(19) Europäisches Patentamt
European Patent Office
Office européen des brevets

(11) **EP 3 055 382 B1**

(12) # EUROPÄISCHE PATENTSCHRIFT

(45) Veröffentlichungstag und Bekanntmachung des Hinweises auf die Patenterteilung:
**05.08.2020 Patentblatt 2020/32**

(21) Anmeldenummer: **14781243.2**

(22) Anmeldetag: **08.10.2014**

(51) Int Cl.:
***C09K 11/64*** *(2006.01)*

(86) Internationale Anmeldenummer:
**PCT/EP2014/071544**

(87) Internationale Veröffentlichungsnummer:
**WO 2015/052238 (16.04.2015 Gazette 2015/15)**

(54) **LEUCHTSTOFF UND VERFAHREN ZUM HERSTELLEN EINES LEUCHTSTOFFS**

LUMINESCENT MATERIAL AND METHOD FOR PRODUCING A LUMINESCENT MATERIAL

SUBSTANCE LUMINESCENTE ET PROCÉDÉ DE PRODUCTION D'UNE SUBSTANCE LUMINESCENTE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:
**08.10.2013 DE 102013220315**
**30.10.2013 DE 102013222144**
**04.03.2014 DE 102014102853**
**17.04.2014 DE 102014105589**
**05.06.2014 DE 102014107984**
**23.06.2014 DE 102014108759**
**17.07.2014 DE 102014110058**

(43) Veröffentlichungstag der Anmeldung:
**17.08.2016 Patentblatt 2016/33**

(73) Patentinhaber:
- **OSRAM Opto Semiconductors GmbH**
  **93055 Regensburg (DE)**
- **OSRAM GmbH**
  **80807 München (DE)**

(72) Erfinder:
- **FIEDLER, Tim**
  **81369 München (DE)**
- **BICHLER, Daniel**
  **81475 München (DE)**
- **LANGE, Stefan**
  **86157 Augsburg (DE)**
- **RÖMER, Rebecca**
  **86150 Augsburg (DE)**
- **JERMANN, Frank**
  **86343 Königsbrunn (DE)**
- **THIENEL, Frauke**
  **80939 München (DE)**
- **HUCKENBECK, Barbara**
  **86159 Augsburg (DE)**
- **BAUMGARTNER, Alexander**
  **93093 Donaustauf (DE)**
- **STÖPPELKAMP, Vera**
  **86157 Augsburg (DE)**
- **BÖNISCH, Norbert**
  **86343 Königsbrunn (DE)**
- **CUI, Hailing**
  **93051 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:

| | |
|---|---|
| **EP-A1- 2 428 544** | **EP-A2- 2 241 607** |
| **WO-A1-2012/166837** | **WO-A1-2012/166841** |
| **CN-A- 102 252 247** | **US-A1- 2013 207 535** |

- **WATANABE H ET AL: "Crystal structure and luminescence properties of SrxCa1-xAlSiN3:Eu<2+> mixed nitride phosphors", JOURNAL OF ALLOYS AND COMPOUNDS, ELSEVIER SEQUOIA, LAUSANNE, CH, Bd. 475, Nr. 1-2, 5. Mai 2009 (2009-05-05) , Seiten 434-439, XP026035585, ISSN: 0925-8388, DOI: 10.1016/J.JALLCOM.2008.07.054 [gefunden am 2008-08-23]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 055 382 B1

- HIROMU WATANABE ET AL: "Synthetic Method and Luminescence Properties of Sr[sub x]Ca[sub 1-x]AlSiN[sub 3]:Eu[sup 2+] Mixed Nitride Phosphors", JOURNAL OF THE ELECTROCHEMICAL SOCIETY, Bd. 155, Nr. 3, 1. Januar 2008 (2008-01-01), Seite F31, XP055157681, ISSN: 0013-4651, DOI: 10.1149/1.2829880
- HIROMU WATANABE: "Nitridation of AEAlSi for Production of AEAlSiN3:Eu2+ Nitride Phosphors (AE=Ca, Sr)", JOURNAL OF THE AMERICAN CERAMIC SOCIETY,, Bd. 92, Nr. 3, 1. Januar 2009 (2009-01-01) , Seiten 641-648, XP002630044, DOI: 10.1111/J.1551-2916.2009.02945.X

## Beschreibung

Es wird ein Leuchtstoff angegeben. Darüber hinaus wird ein Verfahren zur Herstellung eines solchen Leuchtstoffs angegeben. Ein Leuchtstoff, der sich zur Verwendung bei Halbleiterbauelementen wie LED oder Laserdioden eignet, ist in EP 2 135 920 und EP 1 696 016 angegeben.

Die Druckschriften WO 2012/166841 A1, Watanabe H. et al.: "Crystal structure and luminescence properties of SrxCa1-xAlSiN3:Eu2+ mixed nitride phosphors", Journal of Alloys and Compounds, 5. Mai 2009, S. 434-439 und Watanabe H. et al.: "Synthetic Method and Luminescence Properties of SrxCa1- xAlSiN3:Eu2+ Mixed Nitride Phosphors", Journal of the Electrochemical Society, 1. Januar 2008, S. F31 beschreiben jeweils einen Leuchtstoff.

Eine zu lösende Aufgabe besteht darin, einen Leuchtstoff anzugeben, der spektral vergleichsweise schmalbandig im roten Spektralbereich emittiert.

Diese Aufgabe wird unter anderem durch einen Leuchtstoff und durch ein Verfahren mit den Merkmalen der unabhängigen Patentansprüche gelöst. Bevorzugte Weiterbildungen sind Gegenstand der abhängigen Ansprüche.

Ein Leuchtstoff ist generell dadurch ausgezeichnet, dass der Leuchtstoff eine anorganische Substanz beinhaltet, die in ihrer Zusammensetzung zumindest das Element D, das Element A1, das Element AX, das Element SX und das Element NX beinhaltet (wobei D eines, zwei oder mehrere Elemente aus der Gruppe Mn, Ce, Pr, Nd, Sm, Eu, Tb, Dy, Ho, Er, Tm, Alkalimetalle (Li, Na, K, Rb, Cs) und Yb darstellt, A1 eines, zwei oder mehrere Elemente aus der Gruppe der divalenten Metalle darstellt, die nicht in D beinhaltet sind, SX eines, zwei oder mehrere Elemente aus der Gruppe der tetravalenten Metalle darstellt, AX eines, zwei oder mehrere Elemente aus der Gruppe der trivalenten Metalle darstellt, und NX eines, zwei oder mehrere Elemente aus der Gruppe O, N, S, C, Cl, F darstellt) und die dieselbe Kristallstruktur aufweist, wie Sr $(Sr_aCa_{1-a})$ $Si_2Al_2N_6$.

Die Erfinder haben festgestellt, dass ein derartiger Leuchtstoff eine ganze Reihe von Vorteilen gegenüber herkömmlichen Leuchtstoffen aufweist, wie weiter unten beschrieben.

Im Folgenden wird ein Leuchtstoff, der "dieselbe Kristallstruktur aufweist, wie Sr $(Sr_aCa_{1-a})$ $Si_2Al_2N_6$" als ein Leuchtstoff definiert, der neben der Raumgruppe $P2_1$ weiterhin auch in einer der Raumgruppen 1 bis 3 gemäß der International Tables Crystallography A, also in folgenden Raumgruppen beschrieben werden kann: P1, P2, P1 und dessen Länge der chemischen Bindungen zwischen den Elementen Al-N und Si-N berechnet aus den Gitterkonstanten und Atomkoordinaten gemäß einer Rietveld-Analyse innerhalb eines Wertes von ±15 % der in Figur 22 beschriebenen Werte liegt.

Gemäß einer weiteren Ausführungsform ist die Raumgruppe monoklin $P2_1$.

Gemäß einer weiteren Ausführungsform lässt sich die anorganische Substanz durch die folgende allgemeine Formel beschreiben:

$$(D_aA1_b)\ (D_cA1_d)SX_eAX_fNX_g$$

Wobei $a+b \leq 1$ und $c+d \leq 1$ und wobei die Parameter a, b, c, d, e, f und g die folgenden Bedingungen erfüllen $0 \leq a \leq 0{,}5$; $0 \leq c \leq 0{,}5$; $0 \leq b \leq 1$; $0 \leq d \leq 1$; $a+c > 0$; $b+d < 2$; $0{,}1 \leq e \leq 8$; $0{,}1 \leq f \leq 16$; $0{,}8\ (f + 4/3\ e + 2/3\ (b + d)) \leq g$; und $g \leq 1{,}2\ (f + 4/3\ e + 2/3\ (b + d))$

Bevorzugt gilt Folgendes: $0 \leq a \leq 0{,}1$; $0 \leq c \leq 0{,}1$; $0 \leq b \leq 1$; $0 \leq d \leq 1$; $a+c > 0$; $b+d < 2$; $0{,}1 \leq e \leq 8$; $0{,}1 \leq f \leq 16$; $0{,}8(f + 4/3\ e + 2/3\ (b + d)) \leq g$; und $g \leq 1{,}2\ (f + 4/3\ e + 2/3\ (b + d))$.

Gemäß einer weiteren Ausführungsform weist der Leuchtstoff eine allgemeine Summenformel A1 $(A1_aM_{1-a})$ $SX_2AX_2NX_6$: D auf. Dabei ist A1, zumindest ein zweiwertiges metallisches Element, beispielsweise Sr, M ein anderes zweiwertiges metallisches Element, beispielsweise Ca, SX enthält zumindest ein vierwertiges Element, wie z. B. Si und/oder C, AX enthält zumindest ein dreiwertiges Element, wie z.B. Al und/oder La und NX enthält zumindest ein Element ausgewählt aus der Gruppe N, O, F, Cl.

Weiterhin können die allgemeinen Elemente A1, M, SX, AX und NX in dieser Summenformel die bereits oben beschriebenen Bedeutungen haben, also D eines, zwei oder mehrere Elemente aus der Gruppe Mn, Ce, Pr, Nd, Sm, Eu, Tb, Dy, Ho, Er, Alkalimetalle (Li, Na, K, Rb, Cs), besonders Li, Tm und Yb darstellen, A1 eines, zwei oder mehrere Elemente aus der Gruppe der divalenten Metalle darstellen, die nicht in D beinhaltet sind, SX eines, zwei oder mehrere Elemente aus der Gruppe der tetravalenten Metalle, z. B. Si, C, Ge, Hf, Zr, Ti darstellen, AX eines, zwei oder mehrere Elemente aus der Gruppe der trivalenten Metalle darstellen, z. B. Al, La, Ga, In, B, und NX eines, zwei oder mehrere Elemente aus der Gruppe O, N, S, C, Cl, F darstellen.

Der Parameterwert a kann dabei zwischen 0,6 und 1,0, bzw. zwischen 0,8 bis 1,0 liegen. Weiterhin kann gelten, dass $a < 1$ ist.

Eine weitere Ausführungsform ist ein Leuchtstoff der allgemeinen Formel:

$$Sr(Sr_aM_{1-a})Si_2Al_2(N,X)_6\text{: D,A,B,E,G,L}$$

Wobei eine Co-Dotierung der Leuchtstoffe mit den Elementen A, B, E, G und L erfolgt und diese Co-Dotierstoffe entweder Positionen im Wirtsgitter oder Zwischengitterplätze besetzen können. Das allgemeine Element X steht für Elemente wie z. B. O oder Halogen, die insbesondere auch zum Landungsträgerausgleich dienen falls besetzte Zwischengitterplätze im Kristallgitter oder Leerstellen auf Gitterplätzen vorhanden sind.

Dabei ist das Metall M ausgewählt aus Ca, Ba, Mg allein oder in Kombination, A ist ausgewählt aus zweiwertigen Metallen, die unterschiedlich zu M und zu dem weiteren verwendeten Dotierstoff D sind, wie z. B. Cu, Zn oder deren Kombinationen, B steht für dreiwertige Metalle, insbesondere Übergangs- oder Seltenerdmetalle z. B. La oder Pr und E für einwertige Metalle, z. B. Li oder andere Alkalimetalle wie Cs, Rb, K oder Na. G steht für vierwertige Elemente, wie z. B. C oder Ge, oder Hf, Zr, Ti. Das Element L steht dabei für dreiwertige Elemente, wie z. B. B, Ga oder In.

Insbesondere kann dieser Leuchtstoff die folgende allgemeine Formel aufweisen:

$$Sr(Sr_aM_{1-a})Si_2Al_2(N,O)_6{:}D,A,B,E,G$$

Im Folgenden werden anstelle der allgemeinen Formel $Sr(Sr_aM_{1-a})Si_2Al_{2(}N,O)_6{:}D,A,B,E,G$ die Formeln $Sr(Sr_aM_{1-a})Si_2Al_2(N,O)_6{:}D$ oder $Sr(Sr_aM_{1-a})Si_2Al_2(N,O)_6{:}Eu$, $Sr(Sr_aM_{1-a})Si_2Al_{2(}N)_6{:}D$ oder $Sr(Sr_aM_{1-a})\ Si_2Al_{2(}N)_6{:}Eu$ aus Gründen der Einfachheit synonym verwendet.

Die Dotierstoffe können weiterhin spezifische Positionen innerhalb des Kristallgitters der erfindungsgemäßen Leuchtstoffe wie z. B. Gitterplätze oder Zwischengitterplätze einnehmen und auch vorhandene Elemente in den Leuchtstoffen ersetzen, so dass gemäß einer weiteren Ausführungsform ein Leuchtstoff der folgenden allgemeinen Formel resultiert:

$$Sr_{(1-x-h)}(Sr_aM_{1-a})_{(1-y-i)}A_{(x+y)}B_{(h+i)/2}E_{(h+i)/2}Si_{(2-z)}G_zAl_{2-v}L_v(N,X)_6{:}D$$

Insbesondere kann die allgemeine Formel folgendermaßen aufgebaut sein:

$$Sr_{(1-x-h)}(Sr_aM_{1-a})_{(1-y-i)}A_{(x+y)}B_{(h+i)/2}E_{(h+i)/2}Si_{(2-z)}G_zAl_2N_6{:}D$$

Wobei das Metall M und die Elemente A, B und E für die gerade oben beschriebenen Elemente stehen und wobei gilt $0 \leq x+y \leq 0{,}4$, bevorzugt $0 \leq x+y \leq 0{,}3$, weiter bevorzugt $0{,}04 \leq x+y \leq 0{,}3$, x+y können insbesondere 0,2 oder 0,04 sein, weiterhin gilt $0 \leq h+i \leq 0{,}4$, bevorzugt $0 \leq h+i \leq 0{,}3$, weiter bevorzugt $0{,}04 \leq h+i \leq 0{,}3$, wobei auch kein B vorhanden sein kann, so dass x=0 und y=0 sind. Die Parameter h+i können insbesondere 0,2 oder 0,04 sein, wobei auch kein B und E vorhanden sein können, so dass h=0 und i =0 gilt. Dabei können die zweiwertigen Metalle A und/oder eine Kombination aus gleichen molaren Anteilen der dreiwertigen und einwertigen Metalle B und E Sr und/oder Ca ersetzen. Die Parameter x+y, h+i und z können dabei unabhängig voneinander gewählt werden. Weiterhin können jeweils unabhängig voneinander auch x und y und h und i 0 sein.

G steht für vierwertige Elemente, wie z. B. C oder Ge, die Si ersetzen, wobei für den Parameter z gilt: $0 \leq z \leq 1$, bzw. $0 \leq z \leq 0{,}5$, bzw. $0{,}02 \leq z \leq 0{,}3$, wobei z insbesondere 0,02 oder 0,4 sein kann oder kein vierwertiges Element vorhanden sein kann, so dass z = 0. Der Parameter v für das Element L kann folgende Werte einnehmen: $0 \leq v \leq 1$, weiterhin $0 \leq v \leq 0{,}5$.

Ein Ersatz von Sr und M durch A und/oder ein Ersatz von Sr und M durch eine Kombination aus B und E kann zur Veränderung des Farborts im CIE-Farbraum, zur Veränderung der Dominanzwellenlänge, des Reflexionsvermögens, des visuellen Nutzeffekts Vs, des thermischen Löschungsverhaltens, der Stabilität gegen Strahlung, der Hydrolyseempfindlichkeit und/oder der FWHM des Leuchtstoffs führen und somit weitere Möglichkeiten eröffnen die Leuchtstoffe für spezifische Anwendungen anzupassen.

Ein Ersatz von Si durch G kann weiterhin zu einer starken Verschiebung der Wellenlänge der Emission des Leuchtstoffs führen und kann somit eine Verbessrung des Farbwiedergabeindexes (color rendering index) bewirken, besonders bei der Farbwiedergabe von tiefroten Farben. Die Co-Dotierung mit z. B. Kohlenstoff erhöht somit die Möglichkeiten, bestimmte Farborte zu erreichen.

Weiterhin ist es möglich, dass das vierwertige Element G, z.B. C zum Teil auch die N-Atome in Leuchtstoffen ersetzt, wobei G dann als $G^{4-}$ vorliegt, so dass die folgenden allgemeinen Strukturformeln resultieren:

$$Sr(Sr_aM_{1-a})\ Si_2G_{3z}Al_2(N,X)_{6-4z}{:}D$$

bzw.

$$Sr(Sr_aM_{1-a})\ Si_2G_{3z}Al_2N_{6-4z}{:}\ D.$$

Bei einer weiteren Ausführungsform des Leuchtstoffs können jeweils x+y, h+i und/oder z = 0 sein, wobei dann folgende allgemeine Formeln resultieren:

$$Sr(Sr_aM_{1-a})\ Si_{(2-z)}G_zAl_2(N,X)_6{:}D$$

bzw.

$$Sr(Sr_aM_{1-a})\ Si_{(2-z)}G_zAl_2N_6{:}D$$

Für x+y = 0 (x = 0 und y = 0) und zusätzlich h+i =0 (h=0 und i =0) oder die allgemeine Formel:

$$Sr_{(1-h)}(Sr_aM_{1-a})_{(1-i)}B_{(h+i)/2}E_{(h+i)/2}Si_2Al_2(N,X)_6{:}D$$

bzw.

$$Sr_{(1-h)}(Sr_aM_{1-a})_{(1-i)}B_{(h+i)/2}E_{(h+i)/2}Si_2Al_2N_6{:}D$$

resultiert, wenn z = 0 und x+y =0 (x=0 und y =0).

Weiterhin können ausschließlich zweiwertige Metalle A Sr und M ersetzen, also kein B oder E oder G vorhanden sein, so dass folgende allgemeine Formeln resultieren:

$$Sr_{(1-x)}(Sr_aM_{1-a})_{(1-y)}A_{(x+y)}Si_2Al_2(N,X)_6{:}D$$

bzw.

$$Sr_{(1-x)}(Sr_aM_{1-a})_{(1-y)}A_{(x+y)}Si_2Al_2N_6{:}D$$

Weiterhin kann M in den obigen Formeln bevorzugt Ca sein.

Eine weitere Ausführungsform eines Leuchtstoffs weist die folgende allgemeine Formel auf:

$$Sr_{(1-x)}(Sr_aM_{1-a})_{(1-y)}B_{(x+y)}Si_{2-(x+y)}Al_{2+(x+y)}N_6{:}D$$

bzw.

$$Sr_{(1-x)}(Sr_aM_{1-a})_{(1-y)}B_{(x+y)}Si_{2-(x+y)}Al_{2+(x+y)}N_6{:}D$$

so dass Sr und M, sowie Si durch eine Kombination der dreiwertigen Metalle B und Al ersetzt werden, wobei auch hier gilt: $0 \leq x+y \leq 0,4$, bevorzugt $0,04 \leq x+y \leq 0,3$, x+y kann insbesondere 0,2 sein.

Alle oben genannten Leuchtstoffe weisen eine starke Absorption in blauen Spektralbereich auf und emittieren rote Sekundärstrahlung. Weiterhin haben diese Leuchtstoffe die gleiche Kristallstruktur wie $Sr(Sr_aCa_{1-a})\ Si_2Al_2N_6$, kristallisieren also in den Raumgruppen P1, P2, P1, insbesondere in der monoklinen Raumgruppe $P2_1$.

Gegenstand einer weiteren Ausführungsform sind auch Leuchtstoffe der bereits oben beschriebenen allgemeinen Formeln:

$$Sr_{(1-x-h)}(Sr_aM_{1-a})_{(1-y-i)}A_{(x+y)}B_{(h+i)/2}E_{(h+i)/2}Si_{(2-z)}G_zAl_2N_6{:}D$$

oder

$$Sr_{(1-x)}(Sr_aM_{1-a})_{(1-y)}B_{(x+y)}Si_{2-(x+y)}Al_{2+(x+y)}N_6{:}D$$

Wobei D eines, zwei oder mehrere Elemente aus der Gruppe Mn, Ce, Pr, Nd, Sm, Eu, Tb, Dy, Ho, Er, Tm, Alkalimetalle, also Li, Na, K, Rb, Cs, bevorzugt Li und Yb darstellt. D ist bevorzugt ausgewählt aus Eu, Ce, Li, Mn und Kombinationen davon. Bevorzugt ist der Aktivator D ausgewählt aus mindestens einem Element von Eu, Ce, Mn, insbesondere Eu, Ce oder Mn oder eine Mischung aus Eu, Ce, Li. Durch Verwendung der letztgenannten Aktivatoren kann besonders gut der Farbort des Leuchtstoffs im CIE-Farbraum, dessen Dominanzwellenlänge $\lambda$dom, der visuelle Nutzeffekt Vs, FWHM und die diffuse Reflektivität (Remission) bei 450-470 nm eingestellt werden.

Weiterhin ist insbesondere eine Codotierung mit Eu dotierten Leuchtstoffen mit Alkalimetallen, also Li, Na, K, Rb, Cs, bevorzugt Li möglich. Die Codotierung mit den Alkalimetallen kann insbesondere zu einer Verringerung der spektralen Halbwertsbreite FWHM führen, sowie ein verbessertes Verhalten bezüglich des thermischen Quenchens, und eine Verbesserung des visuellen Nutzeffekts bedingen.

Gemäß einer weiteren Ausführungsform ist der Aktivator D eine Kombination aus Eu und einem oder mehreren Alkalimetallen, bevorzugt Li. Dies kann zu einer weiteren Reduzierung der FWHM der emittierten Strahlung, einer Verbesserung des thermischen Quench-Verhaltens und der Quanteneffizienz führen.

Eine allgemeine Formel dieses Leuchtstoffs mit einer Kombination aus Eu und Li kann wie folgt beschrieben werden:

$$Sr_{(1-x-h)}(Sr_aM_{1-a})_{(1-y-i)}A_{(x+y)}B_{(h+i)/2}E_{(h+i)/2}Si_{(2-z)}G_zAl_2N_6{:}Eu, Li$$

oder

$$Sr_{(1-x)}(Sr_aM_{1-a})_{(1-y)}B_{(x+y)}Si_{2-(x+y)}Al_{2+(x+y)}N_6{:}Eu,Li$$

Dabei ist es möglich, dass die Lithium-Metallionen Positionen im Wirtsgitter besetzen und/oder auf Zwischengitterplätzen vorhanden sind. Ein Ladungsträgerausgleich kann dadurch erfolgen dass das Verhältnis Si:Al angepasst wird, und/oder dadurch das partiell N durch O und/oder Halogene wie F ersetzt wird. Möglich sind auch statistisch verteilte Leerstellen innerhalb der Kationen-Gitterplätze. Aus diesem Grunde sind auch die folgenden allgemeinen Formeln geeignet Leuchtstoffe mit Eu und Li als Aktivatoren zu beschreiben, wobei aus Gründen der Übersichtlichkeit die zusätzlichen Elemente A, B, E, und G nicht gezeigt sind, die aber grundsätzlich vorhanden sein können:

$$Li_jSr(Sr_aM_{1-a})Si_{(2-j)}Al_{(2+j)}N_6{:}Eu$$

$$Sr(Sr_aM_{1-a})Li_jSi_{(2-j)}Al_{(2+j)}N_6{:}Eu$$

$$Li_{2j+2k+2l}Sr_{1-j}(Sr_{a-k}M_{1-a-1})Si_2Al_2N_6{:}Eu$$

$$Li_jSr_{1-k}(Sr_aM_{1-a})_{1-l}Si_{2+m}Al_{2-n}N_6{:}Eu$$

$$Li_j[Sr(Sr_aM_{1-a})]_{1-j}Si_{2+j}Al_{2-j}N_6{:}Eu$$

Für den Parameter j gilt dabei: $0 \leq j \leq 0{,}2$, bevorzugt $0 \leq j \leq 0{,}15$, weiter bevorzugt $0 \leq j \leq 0{,}05$. Gemäß einer weiteren Ausführungsform weist der Leuchtstoff eine allgemeine Summenformel $Sr(Sr_aM_{1-a})Si_2Al_2N_6$: D auf. Dabei ist M Ca und/oder Ba. Außerdem kann M auch ausgewählt sein aus der Gruppe Ca, Ba, Zn, Mg und/oder Li allein oder in Kombination. In diesen Fällen und den oben beschriebenen allgemeinen Formeln kann der Wert von a, bei 0,6 bis 1,0, bevorzugt bei 0,8 bis 1,0 (Randwerte ausgeschlossen) liegen. Insbesondere wird a bei 0,7 bis 0,99, weiter bevorzugt bei 0,85 bis 0,99, Randwerte eingeschlossen, gewählt.

Der Aktivator D kann gemäß einer weiteren Ausführungsform dabei in Mol%-Mengen zwischen 0,1% bis 20 Mol%, bzw. 0,1% und 10%, bzw. 1 Mol% - 10Mol%, bzw. 0,5% bis 5%, 2-5 Mol%, bzw.

0,8% bis 3% vorhanden sein. Hier und im Folgenden werden %-Angaben für den Aktivator, insbesondere Eu, als Mol%-Angaben bezogen auf die Molanteile der Erdalkalimetalle im jeweiligen Leuchtstoff verstanden.

Der Aktivator D kann bevorzugt ausgewählt sein aus den Metallen, Eu, Ce, Mn und Li sowie Kombinationen davon. Weiterhin kann der Aktivator D Eu sein, Mn oder Ce sowie Kombinationen von Eu, Ce und Li.

Mit steigender Konzentration an Europium-Dotierstoff verschiebt sich dabei die Dominanzwellenlänge der Emission der Leuchtstoffe zu höheren Wellenlängen hin vom orangenen zu roten Farbbereich (siehe Figur 58a), wobei die relative Intensität der Photolumineszenz von 0.1- etwa 4 Mol% ansteigt und dann bei weiter ansteigenden Aktivatorkonzentrationen an Europium wieder abfällt (siehe Figur 58b). Bezogen auf die relative Intensität der Photolumineszenz ist ein Konzentrationsbereich von 1-10 Mol% Eu, bzw. 2-5 Mol% bevorzugt. Weitgehend analog zur relativen Intensität der Photolumineszenz verhält sich auch die relative augenbewertete Photolumineszenzintensität, die ebenfalls mit steigenden Aktivatorkonzentrationen an Europium zunimmt und ab etwa 4 Mol% bis etwa 20 Mol% wieder absinkt (siehe Figur 58c). Bezogen auf die augenbewertete Photolumineszenzintensität sind Aktivatorkonzentrationen von 0,4-10 Mol% Eu, bzw. 1-5 Mol% Europium bevorzugt.

Gemäß zumindest einer Ausführungsform ist der Leuchtstoff zur Emission von rotem oder orangem Licht eingerichtet. Rotes oder oranges Licht bedeutet, dass der Leuchtstoff Strahlung mit einer Dominanzwellenlänge von mindestens 560 nm, bevorzugt zwischen einschließlich 585 nm und 640 nm, insbesondere zwischen einschließlich 590 nm und 615 nm, emittiert.

Es ist die Dominanzwellenlänge insbesondere diejenige Wellenlänge, die sich als Schnittpunkt der Spektralfarblinie der CIE-Normfarbtafel mit einer geraden Linie ergibt, wobei diese gerade Linie, ausgehend vom Weißpunkt in der CIE-Normfarbtafel, durch den tatsächlichen Farbort der Strahlung verläuft. Im Allgemeinen weicht die Dominanzwellenlänge von einer Wellenlänge maximaler Intensität ab. Insbesondere liegt die Dominanzwellenlänge im roten Spektralbereich bei kleineren Wellenlängen als die Wellenlänge maximaler Intensität.

Gemäß zumindest einer Ausführungsform weist der Leuchtstoff eine allgemeine Summenformel $Sr(Sr_aCa_{1-a})Si_2Al_2N_6$:D auf. Dabei ist D mindestens ein Aktivierungselement. Häufig ist D von Element Eu und/oder auch Ce gebildet. Andere oder zusätzliche Aktivierungselemente oder Dotierungen können aus der Gruppe Mn, Ce, Pr, Nd, Sm, Eu, Gd, Tb, Dy, Ho, Er, Tm, Yb, und Lu jeweils allein oder in Kombination ausgewählt sein. Es ist möglich, dass der Leuchtstoff weitere Elemente, etwa in Form von Verunreinigungen aufweist, wobei diese Verunreinigungen zusammen genommen bevorzugt höchstens einen Gewichtsanteil an dem Leuchtstoff von höchstens 0,1 Promille oder 100 ppm oder 10 ppm, parts per million, aufweisen sollten.

In mindestens einer Ausführungsform ist der Leuchtstoff zur Emission von rotem Licht und bevorzugt zur Anregung mit blauem Licht eingerichtet.

Im ultravioletten Spektralbereich bis in den blau-grünen Spektralbereich anregbare Leuchtstoffe, die rotes Licht emittieren, sind von großer Bedeutung für die Herstellung von weißen Leuchtdioden. Speziell bei Leuchtdioden mit niedrigen Farbtemperaturen, sogenannten warmweißemittierenden Leuchtdioden, und/oder bei Leuchtdioden mit hohem Farbwiedergabeindex sind solche Leuchtstoffe erforderlich. Auch in einer Vielzahl von anderen Anwendungen, etwa für die Display-Hinterleuchtung, sogenannte Color-On-Demand-Anwendungen oder auch für orange und rote Vollkonversionsleuchtdioden sind derartige Leuchtstoffe erforderlich. Ebenso ist der Einsatz in Kombination mit einer organischen Leuchtdiode, kurz OLED, möglich. Der hier beschriebene Leuchtstoff ist für derartige Anwendungen einsetzbar, ebenso für Laser-Anwendungen wie das sog. LARP-Verfahren.

Gemäß zumindest einer Ausführungsform weist der Leuchtstoff in einem Pulverdiffraktogramm bei Bestrahlung mit monochromatischer Cu-$K_{\alpha 1}$-Strahlung einen Reflex bei einem Winkel 2 theta zwischen 36,7° und 37,0° auf, je nach der Zusammensetzung des Leuchtstoffs. Die exakte Position dieses Reflexes ist abhängig von der allgemeinen Summenformel des Leuchtstoffs. Eine Intensität dieses Reflexes, insbesondere bezogen auf einen Hauptreflex, liegt bevorzugt bei mindestens 0,3% oder 0,5% und/oder bei höchstens 10% oder 8% oder 5% oder 4%.

Gemäß zumindest einer Ausführungsform liegt die Dominanzwellenlänge des Leuchtstoffs bei mindestens 596 nm oder 598 nm. Alternativ oder zusätzlich liegt die Dominanzwellenlänge bei höchstens 610 nm, 606 nm oder 604 nm. Die Wellenlänge maximaler Intensität liegt beispielsweise bei mindestens 605 nm oder 610 nm und/oder bei höchstens 630 nm oder 625 nm.

Gemäß zumindest einer Ausführungsform weist der Leuchtstoff eine spektrale Halbwertsbreite auf halber Höhe des Maximums, kurz FWHM oder Full-width at half maximum, von mindestens 70 nm oder 75 nm oder 78 nm auf. Diese spektrale Breite liegt bevorzugt bei höchstens 90 nm oder 87 nm oder 84 nm oder 82 nm.

Gemäß zumindest einer Ausführungsform weist der Leuchtstoff im blauen Spektralbereich ein Absorptionsmaximum, insbesondere ein relatives Absorptionsmaximum, auf. Blauer Spektralbereich bezeichnet insbesondere Wellenlängen von mindestens 400 nm und/oder von höchstens 480 nm. Zum Beispiel liegt das Absorptionsmaximum bei mindestens 410 nm oder 420 nm und/oder bei höchstens 450 nm oder 440 nm.

Die oben genannten Werte zu den spektralen Eigenschaften des Leuchtstoffs gelten insbesondere bei Raumtemperatur, also bei ungefähr 300 K.

Darüber hinaus wird ein Verfahren zur Herstellung eines solchen Leuchtstoffs angegeben. Merkmale des Leuchtstoffs sind daher auch für das Verfahren offenbart und umgekehrt.

In mindestens einer Ausführungsform weist das Verfahren mindestens die folgenden Schritte auf, bevorzugt in der angegebenen Reihenfolge:

A) Bereitstellen von als Festkörper vorliegenden Edukten für Sr, Al, Si und Eu sowie optional für Ca,
B) Mischen der Edukte,
C) Erhitzen der Edukte unter Inertgasatmosphäre, insbesondere Stickstoffatmosphäre oder unter Formiergasatmosphäre auf mindestens 1.500°C und Formen eines Glühkuchens, und
D) Zerkleinern des Glühkuchens zu dem Leuchtstoff

Gemäß zumindest einer Ausführungsform des Verfahrens erfolgt zumindest der Schritt C) oder auch alle Schritte bei etwa Atmosphärendruck. Insbesondere erfolgt das Verfahren dann nicht unter Hochdruckbedingungen. Bevorzugt liegt der Atmosphärendruck und/oder ein Gesamtdruck zwischen einschließlich 0,9 bar und 1,5 bar oder 0,95 bar und 1,05 bar.

Als Edukt und als Quelle für Strontium, Aluminium und/oder Kalzium können die jeweiligen reinen Metalle oder auch Metalllegierungen mit den entsprechenden Metallen Verwendung finden. Ebenso können als Edukte eingesetzt werden Silicide, Hydride, Nitride, Oxinitride, Halogenide und/oder Oxide dieser Metalle. Weiterhin können Mischungen dieser Verbindungen verwendet werden.

Als Edukt oder Quelle für Silicium für die Herstellung des Leuchtstoffs kann eine Silizium-Metallverbindung, ein Siliziumnitrid, ein Erdalkalisilicid, Siliziumdiimid oder eine Mischung dieser Verbindungen eingesetzt werden. Bevorzugt werden Siliziumnitride und/oder Siliziummetalle eingesetzt.

Als Edukt oder Quelle für Eu kann metallisches Europium, eine Europiumlegierung, ein Europiumoxid, ein Europiumnitrid, Europiumhydrid oder ein Europiumhalogenid dienen. Ebenso können Mischungen dieser Verbindungen eingesetzt werden. Bevorzugt wird Europiumoxid als Edukt für Europium verwendet.

Als Edukte für die weiteren vierwertigen Elemente G, z. B. C, die dreiwertigen Elemente B, z. B. La, die einwertigen Elemente E, z. B. Li und die zweiwertigen Elemente A anders als D und M, z.B. Cu oder Zn können beispielsweise die entsprechenden Elemente, Silicide, Hydride, Nitride, Oxinitride, Carbonate, Hydroxide, Halogenide und/oder Oxide dieser Elemente und davon abgeleitete Verbindungen, wie z. B. Hydrate verwendet werden. Beispielsweise können $Mn_2O_3$, CuO, $Zn_3N_2$, $La_2O_3$, $Li_2B_4O_7$ und Graphit verwendet werden.

Gemäß zumindest einer Ausführungsform werden ein Schmelzmittel und/oder ein Flussmittel für die Verbesserung der Kristallinität und/oder zur Unterstützung des Kristallwachstums eingesetzt. Hierzu werden bevorzugt Chloride, Fluoride, Halogenide und/oder borhaltige Verbindungen der eingesetzten Erdalkalimetalle herangezogen werden. Auch Kombinationen aus zwei oder mehreren Schmelzmitteln oder Flussmitteln können Verwendung finden. Insbesondere dient als Schmelzmittel und/oder als Flussmittel zB. zumindest einer der folgenden Stoffe: LiF, LiCl, NaF, NaCl, $SrCl_2$, $SrF_2$, $CaCl_2$, $CaF_2$, $BaCl_2$, $BaF_2$, $NH_4Cl$, $NH_4F$, KF, KCl, $MgF_2$, $MgCl_2$, $AlF_3$, $H_3BO_3$, $B_2O_3$, $Li_2B_4O_7$, $NaBO_2$, $Na_2B_4O_7$, LiBF4. Auch $NH_4HF_2$, $NaBF_4$, $KBF_4$, $EuF_3$ und davon abgeleitete Verbindungen wie z. B. Hydrate sind geeignet.

Gemäß zumindest einer Ausführungsform werden die Ausgangssubstanzen, insbesondere für Sr, Ca, Al und/oder Si sowie Eu und gegebenenfalls auch für die weiteren vierwertigen Elemente G, z. B. C, die dreiwertigen Elemente B, z. B. La, die einwertigen Elemente E, z. B. Li und die zweiwertigen Elemente A anders als D und M, z.B. Cu oder Zn, gemäß der allgemeinen Summenformel des Leuchtstoffs eingewogen. Es ist möglich, das die Erdalkalikomponenten Sr, Ca auch mit einem Überschuss eingewogen werden, um eventuell auftretende Abdampfungsverluste während der Synthese zu kompensieren. Außerdem ist auch die Anwendung von Ba als Erdalkalikomponente möglich.

Gemäß zumindest einer Ausführungsform folgt dem Schritt D) ein Schritt E) nach. In dem Schritt E) erfolgt ein weiteres Glühen des Leuchtstoffs, auch als Tempern bezeichenbar. Das Glühen erfolgt insbesondere bei einer Temperatur von mindestens 1500 °C und bevorzugt unter Stickstoffatmosphäre oder Formiergasatmosphäre. Formiergas bezeichnet eine Mischung aus $N_2$ und $H_2$. Die Temperatur von mindestens 1500 °C in den Schritten C) und/oder E) liegt bevorzugt für mindestens vier Stunden oder sechs Stunden an. Beispielsweise liegt in den Schritten C) und E) jeweils eine Temperatur von 1650 °C $\pm$ 50 °C an.

Gemäß einer alternativen Ausführungsform eines erfindungsgemäßen Verfahrens zur Herstellung eines solchen Leuchtstoffs können anstelle des Schrittes E) auch die Schritte C) und D) wiederholt werden.

Gemäß zumindest einer Ausführungsform erfolgt ein Mischen der Edukte in einer Kugelmühle oder in einem Taumelmischer. Beim Mischprozess kann es von Vorteil sein, die Bedingungen so zu wählen, dass viel Energie in das Mischgut eingetragen wird, wodurch es zu einer Vermahlung der Edukte kommt. Die damit erhöhte Homogenität und Reaktivität der Mischung kann einen positiven Einfluss auf die Eigenschaften des resultierenden Leuchtstoffs haben.

Durch gezielte Veränderung der Schüttdichte oder durch Modifikation der Agglomeration der Eduktmischung kann die Entstehung von Nebenphasen reduziert werden. Außerdem können eine Partikelgrößenverteilung, eine Partikelmorphologie und/oder eine Ausbeute des resultierenden Leuchtstoffs beeinflusst werden. Hierfür besonders geeignete Techniken sind Siebungen und Granulieren, auch unter Verwendung geeigneter Zusätze.

Gemäß zumindest einer Ausführungsform erfolgt eine Temperung, insbesondere in einem Tiegel aus Wolfram, Molybdän oder Bornitrid. Die Temperung erfolgt bevorzugt in einem gasdichten Ofen in einer Stickstoff-Atmosphäre oder in einer Stickstoff/Wasserstoff-Atmosphäre. Die Atmosphäre kann fließen oder stationär sein. Es kann zudem Kohlenstoff in feinverteilter Form im Ofenraum anwesend sein. Es sind auch mehrfache Temperungen des Leuchtstoffs möglich, um die Kristallinität oder die Korngrößenverteilung zu verbessern oder gezielt zu beeinflussen. Weitere Vorteile können eine niedrigere Defektdichte, verbunden mit verbesserten optischen Eigenschaften des Leuchtstoffs und/oder eine höhere Stabilität des Leuchtstoffs, sein. Zwischen den Temperungen kann der Leuchtstoff auf verschiedenste Weisen behandelt werden oder es können dem Leuchtstoff Substanzen wie Schmelzmittel zugegeben werden.

Für ein Mahlen des Leuchtstoffs können etwa eine Mörsermühle, eine Fließbettmühle oder eine Kugelmühle eingesetzt werden. Es ist beim Mahlen bevorzugt darauf zu achten, den Anteil von erzeugtem Splitterkorn möglichst gering zu halten, da dieser die optischen Eigenschaften des Leuchtstoffs verschlechtern kann.

Der Leuchtstoff kann zusätzlich gewaschen werden. Hierzu kann der Leuchtstoff in Wasser oder in wässrigen Säuren wie Salzsäure, Salpetersäure, Flusssäure, Schwefelsäure, organischen Säuren oder einer Mischung dieser gewaschen werden. Der Leuchtstoff kann alternativ oder zusätzlich in einer Lauge wie Natronlauge, Kalilauge, einer wässrigen Ammoniak-Lösung oder Mischungen hieraus gewaschen werden. Alternativ oder zusätzlich ist eine Waschung in organischen Lösungsmitteln wie Aceton, Propanol und/oder Phenol möglich. Das Waschen erfolgt bevorzugt nach dem Mahlen.

Gemäß zumindest einer Ausführungsform erfolgt etwa durch das Tempern, weitere Glühen, Mahlen, Sieben und/oder Waschen eine Entfernung von Nebenphasen, Glasphasen oder andere Verunreinigung und damit eine Verbesserung der optischen Eigenschaften des Leuchtstoffs. Es ist auch möglich, durch diese Behandlung gezielt kleine Leuchtstoffpartikel abzutrennen oder aufzulösen und die Partikelgrößenverteilung für die Anwendung zu beeinflussen. Außerdem kann durch eine solche Behandlung eine Oberfläche der Leuchtstoffpartikel gezielt verändert werden, wie zum Beispiel das Entfernen bestimmter Bestandteile aus der Partikeloberfläche. Diese Behandlung kann, auch in Verbindung mit einer nachgeschalteten Behandlung, zu einer verbesserten Stabilität des Leuchtstoffs führen. Insbesondere ist das Aufbringen einer Schutzschicht möglich, wie an sich grundsätzlich bekannt.

Darüber hinaus wird die Verwendung eines solchen Leuchtstoffs angegeben. Merkmale zur Verwendung sind daher auch für das Verfahren sowie den Leuchtstoff offenbart und umgekehrt.

In mindestens einer Ausführungsform wird der Leuchtstoff in einer Leuchtdiode als Strahlungsquelle als erster Leuchtstoff in einer Leuchtvorrichtung verwendet. Die Leuchtdiode umfasst mindestens einen im Betrieb im blauen und/oder UV-Spektralbereich emittierenden Halbleiterchip. Der Leuchtstoff ist dem Halbleiterchip entlang eines Strahlweges nachgeordnet.

Das vom Halbleiterchip erzeugte blaue und/oder UV-Licht wird teilweise oder vollständig von dem Leuchtstoff absorbiert und in Strahlung mit größerer Wellenlänge umgewandelt, insbesondere in rotes (z.B. D=Eu) oder oranges (z. B. D=Ce) Licht umgewandelt. Es ist möglich, dass zumindest ein weiterer zweiter Leuchtstoff, der eine vom ersten Leuchtstoff unterschiedliche Emission aufweist und insbesondere zur Erzeugung von grünem und/oder gelbem Licht, geeignet ist, vorhanden ist, insbesondere auch Leuchtstoffe mit gleicher Struktur wie der erste Leuchtstoff. Weiterhin wird von der Leuchtdiode bevorzugt Mischstrahlung, beinhaltend blaues Licht von dem Halbleiterchip und konvertierte Strahlung von dem Leuchtstoff sowie grünes und/oder gelbes Licht von dem weiteren Leuchtstoff, emittiert. Als Primärstrahlung kann auch UV-Strahlung statt blauem Licht verwendet werden.

Neben dem ersten Leuchtstoff sowie gegebenenfalls dem zweiten Leuchtstoff können auch weitere nicht leuchtende Partikel, z. B. Streupartikel sowie Diffusoren im Strahlengang der Strahlungsquelle vorhanden sein.

In den folgenden Ausführungen wird die Zusammensetzung des erfindungsgemäßen neuen Leuchtstoffs mit der Summenformel $Sr(Sr_aCa_{1-a})Si_2Al_2N_6$:Eu beschrieben. Dies entspricht der nominellen Zusammensetzung der Proben gemäß der Einwaagezusammensetzung. Das tatsächlich vorliegende Si:Al-Verhältnis kann jedoch auch von 2:2 abweichen, was durch einen Parameter d ausgedrückt werden kann. Ein möglicher Wert von d liegt beispielsweise zwischen 0 und 0.1, Randwerte einschließlich. Eine röntgenographische Unterscheidung von Si und Al ist nicht möglich. Ebenso ist es möglich, dass der fertige Leuchtstoff andere weitere Elemente enthält, die beispielsweise über Verunreinigungen oder Flussmittel in der Ansatzmischung oder während der Synthese eingebracht werden, insbesondere (aber nicht ausschließlich) Bor und/oder Kohlenstoff und/oder Sauerstoff und/oder Halogene wie z.B. Fluor oder Chlor. Durch eventuelle Abdampfungen einzelner Komponenten kann es auch zu statistischen Unterbesetzungen einzelner Lagen kommen. Auch dieser Effekt ist mit röntgenographischer Analyse nicht bzw. nur sehr schwer detektierbar.

Deshalb ist demnach in allen Ausführungsbeispielen eine Summenformel des Typs $Sr_{1-e}(Sr_aCa_{1-a})_{1-g}(Si,C)_{2+d}(Al,B)_{2-d}(N,O,F,Cl,C)_6$:Eu eine mögliche Beschreibung des tatsächlich vorliegenden Leuchtstoffs.

Aus Gründen der Übersichtlichkeit wird in der Folge aber in allen Ausführungsbeispielen vereinfachend von "$Sr(Sr_aCa_{1-a})Si_2Al_2N_6$:Eu" gesprochen, die jeweilige angegebene Summenformel entspricht dann der Einwaagezusammensetzung.

Nachfolgend wird ein hier beschriebener Leuchtstoff unter Bezugnahme auf Zeichnungen anhand von Ausführungsbeispielen näher erläutert. Gleiche Bezugszeichen geben dabei gleiche Elemente in den einzelnen Figuren an. Es sind jedoch keine maßstäblichen Bezüge dargestellt, vielmehr können einzelne Elemente zum besseren Verständnis übertrieben groß dargestellt sein.

Es zeigen:

Figur 1 Verhältnis zwischen x und FWHM,

Figuren 2 bis 34 schematische Darstellungen von Eigenschaften von hier beschriebenen Leuchtstoffen bzw. Leuchtstoffmischungen bei Anregung mit blauem Licht sowie Daten aus einer Röntgenstrukturanalyse von hier beschriebenen Leuchtstoffen bzw. Leuchtstoffmischungen im Vergleich zum Stand der Technik,

Figuren 35a bis 36b Emissionsspektren und Remissionsspektren von hier beschriebenen Leuchtstoffen,

Figur 37 ein Halbleiterbauelement, das als Lichtquelle (LED) für weißes Licht dient;

Figur 38 eine Beleuchtungseinheit mit Leuchtstoffen gemäß der vorliegenden Erfindung;

Figuren 39a und 39b Einwaagen m in g für verschiedene Edukte zur Herstellung von herkömmlichen und erfindungsgemäßen Leuchtstoffen.

Figuren 40a bis 44b und 45a bis 45d zeigen den Lichtstrom und die Strahlungsleistung sowie die Zusammensetzung der Leuchtstoffe verschiedener LEDs gemäß Vergleichsbeispielen und Ausführungsbeispielen sowie deren entsprechende Emissionsspektren und aus den Spektren abgeleitete Daten für die Vollkonversion der Primärstrahlung in rote Sekundärstrahlung.

Figuren 46a bis 46e und 47a bis 47i zeigen verschiedene Ausführungsbeispiele von Beleuchtungsvorrichtungen, die für Straßenbeleuchtungsanwendungen geeignet sind und deren optische Eigenschaften.

Figuren 48a bis 48j zeigen Ausführungsbeispiele von Leuchtvorrichtungen für Hinterleuchtungsanwendungen und deren optische Eigenschaften.

Figuren 49a bis 49g und 50a bis 50e zeigen experimentelle Daten für verschiedene Vergleichs-und Ausführungsbeispiele von Leuchtvorrichtungen für Blitzlichtanwendungen.

Figuren 51a bis 51h, und 52a bis 52h und 53a bis 53d zeigen experimentelle Daten für Leuchtvorrichtungen gemäß verschiedenen Vergleichs-und Ausführungsbeispielen für warmweiße Allgemeinbeleuchtungsanwendungen mit hohem CRI.

Figuren 54 bis 57 zeigen die Lichtausbeute und die Zusammensetzung der Leuchtstoffe für verschiedene LEDs in LARP-Anwendungen gemäß Vergleichsbeispielen und Ausführungsbeispielen sowie deren entsprechende Emissionsspektren.

Figuren 58a bis 58c zeigen die Auswirkungen von unterschiedlichen Eu-Dotierstoffkonzentrationen auf die Dominanzwellenlänge, die relative Intensität der Photolumineszenz und die relative augenbewertete Photolumineszenzintensität.

Figuren 59a bis 59g zeigen die Zusammensetzung von erfindungsgemäßen Leuchtstoffen die mit Cu, Zn, La und Li codotiert wurden, sowie deren Spektren und Röntgenbeugungsdiffraktogramme.

Figuren 60a und 60b zeigen die nominelle Zusammensetzung sowie die Spektren von erfindungsgemäßen Leuchtstoffen die mit Kohlenstoff codotiert wurden.

Figuren 61a bis 61d zeigen die nominelle Zusammensetzung und die Spektren von erfindungsgemäßen Leuchtstoffen die mit verschiedenen Aktivatoren dotiert worden, unter anderem Europium, Cer, Lithium, und Mangan.

Figuren 62a bis 62e zeigen verschiedene Eigenschaften von erfindungsgemäßen Leuchtstoffen und deren Röntgenbeugungsdiffraktogramme, die neben Europium auch mit Lithium codotiert wurden.

Figuren 63 bis 73 zeigen verschiedene Ausführungsformen von Leuchtvorrichtungen 30 mit den erfindungsgemäßen Leuchtstoffen im Querschnitt.

Ein Ausführungsbeispiel eines hier beschriebenen Leuchtstoffs lässt sich wie folgt herstellen:
Als Edukte für die Synthese des Leuchtstoffs der allgemeinen Summenformel $Sr(Sr_aCa_{1-a})Si_2Al_2N_6$:Eu werden die binären Nitride der konstituierenden Elemente, also $Ca_3N_2$, $Sr_3N_2$, AlN und $Si_3N_4$ eingesetzt. Da es sich dabei um stark oxidationsempfindliche und hydrolyseempfindliche Substanzen handelt, wird in einer sogenannten Glove-Box gearbeitet, unter einer $N_2$-Atmosphäre mit $O_2$ < 1 ppm und HO < 1 ppm. Zusätzlich wird zur Dotierung mit $Eu^{2+}$ $Eu_2O_3$ eingesetzt. Eine Einwaage erfolgt so, dass quasi in vereinfachender Darstellung folgendes atomares Verhältnis vorliegt:
Sr : Ca : Si : Al : Eu = (1+a) : (1-a) : 2 : 2 : y, wobei y dem Dotierungsgrad entspricht, also dem Anteil der zweiwertigen Gitterplätze, die durch Eu substituiert werden. Zusätzlich werden verschiedene Flussmittel hinzugefügt, siehe die obige Erläuterung. Eine Eduktmischung wird unter Beibehaltung der oben beschriebenen atomaren Verhältnisse beispielsweise auf eine Gesamteinwaage von 50 - 100 g skaliert. Es ist auch möglich andere Gesamteinwaagen zu verwenden.
Die Eduktmischung wird beispielsweise zusammen mit $ZrO_2$-Kugeln in einen PET-Mischbehälter gegeben und für 6 h auf einer Rollenbank in der Glove-Box gemischt. Anschließend werden die Kugeln aus der Mischung entfernt und das Pulver wird in einen geschlossenen Molybdän-Tiegel überführt. Dieser Tiegel wird in einen Wolfram-Übertiegel, ein halbrundes offenes Rohr aus Wolfram, gelegt und in einen Rohrofen überführt. Der Rohrofen wird während der Laufzeit mit 3 l/min Formiergas mit 92,5% $N_2$ und 7,5% $H_2$ durchströmt. In dem Rohrofen wird die Mischung mit einer Rate von 250 K/h auf 1650 °C erhitzt, bei dieser Temperatur für 4 h gehalten und anschließend mit 250 K/h auf 50 °C abgekühlt. Der entstandene Glühkuchen wird nach Erkalten des Ofens herausgenommen, mit einer Mörser-Mühle zerkleinert und über ein Sieb mit einer Maschenweite von 31 µm gesiebt. Die Siebfraktion < 31 µm ist der verwendete Leuchtstoff.

Dem Sieben kann optional ein weiteres Glühen, Tempern und/oder Waschen und/oder ein Beschichtungsvorgang nachfolgen.

Beispielhafte Einwaagen m in g sowie resultierende Farborte CIE x, CIE y, auch als color locus oder "chromaticity coordinate" bezeichnet, des Emissionsspektrums des jeweiligen Leuchtstoffs in der CIE-Normfarbtafel bei Anregung mit blauem Licht bei 460 nm und bei vollständiger Absorption des blauen Lichts sind tabellarisch in den Figuren 39a und 39b aufgeführt. Einwaagen mit x ≤ 0,8 bezeichnen dabei herkömmliche Leuchtstoffe, während Einwaagen mit x > 0,8 (entspricht a > 0,6) erfindungsgemäße Leuchtstoffe kennzeichnen.

In Figur 1 ist das Verhältnis zwischen x und FWHM dargestellt.

In Figur 1 ist eine Abhängigkeit einer spektralen Halbwertsbreite FWHM der Emission vom Sr-Gehalt gezeigt für Ausführungsbeispiele des erfindungsgemäßen neuen Leuchtstoffs $Sr(Sr_aCa_{1-a})\ Si_2Al_2N_6$:Eu (offene Symbole) im Vergleich zu bekannten Leuchtstoffen aus dem System $Sr_xCa_{1-x}AlSiN_3$:Eu (volle Symbole). Der Sr-Gehalt entspricht dem Parameter a für $Sr(Sr_aCa_{1-a})\ Si_2Al_2N_6$:Eu bzw. x für $Sr_xCa_{1-x}AlSiN_3$:Eu, wobei a=2x-1. Der Parameter a ist in der Figur mit alpha bezeichnet.

Für den Leuchtstoff gemäß Stand der Technik beobachtet man eine sehr geringe Änderung der FWHM mit steigendem x (gestrichelte Linie). Der erfindungsgemäße neue Leuchtstoff dagegen zeigt bei einem Sr-Gehalt von a > 0.6, was formal einem x > 0.8 beim bekanntem Leuchtstoff entspräche, eine sehr starke Änderung der Halbwertsbreite FWHM mit steigendem a. Außerdem liegt die Halbwertsbreite des neuen Leuchtstoffs signifikant niedriger als beim Leuchtstoff gemäß dem Stand der Technik. Der Parameter a kann daher gut zwischen 0,6 und 1,0, bzw. zwischen 0,8 und 1,0 gewählt werden, Randwerte sind bevorzugt ausgeschlossen. Sehr gute Eigenschaften zeigen insbesondere Leuchtstoffe mit einem Wert von a, der zwischen 0,64 bis 0,96 bzw. zwischen 0,82 und 0,98 liegt, Randwerte eingeschlossen. Besonders bevorzugt ist ein Bereich für a, der zwischen 0,68 und 0,92 bzw. zwischen 0,84 und 0,96 liegt, Randwerte eingeschlossen.

Bei Verwendung anderer Konstituenten als Sr, Ca. kann der Wert für a auch deutlich niedriger liegen.

In Figur 2 ist das Verhältnis zwischen ldom (dominante Wellenlänge)und der FWHM für verschiedene Leuchtstoffe dargestellt.

Dabei ist eine Abhängigkeit einer spektralen Halbwertsbreite FWHM der Emission vom Sr-Gehalt gezeigt für Ausführungsbeispiele des erfindungsgemäßen neuen Leuchtstoffs $Sr(Sr_aCa_{1-a)}Si_2Al_2N_6$:Eu (offene Symbole) im Vergleich zu bekannten Leuchtstoffen aus dem System $Sr_xCa_{1-x}AlSiN_3$:Eu (volle Symbole) gezeigt. Der Sr-Gehalt entspricht dem Parameter a für $Sr(Sr_aCa_{1-a})\ Si_2Al_2N_6$:Eu bzw. x für $Sr_xCa_{1-x}AlSiN_3$:Eu, wobei a=2x-1. Zusätzlich ist eine Dominanzwellenlänge ldom des vom Leuchtstoff emittierten Spektrums sowie der Eu-Gehalt angegeben.

Überraschenderweise zeigt ein erfindungsgemäßer Leuchtstoff $Sr(Sr_aCa_{1-a})\ Si_2Al_2N_6$:Eu mit a=0.8 (was x=0.9 entspräche) bei vergleichbarer Dominanzwellenlänge ldom eine viel kleinere Halbwertsbreite FWHM im Vergleich zu herkömmlichen Leuchtstoffen des Typs $Sr_xCa_{1-x}AlSiN_3$:Eu. Die viel geringere Halbwertsbreite FWHM ist nahezu unabhängig vom eingesetzten Eu-Gehalt der Probe.

In Figur 3 ist ein Vergleich spektraler Daten angegeben. Leuchtstoffe des neuen Typs zeichnen sich ggü. dem vorbekannten Leuchtstoff durch eine kleine Halbwertsbreite FWHM der Emission (im Bereich 79 bis 81 liegend verglichen mit 86 bis 88 beim Stand der Technik) und durch einen sehr hohen visuellen Nutzeffekt LER (110 bis 111% gegenüber 100 bis 101% beim Stand der Technik) bei gleichzeitig hoher interner Quanteneffizienz QI und externer Quanteneffizienz QE (etwa 113% gegenüber 100 bis 110% beim Stand der Technik) aus, siehe die Tabelle in Figur 3. Ferner ist eine relative Helligkeit B angegeben (etwa 125 bis 126% gegenüber. Etwa 100 bis 111% beim Stand der Technik). Zur Berechnung der externen Quanteneffizienz QE wurde der Mittelwert der Remission im Bereich von 450 nm bis 470 nm herangezogen, die Messung erfolgte in gepressten Pulvertabletten bei einer Anregungswellenlänge von 460 nm. Außerdem sind die Komponenten x und y des Farborts angegeben.

In Figur 4 wird die LED-Effizienz verschiedener Systeme verglichen. Es sind die relativen Konversionseffizienzen verschiedener, warmweißes Licht emittierender Leuchtdioden, kurz LEDs, gezeigt. Es wurde jeweils eine Mischung aus zwei Leuchtstoffen, die grünes und rotes Licht emittieren, eingesetzt, wobei der grünes Licht emittierende Leuchtstoff G gleich bleibt (derartige Leuchtstoffe, insbesondere Granate, die mit Ce dotiert sind, an sich bekannt) und der rot emittierende Leuchtstoff R variiert wurde. An der Abszissenachse ist für vier verschiedene Leuchtstoffe der Typ des Rot emittierenden Leuchtstoffs R angegeben. Die Ordinatenachse gibt die relative Effizienz E an. Die Anregung der Leuchtstoffe erfolgte mit einem blau emittierenden Halbleiterchip mit einer Dominanzwellenlänge von 446 nm.

Alle Leuchtstoffmischungen wurden so eingestellt, dass in der CIE-Normfarbtafel ein Farbort nahe Planck mit einer korrelierten Farbtemperatur CCT von etwa 2700 K erreicht wird. Der Farbwiedergabeindex CRI aller gemessenen LEDs liegt bei 80 ± 1. Alle eingesetzten Rotleuchtstoffe R zeigen eine vergleichbare Dominanzwellenlänge von etwa 600,5 nm ± 1 nm.

Weitere Angaben zu den Leuchtstoffmischungen, wie in Figur 4 gezeigt, sind der Tabelle in Figur 5 zu entnehmen. Zusätzlich angegeben sind die relative Effizienz E (rel. Eff.), eine Leuchtstoffkonzentration c (phosphor concentration) sowie eine Mengenverhältnis V des grünen Leuchtstoffs G und des roten Leuchtstoffs R (ratio green/red).

In Figur 6 ist ein Vergleich von Konversionseffizienz und Farbwiedergabeindex verschiedener warmweißes Licht erzeugender LEDs gezeigt. Es wurde jeweils eine Mischung aus zwei Leuchtstoffen eingesetzt, wobei der Grün-Leuchtstoff G konstant gehalten und der Rot-Leuchtstoff R variiert wurde, analog zur Tabelle in Figur 5. Alle Leuchtstoffmischungen wurden so eingestellt, dass ein Farbort nahe Planck mit einer korrelierten Farbtemperatur CCT von etwa 2700 K erreicht wird. Die relative Konversionseffizienz E (linke Ordinate), deren relative Größe illustriert durch die Säulen in Figur 6 dargestellt ist, einer warmweißes Licht erzeugenden LED mit dem neuartigen Leuchtstoff mit insgesamt 90% Sr am Erdalkaliplatz (rechts dargestellt) zeigt eine deutlich höhere Effizienz (etwa 6 % gegenüber einem 258-Nitrid) und gleichzeitig eine verbesserte Farbwiedergabe CRI (rechte Ordinate, der Farbwiedergabeindex ist symbolisiert als schwarze Rauten), als LEDs mit einem vorbekannten Rot-Leuchtstoff mit nur 80% Sr (Typ 1113-Calsin) oder noch weniger Sr-Anteil (Typ 258-Nitridosilikat) am Erdalkaliplatz.

Weitere Daten zu den LED-Messungen aus Figur 6 sind der Tabelle in Figur 7 zu entnehmen, analog zur Tabelle in Figur 5. Die Effizienz E (rel. Eff.) einer warmweißes Licht erzeugenden LED bei korrelierten Farbtemperatur CCT von etwa 2700 K mit einem neuartigen roten Leuchtstoff mit insgesamt 90% Sr-Anteil am Erdalkaliplatz (zusammen mit einem grünen Granat-Leuchtstoff) ist auch hier deutlich höher und außerdem ist ein erhöhter Farbwiedergabeindex CRI erzielbar.

Rotleuchtstoffe aus dem neuartigen Materialsystem wurden einem Hydrolysetest unterzogen, um eine Alterungsstabilität des Leuchtstoffs gegenüber Luftfeuchtigkeit zu bewerten, siehe Figur 8. Im Einzelnen wurden Rotleuchtstoffe aus dem Materialsystem $Sr_xCa_{1-x}AlSiN_3$:Eu und ein Ausführungsbeispiel des erfindungsgemäßen neuen Leuchtstoffs $Sr(Sr_aCa_{1-a})Si_2Al_2N_6$:Eu einem Hydrolysetest unterzogen, um die Alterungsstabilität des Leuchtstoffs gegenüber Luftfeuchtigkeit zu bewerten. Dazu wurden die Leuchtstoffpulver für 40 h bei 130°C und 100% rel. Luftfeuchtigkeit gelagert. Die relative Absorption A der Leuchtstoffe im blauen Spektralbereich (450 - 470 nm) als Ordinate wurde sowohl vor als auch nach dieser Behandlung gemessen. Als Maß für die Stabilität eines Leuchtstoffs gegenüber Hydrolyse, also der Zersetzung des Leuchtstoffs in Anwesenheit von Wasser, gilt die Abnahme des Absorptionsvermögens im blauen Spektralbereich. Mit zunehmendem Sr-Gehalt beobachtet man gemäß Figur 8 für Leuchtstoffe aus dem bekannten System SrxCa1-xAlSiN3:Eu eine starke Zunahme der Hydrolyseempfindlichkeit (volle Rauten). Überraschenderweise ist jedoch der neue Leuchtstoff ($Sr(Sr_aCa_{1-a})Si_2Al_2N_6$:Eu) mit a=0.8 (entspricht formal 90% Sr in einer Darstellung als x=0.9) hydrolysestabiler (hohle Raute) als ein vorbekannter $Sr_xCa_{1-x}AlSiN_3$:Eu-Leuchtstoff mit 80% Sr-Anteil (x=0.8).

In Figur 9 ist die Feuchtstabilität des neuartigen Leuchtstoffs untersucht.

Zur Verbesserung der Stabilität des erfindungsgemäßen neuen Leuchtstoffs gegen Hydrolyse wurden Muster des Leuchtstoffs nach der Synthese mit einem inerten Material (SiO2) beschichtet.

Unbehandelte und nachträglich beschichtete Proben wurden einem Hydrolysetest unterzogen, um die Alterungsstabilität des Leuchtstoffs gegenüber Luftfeuchtigkeit zu bewerten. Dazu wurden die Leuchtstoffpulver für 48-56 h bei 130°C und 100% rel. Luftfeuchtigkeit gelagert. Die Quanteneffizienz und die Absorption der Leuchtstoffe im blauen Spektralbereich (450 - 470 nm) wurden sowohl vor als auch nach dieser Behandlung gemessen. Als Maß für die Stabilität eines Leuchtstoffs gegenüber Hydrolyse (Zersetzung des Leuchtstoffs in Anwesenheit von Wasser) gilt die Änderung der relativen Konversionseffizienz (berechnet aus Quanteneffizienz und Absorption im Spektralbereich 450-470 nm) vor und nach dem Degradationstest. Die Beschichtung verbessert die Stabilität deutlich.

In Figuren 10a und 10b sind REM-Aufnahmen verschiedener Leuchtstoffe gezeigt.

Die Abbildungen zeigen REM-Aufnahmen des unbeschichteten Leuchtstoffs vor und nach dem Degradationsprozess in unterschiedlicher Vergrößerung. Gezeigt sind Ausführungsbeispiele des neuen Leuchtstoffs mit der Zusammensetzung $Sr(Sr_{0.8}Ca_{0.2})Si_2Al_2N_6$:1.2%Eu.

Auf den REM-Aufnahmen der Probe nach dem Degradationstest ist eine Rissbildung der einzelnen Leuchtstoffkörner erkennbar. In Figuren 11a und 11b sind REM-Aufnahmen verschiedener Leuchtstoffe gezeigt.

Die Abbildungen zeigen REM-Aufnahmen des beschichteten Leuchtstoffs vor und nach dem Degradationsprozess in unterschiedlicher Vergrößerung.

Gezeigt sind Ausführungsbeispiele des neuen Leuchtstoffs mit der Zusammensetzung $Sr(Sr_{0.B}Ca_{0.2})Si_2Al_2N_6$:1.2%Eu. Auf den REM-Aufnahmen der Probe nach dem Degradationstest ist keine Rissbildung der Leuchtstoffkörner erkennbar.

In Figur 12 ist ein Temperaturlöschverhalten, englisch thermal quenching, von zwei Rot-Leuchtstoffen im Vergleich zueinander dargestellt. Beide Leuchtstoffe haben eine vergleichbare Emissionsfarbe mit einer Dominanzwellenlänge von zirka 600 nm. Überraschenderweise zeigt der erfindungsgemäße neue Leuchtstoff $Sr(Sr_aCa_{1-a})$ $Si_2Al_2N_6$: Eu mit a= 0,8 (volle Quadrate) trotz eines höheren Eu-Gehalts (0,8%) ein geringere Abnahme der Emissionsintensität I (Ordinate) mit steigender Temperatur im Vergleich zum Referenzleuchtstoff aus dem bekannten System $Sr_xCa_{1-x}AlSiN_3$:Eu, dort ist der Eu-Gehalt 0,6% (hohle Rauten) . In Figur 13 ist die relative externe Quanteneffizienz QE für einen vorbekannten Leuchtstoff aus dem System 1113-Calsin dargestellt. Die Daten sind EP 2 135 920 entnommen. Über diese Leuchtstoffe aus dem System $CaAlSiN_3$:Eu wird dort (im Folgenden als Calsin bezeichnet) berichtet, dass mit steigendem Aktivatorgehalt (> 0.8 % Eu) die Konversionseffizienz stagniert.

Ein ähnliches Verhalten ist auch für SCASN bekannt. Der beschriebene Leuchtstoff aus dem (Sr,Ca)$AlSiN_3$:Eu-

System mit Sr-Gehalt 80% zeigt eine starke Abhängigkeit der relativen Emissionsintensität des Lumineszenzsignals vom Aktivatorgehalt. Dieses Verhalten wird z.B. beschrieben in H. Watanabe et al., J. Electrochem. Soc., 2008, 155 (3), F31-F36. Das Verhalten ist in Figur 14 dargestellt.

Im Gegensatz zum reinen Calsin (vgl. Figur 13) bricht die Photolumineszenz-Intensität ab einem Wert von ca. 0.8% Eu und mehr für SCASN sogar stark ein und erreicht nur noch 60% des Maximalwerts.

Ein ähnliches Verhalten wird auch in US 8 274 215 beschrieben.

Bei einem Eu-Gehalt von mindestens 1 % (x=0,01) nimmt das Lumineszenzsignal ab bzw. stagniert nahezu (Sr-Gehalt: 80%). Figur 15 zeigt das daraus abgebildete Figur (dort Figur 15B). Die Erfinder von US 8274 215 merken dazu an, dass mit steigendem Eu-Gehalt (bis zum Wert x=0,01) die Intensität der Photolumineszenz zunimmt, danach bleibt sie gleich oder nimmt ab.

Figur 16 zeigt im Gegensatz dazu die relative Emissionsintensität I als Funktion der Dotierung Eu als Aktivator, der den Erdalkalianteil ersetzt, für einen neuartigen Leuchtstoff. Der Eu-Gehalt ist dabei in % angegeben. Überraschenderweise zeigt der neuartige Leuchtstoff (in der Abszisse angegeben) ein vom Stand der Technik deutlich abweichendes Verhalten. Mit steigendem Eu-Gehalt nimmt die Emissionsintensität I auch bei einem Eu-Gehalt von deutlich über 1% merklich zu, und zwar sogar annähernd linear. Diese Eigenschaft bietet für die Anwendung diverse technische Vorteile. Darunter fallen ein relativ niedriger Leuchtstoffbedarf und die Möglichkeit, Farborte mit relativ großem x, verstanden als der ersten CIE-Komponente, und auch hoher Dominanzwellenlänge lambdadom (ldom), zu erreichen. Mit steigendem Aktivatorgehalt Eu (als Parameter y in % dargestellt) verschiebt sich das Lumineszenzsignal annähernd linear hin zu größeren Wellenlängen. Dadurch lässt sich beispielsweise der Farbwiedergabeindex CRI einer warmweißes Licht emittierenden LED erhöhen, siehe auch die anderen Beispiele in der vorliegenden Anmeldung.

In Figur 17 ist der Einfluss des Grad der Dotierung mit Eu auf die Emissionswellenlänge, dargestellt als lambdadom (in nm) dargestellt. Mit steigendem Aktivatorgehalt y für den neuartigen Leuchtstoff verschiebt sich das Lumineszenzsignal annähernd linear hin zu größeren Wellenlängen. Dadurch lässt sich z.B. der Farbwiedergabeindex CRI einer warmweißes Licht emittierenden LED erhöhen, siehe auch andere entsprechende LED-Beispiele in dieser Anmeldung.

Um die Struktur des erfindungsgemäßen neuen Leuchtstoffs zu bestimmen, wurden Kristalle des neuen Leuchtstoffes unter einem Lichtmikroskop ausgewählt und für eine diffraktometrische Untersuchung vorbereitet. Die Messung erfolgte auf einem Bruker D8 Venture mit Drehanode und CCD-Detektor. Eine Zusammenfassung der Ergebnisse (wichtige Gütefaktoren und die grundlegenden verfeinerten Parameter) finden sich in der Tabelle der Figur 21.

Die gesammelten Beugungsbilder wurden auf ihre Auslöschbedingungen hin sehr genau untersucht. Als Grundmuster ist eine vom AlN (Wurtzitstrukturtyp) abgeleitete Struktur erkennbar, die in der Raumgruppe $P2_1$ beschrieben werden kann.

Die Lösung und Verfeinerung des Datensatzes erfolgte mit dem Programmpaket JANA2006 (Petricek,V., Dusek,M. &Palatinus,L.(2006). Jana2006. The crystallographic computing system. Institute of Physics, Praha, Czech Republic.).

Die Verfeinerung gelingt sehr gut mit folgenden Beschränkungen: Da Si und Al röntgenographisch nicht unterscheidbar sind, wurden alle Si und Al-Positionen mit der eingewogenen Besetzung von Si:Al=1:1 und einem einzigen thermischen Auslenkungsfaktor für Si und Al verfeinert.

Es wurden weiterhin je alle N-Atome zusammen und je alle Erdalkaliatome zusammen mit einem thermischen Auslenkungsfaktor beschrieben. Alle weiteren Parameter (z. B. die Atomlageparameter) wurden frei verfeinert.

Ergebnisse dieser einkristallographischen Untersuchungen sind im folgenden näher diskutiert.

Figur 18 zeigt den kristallographischen Zusammenhang zwischen verschiedenen leuchtenden Nitriden und AlN.

Eine ganze Reihe an bekannten, als Leuchtstoff verwendeten Nitriden lassen sich von AlN mit Wurtzit-Struktur ableiten. Wegen dieser grundlegenden strukturellen Verwandtschaft sehen sich auch die Diffraktogramme (v. a. Röntgenpulverdiffraktogramme) dieser Verbindungen auf den ersten Blick oft ähnlich. Unterschiede zeigen sich jedoch in deutlich ausgeprägten Details. Die Strukturen können sich signifikant unterscheiden, wie in Figur 18 exemplarisch an der Ableitung der Elementarzellen für verschiedene Verbindungen dargestellt ist.

In Figuren 20a bis 20c wird für die neue Struktur $Sr(Sr_aCa_{1-a})Si_2Al_2N_6$ (die Dotierung spielt für diese grundsätzliche Überlegung keine Rolle) gezeigt, warum sie eindeutig in der Raumgruppe $P2_1$ beschrieben werden muss und nicht in einer der beiden anderen oben aufgeführten Raumgruppen beschrieben werden kann.

Gemäß Figur 20 sind die Einkristall-Beugungsdaten im reziproken Raum für den neuartigen Leuchtstoff $Sr(Sr_aCa_{1-a})Si_2Al_2N_6$ untersucht. Figur 20a ist eine Darstellung des neuartigen Leuchtstoffs im reziproken Raum mit Blickrichtung [*h*0*l*].

Die pseudohexagonale Grundstruktur ist klar erkennbar.

Figur 20b ist eine Darstellung des neuartigen Leuchtstoffs im reziproken Raum mit Blickrichtung [0*kl*]. Die eingekreisten Reflexe sind Beispiele für Reflexe, die es in der Raumgruppe *Pna*21 nicht geben darf. Ihr Auftreten schließt eine Beschreibung in dieser Raumgruppe *Pna*21 wegen der Auslöschbedingungen verschiedener kristallographischer Raumgruppen aus. Der neue Leuchtstoff kann also nicht die gleiche Struktur haben wie z.B.

$MgSiN_2$, oder $MnSiN_2$.

Schließlich zeigt Figur 20c eine Darstellung des neuartigen Leuchtstoffs im reziproken Raum mit Blickrichtung [*h*1*l*].

Die eingekreisten Reflexe sind Beispiele für Reflexe, die es in der Raumgruppe *Cmc*21 nicht geben darf. Ihr deutlich erkennbares Auftreten schließt eine Beschreibung in Raumgruppe *Cmc*21 aus. Der neue Leuchtstoff kann also nicht die gleiche Struktur haben wie z.B. $(Ca,Sr)AlSiN_3$, $LiSi_2N_3$, $NaSi_2N_3$.

Figur 19 zeigt eine Übersicht über einige literaturbekannte Strukturdaten von Nitriden ähnlicher Zusammensetzung (Raumgruppe $Cmc2_1$, $NaSiO_3$-Strukturtyp)

Die Einkristalldiffraktometrische Lösung der neuen Struktur $Sr(Sr_aCa_{1-a})\ Si_2Al_2N_6$ ist im Detail in Figur 21 dargestellt. Dort sind die Gitterparameter, die Formeleinheit, die für die Untersuchung verwendete Strahlungsquelle, die Reflexe, der gemessene Ausschnitt des reziproken Raums und weitere Daten angegeben.

In Figur 22 sind die Atomabstände in der neuen Struktur $Sr(Sr_aCa_{1-a})\ Si_2Al_2N_6$ im Detail dargestellt. Im direkten Vergleich mit Nitriden ähnlicher Zusammensetzung, z.B. $SrAlSiN_3$ (ICSD 419410), $CaAlSiN_3$ (ICSD 161796) oder $(Sr,Ca)AlSiN_3$ (ICSD 163203) (vgl. Tabelle der Figur 19 für weitere Beispiele) ist anzumerken, dass es eine etwas größere und eine etwas kleinere Umgebung um die Erdalkaliatome Sr und Ca gibt. In $SrAlSiN_3$, $CaAlSiN_3$ und $(Sr,Ca)AlSiN_3$ gibt es für die Erdalkaliatome nur eine 5-fach koordinierte Lage mit einem mittleren Sr-N-Abstand von 267 pm. In der erfindungsgemäßen neuen Struktur $Sr(Sr_aCa_{1-a})\ Si_2Al_2N_6$ bildet Sr1 eine 6-fach koordinierte Umgebung mit 272 pm mittlerem Sr1-N-Abstand, Sr2/Ca2 bildet eine 5-fach Koordination mit 264 pm mittlerem Sr2/Ca2-N-Abstand aus.

In Figur 23 sind die kristallographischen Daten und Lageparameter (gemäß Einkristallographie) für eine neuartige Verbindung $Sr(Sr_aCa_{1-a})\ Si_2Al_2N_6$ verglichen mit den entsprechenden Daten für das vorbekannte $SrAlSiN_3$:Eu (rechts). Die Kristallsysteme und Raumgruppen unterscheiden sich deutlich.

Anhand Figur 24 wird die Struktur des neuartigen Leuchtstofftyps $Sr(Sr_aCa_{1-a})\ Si_2Al_2N_6$ erläutert. Figur 24a zeigt einen Blick auf die Schichten von $Sr(Sr_aCa_{1-a})\ Si_2Al_2N_6$. Die Schichten sind von AlN abgeleitet. Verglichen mit AlN fehlen einzelne Tetraeder, die durch ein Erdalkaliion ersetzt sind. Die Tetraeder sind gegenüber AlN deutlich verzerrt. Alle Bindungslängen und Winkel sind jedoch ähnlich wie bei anderen Nitridosilikaten. Figur 20b zeigt den erfindungsgemäßen Leuchtstoff $Sr(Sr_aCa_{1-a})\ Si_2Al_2N_6$ aus Richtung [010]. Das 3D-Raumnetz der $(Si/Al)N_4$-Tetraeder ist deutlich erkennbar. In der *a*-*c*-Ebene verlaufen Schichten, die in *b*-Richtung (nicht dargestellt) zu einem Raumnetz verknüpft sind. Dazwischen eingelagert befindet sich jeweils schichtweise die reine Sr-Lage (als weiße Kreise dargestellt) bzw. die Sr/Ca mischbesetzte Lage (als schwarze Kreise dargestellt).

Figur 24 c zeigt zum Vergleich die literaturbekannte Struktur von $(Sr_{0.846}Ca_{0.211})AlSiN_3$ (ICSD 163203) aus Richtung [010]. Hier sind sämtliche Sr/Ca-Lagen (schwarz) mischbesetzt. Es gibt keine reinen Sr-Lagen.

Diese Ausordnung in eine mit Sr/Ca mischbesetzte und eine allein mit Sr vollbesetzte Lage bei dem erfindungsgemäßen neuen Leuchtstoff $Sr(Sr_aCa_{1-a})\ Si_2Al_2N_6$:Eu ist vorteilhaft z. B. gegenüber der Struktur von SCASN (vgl. Figur 24c), bei dem für die Aktivatoratome (Dotierung) nur eine mischbesetzte Lage zur Verfügung steht, was zur Verbreiterung von Emission, die ja auf der Wechselwirkung zwischen dem Aktivator und dem umgebenden Wirtsgitter basiert, und zu stärkeren Quenchingeigenschaften führt. Die erfindungsgemäße Struktur $Sr(Sr_aCa_{1-a})\ Si_2Al_2N_6$:Eu bietet dem Aktivator, hier bevorzugt Eu, dagegen eine ausgeordnete Sr-Lage an, ohne Unordnung und ohne die damit verbundenen Nachteile. Die verbesserten Eigenschaften der Lumineszenz lassen sich mit dieser Struktur zwanglos erklären. Das Eu besetzt gemäß dieser Modellvorstellung überwiegend nur die reine Sr-Ebene, aber eher weniger die Mischebene.

Ausgehend von Figur 24b lässt sich auch ein Leuchtstoff mit der niedrigeren Symmetrie entsprechend der Raumgruppen 1 bis 3 der International Tables Cryst. A, also den Raumgruppen P1, P1, P2 darstellen, indem zum Beispiel die Mischschicht in Ebenen mit unterschiedlicher Besetzung (teilweise) durch reines Sr nebst Mischbesetzung aufgespalten ist.

In Figur 25 und Figur 26 findet sich eine kristallographische Auswertung. Figur 25 zeigt eine Rietveld-Verfeinerung des Röntgenpulverdiffraktogramms von Muster TF162bG/12, ein Ausführungsbeispiel des erfindungsgemäßen, neuen Leuchtstoffes mit der Einwaagezusammensetzung $Sr(Sr_{0.8}Ca_{0.2})Si_2Al_2N_6$:Eu. Das Diffraktogramm lässt sich mit dem anhand der Einkristallröntgenstrukturanalyse ermittelten Strukturmodell für $Sr(Sr_aCa_{1-a})\ Si_2N_2N_6$ sehr gut beschreiben (Rprofil 7%, Rbragg 6%) .

Figur 26 zeigt einen Ausschnitt der Rietveld- Verfeinerung des Röntgenpulverdiffraktogramms von TF162bG/12 vergrößert. Der mit einem Pfeil markierte Reflex ist ein Beispiel eines Reflexes von $Sr(Sr_{0.8}Ca_{0.2})Si_2Al_2N_6$: Eu, der in der Raumgruppe $P2_1$ und anderen niedriger symmetrischen Raumgruppen wie der Raumgruppe P1 vorkommen kann. Das Auftreten dieses Reflexes schließt eine Beschreibung des neuartigen Leuchtstoffs in den höher symmetrischen Raumgruppen Cmc21 und *Pna*21 der anderen AlN verwandten nitridosilikatischen Leuchtstoffe definitiv aus.

Figur 27/28 und Figur 29/30 und 31/32 und Figur 33/34 zeigt exemplarisch weitere Rietveld- Verfeinerungen des Röntgenpulverdiffraktogramms von anderen Ausführungsbeispielen, wie im Diagramm jeweils angegeben, jeweils mit einem charakteristischen Ausschnitt.

Figuren 35a und b zeigen das Absorptions- und Emissionsverhalten eines erfindungsgemäßen Leuchtstoffs im Vergleich zu bekannten Leuchtstoffen.

In Figur 35a sind Emissionsspektren und in Figur 35b Remissionsspektren eines Ausführungsbeispiels des neuen Leuchtstoffs $Sr(Sr_aCa_{1-a})Si_2Al_2N_6$:Eu mit a=0.8 und 0.8% Eu im Vergleich zu bekannten Leuchtstoffen aus dem System $Sr_xCa_{1-x}AlSiN_3$:Eu mit vergleichbarer Dominanzwellenlänge ldom (ldom ≈ 600 nm) dargestellt. Aufgetragen sind die Wellenlänge l gegenüber der Intensität I und der Remission R. Die Emissionsspektren zeigen eine unerwartet spektral schmale Emission des neuen Leuchtstoffs $Sr(Sr_aCa_{1-a})Si_2Al_2N_6$:Eu mit a=0.8. Gleichzeitig zeichnet sich der neue Leuchtstoff $Sr(Sr_aCa_{1-a})Si_2Al_2N_6$:Eu mit a=0.8 durch eine starke Absorption aus, siehe Figur 35b. Die Absorption ergibt sich dabei näherungsweise als 1-R.

Figuren 36a und b zeigen das Absorptions- und Emissionsverhalten eines weiteren erfindungsgemäßen Leuchtstoffs im Vergleich zu bekannten Leuchtstoffen.

In Figur 36a sind Emissionsspektren und in Figur 36b Remissionsspektren eines Ausführungsbeispiels des neuen Leuchtstoffs $Sr(Sr_aCa_{1-a})Si_2Al_2N_6$:Eu mit a=0.8 und 1.2% Eu im Vergleich zu bekannten Leuchtstoffen aus dem System $Sr_xCa_{1-x}AlSiN_3$:Eu mit vergleichbarer Dominanzwellenlänge ldom (ldom ≈ 602-603 nm) dargestellt. Aufgetragen sind die Wellenlänge l gegenüber der Intensität I und der Remission R. Die Emissionsspektren zeigen eine unerwartet spektral schmale Emission des neuen Leuchtstoffs $Sr(Sr_aCa_{1-a})Si_2Al_2N_6$:Eu mit a=0.8. Gleichzeitig zeichnet sich der neue Leuchtstoff $Sr(Sr_aCa_{1-a})Si_2Al_2N_6$:Eu mit a=0.8 durch eine starke Absorption, siehe Figur 36b. Die Absorption ergibt sich dabei näherungsweise als 1-R.

Der hier beschriebene, neuartige Leuchtstoff bietet insbesondere die folgenden Vorteile:

- niedrigere Halbwertsbreite der Emission und damit verbunden höherer visueller Nutzeffekt bei gleicher Dominanzwellenlänge,
- die Möglichkeit, höhere Aktivatorkonzentrationen von Eu mit > 0.8% zu realisieren bei gleichzeitig hoher Quanteneffizienz und Konversionseffizienz, damit einhergehend geringerer Leuchtstoffbedarf in LED-Anwendungen und vereinfachte Prozessierbarkeit,
- verbesserte Alterungsstabilität gegenüber Feuchtigkeit im Vergleich zu herkömmlichem $(Sr,Ca)AlSiN_3$:Eu mit niedrigem Sr-Gehalt, und
- Verbesserung der Temperaturstabilität.

Figur 37 zeigt ein Halbleiterbauelement, das als Lichtquelle (LED) für weißes Licht dient. Für den Einsatz in einer weißen LED zusammen mit einem GaInN-Chip wird beispielsweise ein Aufbau ähnlich wie in US 5 998 925 beschrieben verwendet. Der Aufbau einer derartigen Lichtquelle für weißes Licht ist in Figur 37 explizit gezeigt. Die Lichtquelle, die Strahlungsquelle für die Primärstrahlung ist ein Halbleiterbauelement, das Primärstrahlung im UV- und/oder blauen Wellenlängenbereich emittieren kann. Beispielsweise kann als Strahlungsquelle ein Halbleiterbauelement (Chip 1) des Typs InGaN mit einer PeakEmissionswellenlänge von 460 nm mit einem ersten und zweiten elektrischen Anschluss 2,3, verwendet werden, das in ein lichtundurchlässiges Grundgehäuse 8 im Bereich einer Ausnehmung 9 eingebettet ist. Einer der Anschlüsse 3 ist über einen Bonddraht 14 mit dem Chip 1 verbunden. Die Ausnehmung hat eine Wand 17, die als Reflektor für die blaue Primärstrahlung des Chips 1 dient. Die Ausnehmung 9 ist mit einer Vergussmasse 5 gefüllt, die als Hauptbestandteile ein Vergussmasse und Leuchtstoffpigmente 6 (weniger als 50 Gew.-%) enthält. Weitere geringe Anteile entfallen z. B. u.a. auf Methylether und Aerosil. Die Leuchtstoffpigmente sind eine Mischung aus verschiedenen hier beschriebenen Leuchtstoffmischungen, die auch erfindungsgemäße Leuchtstoffe enthalten, z. B. LuAG:Ce-Pigmente und Pigmente des neuartigen Leuchtstoffs.

Generell können bei einem UV-Strahlung emittierenden LED-Chip als Strahlungsquelle eine Leuchtstoffmischung aus zumindest drei verschiedenen Leuchtstoffen (blau emittierender Leuchtstoff, wie z. B. $BaMgAl_{10}O_{17}:Eu^{2+}$ oder $(Ba,Sr,Ca)_5(PO_4)_3Cl:Eu^{2+}$ zusammen mit einem grün-gelb emittierenden Leuchtstoff, z. B. einen der hier beschriebenen Granat-Leuchtstoffe und einem z. B. erfindungsgemäßen orange-rot emittierenden Leuchtstoff) und bei einem blaues Licht emittierenden LED-Chip als Strahlungsquelle eine Leuchtstoffmischung mit zumindest zwei verschiedenen Leuchtstoffen (einem grün-gelben Leuchtstoff. B. einen der hier beschriebenen Granat-Leuchtstoffe und einem z. B. erfindungsgemäßen orange-rot emittierenden Leuchtstoff) verwendet werden.

In Figur 38 ist ein Ausschnitt aus einer Flächenleuchte 20 als Beleuchtungseinheit gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne HalbleiterBauelemente 24 untergebracht sind. Sie sind UV-emittierende und/oder blaues Licht als Primärstrahlung emittierende Leuchtdioden mit einer Peakemission von 380 nm. Die Umwandlung in weißes Licht erfolgt mittels Konversionsschichten, die direkt im Gießharz der einzelnen LED sitzen ähnlich wie in Figur 37 beschrieben oder Schichten 25, die auf allen der UV-Strahlung zugänglichen Flächen (insbesondere sind das keramische Flächen oder Platten) angebracht sind. Dazu zählen die innen liegenden Oberflächen der Seitenwände des Gehäuses, der Abdeckung und des Bodenteils. Die Konversionsschichten 25 umfassen im Falle von UV-Licht emittierenden LEDs drei Leuchtstoffe, die im rot-orangen, gelb-grünen und blauen Spektralbereich emittieren unter Benutzung erfindungsgemäßer Leuchtstoffe. Wenn die LEDs als Strahlungsquellen blaue Strahlung als Primärstrahlung emittieren können, wie bereits oben beschrieben lediglich auch nur zwei verschiedene, grün-gelb und orange-rot emittierende Leuchtstoffe in den Leuchtstoffmischungen vorhanden sein.

In einer Reihe weiterer Ausführungsbeispiele der vorliegenden Erfindung wurden herkömmliche blaues Licht emittierende InGaN-LEDs mit einem herkömmlichen Silikon-Verguß versehen, in dem unterschiedliche Mengen an verschiedenen erfindungsgemäßen Leuchtstoffen bzw. herkömmlichen Leuchtstoffen als Vergleichsbeispiele eingebettet sind. Dabei sollen insbesondere erfindungsgemäße Leuchtstoffe zum Teil zusammen mit anderen Leuchtstoffen zur Farbkonversion eines blauen Primärlichts in den roten, bzw. gelben oder gelb-orangen Wellenlängenbereich verwendet werden. Diese Leuchtstoffe können dabei unter anderem auch für eine Vollkonversion des Primärlichts der primären Strahlungsquelle in den roten, bzw. gelben oder gelb-orangen Wellenlängenbereich verwendet werden.

Alternativ kann als Primär-Strahlungsquelle anstelle einer LED, wie einer InGaN-LED auch eine organische lichtemittierende Vorrichtung (OLED) verwendet werden, die einen Schichtstapel von organischen, halbleitenden Schichten umfasst, die zwischen einer Anode und einer Kathode angeordnet sind. In diesem Fall muss wenigstens eine der Elektroden transparent für die von der OLED erzeugte Strahlung sein, wobei die erfindungsgemäßen Leuchtstoffe dann im Strahlengang der Strahlung über der transparenten Elektrode angeordnet werden können.

**Ausführungsbeispiele für Vollkonversion Rot:**

Die Tabelle in Figur 40a zeigt dabei die Dominanzwellenlänge der blau emittierenden LED ($\lambda_{dom(blaue\ LED)}$), die chemischen Formeln der eingesetzten erfindungsgemäßen und herkömmlichen Leuchtstoffe sowie deren Konzentrationen im Verguß (Gewichtsprozent bezogen auf den gesamten Verguß), die x-und y-Farbkoordinaten der konvertierten Sekundärstrahlung im CIE-Farbraum sowie den resultierenden Lichtstrom $\Phi_{v(Verguß)}$ und die Strahlungsleistung $\Phi_{v(Verguß)}$ der vergossenen LEDs jeweils relativ zu dem Wert $\Phi_{e(kein\ Verguß)}$ der LEDs ohne Verguß (Angaben jeweils relativ zum Vergleichsbeispiel). Alle weiteren Tabellen beinhalten ebenfalls diese Parameter und gegebenenfalls weitere Parameter, zum Beispiel Mischungsverhältnisse bei der Mischung zweier verschiedener Leuchtstoffe in dem Verguß einer LED.

Dieser Tabelle in Figur 40a lässt sich eindeutig entnehmen, dass bei sehr ähnlichem Farbort im rot-orangenen Bereich (x-und y-CIE Farbkoordinaten) der erfindungsgemäße Leuchtstoff gemäß Ausführungsbeispiel 1 im Vergleich zum herkömmlichen Leuchtstoff gemäß Vergleichsbeispiel 1 einen höheren Lichtstrom wie auch eine höhere Strahlungsleistung aufweist. Dies lässt sich auch dem dazugehörigen Emissionsspektrum der Figur 40b entnehmen, bei dem deutlich zu erkennen ist, dass das Ausführungsbeispiel 1 eine höhere Lichtintensität aufweist im Vergleich zu der LED des Vergleichsbeispiels 1.

In der Tabelle der Figur 41a werden wiederum der Lichtstrom und die Strahlungsleistung einer blau emittierenden LED mit einem herkömmlichen $CaAlSiN_3$-Leuchtstoff (Vergleichsbeispiel 2, Leuchtstoff gemäß der EP Patentanmeldung EP 1 696 016 A1 erfolgt) einer LED gegenübergestellt, in deren Silikon-Verguß eine Ausführungsform eines erfindungsgemäßen Leuchtstoffs eingebracht wurde (Ausführungsbeispiel 2). Aufgrund der guten Stabilität der erfindungsgemäßen Leuchtstoffe können diese auch mit einem höheren Anteil an Aktivator-Dotierstoffen verwendet werden (im vorliegenden Fall 5 %) im Vergleich zu $CaAlSiN_3$-Leuchtstoffen, bei denen ein entsprechender Farbort nur mit sehr niedrigen Eu-Dotierungen erreicht werden kann (im vorliegenden Fall 0,4 %). Der Tabelle in der Figur 41a kann wieder entnommen werden, dass bei vergleichbaren Farborten beider LEDs im roten Farbraum die LED mit dem erfindungsgemäßen Leuchtstoff einen höheren Lichtstrom und eine höhere Strahlungsleistung aufweist. Dies lässt sich ebenso dem Emissionsspektrum der Figur 41b entnehmen in dem die Emissionsspektren des Vergleichsbeispiels 2 und des Ausführungsbeispiels 2 gegenübergestellt werden.

Bei den in der EP-Patentanmeldung EP 1 696 016 A1 beschriebenen zweiten Leuchtstoffen handelt es sich insbesondere um Leuchtstoffe, die die Elemente M, A, D, E, und X aufweisen, wobei M eines oder mehrere Elemente ausgewählt aus der Gruppe bestehend aus: Mn, Ce, Pr, Nd, Sm, Eu, Tb, Dy, Ho, Er, Tm, und Yb, A eines oder mehrere Elemente ausgewählt aus der Gruppe bestehend aus divalenten Metallelementen, die unterschiedlich sind zu M, D eines oder mehrere Elemente ausgewählt aus der Gruppe bestehend aus tetravalenten Metallelementen, E eines oder mehrere Elemente ausgewählt aus der Gruppe bestehend aus trivalenten Metallelementen, X eines oder mehrere Elemente ausgewählt aus der Gruppe bestehend aus: O, N, und F und wobei die Leuchtstoffe die gleiche Kristallstruktur wie $CaAlSiN_3$ aufweisen.

Weiterhin können als zweite Leuchtstoffe auch noch Leuchtstoffe der allgemeinen Formel $(M_{1-x}Eu)_x(Al,Q)(Si,Y)N_3$ verwendet werden, wobei M = Ca, Sr, alleine oder in Kombination oder in Kombination mit anderen divalenten und/oder monovalenten Elementen, beispielsweise Li, Q = trivalentes Kation anders als $Al^{3+}$, Y = andere tetravalente Kationen anders als $Si^{4+}$, $N^{3-}$ kann teilweise durch $O^{2-}$, $F^-$, $Cl^-$, $Br^-$, $C^4$-substituiert sein.

In der Tabelle in der Figur 42a werden das Vergleichsbeispiel 3 und das Ausführungsbeispiel 3 gegenübergestellt. Im Ausführungsbeispiel 3 wird wiederum ein herkömmlicher $CaAlSiN_3$-Leuchtstoff $CaAlSi(N,O)_3$:Eu (0,4%) als erster Leuchtstoff verwendet, wobei im Verguß eine weitere Ausführungsform eines erfindungsgemäßen Leuchtstoffs zusätzlich als zweiter Leuchtstoff eingebracht wurde. Im vorliegenden Fall ist der $CaAlSiN_3$-Leuchtstoff in der Lage die kurzweiligen Anteile der vom erfindungsgemäßen Leuchtstoff konvertierten Sekundärstrahlung zu absorbieren und in rotes Licht mit gegenüber dem Ausgangslicht längeren Wellenlängen zu konvertieren. Dieser Ansatz hat den Vorteil, dass im Gegensatz zu wellenlängenspezifischen Filtern die Strahlung nicht nur absorbiert wird sondern aufgrund der Konversion im Leuchtstoff wieder abgestrahlt wird, was zu einer erhöhten Strahlungsleistung der LED führt. Der Tabelle lässt sich wiederum entnehmen, dass bei ähnlichem Farbort im CIE-Farbraum sowohl der Lichtstrom als auch die Strahlungsleistung des Ausführungsbeispiels 3 gegenüber dem Vergleichsbeispiel 3 stark zugenommen hat. Dies lässt sich ebenso dem Emissionsspektrum der Figur 42b entnehmen.

Analog zum Ausführungsbeispiel 3 wird auch im Ausführungsbeispiel 4, das einem Vergleichsbeispiel 4 in der Tabelle der Figur 43a gegenübergestellt wird, ein herkömmlicher $CaAlSiN_3$-Leuchtstoff verwendet, der die kurzweiligen Anteile des vom erfindungsgemäßen Leuchtstoff konvertierten Lichts absorbiert und als Rotlicht höherer Wellenlänge wieder abstrahlt. Auch diese Tabelle und das entsprechende Emissionsspektrum in der Figur 43b zeigen, dass bei ähnlichem Farborten die LED mit dem erfindungsgemäßen Leuchtstoff einen höheren Lichtstrom und eine höhere Strahlungsleistung im Vergleich zu der LED mit den herkömmlichen Leuchtstoffen aufweist.

Zwei Ausführungsbeispiele 5 und 6 werden in der Tabelle der Figur 44a einem Vergleichsbeispiel 5 gegenübergestellt. Bei allen LEDs wird die blaue Primärstrahlung in eine orange Sekundärstrahlung konvertiert, wobei im Vergleichsbeispiel 5 ausschließlich herkömmliche Leuchtstoffe verwendet werden und in den Ausführungsbeispielen 5 und 6 jeweils unterschiedliche Ausführungsformen von erfindungsgemäßen Leuchtstoffen mit einem Cer-aktivierten Yttrium-Aluminium-Granat-Leuchtstoff verwendet werden. Dieser Tabelle lässt sich ebenso wie dem dazugehörigen Emissionsspektrum der Figur 44b entnehmen, dass die LEDs mit der Kombination an Leuchtstoffen, die erfindungsgemäße Leuchtstoffe beinhalten einen höheren Lichtstrom und eine höhere Strahlungsleistung aufweisen, als LEDs mit herkömmlichen Leuchtstoffen.

Im Folgenden sollen weitere Leuchtvorrichtungen beschrieben werden, bei denen im Verguß der die Primärstrahlung abstrahlenden Strahlungsquelle, beispielsweise einer blauen LED, unterschiedliche Mengen von erfindungsgemäßen Leuchtstoffen mit hohen Europium-Konzentrationen als Dotierstoff vorhanden sind. Derartige Leuchtvorrichtungen können beispielsweise auch zur Vollkonversion der Primärstrahlung der Strahlungsquelle in eine Sekundärstrahlung, beispielsweise in einem roten, bzw. gelben oder gelb-orangen Wellenlängenbereich eingesetzt werden. Insbesondere können Leuchtvorrichtungen gemäß bestimmten Ausführungsformen als ein Primärlicht abstrahlende Strahlungsquelle eine blaue LED mit einer Dominanzwellenlänge von 300-500 nm, bevorzugt 400-500 nm, weiterhin bevorzugt 420-470 nm aufweisen, sowie einen erfindungsgemäßen Leuchtstoff der allgemeinen Formel $Sr(Sr_aM_{1-a})Si_2Al_2N_6$:D, wobei M ausgewählt ist aus der Gruppe Ca, Ba, Zn, Mg, bevorzugt Ca und D bevorzugt Eu und wobei die Europium-Konzentrationen ≥6 Mol%, weiter bevorzugt ≥ 8 Mol% sein können. Die emittierte Strahlung dieser Strahlungsquellen kann dabei eine Halbwertsbreite FWHM ≤90 nm, bevorzugt ≤ 85 nm und eine Dominanzwellenlänge ≥ 607 nm, bevorzugt ≥609 nm aufweisen.

Die Tabelle der Figur 45a zeigt verschiedene Ausführungsbeispiele von Leuchtvorrichtungen bei denen unterschiedliche Konzentrationen an erfindungsgemäßen Leuchtstoffen im Verguß einer herkömmlichen blauen InGaN-LED mit einem Standard-Silikon-Verguß eingebracht sind.

Trotz der hohen Europium-Konzentrationen zeigt dabei die Figur 45b, dass die Halbwertsbreiten der emittierten Strahlungen mit zunehmenden Europium-Konzentrationen bei erfindungsgemäßen Leuchtstoffen der allgemeinen Formel $Sr(Sr_aM_{1-a})Si_2Al_2N_6$:Eu weniger stark zunehmen als bei herkömmlichen Leuchtstoffen der Formeln $CaAlSiN_3$:Eu oder $Sr_2Si_5N_8$:Eu. Die Figur 45c zeigt ebenfalls, dass bei erfindungsgemäßen Leuchtstoffen mit zunehmendem Europium Anteil überraschenderweise im Vergleich zu herkömmlichen Leuchtstoffen die Quanteneffizienz weniger stark abnimmt. Figur 45d zeigt die Emissionsspektren der drei Ausführungsbeispiele 1 bis 3 wobei deutlich zu erkennen ist, dass bis auf einen sehr geringen Anteil der Primärstrahlung die gesamte, von der Leuchtvorrichtung emittierte Strahlung auf konvertierte Sekundärstrahlung mit einer geringen Halbwertsbreite FWHM zurückzuführen ist. Diese Eigenschaften von erfindungsgemäßen Leuchtstoffen erlauben die Bereitstellung von Leuchtvorrichtungen, die im Rahmen einer Vollkonversion der Primärstrahlung tiefrotes Licht emittieren.

Die erfindungsgemäßen Leuchtstoffe können dabei mit einer Vielzahl an verschiedenen Granat-Leuchtstoffen als zweite Leuchtstoffe verwendet werden. Diese können insbesondere die allgemeine Strukturformel:

$$(Gd,Lu,Tb,Y)_3(Al,Ga,D)_5(O,X)_{12}:RE$$

mit X = Halogenid, N oder zweiwertiges Element, D = drei- oder 4-wertiges Element und RE = Seltenerdmetalle als Aktivator, insbesondere Cer mit einem optionalen Co-Dotierstoff, wie z. B. Lanthanoide, z.B. Pr, Sm, Nd aufweisen. Die Granate können weiterhin auch die folgende allgemeine Formel:

$$(Gd,Lu,Tb,Y)_3(Al,Ga)_5(O)_{12}:RE$$

mit RE = Seltenerdmetalle als Aktivator, insbesondere Cer mit einem optionalen Co-Dotierstoff, wie z. B. Lanthanoide, z.B. Pr, Sm, Nd
aufweisen.

**Ausführungsbeispiele für Straßenbeleuchtungsanwendungen:**

Gemäß einer weiteren Ausführungsform können Beleuchtungsvorrichtungen bereitgestellt werden, die insbesondere auch für Allgemeinbeleuchtungsanwendungen, wie beispielsweise Straßenbeleuchtungen mit einem CRI ≥ 70 und hohen Farbtemperaturen (~ 5000 K) eingesetzt werden können.

Insbesondere können diese Beleuchtungsvorrichtungen als Strahlungsquelle eine blaue LED mit einer Dominanzwellenlänge von 300-500 nm, bevorzugt 400-500 nm, weiter bevorzugt 420-470 nm aufweisen, wobei im Strahlengang der Strahlungsquelle als erster Leuchtstoff zumindest ein erfindungsgemäßer Leuchtstoff der allgemeinen Formel $Sr(Sr_aM_{1-a})Si_2Al_2N_6$:D, wobei M ausgewählt ist aus der Gruppe Ca, Ba, Zn, Mg mit D = Eu, vorhanden ist und als zweiter Leuchtstoff zumindest ein gelb-grün emittierender Granat-Leuchtstoff der allgemeinen Formel $(Y,Lu,Gd)_3(Al,Ga)_5O_{12}$:Ce vorhanden ist.

Als erster Leuchtstoff kann dabei ein erfindungsgemäßer Leuchtstoff der allgemeinen Formel $Sr(Sr_aM_{1-a})Si_2Al_2N_6$:D, wobei M ausgewählt ist aus der Gruppe Ca, Ba, Zn, Mg, bevorzugt Ca, und D bevorzugt Eu verwendet werden mit a ≥ 0,8, bevorzugt a ≥ 0,82, weiter bevorzugt a ≥ 0,85 und einem Europium-Anteil von 0,1-5 Mol%, bevorzugt 0,1-3 Mol%, weiter bevorzugt 0,1 bis 2 Mol%. Der erfindungsgemäße Leuchtstoff weist eine Peakemissionswellenlänge von etwa 600-640 nm, bevorzugt 605-625 nm und eine Halbwertsbreite FWHM von < 85 nm bevorzugt < 80 nm, weiter bevorzugt < 78 nm auf. Ein derartiger erfindungsgemäßer Leuchtstoff kann zusammen mit dem Granat-Leuchtstoff als zweiter Leuchtstoff eine Beleuchtungsvorrichtung ergeben, bei der ein weiter Bereich an korrelierter Farbtemperatur CCT im Bereich von zumindest 6500-4000 K, bevorzugt 6500-3000 K möglich ist, wobei der CRI zumindest 70 beträgt.

Dabei kann der Granat-Leuchtstoff als zweiter Leuchtstoff insbesondere die allgemeine Formeln $Lu_3(Al,Ga)_5O_{12}$:Ce oder $(Y,Lu)_3(Al,Ga)_5O_{12}$:Ce aufweisen, wobei das Maximum der Anregbarkeit dann bevorzugt zwischen 440-455 nm, weiter bevorzugt zwischen 454-450 nm liegt. Der gelb-grün emittierende Granat-Leuchtstoff wird derart ausgewählt, dass er eine hohe Konversionseffizienz und hohe Temperaturstabilität aufweist. Ein bevorzugter gelb-grün emittierender Leuchtstoff ist ein $(Y,Lu)_3(Al,Ga)_5O_{12}$:Ce mit einem Cer-Anteil von 0,5-5 Mol%, bevorzugt 1-3 Mol% und einem Y-Anteil von 0-50 Mol%, bevorzugt 0-30 Mol%, sodass ein Leuchtstoff der allgemeinen Formel $(Lu_{1-x}Y_x)_3(Al,Ga)_5O_{12}$:Ce mit x = 0 bis 0,5, bevorzugt x= 0 bis 0,3 resultiert. Auch andere Varianten des Granat-Leuchtstoffs sind möglich, die ähnliche spektrale Charakteristika aufweisen, insbesondere Varianten mit $(Y,Lu)_3(Al,Ga)_5O_{12}$:Ce, bei denen zumindest teilweise das Al gegen Ga ausgetauscht ist.

Gemäß einer weiteren Ausführungsform wird ein Granat-Leuchtstoff der folgenden allgemeinen Formel $Y_3(Al,Ga)_5O_{12}$:Ce verwendet, der ein Maximum der Anregbarkeit im Bereich von 440-455 nm, bevorzugt 445-450 nm aufweist. Der bevorzugte gelb-grün emittierende Leuchtstoff wird derart ausgewählt dass er eine hohe Konversionseffizienz und hohe Temperaturstabilität aufweist. Der bevorzugte gelb-grün emittierende Leuchtstoff ist ein Leuchtstoff der allgemeinen Formel $Y_3(Al,Ga)_5O_{12}$:Ce mit einem Cer-Anteil von 1,5-5 Mol%, bevorzugt 2-5 Mol% und einem Gallium-Anteil von 0-50 Mol%, bevorzugt 0-30 Mol%. Innerhalb dieses Systems sind aber auch noch andere Element-Kombinationen möglich, die in ähnlichen spektralen Eigenschaften resultieren.

Im Folgenden sollen die optischen Eigenschaften von zwei Vergleichsbeispielen 1 und 2 bei denen im Standard-Silikon-Verguß einer herkömmlichen InGaN-LED mit der Dominanzwellenlänge 444,5 bzw. 444,6 nm bei 350 mA ein Granat-Leuchtstoff mit einem herkömmlichen 2-5-8-Leuchtstoff kombiniert ist, mit drei Ausführungsbeispielen der vorliegenden Erfindung verglichen werden. Die Fläche der LED-Chips beträgt jeweils 1 $mm^2$.

Die Zusammensetzungen der verschiedenen Leuchtstoffe sowie die jeweiligen Konzentrationen der Leuchtstoffe im Standard-Verguß und die relativen Anteile der beiden Leuchtstoffe sind in Figur 46a angegeben.

Der Tabelle der Figur 46b kann entnommen werden, dass bei ähnlichen Farbkoordinaten die LEDs der Ausführungsbeispiele 1-4 mit den erfindungsgemäßen Leuchtstoffen bei einem Treiberstrom von 350 mA eine höhere oder ähnliche Konversionseffizienz als Verhältnis von dem Lichtstrom $\Phi_v$ einer LED mit einem mit den Leuchtstoffmischungen gefüllten Verguß und der Strahlungsleistung $\Phi_e$ einer LED mit einem klaren Verguß ohne Leuchtstoffe $\Phi(_{v(gefüllter\ Verguß)}/\Phi_{e(klarer}$ Verguß) im Vergleich zu den LEDs mit der herkömmlichen Leuchtstoffmischung aufweisen, wobei aber der CRI höher ist. Die Farbpunktkorrektur wurde durchgeführt indem ein theoretisches Modell des Vergleichsbeispiels 2 genommen wurde und die LED Effizienz des Vergleichsbeispiels für die Farbpunkte der anderen Ausführungsbeispiele extrapoliert wurde. Die Konversionseffizienzen wurden jeweils als relative Konversionseffizienzen im Bezug auf das Ausführungsbeispiel 1 angegeben.

Die Figur 46c zeigt die gleichen Messdaten wie Figur 46b, allerdings bei einem Treiberstrom von 1000 mA. Auch dort weisen die Ausführungsbeispiele wieder einen höheren CRI auf.

Zusammenfassend gesagt, erreichen beide Vergleichsbeispiele 1 und 2 nicht den notwendigen CRI von 70 bei 3000 K für Straßenbeleuchtungsanwendungen. Aus diesem Grunde können die Vergleichsbeispiele 1 und 2 entweder lediglich in Beleuchtungsvorrichtungen mit einer korrelierten Farbtemperatur CCT zwischen 6500-4000 K und nicht in einem Bereich von 6500-3000 K eingesetzt werden oder ein zusätzlicher dritter Leuchtstoff muss zur Verbesserung der Farbtemperatur eingesetzt werden, was aber den Herstellungsprozess der Beleuchtungsvorrichtungen erschwert. Somit können Beleuchtungsvorrichtungen aufgrund des erfindungsgemäßen Leuchtstoffs einen ausreichenden CRI > 70 in einem breiten Farbtemperaturbereich von 6500-3000 K für Straßenbeleuchtungsanwendungen aufweisen. Im Gegensatz zu herkömmlichen Leuchtstoffmischungen ist dabei für die Erzielung eines breiten Farbtemperaturbereichs kein zusätzlicher dritter Leuchtstoff notwendig.

Die Figuren 46d und 46e zeigen die normalisierten LED-Spektren der Ausführungsbeispiele 1 und 2 sowie der entsprechenden Vergleichsbeispiele 1 und 2 bei einem Treiberstrom von 350 mA (Figur 46d) bzw. die normalisierten LED-Spektren der Ausführungsbeispiele 3 und 4 und der Vergleichsbeispiele 1 und 2 bei einem Treiberstrom von 350 mA (Figur 46e).

Gemäß weiterer Ausführungsformen kann die Effizienz der Beleuchtungsvorrichtungen beispielsweise für Straßenbeleuchtungen bei einer bestimmten Farbtemperatur CCT und einem bestimmten CRI dadurch verbessert werden, dass ein weiterer, dritter Leuchtstoff den Leuchtstoffmischungen hinzugefügt wird. Insbesondere kann eine Beleuchtungsvorrichtung nach dieser Ausführungsform eine Strahlungsquelle aufweisen, die eine blaues Licht emittierende LED mit einer Dominanzwellenlänge zwischen 440-455 nm aufweist, sowie einen erfindungsgemäßen, rot emittierenden Leuchtstoff mit einer Peakwellenlänge zwischen 605-620 nm, bevorzugt 605 - 616 nm und einer Halbwertsbreite FWHM $\leq$ 80 nm, bevorzugt $\leq$ 78 nm als ersten Leuchtstoff, einen grün-gelb emittierenden Leuchtstoff mit einer Peakwellenlänge zwischen 540-565 nm, bevorzugt 546-556 nm und einer Halbwertsbreite FWHM $\geq$ 100 nm, bevorzugt $\geq$ 105 nm als zweiten Leuchtstoff, sowie einem gelb-orange emittierenden Leuchtstoff mit einer Peakwellenlänge von 580-590 nm, bevorzugt 582-588 nm und einer Halbwertsbreite FWHM $\leq$ 80 nm bevorzugt $\leq$ 78 nm als dritten Leuchtstoff.

Als erster Leuchtstoff kann insbesondere ein rot emittierender Leuchtstoff der allgemeinen Formel $Sr(Sr_aM_{1-a})Si_2Al_2N_6$:D, wobei M ausgewählt ist aus der Gruppe Ca, Ba, Zn, Mg, bevorzugt Ca, verwendet werden mit einer Peakemission zwischen 605-620 nm, bevorzugt 605-616 nm und einer Halbwertsbreite FWHM von kleiner gleich 80 nm bevorzugt kleiner gleich 78 nm. Insbesondere kann dabei der Wert a $\geq$ 0,8, bevorzugt a $\geq$ 0,84 und der Europium-Anteil zwischen 0,1-5 Mol%, bevorzugt 0,1-3 Mol%, weiter bevorzugt zwischen 0,1-2 Mol% betragen. Diese rot emittierenden Leuchtstoffe zeichnen sich durch eine hohe Temperaturstabilität und eine hohe Konversionseffizienz bei für Straßenbeleuchtungen typischen Betriebsbedingungen aus.

Insbesondere kann der grün-gelb emittierende Leuchtstoff als zweiter Leuchtstoff ein Granatleuchtstoff der allgemeinen Formel $(Y,Lu,Gd,Tb)_3(Al,Ga)_5O_{12}$:Ce sein, der an die Emissionswellenlängen der blauen LED und der beiden anderen Leuchtstoffe angepasst ist. Insbesondere kann der Leuchtstoff ein grün emittierender Granat-Leuchtstoff der allgemeinen Formel $(Y,Lu)_3(Al,Ga)_5O_{12}$:Ce sein, insbesondere ein gelb-grün emittierender Leuchtstoff der allgemeinen Formel $(Y,Lu)_3(Al,Ga)_5O_{12}$:Ce mit einem Cer-Anteil von 1-5 Mol%, bevorzugt 2-4 Mol% und einem Yttrium-Anteil von 0-50 Mol%, bevorzugt 0-30 Mol%, weiter bevorzugt 0-20 Mol% und einem Gallium-Anteil von 0-50 Mol%, bevorzugt 0-30 Mol% weiter bevorzugt 0-15 Mol%, so dass ein Granat-Leuchtstoff der folgenden allgemeinen Formel resultiert: $(Lu_{1-x}Y_x)_3 (Al_{1-y}Ga_y)_5O_{12}$:Ce mit x = 0 bis 0, 5, bevorzugt x = 0 bis 0, 3, weiter bevorzugt x = 0 bis 0,15 und y = 0 bis 0,5, bevorzugt y = 0 bis 0,2, weiter bevorzugt y = 0 bis 0,15. Andere Elementkombinationen innerhalb der allgemeinen Formel $(Y,Lu,Gd,Tb)_3(Al,Ga)_5O_{12}$:RE mit RE = Seltenerdmetall, z. B. Ce sind ebenso möglich.

Als dritter Leuchtstoff kann insbesondere ein Leuchtstoff der allgemeinen Formel $(Ca,Sr,Ba)_2(Si,Al)_5(N,O)_8$:Eu verwendet werden, der zusammen mit der Primärlichtquelle, beispielsweise einer blauen LED, sowie dem grün-gelb emittierenden Leuchtstoff und dem erfindungsgemäßen rot emittierenden Leuchtstoff einen CRI $\geq$65, bevorzugt $\geq$ 70 über einen großen Bereich der korrelierten Farbtemperatur CCT erreicht (zumindest von 6500-4000 K, weiterhin bevorzugt von 6500-3000 K). Um die oben beschriebenen spektralen Eigenschaften für den gelb-rot bzw. gelb-orange emittierenden Leuchtstoff als dritten Leuchtstoff zu erreichen weist dieser einen Europium-Anteil von 0,1-5 Mol%, bevorzugt von 0,1-3 Mol%, weiter bevorzugt von 0,1-2 Mol%, sowie einen Barium-Anteil von 50-100 Mol%, bevorzugt 70-100 Mol%, weiter bevorzugt 80-100 Mol% und einen Calcium-Anteil von 0-20 Mol%, bevorzugt 0-10 Mol% auf, wobei der Anteil an Strontium so gewählt wird, dass die Erdalkalimetalle Barium, Strontium und Calcium zusammen mit dem Dotierstoff Europium 100 % ergeben.

Im Folgenden wird ein Ausführungsbeispiel einer Leuchtvorrichtung mit drei verschiedenen ersten bis dritten Leuchtstoffen im Bezug auf ein Vergleichsbeispiel erläutert. Das Vergleichsbeispiel 1 ist eine Beleuchtungsvorrichtung mit einem blauen LED-Chip (Dominanzwellenlänge 445 nm) mit einer Chipfläche von 1 $mm^2$, bei dem in den Standard-Silikon-Verguß der LED 14 Gewicht% einer Leuchtstoff-Mischung aus zwei verschiedenen Leuchtstoffen vorhanden sind, wobei das Verhältnis des grünen zum roten Leuchtstoff 4,7:1 beträgt. Der grün emittierende Leuchtstoff ist dabei ein Leuchtstoff der Formel $(Lu_{0,85}Y_{0,15})_3Al_5O_{12}$:Ce (3 Mol%) und der rot emittierende Leuchtstoff ein Leuchtstoff der Formel $(Sr_{0,5}Ba_{0,5})_2Si_5N_8$:Eu (1 Mol%), wobei die LED bei einem Treiberstrom von 350 mA betrieben wird. Beim Ausführungsbeispiel 1 ist im Standard-Silikon Verguß einer blauen LED mit einer Dominanzwellenlänge von 445 nm bei einem Treiberstrom von 350 mA 14 Gewicht% einer Leuchtstoff-Mischung mit den folgenden drei ersten bis dritten Leuchtstoffen vorhanden, $Sr(Sr_{0,86}Ca_{0,14})Si_2Al_2N_6$:Eu (0,8 Mol%) als erster Leuchtstoff, $(Lu_{0,85}Y_{0,15})_3Al_5O_{12}$:Ce (3 Mol%) als zweiter Leuchtstoff und $(Sr_{0,1}Ba_{0,9})_2Si_5N_8$:Eu (1 Mol%) als dritter Leuchtstoff, wobei das Verhältnis erster Leuchtstoff:zweiter Leuchtstoff:dritter Leuchtstoff 0,67:5,3:0,33 beträgt. Die Fläche des LED Chips beträgt wieder 1 $mm^2$.

Figur 47a zeigt tabellarisch eine Auflistung der CIE-Farbkoordinaten sowie des CRI und der Konversionseffizienz als Verhältnis von dem Lichtstrom $\Phi_v$ einer LED mit einem mit den Leuchtstoffmischungen gefüllten Verguß und der Strahlungsleistung $\Phi_e$ einer LED mit einem klaren Verguß ohne Leuchtstoffe $\Phi(_{v(\text{gefüllter Verguß})}/\ \Phi_{e(\text{klarer Verguß})})$ sowie des visuellen Nutzeffekts für das Vergleichsbeispiel 1 und das Ausführungsbeispiel 1 bei einem Treiberstrom von 350 mA und einer Dominanzwellenlänge von 444,6 nm. Es ist zu erkennen dass sowohl der visuelle Nutzeffekt wie auch die Konversionseffizienz bei dem Ausführungsbeispiel höher ist als bei dem Vergleichsbeispiel.

Figur 47b zeigt weitere Ergebnisse des Ausführungsbeispiels 1 und des Vergleichsbeispiels 1 bei einem Treiberstrom von 350 mA bei unterschiedlichen Temperaturen 25 °C bzw. 85 °C. Auch hier ist zu erkennen, dass der visuelle Nutzeffekt bei dem Ausführungsbeispiel 1 höher ist als beim Vergleichsbeispiel 1.

Figur 47c zeigt die Emissionsspektren des Vergleichsbeispiels 1 und des Ausführungsbeispiels 1 bei 25 °C bei einer Farbtemperatur von 4000 K und einem Treiberstrom von 350 mA.

Beide Beispiele weisen in etwa vergleichbare Emissionsspektren auf.

Figur 47d zeigt die spektrale Effizienz (LER, $lm/W_{opt}$) des Ausführungsbeispiels 1 im Vergleich zum Vergleichsbeispiel 1 in Abhängigkeit von der Dominanzwellenlänge des LED Chips bei einer Farbtemperatur von 4000 K basierend auf Raytracing-Simulationen. Deutlich ist zu erkennen, dass bei der erfindungsgemäßen Leuchtstoff-Mischung aus drei Leuchtstoffen die spektrale Effizienz größer ist als beim Vergleichsbeispiel. Auch die in den folgenden Figuren 74e bis 47i gezeigten Daten beruhen auf Raytracing-Simulationen, wobei für die Simulationen Farborte auf dem planckschen Kurvenzug mit der angegebenen CCT gewählt wurden.

Figur 47e zeigt, dass der Bereich für den CRI mit der erfindungsgemäßen Leuchtstoff-Mischung aufweisend drei Leuchtstoffe über einen sehr weiten Bereich zwischen 53 und 76 über einen Bereich der korrelierten Farbtemperatur CCT von 3000-6500 K eingestellt werden kann (siehe grau unterlegte Bereiche). Die Dominanzwellenlänge des LED Chips liegt bei 448 nm und die gestrichelten, bzw. gepunkteten Linien in dieser Abbildung zeigen den CRI für zwei Vergleichsbeispiele Ausführungsbeispiel 1 weist eine Mischung von drei verschiedenen Leuchtstoffen der folgenden Zusammensetzung auf: $(Lu_{0,85}Y_{0,15})_3Al_5O_{12}$:Ce (3 Mol%), $(Sr_{0,1}Ba_{0,9})_2Si_5N_8$:Eu (1 Mol%) und $Sr(Sr_{0,86}Ca_{0,14})Si_2Al_2N_6$:Eu (0,8 Mol%), während das Vergleichsbeispiel 1 die beiden folgenden Leuchtstoffe enthält: $(Lu_{0,8}Y_{0,2})_3Al_5O_{12}$:Ce (4,5 Mol%) und $(Ca_{0,025}Sr_{0,475}Ba_{0,5})_2Si_5N_8$:Eu (2,5 Mol%) sowie das Vergleichsbeispiel 2 folgende Leuchtstoffe aufweist: $(Lu_{0,85}Y_{0,15})_3Al_5O_{12}$:Ce (3 Mol%) und $(Sr_{0,5}Ba_{0,5})_2Si_5N_8$:Eu (1 Mol%).

Die Figuren 47f bis 47i zeigen den visuellen Nutzeffekt LER für dieses Ausführungsbeispiel 1 sowie die Vergleichsbeispiele 1 und 2 in Abhängigkeit von dem Anteil des erfindungsgemäßen roten Leuchtstoffs für Ausführungsbeispiel 1 bei verschiedenen CCTs (Figur 47f: 3000K auf Planck; Figur 47g: 4000K auf Planck; Figur 47h: 5000K auf Planck und Figur 47i: 6500K auf Planck). Für die Vergleichsbeispiele 1 und 2, die lediglich zwei Leuchtstoffe enthalten, ist der visuelle Nutzeffekt LER und der Anteil des roten Leuchtstoffs bereits durch den gewünschten Farbpunkt/CCT bestimmt. Daher beziehen sich die Werte auf der x-Achse nur auf das Ausführungsbeispiel 1, wobei die dort dargestellten Werte den Anteil des roten Leuchtstoffs im Verhältnis zum orangen Leuchtstoff in der erfindungsgemäßen Leuchtstoff-Mischung, enthaltend die drei Leuchtstoffe angibt. Die Mischung aus dem roten und grünen Leuchtstoff wird anschließend mit dem grünen-gelben Leuchtstoff gemischt, um den gewünschten Farbort (LER bei CRI 70 für Ausführungsbeispiele mit Pfeil markiert) zu erreichen. Diesen Abbildungen kann weiterhin entnommen werden, dass bei einem CRI von 70 die erfindungsgemäße Leuchtstoff-Mischung einen LER aufweist, der höher ist als bei herkömmlichen Leuchtstoff-Mischungen. Besonders bei hohen korrelierten Farbtemperaturen CCT kann der Anteil des roten Leuchtstoffs in der Mischung graduell reduziert werden und entsprechend der Anteil des orange emittierenden Leuchtstoffs erhöht werden, da ein hoher Anteil an rot emittierenden Leuchtstoff vor allem bei niedrigen CCT benötigt wird. Keine oder nur geringe Anteile an tiefroter Emission im LED-Spektrum wirken sich im Allgemeinen positiv auf die LED-Effizienz aus.

**Ausführungsbeispiele für Hinterleuchtungsanwendungen:**

Eine weitere Ausführungsform ist auf Leuchtstoffmischungen für die Hinterleuchtungsanwendungen gerichtet. Für Hinterleuchtungsanwendungen muss ein breiter Farbraum mit schmalbandig rot und grün emittierenden Leuchtstoffen erreicht werden, wobei die Leuchtstoff-Mischung die optischen Eigenschaften der LED, wie Helligkeit, Effizienz und Robustheit bestimmt.

Für den sRGB/Rec709-Farbraum können besonders Beleuchtungsvorrichtungen als Hinterleuchtungsvorrichtungen für z. B. LCDs eingesetzt werden, die als primäre Strahlungsquelle eine blaue LED mit einer dominanten Emissionswellenlänge von 430-470 nm, bevorzugt 440-460 nm weiter bevorzugt 445-455 nm aufweisen, sowie einen grüngelb emittierenden Granatleuchtstoff der allgemeinen Formel $(Lu,Y,Gd,Tb)_3(Al,Ga)_5O_{12}$:Ce sowie einen rot emittierenden Leuchtstoff, insbesondere einen erfindungsgemäßen Leuchtstoff der allgemeinen Formel Sr $(Sr_aM_{1-a})$ $Si_2Al_2N_6$:D,

wobei M ausgewählt ist aus der Gruppe Ca, Ba, Zn, Mg, bevorzugt Ca, und D bevorzugt Eu, enthalten. Optional können auch weitere Konverter oder Leuchtstoffe oder nicht konvertierende Materialien, wie Diffusoren in der Leuchtstoff-Mischung vorhanden sein.

Der Granat-Leuchtstoff kann insbesondere die allgemeine Zusammensetzung $(Lu,Y)_3(Al,Ga)_5O_{12}$:Ce aufweisen und auch als Yttrium-Aluminium-Gallium-Granat mit einem Gallium-Anteil von 20 Mol% $\leq x \leq$ 60 Mol%, weiter bevorzugt 30 Mol% $\leq x \leq$ 50 Mol%, weiter bevorzugt 30 Mol% $\leq x \leq$ 45 Mol% vorliegen, so dass die allgemeine Formel: $Y_3(Al_{1-x}Ga_x)_5o_{12}$:Ce mit $0,2 \leq x \leq 0,6$, weiter bevorzugt $0,3 \leq x \leq 0,5$, weiter bevorzugt $0,3 \leq x \leq 0,45$ resultiert. Weiterhin kann der Granat-Leuchtstoff auch als Lutetium-Aluminium-Gallium-Granat mit der folgenden allgemeinen Formel vorliegen: $Lu_3$ $(Al_{1-x}Ga_x)_5o_{12}$: Ce mit $0 \leq x \leq 0,6$, weiter bevorzugt $0 \leq x \leq 0,4$, weiter bevorzugt $0 \leq x \leq 0,25$ mit einem Cer-Anteil von 0,5 - 5 Mol%, bevorzugt 0,5 - 3 Mol%, weiter bevorzugt 0,5 - 2.5 Mol%, jeweils bezogen auf die Seltenerdmetalle.

Der erfindungsgemäße rot emittierende Leuchtstoff kann dabei einen Aktivator Anteil von $\geq$ 2 Mol%, bevorzugt einen Aktivator Anteil $\geq$ 3 Mol%, weiter bevorzugt einen Anteil von $\geq$ 4 Mol% aufweisen, wobei die divalenten Metalle, die bevorzugt Strontium und Calcium sind, einen Calcium-Anteil von $\leq$ 15 Mol%, bevorzugt $\leq$ 10 Mol%, weiter bevorzugt $\leq$ 8 Mol% aufweisen, so dass die folgende allgemeine Formel resultiert: $Sr(Sr_aCa_{1-a})$ $Si_2Al_2N_6$:Eu mit $a \geq 0,7$, bevorzugt $a \geq 0,8$, weiter bevorzugt $a \geq 0,84$.

Beide oben genannten Granat-Leuchtstoffe können verwendet werden, wobei die Verwendung des Yttrium-Aluminium-Gallium-Granats anstelle des Lutetium-Aluminium-Gallium-Granats den Vorteil mit sich bringt, dass der Yttrium-Granat eine geringere spezifische Dichte aufweist, so dass weniger Leuchtstoff für die Leuchtstoff-Mischungen benötigt wird und gleichzeitig ein niedrigerer Prozentsatz an Seltenerdmetallen für die Herstellung der Leuchtstoffe verwendet werden muss, so dass diese kostengünstiger hergestellt werden können.

Für Hinterleuchtungsanwendungen mit erhöhten Anforderungen an den Farbraum (zum Beispiel Adobe RGB, NTSC oder DCI-P3) werden Leuchtstoff-Mischungen benötigt, die sehr schmalbandig emittierende grün-gelbe Leuchtstoffe aufweisen. Bevorzugt weisen derartige Beleuchtungsvorrichtungen als Strahlungsquelle eine blaue LED mit einer dominanten Wellenlänge zwischen 430-470 nm, bevorzugt 440-460 nm, weiter bevorzugt 445-455 nm auf.

Als grün-gelb emittierende Leuchtstoffe können Nitrido-Orthosilikate verwendet werden, die die allgemeine Zusammensetzung $AE_{2-x}RE_xSiO_{4-x}N_x$:Eu mit AE = Sr, Ca, Ba, Mg, RE = Seltenerdmetalle und/oder $AE_{2-x}RE_xSi_{1-y}O_{4-x-2y}N_x$:Eu, AE und RE wie im vorherigen Beispiel definiert, aufweisen und die insbesondere in der Patentanmeldung WO 2011/160944 beschrieben werden. Ebenso können Orthosilikate der allgemeinen Formel $AE_2SiO_4$:Eu mit AE = Ca, Ba, Mg, Sr eingesetzt werden. Sowohl die Nitrido-Orthosilikate und Orthosilikate mit den oben genannten Summenformeln beinhalten bevorzugt eine Kombination von zumindest zwei Erdalkalimetallen, weiter bevorzugt eine Kombination von Strontium und Barium mit dem Verhältnis $0,5 \leq$ Ba:Sr $\leq 2$, weiter bevorzugt $0,75 \leq$ Ba:Sr $\leq 1,25$. Die Nitrido-Orthosilikate können auch durch die allgemeinen Formeln $AE_{2-x}L_xSiO_{4-x}N_x$:RE, wobei AE ein oder mehrere Elemente ausgewählt aus Mg, Ca, Sr, Ba enthält und RE ein oder mehrere Elemente ausgewählt aus Seltenerdmetallen, bevorzugt mindestens Eu enthält, und L ein oder mehrere Elemente ausgewählt aus Seltenerdmetallen unterschiedlich zu RE enthält, mit $0 < x \leq 0,1$, bevorzugt $0,003 \leq x \leq 0,02$ beschrieben werden. Eine weitere allgemeine Zusammensetzung ist $AE_{2-x}L_xSi_{1-y}O_{4-x-2y}N_x$:RE, wobei AE ein oder mehrere Elemente ausgewählt aus Mg, Ca, Sr, Ba enthält und RE ein oder mehrere Elemente ausgewählt aus Seltenerdmetallen, bevorzugt mindestens Eu enthält, und L ein oder mehrere Elemente ausgewählt aus Seltenerdmetallen unterschiedlich zu RE enthält, mit $0 < x \leq 0,1$, bevorzugt $0,003 \leq x \leq 0,02$ und $0 < y \leq 0,1$, bevorzugt $0,002 \leq y \leq 0,02$ Möglich ist auch die Verwendung von gelb-grün emittierenden beta-SiAlONen der allgemeinen Formel $Si_{6-z}Al_zO_zN_{8-z}$:Eu mit $0 < z \leq 4$. Die beta-SiAlONe können auch die allgemeine Formel $Si_{6-x}Al_zO_yN_{8-y}:RE_z$ aufweisen, wobei $0 < x \leq 4$, $0 < y \leq 4$, $0 < z < 1$ und RE ein oder mehrere Elemente ausgewählt aus Seltenerdmetallen, bevorzugt mindestens Eu und/oder Yb.

Verwendet werden können auch gelb bis grün emittierende Nano-Halbleitermaterialien, sogenannte "Quanten-Punkte", welche zumindest eine Verbindung ausgewählt aus: eine Gruppe II-VI-Verbindung, eine Gruppe IV-VI-Verbindung oder Metall-Nanokristalle, enthalten.

Als erfindungsgemäße rot emittierende Leuchtstoffe können insbesondere Leuchtstoffe der folgenden allgemeinen Formel $Sr(Sr_aCa_{1-a})Si_2Al_2N_6$:D mit einem Aktivator Anteil $\geq$ 4 Mol%, bevorzugt $\geq$ 8 Mol%, weiter bevorzugt $\geq$ 10 Mol%, weiter bevorzugt $\geq$ 15 Mol%, wobei die divalenten Metalle bevorzugt Strontium und Calcium sind mit einem Calcium-Anteil $\leq$ 15 Mol%, bevorzugt $\leq$ 10 Mol%, weiter bevorzugt $\leq$ 8 Mol%, so das die allgemeine Formel Sr $(Sr_aCa_{1-a})$ $Si_2Al_2N_6$:D mit $a \geq 0,7$, bevorzugt $a \geq 0,8$, weiter bevorzugt $a \geq 0,84$ resultiert.

Im Folgenden werden einige Ausführungsbeispiele der hier diskutierten Beleuchtungsvorrichtungen im Vergleich zu herkömmlichen Beleuchtungsvorrichtungen diskutiert. Die in den Figuren 48a bis 48d dargestellten Leuchtstoffe der Ausführungsbeispiele 1 und 2 wurden in Leuchtvorrichtungen mit LEDs eingesetzt und in den folgenden Figuren mit Ausführungsbeispiel LED1 oder Ausführungsbeispiel LED2 benannt. Entsprechend wurden auch die Vergleichsbeispiele benannt. Figur 48a zeigt in tabellarischer Form spektrale Daten eines Vergleichsbeispiels 1 bei dem im Standard-Silikon-Verguß einer blau emittierenden LED ein herkömmlicher Leuchtstoff der Formel $CaAlSiN_3$:Eu (0,4% Eu) eingebracht wurde. Im Unterschied dazu wurden bei den Ausführungsbeispielen 1 bis 3 erfindungsgemäße Leuchtstoffe mit unterschiedlichen Anteilen an Europium als Aktivator in den Verguß eingebracht. Bei den Ausführungsbeispielen wird eine geringere Halbwertsbreite FWHM der emittierten Strahlung im Gegensatz zum Vergleichsbeispiel 1 beobachtet, wobei gleichzeitig die Ausführungsbeispiele 1 und 2 eine höhere externe Quanteneffizienz zeigen als das Vergleichsbeispiel. Die weiteren Figuren 48b und 48c zeigen die Emissionsspektren des Vergleichsbeispiels und der drei Ausführungsbeispiele 1 bis 3. Dabei zeigen die Emissionsspektren der Ausführungsbeispiele eine reduzierte Halbwertsbreite bei gleichzeitig tief-roter Emission.

Die Figur 48d zeigt die diffuse Reflexion des Vergleichsbeispiels und der drei Ausführungsbeispiele in Abhängigkeit von der Wellenlänge. Alle Ausführungsbeispiele mit dem erfindungsgemäßen Leuchtstoff zeigen eine sehr geringe Reflexion im UV bis grünen Bereich des Spektrums, was eine hohe Absorption bedingt. Gleichzeitig ist die Reflexion bei Wellenlängen >650 nm sehr hoch, so dass eine hohe Konversionseffizienz erreicht werden kann.

Weißes Licht emittierende LED-Beleuchtungsvorrichtungen wurden mithilfe von verschiedenen Kombinationen von Ausführungsbeispielen und Vergleichsbeispielen gebaut. Dabei wurde ein Weißpunkt mit den CIE Koordinaten CIE-x = 0,285 und CIE-y = 0,275 gewählt. Die resultierenden LED-Emissionsspektren wurden analysiert und verglichen und die Abdeckung des Farbraums dadurch bestimmt, dass ein Standardsatz von LCD-Filter-Absorptionskurven angewandt und die resultierenden gefilterten Farbpunkte für die blauen, grünen und roten Kanäle bestimmt wurden. Der Figur 48e kann dabei entnommen werden, dass im Unterschied zu einem Vergleichsbeispiel 1 ein erfindungsgemäßes Ausführungsbeispiel 1 eine erhöhte Konversionseffizienz und eine Zunahme des visuellen Nutzeffekts LER um 4 % zeigt, wobei die Überlappung mit dem sRGB-Farbraum bei beiden Beleuchtungsvorrichtungen ähnlich ist. Figur 48f zeigt die LED-Spektren des Vergleichsbeispiels 1 und des Ausführungsbeispiels 1 aus der vorherigen Tabelle der Figur 48e. In Figur 48g ist ein Vergleich der Abdeckung des sRGB-Farbraums für das Vergleichsbeispiel 1 und das Ausführungsbeispiel 1 angegeben.

In Figur 48h sind in tabellarischer Form die Zusammensetzung eines Vergleichsbeispiels 2 sowie der Ausführungsbeispiele 2 und 3 für Hinterleuchtungsvorrichtungen für einen extrem große Farbräume, z. B. DCI-P3 angegeben Ein Weißpunkt mit CIE-x = 0,275 und CIE-y = 0,250 wurde gewählt. Die resultierenden LED Emissionsspektren wurden wieder analog zu dem bereits oben in Figur 48e beschriebenen Beispielen diesmal aber für den DCI-P3 Farbraum analysiert und verglichen. Die Überlappung mit diesem Farbraum ist bei den erfindungsgemäßen Ausführungsbeispielen vergleichbar bzw. höher. Die Figuren 48i und 48j zeigen die LED-Emissions Spektren des Ausführungsbeispiels 2 und 3 im Vergleich zum Vergleichsbeispiel 2 sowie die Abdeckung des DCI-P3-Farbraums für diese Beispiele.

Als zweite Leuchtstoffe können auch andere Leuchtstoffe z. B. aus der Gruppe der SiONe, SiAlONe, Silikate und Quantendots verwendet werden.

**Ausführungsbeispiele für Blitzlichtanwendungen:**

Die erfindungsgemäßen Leuchtstoffe, insbesondere die Leuchtstoffe der allgemeinen Strukturformel $Sr(Sr_aCa_{1-a})\ Si_2Al_2\ (N,O)_6$ können zusammen mit den mittels eines Aktivators aktivierten Granaten, insbesondere den oben beschriebenen Cer-aktivierten Granaten auch für Blitzlichtanwendungen eingesetzt werden. Dazu wird als Strahlungsquelle, die eine Primärstrahlung ausstrahlt eine blau emittierende LED, beispielsweise eine InGaN-LED verwendet, die eine Dominanzwellenlänge von 300-500 nm, bevorzugt 400-500 nm, weiterhin bevorzugt 420-470 nm aufweist. Ein besonders geeignetes Spektrum für eine Blitzlichtanwendung, beispielsweise in Mobiltelefon-Kameras weist eine Intensität, bezogen auf das Maximum des Spektrums im cyanen Farbbereich (ca. 450-500 nm) von mindestens 12,5 % auf. Die Intensität des Spektrums im Wellenlängenbereichen > 650 nm kann dabei eher gering sein, da typische Sensoren von Kameras in diesem Bereich eine hohe Sensitivität besitzen und dieser Spektralbereich häufig durch spezielle IR-Filter herausgefiltert wird, um störende Einflüsse von Strahlung dieses Strahlungsbereichs auf den Sensor und die Abbildungsqualität zu vermeiden.

Für Blitzlichtanwendungen können dabei Leuchtvorrichtungen mit nur einer Strahlungsquelle eingesetzt werden, deren blauer und/oder UV-Strahlung emittierender LED-Chip eine Leuchtstoffmischung mit zumindest einem der erfindungsgemäßen Leuchtstoffe z. B. zusammen mit einem gelb-grün emittierenden Granat-Leuchtstoff in dessen Strahlengang enthalt. LED-Vorrichtungen für Blitzlichtanwendungen können weiterhin zumindest auch zwei verschiedene LED-Module aufweisen, wobei ein Modul eher ein kaltweißes Licht (korrelierte Farbtemperatur CCT zwischen 4000-6000 K) und das weitere Modul ein eher warmweißes Licht (korrelierte Farbtemperatur CCT zwischen ca. 1500-3000 K) emittiert. Durch gezielte Bestromung der beiden LED-Module können Beleuchtungssituationen der Umgebung im Fotomotiv noch besser variabel gestaltet werden, beispielsweise bei Kunstlicht oder Tageslicht.

Für einen kaltweißen Farbort kann als erster Leuchtstoff ein erfindungsgemäßer orange-rot emittierender Leuchtstoff der allgemeinen Formel:

$$Sr(Sr_aCa_{1-a})\ Si_2Al_2(N,O)_6{:}Eu$$

Mit a ≥ 0,8, bevorzugt a ≥ 0,82, verwendet werden. Der Europium-Anteil liegt dabei zwischen 0,1-20 Mol%, bzw. zwischen 1-10 Mol%, weiter zwischen 0,1-5 Mol%, bevorzugt zwischen 0,1-3 Mol%, weiter bevorzugt zwischen 0,1-2 Mol% bezogen auf die Erdalkalimetalle.

Der Emissionspeak der erfindungsgemäßen Leuchtstoffe kann dabei zwischen 600-640 nm, bevorzugt zwischen 605-625 nm liegen und die spektrale Halbwertsbreite auf halber Höhe des Maximums (FWHM) sollte < 85 nm, bevorzugt < 80 nm weiterhin bevorzugt < 78 nm sein. Die Emissionsintensität bei Wellenlängen größer 650 nm sollte sehr gering sein, da typische Sensoren von Kameras in diesem Bereich eine hohe Sensitivität besitzen.

Als zweiter Leuchtstoff für eine kaltweiße Anwendung können dann die oben beschriebenen Granate der allgemeinen Formel:

$$(Gd,Lu,Tb,Y)_3(Al,Ga)_5(O)_{12}:RE$$

Mit RE = Seltenerdmetalle, insbesondere Ce,
verwendet werden. Die Granate sind insbesondere blau-grün bis gelb emittierende Leuchtstoffe der Formeln $Lu_3(Al,Ga)_5(O)_{12}$:Ce und$(Lu,Y)_3(Al,Ga)_5(O)_{12}$:Ce die bei einer Wellenlänge im Bereich von 425-455 nm, bevorzugt 430-450 nm besonders gut angeregt werden können. Besonders bevorzugt ist ein blau-grün emittierender Leuchtstoff mit sehr guter Stabilität und Konversionseffizienz bei hohen Temperaturen und hohen Strahlenintensitäten, die typisch für Blitzlichtanwendungen sind mit der Formel $Lu_3(Al_{1-x}Ga_x)_5(O)_{12}$:Ce mit einem Cer-Anteil von 0,5-5 Mol%, bevorzugt 0,5-2 Mol% jeweils bezogen auf die Seltenerdmetalle und einem Gallium-Anteil von x von 0 bis 0,5, bevorzugt 0,15 bis 0,3. Andere Granate mit anderen Elementkombinationen sind ebenfalls möglich, insbesondere Varianten bei denen ein Teil oder das gesamte Lutetium durch Yttrium in der Formel des Granats $Lu_3(Al,Ga)_5(O)_{12}$:Ce ersetzt wurde. Diese Kombinationen von einem ersten und einem zweiten Leuchtstoff zeigen gegenüber herkömmlichen Kombinationen von Leuchtstoffen, bei denen der oben beschriebene Granat-Leuchtstoff mit einem anderen rot emittierenden Leuchtstoff aus der Klasse der 2-5-8 Leuchtstoffe der allgemeinen Formel $(Ca,Sr,Ba)_2(Si,Al)_5(N,O)_8$:Eu mit optionalen Co-Dotierstoffen, wie z. B. Lanthanoiden wie Mn, Nd, Dy, Sm, Tm und Alkalimetallen wie Li, Na, K vermischt ist, eine bessere Stabilität im Bezug auf den Farbpunkt und höhere LED-Effizienzen bei erhöhten Stromstärken auf. Im folgenden werden Leuchtstoffe der allgemeinen Formel $(Ca,Sr,Ba)_2(Si,Al)_5(N,O)_8$:Eu mit optionalen Co-Dotierstoffen als "2-5-8-Leuchstoffe" bezeichnet. Weiterhin zeigen erfindungsgemäße Leuchtstoffmischungen eine reduzierte Intensität der Emission bei Wellenlängen > 650 nm, wobei aber die Intensität, bezogen auf das Maximum des Spektrums im cyanen Farbbereich von zumindest 12,5 % als wichtige Bedingung für Blitzlichtanwendungen erfüllt ist.

Für warmweiße Blitzlichtanwendungen wird bevorzugt ein gelb emittierender Granat-Leuchtstoff $(Gd,Lu,Tb,Y)_3(Al,Ga)_5(O)_{12}$:RE, bevorzugt der Formeln $(Gd,Y)_3(Al,Ga)_5(O)_{12}$:Ce oder $(Tb,Y)_3(Al,Ga)_5(O)_{12}$:Ce verwendet, der das Maximum der Anregung im Bereich von 435-470 nm, bevorzugt 440-465 nm aufweist. Der bevorzugte gelb emittierende Leuchtstoff weist eine sehr hohe Stabilität und Konversionseffizienz bei hohen Temperaturen und hohen Strahlungsintensitäten (hohen Stromintensitäten) auf, die typisch für Blitzlichtanwendungen sind. Ein besonders bevorzugter gelb-grün emittierender Leuchtstoff ist $Y_3(Al_{1-x}Ga_x)_5(O)_{12}$:Ce mit einem Cer-Anteil von 1,5-5 Mol%, bevorzugt 2,5-5 Mol% und einem Gallium-Anteil x von 0 bis 0,5, bevorzugt von x von 0 bis 0,1. Andere Elementkombinationen innerhalb des Systems $(Gd,Lu,Tb,Y)_3(Al,Ga)_5(O)_{12}$:Ce, die ähnliche spektrale Charakteristika aufweisen sind ebenfalls möglich.

LED-Leuchtvorrichtungen, die für Blitzlichtanwendungen geeignet sind, können unabhängig von Leuchtvorrichtungen mit nur einer LED beispielsweise zumindest auch zwei oder drei blau emittierende LED-Chips als Primärstrahlung abstrahlende Strahlungsquellen aufweisen, in deren Strahlengang die bereits oben genannten Leuchtstoffe und Leuchtstoffmischungen eingebracht werden. Der CIE-Farbbereich des konvertierten Lichts der LED-Leuchtvorrichtung befindet sich bevorzugt auf der Linie eines Schwarzkörper-Strahlers (Planck) im Bereich von 6500 K bis 2700 K mit einer Abweichung von 3-Schritten einer MacAdam Ellipse, besonders bevorzugt im Bereich von 5000 K bis 3000 K.

Bei einer LED-Leuchtvorrichtung mit zwei LED-Chips als Strahlungsquellen weist gemäß einem weiteren Ausführungsbeispiel die Strahlung des ersten LED-Chips nach der Konversion einen CIE-Farbort auf, der in einem Bereich liegt, der durch folgende CIE-Farbkoordinaten (Cx/Cy) eingeschlossen wird: (0,21; 0,247), (0,26; 0,24), (0,24; 0,32), (0,28; 0,31). Der zweite LED-Chip als zweite Strahlungsquelle weist nach der Konversion einen CIE-Farbort auf, der durch folgende CIE-Koordinaten eingeschlossen wird: (0,45; 0,41), (0,46; 0, 39), (0,58; 0,39), und (0,58; 0,42). Bei einer derartigen LED-Leuchtvorrichtung können die einzelnen Strahlungsquellen mit unterschiedlichen Treiberströmen betrieben werden, wobei das emittierte, konvertierte Licht vorteilhaft in einem optischen Element, wie einer gemeinsamen Linse zu einer Gesamtemissionsstrahlung gemischt wird.

Bei einer LED-Leuchtvorrichtung, die für Blitzlichtanwendungen geeignet ist und drei LED-Chips als Strahlungsquellen aufweist weisen gemäß einem weiteren Ausführungsbeispiel die ersten beiden LED-Chips die bereits oben beschriebenen CIE-Farborte auf und die dritte Strahlungsquelle, dass dritte LED-Modul, besitzt nach der Konversion einen CIE-Farbort der durch folgende Koordinaten eingeschlossen wird: (0,40; 0,44), (0,39; 0,51), (0,45; 0,52), und (0,47; 0,46). Auch bei dieser Ausführungsform wird das emittierte, konvertierte Licht durch ein im Strahlengang nachgeschaltetes optisches Element, wie eine Linse gemischt.

Die Leuchtstoff-Partikel besitzen bevorzugt eine mittlere Partikelgröße $d_{50}$ von 5-30 $\mu$m, besonders bevorzugt

7-17 μm. Die Partikelgrößenverteilung kann beispielsweise über Laserbeugung mittels der einem Fachmann bekannten Fraunhofer-Näherung bestimmt werden.

Im Folgenden sollen einige Ausführungsbeispiele von LED-Leuchtvorrichtungen, die für Blitzlichtanwendungen geeignet sind, näher erläutert werden. In einem Vergleichsbeispiel 1, einem Ausführungsbeispiel 1 sowie einem Vergleichsbeispiel 2 und einem Ausführungsbeispiel 2 werden jeweils unterschiedliche Leuchtstoffmischungen nach dem Stand der Technik, bzw. Leuchtstoffmischungen, die erfindungsgemäße Leuchtstoffe enthalten in einen Standard-Silikon-Verguß eines blau emittierenden InGaN-LED-Chips als Strahlungsquelle eingebracht. Die Leuchtfläche der LED-Chips beträgt jeweils 1 $mm^2$.

Im Vergleichsbeispiel 1 werden 11,5 Gewichtsprozent Leuchtstoff bezogen auf den Silikon Verguß eingebracht, wobei als grün emittierender Leuchtstoff $Lu_3Al_4GaO_{12}$:Ce mit einem Cer-Anteil von 1,5 Mol% bezogen auf die Seltenerdmetalle eingesetzt wird. Als rot emittierender Leuchtstoff wird ein herkömmlicher 2-5-8 Leuchtstoff $SrBaSi_5N_8$:Eu mit einem Eu-Anteil von 1,5 Mol% bezogen auf die Erdalkalimetalle eingesetzt. Die Dominanzwellenlänge des LED-Chips bei 350 mA liegt bei 447 nm und das Verhältnis der Leuchtstoffe grün/rot beträgt 5,7:1. Als Ausführungsbeispiel 1 wird der gleiche grün emittierende Leuchtstoff, wie im Vergleichsbeispiel 1 verwendet, wobei als roter Leuchtstoff ein erfindungsgemäßer Leuchtstoff $Sr(Sr_{0,86}Ca_{0,14})Si_2Al_2N_6$:Eu mit einem Eu-Anteil von 0,4 Mol% bezogen auf die Seltenerdmetalle verwendet wird. Das Verhältnis der Leuchtstoffe grün/rot beträgt 3,9:1. Die Dominanzwellenlänge des LED-Chips bei 350 mA liegt wiederum bei 447 nm.

In der Tabelle der Figur 49a sind die jeweiligen x- und y-CIE-Farbkoordinaten des Vergleichsbeispiels 1 und des Ausführungsbeispiels 1 bei unterschiedlichen Stromstärken (Durchschnitt von 4 LEDs) gezeigt, wobei das Vergleichsbeispiel 1 bei den Prozentangaben auf 100 % für die entsprechenden Stromstärken gesetzt wurde. Dieser Tabelle, vor allem aber auch den Figuren 49b und 49c kann entnommen werden, dass mit zunehmender Stromstärke die Leuchtstoffmischungen mit den erfindungsgemäßen Leuchtstoffen stabiler sind als die herkömmlichen Leuchtstoffmischungen, wobei die herkömmlichen Leuchtstoffmischungen einen Teil ihrer relativen roten Emissionsintensität im Vergleich zu der grün-gelben Emissionsintensität verlieren, während die erfindungsgemäßen Leuchtstoffmischungen nahezu stabil bleiben. Der Tabelle kann weiterhin entnommen werden, dass die LED mit dem erfindungsgemäßen Leuchtstoff eine höhere Konversionseffizienz als Verhältnis von dem Lichtstrom $\Phi_v$ einer LED mit einem mit den Leuchtstoffmischungen gefüllten Verguß und der Strahlungsleistung $\Phi_e$ einer LED mit einem klaren Verguß ohne Leuchtstoffe $\Phi$(v(gefüllter Verguß)/ $\Phi_e$(klarer Verguß)

im Vergleich zu der LED mit der herkömmlichen Leuchtstoffmischung aufweist. Der visuelle Nutzeffekt Vs ist definiert als:

$$Vs = \frac{\int_{380nm}^{780nm} \Phi e_{(gefüllter\ \mathrm{Verguß})}(\lambda) V(\lambda) d\lambda}{\int_{0}^{\infty} \Phi e_{(gefüllter\ \mathrm{Verguß})}(\lambda) d\lambda}$$

LED-Spektren des Vergleichsbeispiels 1 und des Ausführungsbeispiels 1 bei 40 und 1000 mA Stromstärke sind in den Figuren 49b und 49c gezeigt. Dabei ist deutlich zu erkennen, dass die herkömmliche Leuchtstoffmischung mit zunehmender Stromstärke Emission im roten Wellenlängenbereich verliert (Fig. 49b), während es bei der erfindungsgemäßen Leuchtstoffmischung nur zu einer sehr geringen Abnahme kommt (Fig. 49c).

Der beobachtete Effekt lässt sich auf die unterschiedlichen rotemittierenden Leuchtstoffe in den herkömmlichen und erfindungsgemäßen Leuchtstoffmischungen zurückführen. Bei den in der herkömmlichen Leuchtstoffmischung verwendeten 2-5-8 Leuchtstoffen wird eine Abnahme der Konversionseffizienz mit zunehmender Stromstärke beobachtet, die sich in einer Abnahme der roten Emission in Relation zu der gelb-grünen Emission im LED Spektrum in herkömmlichen Leuchtstoffmischungen mit zunehmender Stromstärke bemerkbar macht. Bei Leuchtstoffmischungen mit dem erfindungsgemäßen Leuchtstoff wird eine demgegenüber deutlich verringerte Abnahme der Konversionseffizienz des roten Leuchtstoffs mit zunehmender Stromstärke beobachtet. Die relative Abnahme der Konversionseffizienz mit zunehmender Stromstärke für einen erfindungsgemäßen Leuchtstoff wie für einen herkömmlichen 2-5-8 Leuchtstoff sind in der Figur 49d gezeigt.

Figur 49e zeigt einen Vergleich der auf die maximale Emissionsintensität normierten LED-Spektren des Ausführungsbeispiels 1 und des Vergleichsbeispiels 1. Ausführungsbeispiel 1 zeigt eine reduzierte Emissionsintensität in einem Wellenlängenbereich > 650 nm und weist gleichzeitig eine relative Emissionsintensität > 12,5 % in der cyanen Region auf.

Figur 49f zeigt die normierte Emissionsintensität eines typischen, beispielhaften 2-5-8 Leuchtstoffs und eines erfindungsgemäßen Leuchtstoffs. Deutlich ist dabei die reduzierte Emissionsintensität des erfindungsgemäßen Leuchtstoffs im Wellenlängenbereich > 650 nm zu erkennen, die auf die reduzierte FWHM zurückzuführen ist.

Die Verschiebung des Farbpunkts der LEDs des Vergleichsbeispiels 1 und des Ausführungsbeispiels 1 mit zunehmender Stromstärke sind in Figur 49g gezeigt. Dabei verschiebt sich der Farbpunkt der LED des Ausführungsbeispiels 1 wesentlich geringer im Vergleich zu der LED des Vergleichsbeispiels 1 aufgrund der höheren Emissionsstabilität des erfindungsgemäßen Leuchtstoffs.

In einem weiteren Vergleich eines Ausführungsbeispiels 2 im Vergleich zu einem herkömmlichen Vergleichsbeispiel 2 wird eine Leuchtstoffmischung mit einem amber Farbpunkt eingesetzt. Vergleichsbeispiel 2 umfasst einen Cer-aktivierten Granat-Leuchtstoff $(Y_{0,957}Ce_{0,043})_3Al_5O_{12}$ zusammen mit einem herkömmlichen 2-5-8 Leuchtstoff $(Ca_{0,1}Sr_{0,4}Ba_{0,5})_2Si_5N_8$:Eu mit einem Eu-Anteil von 3,25 Mol% bezogen auf die Erdalkalimetalle eingesetzt. Die Konzentration der Leuchtstoffe beträgt 41 Gew% bezogen auf den Silikonverguß und die Dominanzwellenlänge des blauen LED-Chips bei einer Stromstärke von 350 mA beträgt 444,7 nm. Das Verhältnis der Leuchtstoffe gelb/rot ist 5,9:1 (Gew%-Verhältnisse). Im Ausführungsbeispiel 2 wird der gleiche Granat-Leuchtstoff wie im Vergleichsbeispiel 2 eingesetzt, wobei dann in einem Verhältnis gelb/rot von 5:1 ein erfindungsgemäßer Leuchtstoff $Sr(Sr_{0,86}Ca_{0,14})Si_2Al_2N_6$:Eu mit einem Eu-Anteil von 2 Mol% bezogen auf die Seltenerdmetalle

verwendet wird. Die Dominanzwellenlänge des blau emittierenden LED-Chips bei einer Stromstärke von 350 mA beträgt 444,5 nm, wobei 39 Gew% Leuchtstoffmischung im Bezug auf den Silikonverguß verwendet wurden.

Der Tabelle der Figur 50a kann entnommen werden, dass die LED mit dem erfindungsgemäßen Leuchtstoff wiederum eine höhere Konversionseffizienz $\Phi_{v(\text{gefüllter Verguß})}/\Phi_{e(\text{klarer Verguß})}$ im Vergleich zu der LED mit der herkömmlichen Leuchtstoffmischung bei den jeweiligen Stromstärken aufweist. Die Werte sind dabei in Relation zum Vergleichsbeispiel 2 angegeben, dass auf 100 % für die jeweilige Stromstärke normiert wurde (Durchschnitt von 4 LEDs).

Bei Mobilfunkgeräten der neuesten Generation können sogenannte "True-Tone-Blitze" eingesetzt werden, die neben einer kaltweißlichtemittierenden LED auch eine zweite LED aufweisen, die entweder warmweißes Licht oder gelbes Licht ("amber") emittieren. Diese zweite LED wird in Situationen verwendet, in denen das Umgebungslicht eine niedrigere Farbtemperatur als Tageslicht (kaltweiß) aufweist, um ein Blitzlicht zu erzeugen, dass sich der Farbtemperatur des Umgebungslichts so weit wie möglich annähert. Um Licht verschiedener Farbtemperaturen zu erzeugen, müssen das kaltweiße Licht und das Licht der gelb emittierenden LED in verschiedenen Verhältnissen miteinander gemischt werden. Dies kann beispielsweise dadurch erreicht werden, dass beide LEDs mit unterschiedlichen Stromstärken betrieben werden. Wenn das Blitzlicht eine ähnliche Farbtemperatur wie das Umgebungslicht aufweist erscheinen die Farben auf dem Bild natürlicher.

Ähnlich wie beim Ausführungsbeispiel 1, so sind auch die erfindungsgemäßen Leuchtstoffmischungen des Ausführungsbeispiels 2 mit zunehmender Stromstärke stabiler als die herkömmlichen Leuchtstoffmischungen, die einen beträchtlichen Anteil ihrer roten Emission im Vergleich zu den gelben Emissionsanteilen vor allem bei höheren Stromstärken verlieren.

Figuren 50b und 50c zeigen die LED-Spektren des Vergleichsbeispiels 2 (Figur 50b) und des Ausführungsbeispiels 2 (Figur 50c) bei Stromstärken von 40 und 1000 mA. Ein Vergleich beider LED Spektren zeigt, dass bei der herkömmlichen Leuchtstoffmischung des Vergleichsbeispiels 2 ein beträchtlicher Anteil des rot emittierenden Spektrums bei steigenden Stromstärken im Vergleich zu erfindungsgemäßen Leuchtstoffmischungen verloren geht.

Figur 50d zeigt die Stabilität des Farbpunkts mit zunehmendem Stromstärken für das Vergleichsbeispiel 2 und das Ausführungsbeispiel 2. Aufgrund der geringeren Abnahme der Emission im roten Bereich beim Ausführungsbeispiel 2 im Bezug zum Vergleichsbeispiel 2 ist die Veränderung des Farbpunkts der LED des Ausführungsbeispiels 2 wesentlich weniger ausgeprägt als bei der LED des Vergleichsbeispiels 2.

Die normierten LED-Spektren für das Ausführungsbeispiel 2 und das Vergleichsbeispiel 2 sind in Figur 50d gezeigt. Die erfindungsgemäße Leuchtstoffmischung zeigt dabei gegenüber der herkömmlichen Leuchtstoffmischung eine signifikant verminderte Emissionsintensität im Wellenlängenbereich > 650 nm. Dies ist vor allen Dingen auf die verminderte FWHM des erfindungsgemäßen Leuchtstoffs im Vergleich zum herkömmlichen 2-5-8 Leuchtstoff zurückzuführen.

Zusammenfassend gesagt kann daher mit niedrigeren Betriebsströmen bei erfindungsgemäßen Leuchtstoffmischungen im Vergleich zu herkömmlichen Leuchtstoffmischungen eine gleiche Lichtausbeute erzielt werden. Da der Stromverbrauch bei mobilen Anwendungen, wie beispielsweise Mobiltelefonen ein entscheidendes Kriterium für die Betriebsdauer ist, ist ein niedriger Verbrauch sehr wichtig. Weiterhin sind hellere LEDs mit erfindungsgemäßen Leuchtstoffmischungen möglich, was den Bereich an Farbpunkten erweitert, insbesondere für "True-Tone-Blitze". Sollte eine höhere Lichtausbeute nicht erwünscht sein, so können LED-Chips mit einer schwächeren Strahlungsemission im Vergleich zu herkömmlichen LED Chips, zum Beispiel für gelb emittierende LEDs ("amber") verwendet werden, was den Ausschuss während der LED-Chip Produktion verringert und somit auch die Benutzung von ansonsten zu dunklen LED-Chips ermöglicht.

**Ausführungsbeispiele für warmweißes Licht mit CRI ≥ 80:**

Gemäß einer weiteren Ausführungsform der vorliegenden Erfindung werden erfindungsgemäße Leuchtstoffe zur Erzeugung von warmweißen Licht, beispielsweise für Allgemeinbeleuchtungsanwendungen verwendet. Warmweißes Licht emittierende Leuchtvorrichtungen mit erfindungsgemäßen Leuchtstoffen können insbesondere einen "color rendering index" (CRI) ≥ 80, bevorzugt ≥ 82 erreichen.

Als Strahlungsquelle von Leuchtvorrichtungen zur Erzeugung von warmweißen Licht können besonders gut blau emittierende LEDs, beispielsweise InGaN-LEDs, verwendet werden, die Licht mit einer Dominanzwellenlänge der Emission von 430-470 nm, bevorzugt 440-460 nm, weiter bevorzugt von 445-455 nm als Primärstrahlung emittieren. Zur Konversion der Primärstrahlung können als erster Leuchtstoff erfindungsgemäße Leuchtstoffe der allgemeinen Formel $Sr(Sr_aCa_{1-a})\ Si_2Al_2N_6$:D eingesetzt werden, wobei 0,7 ≤ a, bevorzugt 0,8 ≤ a, weiter bevorzugt 0,84 ≤ a, wobei a <1 und wobei der Anteil an Aktivator D, bevorzugt Europium bezogen auf den Mol-Anteil der Erdalkalimetalle ≥ 1 Mol%, bevorzugt ≥ 2 Mol%, weiter bevorzugt ≥ 3 Mol% beträgt.

Als zweiter Leuchtstoff kann beispielsweise ein grün-gelb emittierender Granat der allgemeinen Formel $(Gd,Lu,Y,Tb)_3(Al,Ga)_5(O)_{12}$:RE mit RE = Seltenenerdmetall, bevorzugt Ce, eingesetzt werden. Der Granat weist bevorzugt die allgemeine Formel $Y_3(Al_{1-x}Ga_x)_5(O)_{12}$:Ce auf, wobei der Anteil an Ga 0,2 ≤ x ≤ 0,6, bevorzugt 0,3 ≤ x ≤ 0,5, weiter bevorzugt 0,35 ≤ x ≤ 0,45 beträgt.

Ein Vorteil der in der Verwendung eines Granatleuchtstoffs der Formel $Y_3(Al_{1-x}Ga_x)_5(O)_{12}$:Ce anstelle eines Granatleuchtstoffs der Formel $Lu_3(Al_{1-x}Ga_x)_5(O)_{12}$:Ce besteht darin, dass der erstgenannte Granatleuchtstoff $Y_3(Al_{1-x}Ga_x)_5(O)_{12}$:Ce eine geringere Dichte von ca. 4,5-5 g/ $cm^3$ hat, während der zweitgenannte Leuchtstoff $Lu_3(Al_{1-x}Ga_x)_5(O)_{12}$:Ce eine Dichte von ca. 6,7-7 g/$cm^3$ hat und daher eine geringere Masse an Leuchtstoff für eine gegebene Anwendung verbraucht werden. Weiterhin kann deshalb das billigere und weiterverbreitetere $Y_2O_3$ anstelle von $Lu_2O_3$ als Ausgangsmaterial für die Herstellung des Leuchtstoffs verwendet werden, sodass der Anschaffungspreis des Granat-Leuchtstoffs reduziert wird.

Die Verwendung eines erfindungsgemäßen ersten Leuchtstoffs zeigt höhere Absorptionen im Vergleich zu Leuchtstoffmischungen, die herkömmliche 2-5-8 Leuchtstoffe oder $CaAlSiN_3$ Leuchtstoffe enthalten. Überraschenderweise ist die Absorption bei erfindungsgemäßen Leuchtstoffen bei gleichen Aktivator-Gehalt erheblich höher als bei herkömmlichen 2-5-8 Leuchtstoffen. Dies ermöglicht eine drastische Verringerung der Menge an rot emittierenden Leuchtstoff im Vergleich zu herkömmlichen Lösungen und eine sehr hohe Konversionseffizienz. Gleichzeitig ermöglichen die exzellenten optischen Eigenschaften der erfindungsgemäßen rot emittierenden Leuchtstoffe eine sehr hohe Lichtausbeute und hohe Konversionseffizienz mit hohem CRI.

Im Folgenden sollen einige Ausführungsbeispiele von Leuchtvorrichtungen für Allgemeinbeleuchtungsanwendungen mit einem hohen CRI näher beschrieben werden.

Figur 51a zeigt eine tabellarische Aufstellung eines Vergleichsbeispiels 1 und 2 sowie eines Ausführungsbeispiels 1 und 2. Bei allen Beispielen wird eine blau emittierende InGaN-LED mit einer Dominanzwellenlänge von 446 nm verwendet, in deren Standard-Silikon Verguß Leuchtstoffmischungen eingebracht wurden, bei denen Granat-Leuchtstoffe entweder mit herkömmlichen rot emittierenden Leuchtstoffen oder mit erfindungsgemäßen rot emittierenden Leuchtstoffen im Silikon-Verguß vermischt sind.

Im Vergleichsbeispiel 1 wird ein Cer-aktivierter Yttrium-Aluminium-Gallium-Granat (in den folgenden Figuren abgekürzt als YAGaG) mit einem herkömmlichen $(Sr_{0,7}Ca_{0,3})AlSiN_3$ Leuchtstoff (in den folgenden Figuren abgekürzt als (SCASN) als Leuchtstoffmischung in einer Konzentration von 15 Gew% relativ zu der Gesamtmasse des Silikon-Vergußes der blauen LED eingebracht, wobei das Verhältnis von grünem zu roten Leuchtstoff 2,0 beträgt (Gew%-Verhältnis). Die absoluten Konzentrationen an grünem Leuchtstoff betragen 10 Gew% und am roten Leuchtstoff 5 Gew%. Weiterhin ist die korrelierten Farbtemperatur CCT, der CRI, R9-Wert für rote Farbtöne sowie die relative Konversionseffizienz relativ zu dem Vergleichsbeispiel 2 angegeben.

Vergleichsbeispiel 2 enthält eine Mischung eines Lutetium-Aluminium-Granats (in den folgenden Figuren abgekürzt als LuAGaG) sowie eines herkömmlichen 2-5-8 Leuchtstoffs (in den folgenden Figuren abgekürzt als 258). Im Gegensatz dazu enthalten die Ausführungsbeispiele 1 und 2 entweder einen Yttrium-Aluminium-Granat oder einen Lutetium-Aluminium-Granat zusammen mit unterschiedlichen erfindungsgemäßen Leuchtstoffen (in den folgenden Figuren abgekürzt als 226).

Der tabellarischen Auflistung der Figur 51a kann entnommen werden, dass alle Vergleichs-und Ausführungsbeispiele eine korrelierte Farbtemperatur CCT im Bereich von 2700 K ± 15 K mit einem hohen CRI ≥ 80 und einem hohen R9 von 10 ±1 zeigen. Die Ausführungsbeispiele 1 und 2 zeigen eine erhöhte Konversionseffizienz in Relation zu den Vergleichsbeispielen 1 und 2, wobei aber geringere Mengen an rot emittierenden Leuchtstoffen benötigt werden als bei den Vergleichsbeispielen. Besonders bevorzugt ist Ausführungsbeispiel 1, da dort am wenigsten rot emittierender Leuchtstoff verwendet wird und weiterhin auch ein Yttrium-Aluminium-Gallium-Granat verwendet wird, der die oben beschriebenen hohen Kosten des Lutetium-Aluminium-Granats vermeidet.

Figur 51b zeigt dabei eine Menge in % bezogen auf Vergleichsbeispiel 1 an rot emittierenden Leuchtstoff die für die Ausführungs-bzw. Vergleichsbeispiele aufgewendet werden müssen. Dabei ist deutlich zu erkennen, dass für die Ausführungsbeispiele 1 und 2 wesentlich weniger rot emittierender Leuchtstoff verwendet werden muss als für die Vergleichsbeispiele.

Die erfindungsgemäßen Leuchtstoffe zeigen eine sehr geringe spektrale Halbwertsbreite auf halber Höhe des Maximums FWHM im Vergleich zu den herkömmlichen rot emittierenden Leuchtstoffen, wie aus Figur 51c ersichtlich ist.

Figur 51d zeigt die Emissionsspektren der grün emittierenden Granat-Leuchtstoffe der vorliegenden Vergleichs- und Ausführungsbeispiele. Dabei ist zu erkennen dass der Yttrium-Aluminium-Granat eine Emissionsintensität im blau-grünen Bereich des sichtbaren Spektrums (470-520 nm) zeigt, die vergleichbar oder besser ist als bei anderen grün emittierenden Granat-Leuchtstoffen. Aus diesem Grund lassen sich mit diesem Granat-Leuchtstoff besonders kostengünstig (Vermeidung von Lutetium) warmweiß emittierende Leuchtvorrichtungen mit einem hohen CRI realisieren.

Das thermische Quenchen von verschiedenen grün-gelb emittierenden Granat-Leuchtstoffen und einem grün emittierenden Orthosilikat-Leuchtstoff von Raumtemperatur bis 125 °C im Bezug auf die absolute Helligkeit bei 25 °C sind in Figur 51e gezeigt. Diesem Diagramm lässt sich entnehmen, dass der bevorzugte Leuchtstoff des Typs $(Lu,Y)_3(Al,Ga)_5(0)_{12}:Ce^{3+}$ im Gegensatz zu Orthosilikatleuchtstoffen nur sehr geringes thermisches Quenchen bei höheren Temperaturen zeigt.

Die negativen Auswirkungen des thermischen Quenchens der verschiedenen verwendeten rot emittierenden Leuchtstoffe der Vergleichs-und Ausführungsbeispiele auf die absolute Helligkeit sind in Figur 51f gezeigt. Dabei zeigen die erfindungsgemäßen Leuchtstoffe vergleichbares thermisches Quenchen wie die besten 2-5-8-Leuchtstoffe, während ein anderer 2-5-8 Leuchtstoff $Ca_2Si_5N_8:Eu^{2+}$ (2%) merkliches Quenchen zeigt.

Den Figuren 51g und 51h lassen sich die LED Spektren der LEDs der Ausführungsbeispiele 1 und 2 entnehmen. In diesen Spektren sind die Peaks der unkonvertierten blauen Primärstrahlung der LED bei Wellenlängen zwischen 410 und 460 nm, sowie die grün-roten Anteile der konvertierten Sekundärstrahlung deutlich zu erkennen. Durch die additive Farbmischung dieser Primär-und Sekundär-Strahlungskomponenten wird warmweißes Licht mit einem hohen CRI erzeugt.

Gemäß einer weiteren Ausführungsform wird eine Leuchtvorrichtung zur Erzeugung eines Weißlichts mit einem CRI $\geq$ 90 bereitgestellt, wobei die Strahlungsquelle eine Primärstrahlung im Wellenlängenbereich zwischen 430 nm bis 470 nm, bevorzugt 440 bis 460 nm, weiter bevorzugt 445 nm bis 455 nm abstrahlt, und als zweiter Leuchtstoff ein Granat der allgemeinen Formel $(Gd,Lu,Y,Tb)_3(Al,Ga)_5(O)_{12}:RE$, bevorzugt $(Lu,Y)_3(Al,Ga)_5(O)_{12}:RE$ mit RE = Seltenenerdmetall, bevorzugt Ce, vorhanden ist.

Bei dieser Leuchtvorrichtung zur Erzeugung eines Weißlichts mit einem CRI $\geq$ 90 ist im ersten Leuchtstoff, der eine der bereits oben beschriebenen allgemeinen Formeln aufweisen kann, insbesondere $Sr(Sr_aM_{1-a})Si_2Al_2N_6:D$, das Metall M Sr und Ca, wobei für den Parameter a gilt: 0,7 $\leq$ a, bevorzugt 0,8 $\leq$ a, weiter bevorzugt 0,84 $\leq$ a, wobei der Anteil des Aktivators D $\geq$ 1.5%, bevorzugt $\geq$ 3.5%, weiter bevorzugt $\geq$ 4.5% Mol% beträgt.

Im Folgenden sollen einige Ausführungsbeispiele von erfindungsgemäßen Leuchtstoffmischungen vorgestellt werden, die einen hohen CRI $\geq$ 90 aufweisen.

Figur 52a zeigt in tabellarischer Übersicht ein Vergleichsbeispiel 1 sowie die Ausführungsbeispiele 1 bis 4, die neben einem Cer-aktivierten gelb-grün emittierenden Granatleuchtstoff auch noch erfindungsgemäße Leuchtstoffe enthalten. Als primäre Strahlungsquelle wurde ein InGaN-LED-Chip mit den angegebenen Dominanzwellenlängen eingesetzt, in dessen Strahlengang die Leuchtstoffmischungen angeordnet sind (Leuchtstoffmischungen im Standard-Silikon Verguß vorhanden). Die Messungen wurden bei einer korrelierten Farbtemperatur (CCT) von 2700 K $\pm$30 K durchgeführt. Dabei ist zu erkennen dass die Ausführungsbeispiele 1 bis 4 eine im Vergleich zum herkömmlichen Vergleichsbeispiel erhöhte Konversionseffizienz aufweisen. Gleichzeitig muss bei den erfindungsgemäßen Leuchtstoffmischungen weniger roter Leuchtstoff eingesetzt werden.

Bezugnehmend auf die vorherige Figur 52a wird in Figur 52b eine Gegenüberstellung der Messdaten für das Vergleichsbeispiel 1 im Unterschied zum Ausführungsbeispiel 1 bei korrelierten Farbtemperaturen von 2700 K und 4000 K gezeigt. Wieder ist zu erkennen, dass die Konversionseffizienz des Ausführungsbeispiels höher ist als die Konversionseffizienz des Vergleichsbeispiels.

Figur 52c zeigt in der linken Hälfte eine grafische Darstellung der Reflektivität in Abhängigkeit von der Wellenlänge für einen herkömmlichen Leuchtstoff $(Sr,Ca)AlSiN_3$: 0,4% Eu wie für die beiden erfindungsgemäßen Leuchtstoffe $Sr(Sr_{0,84}Ca_{0,16})Si_2Al_2N_6$:4,7% Eu (bezeichnet mit $Sr(Sr,Ca)Si_2Al_2N_6:Eu$ (8% Ca, 4,7% Eu) im Diagramm) und $Sr(Sr_{0,8}Ca_{0,20})Si_2Al_2N_6$:3,7% Eu (bezeichnet mit $Sr(Sr,Ca)Si_2Al_2N_6:Eu$ (10% Ca, 3,7% Eu) im Diagramm) . Dabei fällt die höhere Absorption der erfindungsgemäßen Leuchtstoffe im Wellenlängenbereich zwischen 300-600 nm aufgrund des erhöhten Anteils von Europium auf. Gleichzeitig zeigen die erfindungsgemäßen Leuchtstoffe eine erhöhte Konversionseffizienz. Die rechte Abbildung der Figur 52c zeigt den hohen Verbrauch an rotem Leuchtstoff beim Vergleichsbeispiel 1 (linker Balken) im Unterschied zum Ausführungsbeispiel 1 (rechter Balken) bei korrelierten Farbtemperaturen von 4000 bzw. 2700 K und hier wird besonders deutlich, dass bei erfindungsgemäßen Leuchtstoffmischungen, die den neuen Leuchtstoff enthalten, wesentlich weniger Leuchtstoff verwendet werden muss.

Ein grafischer Vergleich der temperaturabhängigen Veränderungen des LED-Farborts von zwei Ausführungsbeispielen im Vergleich zum Vergleichsbeispiel 1 von Raumtemperatur bis 85 °C ist in Figur 52d gezeigt. Dabei ist zu erkennen, dass die Verschiebung des LED-Farborts in Abhängigkeit von der Temperatur beim Vergleichsbeispiel 1 deutlicher ausgeprägt ist als bei den Ausführungsbeispielen 3 und 4.

Figur 52e zeigt einen Vergleich der Emissionsspektren von zwei erfindungsgemäßen rot emittierenden Leuchtstoffen im Vergleich zu einem herkömmlichen Leuchtstoff der Formel $(Sr,Ca)AlSiN_3$: 0,4% Eu. Die erfindungsgemäßen Leuchtstoffe zeigen dabei im Unterschied zum herkömmlichen Leuchtstoff geringere Halbwertsbreiten FWHM, die in einem hohen Farbwiedergabeindex (CRI) und in einer erhöhten Effizienz resultieren.

Die Emissionsspektren verschiedener grün emittierender Granatleuchtstoffe bei einer Anregungswellenlänge von 460 nm, die bei erfindungsgemäßen Leuchtstoffmischungen für Warm-Weißlicht Anwendungen eingesetzt werden, sind in Figur 52f gezeigt. Die Emissionsintensität dieser Granatleuchtstoffe im blau-grünen Bereich des sichtbaren Spektrums (470-520 nm) ist entweder vergleichbar oder sogar besser im Vergleich mit anderen grün emittierenden Granatleuchtstoffen. Dies erlaubt einen guten Farbwiedergabeindex (hohen CRI).

Die Figuren 52g und 52h zeigen Spektren von blau emittierenden LEDs, in deren Verguß Leuchtstoffmischungen gemäß dem Ausführungsbeispiel 1 bei korrelierten Farbtemperaturen von 2700 K (Figur 52g) bzw. bei 4000 K (Figur 52h) eingebracht wurden. In beiden Spektren sind die Signale der Sekundärstrahlung der erfindungsgemäßen Leuchtstoffe im roten und grünen Bereich wie auch die Emission der nicht konvertierten Primärstrahlung der LED im blauen Bereich deutlich zu erkennen.

Weitere Ausführungsformen der vorliegenden Erfindung sind auf Leuchtstoff-Mischungen bzw. Beleuchtungsvorrichtungen gerichtet, bei denen im Strahlengang der Strahlungsquelle, beispielsweise einer blauen LED, zumindest drei Leuchtstoffe angeordnet sind. Um entweder den CRI oder die LED-Effizienz bei einem gegebenen Farbort anzupassen, können Leuchtstoff-Mischungen eingesetzt werden, die mehr als zwei Leuchtstoffe aufweisen. Insbesondere bei der Verwendung von drei Leuchtstoffen, beispielsweise eines grün emittierenden Leuchtstoffs, eines gelb emittierenden Leuchtstoffs und eines rot emittierenden Leuchtstoffs gibt es mehrere Möglichkeiten, eine LED mit einem bestimmten Farbpunkt zu erhalten. Ein Problem im Stand der Technik besteht aber darin, dass viele herkömmliche orange-rot emittierende Leuchtstoffe eine breitbandige Emission aufweisen und ein erheblicher Teil des roten Lichts in einem Bereich emittiert wird, für den das menschliche Auge relativ unempfindlich ist.

Daher werden Leuchtstoff-Mischungen vorgeschlagen, die zumindest einen erfindungsgemäßen Leuchtstoff aufweisen. Derartige Beleuchtungsvorrichtungen weisen daher als Strahlungsquelle für die Primärstrahlung eine blaue LED mit einer Dominanzwellenlänge von 300-500 nm, bevorzugt 400-500 nm, weiter bevorzugt 420-470 nm auf. Die Leuchtstoff-Mischung enthält zumindest einen rot emittierenden erfindungsgemäßen Leuchtstoff als ersten Leuchtstoff mit der allgemeinen Formel $Sr(Sr_aM_{1-a})Si_2Al_2N_6$:D, wobei M ausgewählt ist aus der Gruppe Ca, Ba, Zn, Mg, bevorzugt Ca, einen gelb-grün emittierenden Granat-Leuchtstoff der allgemeinen Formel $(Y,Lu,Gd,Tb)_3(Al,Ga)_5O_{12}$:Ce mit einer Peakwellenlänge von 500-570 nm, bevorzugt von 510-560 nm, weiter bevorzugt von 520-550 nm als zweiten Leuchtstoff, sowie als dritten Leuchtstoff entweder einen orange-rot emittierenden erfindungsgemäßen Leuchtstoff der allgemeinen Formel $Sr(Sr_aM_{1-a})Si_2Al_2N_6$:D, wobei M ausgewählt ist aus der Gruppe Ca, Ba, Zn, Mg, bevorzugt Ca oder einen orange-rot emittierenden 2-5-8 Leuchtstoff der allgemeinen Formel $M_2(Si,Al)_5(N,O)_8$:Eu mit M = Ca, Sr, Ba oder einen gelb emittierenden Granat-Leuchtstoff der allgemeinen Formel $(Y,Lu,Gd,Tb)_3(Al,Ga)_5O_{12}$:Ce mit einer Peakemissionswellenlänge von 580-650 nm, bevorzugt von 590-640 nm, weiter bevorzugt von 600-625 nm für den erfindungsgemäßen oder den 2-5-8-Leuchtstoff und von 500 bis 600 nm, bevorzugt 525 bis 575 nm, weiter bevorzugt von 535 bis 565 nm für den Granat-Leuchtstoff.

Der erfindungsgemäße rot emittierende Leuchtstoff als erster Leuchtstoff wird bevorzugt derart ausgewählt, dass er in Kombination mit der blauen LED und dem Granat-Leuchtstoff und dem gelb-roten Leuchtstoff einen CRI $\geq$ 75, bevorzugt $\geq$ 80, weiter bevorzugt $\geq$ 85 und mehr bevorzugt $\geq$ 90 ergibt für einen großen Bereich der korrelierten Farbtemperatur CCT von zumindest 4000 bis 2700 K, weiter bevorzugt von 5000 bis 2700 K, weiterhin bevorzugt von 6500 bis 2400 K. Dies wird am besten dadurch erreicht, dass ein erfindungsgemäßer Leuchtstoff mit einer Halbwertsbreite FWHM < 85 nm, bevorzugt < 82 nm, weiter bevorzugt < 80 nm mit der allgemeinen Formel $Sr(Sr_aCa_{1-a})$ $Si_2Al_2N_6$:Eu mit a $\geq$ 0,8 und einem Europium-Anteil von 0,1 bis 10 Mol%, bevorzugt 2-5 Mol% verwendet wird. Die bevorzugten erfindungsgemäßen Leuchtstoffe weisen eine hohe Temperaturstabilität und eine hohe Konversionseffizienz bei den typischen Betriebsbedingungen für warmweiße Beleuchtungsvorrichtungen auf.

Der als zweiter Leuchtstoff eingesetzte grün-gelb emittierende Granat-Leuchtstoff kann beispielsweise die allgemeine Formel $Lu_3(Al,Ga)_5O_{12}$:Ce aufweisen, wobei er derart ausgewählt ist, dass eine hohe Konversionseffizienz und Temperaturstabilität resultiert. Dies kann beispielsweise dadurch geschehen das ein Granat-Leuchtstoff der allgemeinen Formel $Lu_3(Al,Ga)_5O_{12}$:Ce mit einem Cer-Anteil von 1-5 Mol%, bevorzugt 1-3 Mol% und einem Gallium-Anteil von 0-50 Mol%, bevorzugt 0-30 Mol% ausgewählt wird, so dass die allgemeine Formel $Lu_3(Al_{1-x}Ga_x)_5O_{12}$:Ce mit $0 \leq x \leq 0,5$, bevorzugt $0 \leq x \leq 0,3$ resultiert. Andere Elementkombinationen innerhalb des allgemeinen Systems der Granat-Leuchtstoffe sind ebenfalls möglich, insbesondere Varianten bei denen zumindest ein Teil des Lutetium durch Yttrium in der allgemeinen Formel ersetzt ist.

Als dritter Leuchtstoff kann bevorzugt ein Leuchtstoff eingesetzt werden der in Kombination mit der blauen LED und dem Granat-Leuchtstoff sowie dem rot emittierenden erfindungsgemäßen Leuchtstoff einen CRI $\geq$ 75, bevorzugt $\geq$ 80, weiter bevorzugt $\geq$ 85 und am bevorzugten $\geq$ 90 über einen großen CCT-Bereich ergibt, beispielsweise von 4000-2700 K, weiter bevorzugt von 5000-2700 K, am bevorzugtesten von 6500-2400 K. Beispielsweise kann als dritter Leuchtstoff ein Nitrido-Silikat-Leuchtstoff der allgemeinen Formel $(Ca,Sr,Ba)_2(Si,Al)_5(N,O)_8$:Eu, wobei die Peakwellenlänge 580-650 nm, bevorzugt 590-640 nm, weiter bevorzugt 600-625 nm beträgt mit einem Europium-Anteil von 0,1 bis 10 Mol%, bevorzugt von 0,1 bis 5 Mol%, weiterhin bevorzugt von 0,5-3 Mol%, sowie einen Barium-Anteil von 30-100 Mol%, bevorzugt von 40-75 Mol%, weiter bevorzugt von 45-55 Mol% und einen Calcium-Anteil von 0-20 Mol%, bevorzugt 0-10 Mol%, weiterhin bevorzugt 0-5 Mol% verwendet werden, wobei der Strontium-Anteil so ausgewählt ist, dass er in Summe mit den Erdalkalimetallen und dem Europium 100 ergibt.

Alternativ kann als dritter Leuchtstoff auch ein erfindungsgemäßer Leuchtstoff der allgemeinen Formel $Sr(Sr_aCa_{1-a})Si_2Al_2N_6$:Eu mit einer Halbwertsbreite FWHM < 85 nm, bevorzugt < 80 nm, weiterhin bevorzugt < 78 nm verwendet werden, wobei die Peakwellenlänge 580-650 nm, bevorzugt 590-640 nm, weiter bevorzugt 600-625 nm beträgt. Um diese spektralen Eigenschaften zu erzielen, wird ein erfindungsgemäßer Leuchtstoff der allgemeinen Formel $Sr(Sr_aCa_{1-a})Si_2A1_2N_6$:Eu mit a ≥ 0,8, bevorzugt a ≥ 0,82, weiter bevorzugt a ≥ 0,85 mit einem Europium-Anteil von 0,1 bis 5 Mol%, bevorzugt 0,1 bis 3 Mol%, am bevorzugtesten 0,1 bis 2 Mol% eingesetzt.

Als dritter Leuchtstoff kann weiterhin ein gelb emittierender Granat-Leuchtstoff $(Lu,Gd,Tb,Y)_3(Al,Ga)_5O_{12}$:Ce mit einer Peakemissionswellenlänge von 500-600 nm, bevorzugt 525-575 nm, weiter bevorzugt von 535-565 nm eingesetzt werden. Dies kann insbesondere durch einen Granat-Leuchtstoff der allgemeinen Formel $Y_3(Al,Ga)_5O_{12}$:Ce geschehen, der eine hohe Konversionseffizienz und Temperaturstabilität aufweist. Dies kann beispielsweise dadurch geschehen, dass ein Granat-Leuchtstoff der allgemeinen Formel mit einem Cer-Anteil von 1 bis 6 Mol%, bevorzugt 1 bis 4 Mol% und einem Gallium-Anteil von 0-50 Mol%, bevorzugt 0-25 Mol% eingesetzt wird, so dass die allgemeine Formel $Y_3(Al_{1-x}Ga_x)_5O_{12}$:Ce mit $0 \leq x \leq 0,5$, bevorzugt $0 \leq x \leq 0,25$, resultiert, wobei weiterhin auch andere Elementkombinationen innerhalb dieses Systems möglich sind, beispielsweise ein zumindest teilweiser Ersatz von Yttrium durch Lutetium.

Im Folgenden sollen bestimmte technische Vorteile von derartigen Beleuchtungsvorrichtungen gemäß eines Ausführungsbeispiels 1 und 2 im Vergleich zu einem Vergleichsbeispiel 1 und 2 erläutert werden.

Figur 53a zeigt die Zusammensetzung, sowie die Konzentrationen der Leuchtstoffmischungen und die jeweiligen Verhältnisse der ersten bis dritten Leuchtstoffe in Beleuchtungsvorrichtungen, die eine Standard-InGaN-LED mit einer Chip-Fläche von 1 $mm^2$ aufweisen. Figur 53b zeigt die jeweiligen CIE-Farbkoordinaten sowie den CRI und die entsprechenden Konversionseffizienzen, wobei diese im Bezug gesetzt wurden zum Vergleichsbeispiel 1, das auf 100 % gesetzt wurde. Dabei ist wieder deutlich zu erkennen, dass die Ausführungsbeispiele 1 und 2 höhere LED-Effizienzen aufweisen als die herkömmlichen Vergleichsbeispiele.

Figur 53c zeigt einen Vergleich der LED-Spektren der Vergleichsbeispiele 1 und 2 sowie der Ausführungsbeispiele 1 und 2 zusammen mit der Augenempfindlichkeitskurve für Tagsehen des menschlichen Auges. Dabei ist zu erkennen, dass ein großer Teil des Anstiegs der LED-Effizienz mit dem Anstieg des visuellen Nutzeffekts in Verbindung steht, der dadurch zustande kommt, dass erfindungsgemäße Leuchtstoffe eingesetzt werden. Insbesondere wird die Emissionsintensität in einem Spektralbereich in dem das menschliche Auge kaum empfindlich für Licht ist durch Verwendung der erfindungsgemäßen Leuchtstoffe vermindert. Figur 53d zeigt die relative LED-Helligkeit für die Vergleichs- und Ausführungsbeispiele in Abhängigkeit der Temperatur. Die Beleuchtungsvorrichtungen weisen dabei einen geringeren Verlust an Helligkeit bei hohen Temperaturen im Vergleich zur Helligkeit bei 23°C auf als die Vergleichsbeispiele.

## Ausführungsbeispiele für LARP-Anwendungen:

Gemäß einer weiteren Ausführungsform kann als Strahlungsquelle, die das Primärlicht abstrahlt auch ein Laser, beispielsweise eine Laserdiode verwendet werden. In diesem Fall ist es vorteilhaft, wenn der erste erfindungsgemäße Leuchtstoff von der Laser-Strahlungsquelle beabstandet ist (LARP; "laser activated remote phosphor"). Derartige LARP-Anwendungen sind beispielsweise aus den PCT Patentanmeldungen WO 2012/076296 A2, WO 2011/098164 A1 und WO 2013/110495 A2, sowie den weiteren Patentanmeldungen DE 10 2012 209 172 A1, DE 10 2010 062 465 A1, DE 10 2011 002 961 A1 und DE 10 2012 201 790 A1 bekannt, auf die hiermit vollinhaltlich Bezug genommen wird. Mit derartigen Leuchtvorrichtungen, beispielsweise Projektoren lassen sich wesentlich höhere Leuchtdichten als mit herkömmlichen Strahlungsquellen
realisieren.

Bei den folgenden Ausführungsbeispielen wird eine blaue LED-Laserdiode mit einer Strahlungsdichte von 8,9 $W/mm^2$ und einer Peak-Wellenlänge von 446 nm verwendet, deren Strahl auf entweder herkömmliche oder erfindungsgemäße Leuchtstoffkörner gerichtet wird, die sich auf dem Boden einer Ulbricht-Kugel mit einer reflektierenden Innenoberfläche befinden. Das reflektierte, konvertierte Licht wird anschließend eingesammelt und vermessen. Eine derartige Versuchsanordnung simuliert die Verhältnisse bei einer LARP-Leuchtvorrichtung.

In der Tabelle der Figur 54 wird dabei bei einem Vergleichsbeispiel 6 ein herkömmlicher Leuchtstoff mit dem Laserlicht bestrahlt, während im Ausführungsbeispiel 7 eine Ausführungsform eines erfindungsgemäßen Leuchtstoffs mit Laserlicht bestrahlt wird. Deutlich ist zu erkennen, dass bei ähnlichen Dominanzwellenlängen von 601 nm bzw. 597 nm des konvertierten Lichts der visuelle Nutzeffekt bei dem erfindungsgemäßen Leuchtstoff um 42 % höher liegt als bei dem herkömmlichen Leuchtstoff. Das entsprechende Emissionsspektrum ist in der Figur 55 gezeigt, wobei die gestrichelte Linie dem Vergleichsbeispiel 6 und die durchgezogene Linie dem Ausführungsbeispiel 7 entspricht.

Auch in der Tabelle der Figur 56 und dem dazugehörigen Emissionsspektrum der Figur 57 wurden ein herkömmlicher Leuchtstoff und derselbe erfindungsgemäße Leuchtstoff in einem Vergleichsbeispiel 7 und einem Ausführungsbeispiel 8 wie in der Tabelle der Figur 54 mit Laserlicht bestrahlt. Auch bei diesen Experimenten zeigt sich wieder ein erhöhter visueller Nutzeffekt mit dem erfindungsgemäßen Leuchtstoff im Vergleich zu dem herkömmlichen Leuchtstoff (Erhöhung um 13 %).

Insbesondere können bei allen Blitzlichtanwendungen und auch bei anderen Konversionsanwendungen der erfindungsgemäßen Leuchtstoffe, wie zum Beispiel Allgemeinbeleuchtungsanwendungen und soweit es sich nicht um Vollkonversionsanwendungen handelt auch noch Anteile von unkonvertierter Primärstrahlung der Strahlungsquelle vorhanden sein, selbst wenn dies nicht explizit erwähnt wird. Durch Mischung dieser unkonvertierten Primärstrahlung mit der konvertierten Sekundärstrahlung resultiert eine Gesamtemission der Leuchtvorrichtung. Wie beispielsweise bereits weiter oben beschrieben, können warmweißes Licht emittierende Beleuchtungsanwendungen mit erfindungsgemäßen Leuchtstoffen dadurch realisiert werden, dass die blaue Primärstrahlung von InGaN-LEDs mittels der erfindungsgemäßen Leuchtstoffe in einen roten Anteil, sowie mittels grün-gelb emittierender Leuchtstoffe in einem grün-gelben Anteil konvertiert wird, wobei sich dann durch additive Farbmischung der blauen Primärstrahlung und der beiden konvertierten Sekundärstrahlungen warmweißes Licht als Gesamtemission der Beleuchtungsvorrichtung ergibt.

**Ausführungsbeispiele mit unterschiedlichen Eu-Dotierstoffkonzentrationen:**

In den Figuren 58a bis 58c sind die Dominanzwellenlängen, die relativen Intensitäten der Photolumineszenz und die relativen augenbewerteten Photolumineszenzintensitäten verschiedener Ausführungsformen eines erfindungsgemäßen Leuchtstoffs der Formel $Sr(Sr_{0,86}Ca_{0,14})Si_2Al_2N_6$:Eu in Abhängigkeit von steigenden Aktivatorkonzentrationen an Europium gezeigt. Mit steigender Konzentration an Europium-Dotierstoff verschiebt sich dabei die Dominanzwellenlänge der Emission der erfindungs-igemäßen Leuchtstoffe zu höheren Wellenlängen vom orangenen zu roten Farbbereich (siehe Figur 58a) hin, wobei die relative Intensität der Photolumineszenz von 0.1- etwa 4 Mol% ansteigt und dann bei weiter ansteigenden Aktivatorkonzentrationen an Europium wieder abfällt (siehe Figur 58b). Bezogen auf die relative Intensität der Photolumineszenz ist ein Konzentrationsbereich von 1-10 Mol% Eu, bzw. 2-5Mol% bevorzugt. Weitgehend analog zur relativen Intensität der Photolumineszenz verhält sich auch die relative mit der Augenempfindlichkeit bewertete lumineszente Photolumineszenzintensität, die ebenfalls mit steigenden Aktivatorkonzentrationen an Europium zunimmt und ab etwa 4Mol% bis etwa 20 Mol% wieder absinkt (siehe Figur 58c). Dabei wird die Empfindlichkeit des menschlichen Auges für Tagsehen berücksichtigt. Bezogen auf die lumineszente Photo-ilumineszenzintensität sind Aktivatorkonzentrationen von 0,4-10 Mol% Eu, bzw. 1-5 Mol% Europium bevorzugt.

**Ausführungsbeispiele mit weiteren Co-Dotierstoffen bzw. anderen Dotierstoffen als Eu:**

Im Folgenden sollen weitere Ausführungsbeispiele von erfindungsgemäßen Leuchtstoffen mit den allgemeinen Formeln $Sr_{(1-x-h)}(Sr_aM_{1-a})_{(1-y-i)}A_{(x+y)}B_{(h+i)/2}E_{(h+i)/2}Si_{(2-z)}G_zAl_2N_6$:D, und $Sr_{(1-x)}(Sr_aM_{1-a})_{(1-y)}B_{(x+y)}Si_{2-(x+y)}Al_{2+(x+y)}N_6$:D näher beschrieben werden.

Figur 59a zeigt die nominelle Zusammensetzung von fünf verschiedenen Ausführungsformen eines erfindungsgemäßen Leuchtstoffs, wobei beim ersten Leuchtstoff Cu codotiert wurde, beim zweiten Leuchtstoff Zn und beim dritten und vierten Leuchtstoff eine Mischung aus La und Li die Erdalkalimetalle Sr und Ca ersetzt. Im letzten Leuchtstoff ersetzen La und Al die Erdalkalimetalle Sr und Ca sowie Si. In der Tabelle sind die spektralen Eigenschaften der verschiedenen Leuchtstoffe, insbesondere der Farbort im CIE-Farbraum, die durchschnittliche Remission zwischen 450 und 470 nm (R(450-470)), der visuelle Nutzeffekt Vs (Vs = LER/683 [Lm/W], wobei LER = Lichtausbeute), die Dominanzwellenlänge $\lambda$dom und die spektrale Breite auf halber Höhe des Maximums FWHM, angegeben. Deutlich ist zu erkennen, wie die Codotierung mit verschiedenen Metallen den visuellen Nutzeffekt und auch alle anderen spektralen Eigenschaften dieser Leuchtstoffe beeinflusst. Die folgenden Figuren 59b bis 59f zeigen die Emissionsspektren dieser erfindungsgemäßen Leuchtstoffe.

Die Figur 59g zeigt eine Zusammenstellung der Röntgenbeugungdiffraktogramme der oben beschriebenen codotierten erfindungsgemäßen Leuchtstoffe. Mit einem Pfeil ist dabei jeweils der charakteristische Röntgenreflex markiert, der unter anderem die Einordnung der Kristallstruktur auch dieser codotierten erfindungsgemäßen Leuchtstoffe in die monokline Raumgruppe $P2_1$ bedingt.

Figur 60a zeigt in tabellarischer Übersicht verschiedene Ausführungsformen von erfindungsgemäßen Leuchtstoffen bei denen kein Kohlenstoff vorhanden ist und in den beiden anderen Fällen unterschiedliche Mengen an Kohlenstoff zur Codotierung vorhanden sind. Die Leuchtstoffe weisen jeweils die gleiche Aktivatorkonzentration von 3 Mol% Eu bezogen auf die Erdalkalimetalle auf. Analog zur Figur 59a sind auch hier wieder die spektralen Eigenschaften der verschiedenen Leuchtstoffe aufgelistet, wobei "centroid WL" die Schwerpunktswellenlänge des Emissionsspektrums bezeichnet, die einen gewichteten Durchschnitt der Frequenzen, die im Emissionsspektrum vorhanden sind, darstellt. Die Tabelle zeigt, dass durch Codotierung mit Kohlenstoff eine Rotverschiebung des Emissionsspektrums der Leuchtstoffe bedingt wird, was beispielsweise zur Verbesserung des Farbwiedergabeindexes von Leuchtvorrichtungen verwendet werden kann. Die folgende Figur 60b zeigt die Emissionsspektren der verschiedenen Leuchtstoffe der Tabelle der Figur 60a. Deutlich ist dabei die Rotverschiebung aufgrund der Codotierung mit Kohlenstoff zu erkennen.

Die Tabelle der Figur 61a zeigt verschiedene Ausführungsformen von erfindungsgemäßen Leuchtstoffen mit unterschiedlichen Aktivatoren. Beim ersten Leuchtstoff in der Tabelle wird eine Mischung von Eu, Ce und Li verwendet, während bei den anderen Leuchtstoffen entweder Mangan Mn oder Cer Ce als Aktivator dient. Deutlich ist zu erkennen, dass die unterschiedlichen Aktivatoren verschiedene Farborte der Leuchtstoffe im CIE-Farbraum bedingen und dass auch der visuelle Nutzeffekt stark von der Beschaffenheit der Aktivatoren abhängt. Große Unterschiede sind auch noch bei der Dominanzwellenlänge und bei FWHM zu beobachten. In den folgenden Figuren 61b bis 61d sind die Emissionsspektren dieser Leuchtstoffe mit unterschiedlichen Aktivatoren gezeigt.

Die Figuren 62a bis 62e zeigen verschiedene Eigenschaften von erfindungsgemäßen Leuchtstoffen die nur Europium als Aktivator aufweisen im Vergleich zu Leuchtstoffen, die eine Mischung aus Lithium und Europium als Aktivatoren aufweisen.

Figur 62a zeigt einen Graphen mit der Breite beim halben Maximum FWHM für einen herkömmlichen Leuchtstoff der Formel $Sr_xCa_{1-x}AlSiN_3$:Eu im Vergleich zu zwei verschiedenen erfindungsgemäßen Leuchtstoffen $Sr(Sr_aCa_{1-a})Si_2Al_2N_6$:Eu und $Sr(Sr_aCa_{1-a})Si_2Al_2N_6$:Eu,Li für verschiedene Werte x bzw. a für Sr (a = 2x-1). Deutlich ist zu erkennen, dass der herkömmliche Leuchtstoff eine größere Halbwertsbreite aufweist, während beide erfindungsgemäßen Leuchtstoffe geringere Halbwertsbreiten zeigen, wobei insbesondere durch die Codotierung mit Li die Halbwertsbreite weiter reduziert werden kann.

Das thermische Quenchen zweier erfindungsgemäßer Leuchtstoffe wird in Figur 62b gezeigt, wobei die integrale Emissionsintensität gegen die Temperatur aufgetragen ist. Dabei reduziert die Codotierung mit Lithium das thermische Quenchen gegenüber einem erfindungsgemäßen Leuchtstoff der nur Europium als alleinigen Aktivator aufweist.

In Figur 62c ist der Vergleich der Emissionsspektren zweier erfindungsgemäßer Leuchtstoffe gezeigt, wobei ein Leuchtstoff nur mit Europium und der zweite Leuchtstoff mit einer Mischung aus Europium und Lithium dotiert wurden. Beide Leuchtstoffe zeigen eine Dominanzwellenlänge von etwa 604,5 nm, wobei aber die Halbwertsbreite der Emission des erfindungsgemäßen Leuchtstoffs mit der Aktivatormischung Eu,Li nochmals reduziert ist.

Eine Übersicht über die wichtigsten spektralen Eigenschaften, insbesondere dem Farbort im CIE-Farbraum, den visuellen Nutzeffekt Vs, die Dominanzwellenlänge $\lambda$dom und die Halbwertsbreite der Emission FWHM sind in Figur 62d tabellarisch für verschiedene erfindungsgemäße Leuchtstoffe aufgeführt. Wie bereits oben beschrieben, wird deutlich dass die Halbwertsbreite der Emission eines erfindungsgemäßen Leuchtstoffs der mit Europium und Lithium dotiert ist, geringer ist als eines erfindungsgemäßen Leuchtstoffs, der nur mit Europium dotiert wurde. Weiterhin ist auch die erhöhte Quanteneffizienz des mit Europium und Lithium codotierten Leuchtstoffs im Vergleich zu dem anderen erfindungsgemäßen Leuchtstoff zu erkennen.

Die Röntgendiffraktogramme der Leuchtstoffe $Sr(Sr_aCa_{1-a})Si_2Al_2N_6$:Eu (unten) und $Sr(Sr_aCa_{1-a})Si_2Al_2N_6$:Eu,Li (oben) sind in Figur 62e gezeigt. Mit einem Pfeil ist dabei der charakteristische Röntgenbeugungsreflex der neuen Kristallstruktur der Sr $(Sr_aCa_{1-a})Si_2Al_2N_6$-Leuchtstoff-Familie hervorgehoben. Beide erfindungsgemäßen Leuchtstoffe weisen somit die gleiche monokline Kristallstruktur in der Raumgruppe $P2_1$ auf.

In den Figuren 63 bis 73b sind verschiedene beispielhafte Ausführungsformen von Leuchtvorrichtungen 30 mit dem erfindungsgemäßen Leuchtstoff im Querschnitt dargestellt. Bei den Leuchtvorrichtungen kann es sich beispielsweise um Weißlicht, insbesondere um warm- und/oder kaltweiß emittierende Leuchtvorrichtungen, oder um rot emittierende, bzw. rot-orange emittierende Leuchtvorrichtungen handeln. Diese können insbesondere im automotive Bereich, beispielsweise als Blinker, oder Bremslicht eingesetzt werden. Möglich ist auch eine Verwendung in Verkehrsampeln, bei RGB-Anwendungen oder für "color on demand"-Anwendungen, für Allgemeinbeleuchtungsanwendungen wie z. B. Straßenbeleuchtung oder Zimmerbeleuchtungen sowie Blitzlichtanwendungen Diese Leuchtvorrichtungen können jeweils mit und ohne Reflektortopf realisiert werden, wobei auch Multi-Chip-Anordnungen beispielsweise für Blitzlichtanwendungen möglich sind, bei denen mehrere primäre Strahlungsquellen in einer Leuchtvorrichtung kombiniert sind. Als primäre Strahlungsquellen können beispielsweise LEDs, Laserdioden oder auch OLEDs verwendet werden.

Figur 63 zeigt dabei eine Strahlungsquelle 35, beispielsweise eine LED in Form einer InGaN-LED die in einem Reflektortopf 65 angeordnet ist, der die Strahlung der Strahlungsquelle 35 reflektieren kann. Über dieser Strahlungsquelle ist ein erstes Matrixmaterial 50 angeordnet, in dem ein erfindungsgemäßer Leuchtstoff als erster Leuchtstoff 40 eingebettet ist. Dieser Leuchtstoff ist in der Lage, die von der Strahlungsquelle 35 ausgesandte Primärstrahlung, beispielsweise blaues Licht im Wellenlängenbereich von 300 nm bis 570 nm, bevorzugt 300 nm bis 500 nm zu absorbieren und Sekundärstrahlung im orange-roten Wellenlängenbereich in einem Wellenlängenbereich von 570 nm bis 800 nm, bevorzugt 580 nm bis 700 nm, weiter bevorzugt 590 nm bis 650 nm zu emittieren. Die Sekundärstrahlung kann dabei auch in einem Wellenlängenbereich von 580 nm bis 630 nm, bzw. 590 nm bis 620 nm emittiert werden. Erfindungsgemäße Leuchtstoffe können daher alleine zur Vollkonversion oder Teilkonversion von Primärlicht in rote Sekundärstrahlung verwendet werden, wobei erfindungsgemäße Leuchtstoffe in Kombination mit anderen Leuchtstoffen, wie oben beschrieben, auch zur Erzeugung von z. B. Weißlicht eingesetzt werden können.

Das erste Matrixmaterial kann eine Vielzahl von Materialien, die sowohl für die Primärstrahlung, als auch für die durch Konversion entstandene Sekundärstrahlung transparent sind umfassen. Insbesondere kann das erste Matrixmaterial ausgewählt sein aus einer Gruppe von Materialien bestehend aus: Glas, Silikon, Epoxidharz, Polysilazan, Polymethacrylat und Polycarbonat, sowie Kombinationen davon. Als Polymethacrylat kann insbesondere Polymethylmethacrylat (PMMA) verwendet werden. Weiterhin kann der Leuchtstoff auch als keramisches Konverterelement vorliegen.

Figur 64 zeigt eine weitere Ausführungsform einer Leuchtvorrichtung, bei der der erfindungsgemäße erste Leuchtstoff 40 direkt oberhalb der Strahlungsquelle 35 in einer separaten Schicht angeordnet ist. Diese Schicht kann beispielsweise ein Keramik-, ein Phosphor-in-Glas oder ein Silikon-Konverterelement sein, in das der erste Leuchtstoff eingebettet wurde. Auch bei dieser Ausführungsform wird eine effiziente Konversion der Primärstrahlung in Sekundärstrahlung gewährleistet.

Bei der Leuchtvorrichtung der Figur 65 handelt es sich um eine sogenannte "remote phosphor"-Konfiguration bei der die Schicht mit dem ersten Matrixmaterial 50, dass den ersten erfindungsgemäßen Leuchtstoff 40 enthält über einen Zwischenraum 60 von der Strahlungsquelle 35 beabstandet ist. Bei einer derartigen Anordnung kann insbesondere auch sichergestellt werden, dass die Konversion der Primärstrahlung in Sekundärstrahlung nicht durch die von der Strahlungsquelle ausgesandte Wärme beeinträchtigt wird.

Alternativ ist aber auch eine Ausführungsform gemäß Figur 66 möglich, bei der ein Volumen-Verguß oberhalb der Strahlungsquelle 35 erzeugt wurde, dessen erstes Matrixmaterial 35 eine Mischung der ersten und zweiten Leuchtstoffpartikel 40 und 45 enthält.

Weiterhin ist es möglich, dass der erste erfindungsgemäße Leuchtstoff 40 direkt auf der Strahlungsquelle 35 angeordnet ist, beispielsweise in Form eines Silikon-, Phosphor-in-Glas-Konverterelements, oder Keramik-Konverterelements (siehe Figur 67). Der erste Leuchtstoff 40 ist dabei wieder in einem ersten Matrixmaterial 50 eingebettet oder liegt als keramisches Konverterelement vor. Der zweite Leuchtstoff 45 ist in einem, die Strahlungsquelle umgebenden Verguß umfassend ein zweites Matrixmaterial 55 eingebettet. Eine derartige Anordnung kann insbesondere dann von Vorteil sein, wenn der zweite Leuchtstoff Wellenlängenbereiche der durch den ersten Leuchtstoff erzeugten Sekundärstrahlung absorbiert und als Licht mit längerer Wellenlänge wieder emittiert. Das zweite Matrixmaterial kann dabei wieder die gleichen Materialien und deren Kombinationen umfassen, wie das erste Matrixmaterial. Umgekehrt können auch der erste Leuchtstoff im umgebenden Verguß und der zweite Leuchtstoff direkt auf der Strahlungsquelle als Konverterelement angeordnet sein.

Die Figuren 68a und 68b zeigen alternative Ausführungsformen, bei denen entweder der erste oder der zweite Leuchtstoff gegenüber dem jeweils anderen Leuchtstoff im Strahlengang der Primärstrahlung der Strahlungsquelle 35 nachgeordnet sind. Derartige Anordnungen wie auch die Anordnung nach Figur 67 sind von Vorteil, wenn der nachgeordnete Leuchtstoff die durch Konversion erzeugte Primärstrahlung des vorgelagerten Leuchtstoffs reabsorbieren und konvertieren soll oder sind von Vorteil, wenn der vorgeordnete Leuchtstoff Teile der Strahlung des im Strahlengang der Strahlungsquelle nachgeordneten Leuchtstoffs bei umgekehrter Anordnung absorbieren würde, dies aber nicht erwünscht ist.

In den Figuren 69 und 70 sind verschiedene Ausführungsformen von Leuchtvorrichtungen mit dem erfindungsgemäßen ersten Leuchtstoff 40 abgebildet, bei denen das erste Matrixmaterial 50 entweder als Verguß bzw. als Plättchen oberhalb der Strahlungsquelle 35 angeordnet ist. Diese Anordnung ist mittels eines Zwischenraumes 60 von einem Interferenzfilter oder Filterglas 70 getrennt. Das Filterglas, das als Glasplatte, Filterglaspartikel in einem Verguß oder filternder, Strahlung absorbierender zweiter Leuchtstoff vorliegen kann, kann beispielsweise dazu dienen, bestimmte Wellenlängenbereiche des konvertierten Lichts zu absorbieren, bzw. nicht konvertierte Anteile der Primärstrahlung zu absorbieren, so dass derartige Leuchtvorrichtungen zur weitgehend vollständigen Konversion von Primärstrahlung in Sekundärstrahlung verwendet werden können. Im Bezug auf Kombinationen eines ersten Leuchtstoffs mit Filterpartikeln, die auch einen zweiten Leuchtstoff beinhalten können, wird hiermit vollinhaltlich Bezug genommen auf die deutsche Patentanmeldung DE 10 2014 105 588.8 mit Anmeldetag 17.4.2014.

Die Figuren 71 und 72 zeigen weitere Ausführungsformen von Leuchtvorrichtungen mit dem erfindungsgemäßen Leuchtstoff, bei denen die Schichten, die die Leuchtstoffe enthalten durch einen Zwischenraum 60 voneinander beabstandet sind. Dabei können bei den einzelnen Vorrichtungen dieser beiden Figuren die ersten Leuchtstoffe 40 und die zweiten Leuchtstoffe 45 auch jeweils vertauscht sein.

Figuren 73a und Fig. 73b zeigen jeweils im Querschnitt eine mögliche Ausführungsform einer Leuchtvorrichtung 30, die für Blitzlichtanwendungen geeignet ist. Dabei sind zwei Strahlungsquellen 35 als LED-Chips in einem Reflektortopf 65 angeordnet (Figur 73a) bzw. in zwei separaten Reflektortöpfen 65 vorhanden (Figur 73b). Auf beiden LED-Chips sind Leuchtstoffpartikel 40 und 45 angeordnet, wobei die LED-Chips unterschiedliche Leuchtstoffmischungen/ Leuchtstoffe in ihrem Strahlengang angeordnet haben. Auf diese Weise können beispielsweise zwei LEDS oder LED-Module innerhalb der Leuchtvorrichtung vorhanden sein, die Licht unterschiedlicher Farbtemperatur und/oder Farbe emittieren (z. B. kaltweiß und warmweiß oder amber). Eine den Leuchtstoffen/ Leuchtstoffmischungen im Strahlengang nachgeschaltete Linse 75 dient zum Mischen der von beiden LEDS oder LED-Modulen emittierten Strahlung, so dass eine aus der Mischung der Strahlung beider LEDS oder LED-Module resultierende Gesamtemission der Leuchtvorrichtung von einem äußeren Beobachter wahrgenommen wird. Durch Betreiben der beiden LEDS bzw. LED-Module mit unterschiedlichen Treiberströmen kann somit die von der Leuchtvorrichtung abgegebene Gesamtemission bzgl. deren Farbe und/oder Farbtemperatur individuell angepasst werden.

Im Folgenden werden Ausführungsformen von erfindungsgemäßen Leuchtstoffen durch eine im Vergleich zu oben aufgeführten Offenbarung alternativen Charakterisierung beschrieben, die aber konsistent mit der oben aufgeführten Offenbarung ist.

Es wird ein Leuchtstoff angegeben. Darüber hinaus werden ein Verfahren zur Herstellung eines solchen Leuchtstoffs und eine Verwendung eines solchen Leuchtstoffs angegeben.

Eine zu lösende Aufgabe besteht darin, einen Leuchtstoff anzugeben, der spektral vergleichsweise schmalbandig im roten Spektralbereich emittiert.

Diese Aufgabe wird unter anderem durch einen Leuchtstoff, durch ein Verfahren und durch eine Verwendung mit den Merkmalen der unabhängigen Patentansprüche gelöst. Bevorzugte Weiterbildungen sind Gegenstand der abhängigen Ansprüche. Gemäß zumindest einer Ausführungsform ist der Leuchtstoff zur Emission vom rotem Licht eingerichtet. Rotes Licht bedeutet, dass der Leuchtstoff Strahlung mit einer Dominanzwellenlänge zwischen einschließlich 585 nm und 640 nm, insbesondere zwischen einschließlich 590 nm und 615 nm, emittiert.

Es ist die Dominanzwellenlänge insbesondere diejenige Wellenlänge, die sich als Schnittpunkt der Spektralfarblinie der CIE-Normfarbtafel mit einer geraden Linie ergibt, wobei diese gerade Linie, ausgehend vom Weißpunkt in der CIE-Normfarbtafel, durch den tatsächlichen Farbort der Strahlung verläuft. Im Allgemeinen weicht die Dominanzwellenlänge von einer Wellenlänge maximaler Intensität ab. Insbesondere liegt die Dominanzwellenlänge im roten Spektralbereich bei kleineren Wellenlängen als die Wellenlänge maximaler Intensität.

Gemäß zumindest einer Ausführungsform weist der Leuchtstoff die allgemeine Summenformel $Sr_xCa_{1-x}AlSiN_3$:Eu auf. Es ist möglich, dass der Leuchtstoff weitere Elemente etwa in Form von Verunreinigungen aufweist, wobei diese Verunreinigungen zusammen genommen bevorzugt höchstens einen Gewichtsanteil an dem Leuchtstoff von höchstens 0,1 Promille oder 10 ppm, parts per million, aufweisen.

Gemäß zumindest einer Ausführungsform des Leuchtstoffs gilt $x > 0{,}8$ oder $x \geq 0{,}82$ oder $x \geq 0{,}85$ oder $x \geq 0{,}89$. Alternativ oder zusätzlich gilt $x \leq 1$ oder $x < 1$ oder $x \leq 0{,}98$ oder $x \leq 0{,}95$ oder $x \leq 0{,}92$.

Gemäß zumindest einer Ausführungsform liegt der Anteil der Sr-Gitterplätze, die durch Eu ersetzt sind, bei mindestens 0,01% oder 0,1% oder 0,35% oder 0,5%. Alternativ oder zusätzlich liegt dieser Anteil bei höchstens 10% oder 5% oder 3% oder 2,2% oder 1,8%.

Gemäß zumindest einer Ausführungsform weist der Leuchtstoff in einer Röntgenstrukturanalyse einen Reflex mit den Miller'schen Indizes $1\bar{2}1$ auf, wenn eine orthorhombische Beschreibung der kristallographischen Zelle zugrunde gelegt wird. In dieser Angabe sind symmetrieäquivalente Beschreibungen wie $1\overline{21}$ mit eingeschlossen.

In mindestens einer Ausführungsform ist der Leuchtstoff zur Emission von rotem Licht und bevorzugt zur Anregung mit blauem Licht eingerichtet und weist die allgemeine Summenformel $Sr_xCa_{1-x}AlSiN_3$:Eu auf mit $0{,}8 < x \leq 1$. Ein Anteil der Sr-Gitterplätze zwischen einschließlich 0,1% und 5% ist durch Europium ersetzt. In einer Röntgenstrukturanalyse weist der Leuchtstoff in orthorhombischer Beschreibung einen Reflex mit den Miller'schen Indizes $\mathbf{1\bar{2}1}$ auf.

Im ultravioleten Spektralbereich bis in den blau-grünen Spektralbereich anregbare Leuchtstoffe, die rotes Licht emittieren, sind von großer Bedeutung für die Herstellung von weißen Leuchtdioden. Speziell bei Leuchtdioden mit niedrigen Farbtemperaturen, sogenannten warmweißemittierenden Leuchtdioden, und/oder bei Leuchtdioden mit hohem Farbwiedergabeindex sind solche Leuchtstoffe erforderlich. Auch in einer Vielzahl von anderen Anwendungen, etwa für die Display-Hinterleuchtung, sogenannte Color-On-Demand-Anwendungen oder auch für orange und rote Vollkonversionsleuchtdioden sind derartige Leuchtstoffe erforderlich. Ebenso ist der Einsatz in Kombination mit einer organischen Leuchtdiode, kurz OLED, möglich. Der hier beschriebene Leuchtstoff ist für derartige Anwendungen einsetzbar.

Gemäß zumindest einer Ausführungsform weist der Leuchtstoff in einem Pulverdiffraktogramm bei Bestrahlung mit monochromatischer $Cu\text{-}K_{\alpha1}$-Strahlung einen Reflex bei einem Winkel $2\theta$ zwischen 36,7° und 37,0° auf, je nach der Zusammensetzung des Leuchtstoffs. Die exakte Position dieses Reflexes ist abhängig von dem Parameter x in der allgemeinen Summenformel des Leuchtstoffs. Eine Intensität dieses Reflexes, insbesondere bezogen auf einen Hauptreflex, liegt bevorzugt bei mindestens 0,3% oder 0,5% und/oder bei höchstens 10% oder 8% oder 5% oder 4%.

Gemäß zumindest einer Ausführungsform liegt die Dominanzwellenlänge des Leuchtstoffs bei mindestens 596 nm oder 598 nm. Alternativ oder zusätzlich liegt die Dominanzwellenlänge bei höchstens 606 nm oder 604 nm. Die Wellenlänge maximaler Intensität liegt beispielsweise bei mindestens 605 nm oder 610 nm und/oder bei höchstens 630 nm oder 625 nm.

Gemäß zumindest einer Ausführungsform weist der Leuchtstoff eine spektrale Halbwertsbreite auf halber Höhe des Maximums, kurz FWHM oder Full-width at half maximum, von mindestens 70 nm oder 75 nm oder 78 nm auf. Diese spektrale Breite liegt bevorzugt bei höchstens 90 nm oder 87 nm oder 84 nm oder 82 nm.

Gemäß zumindest einer Ausführungsform weist der Leuchtstoff im blauen Spektralbereich ein Absorptionsmaximum, insbesondere ein relatives Absorptionsmaximum, auf. Blauer Spektralbereich bezeichnet insbesondere Wellenlängen von mindestens 400 nm und/oder von höchstens 480 nm. Zum Beispiel liegt das Absorptionsmaximum bei mindestens 410 nm oder 420 nm und/oder bei höchstens 450 nm oder 440 nm.

Die oben genannten Werte zu den spektralen Eigenschaften des Leuchtstoffs gelten insbesondere bei Raumtemperatur, also bei ungefähr 300 K.

Darüber hinaus wird ein Verfahren zur Herstellung eines solchen Leuchtstoffs angegeben. Merkmale des Leuchtstoffs sind daher auch für das Verfahren offenbart und umgekehrt.

In mindestens einer Ausführungsform weist das Verfahren mindestens die folgenden Schritte auf, bevorzugt in der angegebenen Reihenfolge:

A) Bereitstellen von als Festkörper vorliegenden Edukten für Sr, Al, Si und Eu sowie optional für Ca,
B) Mischen der Edukte,
C) Erhitzen der Edukte unter Formiergasatmosphäre auf mindestens 1.500 °C und Formen eines Glühkuchens, und
D) Zerkleinern des Glühkuchens zu dem Leuchtstoff

Gemäß zumindest einer Ausführungsform des Verfahrens erfolgt zumindest der Schritt C) oder auch alle Schritte bei Atmosphärendruck. Insbesondere erfolgt das Verfahren dann nicht unter Hochdruckbedingungen. Bevorzugt liegt der Atmosphärendruck und/oder ein Gesamtdruck zwischen einschließlich 0,9 bar und 1,5 bar oder 0,95 bar und 1,05 bar.

Als Edukt und als Quelle für Strontium, Aluminium und/oder Kalzium können die jeweiligen reinen Metalle oder auch Metalllegierungen mit den entsprechenden Metallen Verwendung finden. Ebenso können als Edukte eingesetzt werden Silicide, Nitride, Oxinitride, Halogenide und/oder Oxide dieser Metalle. Weiterhin können Mischungen dieser Verbindungen verwendet werden.

Als Edukt oder Quelle für Silicium für die Herstellung des Leuchtstoffs kann eine Silizium-Metallverbindung, ein Siliziumnitrid, ein Erdalkalisilicid, Siliziumdiimid oder eine Mischung dieser Verbindungen eingesetzt werden. Bevorzugt werden Siliziumnitride und/oder Siliziummetalle eingesetzt.

Als Edukt oder Quelle für Eu kann metallisches Europium, eine Europiumligierung, ein Europiumoxid, ein Europiumnitrid oder ein Europiumhalogenid dienen. Ebenso können Mischungen dieser Verbindungen eingesetzt werden. Bevorzugt wird Europiumoxid als Edukt für Europium verwendet.

Gemäß zumindest einer Ausführungsform werden ein Schmelzmittel und/oder ein Flussmittel für die Verbesserung der Kristallinität und/oder zur Unterstützung des Kristallwachstums eingesetzt. Hierzu werden bevorzugt Chloride, Fluoride, Halogenide und/oder borhaltige Verbindungen der eingesetzten Erdalkalimetalle herangezogen werden. Auch Kombinationen aus zwei oder mehreren Schmelzmitteln oder Flussmitteln können Verwendung finden. Insbesondere dient als Schmelzmittel und/oder als Flussmittel zumindest einer der folgenden Stoffe: LiF, LiCl, NaF, NaCl, $SrCl_2$, $SrF_2$, $CaCl_2$, $CaF_2$, $BaCl_2$, $BaF_2$, $NH_4Cl$, $NH_4F$, KF, KCl, $MgF_2$, $MgCl_2$, $AlF_3$, $H_3BO_3$, $B_2O_3$, $Li_2B_4O_7$, $NaBO_2$, $Na_2B_4O_7$, $LiBF_4$.

Gemäß zumindest einer Ausführungsform werden die Ausgangssubstanzen, insbesondere für Sr, Ca, Al und/oder Si sowie Eu, gemäß der allgemeinen Summenformel des Leuchtstoffs eingewogen. Es ist möglich, dass die Erdalkalikomponenten auch mit einem Überschuss eingewogen werden, um eventuell auftretende Abdampfungsverluste während der Synthese zu kompensieren.

Gemäß zumindest einer Ausführungsform folgt dem Schritt D) ein Schritt E) nach. In dem Schritt E) erfolgt ein weiteres Glühen des Leuchtstoffs, auch als Tempern bezeichenbar. Das Glühen erfolgt insbesondere bei einer Temperatur von mindestens 1500 °C und bevorzugt unter Stickstoffatmosphäre oder Formiergasatmosphäre. Formiergas bezeichnet eine Mischung aus $N_2$ und $H_2$. Die Temperatur von mindestens 1500 °C in den Schritten C) und/oder E) liegt bevorzugt für mindestens vier Stunden oder sechs Stunden an. Beispielsweise liegt in den Schritten C) und E) jeweils eine Temperatur von 1650 °C $\pm$ 50 °C an.

Gemäß zumindest einer Ausführungsform erfolgt ein Mischen der Edukte in einer Kugelmühle oder in einem Taumelmischer. Beim Mischprozess kann es von Vorteil sein, die Bedingungen so zu wählen, dass viel Energie in das Mischgut eingetragen wird, wodurch es zu einer Vermahlung der Edukte kommt. Die damit erhöhte Homogenität und Reaktivität der Mischung kann einen positiven Einfluss auf die Eigenschaften des resultierenden Leuchtstoffs haben.

Durch gezielte Veränderung der Schüttdichte oder durch Modifikation der Agglomeration der Eduktmischung kann die Entstehung von Nebenphasen reduziert werden. Außerdem können eine Partikelgrößenverteilung, eine Partikelmorphologie und/oder eine Ausbeute des resultierenden Leuchtstoffs beeinflusst werden. Hierfür besonders geeignete Techniken sind Siebungen und Granulieren, auch unter Verwendung geeigneter Zusätze.

Gemäß zumindest einer Ausführungsform erfolgt eine Temperung, insbesondere in einem Tiegel aus Wolfram, Molybdän oder Bornitrid. Die Temperung erfolgt bevorzugt in einem gasdichten Ofen in einer Stickstoff-Atmosphäre oder in einer Stickstoff/Wasserstoff-Atmosphäre. Die Atmosphäre kann fließen oder stationär sein. Es kann zudem Kohlenstoff in feinverteilter Form im Ofenraum anwesend sein. Es sind auch mehrfache Temperungen des Leuchtstoffs möglich, um die Kristallinität oder die Korngrößenverteilung zu verbessern. Weitere Vorteile können eine niedrigere Defektdichte verbunden mit verbesserten optischen Eigenschaften des Leuchtstoffs und/oder eine höhere Stabilität des Leuchtstoffs sein. Zwischen den Temperungen kann der Leuchtstoff auf verschiedenste Weisen behandelt werden oder es können dem Leuchtstoff Substanzen wie Schmelzmittel zugegeben werden.

Für ein Mahlen des Leuchtstoffs können etwa eine Mörsermühle, eine Fließbettmühle oder eine Kugelmühle eingesetzt werden. Es ist beim Mahlen darauf zu achten, den Anteil von erzeugtem Splitterkorn möglichst gering zu halten, da dieser die optischen Eigenschaften des Leuchtstoffs verschlechtern kann.

Der Leuchtstoff kann zusätzlich gewaschen werden. Hierzu kann der Leuchtstoff in Wasser oder in wässrigen Säuren wie Salzsäure, Salpetersäure, Flusssäure, Schwefelsäure, organischen Säuren oder einer Mischung dieser gewaschen werden. Der Leuchtstoff kann alternativ oder zusätzlich in einer Lauge wie Natronlauge, Kalilauge, einer wässrigen Ammoniak-Lösung oder Mischungen hieraus gewaschen werden. Alternativ oder zusätzlich ist eine Waschung in organischen Lösungsmitteln wie Aceton, Propanol und/oder Phenol möglich. Das Waschen erfolgt bevorzugt nach dem Mahlen.

Gemäß zumindest einer Ausführungsform erfolgt etwa durch das Tempern, weitere Glühen, Mahlen, Sieben und/oder Waschen eine Entfernung von Nebenphasen, Glasphasen oder andere Verunreinigung und damit eine Verbesserung der optischen Eigenschaften des Leuchtstoffs. Es ist auch möglich durch diese Behandlung gezielt kleine Leuchtstoffpartikel abzutrennen oder aufzulösen und die Partikelgrößenverteilung für die Anwendung zu optimieren. Außerdem kann durch eine solche Behandlung eine Oberfläche der Leuchtstoffpartikel gezielt verändert werden, wie zum Beispiel das Entfernen bestimmter Bestandteile aus der Partikeloberfläche. Diese Behandlung kann, auch in Verbindung mit einer nachgeschalteten Behandlung, zu einer verbesserten Stabilität des Leuchtstoffs führen.

Darüber hinaus wird die Verwendung eines solchen Leuchtstoffs angegeben. Merkmale zur Verwendung sind daher auch für das Verfahren sowie den Leuchtstoff offenbart und umgekehrt.

In mindestens einer Ausführungsform wird der Leuchtstoff in einer Leuchtdiode verwendet. Die Leuchtdiode umfasst mindestens einen im Betrieb im blauen Spektralbereich emittierenden Halbleiterchip. Der Leuchtstoff ist dem Halbleiterchip entlang eines Strahlweges nachgeordnet.

Das vom Halbleiterchip erzeugte blaue Licht wird teilweise oder vollständig von dem Leuchtstoff absorbiert und in rotes Licht umgewandelt. Es ist möglich, dass weitere Leuchtstoffe, insbesondere zur Erzeugung von grünem und/oder gelbem Licht, vorhanden sind. Weiterhin wird von der Leuchtdiode bevorzugt Mischstrahlung, beinhaltend blaues Licht von dem Halbleiterchip und konvertierte Strahlung von dem Leuchtstoff sowie grünes und/oder gelbes Licht von dem weiteren Leuchtstoff, emittiert.

Nachfolgend wird ein hier beschriebener Leuchtstoff unter Bezugnahme auf die Zeichnung anhand von Ausführungsbeispielen näher erläutert. Gleiche Bezugszeichen geben dabei gleiche Elemente in den einzelnen Figuren an. Es sind jedoch keine maßstäblichen Bezüge dargestellt, vielmehr können einzelne Elemente zum besseren Verständnis übertrieben groß dargestellt sein.

Es zeigen:

| | |
|---|---|
| Figur 74 | Einwaagen zu Ausführungsbeispielen und zu Abwandlungen von hier beschriebenen Leuchtstoffen und deren emittierter Farbort, |
| Figuren 75 bis 87 | schematische Darstellungen von Eigenschaften von hier beschriebenen Leuchtstoffen bei Anregung mit blauem Licht, |
| Figuren 88 bis 90 | Daten aus einer Röntgenstrukturanalyse von hier beschriebenen Leuchtstoffen, |
| Figur 91 | eine schematische Darstellung einer Struktur eines hier beschriebenen Leuchtstoffs, und |
| Figur 92 | eine schematische Darstellung einer Struktur einer Abwandlung eines hier beschriebenen Leuchtstoffs. |

Ein Ausführungsbeispiel eines hier beschriebenen Leuchtstoffs lässt sich wie folgt herstellen:
Als Edukte für die Synthese des Leuchtstoffs der allgemeinen Summenformel $Sr_xCa_{1-x}AlSiN_3$:Eu werden die binären Nitride der konstituierenden Elemente, also $Ca_3N_2$, $Sr_3N_2$, AlN und $Si_3N_4$ eingesetzt. Da es sich dabei um stark oxidationsempfindliche und hydrolyseempfindliche Substanzen handelt, wird in einer sogenannten Glove-Box gearbeitet, unter einer $N_2$-Atmosphäre mit $O_2$ < 1 ppm und $H_2O$ < 1 ppm. Zusätzlich wird zur Dotierung mit $Eu^{2+}$ $Eu_2O_3$ eingesetzt. Eine Einwaage erfolgt so, dass folgendes atomares Verhältnis vorliegt:
Ca : Sr : Al : Si : Eu = (1-x) : x : 1 : 1 : y, wobei y dem Dotierungsgrad entspricht, also dem Anteil der Sr-Gitterplätze, die durch Eu substituiert werden. Zusätzlich werden verschiedene Flussmittel hinzugefügt, siehe die Tabelle in Figur 74. Eine Eduktmischung wird unter Beibehaltung der oben beschriebenen atomaren Verhältnisse auf eine Gesamteinwaage von 50 - 100 g skaliert, siehe ebenfalls die Tabelle in Figur 74.

Die Eduktmischung wird zusammen mit $ZrO_2$-Kugeln in einen PET-Mischbehälter gegeben und für 6 h auf einer Rollenbank in der Glove-Box gemischt. Anschließend werden die Kugeln aus der Mischung entfernt und das Pulver wird in einen geschlossenen Molybdän-Tiegel überführt. Dieser Tiegel wird in einen Wolfram-Übertiegel, ein halbrundes offenes Rohr aus Wolfram, gelegt und in einen Rohrofen überführt. Der Rohrofen wird während der Laufzeit mit 3 l/min Formiergas mit 92,5% $N_2$ und 7,5% $H_2$ durchströmt. In dem Rohrofen wird die Mischung mit einer Rate von 250 K/h auf 1650 °C erhitzt, bei dieser Temperatur für 4 h gehalten und anschließend mit 250 K/h auf 50 °C abgekühlt. Der entstandene Glühkuchen wird nach Erkalten des Ofens herausgenommen, mit einer Mörser-Mühle zerkleinert und über ein Sieb mit einer Maschenweite von 31 $\mu$m gesiebt. Die Siebfraktion < 31 $\mu$m ist der verwendete Leuchtstoff.

Dem Sieben kann optional ein weiteres Glühen, Tempern und/oder Waschen nachfolgen.

Beispielhafte Einwaagen m in g sowie resultierende Farborte CIE x, CIE y, auch als color locus oder chromaticity coordinate bezeichnet, des Emissionsspektrums des jeweiligen Leuchtstoffs in der CIE-Normfarbtafel bei Anregung mit blauem Licht bei 460 nm und bei vollständiger Absorption des blauen Lichts sind auch in der Tabelle in Figur 74 aufgeführt. Für die Ausführungsbeispiele in der Tabelle gilt je $0{,}8 \leq x \leq 1$.

In den Figuren 75 bis 78 sind die Eigenschaften einer von dem Leuchtstoff emittierten Strahlung gezeigt.

In Figur 75 sind Emissionsspektren und in Figur 76 Remissionsspektren von $Sr_xCa_{1-x}AlSiN_3$:Eu-Leuchtstoffen dargestellt. Aufgetragen sind die Wellenlänge $\lambda$ gegenüber der Intensität I und der Reflektivität R. Die Emissionsspektren zeigen eine unerwartet spektral schmale Emission des Leuchtstoffs mit x = 0,9. Gleichzeitig zeichnet sich der Leuchtstoff mit x = 0,9 durch eine starke Absorption aus, siehe Figur 3. Die Absorption ergibt sich dabei näherungsweise als 1 - R.

In Figur 77 ist eine Abhängigkeit einer spektralen Halbwertsbreite FWHM der Emission vom Sr-Gehalt, also dem Parameter x in $Sr_xCa_{1-x}AlSiN_3$:Eu, gezeigt. Bis zu einem Sr-Gehalt von 80%, also x = 0,8, beobachtet man eine sehr geringe Änderung der Halbwertbreite FWHM mit steigendem x. Überraschenderweise beobachtet man ab einem Sr-Gehalt von >80% plötzlich eine sprunghafte Abnahme der Halbwertbreite FWHM.

In Figur 78 ist, analog zu Figur 77, die spektrale Halbwertbreite FWHM in Abhängigkeit des Parameters x gezeigt. Zusätzlich sind eine Dominanzwellenlänge ldom des vom Leuchtstoff emittierten Spektrums sowie der Eu-Gehalt angegeben. Überaschenderweise zeigt ein Leuchtstoff mit 90% Sr bei vergleichbarer Dominanzwellenlänge ldom eine viel kleinere Halbwertbreite FWHM im Vergleich zu herkömmlichen Leuchtstoffen mit nur geringerem Sr-Anteil. Die sprunghafte Abnahme der Halbwertbreite FWHM ist nahezu unabhängig vom eingesetzten Eu-Gehalt der Probe.

Der Leuchtstoff mit $x \geq 0{,}8$ zeichnet sich also durch eine kleine Halbwertsbreite FWHM der Emission und durch einen sehr hohen visuellen Nutzeffekt LER bei gleichzeitig hoher interner Quanteneffizienz QI und externer Quanteneffizienz QE aus, siehe die Tabelle in Figur 79. Ferner ist eine relative Helligkeit B angegeben. Zur Berechnung der externen Quanteneffizienz QE wurde der Mittelwert der Remission im Bereich von 450 nm bis 470 nm herangezogen, die Messung erfolgte in gepressten Pulvertabletten bei einer Anregungswellenlänge von 460 nm.

In Figur 80 ist ein Vergleich von Konversionseffizienzen verschiedener warmweißes Licht emittierender Leuchtdioden, kurz LEDs, gezeigt. Es wurde jeweils eine Mischung aus zwei Leuchtstoffen eingesetzt, wobei der grünes Licht emittierende Leuchtstoff G gleich bleibt und der rot emittierende Leuchtstoff R variiert wurde. An der Abszissenachse ist der Typ des Rot emittierenden Leuchtstoffs R angegeben. Die Ordinatenachse gibt die relative Effizienz E an. Die Anregung der Leuchtstoffe erfolgte mit einem blau emittierenden Halbleiterchip mit einer Dominanzwellenlänge von 446 nm.

Alle Leuchtstoffmischungen wurden so eingestellt, dass in der CIE-Normfarbtafel ein Farbort nahe Planck mit einer korrelierten Farbtemperatur CCT von etwa 2700 K erreicht wird. Der Farbwiedergabeindex CRI aller gemessenen LEDs liegt bei 80 $\pm$ 1. Alle eingesetzten Rotleuchtstoffe R zeigen eine vergleichbare Dominanzwellenlänge von etwa 600,5 nm $\pm$ 1 nm.

Weitere Angaben zu den Leuchtstoffmischungen, wie in Figur 80 gezeigt, sind auch der Tabelle in Figur 81 zu entnehmen. Zusätzlich angegeben sind die relative Effizienz E, eine Leuchtstoffkonzentration c sowie eine Mengenverhältnis V des grünen Leuchtstoffs G und des roten Leuchtstoffs R.

In Figur 82 ist ein Vergleich von Konversionseffizienz und Farbwiedergabeindex verschiedener warmweißes Licht erzeugender LEDs gezeigt. Es wurde jeweils eine Mischung aus zwei Leuchtstoffen eingesetzt, wobei der Grün-Leuchtstoff G konstant gehalten und der Rot-Leuchtstoff R variiert wurde, analog zur Tabelle in Figur 81. Alle Leuchtstoffmischungen wurden so eingestellt, dass ein Farbort nahe Planck mit einer korrelierten Farbtemperatur CCT von etwa 2700 K erreicht wird. Die Effizienz E, illustriert durch die Balken, einer warmweißes Licht erzeugenden LED mit dem neuartigen Leuchtstoff mit 90% Sr zeigt eine deutlich höhere Effizienz und gleichzeitig eine verbesserte Farbwiedergabe CRI, symbolisiert als Rauten, als LEDs mit einem Rot-Leuchtstoff mit nur 80% Sr.

Weitere Daten zu den LED-Messungen aus Figur 82 sind der Tabelle in Figur 83 zu entnehmen, analog zur Tabelle in Figur 81. Die Effizienz E einer warmweißes Licht erzeugenden LED bei korrelierten Farbtemperatur CCT von etwa 2700 K mit einem neuartigen roten Leuchtstoff mit 90% Sr ist auch hier deutlich höher und außerdem ist ein erhöhter Farbwiedergabeindex CRI erzielbar.

Rotleuchtstoffe aus dem Materialsystem $Sr_xCa_{1-x}AlSiN_3$:Eu wurden einem Hydrolysetest unterzogen, um eine Alterungsstabilität des Leuchtstoffs gegenüber Luftfeuchtigkeit zu bewerten, siehe Figur 84. Dazu wurden die entsprechenden Leuchtstoffpulver für 40 h bei 130 °C und 100% relativer Luftfeuchtigkeit gelagert. Die Absorption A der Leuchtstoffe im blauen Spektralbereich zwischen 450 nm und 470 nm wurde sowohl vor als auch nach dieser Behandlung gemessen. Als Maß für die Stabilität eines Leuchtstoffs gegenüber Hydrolyse, also der Zersetzung des Leuchtstoffs in Anwesenheit von Wasser, gilt die Abnahme des Absorptionsvermögens im blauen Spektralbereich. Mit zunehmendem Sr-Gehalt beobachtet man zunächst eine starke Zunahme der Hydrolyseempfindlichkeit. Überraschenderweise ist jedoch der neue Leuchtstoff mit 90% Sr hydrolysestabiler als ein Leuchtstoff mit nur 80% Sr-Anteil.

In Figur 85 ist ein Temperaturlöschverhalten, englisch thermal Quenching, von zwei Rot-Leuchtstoffen im Vergleich zueinander dargestellt. Beide Leuchtstoffe haben eine vergleichbare Emissionsfarbe mit einer Dominanzwellenlänge von zirka 600 nm. Überraschenderweise zeigt der neue Leuchtstoff mit hohem Sr-Gehalt trotz eines höheren Eu-Gehalts ein geringere Abnahme der Emissionsintensität I mit steigender Temperatur im Vergleich zum Referenzleuchtstoff.

In Figur 86 ist die relative Emissionsintensität I in Abhängigkeit des Gehalts an Eu als Aktivator illustriert. Der Eu-Gehalt ist dabei in Prozent angegeben.

Über Leuchtstoffe aus dem System $CaAlSiN_3$:Eu wird in der Literatur berichtet, dass mit einem steigendem Aktivatorgehalt, insbesondere > 0.8 % Eu, eine Konversionseffizienz stagniert, siehe Tabelle 1 in EP 2 135 920 A1.

Überraschenderweise zeigt der neue Leuchtstoff mit hohem Sr-Gehalt ein davon abweichendes Verhalten. Mit steigendem Eu-Gehalt nimmt die Emissionsintensität I auch bei einem Eu-Gehalt > 1% weiter annähernd linear zu. Diese Eigenschaft bietet für die Anwendung diverse technische Vorteile, insbesondere niedrigerer Leuchtstoffbedarf und die Möglichkeit, Farborte mit größerem CIE x zu erreichen.

In Figur 87 ist eine Abhängigkeit der Dominanzwellenlänge Idom der Emission vom Aktivatorgehalt y für den neuen Leuchtstoff $Sr_xCa_{1-x}AlSiN_3$:Eu mit X = 0,9 gezeigt. Mit steigendem Aktivatorgehalt verschiebt sich das Lumineszenzsignal annähernd linear hin zu höheren Wellenlängen. Dadurch lässt sich beispielsweise der Farbwiedergabeindex CRI einer warmweißes Licht emittierenden LED erhöhen, siehe auch die LED-Ausführungsbeispiele gemäß der Figuren 80 bis 82.

In Figur 88 ist ein Röntgenpulverdiffraktogramm des Leuchtstoffs $Sr_{0,8}Ca_{0,2}AlSiN_3$:Eu, der mittels der hier beschriebenen Synthese hergestellt wurde, gezeigt. Überraschenderweise ist der Leuchtstoff, hergestellt aus Sr-Nitrid, Ca-Nitrid, AlN, $Si_3N_4$ und $Eu_20_3$ unter Atmosphärendruck, röntgenographisch phasenrein. Reflexe von Nebenphasen wie AlN oder $(Sr,Ca)_2Si_5N_8$ werden nicht beobachtet.

In Figur 89 sind Röntgenpulverdiffraktogramme von Leuchtstoffen $Ca_{1-x}Sr_xAlSiN_3$:Eu mit verschiedenen Werten für x gezeigt, welche mittels der hier beschriebnen Synthese hergestellt wurden. Ab einem Substitutionsgrad von x > 0,8 beobachtet man das Auftreten eines zusätzlichen Reflexes R bei 2θ von 36,7° bis 37,0°. Dieser Reflex lässt sich mit dem Strukturmodell von bekanntem $(Sr,Ca)AlSiN_3$ nicht erklären. Der Reflex R konnte auch keinen Verbindungen aus Datenbanken zugeordnet werden.

In orthorhombischer Beschreibung stammt dieser Reflex R von der Gitterebene **$1\bar{2}1$**. Die genaue Lage dieses Reflexes hängt vom Substitutionsgrad x ab. Würde es sich um einen Reflex R einer eventuellen nicht identifizierten Fremdphase handeln, so würde man diese Verschiebung nicht erwarten.

Um die Struktur des hier beschriebenen, neuen Leuchtstoffs zu beschreiben, wurden der Reihe nach die im Folgenden beschriebenen Schritte durchgeführt. Eine Zusammenfassung der Ergebnisse, wichtige R-Werte und die grundlegenden verfeinerten Parameter, finden sich in der Tabelle in Figur 90.

1) Es wurde eine Rietveld-Verfeinerung durchgeführt mit den bekannten Phasen $Sr_{0,99}Eu_{0,01}AlSiN_3$ aus ICSD 98-041-9410, AlN aus ICSD 98-060-8626 und $SrF_2$ aus ICSD 98-004-1402. Die Kristallstrukturdaten von $Sr_{0,99}Eu_{0,01}AlSiN_3$ wurden als $Ca_{0,1}Sr_{0,89}Eu_{0,01}AlSiN_3$ angepasst.

2) Es wurden sämtliche Reflexe mittels eines Profilparameterfits angepasst, mit FWHM aller Reflexe gleich. Gegebenenfalls wurden Reflexe, die Fremdphasen wie etwa $SrF_2$ und AlN zuzuordnen waren, aus der Suche eliminiert. Die übrigen Reflexe wurden für eine Gitterparametersuche verwendet. Diese Gitterparametersuche ergibt, dass sich fast alle Reflexe mit der ursprünglichen Zelle, aber ohne Auslöschbedingungen, beschreiben lassen. Aus diesem Grund wurde im nächsten Schritt eine Rietveld-Verfeinerung durchgeführt mit der ursprünglichen Struktur, aber transferiert in die Raumgruppe P1.

3) Es wurde eine testweise Verfeinerung der experimentellen Daten basierend auf dem literaturbekannten Strukturmodell für $Sr_xCa_{1-x}AlSiN_3$ durchgeführt, welches jedoch in die niedrigersymmetrische Raumgruppe P1 transferiert worden war, siehe auch den vorherigen Schritt 2. Diese Verfeinerung konvergierte ebenfalls, erklärt aber nicht den beobachteten Reflex R.

4) Um die zusätzlichen beobachteten Reflexe zu erklären, wurde ein neues, von der bekannten $CaAlSiN_3$-Struktur verschiedenes Strukturmodell aufgestellt. Das neue Strukturmodell des hier beschriebenen Leuchtstoffs unterscheidet sich eindeutig von der bereits zuvor bekannten $CaAlSiN_3$-Struktur. Im kristallographischen Sinne handelt es sich um eine Überstrukturvariante. Diese Struktur lässt sich aus der des $CaAlSiN_3$ formal durch eine Reduktion der Symmetrie ableiten. Im so abgeleiteten Strukturmodell für den neuen Leuchtstoff lässt sich der mindestens eine zusätzlich beobachtete Reflex R gut erklären und beschreiben.

Dieses Strukturmodell des neuen Leuchtstoffs unterscheidet sich von dem Strukturmodell aus dem oben erläuterten Schritt 3). In Schritt 3) wurde lediglich das bekannte Strukturmodell von $CaAlSiN_3$ in einer alternativen, niedersymmetrischeren Raumgruppe beschrieben. Erst durch die tatsächliche Einführung eines neuen, von $CaAlSiN_3$ verschiedenen Strukturmodells gelingt eine gute Beschreibung der experimentell beobachteten Reflexe, insbesondere des neuen Reflexes R.

Dazu ist es vor allem nötig, die Sr/Ca-mischbesetzte Lage, die in der ursprünglichen Raumgruppe $Cmc2_1$ mischbesetzt ist und aus Symmetriegründen vier Erdalkaliatome gleichzeitig beschreibt, in vier einzelne Lagen aufzuspalten. Im Modell des herkömmlichen Leuchtstoffs sind alle vier Lagen mischbesetzt mit Sr und Ca. In dem Modell des neuen Leuchtstoffs sind drei der Lagen nur mit Sr besetzt, und nur eine der Lagen sowohl mit Sr als auch mit Ca mischbesetzt.

Der gezeigte, neue Reflex R ist somit ein Überstrukturreflex, der in P1 beschrieben werden kann, aber nicht in $Cmc2_1$, da er die Auslöschbedingungen für diese Raumgruppe verletzt.

Die Verfeinerung der beobachteten Pulverröntgendaten basierend auf dem bekannten Strukturmodell in Raumgruppe $Cmc2_1$ führt zu den Gütefaktoren in der ersten Spalte in Figur 17, entsprechend dem obigen Schritt 1. Eine alternative Beschreibung des gleichen, bekannten Strukturmodells in der niedersymmetrischeren Raumgruppe P1 führt zu vergleichbaren Gütefaktoren, angegeben in der dritten Spalte in Figur 90, entsprechend dem obigen Schritt 3. Erst mit Hilfe der Beschreibung mit dem neuen, von $CaAlSiN_3$ verschiedenen Strukturmodell erreicht man eine vollständige Beschreibung aller beobachteten Reflexe und damit signifikant verbesserte Gütefaktoren, entsprechend dem obigen Schritt 4.

In Figur 91 ist schematisch perspektivisch das Strukturmodell des neuen Leuchtstoffs mit $x \geq 0{,}8$ gezeigt. Die dunkel gezeichneten Lagen sind nur mit Sr besetzt. Die weiß gezeichnete Lage ist Ca/Sr-mischbesetzt.

Im Vergleich hierzu ist in der perspektivischen Darstellung gemäß Figur 92 die Struktur des $CaAlSiN_3$-Leuchtstoffs mit kleinem x in der Raumgruppe $Cmc2_1$ illustriert. Dunkel dargestellt sind die vier Ca/Sr-mischbesetzten Lagen.

Der hier beschriebene, neuartige Leuchtstoff bietet insbesondere die folgenden Vorteile:

- niedrigere Halbwertbreite der Emission und damit verbunden höherer visueller Nutzeffekt bei gleicher Dominanzwellenlänge,
- die Möglichkeit, höhere Aktivatorkonzentrationen von Eu mit > 0.8% zu realisieren bei gleichzeitig hoher Quanteneffizienz und Konversionseffizienz, damit einhergehend geringerer Leuchtstoffbedarf in LED-Anwendungen und vereinfachte Prozessierbarkeit,
- verbesserte Alterungsstabilität gegenüber Feuchtigkeit im Vergleich zu herkömmlichem $(Sr,Ca)AlSiN_3$:Eu mit niedrigem Sr-Gehalt, und
- Verbesserung der Temperaturstabilität.

## Patentansprüche

1. Leuchtstoff zur Emission von rotem Licht, mit der allgemeinen Summenformel $Sr_xCa_{1-x}AlSiN_3$:Eu, wobei $0{,}8 < x \leq 1$, wobei zwischen einschließlich 0,1 % und 5 % der Sr-, Ca- und/oder Sr/Ca-Gitterplätze durch Eu ersetzt sind, und wobei in der Röntgenstrukturanalyse der Leuchtstoff in orthorhombischer Beschreibung einen Reflex (R) mit den Miller'schen Indizes $1\bar{2}1$ aufzeigt.

2. Leuchtstoff nach dem vorhergehenden Anspruch, wobei $0{,}85 \leq x \leq 0{,}95$, und wobei zwischen einschließlich 0,35 % und 2,2 % der Sr-Gitterplätze durch Eu ersetzt sind.

3. Leuchtstoff nach einem der vorhergehenden Ansprüche, der in einem Pulverdiffraktogramm bei monochromatischer Bestrahlung mit Cu-$K_{\alpha 1}$-Strahlung den Reflex (R) mit den Miller'schen Indizes $1\bar{2}1$ bei $2\theta$ zwischen 36,7° und 37,0° aufzeigt.

4. Leuchtstoff nach dem vorhergehenden Anspruch, bei dem der Reflex (R), bezogen auf einen Hauptreflex, eine Intensität zwischen einschließlich 0,3 % und 8 % aufzeigt.

5. Leuchtstoff nach einem der vorhergehenden Ansprüche 1 bis 4, der eine Dominanzwellenlänge zwischen einschließlich 596 nm und 606 nm aufweist, wobei eine Breite eines von dem Leuchtstoff emittierten Strahlungsspektrums auf halber Höhe des Maximums zwischen einschließlich 75 nm und 87 nm liegt, und wobei der Leuchtstoff im Wellenlängenbereich zwischen einschließlich 410 nm und 450 nm ein relatives Absorptionsmaximum aufweist und mit blauem Licht zur Strahlungsemission anregbar ist.

**6.** Verfahren zur Herstellung eines Leuchtstoffs nach einem der vorherigen Ansprüche 1 bis 5,
mit den Schritten:

A) Bereitstellen von als Festkörper vorliegenden Edukten für Sr, Al, Si und Eu sowie optional für Ca,
B) Mischen der Edukte,
C) Erhitzen der Edukte unter Stickstoffatmosphäre oder unter Formiergasatmosphäre auf mindestens 1500 °C und Formen eines Glühkuchens, und
D) Zerkleinern des Glühkuchens zu dem Leuchtstoff.

## Claims

**1.** A phosphor for emission of red light, having the general empirical formula $Sr_xCa_{1-x}AlSiN_3$:Eu
wherein $0.8 < x \leq 1$,
wherein between 0.1% and 5% inclusive of the Sr, Ca and/or Sr/Ca lattice sites have been replaced by Eu, and
wherein, in the x-ray structure analysis, the phosphor in orthorhombic description exhibits a reflection (R) having the Miller indices $1\bar{2}1$ .

**2.** The phosphor according to the preceding claim,
wherein $0.85 \leq x \leq 0.95$, and
wherein between 0.35% and 2.2% inclusive of the Sr lattice sites have been replaced by Eu.

**3.** The phosphor according to either of the preceding claims,
which exhibits, in a powder diffractogram on monochromatic irradiation with Cu-$K_{\alpha 1}$ radiation, the reflection (R) having the Miller indices $1\bar{2}1$ at $2\theta$ between 36.7° and 37.0°.

**4.** The phosphor according to the preceding claim,
in which the reflection (R), based on a main reflection, exhibits an intensity between 0.3% and 8% inclusive.

**5.** The phosphor according to any of the preceding claims 1 to 4,
which has a dominant wavelength between 596 nm and 606 nm inclusive,
wherein a breadth of a radiation spectrum emitted by the phosphor at half the maximum height is between 75 nm and 87 nm inclusive, and
wherein the phosphor has a relative absorption maximum in the wavelength range between 410 nm and 450 nm inclusive and can be induced to emit radiation with blue light.

**6.** A process for producing a phosphor according to any of the preceding claims 1 to 5,
having the steps of:

A) providing reactants in the solid state for Sr, Al, Si and Eu and optionally for Ca,
B) mixing the reactants,
C) heating the reactants under a nitrogen atmosphere or under a forming gas atmosphere to at least 1500°C and forming a calcined cake, and
D) comminuting the calcined cake to give the phosphor.

## Revendications

**1.** Phosphore pour l'émission de lumière rouge,
avec la formule empirique générale $Sr_xCa_{1-x}AlSiN_3$:Eu,
où $0{,}8 < x \leq 1$,
où entre 0,1% et 5% inclus des sites du réseau Sr, Ca et/ou Sr/Ca sont remplacés par Eu, et
où dans l'analyse de la structure des rayons X, le phosphore en description orthorhombique montre un réflexe (R) avec les indices de Miller $1\bar{2}1$ .

**2.** Phosphore selon la revendication précédente, où $0,85 \leq x \leq 0,95$, et où entre 0,35 % et 2,2 % inclus des sites du réseau Sr sont remplacées par Eu.

**3.** Phosphore selon l'une des revendications précédentes, qui, dans un diffractogramme sur poudre sous irradiation monochromatique avec du rayonnement Cu-$K_{\alpha 1}$, montre le réflexe (R) avec les indices de Miller $\mathbf{1\bar{2}1}$ à $2\theta$ entre 36,7° et 37,0°.

**4.** Phosphore selon la revendication précédente, dans laquelle le réflexe (R), par rapport à un réflexe principal, montre une intensité comprise entre 0,3 % et 8 % inclus.

**5.** Phosphore selon l'une des revendications 1 à 4 précédentes,

ayant une longueur d'onde dominante comprise entre 596 nm et 606 nm inclus,
dans laquelle une largeur d'un spectre de rayonnement émis par le phosphore à la demi-hauteur du maximum est comprise entre 75 nm et 87 nm inclus, et
dans laquelle le phosphore a un maximum d'absorption relative dans la gamme de longueurs d'onde comprise entre 410 nm et 450 nm inclus et est excitable pour émettre un rayonnement avec une lumière bleue.

**6.** Procédé de production d'un phosphore selon l'une des revendications 1 à 5 précédentes, avec les étapes:

A) fourniture de matières premières présentes sous forme de solides pour Sr, Al, Si et Eu et éventuellement pour Ca,
B) mélanger les matières premières,
C) chauffer les matières premières sous atmosphère d'azote ou sous atmosphère de gaz de formation à au moins 1500 °C et former un gâteau calciné, et
D) broyer le gâteau calciné pour obtenir le phosphore.

Fig. 1

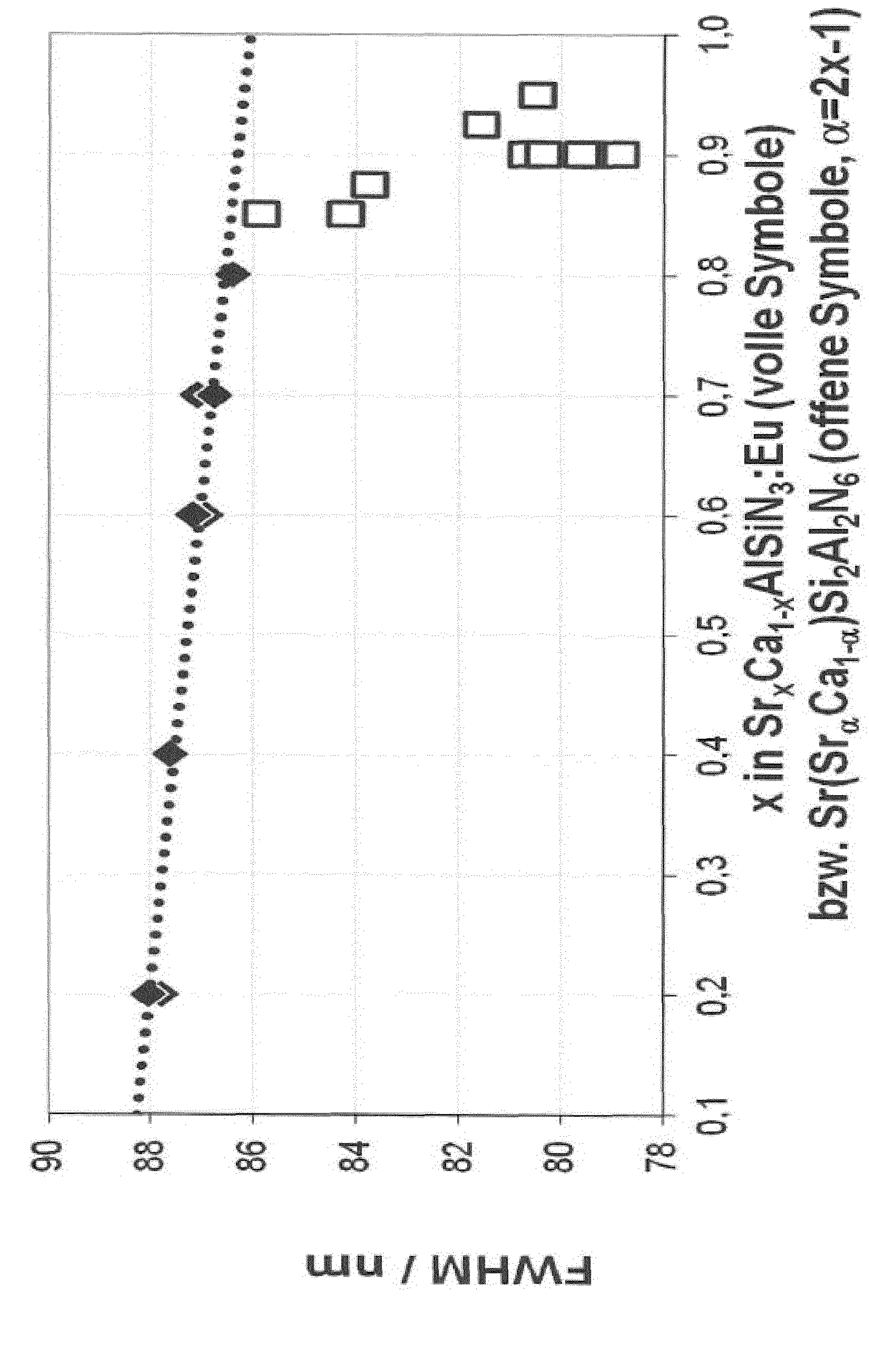
FWHM / nm
90
88
86
84
82
80
78
0,1
0,2
0,3
0,4
0,5
0,6
0,7
0,8
0,9
1,0
x in $Sr_xCa_{1-x}AlSiN_3$:Eu (volle Symbole)
bzw. $Sr(Sr_\alpha Ca_{1-\alpha})Si_2Al_2N_6$ (offene Symbole, $\alpha$=2x-1)

Fig. 2

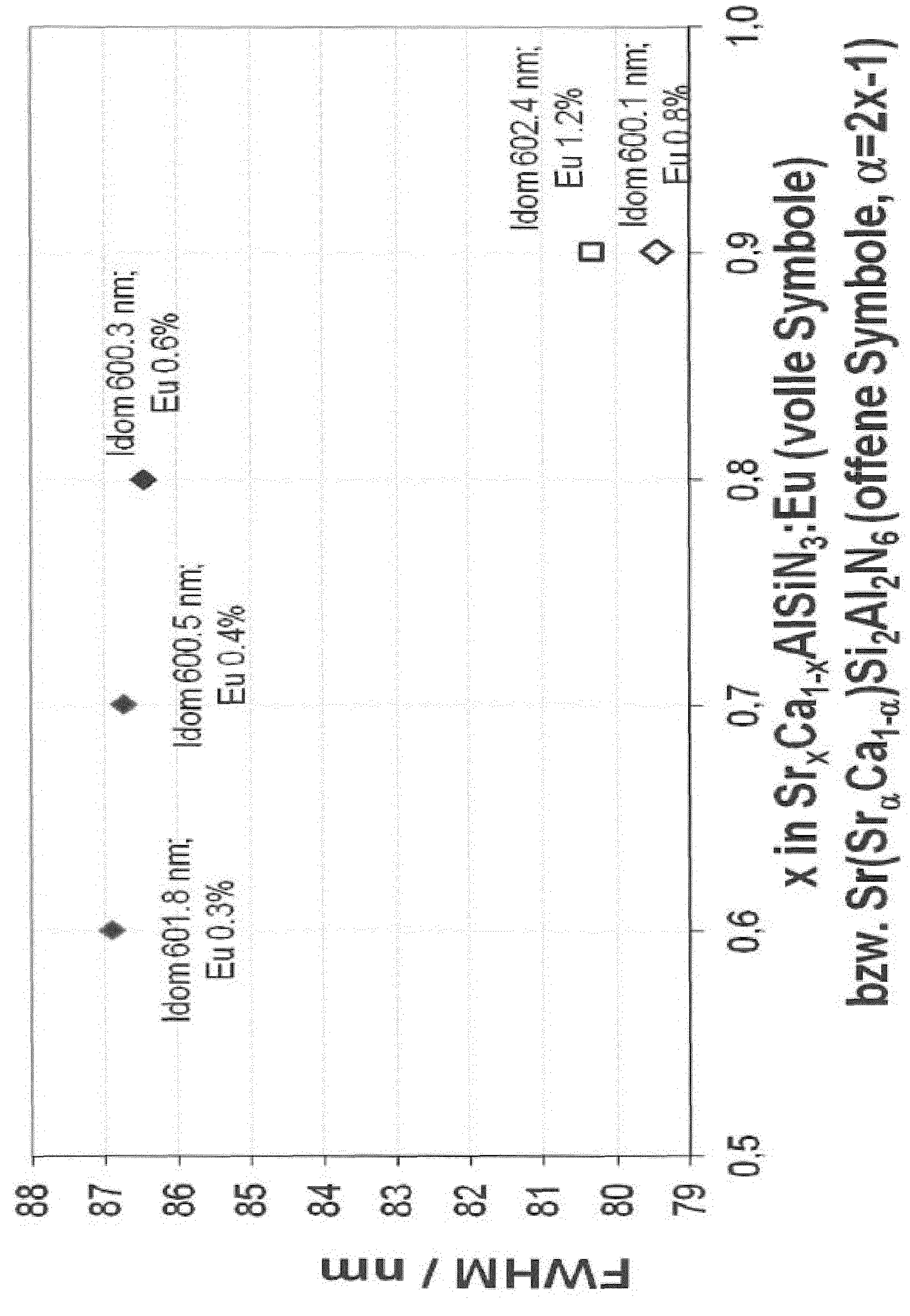
FWHM / nm
88
87
86
85
84
83
82
81
80
79
0,5
0,6
0,7
0,8
0,9
1,0
Idom 601.8 nm; Eu 0.3%
Idom 600.5 nm; Eu 0.4%
Idom 600.3 nm; Eu 0.6%
Idom 602.4 nm; Eu 1.2%
Idom 600.1 nm; Eu 0.8%
x in $Sr_xCa_{1-x}AlSiN_3$:Eu (volle Symbole)
bzw. $Sr(Sr_\alpha Ca_{1-\alpha})Si_2Al_2N_6$ (offene Symbole, $\alpha$=2x-1)

Fig. 3

| | x | y | Idom/nm | FWHM/nm | QI | QE | LER | B |
|---|---|---|---|---|---|---|---|---|
| $(Sr_{0.7}Ca_{0.3})AlSiN_3$:Eu (0.4%) | 0,628 | 0,370 | 600,5 | 86,7 | 100% | 100% | 100% | 100% |
| $(Sr_{0.8}Ca_{0.2})AlSiN_3$:Eu (0.6%) | 0,628 | 0,371 | 600,3 | 86,5 | 99% | 110% | 101% | 111% |
| $Sr(Sr_{0.8}Ca_{0.2})Si_2Al_2N_6$:Eu (0.8%) | 0,626 | 0,372 | 600,1 | 79,5 | 99% | 113% | 110% | 125% |
| $(Sr_{0.6}Ca_{0.4})AlSiN_3$:Eu (0.4%) | 0,639 | 0,359 | 603,1 | 87,2 | 100% | 100% | 100% | 100% |
| $Sr(Sr_{0.8}Ca_{0.2})Si_2Al_2N_6$:Eu (1.2%) | 0,637 | 0,362 | 602,4 | 80,4 | 99% | 113% | 111% | 126% |

Fig. 4

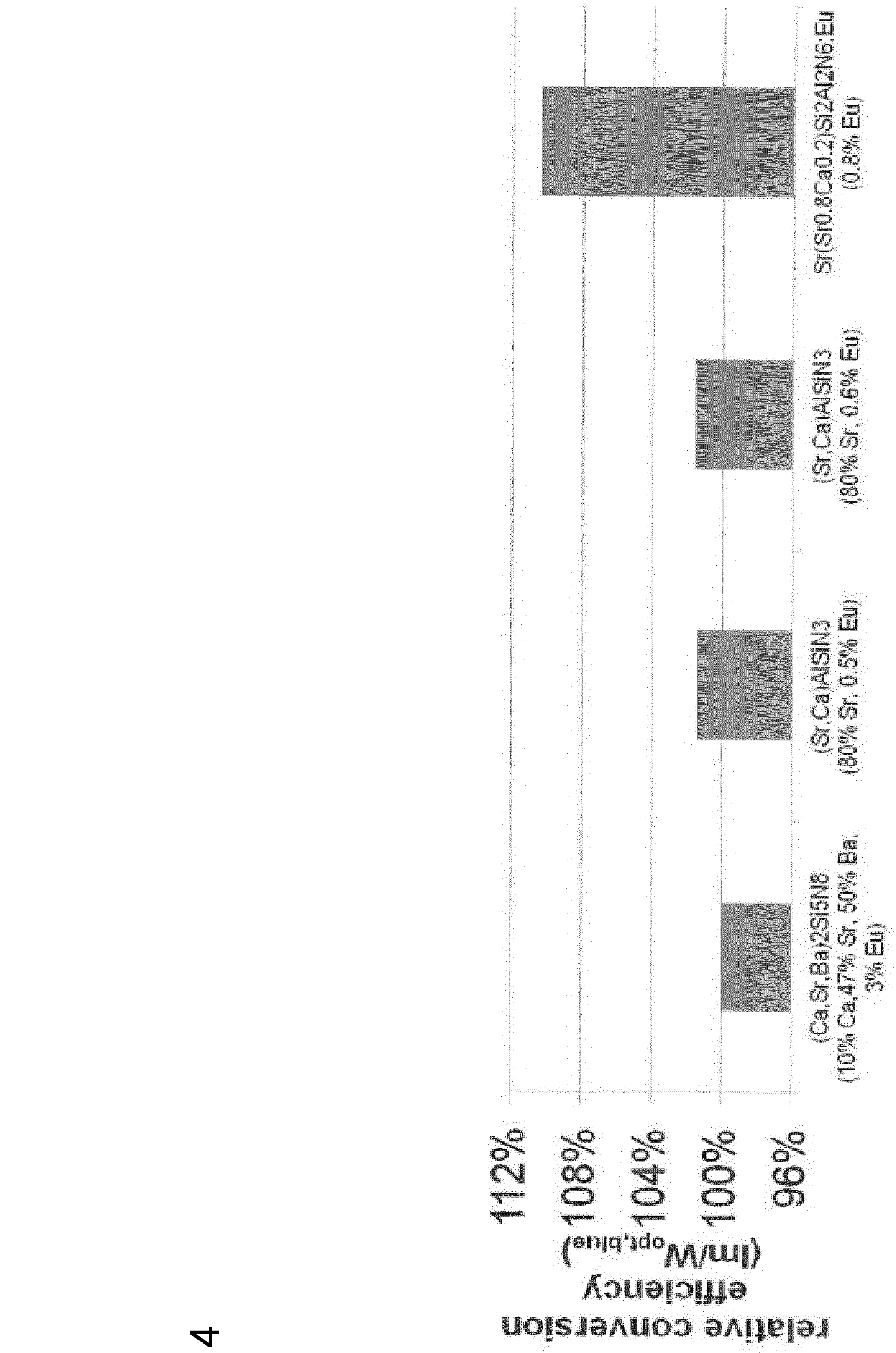
relative conversion efficiency (lm/W$_{opt,blue}$)
112%
108%
104%
100%
96%
(Ca,Sr,Ba)2Si5N8 (10% Ca,47% Sr, 50% Ba, 3% Eu)
(Sr,Ca)AlSiN3 (80% Sr, 0.5% Eu)
(Sr,Ca)AlSiN3 (80% Sr, 0.6% Eu)
Sr(Sr0.8Ca0.2)Si2Al2N6:Eu (0.8% Eu)

Fig. 5

| comment | Blue LED $\lambda_{dom}$ / nm | Green Phosphor | Red Phosphor | $\lambda_{dom}$ / nm (red phosphor) | phosphor concentration | ratio green / red | CIE x | CIE y | CCT / K | CRI | rel. eff. |
|---|---|---|---|---|---|---|---|---|---|---|---|
| Vergleichsbeispiel 1 | 446 | $(Lu,Ce)_3(Al,Ga)_5O_{12}$ (25% Ga, 2.5% Ce) | $(Ca,Sr,Ba)_2Si_5N_8$ (10% Ca,47% Sr, 50% Ba, 3% Eu) | 601,5 | 15,5% | 4,45:1 | 0,461 | 0,408 | 2669 | 79 | 100,0% |
| Vergleichsbeispiel 3 | 446 | $(Lu,Ce)_3(Al,Ga)_5O_{12}$ (25% Ga, 2.5% Ce) | $(Sr,Ca)AlSiN_3$ (80% Sr, 0.5% Eu) | 599,4 | 18,0% | 2,5:1 | 0,459 | 0,416 | 2754 | 80 | 101,4% |
| Vergleichsbeispiel 4 | 446 | $(Lu,Ce)_3(Al,Ga)_5O_{12}$ (25% Ga, 2.5% Ce) | $(Sr,Ca)AlSiN_3$ (80% Sr, 0.6% Eu) | 600,3 | 16,8% | 2,6:1 | 0,461 | 0,408 | 2655 | 81 | 101,5% |
| Ausführungsbeispiel 1 | 446 | $(Lu,Ce)_3(Al,Ga)_5O_{12}$ (25% Ga, 2.5% Ce) | $Sr(Sr_{0.8}Ca_{0.2})Si_2Al_2N_6$:Eu (0.8% Eu) | 600,1 | 16,7% | 3,7:1 | 0,462 | 0,411 | 2681 | 79 | 110,4% |

Fig. 6

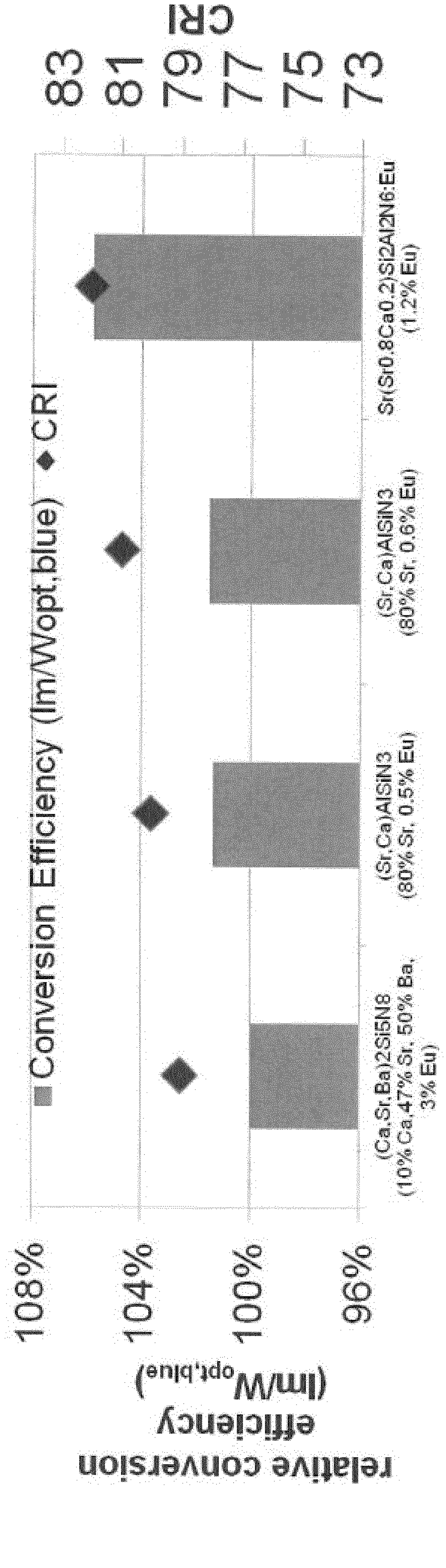
Conversion Efficiency (lm/Wopt,blue)
CRI
relative conversion efficiency ($lm/W_{opt,blue}$)
108%
104%
100%
96%
83
81
79
77
75
73
CRI
(Ca,Sr,Ba)2Si5N8 (10% Ca,47% Sr, 50% Ba, 3% Eu)
(Sr,Ca)AlSiN3 (80% Sr, 0.5% Eu)
(Sr,Ca)AlSiN3 (80% Sr, 0.6% Eu)
Sr(Sr0.8Ca0.2)Si2Al2N6:Eu (1.2% Eu)

Fig. 7

| comment | Blue LED $\lambda_{dom}$ / nm | Green Phosphor | Red Phosphor | $\lambda_{dom}$ / nm (red phosphor) | phosphor concentration | ratio green / red | CIE x | CIE y | CCT / K | CRI | rel. eff. |
|---|---|---|---|---|---|---|---|---|---|---|---|
| Vergleichsbeispiel 1 | 446 | $(Lu,Ce)_3(Al,Ga)_5O_{12}$ (25% Ga, 2.5% Ce) | $(Ca,Sr,Ba)_2Si_5N_8$ (10% Ca,47% Sr, 50% Ba, 3% Eu) | 601,5 | 15,5% | 4,45:1 | 0,461 | 0,408 | 2669 | 79 | 100,0% |
| Vergleichsbeispiel 3 | 446 | $(Lu,Ce)_3(Al,Ga)_5O_{12}$ (25% Ga, 2.5% Ce) | $(Sr,Ca)AlSiN_3$ (80% Sr, 0.5% Eu) | 599,4 | 18,0% | 2,5:1 | 0,459 | 0,416 | 2754 | 80 | 101,4% |
| Vergleichsbeispiel 4 | 446 | $(Lu,Ce)_3(Al,Ga)_5O_{12}$ (25% Ga, 2.5% Ce) | $(Sr,Ca)AlSiN_3$ (80% Sr, 0.6% Eu) | 600,3 | 16,8% | 2,6:1 | 0,461 | 0,408 | 2655 | 81 | 101,5% |
| Ausführungsbeispiel 2 | 446 | $(Lu,Ce)_3(Al,Ga)_5O_{12}$ (25% Ga, 2.5% Ce) | $Sr(Sr_{0.8}Ca_{0.2})Si_2Al_2N_6$:Eu (1.2% Eu) | 602,4 | 16,5% | 5,5:1 | 0,462 | 0,408 | 2649 | 82 | 105,8% |

Fig. 8

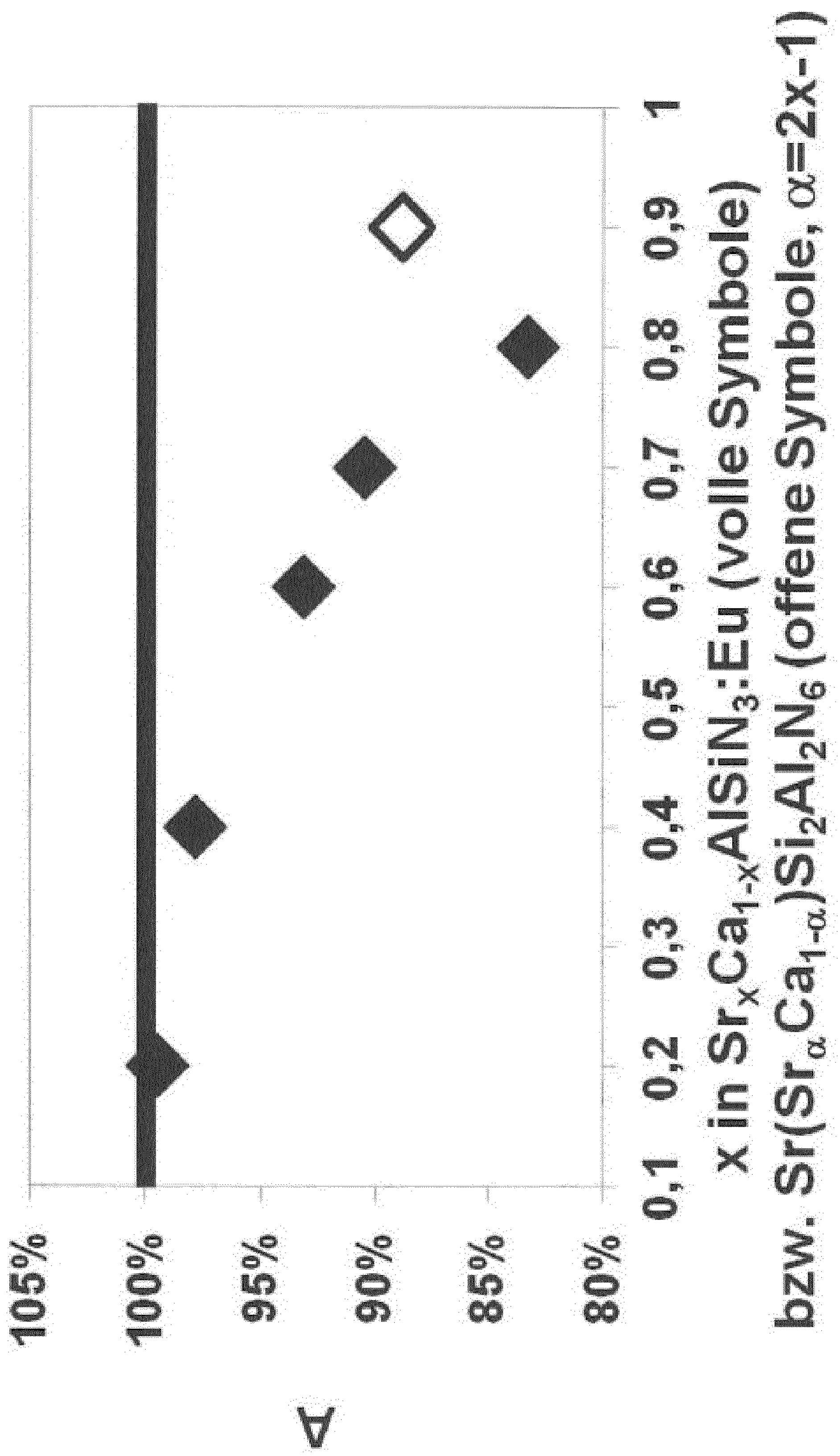
A
105%
100%
95%
90%
85%
80%
0,1
0,2
0,3
0,4
0,5
0,6
0,7
0,8
0,9
1
x in $Sr_xCa_{1-x}AlSiN_3$:Eu (volle Symbole)
bzw. $Sr(Sr_\alpha Ca_{1-\alpha})Si_2Al_2N_6$ (offene Symbole, $\alpha$=2x-1)

Fig. 9

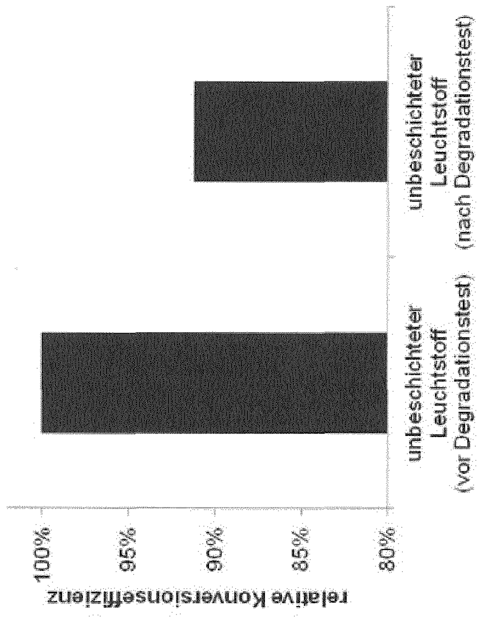


FIG 9a

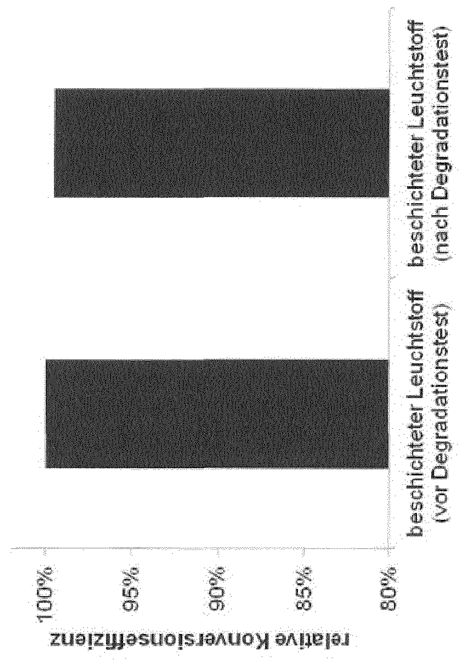


FIG 9b

Fig. 10a

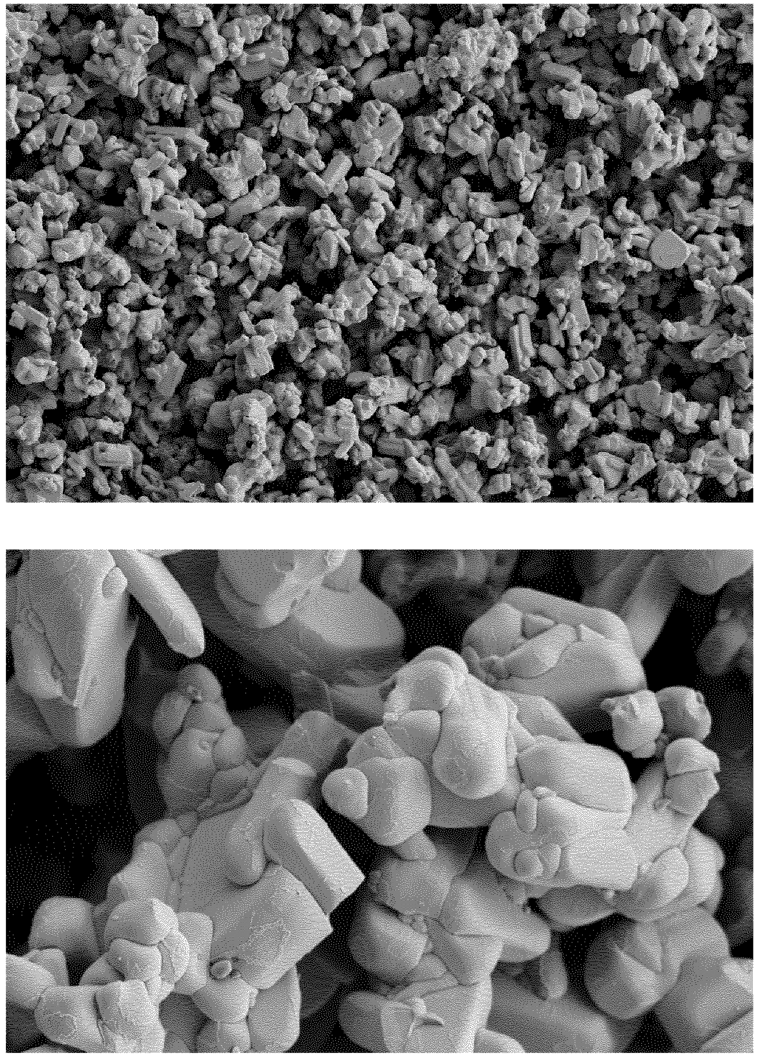

Unbeschichtet
Vor Degradationstest

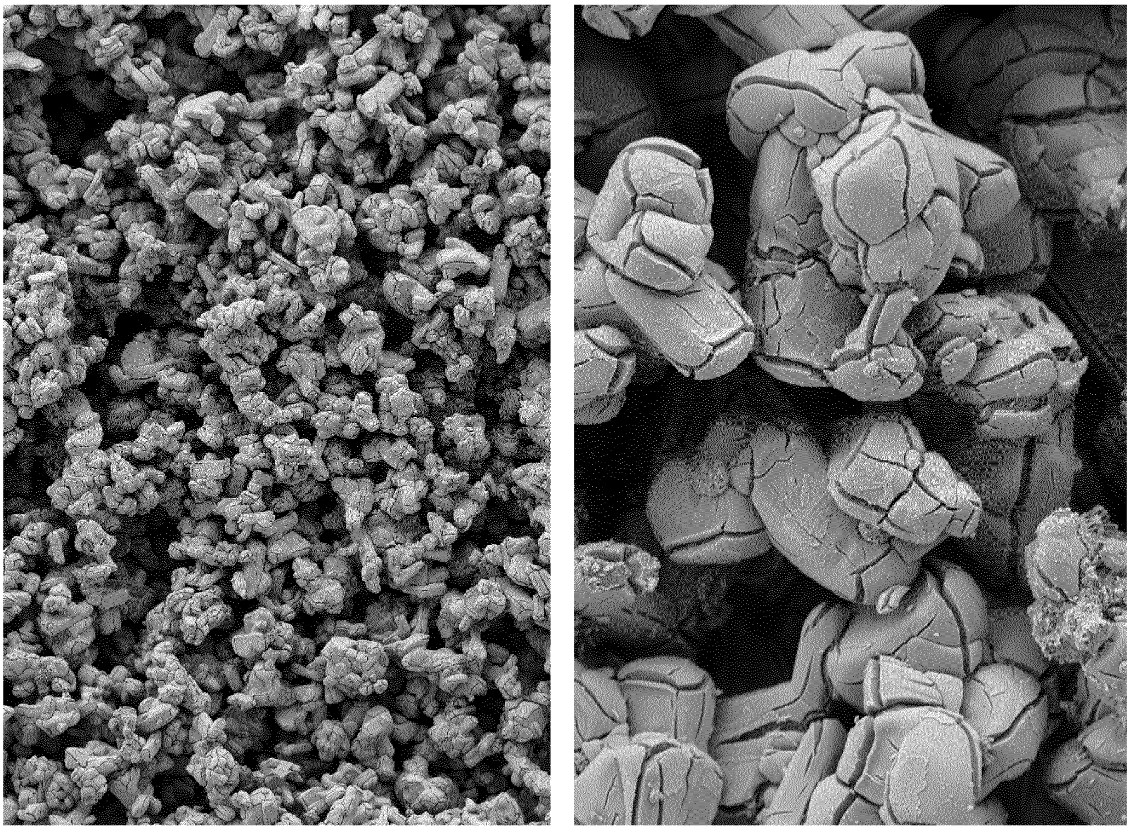

Unbeschichtet
nach Degradationstest

Fig. 10b

Fig. 11a

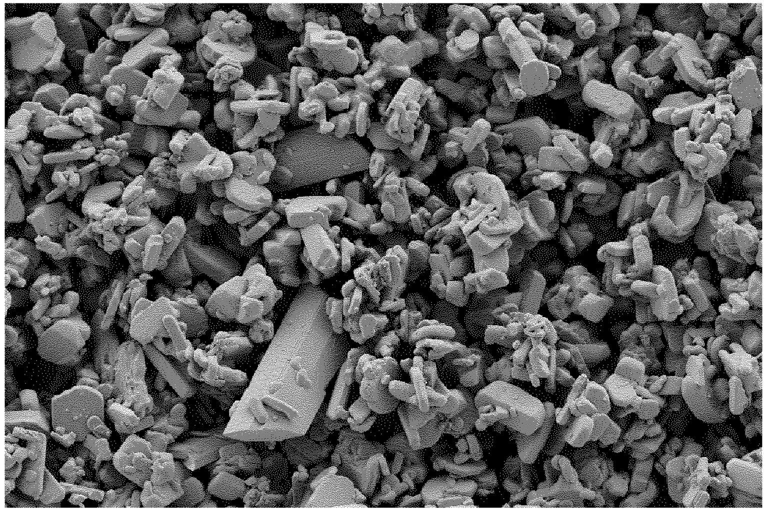

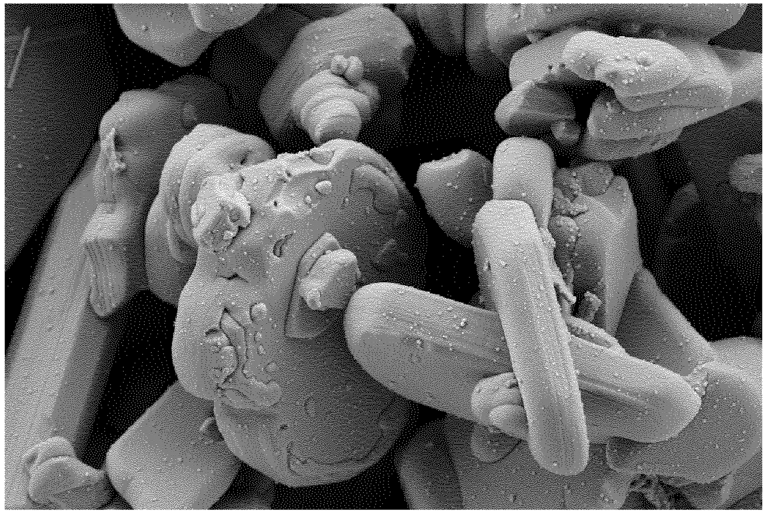

Beschichtet
Vor Degradationstest

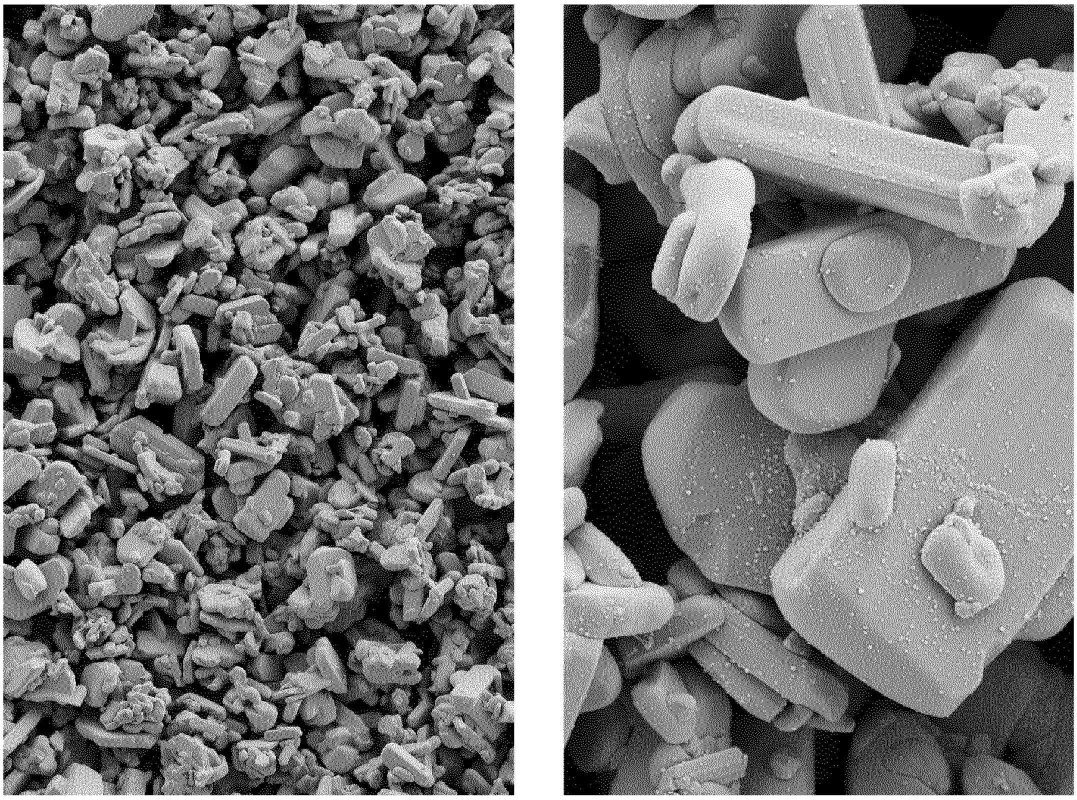

Beschichtet
nach Degradationstest

Fig. 11b

Fig. 12

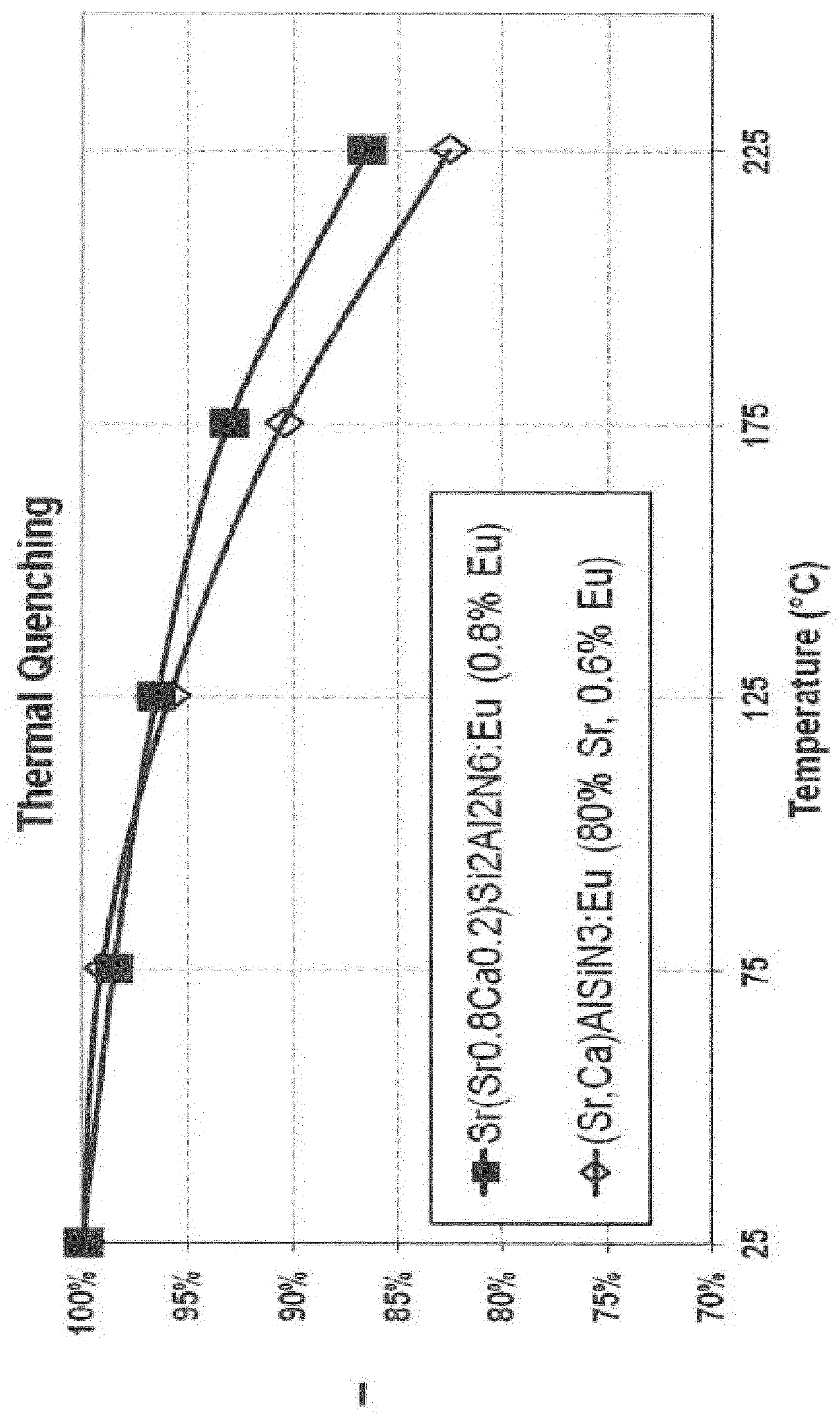
Thermal Quenching
I
100%
95%
90%
85%
80%
75%
70%
25
75
125
175
225
Temperature (°C)
Sr(Sr0.8Ca0.2)Si2Al2N6:Eu (0.8% Eu)
(Sr,Ca)AlSiN3:Eu (80% Sr, 0.6% Eu)

Fig. 13

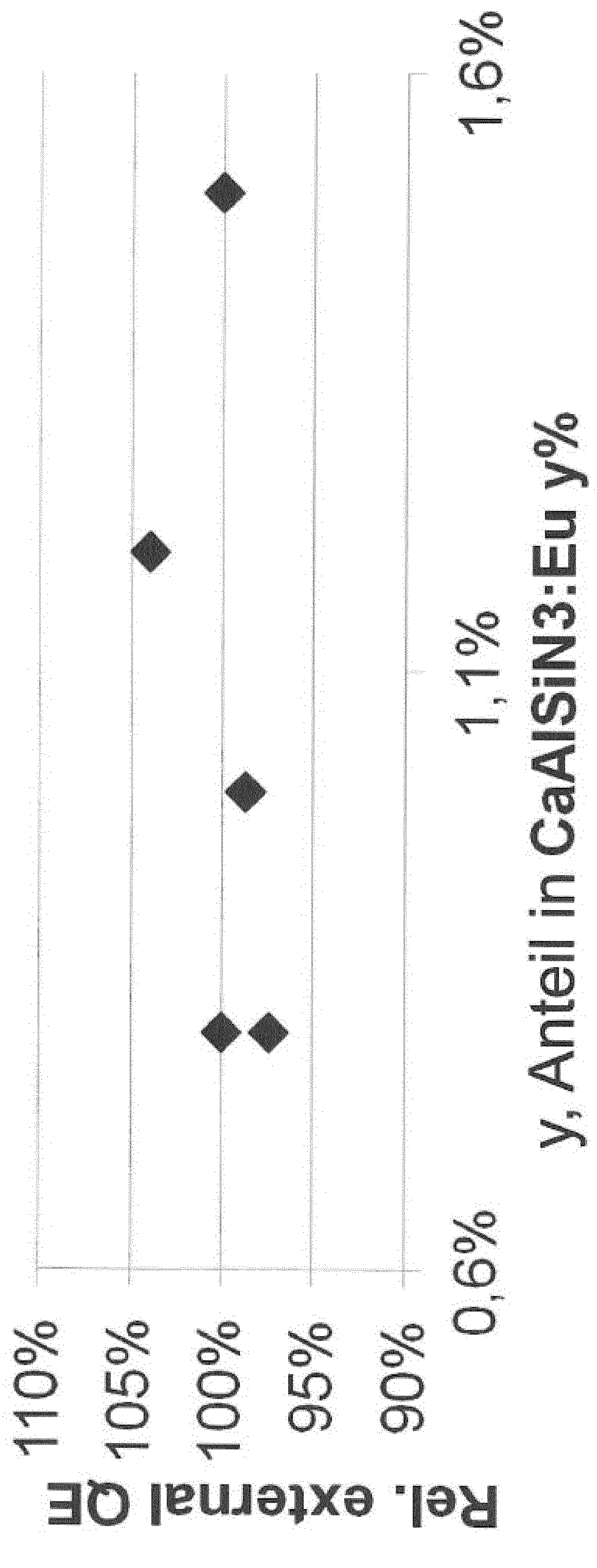
Rel. external QE
110%
105%
100%
95%
90%
0,6%
1,1%
1,6%
y, Anteil in CaAlSiN3:Eu y%

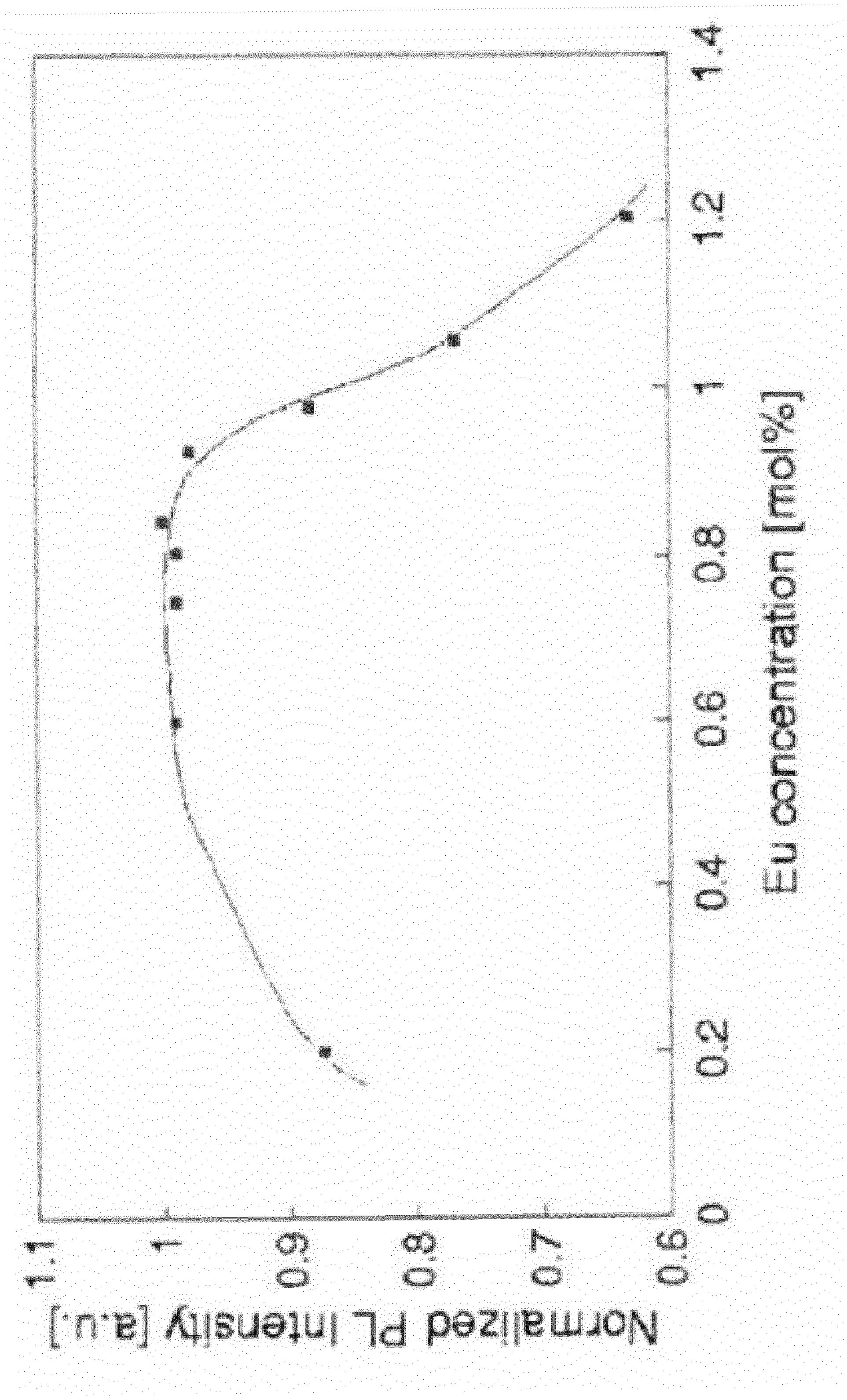

Normalized PL Intensity [a.u.]
1.1
1
0.9
0.8
0.7
0.6
Eu concentration [mol%]
0
0.2
0.4
0.6
0.8
1
1.2
1.4


Fig. 14

Fig. 15

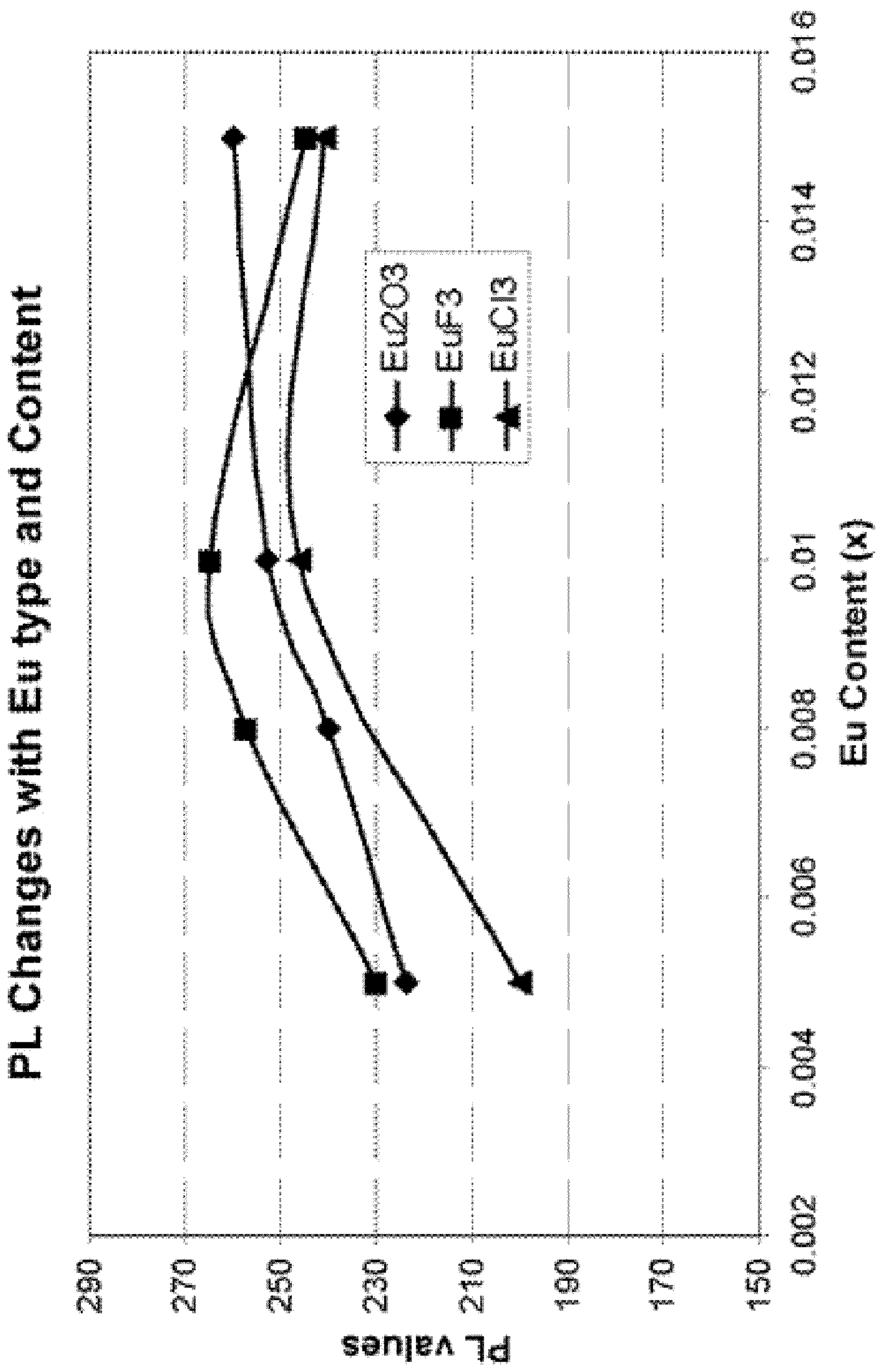
PL Changes with Eu type and Content
PL values
290
270
250
230
210
190
170
150
0.002
0.004
0.006
0.008
0.01
0.012
0.014
0.016
Eu Content (x)
Eu2O3
EuF3
EuCl3

Fig. 16

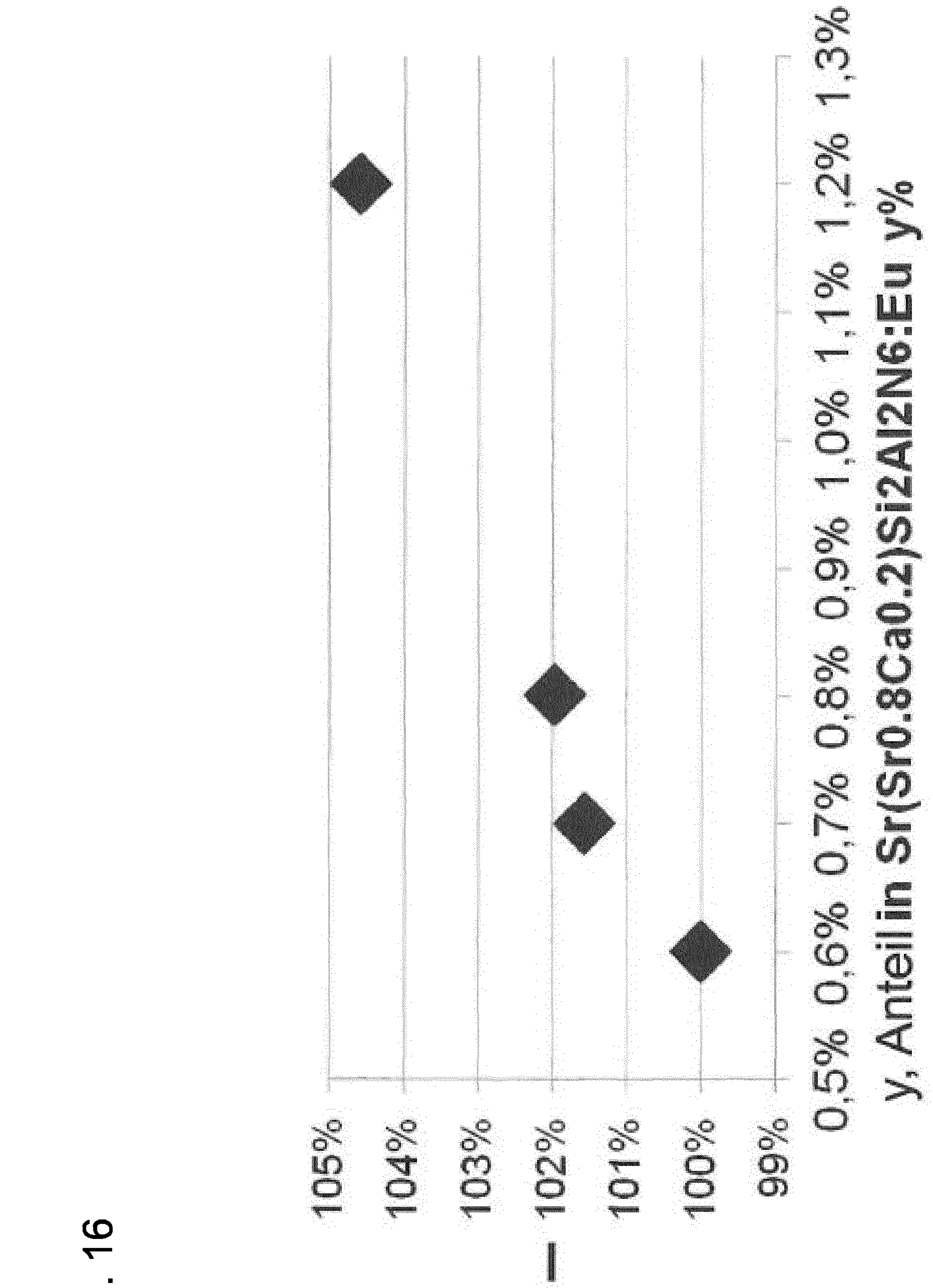
I
105%
104%
103%
102%
101%
100%
99%
0,5% 0,6% 0,7% 0,8% 0,9% 1,0% 1,1% 1,2% 1,3%
y, Anteil in Sr(Sr0.8Ca0.2)Si2Al2N6:Eu y%

Fig. 17

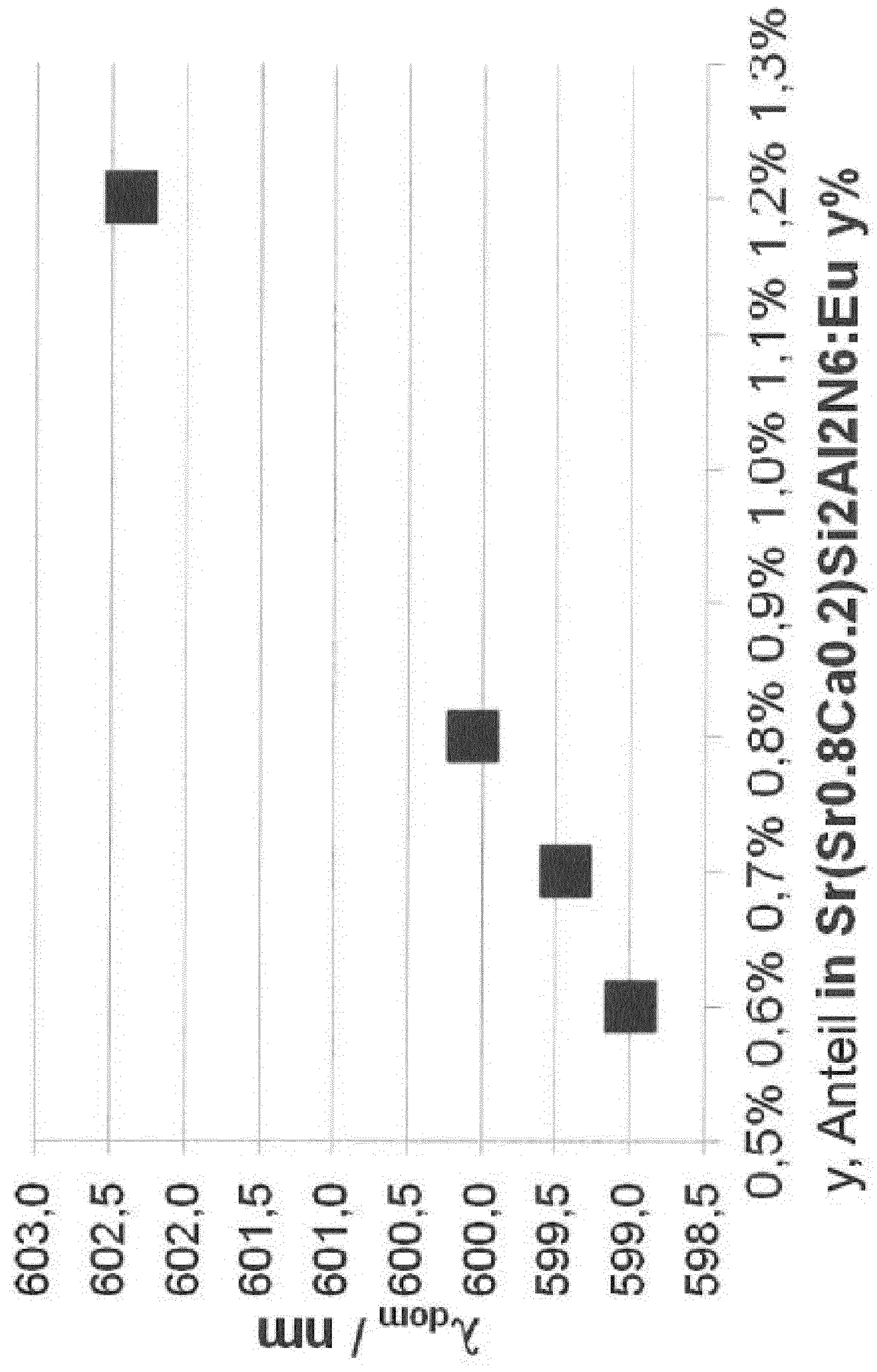
λdom / nm
603,0
602,5
602,0
601,5
601,0
600,5
600,0
599,5
599,0
598,5
0,5% 0,6% 0,7% 0,8% 0,9% 1,0% 1,1% 1,2% 1,3%
y, Anteil in Sr(Sr0.8Ca0.2)Si2Al2N6:Eu y%

Fig. 18

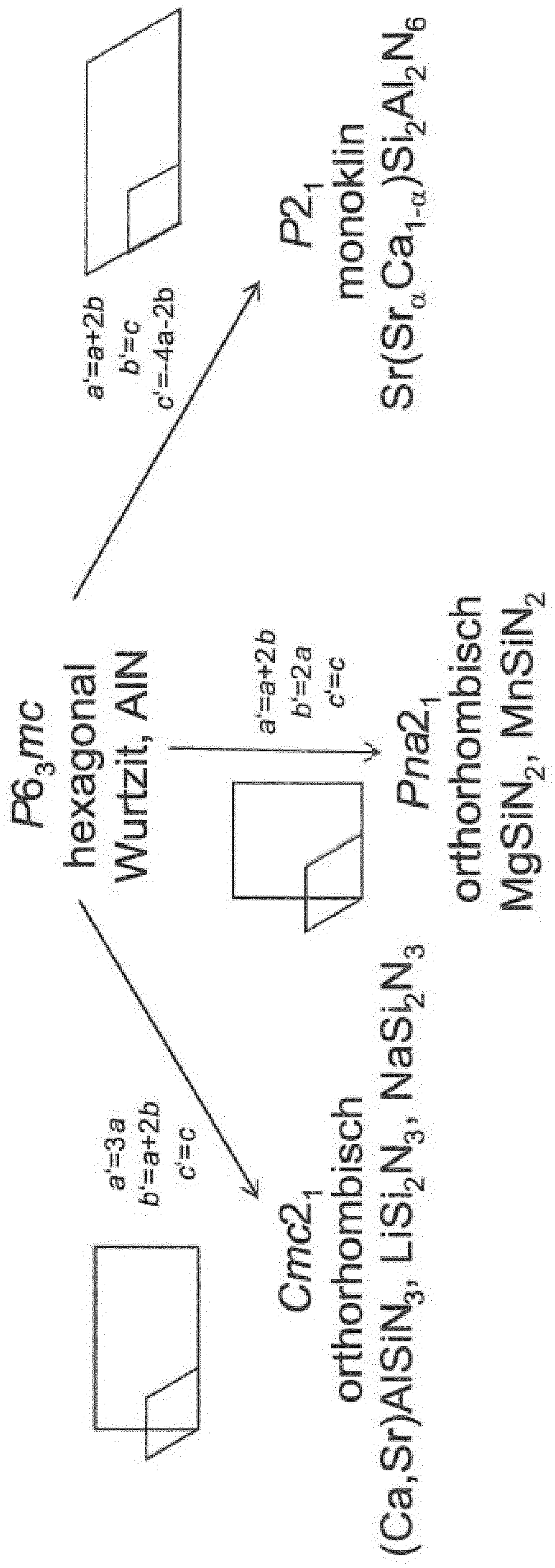
$P6_3mc$
hexagonal
Wurtzit, AlN
a'=3a
b'=a+2b
c'=c
$Cmc2_1$
orthorhombisch
$(Ca,Sr)AlSiN_3$, $LiSi_2N_3$, $NaSi_2N_3$
a'=a+2b
b'=2a
c'=c
$Pna2_1$
orthorhombisch
$MgSiN_2$, $MnSiN_2$
a'=a+2b
b'=c
c'=-4a-2b
$P2_1$
monoklin
$Sr(Sr_\alpha Ca_{1-\alpha})Si_2Al_2N_6$

Fig. 19

Strukturelle Daten aus der ICSD-Datenbank; einige Verbindungen in der Raumgruppe $Cmc2_1$, alle im $NaSiO_3$-Strukturtyp

| forumla | *a* (Å) | *b* (Å) | *c* (Å) | Bibliographic data |
|---|---|---|---|---|
| $Ca(Al_{0.54}Si_{1.38})N_3$ | 9.7558 | 5.6473 | 5.0524 | Chem. Mater. (1,1989 -(2008) 20, p6704 -p6714) |
| $(Ca_{0.98}Ce_{0.01}Li_{0.01})(Al_{0.6}Si_{1.3})N_3$ | 9.795 | 5.6465 | 5.0590 | Chem. Mater. (1,1989 -(2008) 20, p6704 -p6714) |
| $(Sr_{0.2}Ca_{0.8})(AlSi)N_3$ | 9.813 | 5.6667 | 5.08378 | Journal of Alloys Compd. (2009), 475, p434 -439 |
| $(Sr_{0.5}Ca_{0.5})(AlSi)N_3$ | 9.8297 | 5.6879 | 5.1085 | Journal of Alloys Compd. (2009), 475, p434 -439 |
| $(Sr_{0.846}Ca_{0.211})(AlSi)N_3$ | 9.8152 | 5.73644 | 5.14905 | Journal of Alloys Compd. (2009), 475, p434 -439 |
| $Li_{0.94}Ca_{0.04}Eu_{0.01}Al_{0.04}Si_{1.90}N_3$ | 9.2204 | 5.3107 | 4.7861 | Journal of Sol. State Chem. (2009). 182 (2). p301 - 311 |
| $Sr_{0.962}$ $(AlSi)N_3$ | 9.8087 | 5.756 | 5.16614 | Journal of Alloys Compd. (2009), 475, p434 -439 |
| $(Sr_{0.99}Eu_{0.01})(AlSi)N_3$ | 9.843 | 5.7603 | 5.177 | Journal of Sol. State Chem. (2009), 181 (8), p1848 - 1852 |

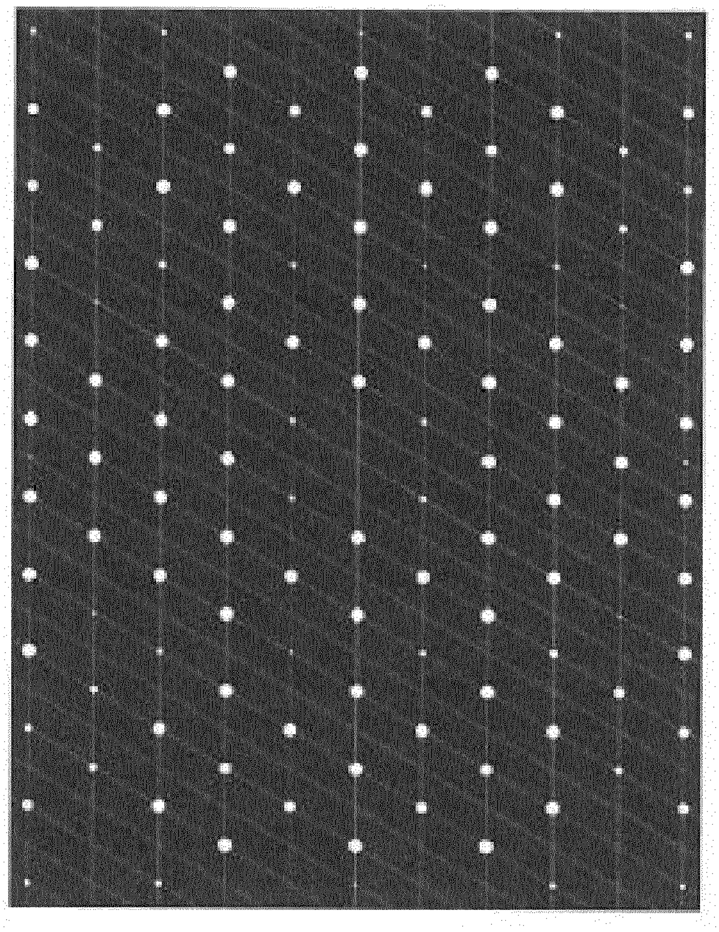

Fig. 20a

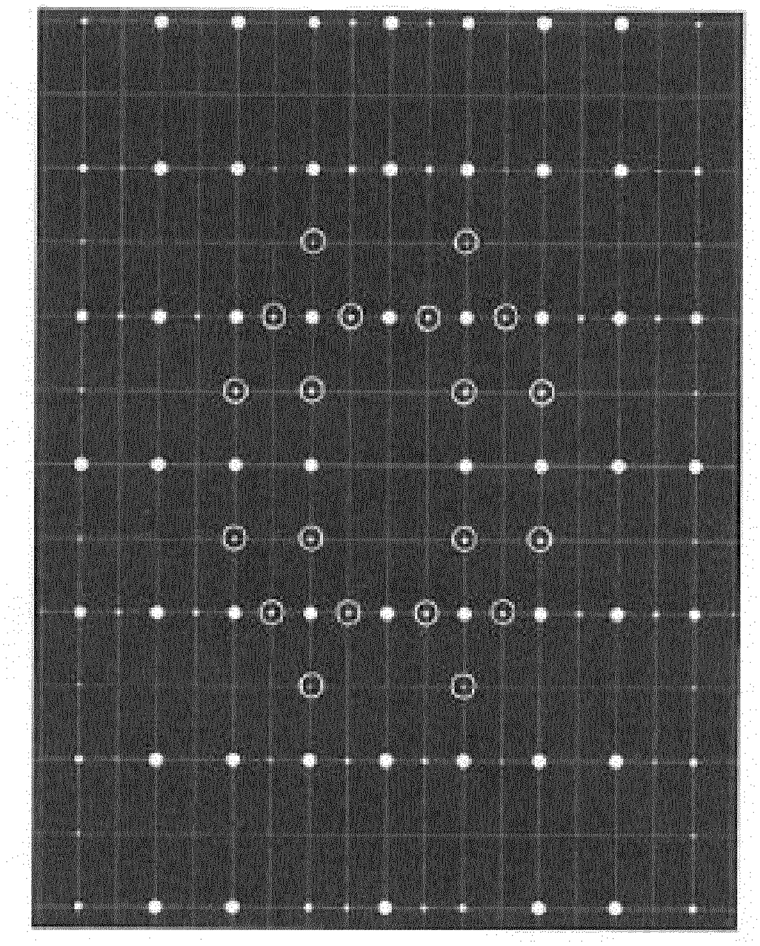

Fig. 20b

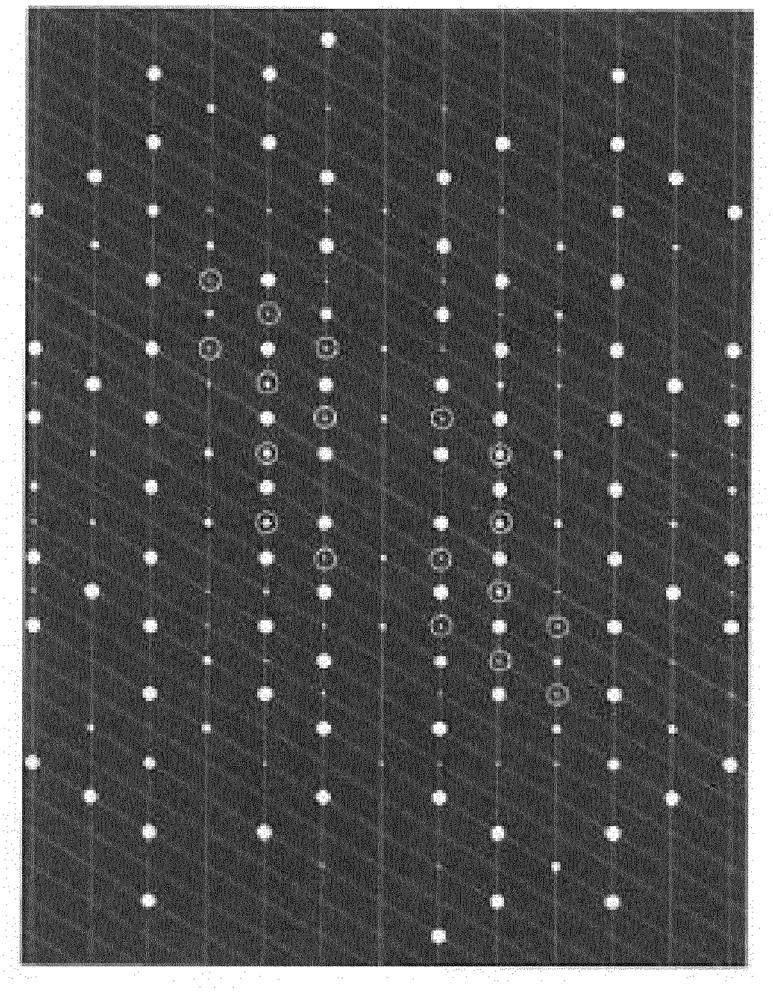

Fig. 20c

Fig. 21

## Einkristalldiffraktometrische Lösung der neuen Struktur $Sr(Sr_{\alpha}Ca_{1-\alpha})Si_2Al_2N_6$

| Details der röntgenographischen Lösung | |
|---|---|
| Gitterparameter | |
| *a* | 574.93(3) pm |
| *b* | 516.35(3) pm |
| *c* | 1138.1(2) pm |
| *ß* | 120.341(2) ° |
| Formeleinheiten Z | 2 |
| Strahlung | Mo $K_a$, $\lambda$= 71.073 pm |
| Gemessene/ unabhängige Reflexe | 8331/ 2053 |
| Gemessener Ausschnitt des reziproken Raums | $-8 < h < 8; -7 < k < 8; -16 < l < 17$ |
| $R_{obs}/wR_{obs}$ | 6.46%/11.38% |
| GoF | 1.97 |

Fig. 22

## Abstände in der neuen Struktur $Sr(Sr_{\alpha}Ca_{1-\alpha})Si_2Al_2N_6$

**Wichtige Atomabstände in der neuen Struktur $Sr(Sr_{\alpha}Ca_{1-\alpha})Si_2Al_2N_6$**

| | | | | | | | | |
|---|---|---|---|---|---|---|---|---|
| Si1/Al1- | N1 | 175 pm | Si2/Al2- | N1 | 202 pm | Si3/Al3- | N1 | 169 pm |
| | N2 | 181 pm | | N2 | 176 pm | | N3 | 194 pm |
| | N3 | 188 pm | | N4 | 178 pm | | N4 | 183 pm |
| | N5 | 182 pm | | N6 | 171 pm | | N5 | 167 pm |
| Si4/Al4- | N2 | 187 pm | Sr1 | N1 | 259 pm | Sr2/Ca2 | N2 | 250 pm |
| | N3 | 159 pm | | N3 | 263 pm | | N4 | 281 pm |
| | N4 | 202 pm | | N5_1 | 264 pm | | N6_1 | 253 pm |
| | N6 | 192 pm | | N5_2 | 270 pm | | N6_2 | 272 pm |
| | | | | N5_3 | 277 pm | | N6_3 | 263 pm |
| | | | | N5_4 | 297 pm | | | |

Fig. 23

# Kristallographische Parameter (Einkristallographie)

**Kristallographische Daten von $Sr(Sr_{0.624}Ca_{0.376})Si_2Al_2N_6$**

Raumgruppe: $P2_1$
Kristallsystem: monoklin
Strukturtyp: $Sr(Sr_aCa_{1-a})Si_2Al_2N_6$
Gitterparameter:
$a$ = 574,93 pm
$b$ = 516,35 pm
$c$ = 1138,1 pm
$ß$ = 120,341°

| Atom | Wyck. | s.o.f. | x | y | z | B/ $10^4$ $pm^2$ |
|---|---|---|---|---|---|---|
| Al1 | 2a | 0,5000 | 0,0349 | 0,9764 | 0,1792 | 0,6948 |
| Al2 | 2a | 0,5000 | 0,0324 | 0,9720 | 0,6794 | 0,6948 |
| Al3 | 2a | 0,5000 | 0,6773 | 0,9855 | 0,8289 | 0,6948 |
| Al4 | 2a | 0,5000 | 0,6615 | 0,0037 | 0,3226 | 0,6948 |
| Si1 | 2a | 0,5000 | 0,0349 | 0,9764 | 0,1792 | 0,6948 |
| Si2 | 2a | 0,5000 | 0,0324 | 0,9720 | 0,6794 | 0,6948 |
| Si3 | 2a | 0,5000 | 0,6773 | 0,9855 | 0,8289 | 0,6948 |
| Si4 | 2a | 0,5000 | 0,6615 | 0,0037 | 0,3226 | 0,6948 |
| N1 | 2a | 1,0000 | 0,1210 | 0,6520 | 0,2134 | 0,8212 |
| N2 | 2a | 1,0000 | 0,0830 | 0,6350 | 0,7224 | 0,8212 |
| N3 | 2a | 1,0000 | 0,6260 | 0,6260 | 0,7640 | 0,8212 |
| N4 | 2a | 1,0000 | 0,6620 | 0,6440 | 0,2575 | 0,8212 |
| N5 | 2a | 1,0000 | 0,7950 | 0,9920 | 0,9950 | 0,8212 |
| N6 | 2a | 1,0000 | 0,7870 | 0,0170 | 0,5132 | 0,8212 |
| Sr1 | 2a | 1,0000 | 0,6806 | 0,4874 | 0,0004 | 1,0264 |
| Sr2 | 2a | 0,6240 | 0,6894 | 0,4982 | 0,5016 | 1,0264 |
| Ca2 | 2a | 0,3760 | 0,6894 | 0,4982 | 0,5016 | 1,0264 |

**Kristallographische Daten von literaturbekanntem $Sr_{0.99}Eu_{0.01}AlSiN_3$**
(Strukturdatenbank ICSD 41-9410)
Raumgruppe: $Cmc2_1$
Kristallsystem: orthorhombisch
Strukturtyp: $NaSiO_3$
Gitterparameter:
$a$ = 984,3 pm
$b$ = 576,03 pm
$c$ = 517,7 pm

| Atom | Wyck. | s.o.f. | x | y | z | B/ $10^4$ $pm^2$ |
|---|---|---|---|---|---|---|
| Al1 | 8b | 0,5000 | 0,1777 | 0,1518 | 0,0256 | 1,113 |
| Si1 | 8b | 0,5000 | 0,1777 | 0,1518 | 0,0256 | 1,113 |
| N1 | 4a | 1,0000 | 0,0000 | 0,2919 | 0,5064 | 1,492 |
| N2 | 8b | 1,0000 | 0,2714 | 0,1177 | 0,3531 | 1,713 |
| Sr1 | 4a | 0,9900 | 0,0000 | 0,1847 | 0,0000 | 0,829 |
| Eu1 | 4a | 0,0100 | 0,0000 | 0,1847 | 0,0000 | 0,829 |

Kristallographische Daten/ Lageparameter des neuen, erfindungsgemäßen Leuchtstoffes (links) – und als Vergleich die kristallographischen Daten/ Lageparameter des literaturbekannten Leuchtstoff $SrAlSiN_3$ (rechts).

Fig. 24a

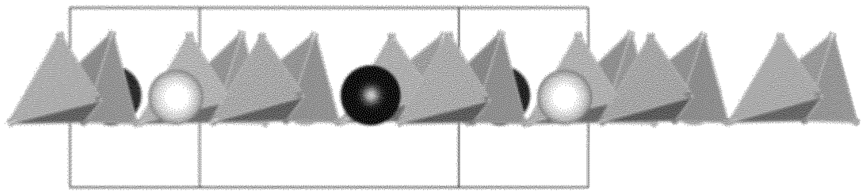

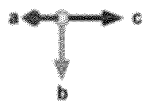


*Abb a) Erfindungsgemäßer Leuchtstoff $Sr(Sr_{\alpha}Ca_{1-\alpha})Si_2Al_2N_6$:Eu, Blick auf die Schichten*

Fig. 24b

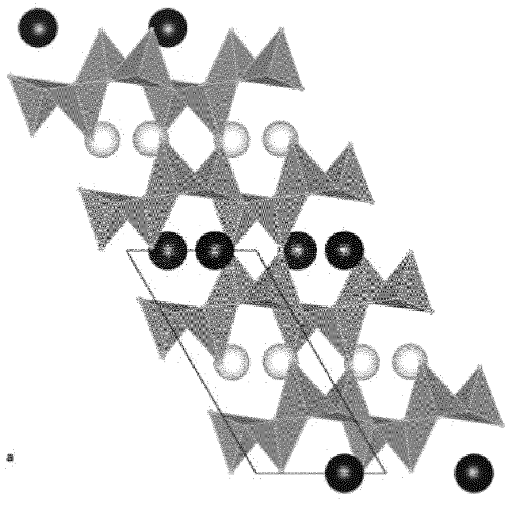

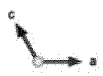


*Abb b) Erfindungsgemäßer Leuchtstoff* $Sr(Sr_{\alpha}Ca_{1-\alpha})Si_2Al_2N_6$:Eu, Blickrichtung [010]

Fig. 24c

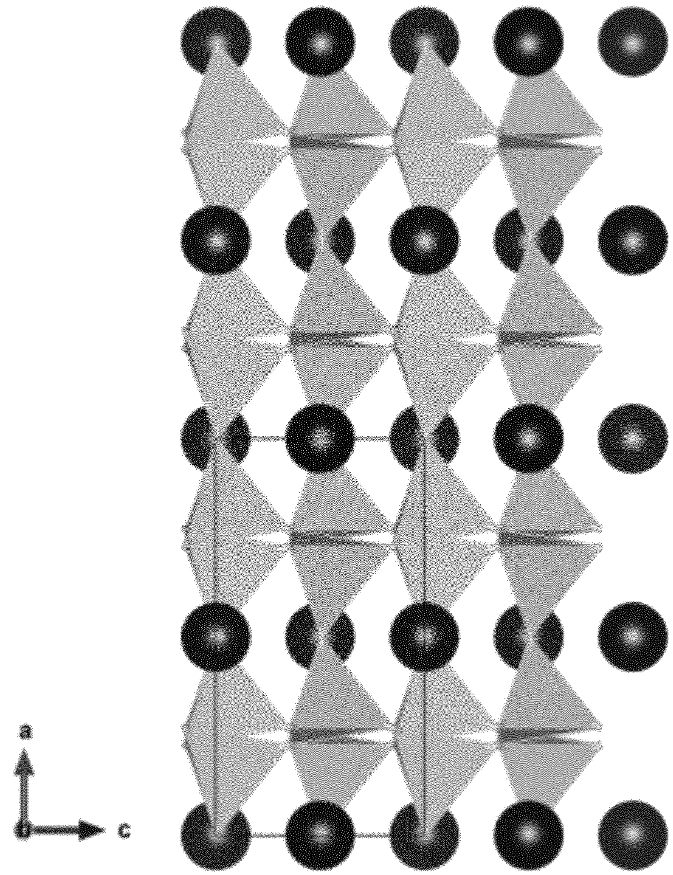


*Abb c)literatur-bekannter Leuchtstoff SCASN*

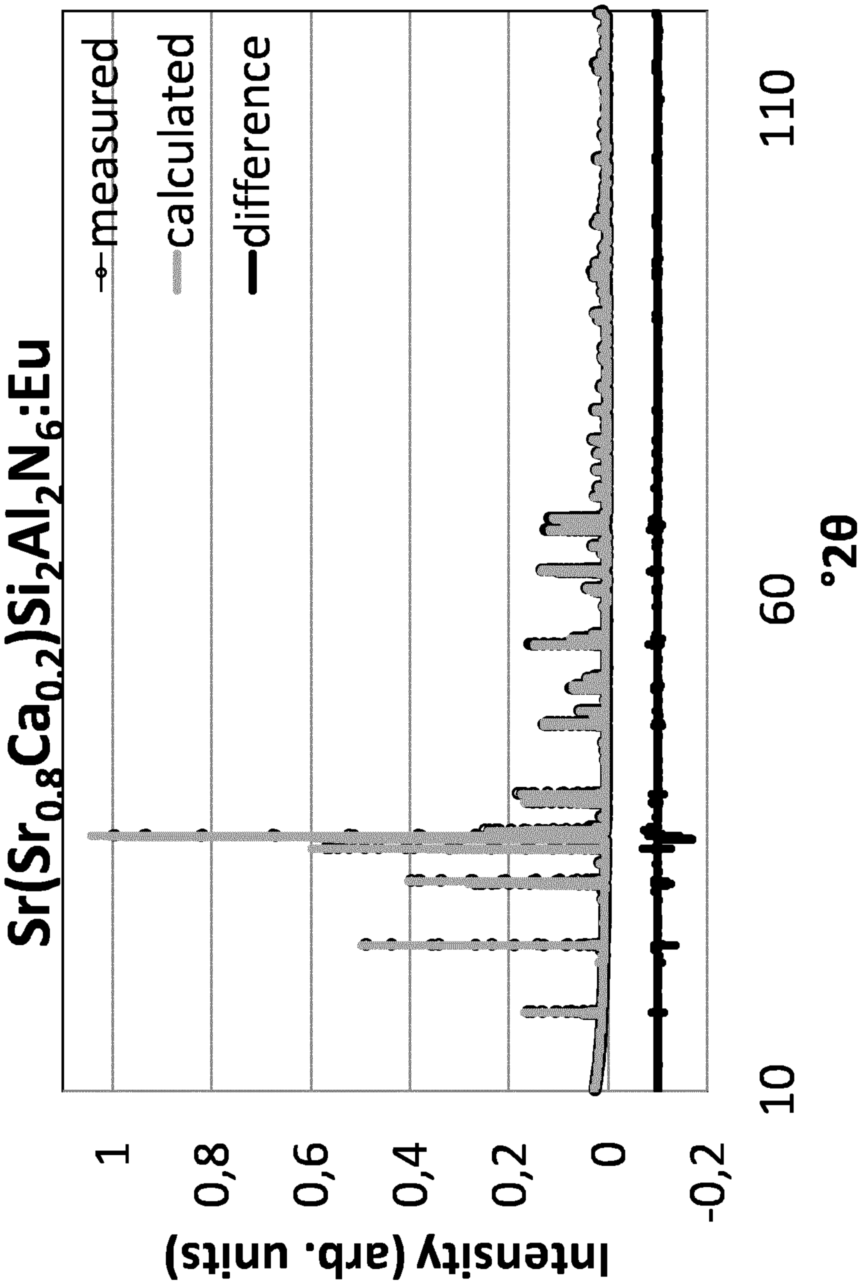

$Sr(Sr_{0.8}Ca_{0.2})Si_2Al_2N_6$:Eu
measured
calculated
difference
Intensity (arb. units)
1
0,8
0,6
0,4
0,2
0
-0,2
10
60
110
°2θ


Fig. 25

Fig. 26

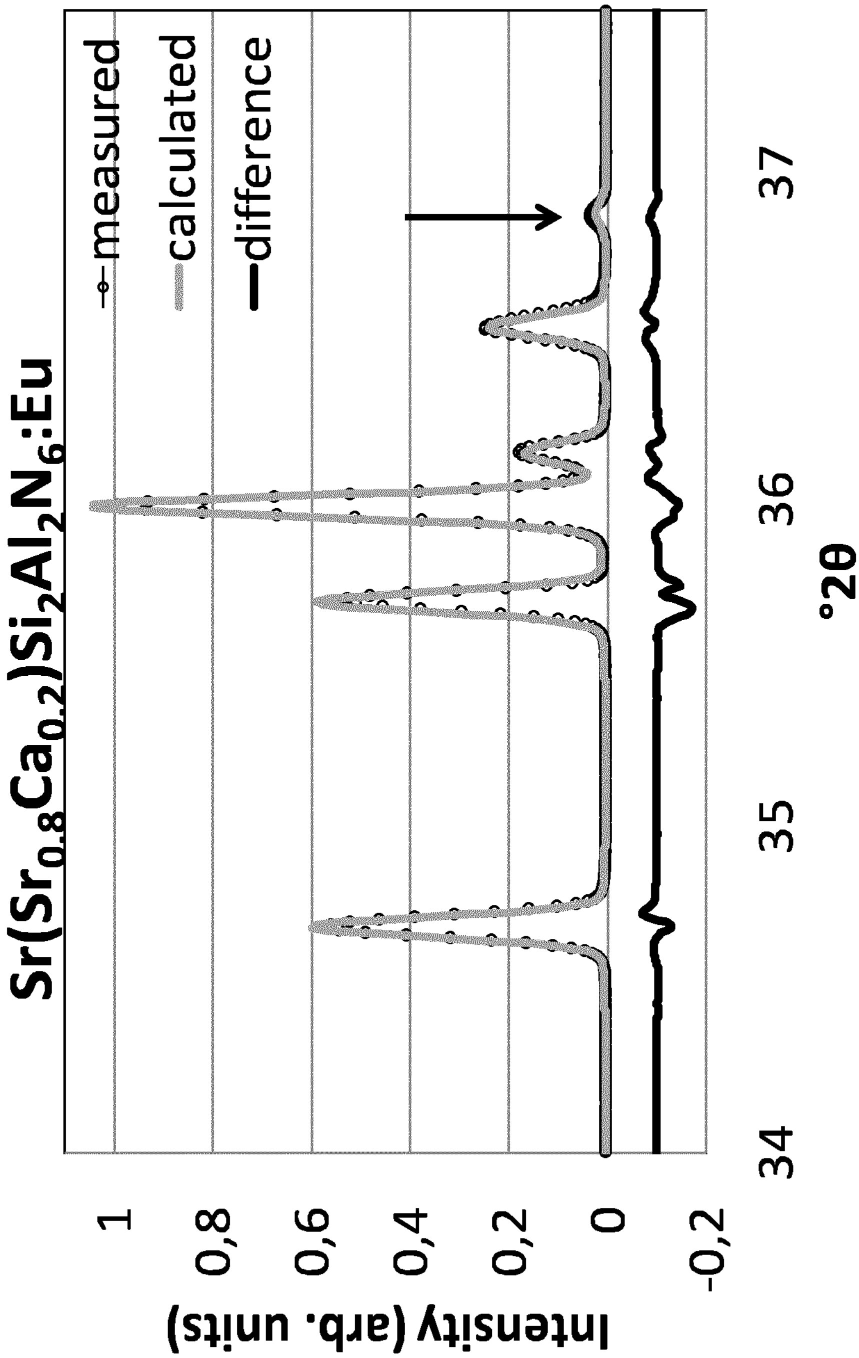

$Sr(Sr_{0.8}Ca_{0.2})Si_2Al_2N_6$:Eu
measured
calculated
difference
Intensity (arb. units)
1
0,8
0,6
0,4
0,2
0
-0,2
34
35
36
37
°2θ

Fig. 27

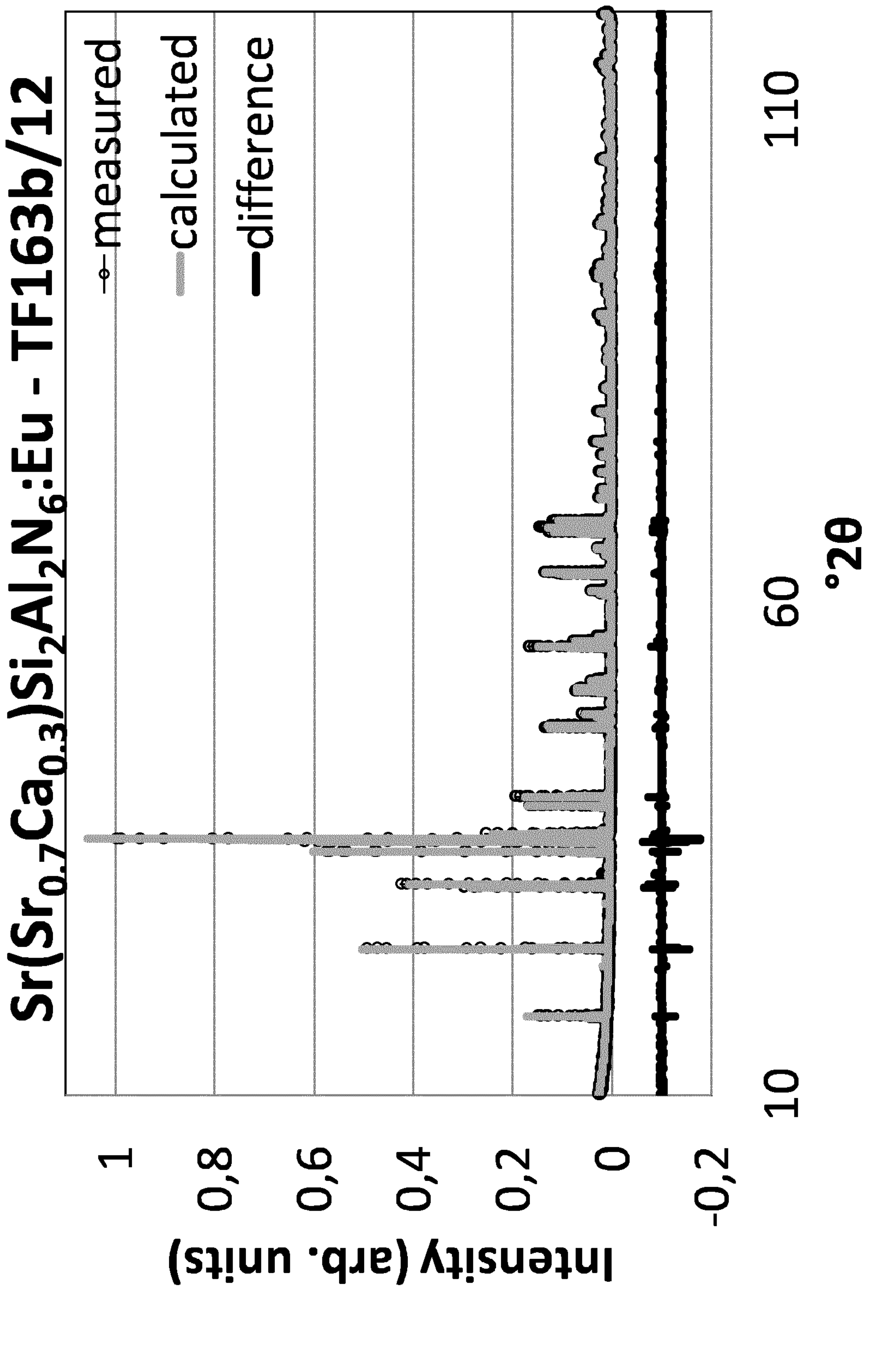
$Sr(Sr_{0.7}Ca_{0.3})Si_2Al_2N_6$:Eu - TF163b/12
measured
calculated
difference
Intensity (arb. units)
1
0,8
0,6
0,4
0,2
0
-0,2
10
60
110
°2θ

Fig. 28

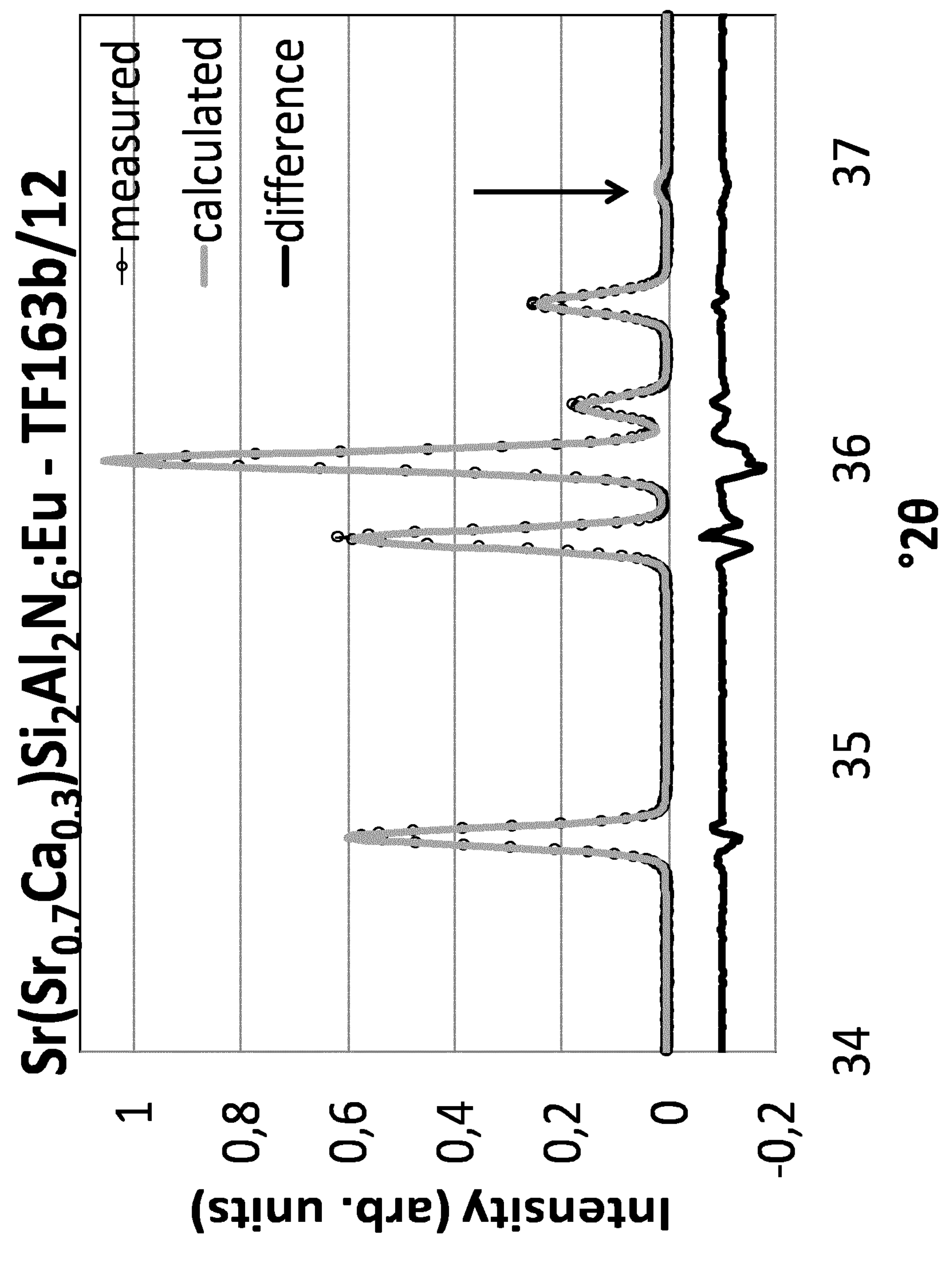
Sr(Sr$_{0.7}$Ca$_{0.3}$)Si$_2$Al$_2$N$_6$:Eu - TF163b/12
measured
calculated
difference
Intensity (arb. units)
1
0,8
0,6
0,4
0,2
0
-0,2
34
35
36
37
°2θ

Fig. 29

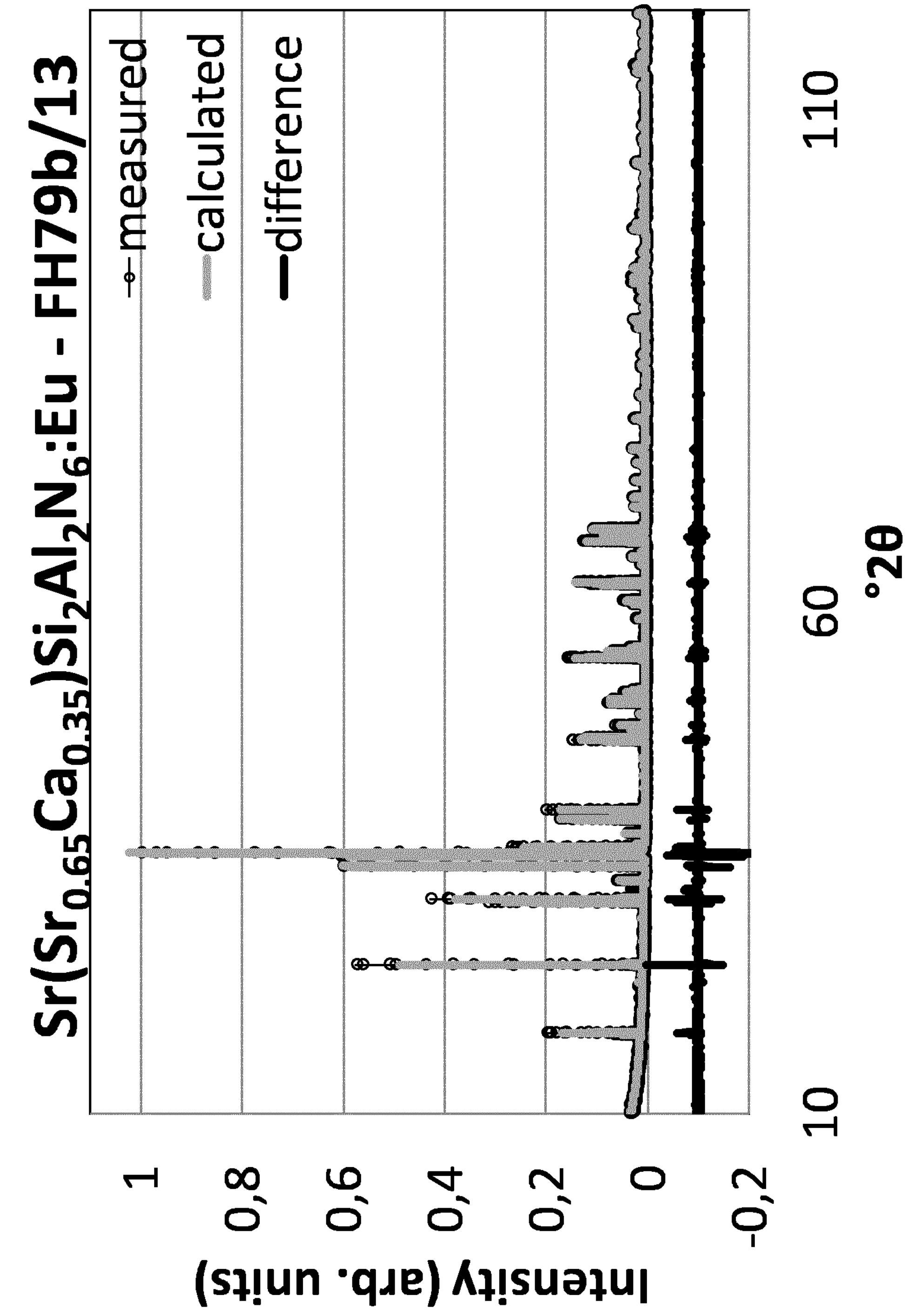

Sr(Sr0.65Ca0.35)Si2Al2N6:Eu - FH79b/13
measured
calculated
difference
Intensity (arb. units)
1
0,8
0,6
0,4
0,2
0
-0,2
10
60
110
°2θ

Fig. 30

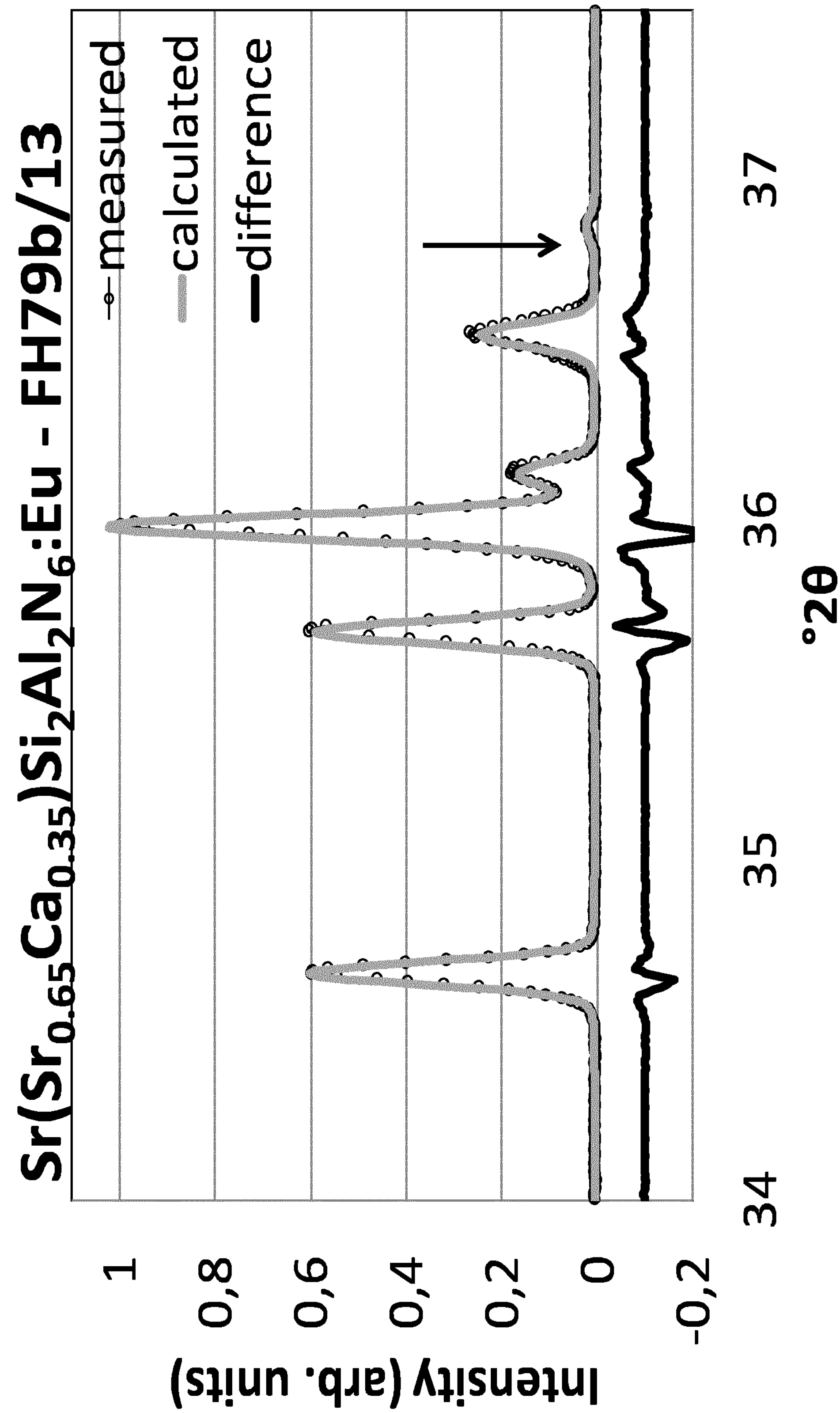

Sr(Sr0.65Ca0.35)Si2Al2N6:Eu - FH79b/13
measured
calculated
difference
Intensity (arb. units)
1
0,8
0,6
0,4
0,2
0
-0,2
34
35
36
37
°2θ

Fig.31

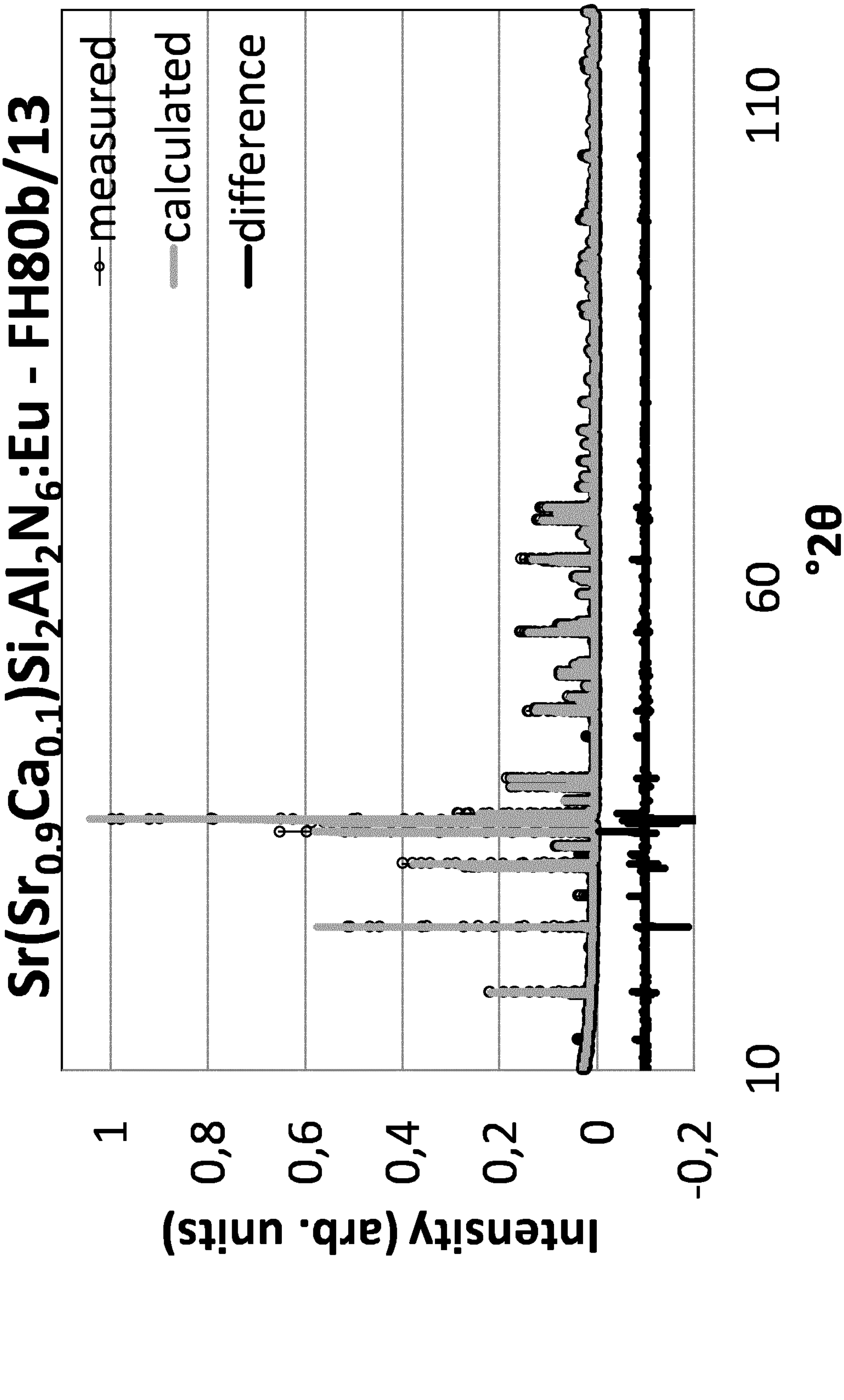

$Sr(Sr_{0.9}Ca_{0.1})Si_2Al_2N_6$:Eu - FH80b/13
measured
calculated
difference
Intensity (arb. units)
1
0,8
0,6
0,4
0,2
0
-0,2
10
60
110
°2θ

Fig.32

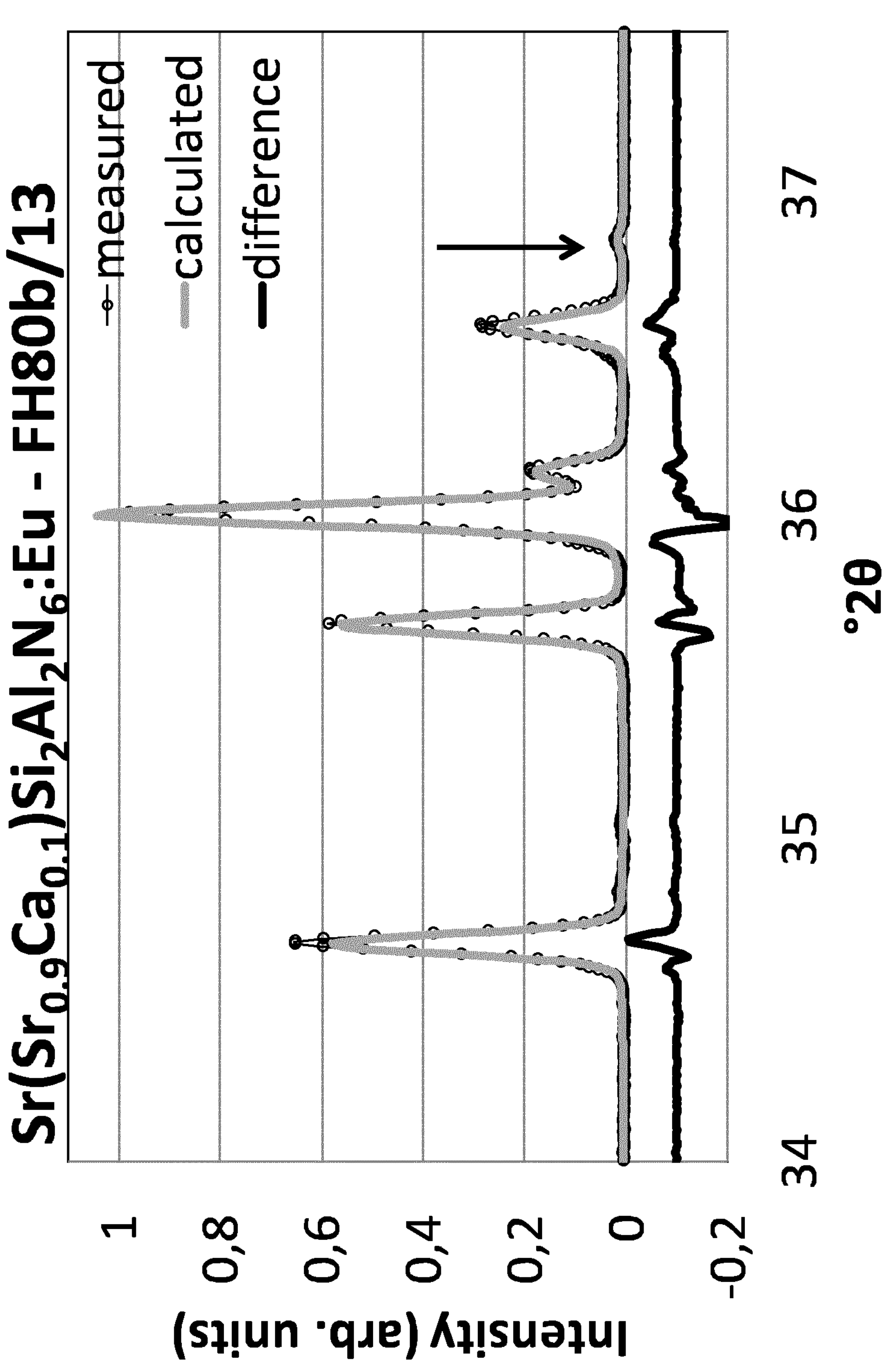
Sr(Sr0.9Ca0.1)Si2Al2N6:Eu - FH80b/13
measured
calculated
difference
Intensity (arb. units)
1
0,8
0,6
0,4
0,2
0
-0,2
34
35
36
37
°2θ

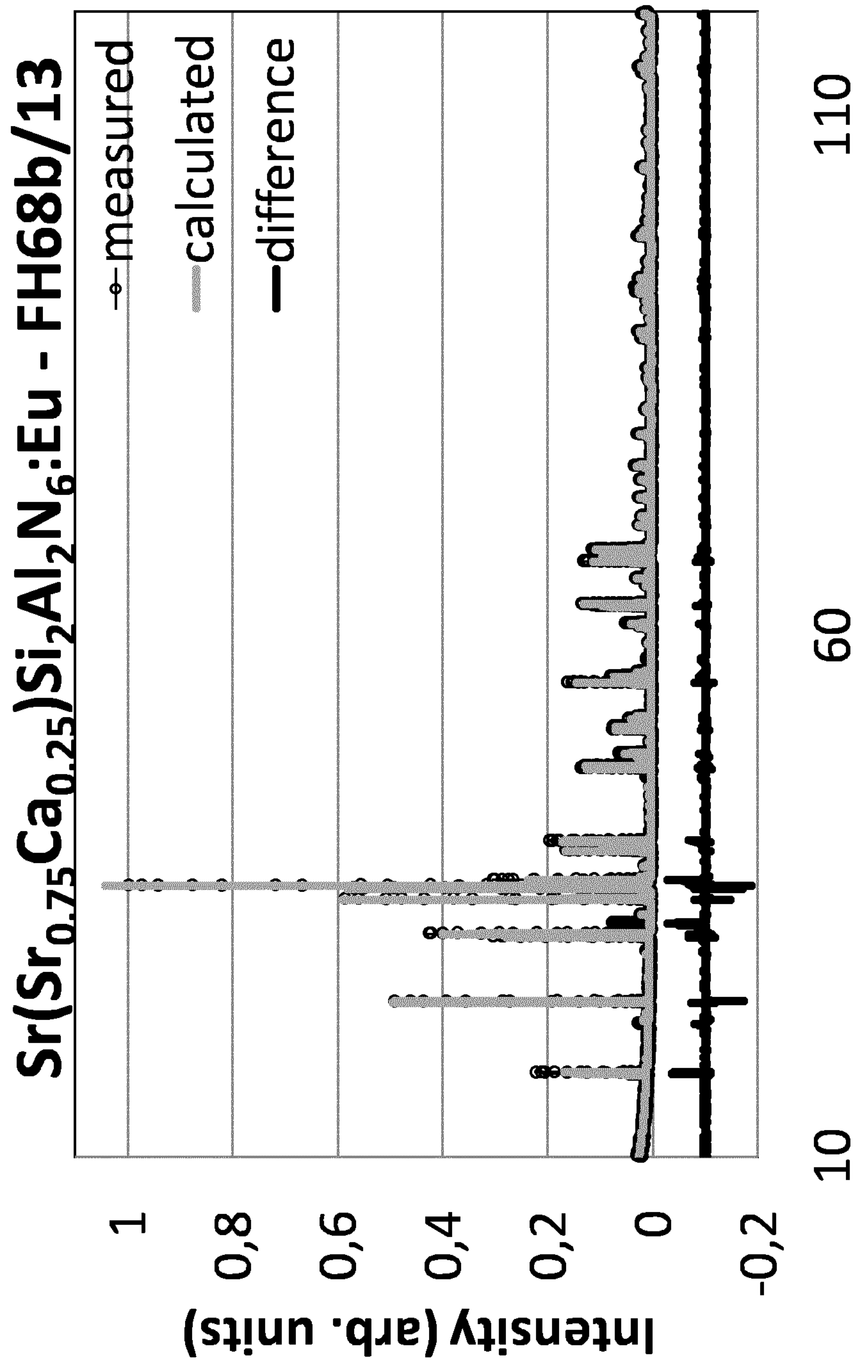
Sr(Sr0.75Ca0.25)Si2Al2N6:Eu - FH68b/13
measured
calculated
difference
Intensity (arb. units)
1
0,8
0,6
0,4
0,2
0
-0,2
10
60
110
°2θ

Fig.33

Fig.34

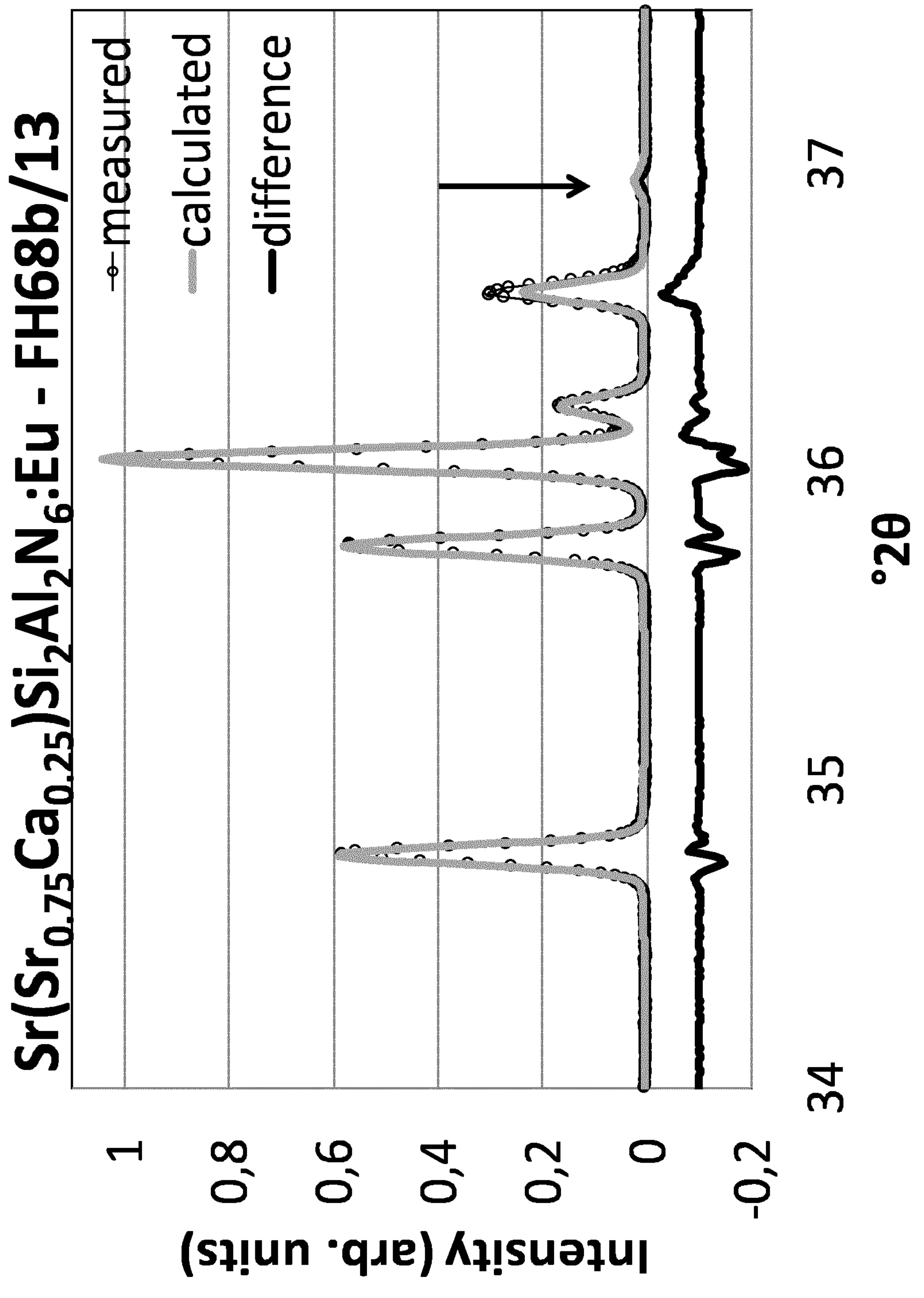
Sr(Sr0.75Ca0.25)Si2Al2N6:Eu - FH68b/13
measured
calculated
difference
Intensity (arb. units)
1
0,8
0,6
0,4
0,2
0
-0,2
34
35
36
37
°2θ

Fig. 35a

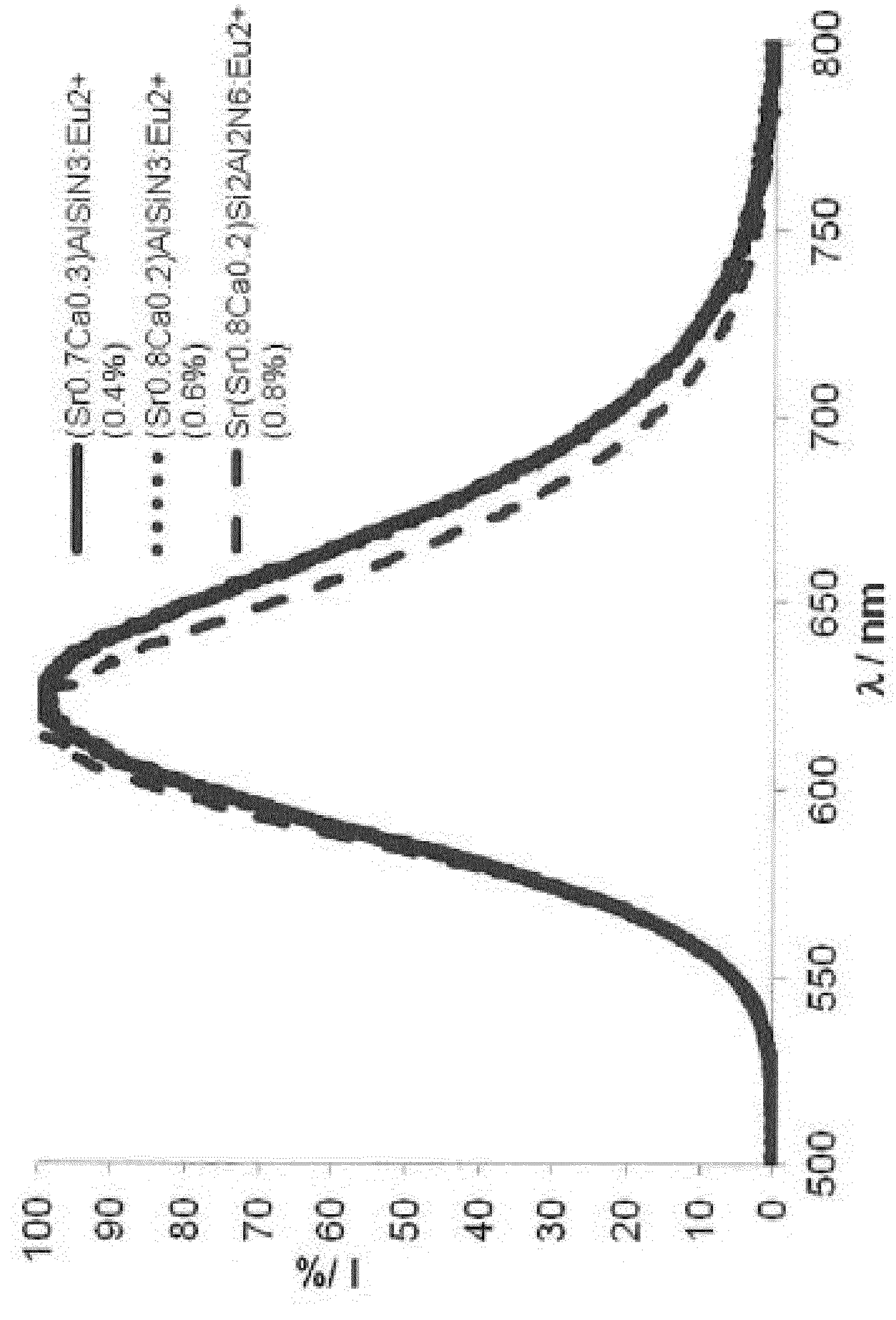
(Sr0.7Ca0.3)AlSiN3:Eu2+ (0.4%)
(Sr0.8Ca0.2)AlSiN3:Eu2+ (0.6%)
Sr(Sr0.8Ca0.2)Si2Al2N6:Eu2+ (0.8%)
I /%
0
10
20
30
40
50
60
70
80
90
100
500
550
600
650
700
750
800
λ / nm

Fig. 35b

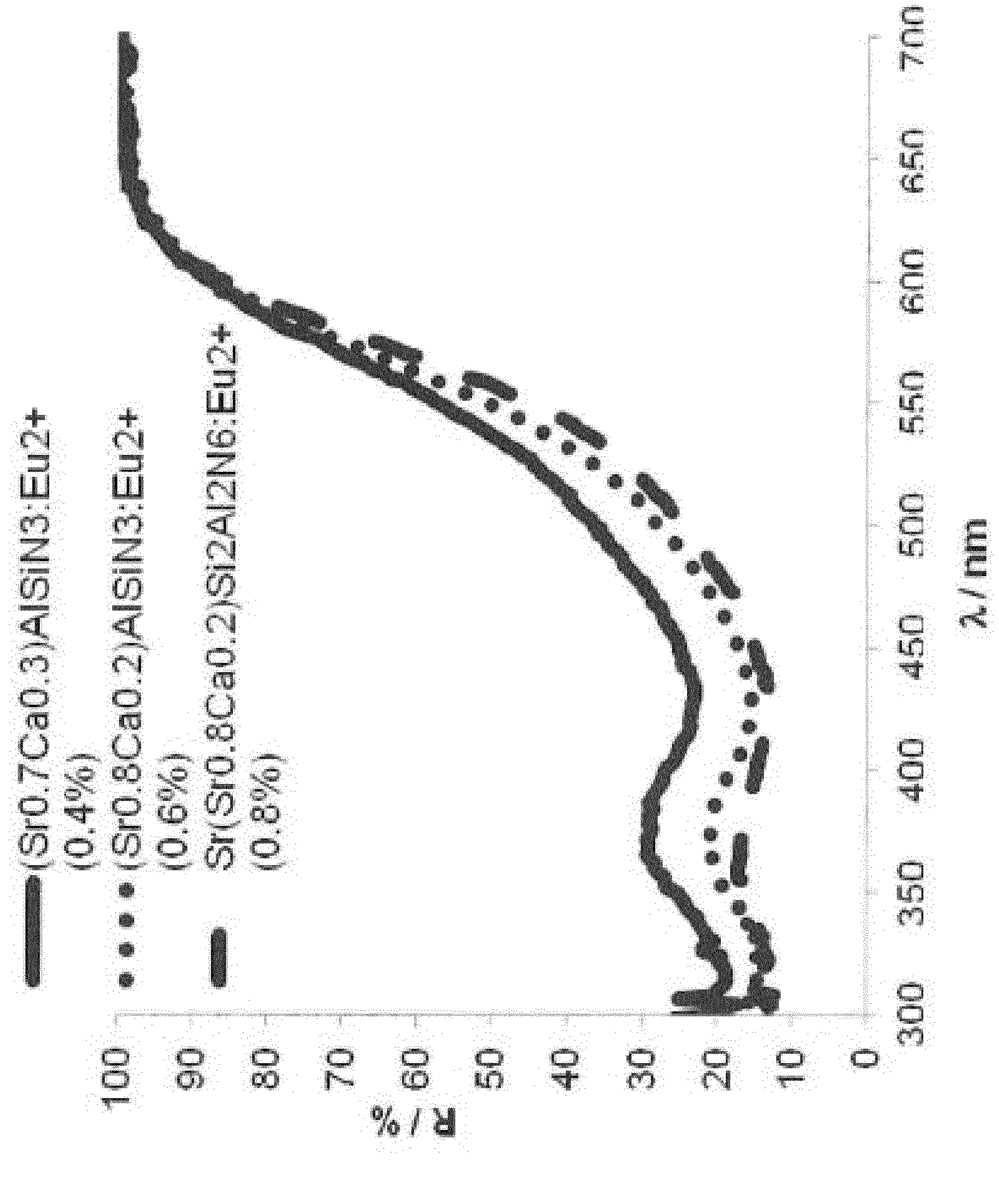
(Sr0.7Ca0.3)AlSiN3:Eu2+
(0.4%)
(Sr0.8Ca0.2)AlSiN3:Eu2+
(0.6%)
Sr(Sr0.8Ca0.2)Si2Al2N6:Eu2+
(0.8%)
R / %
100
90
80
70
60
50
40
30
20
10
0
300
350
400
450
500
550
600
650
700
λ / nm

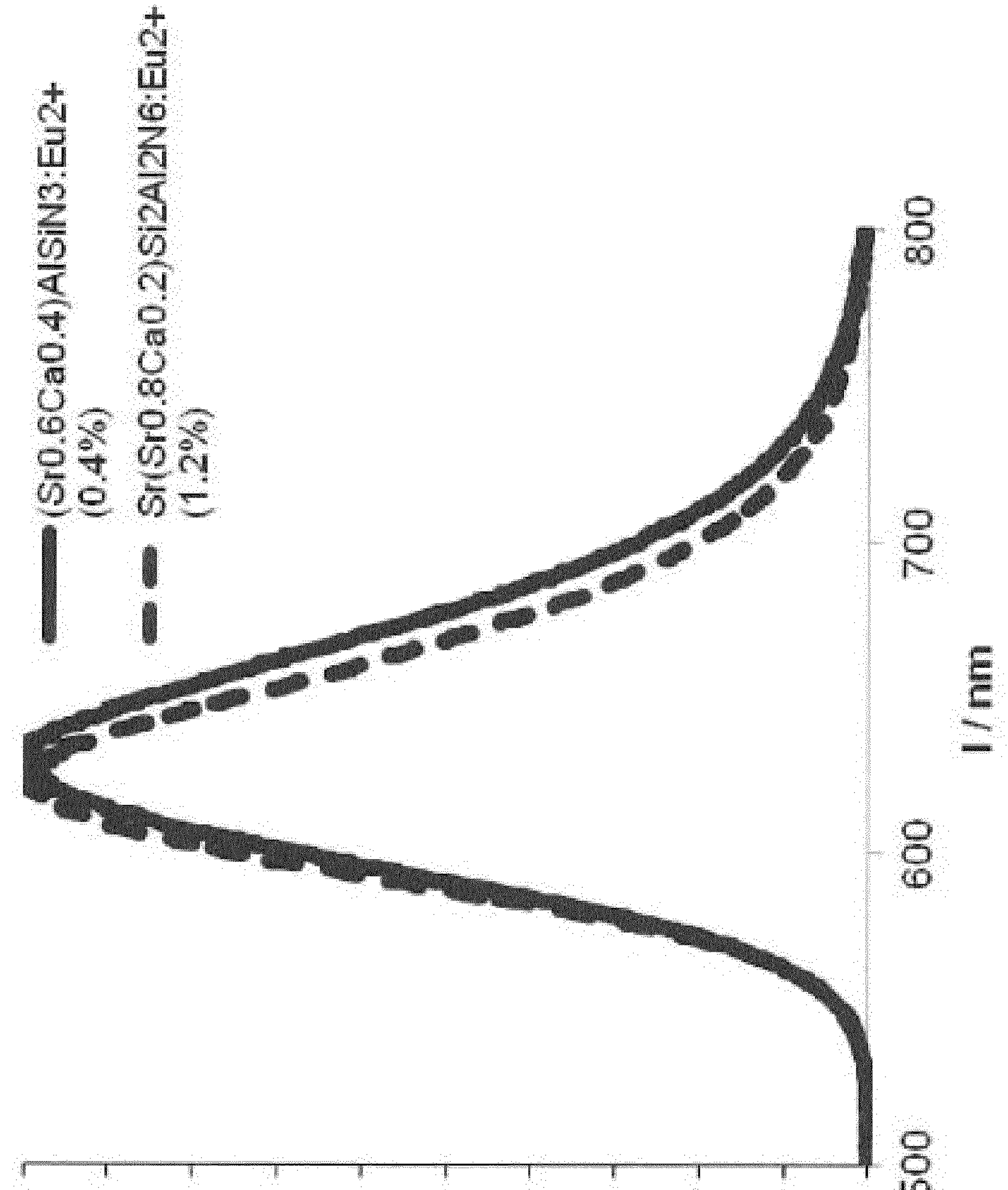
(Sr0.6Ca0.4)AlSiN3:Eu2+ (0.4%)
Sr(Sr0.8Ca0.2)Si2Al2N6:Eu2+ (1.2%)
I / %
100
90
80
70
60
50
40
30
20
10
0
500
600
700
800
l / nm

Fig. 36a

Fig. 36b

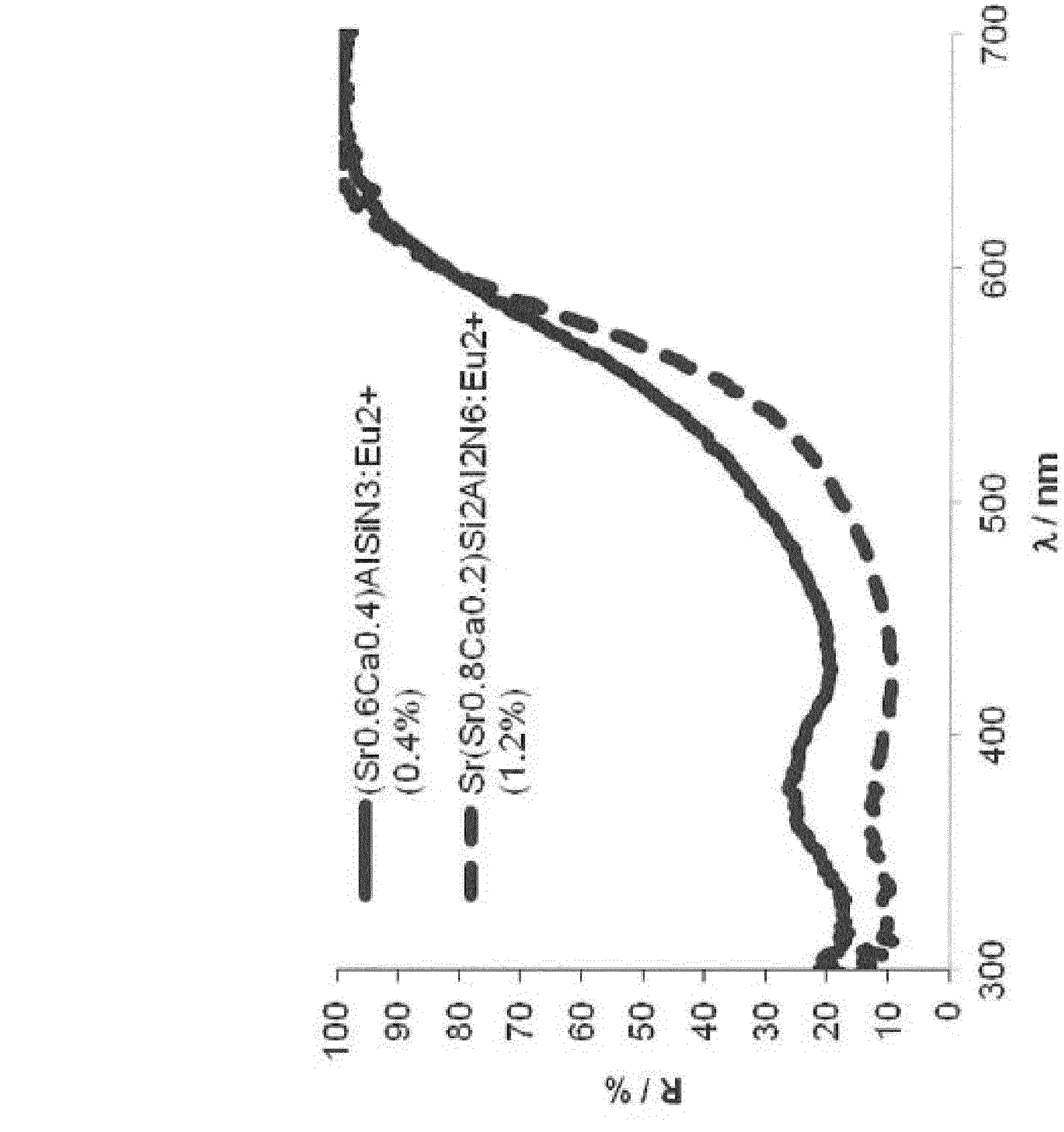


FIG 36b

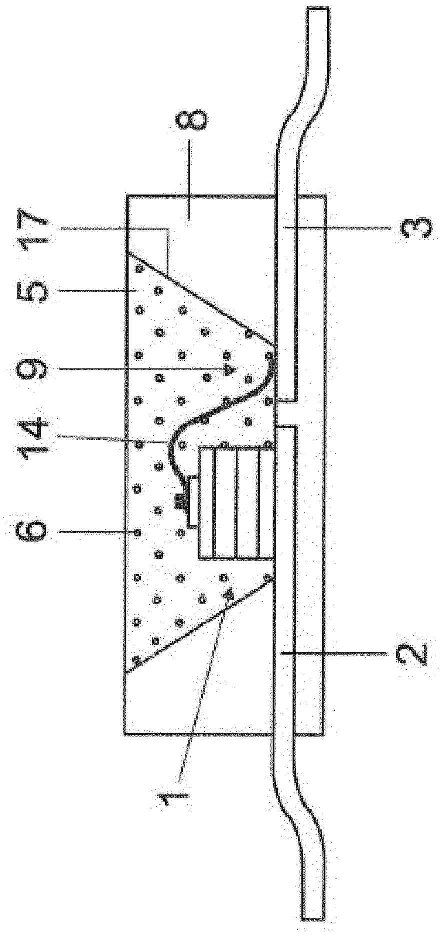


Fig. 37

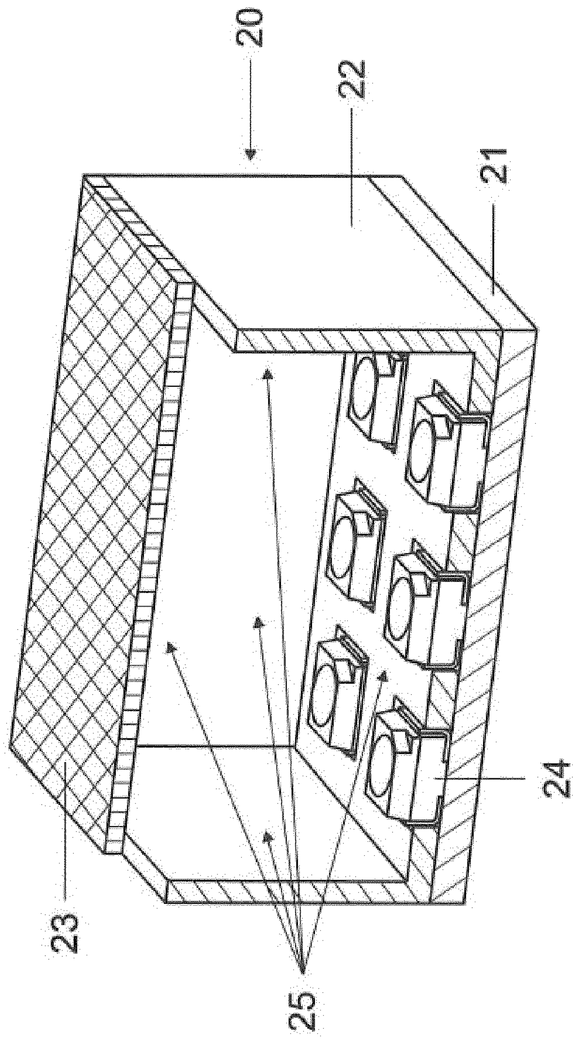


Fig. 38

Fig. 39a/1

| | Zusammensetzung $Ca_{1-x}Sr_xAlSiN_3$:yEu bzw. $Sr(Sr_aCa_{1-a})Si_2Al_2N_6$:yEu (a=2x-1) | | Einwaage / g | | | | | | | | | | Optische Charakterisierung | |
|---|---|---|---|---|---|---|---|---|---|---|---|---|---|---|
| Versuch | y | x | Ca3N2 | Sr3N2 | AlF3 | SrF2 | BaF2 | Li2B4O7 | LiBF4 | Si3N4 | AlN | Eu2O3 | Gesamt | CIE x | CIE y |
| FH 005_13 | 0,6% | 0,8 | 2,746 | 21,552 | 0,875 | 0,436 | 0 | 0 | 0 | 12,993 | 11,104 | 0,293 | 50 | 0,632 | 0,365 |
| FH 006_13 | 0,6% | 0,8 | 2,730 | 21,428 | 0,290 | 1,301 | 0 | 0 | 0 | 12,918 | 11,040 | 0,292 | 50 | 0,632 | 0,365 |
| FH 007_13 | 0,6% | 0,8 | 2,729 | 21,416 | 0,232 | 1,387 | 0 | 0 | 0 | 12,911 | 11,034 | 0,292 | 50 | 0,634 | 0,364 |
| FH 008_13 | 0,6% | 0,8 | 2,748 | 21,564 | 0,934 | 0,349 | 0 | 0 | 0 | 13,000 | 11,111 | 0,294 | 50 | 0,632 | 0,365 |
| FH 009_13 | 0,6% | 0,8 | 2,738 | 21,492 | 1,163 | 0 | 0 | 0 | 0 | 12,957 | 11,357 | 0,293 | 50 | 0,631 | 0,366 |
| FH 010_13 | 0,6% | 0,8 | 2,646 | 20,769 | 1,124 | 1,682 | 0 | 0 | 0 | 12,521 | 10,975 | 0,283 | 50 | 0,631 | 0,366 |
| FH 011_13 | 0,6% | 0,8 | 2,574 | 20,202 | 1,641 | 2,454 | 0 | 0 | 0 | 12,179 | 10,676 | 0,275 | 50 | 0,633 | 0,364 |
| FH 012_13 | 0,6% | 0,8 | 2,506 | 19,665 | 2,129 | 3,185 | 0 | 0 | 0 | 11,855 | 10,392 | 0,268 | 50 | 0,632 | 0,364 |
| FH 013_13 | 0,6% | 0,8 | 2,731 | 21,434 | 0 | 0 | 0 | 0 | 1,295 | 12,922 | 11,326 | 0,292 | 50 | 0,635 | 0,363 |
| FH 014_13 | 0,6% | 0,8 | 2,735 | 21,463 | 0,581 | 0 | 0 | 0 | 0,648 | 12,939 | 11,342 | 0,292 | 50 | 0,633 | 0,364 |
| FH 015_13 | 0,6% | 0,8 | 2,719 | 21,340 | 0,000 | 0,864 | 0 | 0 | 0,645 | 12,865 | 11,277 | 0,290 | 50 | 0,634 | 0,364 |
| FH 016_13 | 0,6% | 0,8 | 2,725 | 21,389 | 0,387 | 0,578 | 0 | 0 | 0,432 | 12,895 | 11,303 | 0,291 | 50 | 0,633 | 0,364 |
| FH 029_13 | 0,6% | 0,8 | 2,671 | 20,961 | 0 | 0 | 2,369 | 0 | 0 | 12,637 | 11,077 | 0,285 | 50 | 0,633 | 0,364 |
| FH 030_13 | 0,6% | 0,8 | 2,704 | 21,223 | 0,574 | 0 | 1,199 | 0 | 0 | 12,795 | 11,215 | 0,289 | 50 | 0,631 | 0,366 |
| FH 031_13 | 0,6% | 0,8 | 2,689 | 21,103 | 0,000 | 0,854 | 1,193 | 0 | 0 | 12,722 | 11,152 | 0,287 | 50 | 0,630 | 0,367 |
| FH 032_13 | 0,6% | 0,8 | 2,701 | 21,195 | 0,000 | 0 | 1,198 | 0 | 0,640 | 12,778 | 11,200 | 0,289 | 50 | 0,636 | 0,361 |
| FH 037_13 | 0,4% | 0,6 | 5,741 | 16,896 | 0,305 | 1,368 | 0 | 0 | 0 | 13,581 | 11,905 | 0,204 | 50 | 0,636 | 0,360 |
| FH 038_13 | 0,4% | 0,6 | 5,738 | 16,886 | 0,244 | 1,458 | 0 | 0 | 0 | 13,573 | 11,897 | 0,204 | 50 | 0,635 | 0,361 |
| FH 039_13 | 0,4% | 0,6 | 5,776 | 16,999 | 0,920 | 0,459 | 0 | 0 | 0 | 13,664 | 11,977 | 0,206 | 50 | 0,637 | 0,359 |
| FH 040_13 | 0,4% | 0,6 | 5,779 | 17,009 | 0,982 | 0,367 | 0 | 0 | 0 | 13,672 | 11,984 | 0,206 | 50 | 0,638 | 0,358 |
| FH 041_13 | 0,4% | 0,6 | 5,793 | 17,048 | 0,000 | 0 | 0 | 0 | 1,239 | 13,703 | 12,011 | 0,206 | 50 | 0,636 | 0,359 |
| FH 042_13 | 0,4% | 0,6 | 5,793 | 17,049 | 0,615 | 0 | 0 | 0 | 0,620 | 13,704 | 12,012 | 0,206 | 50 | 0,640 | 0,356 |
| FH 043_13 | 0,4% | 0,6 | 5,758 | 16,946 | 0 | 0,915 | 0 | 0 | 0,616 | 13,621 | 11,940 | 0,205 | 50 | 0,639 | 0,357 |
| FH 044_13 | 0,4% | 0,6 | 5,785 | 17,025 | 0 | 0 | 0 | 0,619 | 0,686 | 13,685 | 11,995 | 0,206 | 50 | 0,642 | 0,354 |

Fig. 39a/2

| | Zusammensetzung $Ca_{1-x}Sr_xAlSiN_3$:yEu bzw. $Sr(Sr_aCa_{1-a})Si_2Al_2N_6$:yEu (a=2x-1) | | Einwaage / g | | | | | | | | | | | Optische Charakterisierung | |
|---|---|---|---|---|---|---|---|---|---|---|---|---|---|---|---|
| Versuch | y | x | Ca3N2 | Sr3N2 | AlF3 | SrF2 | BaF2 | Li2B4O7 | LiBF4 | Si3N4 | AlN | Eu2O3 | Gesamt | CIE x | CIE y |
| FH 046_13 | 0,4% | 0,6 | 5,747 | 16,913 | 0 | 1,205 | 0 | 0,418 | 0 | 13,595 | 11,917 | 0,205 | 50 | 0,639 | 0,358 |
| FH 047_13 | 0,4% | 0,6 | 5,737 | 16,885 | 0 | 1,458 | 0 | 0,245 | 0 | 13,573 | 11,897 | 0,204 | 50 | 0,639 | 0,358 |
| FH 048_13 | 0,4% | 0,6 | 5,782 | 17,017 | 0 | 0 | 0 | 0,421 | 0,905 | 13,679 | 11,990 | 0,206 | 50 | 0,640 | 0,356 |
| FH 049_13 | 0,4% | 0,6 | 5,780 | 17,011 | 0 | 0 | 0 | 0,247 | 1,096 | 13,674 | 11,986 | 0,206 | 50 | 0,640 | 0,356 |
| FH 050_13 | 0,4% | 0,6 | 5,793 | 17,050 | 0,809 | 0 | 0 | 0,421 | 0 | 13,707 | 12,013 | 0,206 | 50 | 0,639 | 0,357 |
| FH 051_13 | 0,4% | 0,6 | 5,793 | 17,049 | 0,984 | 0 | 0 | 0,248 | 0 | 13,707 | 12,013 | 0,206 | 50 | 0,639 | 0,358 |
| FH 052_13 | 0,4% | 0,6 | 5,770 | 16,980 | 0,408 | 0,611 | 0 | 0,411 | 0 | 13,651 | 11,964 | 0,205 | 50 | 0,639 | 0,358 |
| FH 053_13 | 0,4% | 0,6 | 5,725 | 17,196 | 0,486 | 0,728 | 0 | 0,245 | 0 | 13,545 | 11,871 | 0,204 | 50 | 0,639 | 0,358 |
| FH 058_13 | 0,4% | 0,6 | 5,704 | 17,134 | 0,906 | 0,606 | 0 | 0,122 | 0 | 13,496 | 11,828 | 0,203 | 50 | 0,636 | 0,360 |
| FH 059_13 | 0,4% | 0,6 | 5,753 | 17,280 | 0,000 | 1,100 | 0 | 0,123 | 0 | 13,611 | 11,929 | 0,205 | 50 | 0,637 | 0,360 |
| FH 060_13 | 0,4% | 0,6 | 5,793 | 17,049 | 1,107 | 0,000 | 0 | 0,124 | 0 | 13,707 | 12,013 | 0,206 | 50 | 0,638 | 0,358 |
| FH 061_13 | 0,4% | 0,6 | 5,722 | 17,186 | 0,818 | 0,548 | 0 | 0,122 | 0 | 13,537 | 11,864 | 0,204 | 50 | 0,638 | 0,359 |
| FH 064_13 | 0,8% | 0,8 | 2,791 | 21,907 | 0,119 | 0 | 0 | 0 | 0 | 13,209 | 11,577 | 0,398 | 50 | 0,634 | 0,364 |
| FH 065_13 | 1,0% | 0,8 | 2,786 | 21,863 | 0,118 | 0 | 0 | 0 | 0 | 13,183 | 11,554 | 0,496 | 50 | 0,638 | 0,360 |
| FH 066_13 | 1,2% | 0,8 | 2,780 | 21,820 | 0,118 | 0 | 0 | 0 | 0 | 13,157 | 11,531 | 0,594 | 50 | 0,641 | 0,357 |
| FH 067_13 | 1,2% | 0,9 | 1,354 | 23,908 | 0,115 | 0 | 0 | 0 | 0 | 12,814 | 11,230 | 0,579 | 50 | 0,633 | 0,366 |
| FH 068_13 | 1,2% | 0,875 | 1,704 | 23,397 | 0,116 | 0 | 0 | 0 | 0 | 12,898 | 11,304 | 0,582 | 50 | 0,636 | 0,362 |
| FH 069_13 | 1,2% | 0,85 | 2,058 | 22,878 | 0,117 | 0 | 0 | 0 | 0 | 12,983 | 11,378 | 0,586 | 50 | 0,640 | 0,358 |
| FH 070_13 | 1,2% | 0,825 | 2,417 | 22,353 | 0,117 | 0 | 0 | 0 | 0 | 13,069 | 11,454 | 0,590 | 50 | 0,642 | 0,356 |
| FH 079_13 | 1,2% | 0,925 | 1,009 | 24,413 | 0,114 | 0 | 0 | 0 | 0 | 12,731 | 11,158 | 0,575 | 50 | 0,628 | 0,370 |
| FH 080_13 | 1,2% | 0,95 | 0,668 | 24,912 | 0,114 | 0 | 0 | 0 | 0 | 12,649 | 11,086 | 0,571 | 50 | 0,626 | 0,372 |
| FH 081_13 | 1,5% | 0,8 | 2,772 | 21,756 | 0,118 | 0 | 0 | 0 | 0 | 13,118 | 11,497 | 0,740 | 50 | 0,645 | 0,353 |
| FH 082_13 | 2,0% | 0,8 | 2,759 | 21,649 | 0,117 | 0 | 0 | 0 | 0 | 13,053 | 11,440 | 0,982 | 50 | 0,654 | 0,345 |
| TF 88/12 | 0,5% | 0,7 | 8,632 | 39,518 | 0,244 | 0 | 0 | 0 | 0 | 27,227 | 23,866 | 0,512 | 100 | 0,635 | 0,364 |
| TF 93/12 | 0,6% | 0,8 | 5,594 | 43,903 | 0,238 | 0 | 0 | 0 | 0 | 26,468 | 23,200 | 0,598 | 100 | 0,638 | 0,361 |
| TF 99/12 | 0,5% | 0,7 | 8,632 | 39,518 | 0,244 | 0 | 0 | 0 | 0 | 27,227 | 23,866 | 0,512 | 100 | 0,632 | 0,366 |

Fig. 39a/3

| | Zusammensetzung $Ca_{1-x}Sr_xAlSiN_3$:yEu bzw. $Sr(Sr_aCa_{1-a})Si_2Al_2N_6$:yEu (a=2x-1) | | Einwaage / g | | | | | | | | | | | Optische Charakterisierung | |
|---|---|---|---|---|---|---|---|---|---|---|---|---|---|---|---|
| Versuch | y | x | Ca3N2 | Sr3N2 | AlF3 | SrF2 | BaF2 | Li2B4O7 | LiBF4 | Si3N4 | AlN | Eu2O3 | Gesamt | CIE x | CIE y |
| TF 100/12 | 0,6% | 0,8 | 5,594 | 43,903 | 0,238 | 0 | 0 | 0 | 0 | 26,468 | 23,200 | 0,598 | 100 | 0,628 | 0,371 |
| TF 103/12 | 0,5% | 0,8 | 5,600 | 43,947 | 0,238 | 0 | 0 | 0 | 0 | 26,494 | 23,223 | 0,499 | 100 | 0,624 | 0,375 |
| TF 131/12 | 0,6% | 0,9 | 2,724 | 48,097 | 0,231 | 0 | 0 | 0 | 0 | 25,774 | 22,592 | 0,582 | 100 | 0,622 | 0,377 |
| TF 132/12 | 0,7% | 0,9 | 2,721 | 48,050 | 0,231 | 0 | 0 | 0 | 0 | 25,749 | 22,570 | 0,678 | 100 | 0,624 | 0,375 |
| TF 133/12 | 0,8% | 0,9 | 2,719 | 48,004 | 0,231 | 0 | 0 | 0 | 0 | 25,724 | 22,548 | 0,774 | 100 | 0,626 | 0,372 |
| TF 161/12 | 1,0% | 0,9 | 2,713 | 47,911 | 0,231 | 0 | 0 | 0 | 0 | 25,674 | 22,505 | 0,966 | 100 | 0,635 | 0,364 |
| TF 162/12 | 1,2% | 0,9 | 2,708 | 47,818 | 0,230 | 0 | 0 | 0 | 0 | 25,625 | 22,461 | 1,157 | 100 | 0,637 | 0,362 |
| TF 163/12 | 0,6% | 0,85 | 4,140 | 46,028 | 0,235 | 0 | 0 | 0 | 0 | 26,116 | 22,892 | 0,590 | 100 | 0,624 | 0,374 |
| TF 168/12 | 0,9% | 0,9 | 2,716 | 47,957 | 0,231 | 0 | 0 | 0 | 0 | 25,699 | 22,527 | 0,870 | 100 | 0,629 | 0,370 |
| TF 169/12 | 1,2% | 0,95 | 1,337 | 49,826 | 0,227 | 0 | 0 | 0 | 0 | 25,295 | 22,173 | 1,142 | 100 | 0,631 | 0,368 |

# Fig. 39b/1

| | Zusammensetzung $Ca_{1-x}Sr_xAlSiN_3{:}yEu$ bzw. $Sr(Sr_aCa_{1-a})Si_2Al_2N_6{:}yEu$ (a=2x-1) | | | | Einwaage / g | | | | | | | | | | | | | | | | | | | | | | Optische Charakterisierun | |
|---|---|---|---|---|---|---|---|---|---|---|---|---|---|---|---|---|---|---|---|---|---|---|---|---|---|---|---|---|
| Versuch | y | x | EA Anteil | Si:Al ratio | Ca3N2 | Sr3N2 | BaNx | AlF3 | SrF2 | BaF2 | Li2B4O7 | LiBF4 | LiF | Li3N | Mn2O3 | CuO | Zn3N2 | La2O3 | Si3N4 | Graphite | AlN | Eu2O3 | EuN | CeO2 | SiO2 | Gesamt | CIE x | CIE y |
| FH 005_13 | 0,6% | 0,8 | 1 | 1,0:0,975 | 2,746 | 21,552 | 0 | 0,875 | 0,436 | 0 | 0 | 0 | 0 | 0 | 0 | 0 | 0 | 0 | 12,993 | 0 | 11,104 | 0,293 | 0 | 0 | 0 | 50 | 0,632 | 0,365 |
| FH 006_13 | 0,6% | 0,8 | 1 | 1,0:0,975 | 2,730 | 21,428 | 0 | 0,290 | 1,301 | 0 | 0 | 0 | 0 | 0 | 0 | 0 | 0 | 0 | 12,918 | 0 | 11,040 | 0,292 | 0 | 0 | 0 | 50 | 0,632 | 0,365 |
| FH 007_13 | 0,6% | 0,8 | 1 | 1,0:0,975 | 2,728 | 21,416 | 0 | 0,232 | 1,387 | 0 | 0 | 0 | 0 | 0 | 0 | 0 | 0 | 0 | 12,911 | 0 | 11,034 | 0,292 | 0 | 0 | 0 | 50 | 0,634 | 0,364 |
| FH 008_13 | 0,6% | 0,8 | 1 | 1,0:0,975 | 2,748 | 21,564 | 0 | 0,934 | 0,349 | 0 | 0 | 0 | 0 | 0 | 0 | 0 | 0 | 0 | 13,000 | 0 | 11,111 | 0,294 | 0 | 0 | 0 | 50 | 0,632 | 0,365 |
| FH 009_13 | 0,6% | 0,8 | 1 | 1:1 | 2,738 | 21,492 | 0 | 1,163 | 0 | 0 | 0 | 0 | 0 | 0 | 0 | 0 | 0 | 0 | 12,957 | 0 | 11,357 | 0,293 | 0 | 0 | 0 | 50 | 0,631 | 0,366 |
| FH 010_13 | 0,6% | 0,8 | 1 | 1:1 | 2,646 | 20,769 | 0 | 1,124 | 1,682 | 0 | 0 | 0 | 0 | 0 | 0 | 0 | 0 | 0 | 12,521 | 0 | 10,975 | 0,283 | 0 | 0 | 0 | 50 | 0,631 | 0,366 |
| FH 011_13 | 0,6% | 0,8 | 1 | 1:1 | 2,574 | 20,202 | 0 | 1,641 | 2,454 | 0 | 0 | 0 | 0 | 0 | 0 | 0 | 0 | 0 | 12,179 | 0 | 10,676 | 0,275 | 0 | 0 | 0 | 50 | 0,633 | 0,364 |
| FH 012_13 | 0,6% | 0,8 | 1 | 1:1 | 2,506 | 19,665 | 0 | 2,129 | 3,185 | 0 | 0 | 0 | 0 | 0 | 0 | 0 | 0 | 0 | 11,855 | 0 | 10,392 | 0,268 | 0 | 0 | 0 | 50 | 0,632 | 0,364 |
| FH 013_13 | 0,6% | 0,8 | 1 | 1:1 | 2,731 | 21,434 | 0 | 0 | 0 | 0 | 0 | 1,295 | 0 | 0 | 0 | 0 | 0 | 0 | 12,922 | 0 | 11,326 | 0,292 | 0 | 0 | 0 | 50 | 0,635 | 0,363 |
| FH 014_13 | 0,6% | 0,8 | 1 | 1:1 | 2,735 | 21,463 | 0 | 0,581 | 0 | 0 | 0 | 0,648 | 0 | 0 | 0 | 0 | 0 | 0 | 12,939 | 0 | 11,342 | 0,292 | 0 | 0 | 0 | 50 | 0,633 | 0,364 |
| FH 015_13 | 0,6% | 0,8 | 1 | 1:1 | 2,719 | 21,340 | 0 | 0,000 | 0,864 | 0 | 0 | 0,645 | 0 | 0 | 0 | 0 | 0 | 0 | 12,865 | 0 | 11,277 | 0,290 | 0 | 0 | 0 | 50 | 0,634 | 0,364 |
| FH 016_13 | 0,6% | 0,8 | 1 | 1:1 | 2,725 | 21,389 | 0 | 0,387 | 0,578 | 0 | 0 | 0,432 | 0 | 0 | 0 | 0 | 0 | 0 | 12,895 | 0 | 11,303 | 0,291 | 0 | 0 | 0 | 50 | 0,633 | 0,364 |
| FH 029_13 | 0,6% | 0,8 | 1 | 1:1 | 2,671 | 20,961 | 0 | 0 | 0 | 2,369 | 0 | 0 | 0 | 0 | 0 | 0 | 0 | 0 | 12,637 | 0 | 11,077 | 0,285 | 0 | 0 | 0 | 50 | 0,633 | 0,364 |
| FH 030_13 | 0,6% | 0,8 | 1 | 1:1 | 2,704 | 21,223 | 0 | 0,574 | 0 | 1,199 | 0 | 0 | 0 | 0 | 0 | 0 | 0 | 0 | 12,795 | 0 | 11,215 | 0,289 | 0 | 0 | 0 | 50 | 0,631 | 0,366 |
| FH 031_13 | 0,6% | 0,8 | 1 | 1:1 | 2,689 | 21,103 | 0 | 0,000 | 0,854 | 1,193 | 0 | 0 | 0 | 0 | 0 | 0 | 0 | 0 | 12,722 | 0 | 11,152 | 0,287 | 0 | 0 | 0 | 50 | 0,630 | 0,367 |
| FH 032_13 | 0,6% | 0,8 | 1 | 1:1 | 2,701 | 21,195 | 0 | 0,000 | 0 | 1,198 | 0 | 0,640 | 0 | 0 | 0 | 0 | 0 | 0 | 12,778 | 0 | 11,200 | 0,289 | 0 | 0 | 0 | 50 | 0,636 | 0,361 |
| FH 037_13 | 0,4% | 0,6 | 1 | 1:1 | 5,741 | 16,896 | 0 | 0,305 | 1,368 | 0 | 0 | 0 | 0 | 0 | 0 | 0 | 0 | 0 | 13,581 | 0 | 11,905 | 0,204 | 0 | 0 | 0 | 50 | 0,636 | 0,360 |
| FH 038_13 | 0,4% | 0,6 | 1 | 1:1 | 5,738 | 16,886 | 0 | 0,244 | 1,458 | 0 | 0 | 0 | 0 | 0 | 0 | 0 | 0 | 0 | 13,573 | 0 | 11,897 | 0,204 | 0 | 0 | 0 | 50 | 0,635 | 0,361 |
| FH 039_13 | 0,4% | 0,6 | 1 | 1:1 | 5,776 | 16,999 | 0 | 0,920 | 0,459 | 0 | 0 | 0 | 0 | 0 | 0 | 0 | 0 | 0 | 13,664 | 0 | 11,977 | 0,206 | 0 | 0 | 0 | 50 | 0,637 | 0,359 |
| FH 040_13 | 0,4% | 0,6 | 1 | 1:1 | 5,779 | 17,009 | 0 | 0,982 | 0,367 | 0 | 0 | 0 | 0 | 0 | 0 | 0 | 0 | 0 | 13,672 | 0 | 11,984 | 0,206 | 0 | 0 | 0 | 50 | 0,638 | 0,358 |
| FH 041_13 | 0,4% | 0,6 | 1 | 1:1 | 5,793 | 17,048 | 0 | 0,000 | 0 | 0 | 0 | 1,239 | 0 | 0 | 0 | 0 | 0 | 0 | 13,703 | 0 | 12,011 | 0,206 | 0 | 0 | 0 | 50 | 0,636 | 0,359 |
| FH 042_13 | 0,4% | 0,6 | 1 | 1:1 | 5,793 | 17,049 | 0 | 0,615 | 0 | 0 | 0 | 0,620 | 0 | 0 | 0 | 0 | 0 | 0 | 13,704 | 0 | 12,012 | 0,206 | 0 | 0 | 0 | 50 | 0,640 | 0,356 |
| FH 043_13 | 0,4% | 0,6 | 1 | 1:1 | 5,758 | 16,946 | 0 | 0 | 0,915 | 0 | 0 | 0,616 | 0 | 0 | 0 | 0 | 0 | 0 | 13,621 | 0 | 11,940 | 0,205 | 0 | 0 | 0 | 50 | 0,639 | 0,357 |
| FH 044_13 | 0,4% | 0,6 | 1 | 1:1 | 5,785 | 17,025 | 0 | 0 | 0 | 0 | 0,619 | 0,686 | 0 | 0 | 0 | 0 | 0 | 0 | 13,685 | 0 | 11,995 | 0,206 | 0 | 0 | 0 | 50 | 0,642 | 0,354 |
| FH 046_13 | 0,4% | 0,6 | 1 | 1:1 | 5,747 | 16,913 | 0 | 0 | 1,205 | 0 | 0,418 | 0 | 0 | 0 | 0 | 0 | 0 | 0 | 13,595 | 0 | 11,917 | 0,205 | 0 | 0 | 0 | 50 | 0,639 | 0,358 |
| FH 047_13 | 0,4% | 0,6 | 1 | 1:1 | 5,737 | 16,885 | 0 | 0 | 1,458 | 0 | 0,245 | 0 | 0 | 0 | 0 | 0 | 0 | 0 | 13,573 | 0 | 11,897 | 0,204 | 0 | 0 | 0 | 50 | 0,639 | 0,358 |
| FH 048_13 | 0,4% | 0,6 | 1 | 1:1 | 5,782 | 17,017 | 0 | 0 | 0 | 0 | 0,421 | 0,905 | 0 | 0 | 0 | 0 | 0 | 0 | 13,679 | 0 | 11,990 | 0,206 | 0 | 0 | 0 | 50 | 0,640 | 0,356 |
| FH 049_13 | 0,4% | 0,6 | 1 | 1:1 | 5,780 | 17,011 | 0 | 0 | 0 | 0 | 0,247 | 1,096 | 0 | 0 | 0 | 0 | 0 | 0 | 13,674 | 0 | 11,986 | 0,206 | 0 | 0 | 0 | 50 | 0,640 | 0,356 |
| FH 050_13 | 0,4% | 0,6 | 1 | 1:1 | 5,793 | 17,050 | 0 | 0,809 | 0 | 0 | 0,421 | 0 | 0 | 0 | 0 | 0 | 0 | 0 | 13,707 | 0 | 12,013 | 0,206 | 0 | 0 | 0 | 50 | 0,639 | 0,357 |
| FH 051_13 | 0,4% | 0,6 | 1 | 1:1 | 5,793 | 17,049 | 0 | 0,984 | 0 | 0 | 0,248 | 0 | 0 | 0 | 0 | 0 | 0 | 0 | 13,707 | 0 | 12,013 | 0,206 | 0 | 0 | 0 | 50 | 0,639 | 0,358 |
| FH 052_13 | 0,4% | 0,6 | 1 | 1:1 | 5,770 | 16,980 | 0 | 0,408 | 0,611 | 0 | 0,411 | 0 | 0 | 0 | 0 | 0 | 0 | 0 | 13,651 | 0 | 11,964 | 0,205 | 0 | 0 | 0 | 50 | 0,639 | 0,358 |
| FH 053_13 | 0,4% | 0,6 | 1 | 1:1 | 5,725 | 17,196 | 0 | 0,486 | 0,728 | 0 | 0,245 | 0 | 0 | 0 | 0 | 0 | 0 | 0 | 13,545 | 0 | 11,871 | 0,204 | 0 | 0 | 0 | 50 | 0,639 | 0,358 |
| FH 058_13 | 0,4% | 0,6 | 1 | 1:1 | 5,704 | 17,134 | 0 | 0,906 | 0,606 | 0 | 0,122 | 0 | 0 | 0 | 0 | 0 | 0 | 0 | 13,496 | 0 | 11,828 | 0,203 | 0 | 0 | 0 | 50 | 0,636 | 0,360 |
| FH 059_13 | 0,4% | 0,6 | 1 | 1:1 | 5,753 | 17,280 | 0 | 0,000 | 1,100 | 0 | 0,123 | 0 | 0 | 0 | 0 | 0 | 0 | 0 | 13,611 | 0 | 11,929 | 0,205 | 0 | 0 | 0 | 50 | 0,637 | 0,360 |
| FH 060_13 | 0,4% | 0,6 | 1 | 1:1 | 5,793 | 17,049 | 0 | 1,107 | 0,000 | 0 | 0,124 | 0 | 0 | 0 | 0 | 0 | 0 | 0 | 13,707 | 0 | 12,013 | 0,206 | 0 | 0 | 0 | 50 | 0,638 | 0,358 |
| FH 061_13 | 0,4% | 0,6 | 1 | 1:1 | 5,722 | 17,186 | 0 | 0,818 | 0,548 | 0 | 0,122 | 0 | 0 | 0 | 0 | 0 | 0 | 0 | 13,537 | 0 | 11,864 | 0,204 | 0 | 0 | 0 | 50 | 0,638 | 0,359 |
| FH 064_13 | 0,8% | 0,8 | 1 | 1:1 | 2,791 | 21,907 | 0 | 0,119 | 0 | 0 | 0 | 0 | 0 | 0 | 0 | 0 | 0 | 0 | 13,209 | 0 | 11,577 | 0,398 | 0 | 0 | 0 | 50 | 0,634 | 0,364 |
| FH 065_13 | 1,0% | 0,8 | 1 | 1:1 | 2,786 | 21,863 | 0 | 0,118 | 0 | 0 | 0 | 0 | 0 | 0 | 0 | 0 | 0 | 0 | 13,183 | 0 | 11,554 | 0,496 | 0 | 0 | 0 | 50 | 0,638 | 0,360 |
| FH 066_13 | 1,2% | 0,8 | 1 | 1:1 | 2,780 | 21,820 | 0 | 0,118 | 0 | 0 | 0 | 0 | 0 | 0 | 0 | 0 | 0 | 0 | 13,157 | 0 | 11,531 | 0,594 | 0 | 0 | 0 | 50 | 0,641 | 0,357 |
| FH 067_13 | 1,2% | 0,9 | 1 | 1:1 | 1,354 | 23,908 | 0 | 0,115 | 0 | 0 | 0 | 0 | 0 | 0 | 0 | 0 | 0 | 0 | 12,814 | 0 | 11,230 | 0,579 | 0 | 0 | 0 | 50 | 0,633 | 0,366 |
| FH 068_13 | 1,2% | 0,875 | 1 | 1:1 | 1,704 | 23,397 | 0 | 0,116 | 0 | 0 | 0 | 0 | 0 | 0 | 0 | 0 | 0 | 0 | 12,898 | 0 | 11,304 | 0,582 | 0 | 0 | 0 | 50 | 0,636 | 0,362 |
| FH 069_13 | 1,2% | 0,85 | 1 | 1:1 | 2,058 | 22,878 | 0 | 0,117 | 0 | 0 | 0 | 0 | 0 | 0 | 0 | 0 | 0 | 0 | 12,983 | 0 | 11,378 | 0,586 | 0 | 0 | 0 | 50 | 0,640 | 0,358 |
| FH 070_13 | 1,2% | 0,825 | 1 | 1:1 | 2,417 | 22,353 | 0 | 0,117 | 0 | 0 | 0 | 0 | 0 | 0 | 0 | 0 | 0 | 0 | 13,069 | 0 | 11,454 | 0,590 | 0 | 0 | 0 | 50 | 0,642 | 0,356 |
| FH 079_13 | 1,2% | 0,925 | 1 | 1:1 | 1,009 | 24,413 | 0 | 0,114 | 0 | 0 | 0 | 0 | 0 | 0 | 0 | 0 | 0 | 0 | 12,731 | 0 | 11,158 | 0,575 | 0 | 0 | 0 | 50 | 0,628 | 0,370 |
| FH 080_13 | 1,2% | 0,95 | 1 | 1:1 | 0,668 | 24,912 | 0 | 0,114 | 0 | 0 | 0 | 0 | 0 | 0 | 0 | 0 | 0 | 0 | 12,649 | 0 | 11,086 | 0,571 | 0 | 0 | 0 | 50 | 0,626 | 0,372 |
| FH 081_13 | 1,5% | 0,8 | 1 | 1:1 | 2,772 | 21,756 | 0 | 0,118 | 0 | 0 | 0 | 0 | 0 | 0 | 0 | 0 | 0 | 0 | 13,118 | 0 | 11,497 | 0,740 | 0 | 0 | 0 | 50 | 0,645 | 0,353 |
| FH 082_13 | 2,0% | 0,8 | 1 | 1:1 | 2,759 | 21,649 | 0 | 0,117 | 0 | 0 | 0 | 0 | 0 | 0 | 0 | 0 | 0 | 0 | 13,053 | 0 | 11,440 | 0,982 | 0 | 0 | 0 | 50 | 0,654 | 0,345 |
| TF 88/12 | 0,5% | 0,7 | 1 | 1:1 | 8,632 | 39,518 | 0 | 0,244 | 0 | 0 | 0 | 0 | 0 | 0 | 0 | 0 | 0 | 0 | 27,227 | 0 | 23,866 | 0,512 | 0 | 0 | 0 | 100 | 0,635 | 0,364 |
| TF 93/12 | 0,6% | 0,8 | 1 | 1:1 | 5,594 | 43,903 | 0 | 0,238 | 0 | 0 | 0 | 0 | 0 | 0 | 0 | 0 | 0 | 0 | 26,468 | 0 | 23,200 | 0,598 | 0 | 0 | 0 | 100 | 0,638 | 0,361 |
| TF 99/12 | 0,5% | 0,7 | 1 | 1:1 | 8,632 | 39,518 | 0 | 0,244 | 0 | 0 | 0 | 0 | 0 | 0 | 0 | 0 | 0 | 0 | 27,227 | 0 | 23,866 | 0,512 | 0 | 0 | 0 | 100 | 0,632 | 0,366 |
| TF 100/12 | 0,6% | 0,8 | 1 | 1:1 | 5,594 | 43,903 | 0 | 0,238 | 0 | 0 | 0 | 0 | 0 | 0 | 0 | 0 | 0 | 0 | 26,468 | 0 | 23,200 | 0,598 | 0 | 0 | 0 | 100 | 0,628 | 0,371 |
| TF 103/12 | 0,5% | 0,8 | 1 | 1:1 | 5,600 | 43,947 | 0 | 0,238 | 0 | 0 | 0 | 0 | 0 | 0 | 0 | 0 | 0 | 0 | 26,494 | 0 | 23,223 | 0,499 | 0 | 0 | 0 | 100 | 0,624 | 0,375 |
| TF 131/12 | 0,6% | 0,9 | 1 | 1:1 | 2,724 | 48,097 | 0 | 0,231 | 0 | 0 | 0 | 0 | 0 | 0 | 0 | 0 | 0 | 0 | 25,774 | 0 | 22,592 | 0,582 | 0 | 0 | 0 | 100 | 0,622 | 0,377 |
| TF 132/12 | 0,7% | 0,9 | 1 | 1:1 | 2,721 | 48,050 | 0 | 0,231 | 0 | 0 | 0 | 0 | 0 | 0 | 0 | 0 | 0 | 0 | 25,749 | 0 | 22,570 | 0,678 | 0 | 0 | 0 | 100 | 0,624 | 0,375 |
| TF 133/12 | 0,8% | 0,9 | 1 | 1:1 | 2,719 | 48,004 | 0 | 0,231 | 0 | 0 | 0 | 0 | 0 | 0 | 0 | 0 | 0 | 0 | 25,724 | 0 | 22,548 | 0,774 | 0 | 0 | 0 | 100 | 0,626 | 0,372 |
| TF 161/12 | 1,0% | 0,9 | 1 | 1:1 | 2,713 | 47,911 | 0 | 0,231 | 0 | 0 | 0 | 0 | 0 | 0 | 0 | 0 | 0 | 0 | 25,674 | 0 | 22,505 | 0,966 | 0 | 0 | 0 | 100 | 0,635 | 0,364 |
| TF 162/12 | 1,2% | 0,9 | 1 | 1:1 | 2,708 | 47,818 | 0 | 0,230 | 0 | 0 | 0 | 0 | 0 | 0 | 0 | 0 | 0 | 0 | 25,625 | 0 | 22,461 | 1,157 | 0 | 0 | 0 | 100 | 0,637 | 0,362 |
| TF 163/12 | 0,6% | 0,85 | 1 | 1:1 | 4,140 | 46,028 | 0 | 0,235 | 0 | 0 | 0 | 0 | 0 | 0 | 0 | 0 | 0 | 0 | 26,116 | 0 | 22,892 | 0,590 | 0 | 0 | 0 | 100 | 0,624 | 0,374 |
| TF 168/12 | 0,9% | 0,9 | 1 | 1:1 | 2,716 | 47,957 | 0 | 0,231 | 0 | 0 | 0 | 0 | 0 | 0 | 0 | 0 | 0 | 0 | 25,699 | 0 | 22,527 | 0,870 | 0 | 0 | 0 | 100 | 0,629 | 0,370 |
| TF 169/12 | 1,2% | 0,95 | 1 | 1:1 | 1,337 | 49,826 | 0 | 0,227 | 0 | 0 | 0 | 0 | 0 | 0 | 0 | 0 | 0 | 0 | 25,295 | 0 | 22,173 | 1,142 | 0 | 0 | 0 | 100 | 0,631 | 0,368 |

# Fig. 39b/2

| | Zusammensetzung $Ca_{1-x}Sr_xAlSiN_3$:yEu bzw. $Sr(Sr_aCa_{1-a})Si_2Al_2N_6$:yEu (a=2x-1) | | | | Einwaage / g | | | | | | | | | | | | | | | | | | | | | | Optische Charakterisierung | |
|---|---|---|---|---|---|---|---|---|---|---|---|---|---|---|---|---|---|---|---|---|---|---|---|---|---|---|---|---|
| Versuch | y | x | EA Anteil | Si:Al ratio | Ca3N2 | Sr3N2 | BaNx | AlF3 | SrF2 | BaF2 | Li2B4O7 | LiBF4 | LiF | Li3N | Mn2O3 | CuO | Zn3N2 | La2O3 | Si3N4 | Graphite | AlN | Eu2O3 | EuN | CeO2 | SiO2 | Gesamt | CIE x | CIE y |
| FH 086_13 | 1,2% | 0,9 | 1 | 1:1 | 4,062 | 71,725 | 0 | 0,345 | 0 | 0 | 0 | 0 | 0 | 0 | 0 | 0 | 0 | 0 | 38,442 | 0 | 33,691 | 1,736 | 0 | 0 | 0 | 150 | 0,634 | 0,364 |
| FH 095_13 | 1,2% | 0,9 | 1 | 1:1 | 1,311 | 23,146 | 0 | 0,111 | 0 | 0 | 0 | 0 | 0 | 0 | 0 | 0 | 0 | 0 | 12,406 | 0 | 10,872 | 0,560 | 0 | 0 | 1,593 | 50 | 0,635 | 0,363 |
| FH 096_13 | 1,2% | 0,9 | 1 | 1:1 | 1,354 | 23,908 | 0 | 0,115 | 0 | 0 | 0 | 0 | 0 | 0 | 0 | 0 | 0 | 0 | 12,814 | 0 | 11,230 | 0,579 | 0 | 0 | 0 | 50 | 0,637 | 0,361 |
| FH 097_13 | 1,2% | 0,9 | 1 | 1:1 | 1,354 | 23,908 | 0 | 0,115 | 0 | 0 | 0 | 0 | 0 | 0 | 0 | 0 | 0 | 0 | 12,814 | 0 | 11,230 | 0,579 | 0 | 0 | 0 | 50 | 0,635 | 0,363 |
| FH 098_13 | 1,2% | 0,9 | 1 | 1:1 | 1,354 | 23,908 | 0 | 0,115 | 0 | 0 | 0 | 0 | 0 | 0 | 0 | 0 | 0 | 0 | 12,814 | 0 | 11,230 | 0,579 | 0 | 0 | 0 | 50 | 0,639 | 0,359 |
| FH 099_13 | 1,2% | 0,9 | 1 | 1:1 | 1,325 | 23,391 | 0 | 0 | 0 | 0 | 0,567 | 0,628 | 0 | 0 | 0 | 0 | 0 | 0 | 12,537 | 0 | 10,987 | 0,,566 | 0 | 0 | 0 | 50 | 0,638 | 0,359 |
| FH 100_13 | 1,2% | 0,9 | 1 | 1:1 | 1,354 | 29,905 | 0 | 0 | 0 | 0 | 0,058 | 0,064 | 0 | 0 | 0 | 0 | 0 | 0 | 12,812 | 0 | 11,229 | 0,578 | 0 | 0 | 0 | 50 | 0,637 | 0,362 |
| FH 101_13 | 1,2% | 0,9 | 1 | 1:1 | 1,354 | 23,902 | 0 | 0 | 0 | 0 | 0 | 0,128 | 0 | 0 | 0 | 0 | 0 | 0 | 12,810 | 0 | 11,227 | 0,578 | 0 | 0 | 0 | 50 | 0,636 | 0,362 |
| FH 102_13 | 1,2% | 0,9 | 1 | 1:1 | 1,354 | 23,908 | 0 | 0 | 0 | 0 | 0,116 | 0 | 0 | 0 | 0 | 0 | 0 | 0 | 12,814 | 0 | 11,230 | 0,579 | 0 | 0 | 0 | 50 | 0,634 | 0,364 |
| FH 105_13 | 1,2% | 0,9 | 1 | 1:1 | 4,061 | 71,706 | 0 | 0 | 0 | 0 | 0 | 0,385 | 0 | 0 | 0 | 0 | 0 | 0 | 38,431 | 0 | 33,682 | 1,735 | 0 | 0 | 0 | 150 | 0,636 | 0,363 |
| Thi 800_13 | 1,2% | 0,99 | 1,1 | 1:1 | 1,417 | 25,028 | 0 | 0 | 0 | 0 | 0 | 0,122 | 0 | 0 | 0 | 0 | 0 | 0 | 12,194 | 0 | 10,687 | 0,551 | 0 | 0 | 0 | 50 | 0,634 | 0,365 |
| Thi 801_13 | 1,2% | 0,9 | 1 | 1:1 | 1,354 | 23,902 | 0 | 0 | 0 | 0 | 0 | 0,128 | 0 | 0 | 0 | 0 | 0 | 0 | 12,810 | 0 | 11,227 | 0,578 | 0 | 0 | 0 | 50 | 0,637 | 0,362 |
| Thi 802_13 | 1,2% | 0,9 | 1 | 1,1:0,9 | 1,349 | 23,826 | 0 | 0 | 0 | 0 | 0 | 0,128 | 0 | 0 | 0 | 0 | 0 | 0 | 14,047 | 0 | 10,073 | 0,577 | 0 | 0 | 0 | 50 | 0,639 | 0,360 |
| Thi 803_13 | 1,2% | 0,81 | 0,9 | 0,9:1,1 | 1,287 | 22,732 | 0 | 0 | 0 | 0 | 0 | 0,136 | 0 | 0 | 0 | 0 | 0 | 0 | 12,183 | 0 | 13,051 | 0,611 | 0 | 0 | 0 | 50 | 0,636 | 0,362 |
| Thi 804_13 | 1,2% | 0,945 | 1,05 | 0,9:1,1 | 1,391 | 24,555 | 0 | 0 | 0 | 0 | 0 | 0,126 | 0 | 0 | 0 | 0 | 0 | 0 | 11,280 | 0 | 12,083 | 0,566 | 0 | 0 | 0 | 50 | 0,633 | 0,365 |
| Thi 805_13 | 1,2% | 0,855 | 0,95 | 0,95:1,05 | 1,321 | 23,333 | 0 | 0 | 0 | 0 | 0 | 0,132 | 0 | 0 | 0 | 0 | 0 | 0 | 12,506 | 0 | 12,114 | 0,594 | 0 | 0 | 0 | 50 | 0,637 | 0,361 |
| Thi 806_13 | 1,2% | 0,945 | 1,05 | 1,05:0,95 | 1,384 | 24,411 | 0 | 0 | 0 | 0 | 0 | 0,125 | 0 | 0 | 0 | 0 | 0 | 0 | 13,099 | 0 | 10,387 | 0,563 | 0 | 0 | 0 | 50 | 0,640 | 0,359 |
| Thi 807_13 | 1,2% | 0,81 | 0,9 | 1,1:0.9 | 1,279 | 22,581 | 0 | 0 | 0 | 0 | 0 | 0,135 | 0 | 0 | 0 | 0 | 0 | 0 | 14,792 | 0 | 10,601 | 0,607 | 0 | 0 | 0 | 50 | 0,640 | 0,358 |
| TF 808_13 | 1,2% | 0,855 | 0,95 | 1:1 | 1,319 | 23,295 | 0 | 0 | 0 | 0 | 0 | 0,132 | 0 | 0 | 0 | 0 | 0 | 0 | 13,142 | 0 | 11,518 | 0,593 | 0 | 0 | 0 | 50 | 0,637 | 0,362 |
| TF 809_13 | 1,2% | 0,99 | 1,1 | 0,9:1,1 | 1,422 | 25,104 | 0 | 0 | 0 | 0 | 0 | 0,123 | 0 | 0 | 0 | 0 | 0 | 0 | 11,008 | 0 | 11,792 | 0,552 | 0 | 0 | 0 | 50 | 0,637 | 0,361 |
| TF 810_13 | 1,2% | 0,99 | 1,1 | 1,1:0,9 | 1,413 | 24,953 | 0 | 0 | 0 | 0 | 0 | 0,122 | 0 | 0 | 0 | 0 | 0 | 0 | 13,374 | 0 | 9,590 | 0,549 | 0 | 0 | 0 | 50 | 0,637 | 0,362 |
| TF 811_13 | 1,2% | 0,855 | 0,95 | 1,05:0.95 | 1,317 | 23,257 | 0 | 0 | 0 | 0 | 0 | 0,132 | 0 | 0 | 0 | 0 | 0 | 0 | 13,777 | 0 | 10,925 | 0,592 | 0 | 0 | 0 | 50 | 0,637 | 0,361 |
| TF 812_13 | 1,2% | 0,99 | 1,1 | 0,95:1,05 | 1,420 | 25,066 | 0 | 0 | 0 | 0 | 0 | 0,122 | 0 | 0 | 0 | 0 | 0 | 0 | 11,602 | 0 | 11,239 | 0,551 | 0 | 0 | 0 | 50 | 0,635 | 0,364 |
| TF 813_13 | 1,2% | 0,99 | 1,1 | 1,05:0.95 | 1,415 | 24,990 | 0 | 0 | 0 | 0 | 0 | 0,122 | 0 | 0 | 0 | 0 | 0 | 0 | 12,785 | 0 | 10,138 | 0,550 | 0 | 0 | 0 | 50 | 0,636 | 0,363 |
| TF 814_13 | 1,2% | 0,9 | 1,0 | 0,9:1,1 | 1,358 | 23,978 | 0 | 0 | 0 | 0 | 0 | 0,129 | 0 | 0 | 0 | 0 | 0 | 0 | 11,566 | 0 | 12,389 | 0,580 | 0 | 0 | 0 | 50 | 0,637 | 0,361 |
| TF 815_13 | 1,2% | 0,945 | 1,1 | 0,95:1,05 | 1,388 | 24,517 | 0 | 0 | 0 | 0 | 0 | 0,125 | 0 | 0 | 0 | 0 | 0 | 0 | 11,888 | 0 | 11,516 | 0,565 | 0 | 0 | 0 | 50 | 0,634 | 0,364 |
| Thi 816_13 | 1,2% | 0,81 | 0,9 | 0,95:1,05 | 1,285 | 22,694 | 0 | 0 | 0 | 0 | 0 | 0,135 | 0 | 0 | 0 | 0 | 0 | 0 | 12,839 | 0 | 12,437 | 0,610 | 0 | 0 | 0 | 50 | 0,636 | 0,362 |
| Thi 817_13 | 1,2% | 0,945 | 1,1 | 1:1 | 1,386 | 24,479 | 0 | 0 | 0 | 0 | 0 | 0,125 | 0 | 0 | 0 | 0 | 0 | 0 | 12,495 | 0 | 10,951 | 0,564 | 0 | 0 | 0 | 50 | 0,634 | 0,364 |
| Thi 818_13 | 1,2% | 0,81 | 0,9 | 1,05:0.95 | 1,281 | 22,618 | 0 | 0 | 0 | 0 | 0 | 0,135 | 0 | 0 | 0 | 0 | 0 | 0 | 14,143 | 0 | 11,215 | 0,608 | 0 | 0 | 0 | 50 | 0,640 | 0,358 |
| Thi 819_13 | 1,2% | 0,855 | 1,0 | 0,9:1,1 | 1,324 | 23,371 | 0 | 0 | 0 | 0 | 0 | 0,132 | 0 | 0 | 0 | 0 | 0 | 0 | 11,867 | 0 | 12,711 | 0,595 | 0 | 0 | 0 | 50 | 0,635 | 0,364 |
| Thi 820_13 | 1,2% | 0,945 | 1,1 | 1,1:0,9 | 1,382 | 24,403 | 0 | 0 | 0 | 0 | 0 | 0,125 | 0 | 0 | 0 | 0 | 0 | 0 | 13,702 | 0 | 9,825 | 0,562 | 0 | 0 | 0 | 50 | 0,642 | 0,356 |
| Thi 821_13 | 1,2% | 0,81 | 0,9 | 1:1 | 1,283 | 22,656 | 0 | 0 | 0 | 0 | 0 | 0,135 | 0 | 0 | 0 | 0 | 0 | 0 | 13,492 | 0 | 11,825 | 0,609 | 0 | 0 | 0 | 50 | 0,638 | 0,360 |
| Thi 822_13 | 1,2% | 0,9 | 1,0 | 0,95:1,05 | 1,356 | 23,940 | 0 | 0 | 0 | 0 | 0 | 0,129 | 0 | 0 | 0 | 0 | 0 | 0 | 12,189 | 0 | 11,807 | 0,579 | 0 | 0 | 0 | 50 | 0,634 | 0,364 |
| Thi 823_13 | 1,2% | 0,855 | 1,0 | 1,1:0,9 | 1,315 | 23,220 | 0 | 0 | 0 | 0 | 0 | 0,131 | 0 | 0 | 0 | 0 | 0 | 0 | 14,410 | 0 | 10,333 | 0,591 | 0 | 0 | 0 | 50 | 0,638 | 0,360 |
| Thi 824_13 | 1,2% | 0,9 | 1,0 | 1,05:0.95 | 1,351 | 23,864 | 0 | 0 | 0 | 0 | 0 | 0,128 | 0 | 0 | 0 | 0 | 0 | 0 | 13,430 | 0 | 10,649 | 0,577 | 0 | 0 | 0 | 50 | 0,637 | 0,362 |
| Thi 825_13 | 1,2% | 0,855 | 1,0 | 0,95:1,05 | 1,321 | 23,333 | 0 | 0 | 0 | 0 | 0 | 0,132 | 0 | 0 | 0 | 0 | 0 | 0 | 12,506 | 0 | 12,114 | 0,594 | 0 | 0 | 0 | 50 | 0,635 | 0,363 |
| TF 826_13 | 1,2% | 0,945 | 1,1 | 1,05:0.95 | 1,384 | 24,441 | 0 | 0 | 0 | 0 | 0 | 0,125 | 0 | 0 | 0 | 0 | 0 | 0 | 13,099 | 0 | 10,387 | 0,563 | 0 | 0 | 0 | 50 | 0,635 | 0,363 |
| TF 827_13 | 1,2% | 0,81 | 0,9 | 1,1:0,9 | 1,279 | 22,581 | 0 | 0 | 0 | 0 | 0 | 0,135 | 0 | 0 | 0 | 0 | 0 | 0 | 14,792 | 0 | 10,607 | 0,607 | 0 | 0 | 0 | 50 | 0,638 | 0,360 |
| Thi 828_13 | 1,2% | 0,9 | 1,0 | 1:1 | 1,354 | 23,902 | 0 | 0 | 0 | 0 | 0 | 0,128 | 0 | 0 | 0 | 0 | 0 | 0 | 12,810 | 0 | 11,227 | 0,578 | 0 | 0 | 0 | 50 | 0,638 | 0,361 |
| Thi 829_13 | 1,5% | 0,9 | 1,0 | 1:1 | 1,350 | 23,833 | 0 | 0 | 0 | 0 | 0 | 0,128 | 0 | 0 | 0 | 0 | 0 | 0 | 12,774 | 0 | 11,195 | 0,721 | 0 | 0 | 0 | 50 | 0,641 | 0,357 |
| Thi 830_13 | 1,7% | 0,9 | 1,0 | 1:1 | 1,347 | 23,787 | 0 | 0 | 0 | 0 | 0 | 0,128 | 0 | 0 | 0 | 0 | 0 | 0 | 12,749 | 0 | 11,173 | 0,815 | 0 | 0 | 0 | 50 | 0,642 | 0,356 |
| Thi 831_13 | 2,0% | 0,9 | 1,0 | 1:1 | 1,343 | 23,720 | 0 | 0 | 0 | 0 | 0 | 0,127 | 0 | 0 | 0 | 0 | 0 | 0 | 12,712 | 0 | 11,141 | 0,957 | 0 | 0 | 0 | 50 | 0,648 | 0,351 |
| TF 832_13 | 1,2% | 0,855 | 1,0 | 0,95:1,05 | 3,964 | 69,999 | 0 | 0 | 0 | 0 | 0 | 0,396 | 0 | 0 | 0 | 0 | 0 | 0 | 37,517 | 0 | 36,341 | 1,783 | 0 | 0 | 0 | 150 | -- | -- |
| TF 833_13 | 1,2% | 0,81 | 0,9 | 0,95:1,05 | 3,856 | 68,082 | 0 | 0 | 0 | 0 | 0 | 0,406 | 0 | 0 | 0 | 0 | 0 | 0 | 38,516 | 0 | 37,310 | 1,830 | 0 | 0 | 0 | 150 | 0,640 | 0,359 |
| TF 834_13 | 1,2% | 0,855 | 1,0 | 0,95:1,05 | 3,964 | 69,999 | 0 | 0 | 0 | 0 | 0 | 0,396 | 0 | 0 | 0 | 0 | 0 | 0 | 37,517 | 0 | 36,341 | 1,783 | 0 | 0 | 0 | 150 | 0,635 | 0,363 |
| TF 835_13 | 1,2% | 0,81 | 0,9 | 0,95:1,05 | 3,856 | 68,082 | 0 | 0 | 0 | 0 | 0 | 0,406 | 0 | 0 | 0 | 0 | 0 | 0 | 38,516 | 0 | 37,310 | 1,830 | 0 | 0 | 0 | 150 | 0,636 | 0,362 |
| TF 836_13 | 1,2% | 0,855 | 1,0 | 0,9:1,1 | 3,971 | 70,113 | 0 | 0 | 0 | 0 | 0 | 0,396 | 0 | 0 | 0 | 0 | 0 | 0 | 35,600 | 0 | 38,134 | 1,786 | 0 | 0 | 0 | 150 | 0,634 | 0,364 |
| TF 837_13 | 1,2% | 0,9 | 1,0 | 1:1 | 4,061 | 71,706 | 0 | 0 | 0 | 0 | 0 | 0,385 | 0 | 0 | 0 | 0 | 0 | 0 | 38,431 | 0 | 33,682 | 1,735 | 0 | 0 | 0 | 150 | 0,636 | 0,363 |
| Thi 838_13 | 2,2% | 0,9 | 1,0 | 1:1 | 1,341 | 23,674 | 0 | 0 | 0 | 0 | 0 | 0,127 | 0 | 0 | 0 | 0 | 0 | 0 | 12,688 | 0 | 11,120 | 1,050 | 0 | 0 | 0 | 50 | 0,652 | 0,347 |
| Thi 839_13 | 2,5% | 0,9 | 1,0 | 1:1 | 1,337 | 23,606 | 0 | 0 | 0 | 0 | 0 | 0,127 | 0 | 0 | 0 | 0 | 0 | 0 | 12,652 | 0 | 11,088 | 1,190 | 0 | 0 | 0 | 50 | 0,653 | 0,346 |
| Thi 840_13 | 2,7% | 0,9 | 1,0 | 1:1 | 1,334 | 23,561 | 0 | 0 | 0 | 0 | 0 | 0,127 | 0 | 0 | 0 | 0 | 0 | 0 | 12,628 | 0 | 11,067 | 1,283 | 0 | 0 | 0 | 50 | 0,651 | 0,348 |
| Thi 841_13 | 3,0% | 0,9 | 1,0 | 1:1 | 1,331 | 23,494 | 0 | 0 | 0 | 0 | 0 | 0,126 | 0 | 0 | 0 | 0 | 0 | 0 | 12,592 | 0 | 11,036 | 1,421 | 0 | 0 | 0 | 50 | 0,653 | 0,346 |
| Thi 842_13 | 1,2% | 0,9 | 1,0 | 0,95:1,05 | 1,356 | 23,940 | 0 | 0 | 0 | 0 | 0 | 0,129 | 0 | 0 | 0 | 0 | 0 | 0 | 12,189 | 0 | 11,807 | 0,579 | 0 | 0 | 0 | 50 | 0,633 | 0,365 |
| Thi 843_13 | 1,7% | 0,9 | 1,0 | 0,95:1,05 | 1,349 | 23,825 | 0 | 0 | 0 | 0 | 0 | 0,128 | 0 | 0 | 0 | 0 | 0 | 0 | 12,131 | 0 | 11,751 | 0,817 | 0 | 0 | 0 | 50 | 0,642 | 0,357 |
| Thi 844_13 | 2,2% | 0,9 | 1,0 | 0,95:1,05 | 1,343 | 23,711 | 0 | 0 | 0 | 0 | 0 | 0,127 | 0 | 0 | 0 | 0 | 0 | 0 | 12,073 | 0 | 11,694 | 1,052 | 0 | 0 | 0 | 50 | 0,648 | 0,351 |
| Thi 845_13 | 2,7% | 0,9 | 1,0 | 0,95:1,05 | 1,336 | 23,598 | 0 | 0 | 0 | 0 | 0 | 0,127 | 0 | 0 | 0 | 0 | 0 | 0 | 12,015 | 0 | 11,639 | 1,285 | 0 | 0 | 0 | 50 | 0,652 | 0,347 |
| TF 846_13 | 2,0% | 0,92 | 1,0 | 1:1 | 1,069 | 24,121 | 0 | 0 | 0 | 0 | 0 | 0,127 | 0 | 0 | 0 | 0 | 0 | 0 | 12,647 | 0 | 11,084 | 0,952 | 0 | 0 | 0 | 50 | 0,643 | 0,356 |
| TF 847_13 | 2,0% | 0,94 | 1,0 | 1:1 | 0,798 | 24,520 | 0 | 0 | 0 | 0 | 0 | 0,126 | 0 | 0 | 0 | 0 | 0 | 0 | 12,582 | 0 | 11,027 | 0,947 | 0 | 0 | 0 | 50 | 0,644 | 0,355 |

# Fig. 39b/3

| | Zusammensetzung $Ca_{1-x}Sr_xAlSiN_3$:yEu bzw. $Sr(Sr_aCa_{1-a})Si_2Al_2N_6$:yEu (a=2x-1) | | | | Einwaage / g | | | | | | | | | | | | | | | | | | | | | | Optische Charakterisierung | |
|---|---|---|---|---|---|---|---|---|---|---|---|---|---|---|---|---|---|---|---|---|---|---|---|---|---|---|---|---|
| Versuch | y | x | EA Anteil | Si:Al ratio | Ca3N2 | Sr3N2 | BaNx | AlF3 | SrF2 | BaF2 | Li2B4O7 | LiBF4 | LiF | Li3N | Mn2O3 | CuO | Zn3N2 | La2O3 | Si3N4 | Graphite | AlN | Eu2O3 | EuN | CeO2 | SiO2 | Gesamt | CIE x | CIE y |
| TF 848_13 | 2,0% | 0,96 | 1,0 | 1:1 | 0,529 | 24,914 | 0 | 0 | 0 | 0 | 0 | 0,125 | 0 | 0 | 0 | 0 | 0 | 0 | 12,518 | 0 | 10,971 | 0,942 | 0 | 0 | 0 | 50 | 0,638 | 0,360 |
| TF 849_13 | 2,0% | 0,98 | 1,0 | 1:1 | 0,263 | 25,304 | 0 | 0 | | 0 | 0 | 0,125 | 0 | 0 | 0 | 0 | 0 | 0 | 12,455 | 0 | 10,916 | 0,937 | 0 | 0 | 0 | 50 | 0,613 | 0,369 |
| TF 850_14 | 3,0% | 0,91 | 1,0 | 1:1 | 1,194 | 23,695 | 0 | 0 | 0 | 0 | 0 | 0,126 | 0 | 0 | 0 | 0 | 0 | 0 | 12,560 | 0 | 11,008 | 1,418 | 0 | 0 | 0 | 50 | 0,653 | 0,346 |
| TF 851_14 | 3,0% | 0,92 | 1,0 | 1:1 | 1,059 | 23,894 | 0 | 0 | 0 | 0 | 0 | 0,126 | 0 | 0 | 0 | 0 | 0 | 0 | 12,528 | 0 | 10,980 | 1,414 | 0 | 0 | 0 | 50 | 0,652 | 0,347 |
| TF 852_14 | 3,0% | 0,93 | 1,0 | 1:1 | 0,924 | 24,092 | 0 | 0 | 0 | 0 | 0 | 0,125 | 0 | 0 | 0 | 0 | 0 | 0 | 12,486 | 0 | 10,952 | 1,410 | 0 | 0 | 0 | 50 | 0,653 | 0,345 |
| TF 853_14 | 3,0% | 0,94 | 1,0 | 1:1 | 0,790 | 24,290 | 0 | 0 | 0 | 0 | 0 | 0,125 | 0 | 0 | 0 | 0 | 0 | 0 | 12,464 | 0 | 10,924 | 1,407 | 0 | 0 | 0 | 50 | 0,654 | 0,345 |
| Thi 854_14 | 3,2% | 0,9 | 1,0 | 1:1 | 1,328 | 23,450 | 0 | 0 | 0 | 0 | 0 | 0,126 | 0 | 0 | 0 | 0 | 0 | 0 | 12,568 | 0 | 11,015 | 1,153 | 0 | 0 | 0 | 50 | 0,656 | 0,343 |
| Thi 855_14 | 3,5% | 0,9 | 1,0 | 1:1 | 1,324 | 23,383 | 0 | 0 | 0 | 0 | 0 | 0,126 | 0 | 0 | 0 | 0 | 0 | 0 | 12,533 | 0 | 10,984 | 1,650 | 0 | 0 | 0 | 50 | 0,658 | 0,341 |
| Thi 856_14 | 3,7% | 0,9 | 1,0 | 1:1 | 1,322 | 23,339 | 0 | 0 | 0 | 0 | 0 | 0,125 | 0 | 0 | 0 | 0 | 0 | 0 | 12,509 | 0 | 10,963 | 1,741 | 0 | 0 | 0 | 50 | 0,659 | 0,340 |
| Thi 857_14 | 4,0% | 0,9 | 1,0 | 1:1 | 1,318 | 23,274 | 0 | 0 | 0 | 0 | 0 | 0,125 | 0 | 0 | 0 | 0 | 0 | 0 | 12,474 | 0 | 10,932 | 1,877 | 0 | 0 | 0 | 50 | 0,660 | 0,339 |
| TF 858_14 | 3,0% | 0,91 | 1,0 | 1:1 | 1,194 | 23,695 | 0 | 0 | 0 | 0 | 0 | 0,126 | 0 | 0 | 0 | 0 | 0 | 0 | 12,560 | 0 | 11,008 | 1,418 | 0 | 0 | 0 | 50 | 0,658 | 0,341 |
| TF 859_14 | 3,0% | 0,92 | 1,0 | 1:1 | 1,059 | 23,894 | 0 | 0 | 0 | 0 | 0 | 0,126 | 0 | 0 | 0 | 0 | 0 | 0 | 12,528 | 0 | 10,980 | 1,414 | 0 | 0 | 0 | 50 | 0,652 | 0,347 |
| TF 860_14 | 3,0% | 0,93 | 1,0 | 1:1 | 0,924 | 24,092 | 0 | 0 | 0 | 0 | 0 | 0,125 | 0 | 0 | 0 | 0 | 0 | 0 | 12,496 | 0 | 10,952 | 1,410 | 0 | 0 | 0 | 50 | 0,652 | 0,347 |
| TF 861_14 | 3,0% | 0,94 | 1,0 | 1:1 | 0,790 | 24,290 | 0 | 0 | 0 | 0 | 0 | 0,125 | 0 | 0 | 0 | 0 | 0 | 0 | 12,464 | 0 | 10,924 | 1,407 | 0 | 0 | 0 | 50 | 0,650 | 0,349 |
| Thi 862_14 | 1,2% | 0,9 | 1,0 | 1:1 | 1,212 | 23,772 | 0,407 | 0 | 0 | 0 | 0 | 0,128 | 0 | 0 | 0 | 0 | 0 | 0 | 12,741 | 0 | 11,166 | 0,575 | 0 | 0 | 0 | 50 | 0,634 | 0,365 |
| Thi 863_14 | 1,2% | 0,9 | 1,0 | 1:1 | 0,932 | 23,515 | 1,208 | 0 | 0 | 0 | 0 | 0,126 | 0 | 0 | 0 | 0 | 0 | 0 | 12,603 | 0 | 11,046 | 0,569 | 0 | 0 | 0 | 50 | 0,637 | 0,361 |
| Thi 864_14 | 1,2% | 0,9 | 1,0 | 1:1 | 0,659 | 23,264 | 1,992 | 0 | 0 | 0 | 0 | 0,125 | 0 | 0 | 0 | 0 | 0 | 0 | 12,469 | 0 | 10,928 | 0,563 | 0 | 0 | 0 | 50 | 0,627 | 0,368 |
| Thi 865_14 | 1,2% | 0,9 | 1,0 | 1:1 | 1,354 | 23,902 | 0 | 0 | 0 | 0 | 0 | 0,128 | 0 | 0 | 0 | 0 | 0 | 0 | 12,810 | 0 | 11,227 | 0,578 | 0 | 0 | 0 | 50 | 0,636 | 0,363 |
| Thi 866_14 | 2,0% | 0,9 | 1,0 | 1:1 | 4,030 | 71,157 | 0 | 0 | 0 | 0 | 0 | 0,382 | 0 | 0 | 0 | 0 | 0 | 0 | 38,137 | 0 | 33,424 | 2,870 | 0 | 0 | 0 | 150 | 0,645 | 0,353 |
| Thi 867_14 | 2,0% | 0,92 | 1,0 | 1:1 | 3,207 | 72,364 | 0 | 0 | 0 | 0 | 0 | 0,38 | 0 | 0 | 0 | 0 | 0 | 0 | 37,941 | 0 | 33,252 | 2,855 | 0 | 0 | 0 | 150 | 0,645 | 0,354 |
| Thi 868_14 | 2,0% | 0,95 | 1,0 | 1:1 | 1,989 | 74,152 | 0 | 0 | 0 | 0 | 0 | 0,377 | 0 | 0 | 0 | 0 | 0 | 0 | 37,651 | 0 | 32,998 | 2,833 | 0 | 0 | 0 | 150 | 0,642 | 0,357 |
| TF 869_14 | 2,0% | 0,9 | 1,0 | 1:1 | 1,343 | 23,719 | 0 | 0 | 0 | 0 | 0 | 0,127 | 0 | 0 | 0 | 0 | 0 | 0 | 12,712 | 0 | 11,141 | 0,957 | 0 | 0 | 0 | 50 | 0,645 | 0,353 |
| TF 870_14 | 2,0% | 0,9 | 1,0 | 1:1 | 1,343 | 23,719 | 0 | 0 | 0 | 0 | 0 | 0,127 | 0 | 0 | 0 | 0 | 0 | 0 | 12,712 | 0 | 11,141 | 0,957 | 0 | 0 | 0 | 50 | 0,645 | 0,353 |
| TF 871_14 | 2,0% | 0,9 | 1,0 | 1:1 | 1,343 | 23,719 | 0 | 0 | 0 | 0 | 0 | 0,127 | 0 | 0 | 0 | 0 | 0 | 0 | 12,712 | 0 | 11,414 | 0,957 | 0 | 0 | 0 | 50 | 0,646 | 0,352 |
| TF 872_14 | 2,0% | 0,9 | 1,0 | 1:1 | 1,343 | 23,719 | 0 | 0 | 0 | 0 | 0 | 0,127 | 0 | 0 | 0 | 0 | 0 | 0 | 12,712 | 0 | 11,414 | 0,957 | 0 | 0 | 0 | 50 | 0,646 | 0,353 |
| TF 873_14 | 2,0% | 0,9 | 1,0 | 1:1 | 1,338 | 23,634 | 0 | 0 | 0 | 0 | 0 | 0,127 | 0 | 0 | 0 | 0 | 0 | 0 | 12,667 | 0 | 11,102 | 1,132 | 0 | 0 | 0 | 50 | 0,647 | 0,351 |
| TF 874_14 | 2,0% | 0,92 | 1,0 | 1:1 | 1,069 | 24,121 | 0 | 0 | 0 | 0 | 0 | 0,127 | 0 | 0 | 0 | 0 | 0 | 0 | 12,647 | 0 | 11,084 | 0,952 | 0 | 0 | 0 | 50 | 0,643 | 0,356 |
| TF 875_14 | 2,5% | 0,92 | 1,0 | 1:1 | 1,064 | 24,007 | 0 | 0 | 0 | 0 | 0 | 0,126 | 0 | 0 | 0 | 0 | 0 | 0 | 12,587 | 0 | 11,032 | 1,184 | 0 | 0 | 0 | 50 | 0,647 | 0,352 |
| TF 876_14 | 2,0% | 0,93 | 1,0 | 1:1 | 0,933 | 24,321 | 0 | 0 | 0 | 0 | 0 | 0,126 | 0 | 0 | 0 | 0 | 0 | 0 | 12,615 | 0 | 11,056 | 0,949 | 0 | 0 | 0 | 50 | 0,641 | 0,357 |
| Thi 877_14 | 2,0% | 0,92 | 1,0 | 1:1 | 3,207 | 72,364 | 0 | 0 | 0 | 0 | 0 | 0,38 | 0 | 0 | 0 | 0 | 0 | 0 | 37,941 | 0 | 33,252 | 2,855 | 0 | 0 | 0 | 150 | 0,644 | 0,354 |
| Thi 878_14 | 2,0% | 0,93 | 1,0 | 1:1 | 2,799 | 72,963 | 0 | 0 | 0 | 0 | 0 | 0,379 | 0 | 0 | 0 | 0 | 0 | 0 | 37,844 | 0 | 33,167 | 2,848 | 0 | 0 | 0 | 150 | 0,643 | 0,356 |
| Thi 879_14 | 2,0% | 0,9 | 1,0 | 0,95:1,05 | 4,036 | 71,269 | 0 | 0 | 0 | 0 | 0 | 0,383 | 0 | 0 | 0 | 0 | 0 | 0 | 36,287 | 0 | 35,151 | 2,874 | 0 | 0 | 0 | 150 | 0,646 | 0,353 |
| Thi 880_14 | 4,2% | 0,9 | 1,0 | 1:1 | 1,316 | 23,230 | 0 | 0 | 0 | 0 | 0 | 0,125 | 0 | 0 | 0 | 0 | 0 | 0 | 12,450 | 0 | 10,915 | 1,967 | 0 | 0 | 0 | 50 | 0,661 | 0,338 |
| Thi 881_14 | 4,5% | 0,9 | 1,0 | 1:1 | 1,312 | 23,165 | 0 | 0 | 0 | 0 | 0 | 0,124 | 0 | 0 | 0 | 0 | 0 | 0 | 12,415 | 0 | 10,881 | 2,102 | 0 | 0 | 0 | 50 | 0,662 | 0,337 |
| Thi 882_14 | 4,7% | 0,9 | 1,0 | 1:1 | 1,309 | 23,122 | 0 | 0 | 0 | 0 | 0 | 0,124 | 0 | 0 | 0 | 0 | 0 | 0 | 12,392 | 0 | 10,861 | 2,191 | 0 | 0 | 0 | 50 | 0,663 | 0,336 |
| Thi 883_14 | 5,0% | 0,9 | 1,0 | 1:1 | 1,306 | 23,057 | 0 | 0 | 0 | 0 | 0 | 0,124 | 0 | 0 | 0 | 0 | 0 | 0 | 12,358 | 0 | 10,831 | 2,325 | 0 | 0 | 0 | 50 | 0,664 | 0,334 |
| Thi 884_14 | 2,5% | 0,93 | 1,0 | 1:1 | 2,786 | 72,618 | 0 | 0 | 0 | 0 | 0 | 0,377 | 0 | 0 | 0 | 0 | 0 | 0 | 37,665 | 0 | 33,101 | 3,543 | 0 | 0 | 0 | 150 | 0,649 | 0,349 |
| Thi 885_14 | 3,0% | 0,93 | 1,0 | 1:1 | 2,773 | 72,277 | 0 | 0 | 0 | 0 | 0 | 0,376 | 0 | 0 | 0 | 0 | 0 | 0 | 37,488 | 0 | 32,855 | 4,231 | 0 | 0 | 0 | 150 | 0,652 | 0,347 |
| Thi 886_14 | 2,0% | 0,94 | 1,0 | 1:1 | 2,393 | 73,559 | 0 | 0 | 0 | 0 | 0 | 0,378 | 0 | 0 | 0 | 0 | 0 | 0 | 37,747 | 0 | 33,072 | 2,840 | 0 | 0 | 0 | 150 | 0,643 | 0,355 |
| TF 887_14 | 0,8% | 0,93 | 1,0 | 1:1 | 0,944 | 24,601 | 0 | 0 | 0 | 0 | 0 | 0,128 | 0 | 0 | 0 | 0 | 0 | 0 | 12,760 | 0 | 11,183 | 0,384 | 0 | 0 | 0 | 50 | 0,622 | 0,377 |
| TF 888_14 | 0,4% | 0,93 | 1,0 | 1:1 | 0,916 | 23,868 | 0 | 0 | 0 | 0 | 0 | 0,124 | 0 | 0 | 0 | 0 | 0 | 0 | 12,380 | 0 | 10,850 | 1,863 | 0 | 0 | 0 | 50 | 0,607 | 0,391 |
| TF 889_14 | 2,0% | 0,9 | 1,0 | 1:1 | 1,202 | 23,591 | 0,404 | 0 | 0 | 0 | 0 | 0,127 | 0 | 0 | 0 | 0 | 0 | 0 | 12,644 | 0 | 11,081 | 0,951 | 0 | 0 | 0 | 50 | 0,644 | 0,355 |
| TF 890_41 | 0,0% | 0,9 | 1,0 | 1:1 | 1,357 | 23,950 | 0 | 0 | 0 | 0 | 0 | 0,129 | 0 | 0 | 0 | 0 | 0 | 0 | 12,838 | 0 | 11,251 | 0,000 | 0 | 0,472 | 0 | 50 | 0,452 | 0,524 |
| TF 891_14 | 2,0% | 0,94 | 1,0 | 1:1 | 0,928 | 24,455 | 0 | 0 | 0 | 0 | 0 | 0,126 | 0 | 0 | 0 | 0 | 0 | 0 | 12,549 | 0 | 10,998 | 0,944 | 0 | 0 | 0 | 50 | 0,642 | 0,356 |
| TF 892_14 | 2,0% | 0,95 | 1,0 | 1:1 | 0,923 | 24,587 | 0 | 0 | 0 | 0 | 0 | 0,125 | 0 | 0 | 0 | 0 | 0 | 0 | 12,484 | 0 | 10,941 | 0,939 | 0 | 0 | 0 | 50 | 0,641 | 0,358 |
| TF 893_14 | 2,0% | 0,97 | 1,0 | 1:1 | 0,914 | 24,847 | 0 | 0 | 0 | 0 | 0 | 0,124 | 0 | 0 | 0 | 0 | 0 | 0 | 12,356 | 0 | 10,829 | 0,930 | 0 | 0 | 0 | 50 | 0,640 | 0,358 |
| TF 894_14 | 0,8% | 0,93 | 1,0 | 1:1 | 0,944 | 24,601 | 0 | 0 | 0 | 0 | 0 | 0,128 | 0 | 0 | 0 | 0 | 0 | 0 | 12,760 | 0 | 11,183 | 0,384 | 0 | 0 | 0 | 50 | 0,622 | 0,376 |
| TF 895_14 | 1,2% | 0,93 | 1,0 | 1:1 | 0,940 | 24,507 | 0 | 0 | 0 | 0 | 0 | 0,127 | 0 | 0 | 0 | 0 | 0 | 0 | 12,711 | 0 | 11,140 | 0,574 | 0 | 0 | 0 | 50 | 0,631 | 0,367 |
| TF 896_14 | 2,5% | 0,93 | 1,0 | 1:1 | 0,929 | 24,206 | 0 | 0 | 0 | 0 | 0 | 0,126 | 0 | 0 | 0 | 0 | 0 | 0 | 12,555 | 0 | 11,003 | 1,181 | 0 | 0 | 0 | 50 | 0,648 | 0,351 |
| TF 897_14 | 2,5% | 0,93 | 1,0 | 1:1 | 0,920 | 23,980 | 0 | 0 | 0 | 0 | 0 | 0,125 | 0 | 0 | 0 | 0 | 0 | 0 | 12,428 | 0 | 10,900 | 1,638 | 0 | 0 | 0 | 50 | 0,654 | 0,344 |
| TF 898_14 | 2,5% | 0,93 | 1,0 | 1:1 | 2,789 | 72,618 | 0 | 0 | 0 | 0 | 0 | 0,377 | 0 | 0 | 0 | 0 | 0 | 0 | 37,665 | 0 | 33,010 | 3,543 | 0 | 0 | 0 | 150 | 0,659 | 0,340 |
| TF 899_14 | 2,5% | 0,93 | 1,0 | 1:1 | 2,786 | 72,618 | 0 | 0 | 0 | 0 | 0 | 0,377 | 0 | 0 | 0 | 0 | 0 | 0 | 37,665 | 0 | 33,010 | 3,543 | 0 | 0 | 0 | 150 | 0,649 | 0,350 |
| TF 900_14 | 2,5% | 0,93 | 1,0 | 1:1 | 2,786 | 72,618 | 0 | 0 | 0 | 0 | 0 | 0,377 | 0 | 0 | 0 | 0 | 0 | 0 | 37,665 | 0 | 33,010 | 3,543 | 0 | 0 | 0 | 150 | 0,650 | 0,349 |
| Thi 901_14 | 2,5% | 0,93 | 1,0 | 1:1 | 2,786 | 72,618 | 0 | 0 | 0 | 0 | 0 | 0,377 | 0 | 0 | 0 | 0 | 0 | 0 | 37,665 | 0 | 33,010 | 3,543 | 0 | 0 | 0 | 150 | 0,650 | 0,349 |
| Thi 902_14 | 3,0% | 0,93 | 1,0 | 1:1 | 2,773 | 72,277 | 0 | 0 | 0 | 0 | 0 | 0,376 | 0 | 0 | 0 | 0 | 0 | 0 | 37,488 | 0 | 32,855 | 4,231 | 0 | 0 | 0 | 150 | 0,654 | 0,345 |
| Thi 903_14 | 3,0% | 0,93 | 1,0 | 1:1 | 4,030 | 71,157 | 0 | 0 | 0 | 0 | 0 | 0,382 | 0 | 0 | 0 | 0 | 0 | 0 | 38,137 | 0 | 33,424 | 2,870 | 0 | 0 | 0 | 150 | 0,646 | 0,352 |
| Thi 904_14 | 3,0% | 0,93 | 1,0 | 1:1 | 2,773 | 72,277 | 0 | 0 | 0 | 0 | 0 | 0,376 | 0 | 0 | 0 | 0 | 0 | 0 | 37,488 | 0 | 32,855 | 4,231 | 0 | 0 | 0 | 150 | 0,653 | 0,346 |
| Thi 905_14 | 3,0% | 0,94 | 1,0 | 1:1 | 2,371 | 72,869 | 0 | 0 | 0 | 0 | 0 | 0,375 | 0 | 0 | 0 | 0 | 0 | 0 | 37,939 | 0 | 32,772 | 4,221 | 0 | 0 | 0 | 150 | 0,653 | 0,346 |
| Thi 906_14 | 3,0% | 0,96 | 1,0 | 1:1 | 1,572 | 74,044 | 0 | 0 | 0 | 0 | 0 | 0,373 | 0 | 0 | 0 | 0 | 0 | 0 | 37,204 | 0 | 32,607 | 4,199 | 0 | 0 | 0 | 150 | -- | -- |

Fig. 39b/4

| | Zusammensetzung $Ca_{1-x}Sr_xAlSiN_3$:yEu bzw. $Sr(Sr_aCa_{1-a})Si_2Al_2N_6$:yEu (a=2x-1) | | | | Einwaage / g | | | | | | | | | | | | | | | | | | | | | | Optische Charakterisierung | |
|---|---|---|---|---|---|---|---|---|---|---|---|---|---|---|---|---|---|---|---|---|---|---|---|---|---|---|---|---|
| Versuch | y | x | EA Anteil | Si:Al ratio | Ca3N2 | Sr3N2 | BaNx | AlF3 | SrF2 | BaF2 | Li2B4O7 | LiBF4 | LiF | Li3N | Mn2O3 | CuO | Zn3N2 | La2O3 | Si3N4 | Graphite | AlN | Eu2O3 | EuN | CeO2 | SiO2 | Gesamt | CIE x | CIE y |
| TF 907_14 | 0,1% | 0,93 | 1,0 | 1:1 | 0,950 | 24,768 | 0 | 0 | 0 | 0 | 0 | 0,129 | 0 | 0 | 0 | 0 | 0 | 0 | 12,846 | 0 | 11,259 | 0,048 | 0 | 0 | 0 | 50 | 0,582 | 0,412 |
| TF 908_14 | 0,2% | 0,93 | 1,0 | 1:1 | 0,949 | 24,744 | 0 | 0 | 0 | 0 | 0 | 0,129 | 0 | 0 | 0 | 0 | 0 | 0 | 12,834 | 0 | 11,248 | 0,097 | 0 | 0 | 0 | 50 | 0,593 | 0,403 |
| Thi 017_14 | 1,5% | 0,9 | 1,0 | 1:1 | 1,330 | 23,479 | 0 | 0 | 0 | 0 | 0 | 0,126 | 0 | 0,047 | 0 | 0 | 0 | 0 | 12,584 | 0 | 11,023 | 0,710 | 0 | 0,695 | 0 | 50 | 0,638 | 0,360 |
| Thi 018_14 | 2,0% | 0,8 | 0,9 | 1:1 | 1,350 | 21,195 | 0 | 0 | 0 | 0 | 0 | 0,128 | 0 | 0,159 | 0 | 0 | 0 | 2,226 | 12,780 | 0 | 11,200 | 0,962 | 0 | 0 | 0 | 50 | 0,640 | 0,353 |
| Thi 019_14 | 0,0% | 0,9 | 1,0 | 1:1 | 1,358 | 23,972 | 0 | 0 | 0 | 0 | 0 | 0,129 | 0 | 0 | 0,434 | 0 | 0 | 0 | 12,848 | 0 | 11,260 | 0,000 | 0 | 0 | 0 | 50 | 0,573 | 0,423 |
| Thi 020_14 | 3,0% | 0,93 | 1,0 | 1:1 | 0,924 | 24,092 | 0 | 0 | 0 | 0 | 0 | 0,125 | 0 | 0 | 0 | 0 | 0 | 0 | 12,496 | 0 | 10,952 | 1,410 | 0 | 0 | 0 | 50 | 0,650 | 0,349 |
| Thi 021_14 | 2,0% | 0,8 | 0,9 | 1:1 | 1,356 | 21,285 | 0 | 0 | 0 | 0 | 0 | 0,129 | 0 | 0 | 0 | 2,183 | 0 | 0 | 12,834 | 0 | 11,248 | 0,966 | 0 | 0 | 0 | 50 | 0,646 | 0,352 |
| Thi 022_14 | 2,0% | 0,8 | 0,9 | 1:1 | 1,360 | 21,342 | 0 | 0 | 0 | 0 | 0 | 0,129 | 0 | 0 | 0 | 0 | 2,056 | 0 | 12,868 | 0 | 11,278 | 0,968 | 0 | 0 | 0 | 50 | 0,648 | 0,350 |
| Thi 023_14 | 3,0% | 0,9 | 1,0 | 1:1 | 1,382 | 24,408 | 0 | 0 | 0 | 0 | 0 | 0,131 | 0 | 0 | 0 | 0 | 0 | 0 | 10,465 | 0,671 | 11,465 | 1,477 | 0 | 0 | 0 | 50 | 0,656 | 0,343 |
| Thi 024_14 | 3,0% | 0,93 | 1,0 | 1:1 | 0,924 | 24,092 | 0 | 0 | 0 | 0 | 0 | 0,125 | 0 | 0 | 0 | 0 | 0 | 0 | 12,496 | 0 | 10,952 | 1,410 | 0 | 0 | 0 | 50 | 0,650 | 0,349 |
| Thi 025_14 | 2,0% | 0,9 | 1,0 | 1:1 | 1,342 | 23,690 | 0 | 0,187 | 0 | 0 | 0 | 0 | 0 | 0 | 0 | 0 | 0 | 0 | 12,697 | 0 | 11,128 | 0,955 | 0 | 0 | 0 | 50 | 0,645 | 0,353 |
| Thi 026_14 | 2,0% | 0,9 | 1,0 | 1:1 | 1,347 | 23,780 | 0 | 0 | 0 | 0 | 0 | 0 | 0 | 0 | 0 | 0 | 0 | 0 | 12,745 | 0 | 11,170 | 0,959 | 0 | 0 | 0 | 50 | 0,644 | 0,355 |
| Thi 027_14 | 2,0% | 0,9 | 1,0 | 1:1 | 1,346 | 23,763 | 0 | 0 | 0 | 0 | 0 | 0 | 0,035 | 0 | 0 | 0 | 0 | 0 | 12,736 | 0 | 11,162 | 0,958 | 0 | 0 | 0 | 50 | 0,645 | 0,354 |
| Thi 028_14 | 2,0% | 0,9 | 1,0 | 1:1 | 1,343 | 23,713 | 0 | 0 | 0 | 0 | 0 | 0 | 0,141 | 0 | 0 | 0 | 0 | 0 | 12,709 | 0 | 11,138 | 0,956 | 0 | 0 | 0 | 50 | 0,647 | 0,352 |
| TF 909_14 | 0,6% | 0,93 | 1,0 | 1:1 | 0,946 | 24,649 | 0 | 0 | 0 | 0 | 0 | 0,128 | 0 | 0 | 0 | 0 | 0 | 0 | 12,875 | 0 | 11,205 | 0,289 | 0 | 0 | 0 | 50 | 0,614 | 0,383 |
| TF 910_14 | 2,0% | 0,93 | 1,0 | 1:1 | 0,934 | 24,347 | 0 | 0 | 0 | 0 | 0 | 0,128 | 0 | 0 | 0 | 0 | 0 | 0 | 12,628 | 0 | 11,068 | 0,896 | 0 | 0 | 0 | 50 | 0,644 | 0,354 |
| TF 911_14 | 10,0% | 0,93 | 1,0 | 1:1 | 0,891 | 21,978 | 0 | 0 | 0 | 0 | 0 | 0,121 | 0 | 0 | 0 | 0 | 0 | 0 | 12,047 | 0 | 10,558 | 2,266 | 2,138 | 0 | 0 | 50 | 0,675 | 0,324 |
| TF 912_14 | 20,0% | 0,93 | 1,0 | 1:1 | 0,861 | 18,812 | 0 | 0 | 0 | 0 | 0 | 0,117 | 0 | 0 | 0 | 0 | 0 | 0 | 11,634 | 0 | 10,196 | 2,189 | 6,193 | 0 | 0 | 50 | 0,687 | 0,311 |
| Thi 913_14 | 3,0% | 0,93 | 1,0 | 0,99:1,01 | 2,774 | 72,299 | 0 | 0 | 0 | 0 | 0 | 0,376 | 0 | 0 | 0 | 0 | 0 | 0 | 37,125 | 0 | 33,194 | 4,233 | 0 | 0 | 0 | 150 | 0,652 | 0,347 |
| Thi 914_14 | 3,0% | 0,93 | 1,0 | 0,98:1,02 | 2,775 | 72,322 | 0 | 0 | 0 | 0 | 0 | 0,376 | 0 | 0 | 0 | 0 | 0 | 0 | 36,761 | 0 | 33,533 | 4,234 | 0 | 0 | 0 | 150 | 0,652 | 0,347 |
| Thi 915_14 | 3,0% | 0,93 | 1,0 | 1:1,01 | 2,767 | 72,119 | 0 | 0 | 0 | 0 | 0 | 0,375 | 0 | 0 | 0 | 0 | 0 | 0 | 37,406 | 0 | 33,111 | 4,222 | 0 | 0 | 0 | 150 | 0,652 | 0,347 |
| Thi 916_14 | 3,0% | 0,93 | 1,0 | 1:1 | 2,773 | 72,277 | 0 | 0 | 0 | 0 | 0 | 0,376 | 0 | 0 | 0 | 0 | 0 | 0 | 37,488 | 0 | 32,855 | 4,231 | 0 | 0 | 0 | 150 | 0,650 | 0,348 |
| Thi 030_14 | 3,0% | 0,93 | 1,0 | 1:1 | 2,773 | 72,277 | 0 | 0 | 0 | 0 | 0 | 0,378 | 0 | 0 | 0 | 0 | 0 | 0 | 37,488 | 0 | 32,855 | 4,231 | 0 | 0 | 0 | 150 | 0,652 | 0,347 |
| TF 917_14 | 3,0% | 0,93 | 1,0 | 1:0,98 | 2,785 | 72,595 | 0 | 0 | 0 | 0 | 0 | 0,377 | 0 | 0 | 0 | 0 | 0 | 0 | 37,653 | 0 | 32,340 | 4,250 | 0 | 0 | 0 | 150 | 0,653 | 0,346 |
| TF 918_14 | 3,0% | 0,93 | 1,0 | 1,03:0,97 | 2,770 | 72,210 | 0 | 0 | 0 | 0 | 0 | 0,375 | 0 | 0 | 0 | 0 | 0 | 0 | 38,577 | 0 | 31,840 | 4,227 | 0 | 0 | 0 | 150 | 0,652 | 0,347 |
| Thi 919_14 | 3,0% | 0,93 | 1,0 | 0,99:1,01 | 2,774 | 72,299 | 0 | 0 | 0 | 0 | 0 | 0,376 | 0 | 0 | 0 | 0 | 0 | 0 | 37,125 | 0 | 33,194 | 4,233 | 0 | 0 | 0 | 150 | 0,651 | 0,348 |
| Thi 920_14 | 3,0% | 0,93 | 1,0 | 0,98:1,02 | 2,775 | 72,322 | 0 | 0 | 0 | 0 | 0 | 0,376 | 0 | 0 | 0 | 0 | 0 | 0 | 36,761 | 0 | 33,533 | 4,234 | 0 | 0 | 0 | 150 | 0,652 | 0,347 |
| Thi 921_14 | 3,0% | 0,93 | 1,0 | 0,995:1,005 | 2,773 | 72,288 | 0 | 0 | 0 | 0 | 0 | 0,376 | 0 | 0 | 0 | 0 | 0 | 0 | 37,306 | 0 | 33,024 | 4,232 | 0 | 0 | 0 | 150 | 0,653 | 0,346 |
| Thi 032_14 | 3,0% | 0,91 | 0,98 | 1:1 | 0,925 | 23,599 | 0 | 0 | 0 | 0 | 0 | 0,125 | 0 | 0,031 | 0 | 0 | 0 | 0,436 | 12,509 | 0 | 10,963 | 1,412 | 0 | 0 | 0 | 50 | 0,648 | 0,349 |
| Thi 033_14 | 3,0% | 0,92 | 0,99 | 1:1 | 0,921 | 23,750 | 0 | 0 | 0 | 0 | 0 | 0,125 | 0 | 0 | 0 | 0 | 0 | 0,434 | 12,452 | 0 | 10,913 | 1,406 | 0 | 0 | 0 | 50 | 0,646 | 0,352 |
| Thi 034_14 | 3,0% | 0,9 | 1,0 | 1:1 | 1,333 | 23,538 | 0 | 0 | 0 | 0 | 0 | 0,126 | 0 | 0 | 0 | 0 | 0 | 0 | 12,489 | 0,032 | 11,056 | 1,424 | 0 | 0 | 0 | 50 | 0,656 | 0,343 |
| Thi 035_14 | 3,0% | 0,93 | 1,0 | 0,99:1,01 | 0,925 | 24,100 | 0 | 0 | 0 | 0 | 0 | 0,125 | 0 | 0 | 0 | 0 | 0 | 0 | 12,375 | 0 | 11,065 | 1,411 | 0 | 0 | 0 | 50 | 0,652 | 0,346 |
| TF 922_14 | 3,0% | 0,93 | 1,0 | 0,985:1 | 2,783 | 72,649 | 0 | 0 | 0 | 0 | 0 | 0,377 | 0 | 0 | 0 | 0 | 0 | 0 | 37,065 | 0 | 32,979 | 4,247 | 0 | 0 | 0 | 150 | 0,653 | 0,346 |
| TF 923_14 | 3,0% | 0,93 | 1,0 | 0,985:0,985 | 2,792 | 72,789 | 0 | 0 | 0 | 0 | 0 | 0,378 | 0 | 0 | 0 | 0 | 0 | 0 | 37,187 | 0 | 32,592 | 4,261 | 0 | 0 | 0 | 150 | 0,652 | 0,347 |
| TF 924_14 | 3,0% | 0,93 | 1,0 | 1:0,985 | 2,782 | 72,515 | 0 | 0 | 0 | 0 | 0 | 0,377 | 0 | 0 | 0 | 0 | 0 | 0 | 37,612 | 0 | 32,469 | 4,245 | 0 | 0 | 0 | 150 | 0,653 | 0,347 |
| Thi 925_14 | 3,0% | 0,93 | 1,0 | 0,995:0,995 | 2,779 | 72,447 | 0 | 0 | 0 | 0 | 0 | 3,77 | 0 | 0 | 0 | 0 | 0 | 0 | 37,388 | 0 | 32,768 | 4,241 | 0 | 0 | 0 | 150 | 0,653 | 0,347 |
| Thi 926_14 | 3,0% | 0,93 | 1,0 | 0,985:1,01 | 2,774 | 72,308 | 0 | 0 | 0 | 0 | 0 | 0,376 | 0 | 0 | 0 | 0 | 0 | 0 | 37,110 | 0 | 33,198 | 4,233 | 0 | 0 | 0 | 150 | 0,652 | 0,347 |
| Thi 927_14 | 3,0% | 0,93 | 1,0 | 1:1,015 | 2,764 | 72,040 | 0 | 0 | 0 | 0 | 0 | 0,374 | 0 | 0 | 0 | 0 | 0 | 0 | 37,365 | 0 | 33,239 | 4,218 | 0 | 0 | 0 | 150 | 0,652 | 0,347 |
| Thi 928_14 | 3,0% | 0,93 | 1,0 | 1,015:1,015 | 2,753 | 71,772 | 0 | 0 | 0 | 0 | 0 | 0,373 | 0 | 0 | 0 | 0 | 0 | 0 | 37,785 | 0 | 33,115 | 4,202 | 0 | 0 | 0 | 150 | 0,653 | 0,345 |
| Thi 929_14 | 3,0% | 0,93 | 1,0 | 0,985:1,005 | 2,780 | 72,469 | 0 | 0 | 0 | 0 | 0 | 0,377 | 0 | 0 | 0 | 0 | 0 | 0 | 37,024 | 0 | 33,104 | 4,243 | 0 | 0 | 0 | 150 | 0,652 | 0,347 |
| Thi 930_14 | 3,0% | 0,93 | 1,0 | 0,99:0,985 | 2,789 | 72,698 | 0 | 0 | 0 | 0 | 0 | 0,378 | 0 | 0 | 0 | 0 | 0 | 0 | 37,329 | 0 | 32,551 | 4,256 | 0 | 0 | 0 | 150 | 0,652 | 0,647 |
| Thi 931_14 | 3,0% | 0,93 | 1,0 | 0,985:1,01 | 2,777 | 72,390 | 0 | 0 | 0 | 0 | 0 | 0,376 | 0 | 0 | 0 | 0 | 0 | 0 | 36,983 | 0 | 33,235 | 4,238 | 0 | 0 | 0 | 150 | 0,652 | 0,347 |
| Thi 932_14 | 3,0% | 0,93 | 1,0 | 0,995:1,01 | 2,770 | 72,209 | 0 | 0 | 0 | 0 | 0 | 0,375 | 0 | 0 | 0 | 0 | 0 | 0 | 37,265 | 0 | 33,152 | 4,227 | 0 | 0 | 0 | 150 | 0,652 | 0,347 |
| Thi 933_14 | 3,0% | 0,93 | 1,0 | 1,01:1,01 | 2,760 | 71,940 | 0 | 0 | 0 | 0 | 0 | 0,374 | 0 | 0 | 0 | 0 | 0 | 0 | 37,686 | 0 | 33,028 | 4,212 | 0 | 0 | 0 | 150 | 0,652 | 0,347 |
| Thi 934_14 | 3,0% | 0,93 | 1,0 | 0,995:0,99 | 2,782 | 72,526 | 0 | 0 | 0 | 0 | 0 | 0,377 | 0 | 0 | 0 | 0 | 0 | 0 | 37,429 | 0 | 32,839 | 4,248 | 0 | 0 | 0 | 150 | 0,655 | 0,344 |
| Thi 935_14 | 3,0% | 0,93 | 1,0 | 1,105:0,985 | 2,772 | 72,244 | 0 | 0 | 0 | 0 | 0 | 0,376 | 0 | 0 | 0 | 0 | 0 | 0 | 39,347 | 0 | 32,347 | 4,229 | 0 | 0 | 0 | 150 | 0,654 | 0,345 |
| Thi 936_14 | 3,0% | 0,93 | 1,0 | 1,005:0,995 | 2,772 | 72,266 | 0 | 0 | 0 | 0 | 0 | 0,376 | 0 | 0 | 0 | 0 | 0 | 0 | 37,670 | 0 | 32,686 | 4,231 | 0 | 0 | 0 | 150 | 0,653 | 0,346 |
| Thi 937_14 | 3,0% | 0,93 | 1,0 | 0,985:1,105 | 2,774 | 72,311 | 0 | 0 | 0 | 0 | 0 | 0,376 | 0 | 0 | 0 | 0 | 0 | 0 | 36,943 | 0 | 33,363 | 4,233 | 0 | 0 | 0 | 150 | 0,654 | 0,345 |
| Thi 938_14 | 3,0% | 0,93 | 1,0 | 1,005:1,005 | 2,766 | 72,108 | 0 | 0 | 0 | 0 | 0 | 0,375 | 0 | 0 | 0 | 0 | 0 | 0 | 37,587 | 0 | 32,942 | 4,221 | 0 | 0 | 0 | 150 | 0,653 | 0,346 |
| Thi 939_14 | 3,0% | 0,93 | 1,0 | 1,015:1 | 2,762 | 72,007 | 0 | 0 | 0 | 0 | 0 | 0,374 | 0 | 0 | 0 | 0 | 0 | 0 | 37,908 | 0 | 32,732 | 4,216 | 0 | 0 | 0 | 150 | 0,651 | 0,348 |
| TF 940_14 | 3,0% | 0,93 | 1,0 | 1,015:0,99 | 2,769 | 72,165 | 0 | 0 | 0 | 0 | 0 | 0,375 | 0 | 0 | 0 | 0 | 0 | 0 | 37,991 | 0 | 32,476 | 4,225 | 0 | 0 | 0 | 150 | 0,653 | 0,346 |
| TF 941_14 | 3,0% | 0,93 | 1,0 | 1,01:0,985 | 2,775 | 72,334 | 0 | 0 | 0 | 0 | 0 | 0,376 | 0 | 0 | 0 | 0 | 0 | 0 | 37,893 | 0 | 32,388 | 4,235 | 0 | 0 | 0 | 150 | 0,653 | 0,346 |
| TF 942_14 | 3,0% | 0,93 | 1,0 | 0,9:1,015 | 2,837 | 73,881 | 0 | 0 | 0 | 0 | 0 | 0,384 | 0 | 0 | 0 | 0 | 0 | 0 | 34,488 | 0 | 34,888 | 4,325 | 0 | 0 | 0 | 150 | 0,650 | 0,348 |
| Thi 943_14 | 3,0% | 0,93 | 1,0 | 1,015:1,005 | 2,759 | 71,929 | 0 | 0 | 0 | 0 | 0 | 0,374 | 0 | 0 | 0 | 0 | 0 | 0 | 37,867 | 0 | 32,860 | 4,211 | 0 | 0 | 0 | 150 | 0,653 | 0,346 |
| Thi 944_14 | 3,0% | 0,93 | 1,0 | 0,99:1 | 2,780 | 72,458 | 0 | 0 | 0 | 0 | 0 | 0,377 | 0 | 0 | 0 | 0 | 0 | 0 | 37,206 | 0 | 32,937 | 4,242 | 0 | 0 | 0 | 150 | 0,651 | 0,348 |
| Thi 945_14 | 3,0% | 0,93 | 1,0 | 1,015:0,995 | 2,766 | 72,086 | 0 | 0 | 0 | 0 | 0 | 0,375 | 0 | 0 | 0 | 0 | 0 | 0 | 37,950 | 0 | 32,604 | 4,220 | 0 | 0 | 0 | 150 | 0,653 | 0,345 |
| Thi 946_14 | 3,0% | 0,93 | 1,0 | 0,95:0,99 | 2,814 | 73,354 | 0 | 0 | 0 | 0 | 0 | 0,381 | 0 | 0 | 0 | 0 | 0 | 0 | 36,144 | 0 | 33,011 | 4,294 | 0 | 0 | 0 | 150 | 0,653 | 0,346 |
| Thi 947_14 | 3,0% | 0,93 | 1,0 | 0,995:1,015 | 2,767 | 72,130 | 0 | 0 | 0 | 0 | 0 | 0,375 | 0 | 0 | 0 | 0 | 0 | 0 | 37,225 | 0 | 33,280 | 4,223 | 0 | 0 | 0 | 150 | 0,654 | 0,345 |
| Thi 948_14 | 3,0% | 0,93 | 1,0 | 1:1,005 | 2,770 | 72,198 | 0 | 0 | 0 | 0 | 0 | 0,375 | 0 | 0 | 0 | 0 | 0 | 0 | 37,447 | 0 | 32,983 | 4,227 | 0 | 0 | 0 | 150 | 0,654 | 0,345 |
| TF 949_14 | 3,0% | 0,93 | 1,0 | 1,033:1,066 | 2,711 | 70,672 | 0 | 0 | 0 | 0 | 0 | 0,367 | 0 | 0 | 0 | 0 | 0 | 0 | 37,865 | 0 | 34,246 | 4,137 | 0 | 0 | 0 | 150 | 0,653 | 0,346 |
| TF 950_14 | 3,0% | 0,93 | 1,0 | 1,066:1,132 | 2,652 | 69,138 | 0 | 0 | 0 | 0 | 0 | 0,359 | 0 | 0 | 0 | 0 | 0 | 0 | 38,226 | 0 | 35,577 | 4,048 | 0 | 0 | 0 | 150 | 0,652 | 0,346 |
| TF 951_14 | 3,0% | 0,93 | 1,0 | 1,1:1,2 | 2,594 | 67,625 | 0 | 0 | 0 | 0 | 0 | 0,352 | 0 | 0 | 0 | 0 | 0 | 0 | 38,582 | 0 | 36,888 | 3,959 | 0 | 0 | 0 | 150 | 0,654 | 0,345 |
| TF 952_14 | 3,0% | 0,93 | 1,0 | 1,06:1,16 | 1,121 | 71,105 | 0 | 0 | 0 | 0 | 0 | 0,354 | 0 | 0 | 0 | 0 | 0 | 0 | 37,481 | 0,000 | 35,948 | 3,891 | 0 | 0 | 0 | 150 | – | -- |
| TF 953_14 | 3,0% | 0,93 | 1,0 | 0,995:1,01 | 2,770 | 72,209 | 0 | 0 | 0 | 0 | 0 | 0,375 | 0 | 0 | 0 | 0 | 0 | 0 | 37,265 | 0 | 33,150 | 4,227 | 0 | 0 | 0 | 150 | 0,653 | 0,346 |
| TF 954_14 | 3,0% | 0,93 | 1,0 | 1:1 | 2,773 | 72,277 | 0 | 0 | 0 | 0 | 0 | 0,376 | 0 | 0 | 0 | 0 | 0 | 0 | 37,488 | 0 | 32,855 | 4,231 | 0 | 0 | 0 | 150 | 0,654 | 0,345 |
| Thi 044_14 | 3,0% | 0,93 | 1,0 | 1:1,005 | 2,770 | 72,198 | 0 | 0 | 0 | 0 | 0 | 0,375 | 0 | 0 | 0 | 0 | 0 | 0 | 37,447 | 0 | 32,983 | 4,227 | 0 | 0 | 0 | 150 | 0,651 | 0,348 |
| Thi 045_14 | 3,0% | 0,93 | 1,0 | 1:1,01 | 2,767 | 72,119 | 0 | 0 | 0 | 0 | 0 | 0,375 | 0 | 0 | 0 | 0 | 0 | 0 | 37,406 | 0 | 33,111 | 4,222 | 0 | 0 | 0 | 150 | 0,653 | 0,346 |
| Thi 046_14 | 3,0% | 0,93 | 1,0 | 1:1,015 | 2,764 | 72,040 | 0 | 0 | 0 | 0 | 0 | 0,374 | 0 | 0 | 0 | 0 | 0 | 0 | 37,365 | 0 | 33,239 | 4,218 | 0 | 0 | 0 | 150 | 0,651 | 0,348 |
| Thi 047_14 | 3,0% | 0,93 | 1,0 | 1:1,01 | 2,767 | 72,119 | 0 | 0 | 0 | 0 | 0 | 0,375 | 0 | 0 | 0 | 0 | 0 | 0 | 37,406 | 0 | 33,111 | 4,222 | 0 | 0 | 0 | 150 | 0,652 | 0,347 |
| Thi 048_14 | 3,0% | 0,93 | 1,0 | 1:1,01 | 2,767 | 72,119 | 0 | 0 | 0 | 0 | 0 | 0,375 | 0 | 0 | 0 | 0 | 0 | 0 | 37,406 | 0 | 33,111 | 4,222 | 0 | 0 | 0 | 150 | 0,653 | 0,346 |
| Thi 049_14 | 3,0% | 0,93 | 1,0 | 1:1,01 | 2,767 | 72,119 | 0 | 0 | 0 | 0 | 0 | 0,375 | 0 | 0 | 0 | 0 | 0 | 0 | 37,406 | 0 | 33,111 | 4,222 | 0 | 0 | 0 | 150 | 0,652 | 0,347 |

Fig. 40a

| | $\lambda_{dom(blaue\ LED)}$ | Leuchtstoff | Leucht-stoff-konzen-tration | x | y | $\Phi_{e(Verguß)}/\Phi_{e(kein\ Verguß)}$ | $\Phi_{v(Verguß)}/\Phi_{e(kein\ Verguß)}$ |
|---|---|---|---|---|---|---|---|
| **Vergleichs-beispiel 1** | 447,6 | $(Ca_{0,1}Sr_{0,4}Ba_{0,5})_2Si_5N_8$:Eu (6%) | 20 % | 0,661 | 0,335 | 100 % | 100 % |
| **Ausführungsbeispiel 1** | 446,9 | $Sr(Sr_{0,8}Ca_{0,2})Si_2Al_2N_6$: Eu (2%) | 21,5 % | 0,659 | 0,335 | 113 % | 145 % |

Fig. 40b

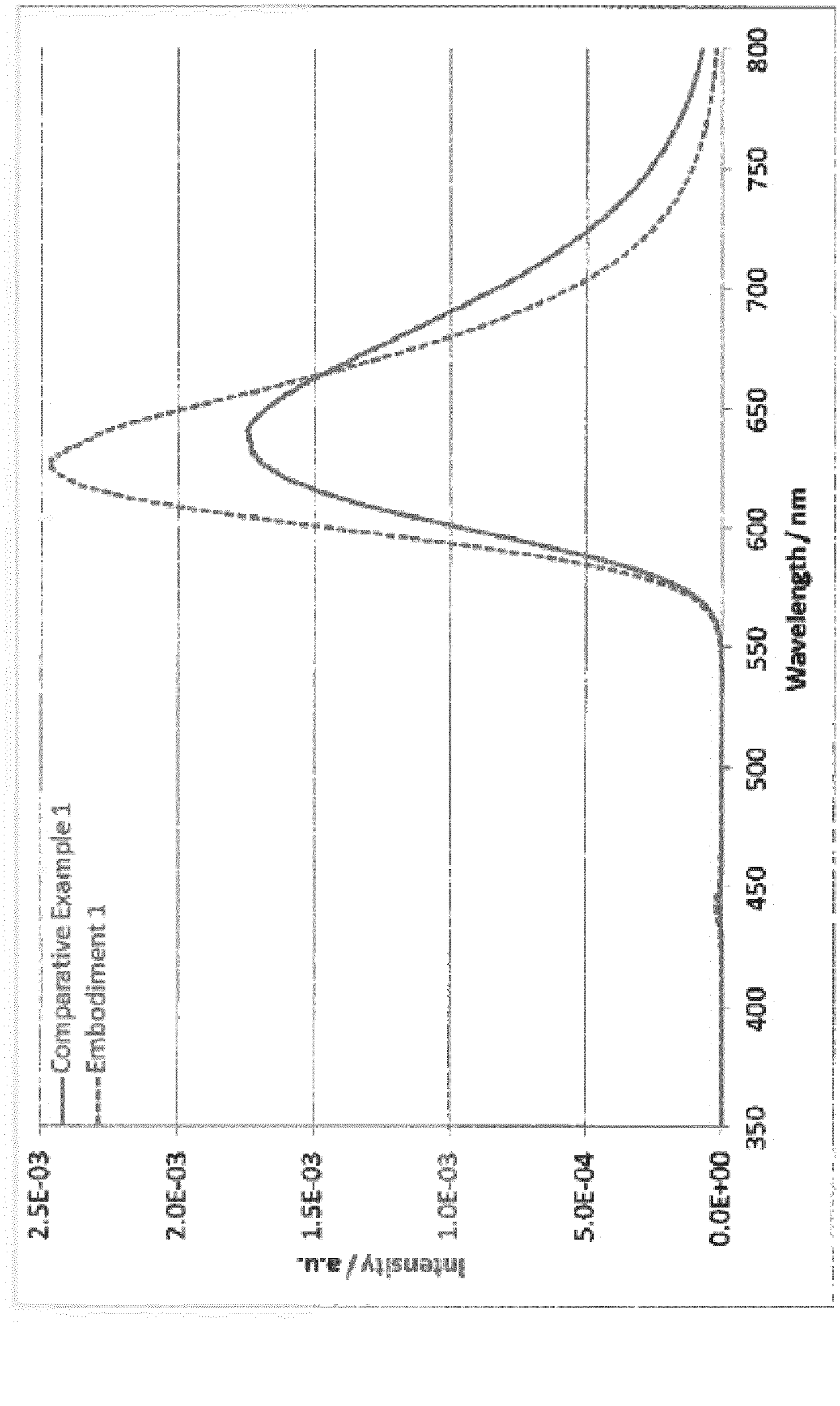

Intensity / a.u.
2.5E-03
2.0E-03
1.5E-03
1.0E-03
5.0E-04
0.0E+00
350
400
450
500
550
600
650
700
750
800
Wavelength / nm
Comparative Example 1
Embodiment 1

Fig. 41a

| - | $\lambda_{dom(blaue\ LED)}$ | Leuchtstoff | Leucht-stoff-konzen-tration | x | y | $\Phi_{e(Verguß)}/\Phi_{e(kein\ Verguß)}$ | $\Phi_{v(Verguß)}/\Phi_{e(kein\ Verguß)}$ |
|---|---|---|---|---|---|---|---|
| **Vergleichsbeispiel 2** | 447,5 | $CaAlSi(N,O)_3$:Eu (0,4%) | 30 % | 0,668 | 0,320 | 100 % | 100 % |
| **Ausführungsbeispiel 2** | 446,9 | $Sr(Sr_{0,8}Ca_{0,2})Si_2Al_2N_6$: Eu (5%) | 17 % | 0,670 | 0,317 | 133 % | 160 % |

Fig. 41b

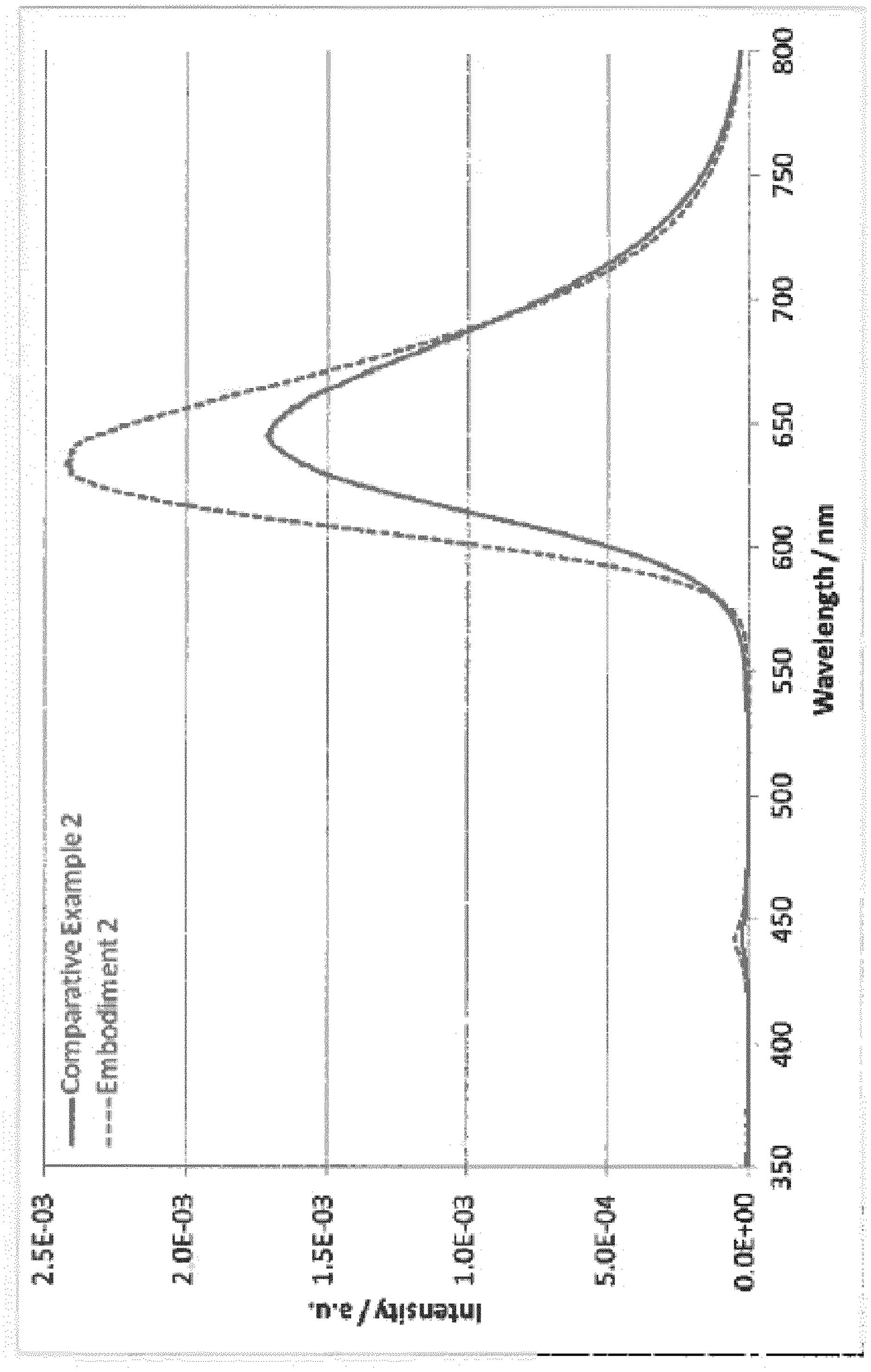
Comparative Example 2
Embodiment 2
Intensity / a.u.
2.5E-03
2.0E-03
1.5E-03
1.0E-03
5.0E-04
0.0E+00
350
400
450
500
550
600
650
700
750
800
Wavelength / nm

Fig. 42a

| | $\lambda_{dom(blaue LED)}$ | Erster Leuchtstoff | Zweiter Leuchtstoff | Verhältnis d. Leuchtstoffe | Leucht-stoff-konzen-tration | x | y | $\Phi_{e(Verguß)}$/ $\Phi_{e(kein Verguß)}$ | $\Phi_{v(Verguß)}$ / $\Phi_{e(kein Verguß)}$ |
|---|---|---|---|---|---|---|---|---|---|
| **Vergleichs-beispiel 3** | 447,6 | $(Ca_{0,1}Sr_{0,4}Ba_{0,5})_2Si_5N_8$:Eu (6%) | | | 20 % | 0,661 | 0,335 | 100 % | 100 % |
| **Ausführungs-beispiel 3** | 447,0 | $CaAlSi(N,O)_3$:Eu (0,4%) | $Sr(Sr_{0,8}Ca_{0,2})Si_2Al_2N_6$: Eu (2%) | 0,5/1 | 21,5 % | 0,661 | 0,330 | 104 % | 118 % |

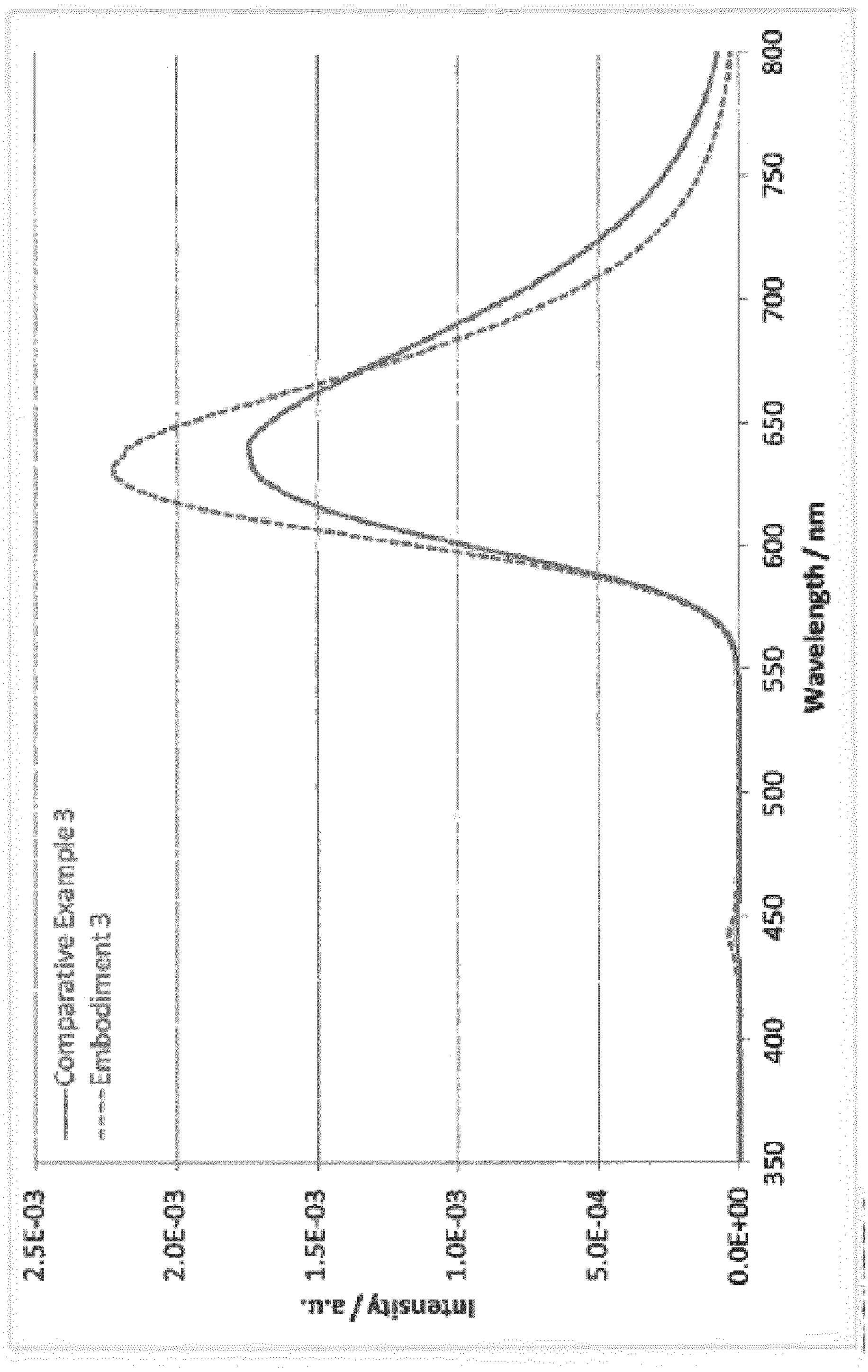

Comparative Example 3
Embodiment 3
Intensity / a.u.
2.5E-03
2.0E-03
1.5E-03
1.0E-03
5.0E-04
0.0E+00
350
400
450
500
550
600
650
700
750
800
Wavelength / nm


Fig. 42b

Fig. 43a

| | $\lambda_{dom(blaue LED)}$ | Erster Leuchtstoff | Zweiter Leuchtstoff | Verhältnis d. Leuchtstoffe | Leucht-stoff-konzen-tration | x | y | $\Phi_{e(Verguß)}/\Phi_{e(kein Verguß)}$ | $\Phi_{v(Verguß)}/\Phi_{e(kein Verguß)}$ |
|---|---|---|---|---|---|---|---|---|---|
| **Vergleichs-beispiel 4** | 447,1 | $CaAlSi(N,O)_3$:Eu (0,4%) | $(Ca_{0,1}Sr_{0,4}Ba_{0,5})_2Si_5N_8$:Eu (4%) | 1,7/1 | 21,5 % | 0,661 | 0,329 | 100 % | 100 % |
| **Ausführungs-beispiel 4** | 447,0 | $CaAlSi(N,O)_3$:Eu (0,4%) | $Sr(Sr_{0,8}Ca_{0,2})Si_2Al_2N_6$: Eu (2%) | 0,5/1 | 21,5 % | 0,661 | 0,330 | 107 % | 129 % |

Fig. 43b

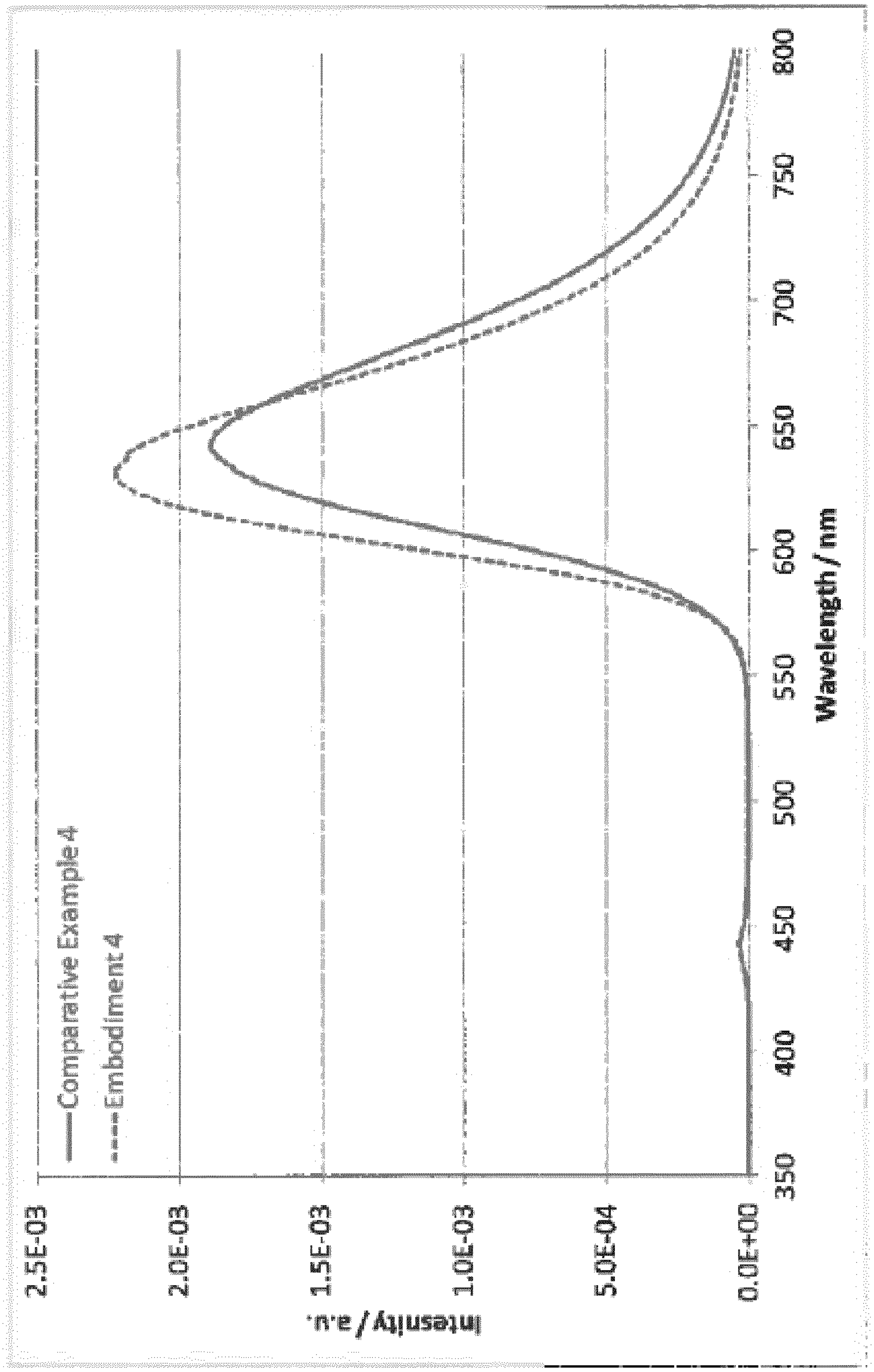

Comparative Example 4
Embodiment 4
Intensity / a.u.
2.5E-03
2.0E-03
1.5E-03
1.0E-03
5.0E-04
0.0E+00
350
400
450
500
550
600
650
700
750
800
Wavelength / nm

Fig. 44a

| | $\lambda_{dom(blaue\ LED)}$ | Erster Leuchtstoff | Zweiter Leuchtstoff | Verhältnis d. Leuchtstoffe | Leucht-stoff-konzen-tration | x | y | $\Phi_{e(Verguß)}/\Phi_{e(kein\ Verguß)}$ | $\Phi_{v(Verguß)}/\Phi_{e(kein\ Verguß)}$ |
|---|---|---|---|---|---|---|---|---|---|
| **Vergleichs-beispiel 5** | 444,7 | $(Y_{0,957}Ce_{0,043})_3Al_5O_{12}$ | $(Ca_{0,1}Sr_{0,4}Ba_{0,5})_2Si_5N_8:Eu$ (4%) | 5,9/1 | 41 % | 0,561 | 0,430 | 100 % | 100 % |
| **Ausführungs-beispiel 5** | 444,4 | $(Y_{0,957}Ce_{0,043})_3Al_5O_{12}$ | $Sr(Sr_{0,8}Ca_{0,2})Si_2Al_2N_6:Eu$ (2%) | 12,1/1 | 41% | 0,561 | 0,430 | 107 % | 109 % |
| **Ausführungs-beispiel 6** | 444,4 | $(Y_{0,957}Ce_{0,043})_3Al_5O_{12}$ | $Sr(Sr_{0,86}Ca_{0,14})Si_2Al_2N_6$: Eu (0,8%) | 5/1 | 39 % | 0,561 | 0,428 | 107 % | 117 % |

Fig. 44b

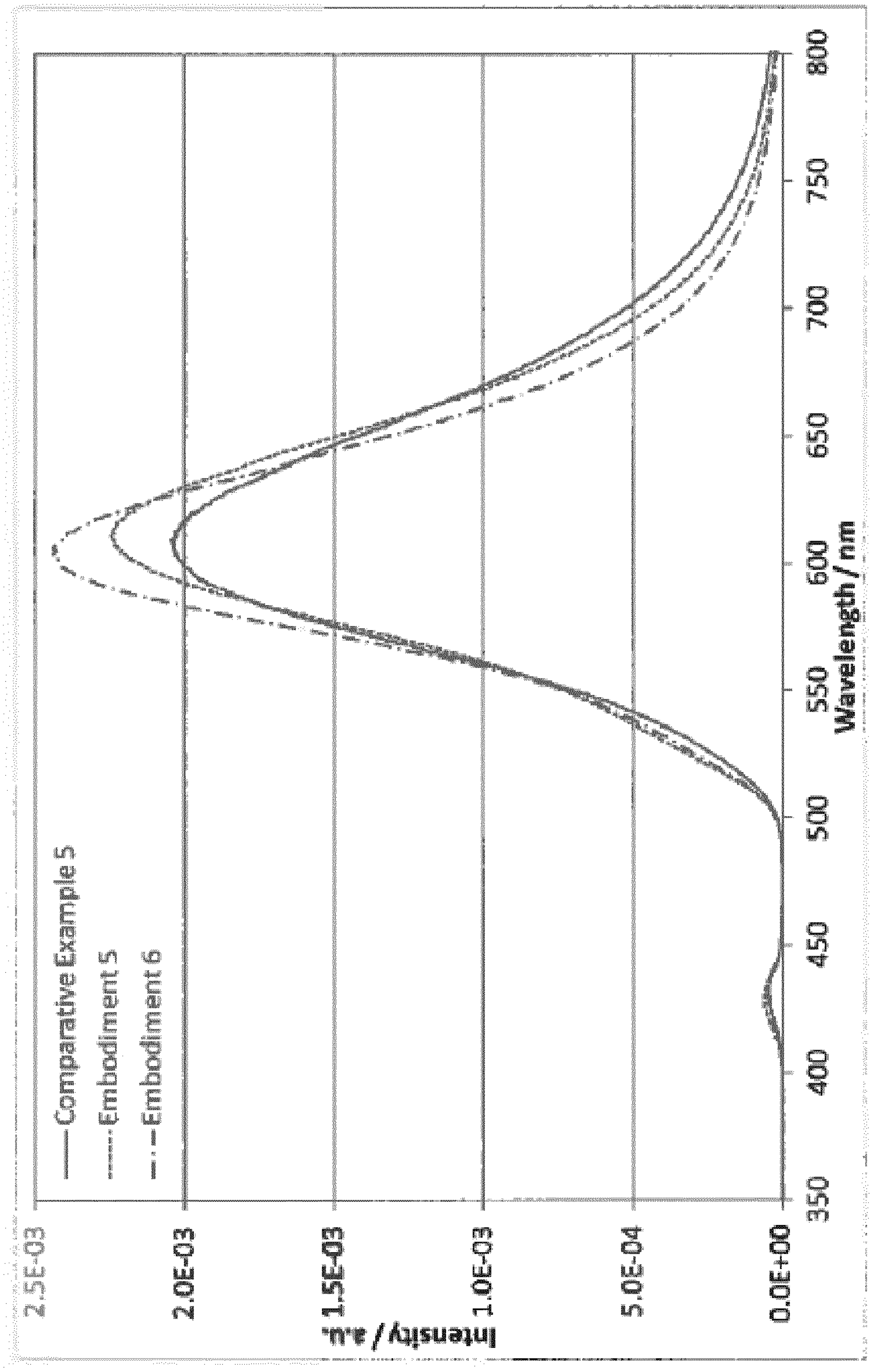
Comparative Example 5
Embodiment 5
Embodiment 6
Intensity / a.u.
2.5E-03
2.0E-03
1.5E-03
1.0E-03
5.0E-04
0.0E+00
350
400
450
500
550
600
650
700
750
800
Wavelength / nm

Fig. 45a

| Beispiel | $\lambda_{dom(blaue LED)}$ | Zusammensetzung roter Leuchtstoff | Leuchtstoff-Konzentration (Gew%) | λdom | CIE-x | CIE-y |
|---|---|---|---|---|---|---|
| **Ausführungsbsp. 1** | 446,9 | $Sr(Sr_{0,86}Ca_{0,14})Si_2Al_2N_6$: Eu (10% Eu) | 15,5% | 621,2 nm | 0,682 | 0,307 |
| **Ausführungsbsp. 2** | 446,9 | $Sr(Sr_{0,86}Ca_{0,14})Si_2Al_2N_6$: Eu (10% Eu) | 17,0% | 621,2 nm | 0,690 | 0,306 |
| **Ausführungsbsp. 3** | 446,9 | $Sr(Sr_{0,86}Ca_{0,14})Si_2Al_2N_6$: Eu (20% Eu) | 19,3% | 632,3 nm | 0,698 | 0,291 |

Fig. 45b

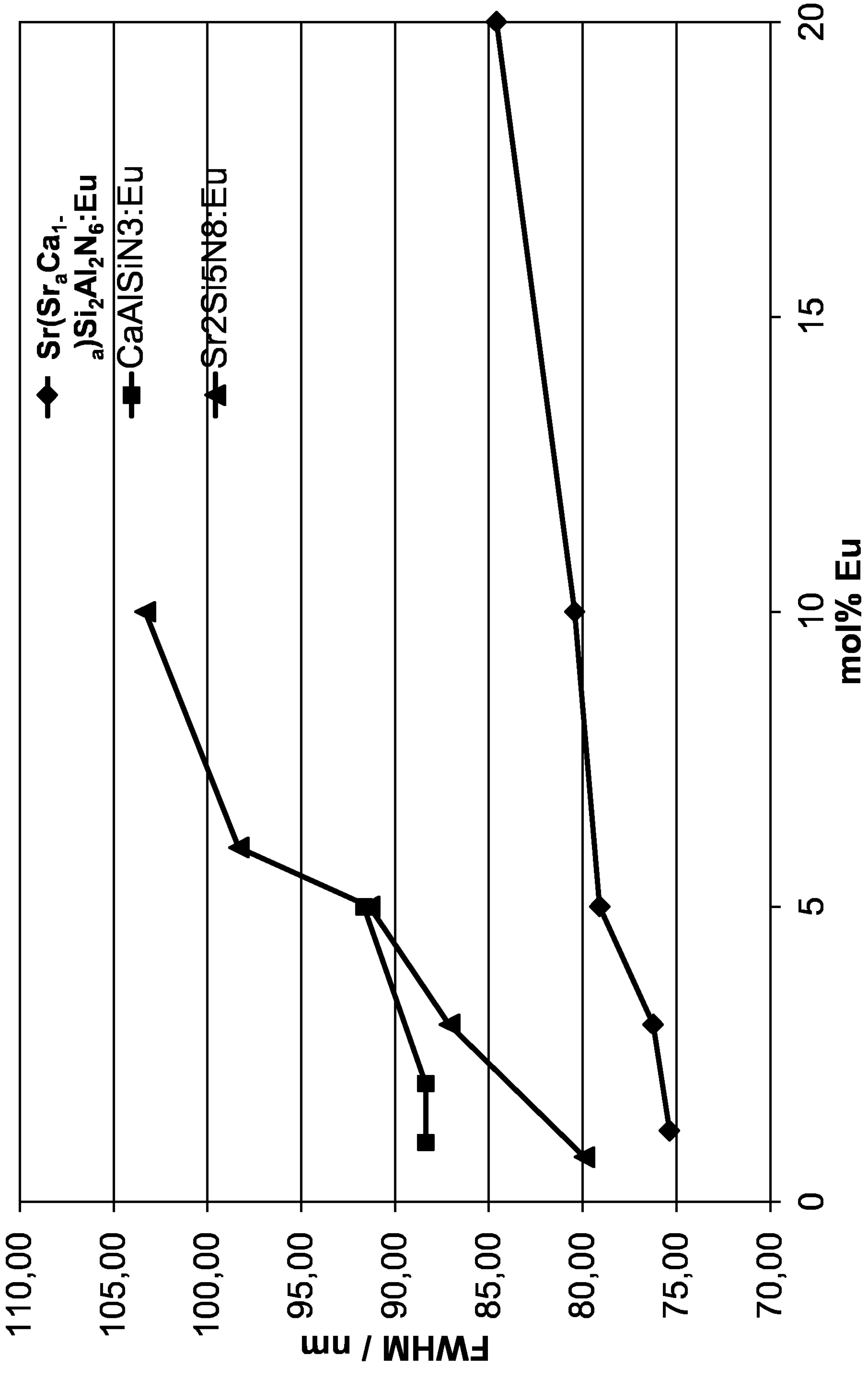
FWHM / nm
110,00
105,00
100,00
95,00
90,00
85,00
80,00
75,00
70,00
0
5
10
15
20
mol% Eu
Sr(Sr$_a$Ca$_{1-a}$)Si$_2$Al$_2$N$_6$:Eu
CaAlSiN3:Eu
Sr2Si5N8:Eu

Fig. 45c

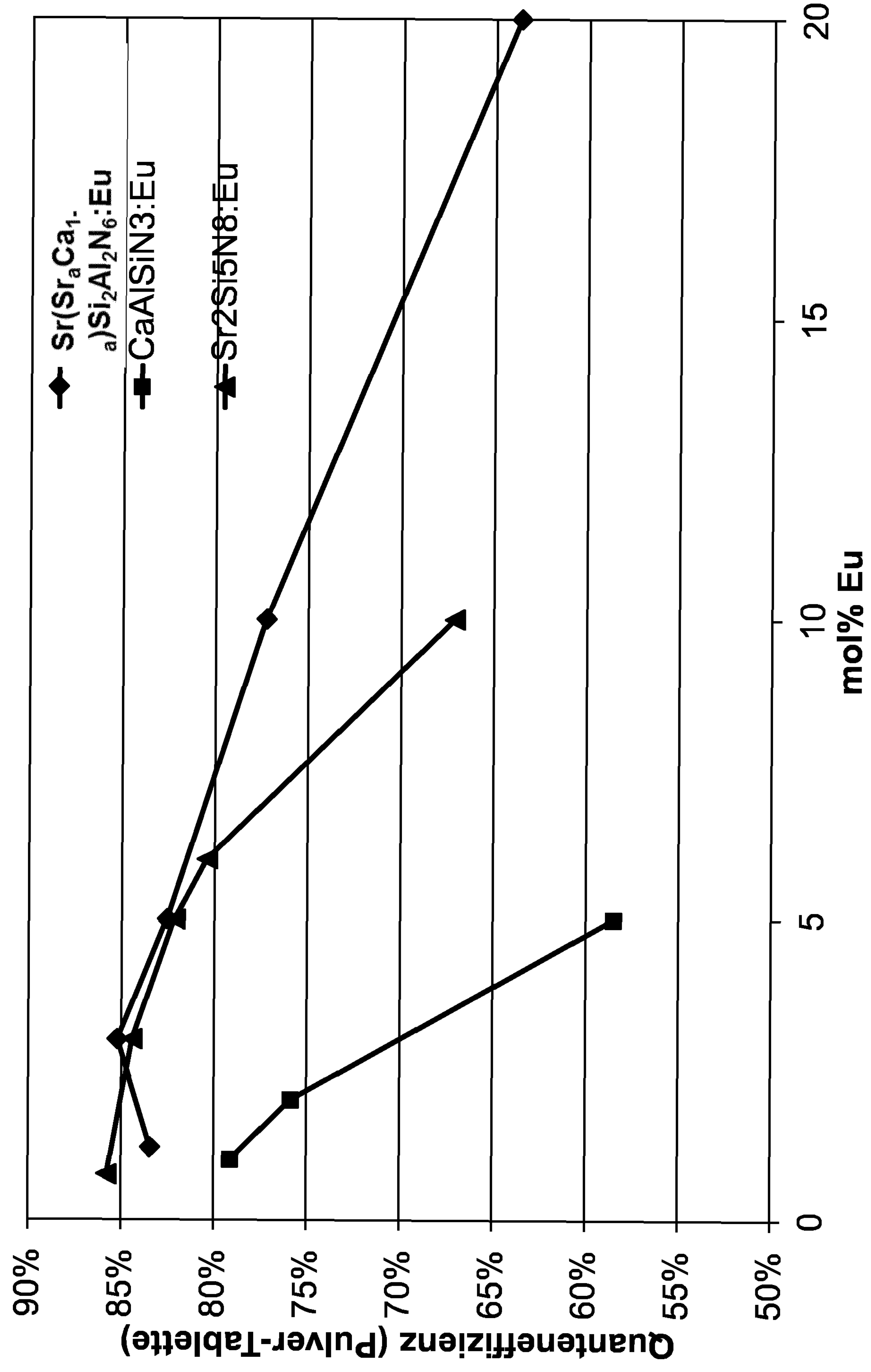
Quanteneffizienz (Pulver-Tablette)
90%
85%
80%
75%
70%
65%
60%
55%
50%
0
5
10
15
20
mol% Eu
Sr(SraCa1-a)Si2Al2N6:Eu
CaAlSiN3:Eu
Sr2Si5N8:Eu

Fig. 45d

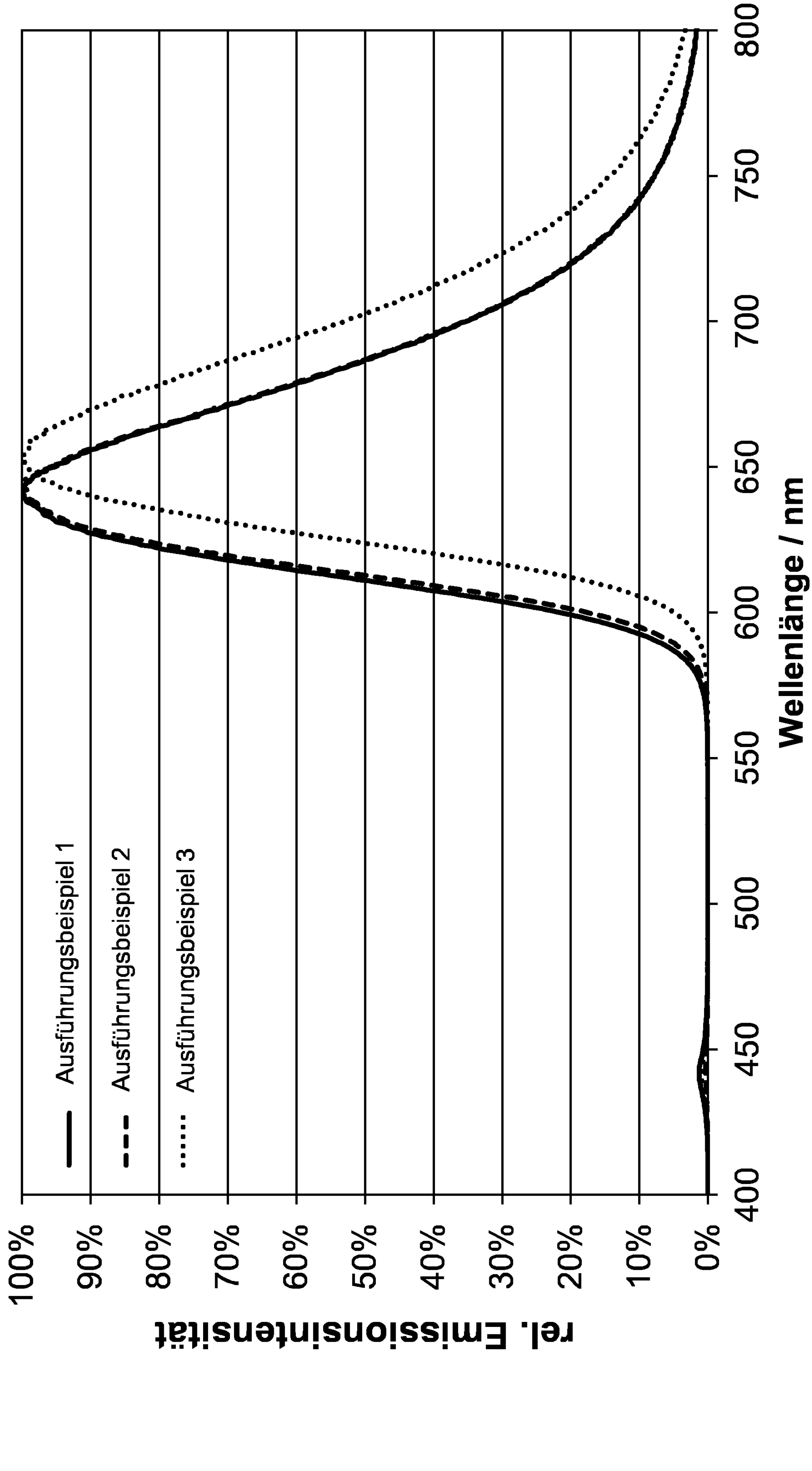
rel. Emissionsintensität
100%
90%
80%
70%
60%
50%
40%
30%
20%
10%
0%
400
450
500
550
600
650
700
750
800
Wellenlänge / nm
Ausführungsbeispiel 1
Ausführungsbeispiel 2
Ausführungsbeispiel 3

Fig. 46a

| Beispiel | $\lambda_{dom(blaue\ LED)}$ bei 350mA | Zusammensetzung gelber Leuchtstoff | Zusammensetzung roter Leuchtstoff | Gesamtkonz. Leuchtstoff (Gew%) | Verhältnis gelb/ rot |
|---|---|---|---|---|---|
| **Vgbl. 1** | 444,5 | $(Lu_{0,8}Y_{0,2})_3Al_5O_{12}$: Ce (4,5% Ce) | $(Ca_{0,025}Sr_{0,475}Ba_{0,5})_2Si_5N_8$:Eu (2,5% Eu) | 19,9% | 7,0 |
| **Vgbl. 2** | 444,6 | $(Lu_{0,85}Y_{0,15})_3Al_5O_{12}$: Ce (3% Ce) | $(Sr_{0,5}Ba_{0,5})_2 Si_5N_8$:Eu (1% Eu) | 17,7% | 3,0 |
| **Ausführungsbsp. 1** | 444,6 | $(Lu_{0,85}Y_{0,15})_3Al_5O_{12}$: Ce (3% Ce) | $Sr(Sr_{0,86}Ca_{0,14})Si_2Al_2N_6$: Eu (0,4% Eu) | 17,7% | 3,0 |
| **Ausführungsbsp. 2** | 444,4 | $(Lu_{0,85}Y_{0,15})_3Al_5O_{12}$: Ce (3% Ce) | $Sr(Sr_{0,86}Ca_{0,14})Si_2Al_2N_6$: Eu (1,2% Eu) | 17,7% | 8,1 |
| **Ausführungsbsp. 3** | 444,5 | $Y_3(Al_{0,70}Ga_{0,30})_5O_{12}$: Ce (3% Ce) | $Sr(Sr_{0,86}Ca_{0,14})Si_2Al_2N_6$: Eu (1,2% Eu) | 9,8% | 4,0 |
| **Ausführungsbsp. 4** | 444,5 | $Y_{03}(Al_{0,75}Ga_{0,25})_5O_{12}$: Ce (3% Ce) | $Sr(Sr_{0,86}Ca_{0,14})Si_2Al_2N_6$: Eu (1,2% Eu) | 9,8% | 4,2 |

Fig. 46b

| Beispiel | CIE-x | CIE-y | CRI | Rel. $\Phi_{v(gefüllter Verguß)}$/ $\Phi_{e(klarer Verguß)}$ | Rel. $\Phi_{v(gefüllter Verguß)}$/ $\Phi_{e(klarer Verguß)}$ (Farbpunktkorr.) |
|---|---|---|---|---|---|
| Vgbl. 1 | 0,435 | 0,403 | 69 | 100% | 100% |
| Vgbl. 2 | 0,433 | 0,405 | 69 | 104,1% | 103,4% |
| Ausführungsbsp. 1 | 0,435 | 0,401 | 70 | 103% | 103,4% |
| Ausführungsbsp. 2 | 0,434 | 0,402 | 76 | 100,6% | 100,7% |
| Ausführungsbsp. 3 | 0,435 | 0,402 | 75 | 102,1% | 102,4% |
| Ausführungsbsp. 4 | 0,434 | 0,403 | 74 | 101,2% | 101,1% |

Fig. 46c

| Beispiel | CIE-x | CIE-y | CRI | Rel. $\Phi_{v(gefüllter\ Verguß)}/\Phi_{e(klarer\ Verguß)}$ | Rel. $\Phi_{v(gefüllter\ Verguß)}/\Phi_{e(klarer\ Verguß)}$ (Farbpunktkorr.) |
|---|---|---|---|---|---|
| Vgbl. 1 | 0,430 | 0,401 | 69 | 100% | 100% |
| Vgbl. 2 | 0,429 | 0,402 | 69 | 104,4% | 104,6% |
| Ausführungsbsp. 1 | 0,433 | 0,399 | 71 | 104,1% | 105,4% |
| Ausführungsbsp. 2 | 0,430 | 0,400 | 75 | 101,6% | 101,9% |
| Ausführungsbsp. 3 | 0,432 | 0,400 | 75 | 104,4% | 105,4% |
| Ausführungsbsp. 4 | 0,431 | 0,401 | 74 | 102,7% | 103,5% |

Fig. 46d

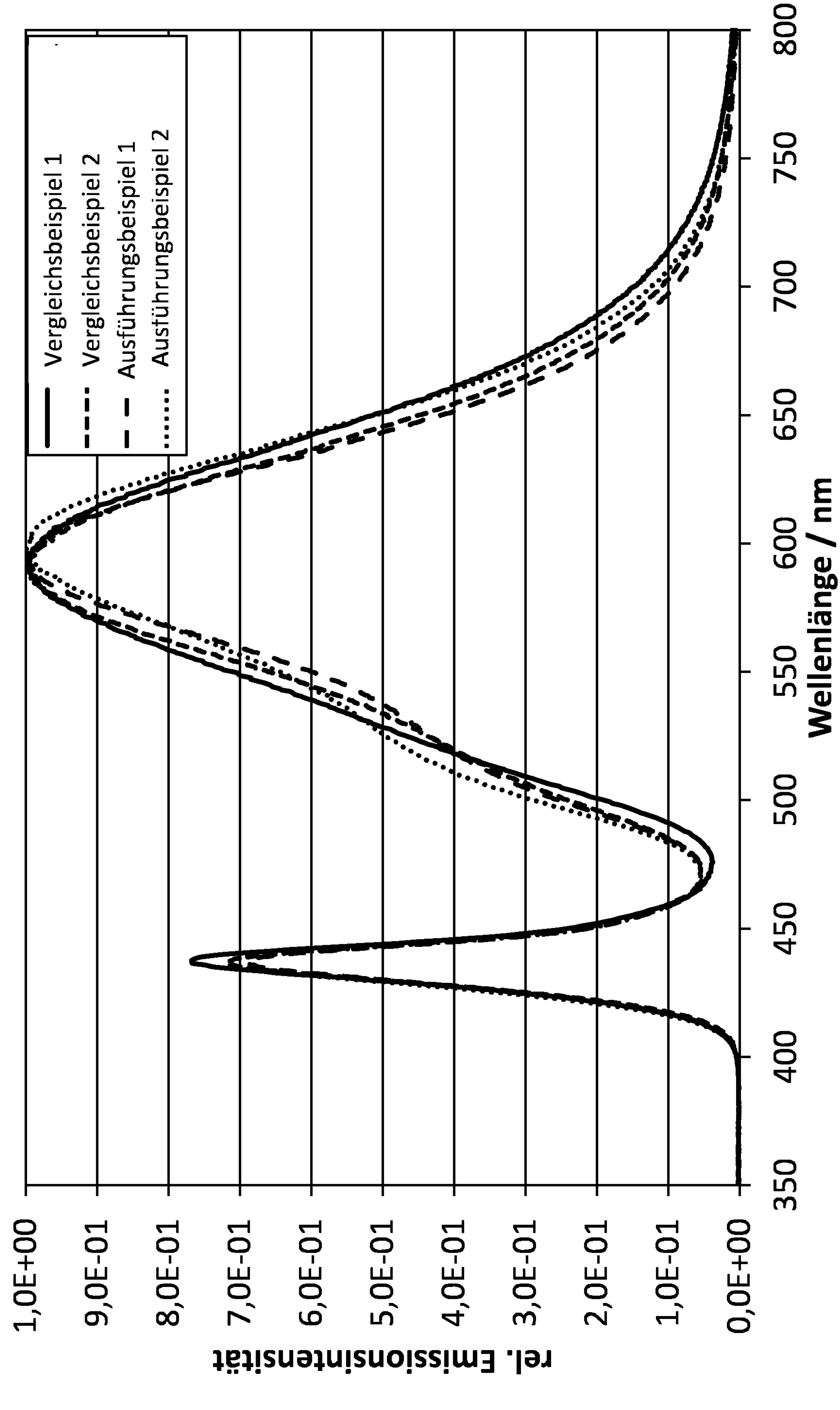
rel. Emissionsintensität
1,0E+00
9,0E-01
8,0E-01
7,0E-01
6,0E-01
5,0E-01
4,0E-01
3,0E-01
2,0E-01
1,0E-01
0,0E+00
350
400
450
500
550
600
650
700
750
800
Wellenlänge / nm
Vergleichsbeispiel 1
Vergleichsbeispiel 2
Ausführungsbeispiel 1
Ausführungsbeispiel 2

Fig. 46e

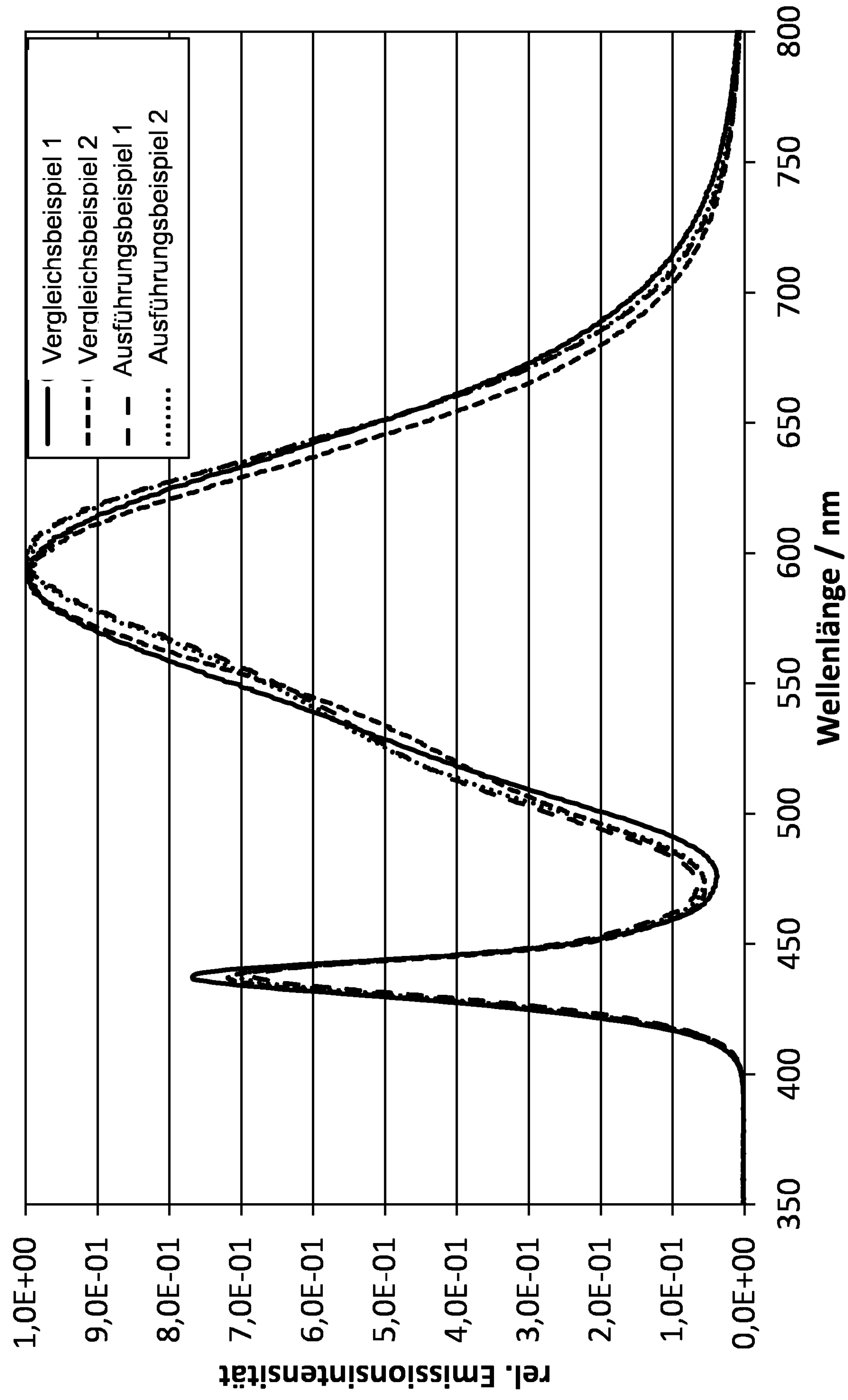
rel. Emissionsintensität
1,0E+00
9,0E-01
8,0E-01
7,0E-01
6,0E-01
5,0E-01
4,0E-01
3,0E-01
2,0E-01
1,0E-01
0,0E+00
350
400
450
500
550
600
650
700
750
800
Wellenlänge / nm
Vergleichsbeispiel 1
Vergleichsbeispiel 2
Ausführungsbeispiel 1
Ausführungsbeispiel 2

Fig. 47a

| Beispiel | CIE-x | CIE-y | CRI | Rel. $\Phi_{v(gefüllter Verguß)}/\Phi_{e(klarer Verguß)}$ | Rel. Vs |
|---|---|---|---|---|---|
| Vgbl. 1 | 0,379 | 0,377 | 71 | 100% | 100% |
| Ausführungsbsp. 1 | 0,380 | 0,378 | 70 | 100,7% | 101,3% |

Fig. 47b

| Beispiel | T (°C) | $\lambda_{dom}$ LED | CIE-x | CIE-y | CRI | Rel. $\Phi_{v(gefüllter Verguß)}/\Phi_{e(klarer Verguß)}$ | Rel. Vs |
|---|---|---|---|---|---|---|---|
| **Vgbl. 1** | 25 | 444,8 | 0,372 | 0,368 | 71 | 100% | 100% |
| | 85 | 447,8 | 0,369 | 0,370 | 72 | 101,6% | 100,9% |
| **Ausführungsbsp. 1** | 25 | 445,0 | 0,373 | 0,370 | 71 | 101,3% | 101,5% |
| | 85 | 448,0 | 0,368 | 0,371 | 71 | 101,3% | 101,6% |

Fig. 47c

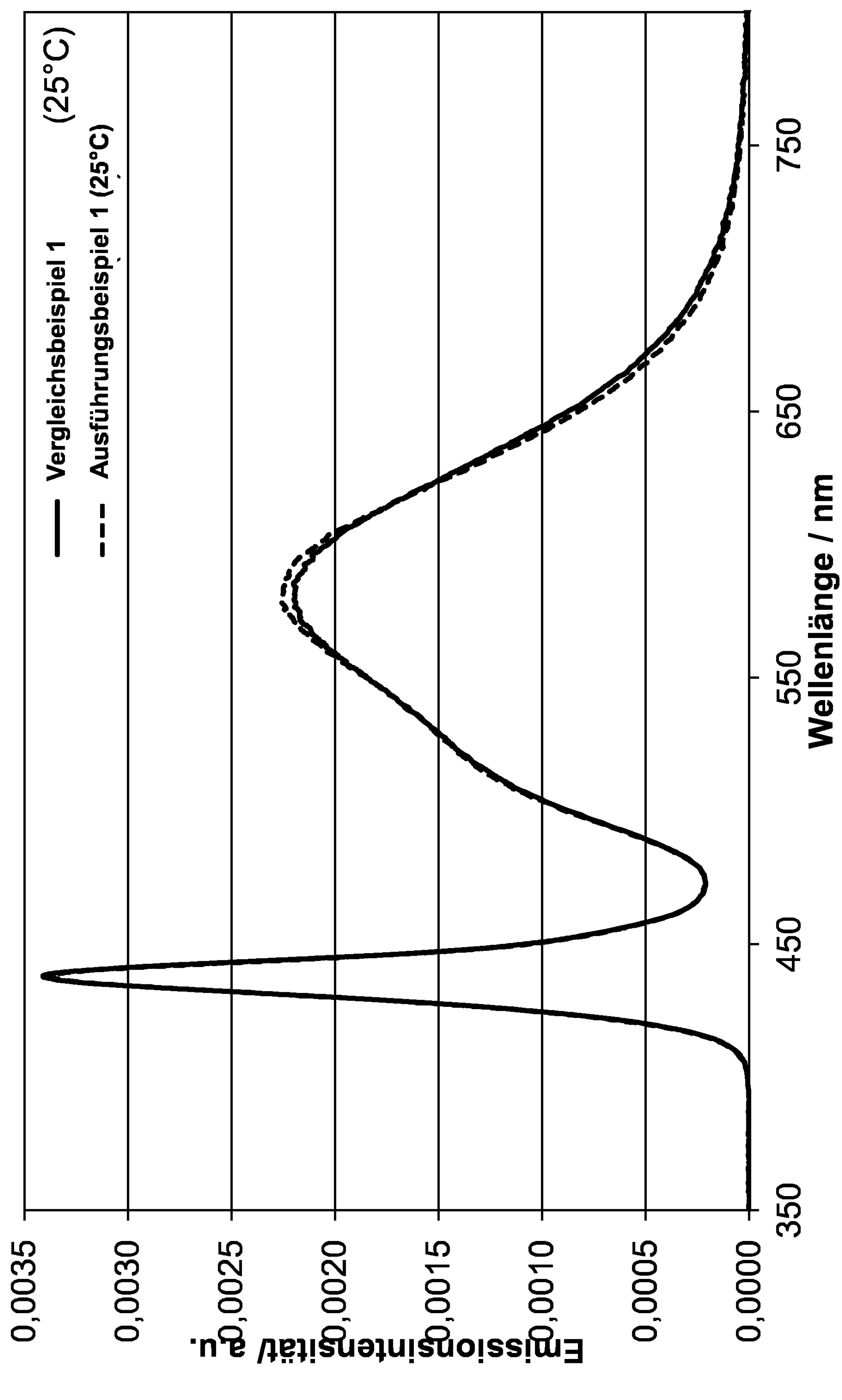
(25°C)
Vergleichsbeispiel 1
Ausführungsbeispiel 1 (25°C)
Emissionsintensität/ a.u.
0,0000
0,0005
0,0010
0,0015
0,0020
0,0025
0,0030
0,0035
350
450
550
650
750
Wellenlänge / nm

Fig. 47d

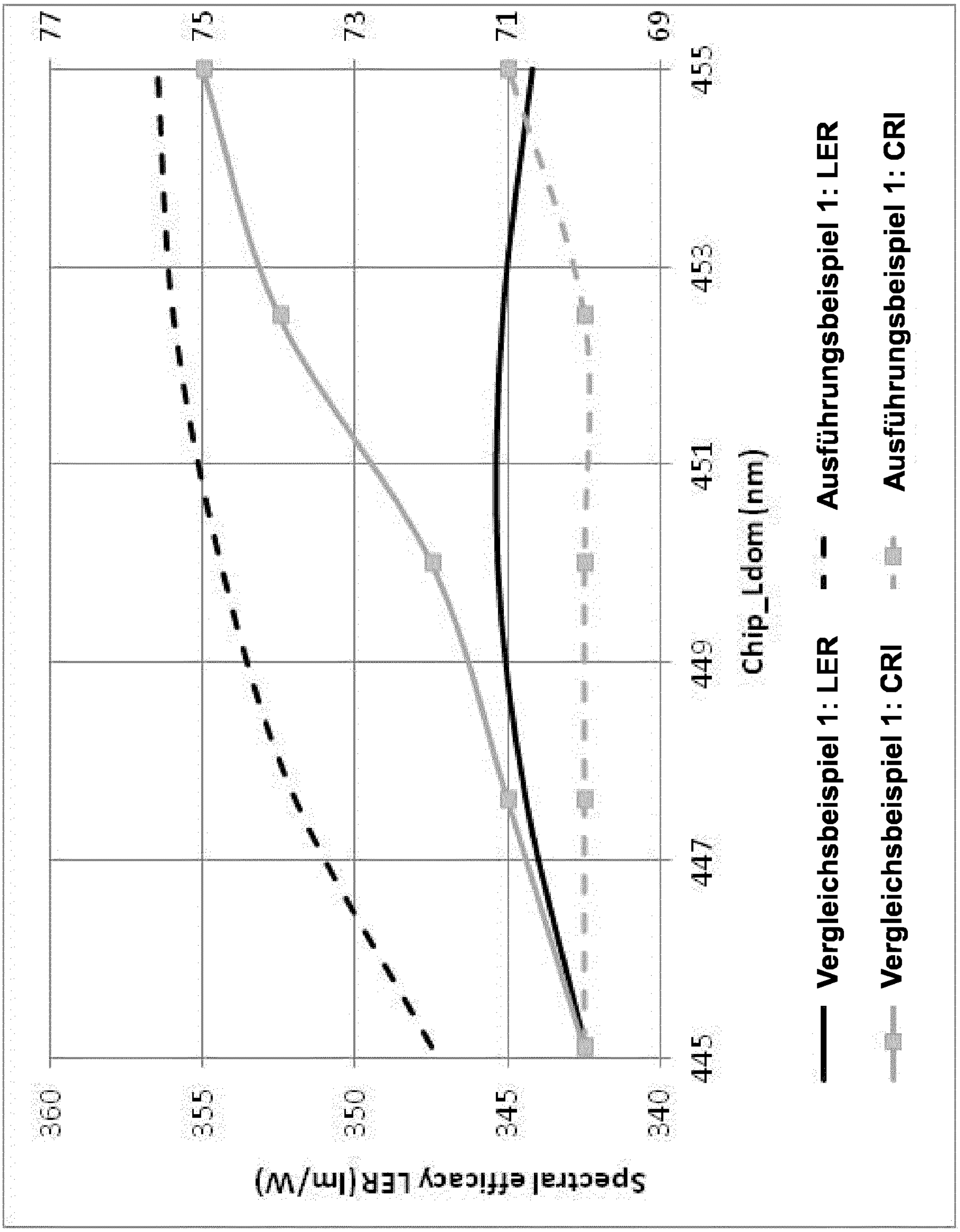
Spectral efficacy LER (lm/W)
360
355
350
345
340
77
75
73
71
69
445
447
449
451
453
455
Chip_Ldom (nm)
Vergleichsbeispiel 1: LER
Vergleichsbeispiel 1: CRI
Ausführungsbeispiel 1: LER
Ausführungsbeispiel 1: CRI

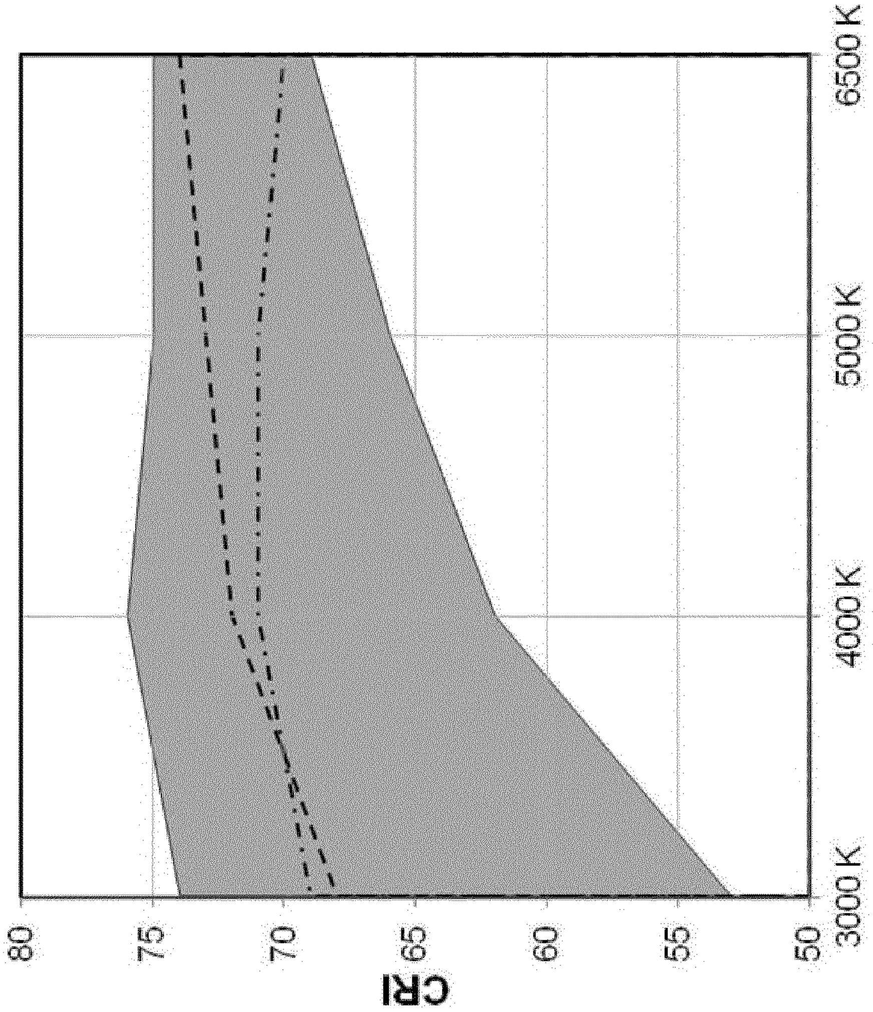


Fig. 47e

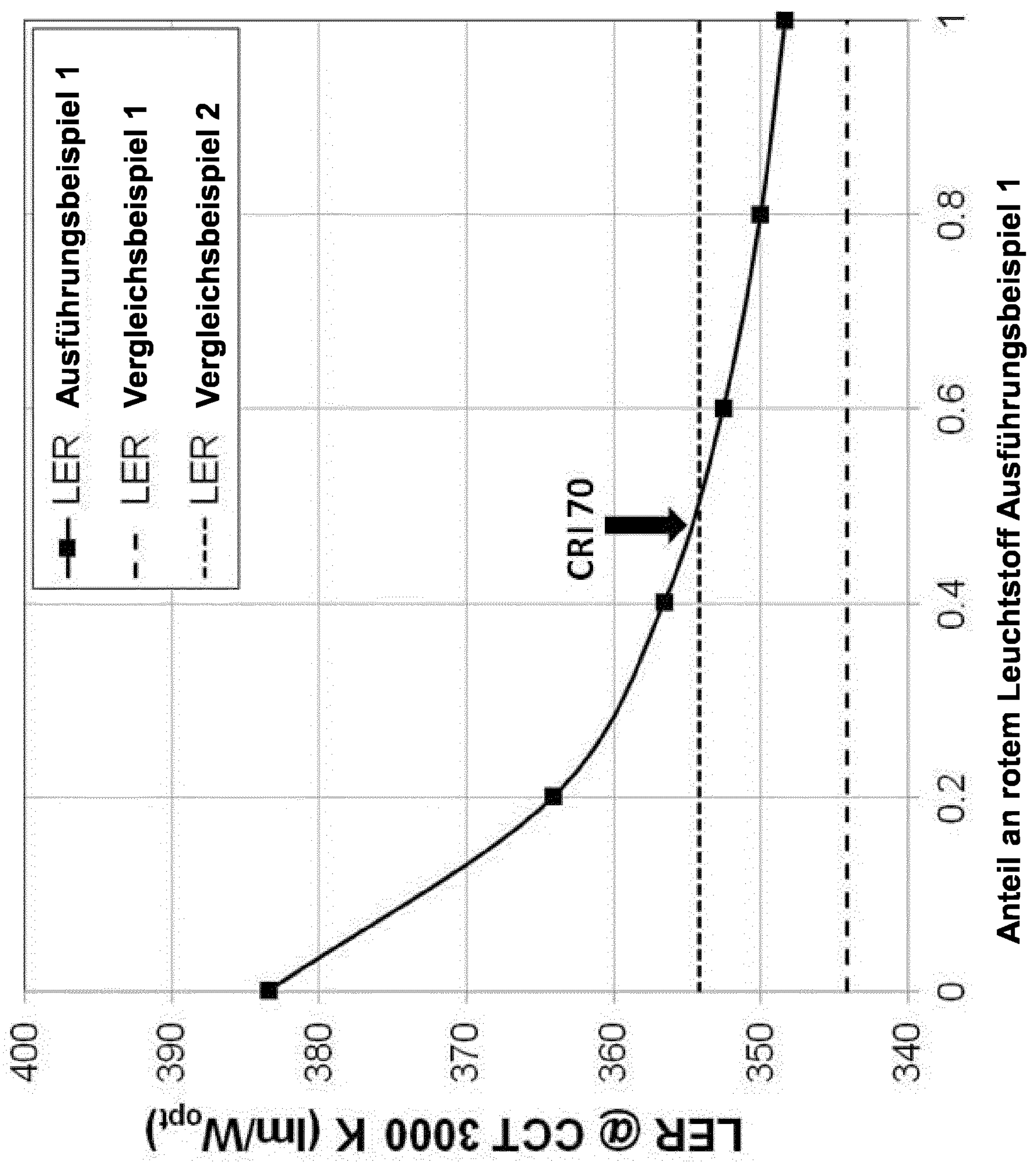
LER Ausführungsbeispiel 1
LER Vergleichsbeispiel 1
LER Vergleichsbeispiel 2
CRI 70
LER @ CCT 3000 K (lm/W$_{opt}$)
400
390
380
370
360
350
340
0
0.2
0.4
0.6
0.8
1
Anteil an rotem Leuchtstoff Ausführungsbeispiel 1

Fig. 47f

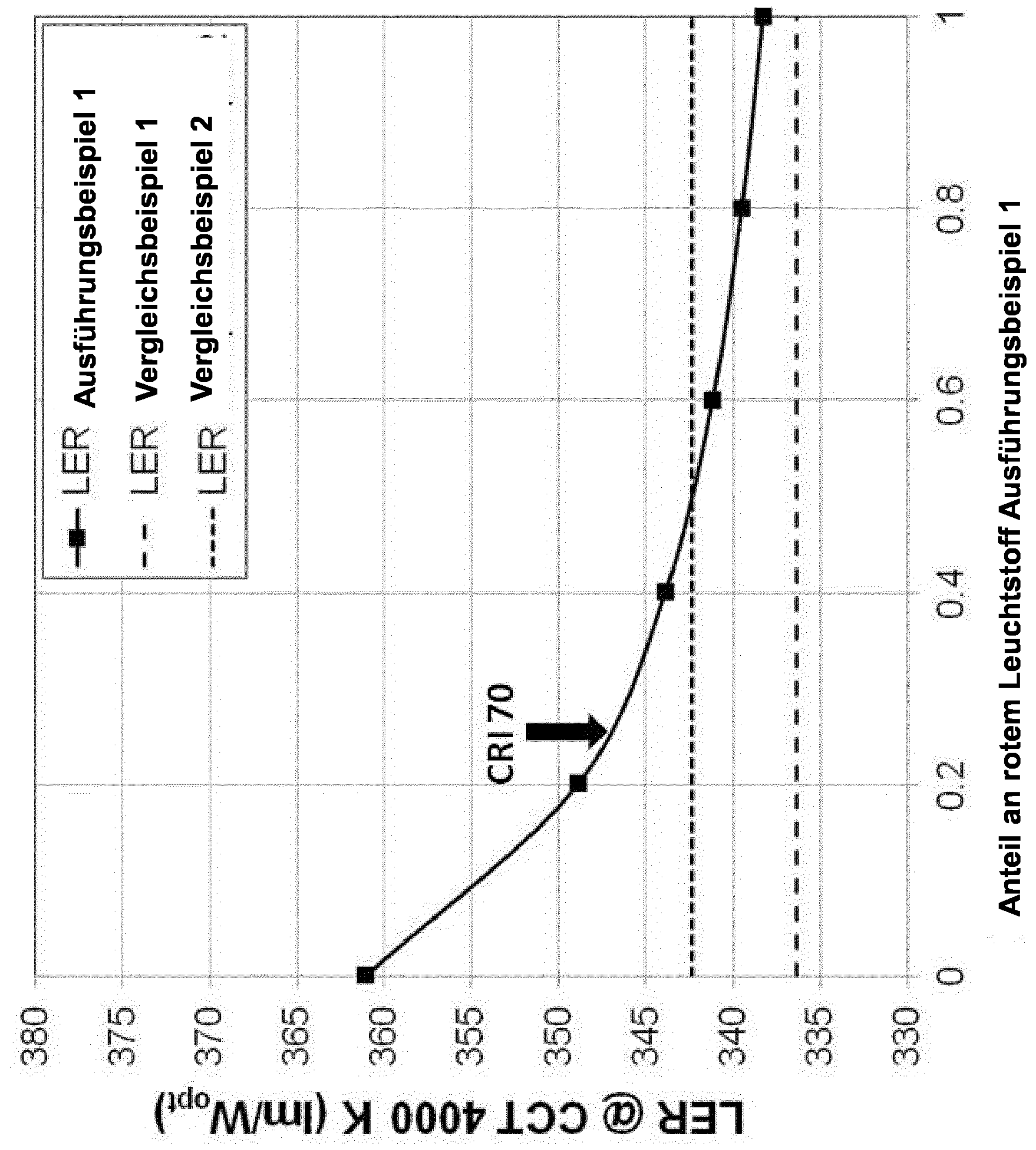
LER Ausführungsbeispiel 1
LER Vergleichsbeispiel 1
LER Vergleichsbeispiel 2
CRI 70
LER @ CCT 4000 K (lm/W$_{opt}$)
380
375
370
365
360
355
350
345
340
335
330
0
0.2
0.4
0.6
0.8
1
Anteil an rotem Leuchtstoff Ausführungsbeispiel 1

Fig. 47g

Fig. 47h

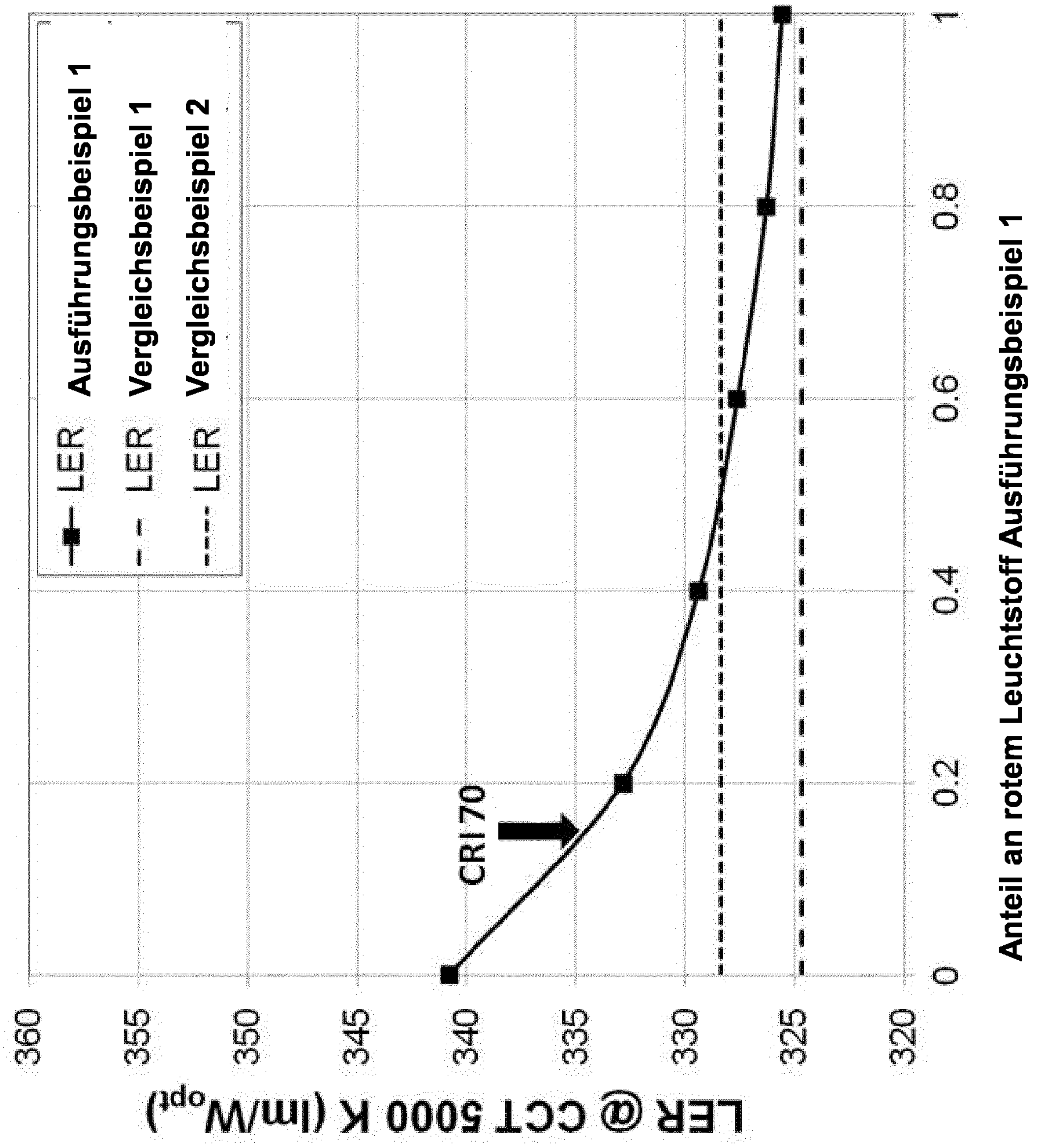
LER Ausführungsbeispiel 1
LER Vergleichsbeispiel 1
LER Vergleichsbeispiel 2
CRI 70
LER @ CCT 5000 K (lm/W$_{opt}$)
360
355
350
345
340
335
330
325
320
0
0.2
0.4
0.6
0.8
1
Anteil an rotem Leuchtstoff Ausführungsbeispiel 1

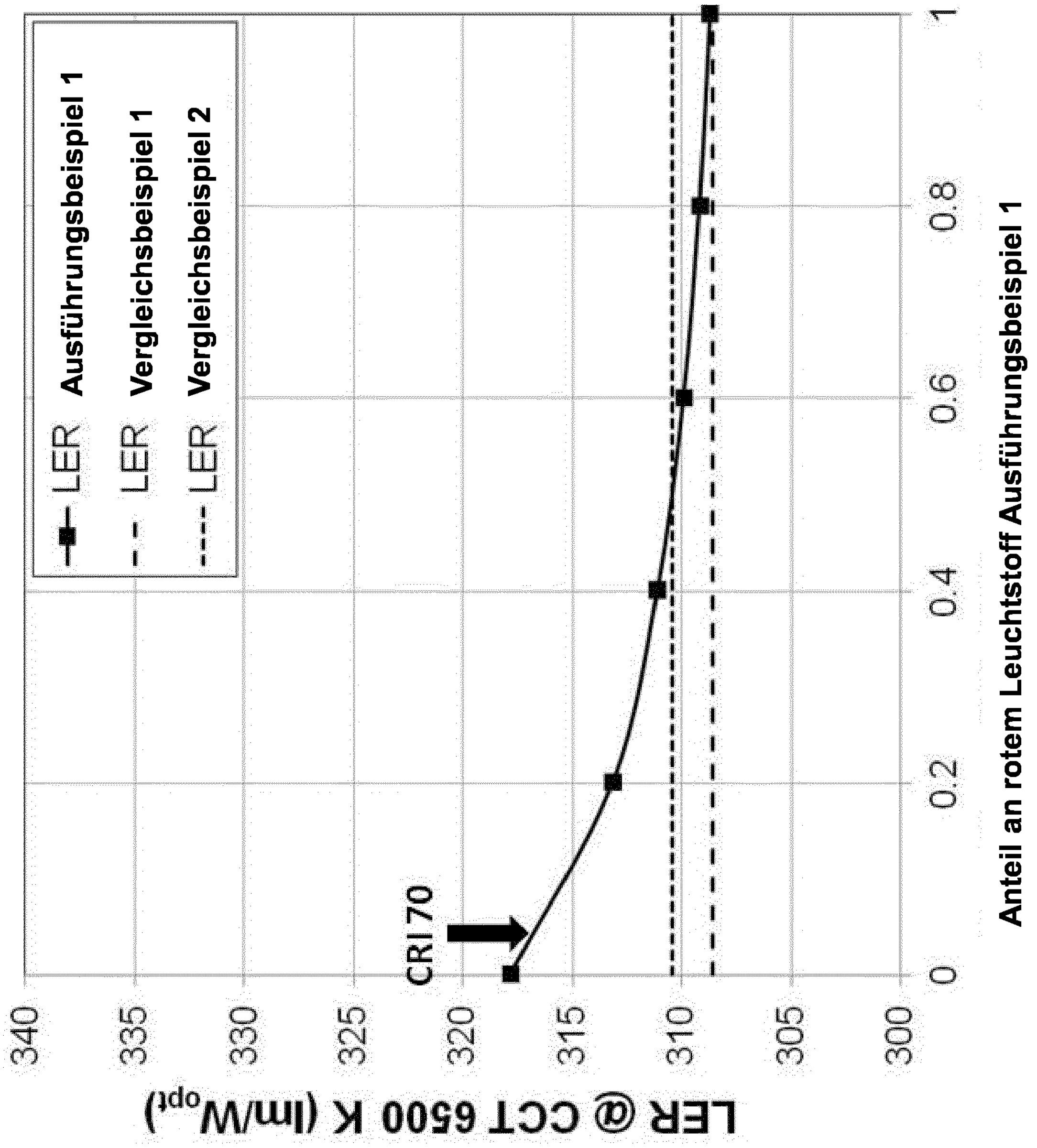
LER Ausführungsbeispiel 1
LER Vergleichsbeispiel 1
LER Vergleichsbeispiel 2
CRI 70
LER @ CCT 6500 K (lm/W$_{opt}$)
340
335
330
325
320
315
310
305
300
0
0.2
0.4
0.6
0.8
1
Anteil an rotem Leuchtstoff Ausführungsbeispiel 1

Fig. 47i

Fig. 48a

| phosphor | nominal composition | CIE x | CIE y | dominant wavelength / nm | FWHM / nm | LER / lm/W | relative LER | relative ext. QE |
|---|---|---|---|---|---|---|---|---|
| comparative example 1 | CaAlSiN3:Eu | 0,656 | 0,341 | 607,9 | 89 | 132 | 100% | 100% |
| embodiment 1 | Sr(Sr0.8Ca0.2)Si2Al2N6:Eu (3.7%) | 0,659 | 0,340 | 608,2 | 78 | 172 | 130% | 125% |
| embodiment 2 | Sr(Sr0.86Ca0.14)Si2Al2N6:Eu (10%) | 0,675 | 0,324 | 613,4 | 80 | 127 | 96% | 120% |
| embodiment 3 | Sr(Sr0.86Ca0.14)Si2Al2N6:Eu (20%) | 0,687 | 0,311 | 618,8 | 85 | 88 | 66% | 99% |

Fig. 48b

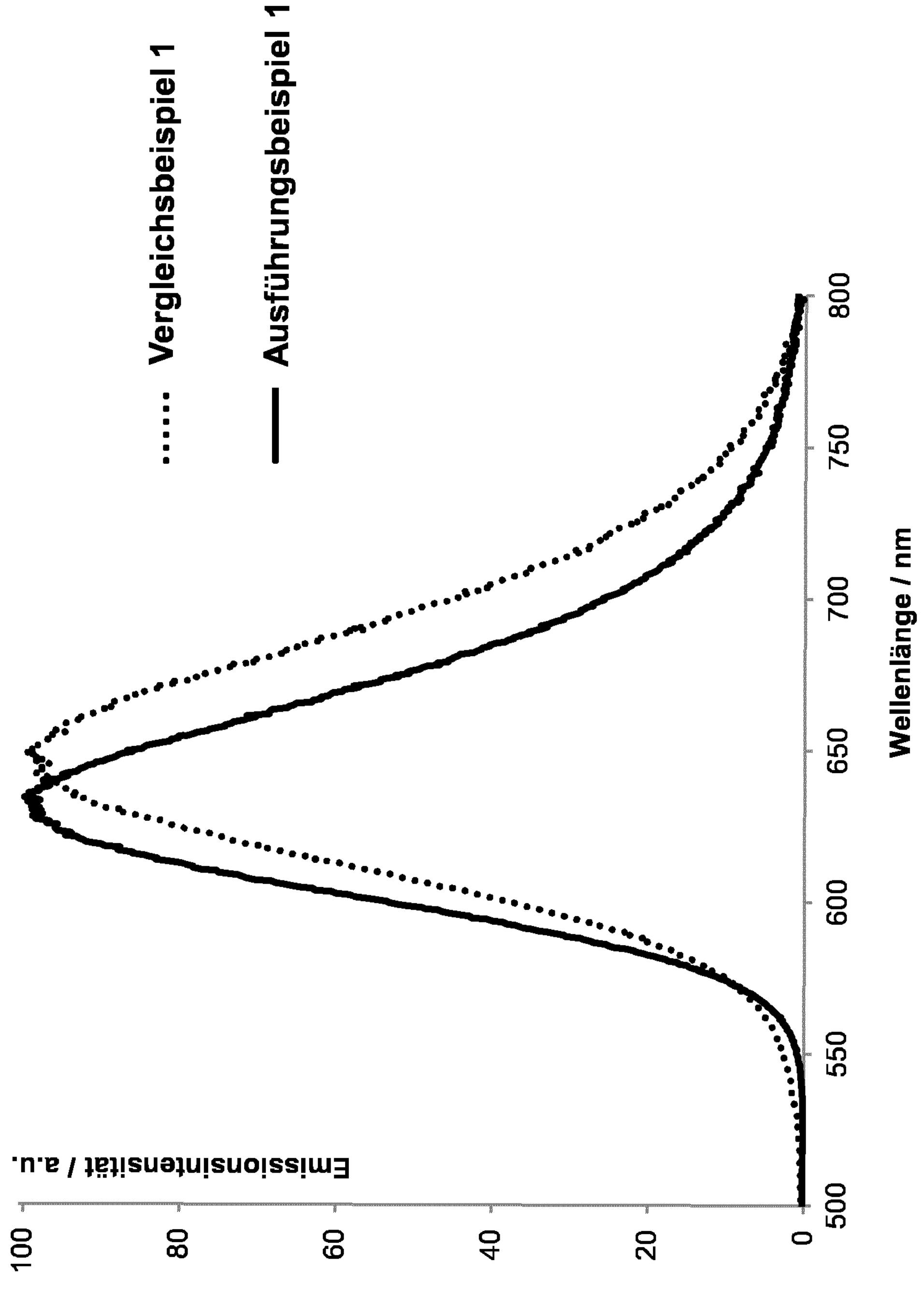
Emissionsintensität / a.u.
0
20
40
60
80
100
500
550
600
650
700
750
800
Wellenlänge / nm
Vergleichsbeispiel 1
Ausführungsbeispiel 1

Fig. 48c

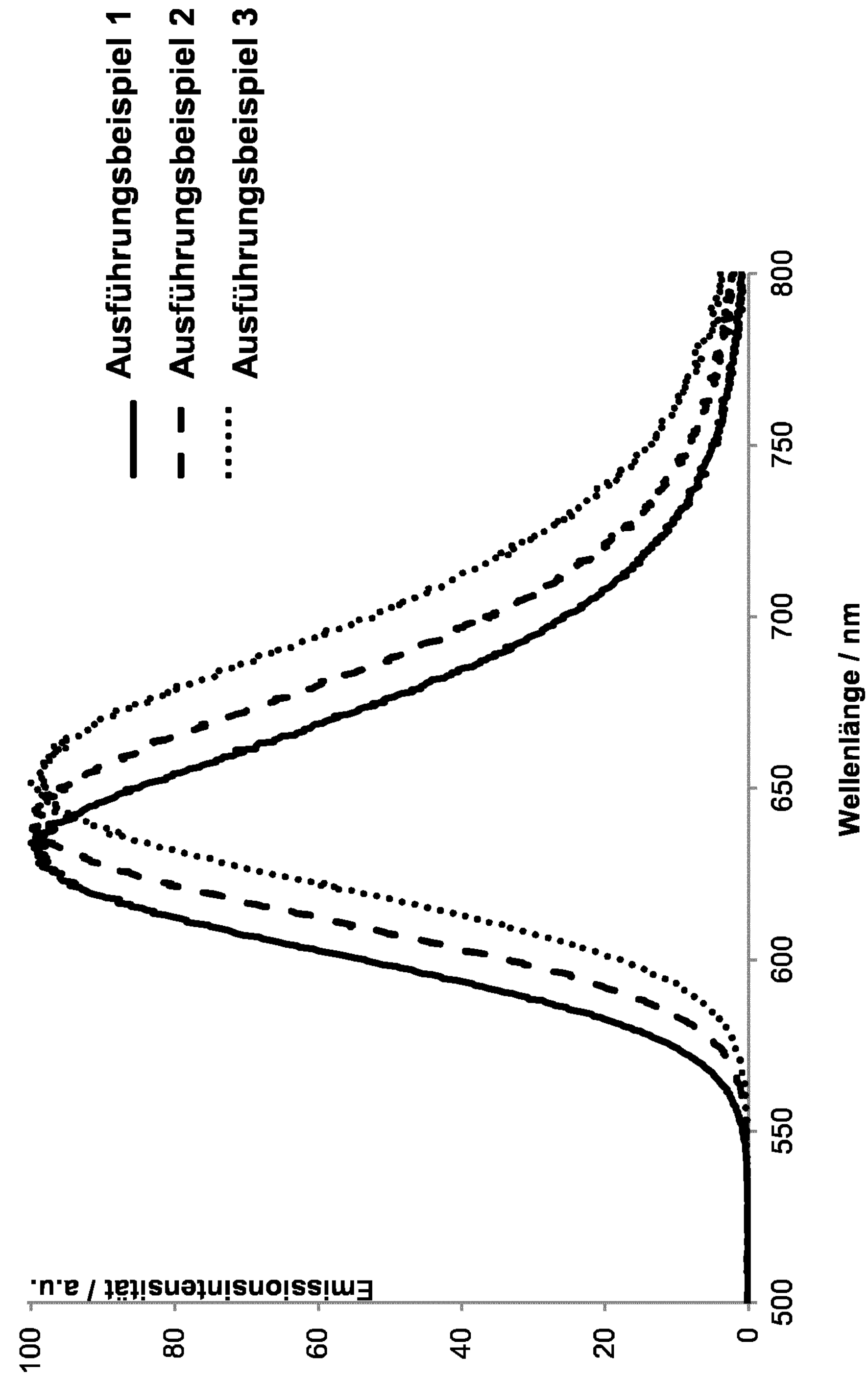
Ausführungsbeispiel 1
Ausführungsbeispiel 2
Ausführungsbeispiel 3
Emissionsintensität / a.u.
0
20
40
60
80
100
500
550
600
650
700
750
800
Wellenlänge / nm

Fig. 48d

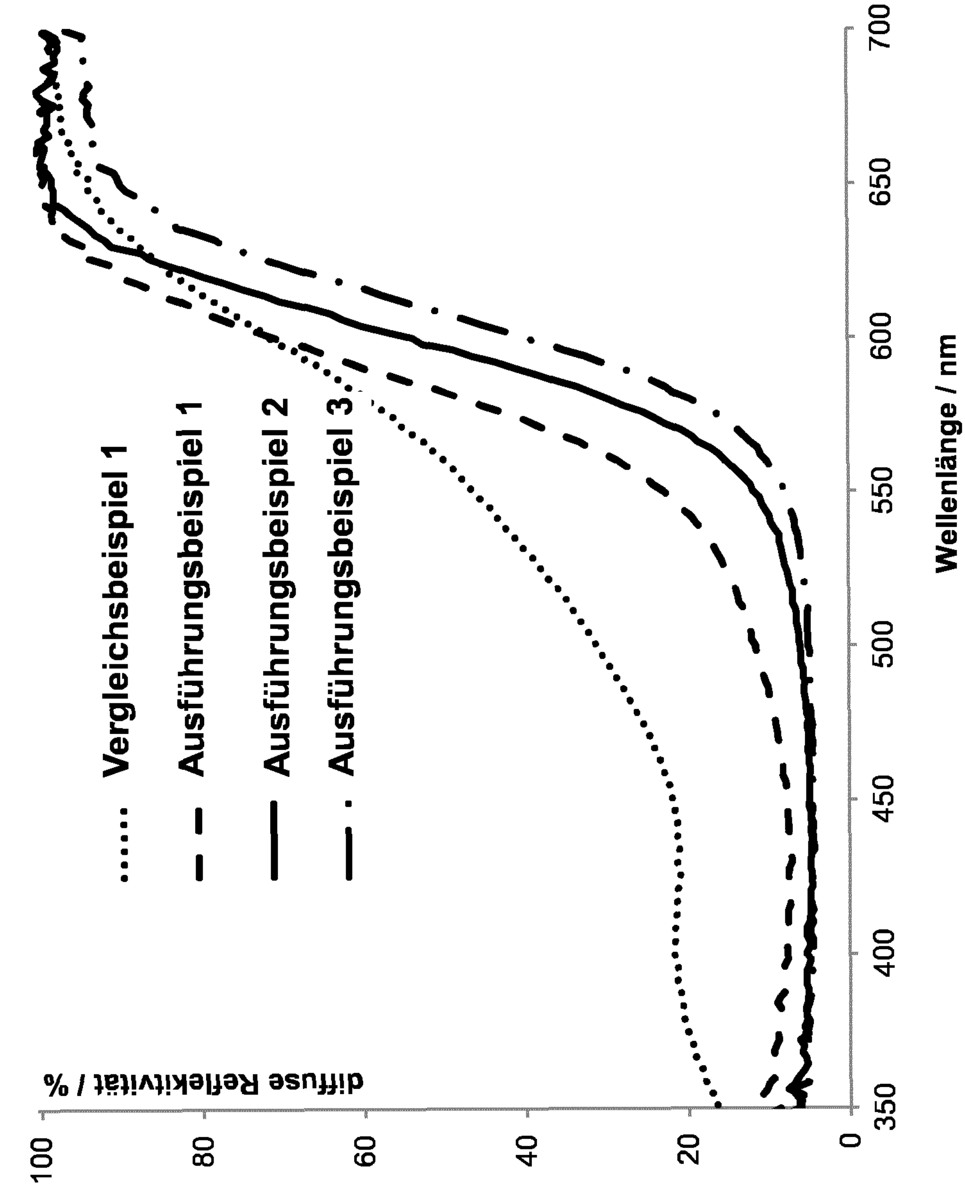
Vergleichsbeispiel 1
Ausführungsbeispiel 1
Ausführungsbeispiel 2
Ausführungsbeispiel 3
diffuse Reflektivität / %
0
20
40
60
80
100
350
400
450
500
550
600
650
700
Wellenlänge / nm

# Fig. 48e

| solution | comparative example LED1 | embodiment LED1 |
|---|---|---|
| LED dominant wavelength / nm | 452,3 | 452,3 |
| green phosphor | LuAG:Ce | LuAG:Ce |
| red phosphor | CaAlSiN3:Eu | Sr(Sr0.8Ca0.2)Si2Al2N6:Eu (3.7%) |
| total phosphor concentration | 11,8% | 13,0% |
| green:red ratio | 6,3:1 | 31:1 |
| CIE x/y (unfiltered) | 0,286 / 0,273 | 0,286 / 0,272 |
| CIE u'v' (unfiltered) | 0,200 / 0,431 | 0,201 / 0,430 |
| CIE x/y (red channel, filtered) | 0,653 / 0,330 | 0,650 / 0,333 |
| CIE x/y (green channel, filtered) | 0,292 / 0,590 | 0,295 / 0,587 |
| CIE x/y (blue channel, filtered) | 0,149 / 0,063 | 0,149 / 0,062 |
| CIE u'/v' (red channel, filtered) | 0,463 / 0,525 | 0,456 / 0,526 |
| CIE u'/v'(green channel, filtered) | 0,123 / 0,559 | 0,125 / 0,559 |
| CIE u'/v' (blue channel, filtered) | 0,173 / 0,164 | 0,173 / 0,163 |
| color gamut overlap vs. sRGB / rec. 709 in x/y color space | 98,2% | 98,0% |
| color gamut overlap vs. sRGB / rec. 709 in u'v' color space | 98,7% | 98,3% |
| relative conversion efficiency | 100% | 105% |
| relative LER | 100% | 104% |

Fig. 48f

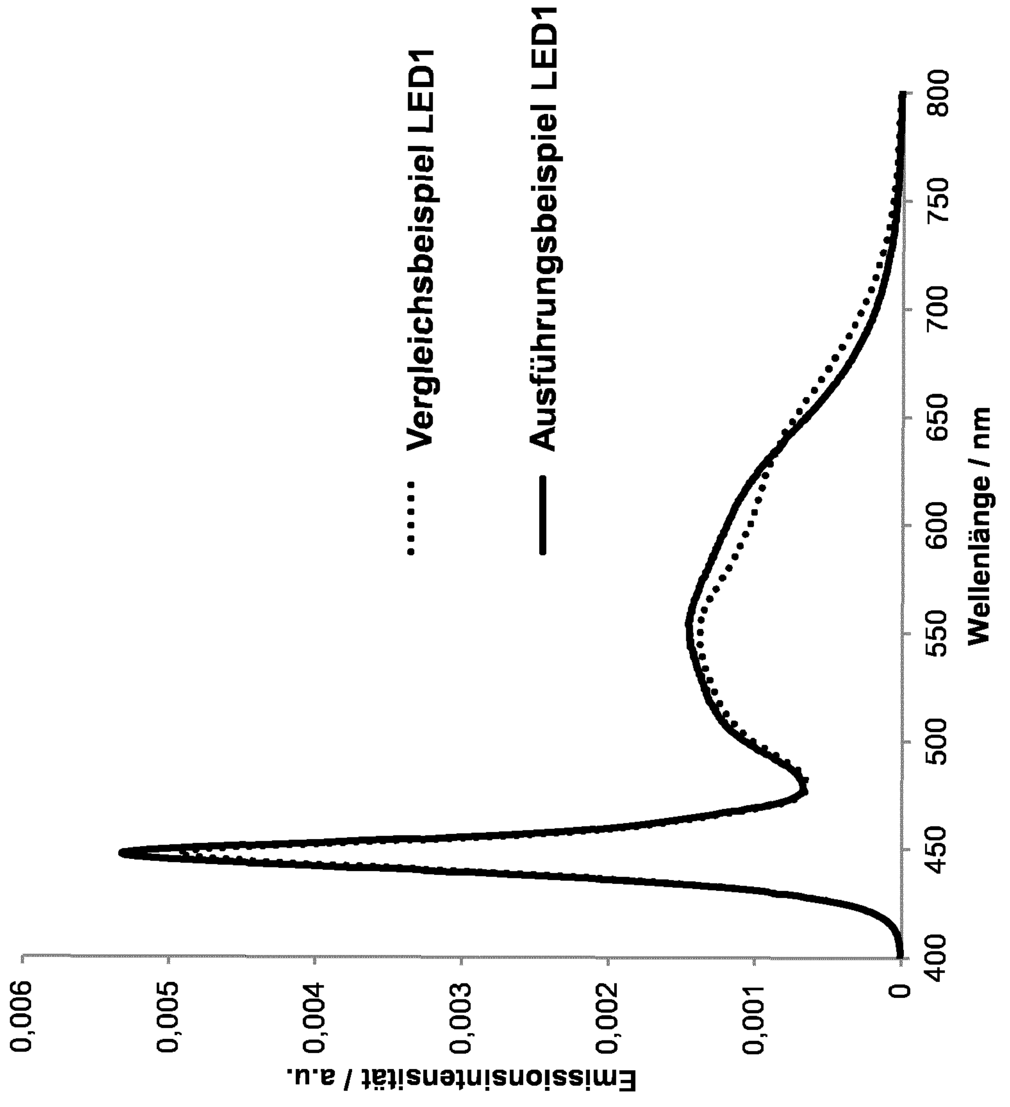
Vergleichsbeispiel LED1
Ausführungsbeispiel LED1
Emissionsintensität / a.u.
0,006
0,005
0,004
0,003
0,002
0,001
0
400
450
500
550
600
650
700
750
800
Wellenlänge / nm

Fig. 48g

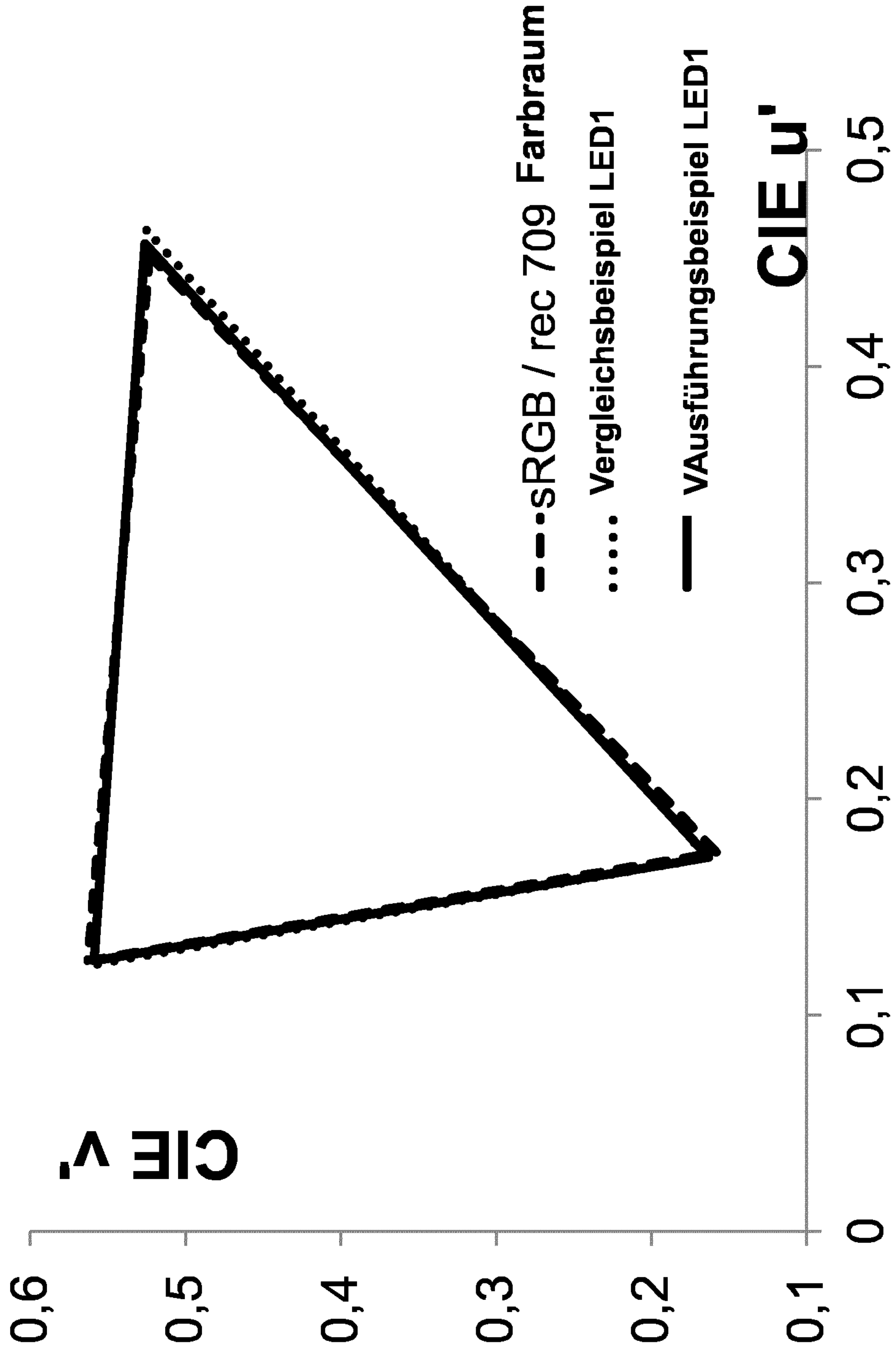
sRGB / rec 709 Farbraum
Vergleichsbeispiel LED1
VAusführungsbeispiel LED1
CIE u'
CIE v'
0
0,1
0,2
0,3
0,4
0,5
0,6

Fig. 48h

| solution | comparative example LED2 | embodiment LED2 | embodiment LED3 |
|---|---|---|---|
| LED dominant wavelength / nm | 450,6 | 446,9 | 450,7 |
| green phosphor | Nitrido-Orthosilicate:Eu | Nitrido-Orthosilicate:Eu | Nitrido-Orthosilicate:Eu |
| red phosphor | CaAlSiN3:Eu | Sr(Sr0.86Ca0.14)Si2Al2N6:Eu (10%) | Sr(Sr0.86Ca0.14)Si2Al2N6:Eu (20 |
| total phosphor concentration | 9,3% | 8,8% | 11,0% |
| green:red ratio | 2,2:1 | 13,5:1 | 12,2:1 |
| CIE x/y (unfiltered) | 0,274 / 0,247 | 0,273 / 0,249 | 0,274 / 0,249 |
| CIE u'v' (unfiltered) | 0,202 / 0,410 | 0,200 / 0,412 | 0,201 / 0,412 |
| CIE x/y (red channel, filtered) | 0,663 / 0,319 | 0,657 / 0,319 | 0,666 / 0,316 |
| CIE x/y (green channel, filtered) | 0,271 / 0,604 | 0,271 / 0,613 | 0,265 / 0,604 |
| CIE x/y (blue channel, filtered) | 0,151 / 0,057 | 0,154 / 0,057 | 0,150 / 0,060 |
| CIE u'/v' (red channel, filtered) | 0,483 / 0,522 | 0,477 / 0,521 | 0,488 / 0,521 |
| CIE u'/v'(green channel, filtered) | 0,112 / 0,560 | 0,111 / 0,562 | 0,109 / 0,559 |
| CIE u'/v' (blue channel, filtered) | 0,178 / 0,153 | 0,182 / 0,151 | 0,175 / 0,158 |
| color gamut overlap vs. DCI-P3 in x/y color space | 81,6% | 81,7% | 82,7% |
| color gamut overlap vs. DCI-P3 in u'v' color space | 90,5% | 89,4% | 91,7% |

Fig. 48i

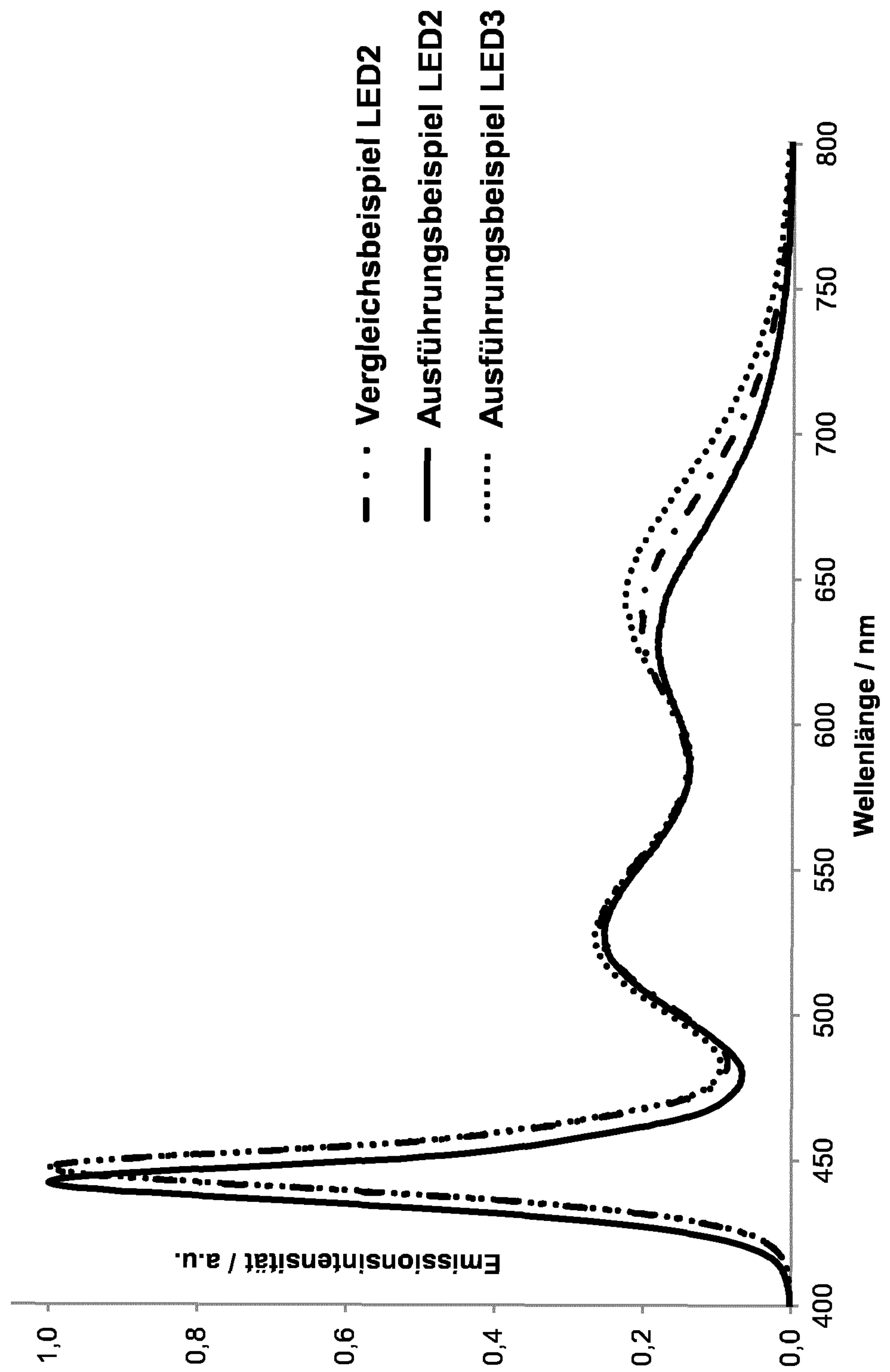

Vergleichsbeispiel LED2
Ausführungsbeispiel LED2
Ausführungsbeispiel LED3
Emissionsintensität / a.u.
Wellenlänge / nm
0,0
0,2
0,4
0,6
0,8
1,0
400
450
500
550
600
650
700
750
800

Fig. 48j

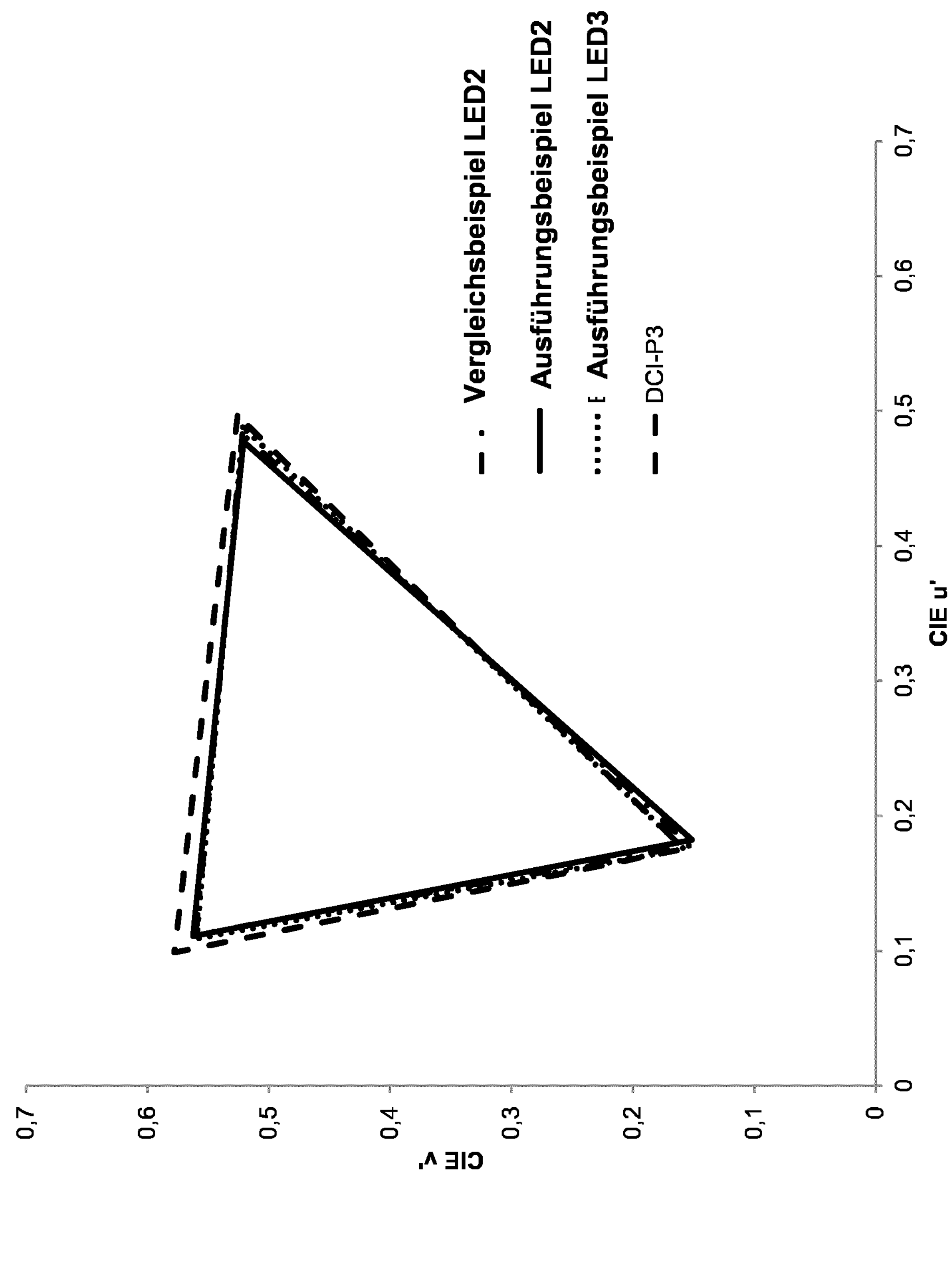
Vergleichsbeispiel LED2
Ausführungsbeispiel LED2
Ausführungsbeispiel LED3
DCI-P3
CIE v'
CIE u'
0
0,1
0,2
0,3
0,4
0,5
0,6
0,7

Fig. 49a

| Strom/mA | CIE-x (Vglbspl. 1) | CIE-y (Vglbspl. 1) | CIE-x (Ausführungsbspl. 1) | CIE-y Ausführungsbspl. 1) | $\Phi_{v(gefüllter\ Verguß)}/\ \Phi_{e(klarer\ Verguß)}$ | Relative Vs (visueller Nutzeffekt) |
|---|---|---|---|---|---|---|
| **40** | 0,346 | 0,350 | 0,346 | 0,348 | 101,2% | 101,6% |
| 100 | 0,346 | 0,351 | 0,346 | 0,349 | 101,3% | 101,5% |
| **200** | 0,346 | 0,351 | 0,346 | 0,350 | 101,3% | 101,5% |
| **350** | 0,345 | 0,352 | 0,346 | 0,350 | 101,4% | 101,4% |
| **500** | 0,344 | 0,352 | 0,345 | 0,350 | 101,6% | 101,3% |
| **700** | 0,343 | 0,352 | 0,345 | 0,350 | 101,9% | 101,3% |
| **1000** | 0,342 | 0,351 | 0,344 | 0,350 | 102.1% | 101,2% |

Fig. 49b

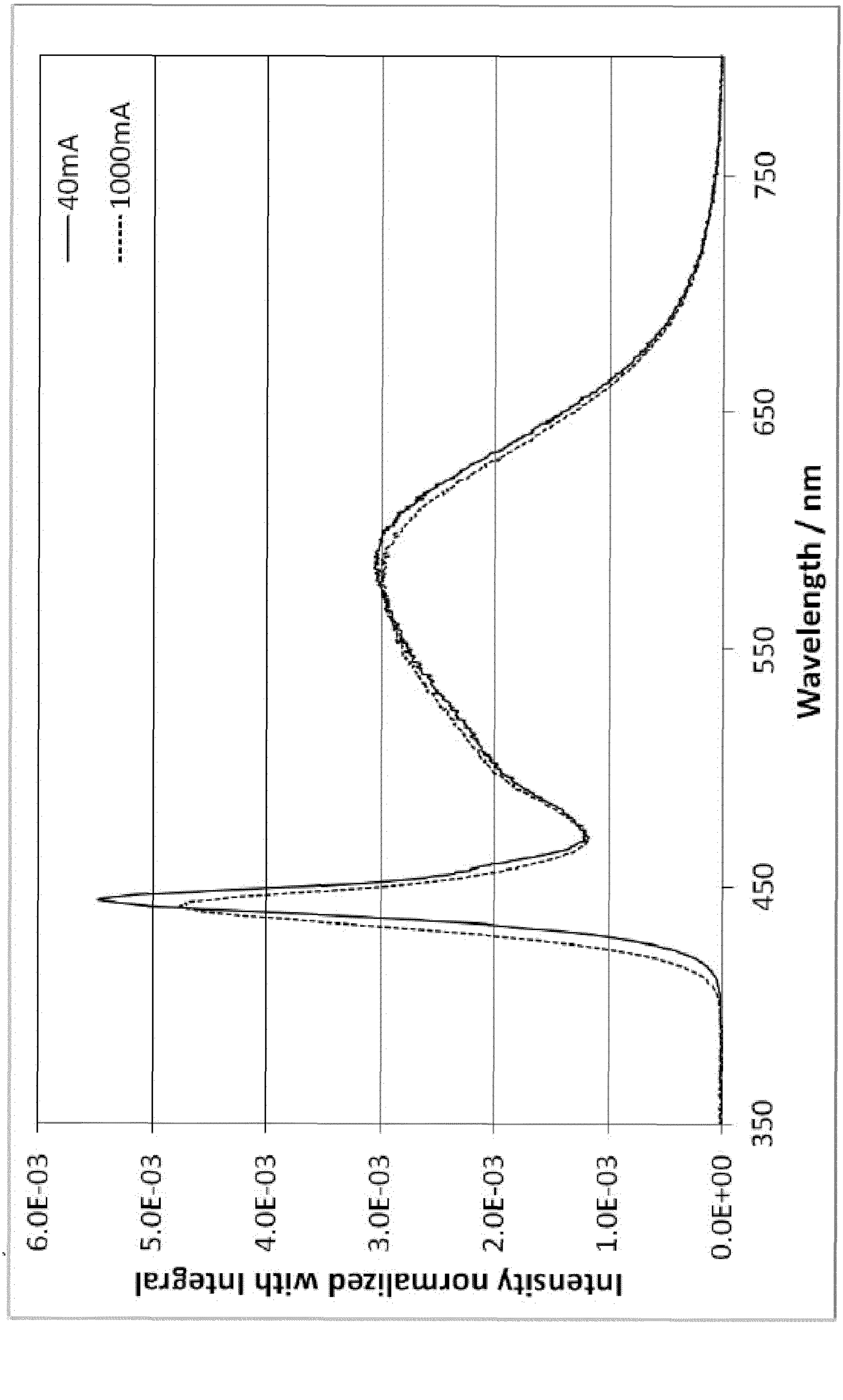
40mA
1000mA
Intensity normalized with integral
6.0E-03
5.0E-03
4.0E-03
3.0E-03
2.0E-03
1.0E-03
0.0E+00
350
450
550
650
750
Wavelength / nm

Fig. 49c

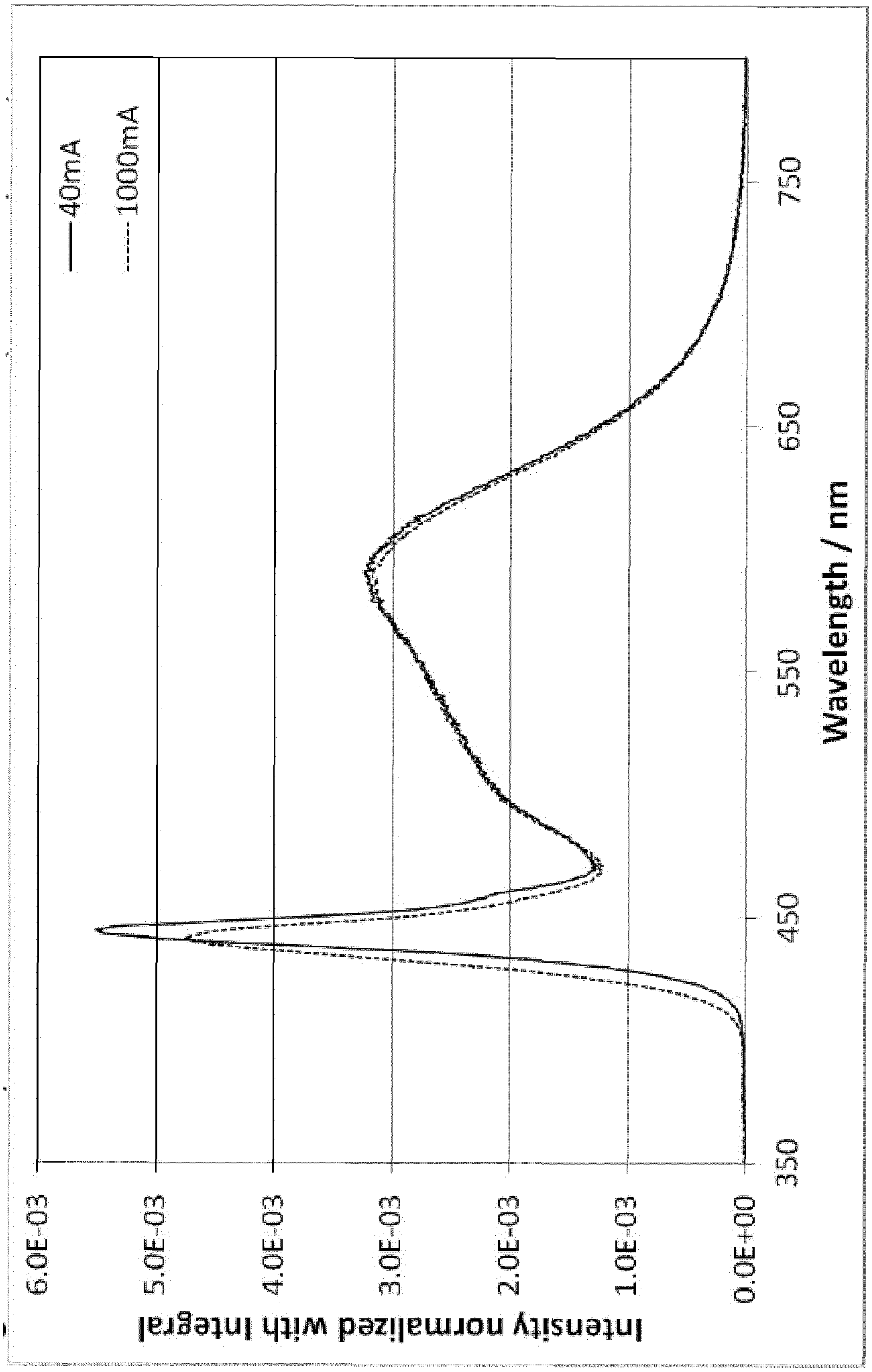
Intensity normalized with Integral
6.0E-03
5.0E-03
4.0E-03
3.0E-03
2.0E-03
1.0E-03
0.0E+00
350
450
550
650
750
Wavelength / nm
40mA
1000mA

Fig. 49d

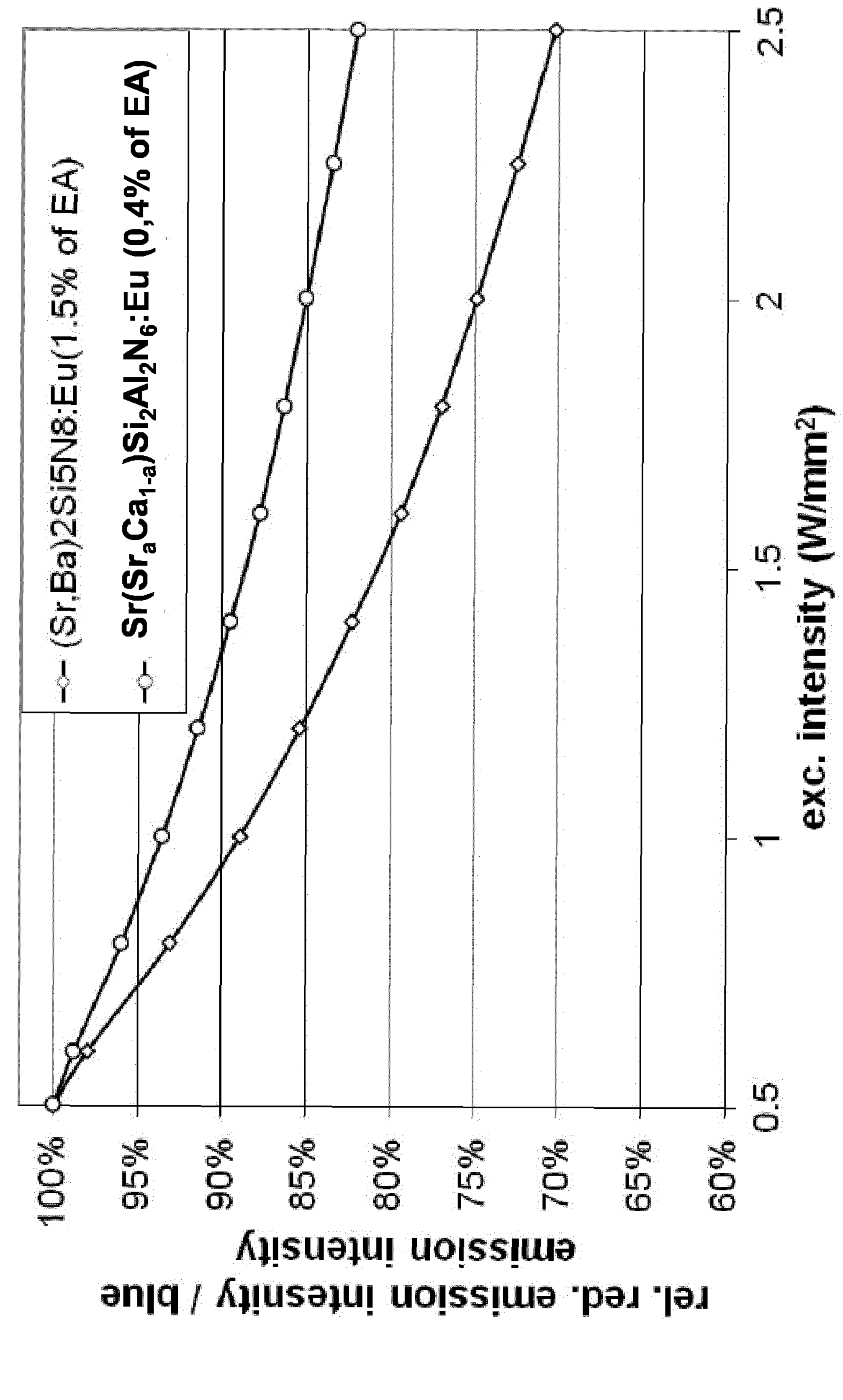
(Sr,Ba)2Si5N8:Eu(1.5% of EA)
Sr(Sr$_a$Ca$_{1-a}$)Si$_2$Al$_2$N$_6$:Eu (0,4% of EA)
rel. red. emission intensity / blue emission intensity
100%
95%
90%
85%
80%
75%
70%
65%
60%
0.5
1
1.5
2
2.5
exc. intensity (W/mm$^2$)

Fig. 49e

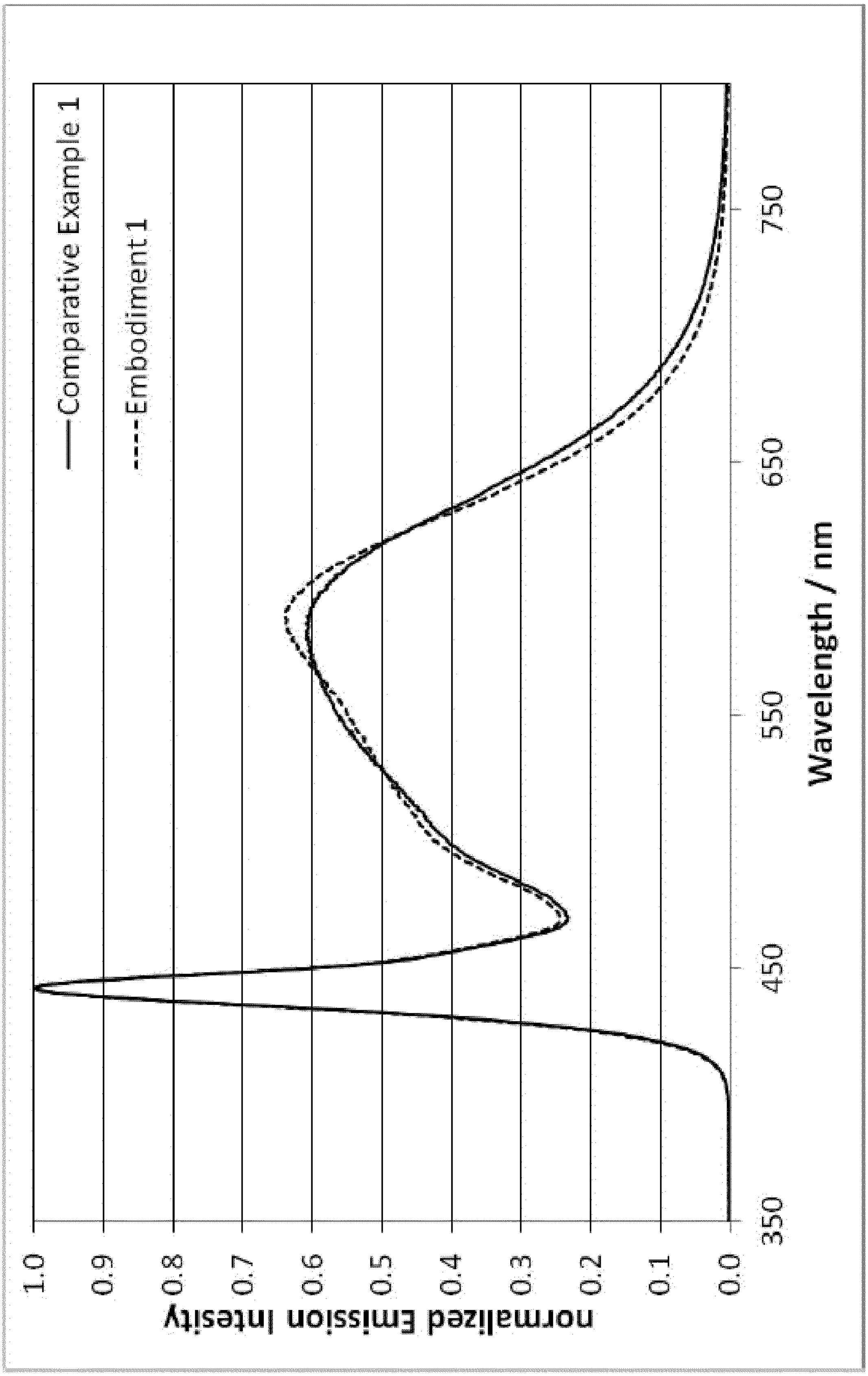
Comparative Example 1
Embodiment 1
normalized Emission Intesity
1.0
0.9
0.8
0.7
0.6
0.5
0.4
0.3
0.2
0.1
0.0
350
450
550
650
750
Wavelength / nm

Fig. 49f

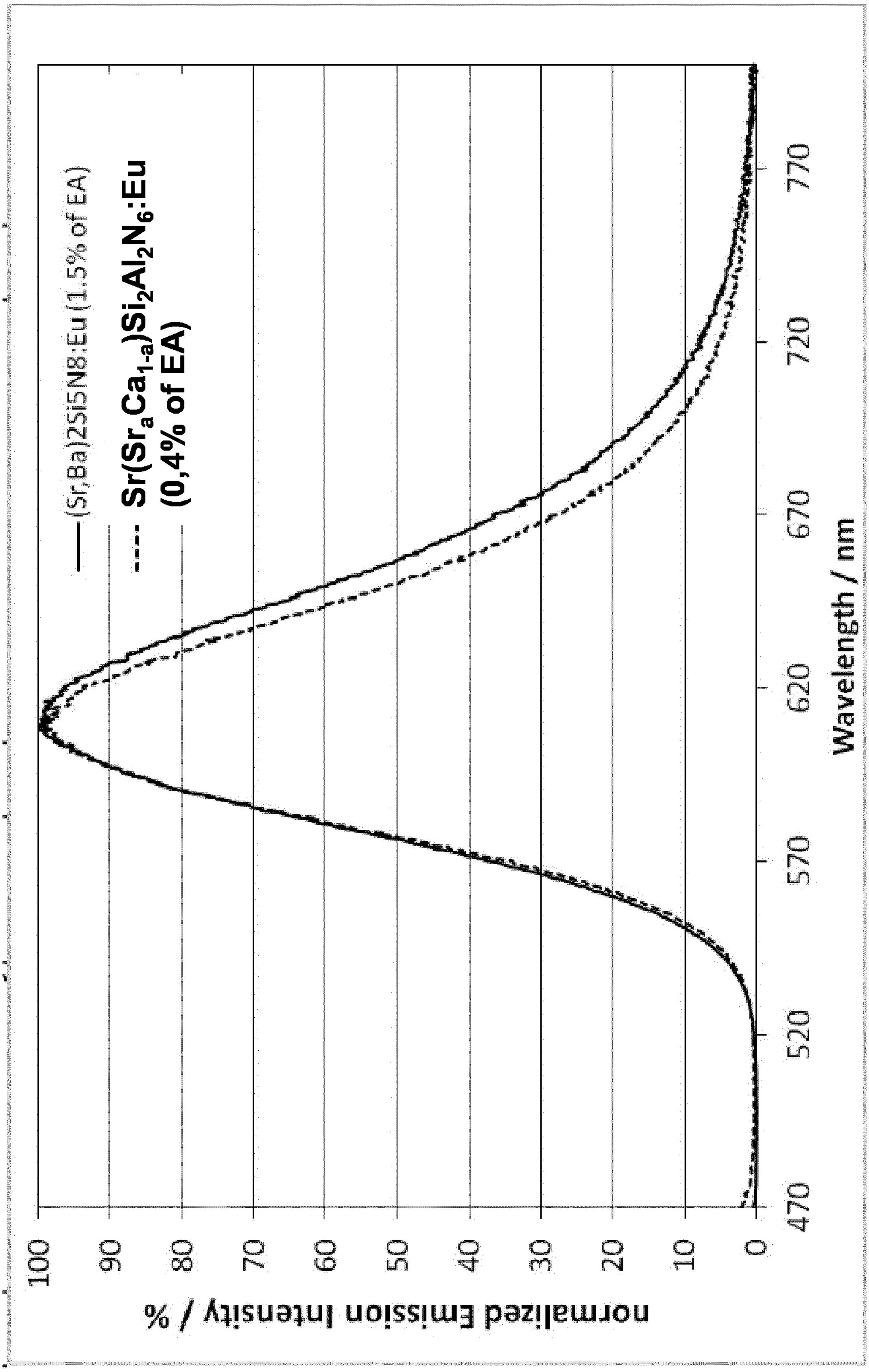

(Sr,Ba)2Si5N8:Eu (1.5% of EA)
Sr(Sr$_a$Ca$_{1-a}$)Si$_2$Al$_2$N$_6$:Eu (0,4% of EA)
normalized Emission Intensity / %
0
10
20
30
40
50
60
70
80
90
100
470
520
570
620
670
720
770
Wavelength / nm

Fig. 49g

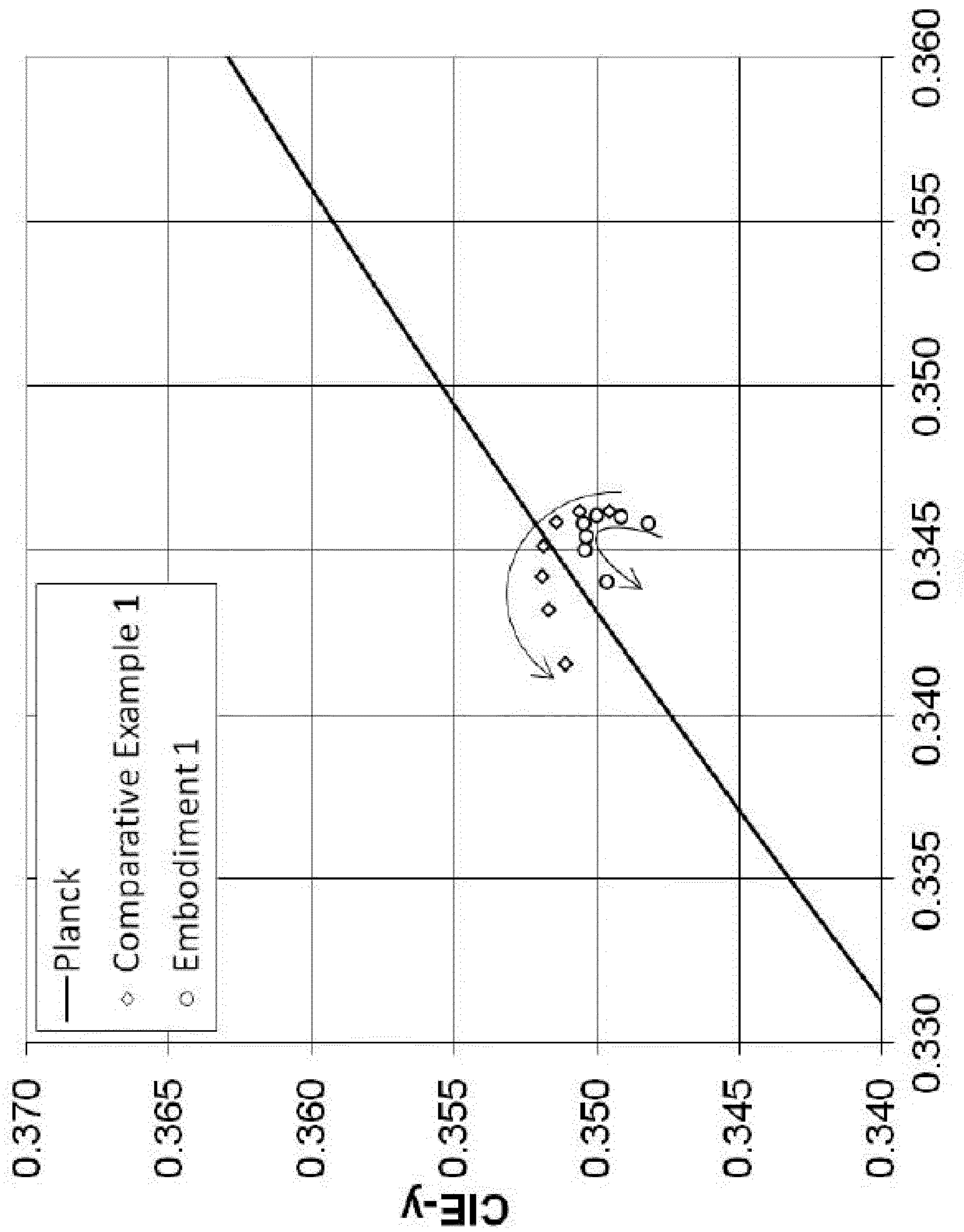

Planck
Comparative Example 1
Embodiment 1
CIE-x
CIE-y
0.330
0.335
0.340
0.345
0.350
0.355
0.360
0.340
0.345
0.350
0.355
0.360
0.365
0.370

Fig. 50a

| Strom/mA | CIE-x (Vglbspl. 2) | CIE-y (Vglbspl. 2) | CIE-x (Ausführungsbspl. 2) | CIE-y Ausführungsbspl. 2) | $\Phi_{v(gefüllter\ Verguß)}/\Phi_{e(klarer\ Verguß)}$ | Relative Vs (visueller Nutzeffekt) |
|---|---|---|---|---|---|---|
| **40** | 0,563 | 0,430 | 0,562 | 0,429 | 116,2% | 110,4% |
| 100 | 0,563 | 0,430 | 0,562 | 0,428 | 116,1% | 110,3% |
| **200** | 0,562 | 0,430 | 0,561 | 0,428 | 116,5% | 110,1% |
| **350** | 0,561 | 0,430 | 0,561 | 0,428 | 117,1% | 109,7% |
| **500** | 0,561 | 0,431 | 0,561 | 0,429 | 118,3% | 109,5% |
| **700** | 0,560 | 0,431 | 0,560 | 0,429 | 118,9% | 109,1% |
| **1000** | 0,559 | 0,432 | 0,559 | 0,429 | 117,0% | 108,5% |

Fig. 50b

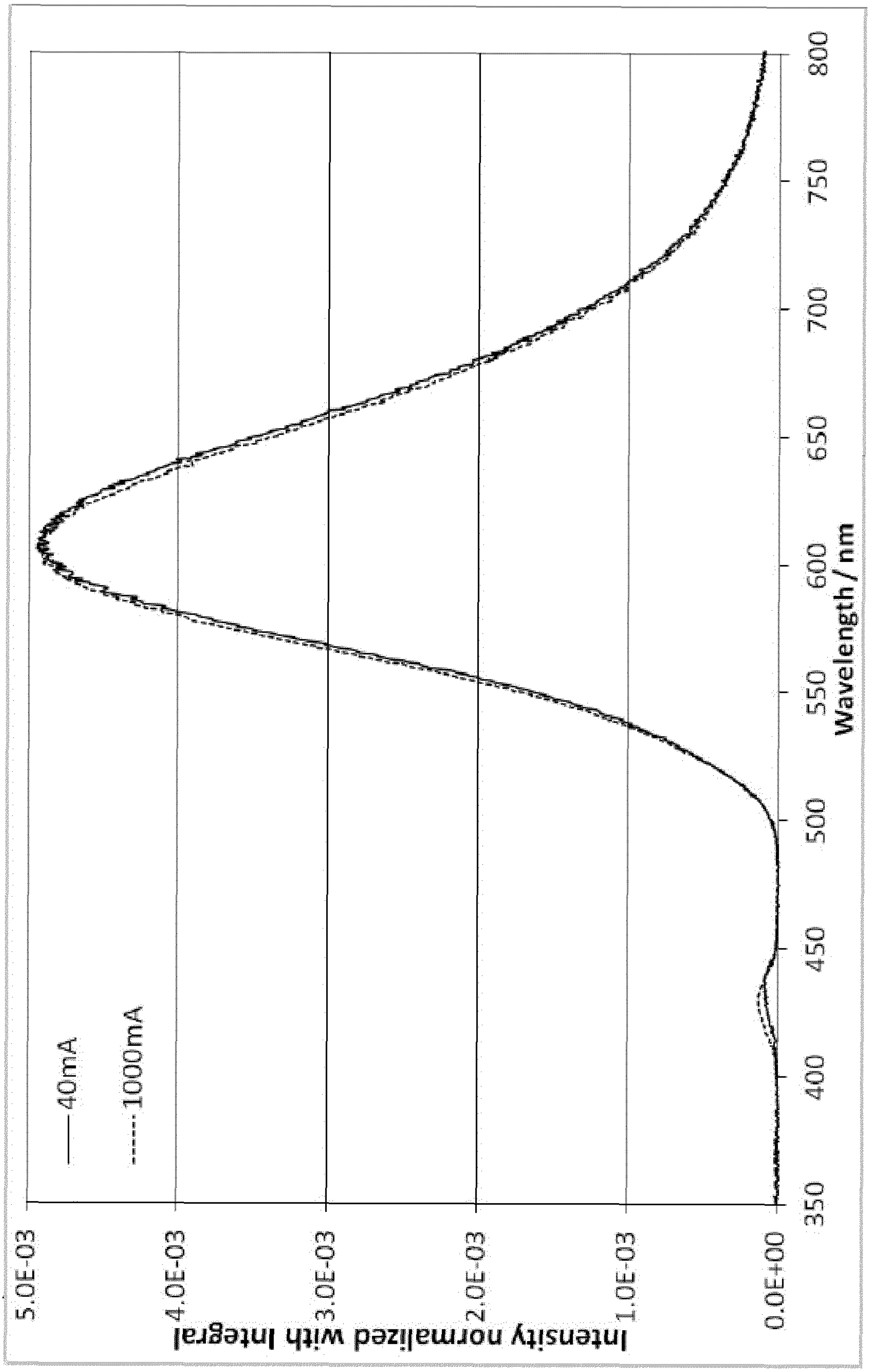
40mA
1000mA
Intensity normalized with Integral
5.0E-03
4.0E-03
3.0E-03
2.0E-03
1.0E-03
0.0E+00
350
400
450
500
550
600
650
700
750
800
Wavelength / nm

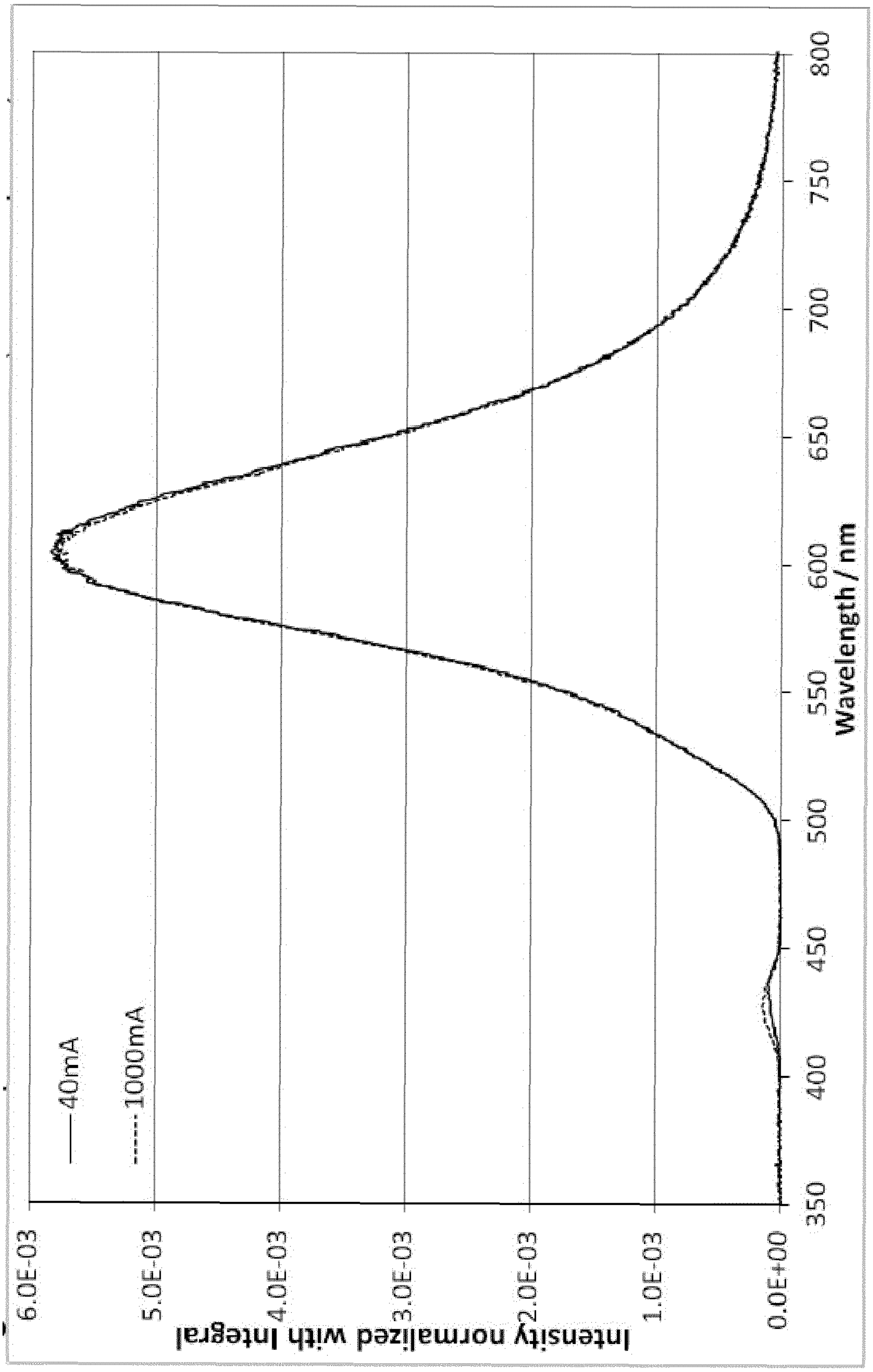
40mA
1000mA
Intensity normalized with Integral
6.0E-03
5.0E-03
4.0E-03
3.0E-03
2.0E-03
1.0E-03
0.0E+00
350
400
450
500
550
600
650
700
750
800
Wavelength / nm

Fig. 50c

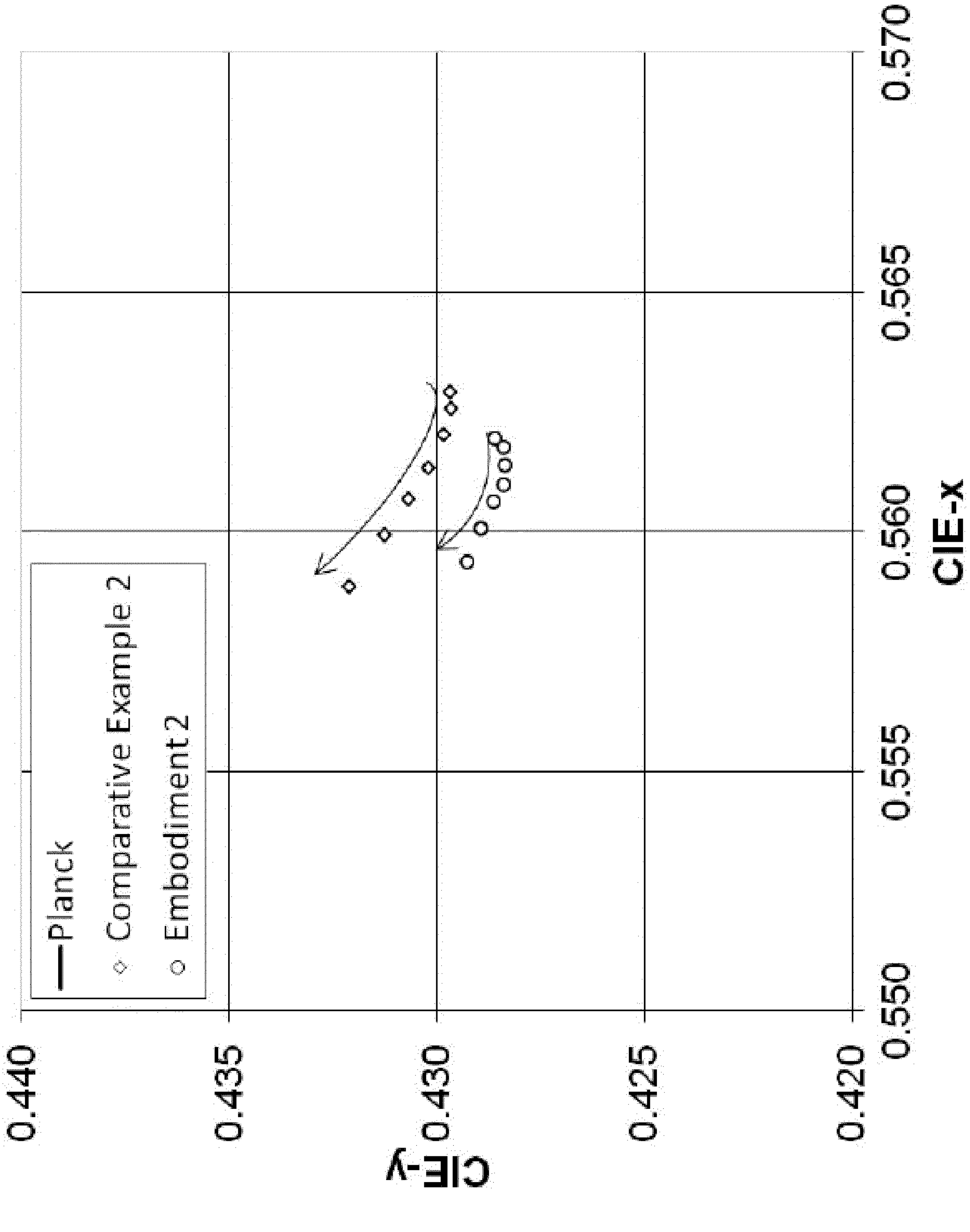
Planck
Comparative Example 2
Embodiment 2
0.440
0.435
0.430
0.425
0.420
CIE-y
0.550
0.555
0.560
0.565
0.570
CIE-x

Fig. 50d

Fig. 50e

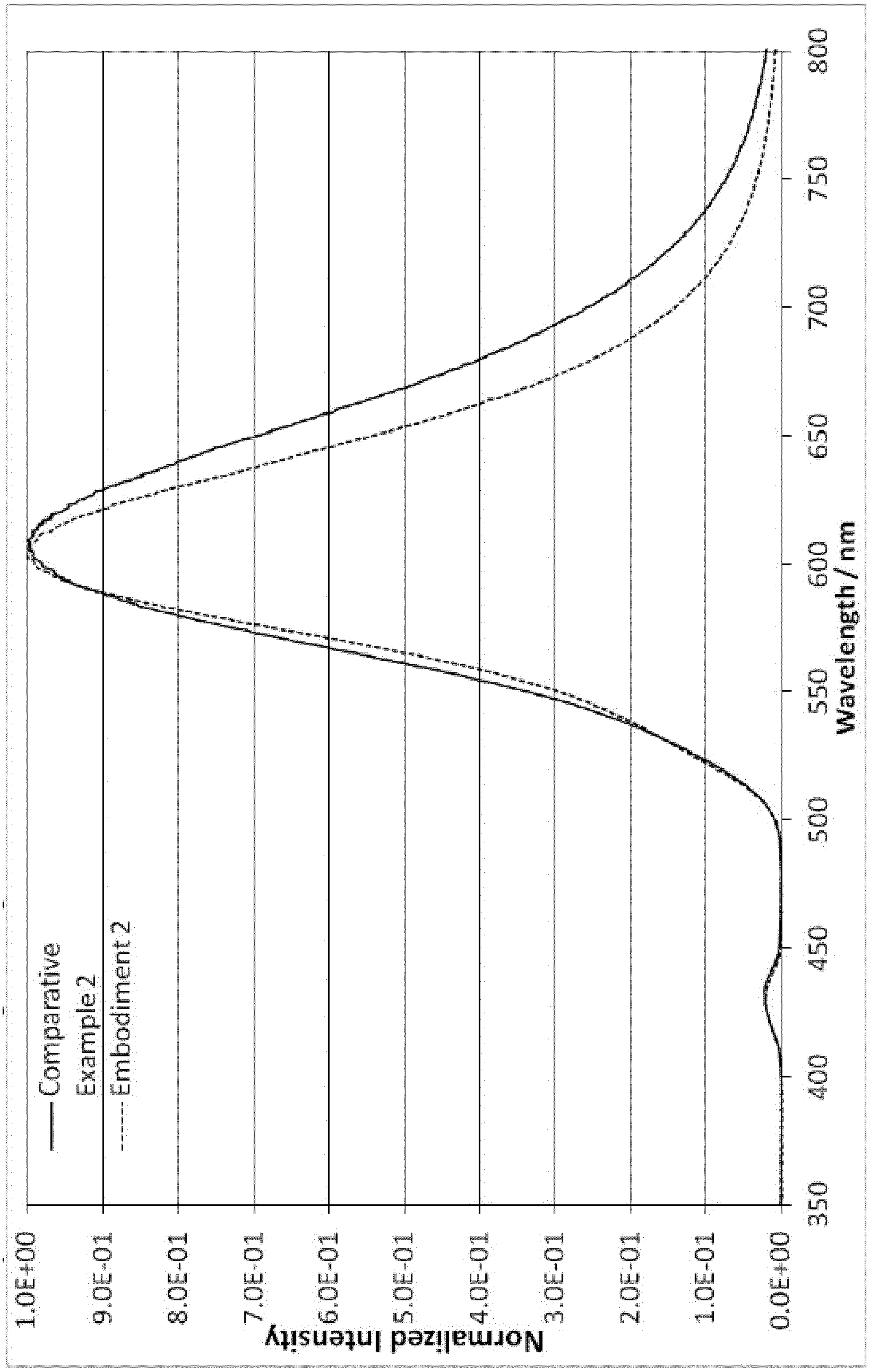

Comparative
Example 2
Embodiment 2
Normalized Intensity
1.0E+00
9.0E-01
8.0E-01
7.0E-01
6.0E-01
5.0E-01
4.0E-01
3.0E-01
2.0E-01
1.0E-01
0.0E+00
350
400
450
500
550
600
650
700
750
800
Wavelength / nm

Fig. 51a

| Beispiel | $\lambda_{dom(blaue LED)}$ | Zusammen-setzung grüner Leuchtstoff | Zusammen-setzung roter Leuchtstoff | Gesamtkonz. Leuchtstoff (Gew %) | Verhältnis grün/ rot | Abs Konz. Grün (Gew %) | Abs. Konz. Rot (Gew %) | CCT/K | CRI | R9 | Rel. Konversions-Effizienz |
|---|---|---|---|---|---|---|---|---|---|---|---|
| **Vgbl. 1** | 446 | $Y_3(Al_{0,6}Ga_{0,4})_5O_{12}$: Ce (ca 2% Ce) | $Sr_{0,7}Ca_{0,3}AlSiN_3$:Eu (0,5% Eu) | 15,0% | 2,0 | 10,0% | 5,0% | 2713 | 81 | 9 | 101% |
| **Vgbl. 2** | 446 | $Lu_3(Al_{0,75}Ga_{0,25})_5O_{12}$: Ce (ca 2,5 % Ce) | $(Ca_{0,1}Sr_{0,4}Ba_{0,5})_2Si_5N_8$:Eu (3,25% Eu) | 16,7% | 4,6 | 13,7% | 3,0% | 2680 | 80 | 11 | 100% |
| **Ausführungsbsp. 1** | 446 | $Y_3(Al_{0,6}Ga_{0,4})_5O_{12}$: Ce (ca 2% Ce) | $Sr(Sr_{0,86}Ca_{0,14})Si_2Al_2N_6$: Eu (3% Eu) | 15,7% | 7,55 | 13,9% | 1,8% | 2708 | 83 | 10 | 107% |
| **Ausführungsbsp. 2** | 446 | $Lu_3Al_5O_{12}$: Ce (ca 1,5 % Ce) | $Sr(Sr_{0,80}Ca_{0,20})Si_2Al_2N_6$: Eu (2% Eu) | 27,5% | 12,4 | 25.4% | 2,1% | 2685 | 81 | 9 | 110% |

Fig. 51b

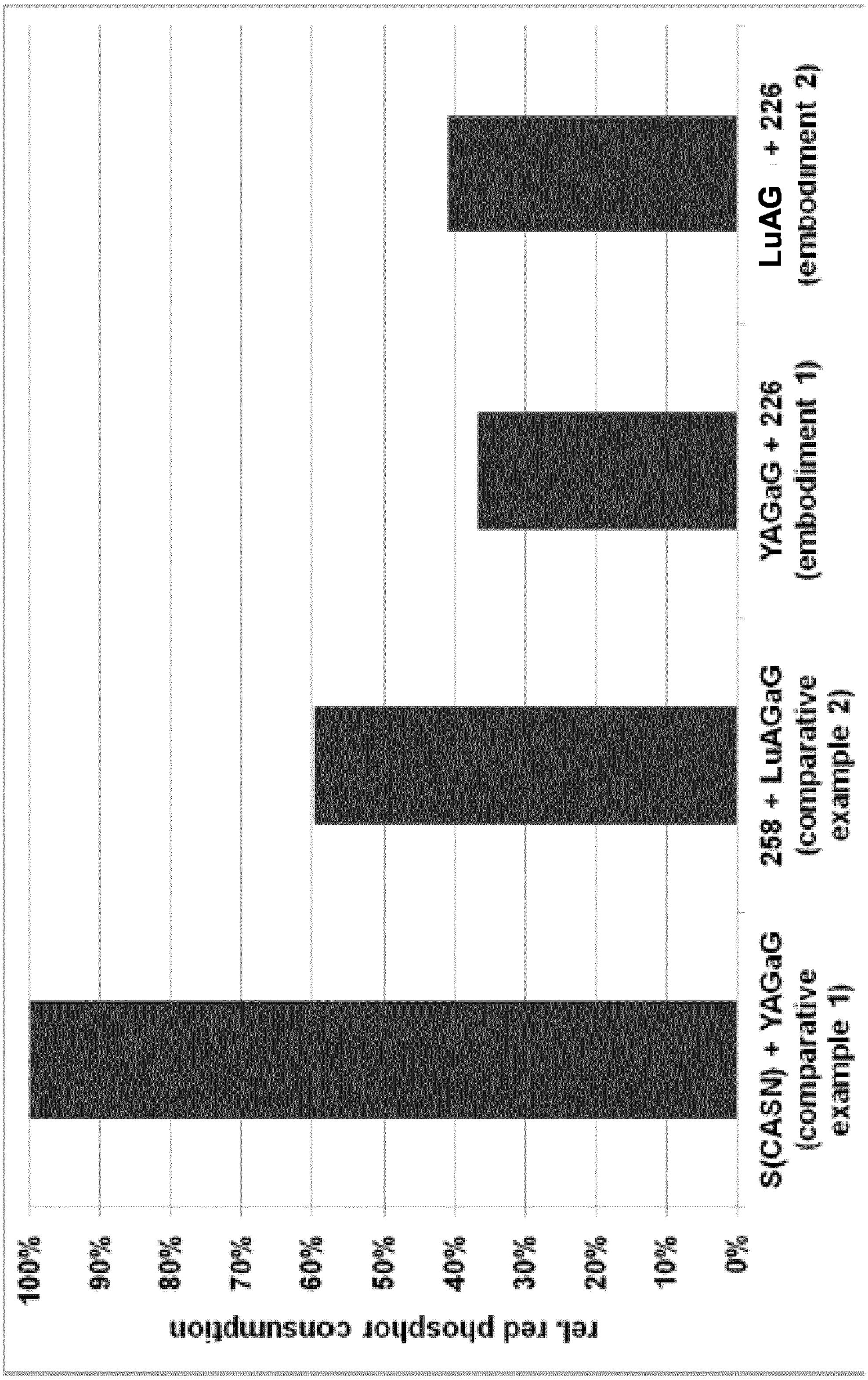
rel. red phosphor consumption
100%
90%
80%
70%
60%
50%
40%
30%
20%
10%
0%
S(CASN) + YAGaG (comparative example 1)
258 + LuAGaG (comparative example 2)
YAGaG + 226 (embodiment 1)
LuAG + 226 (embodiment 2)

Fig. 51c

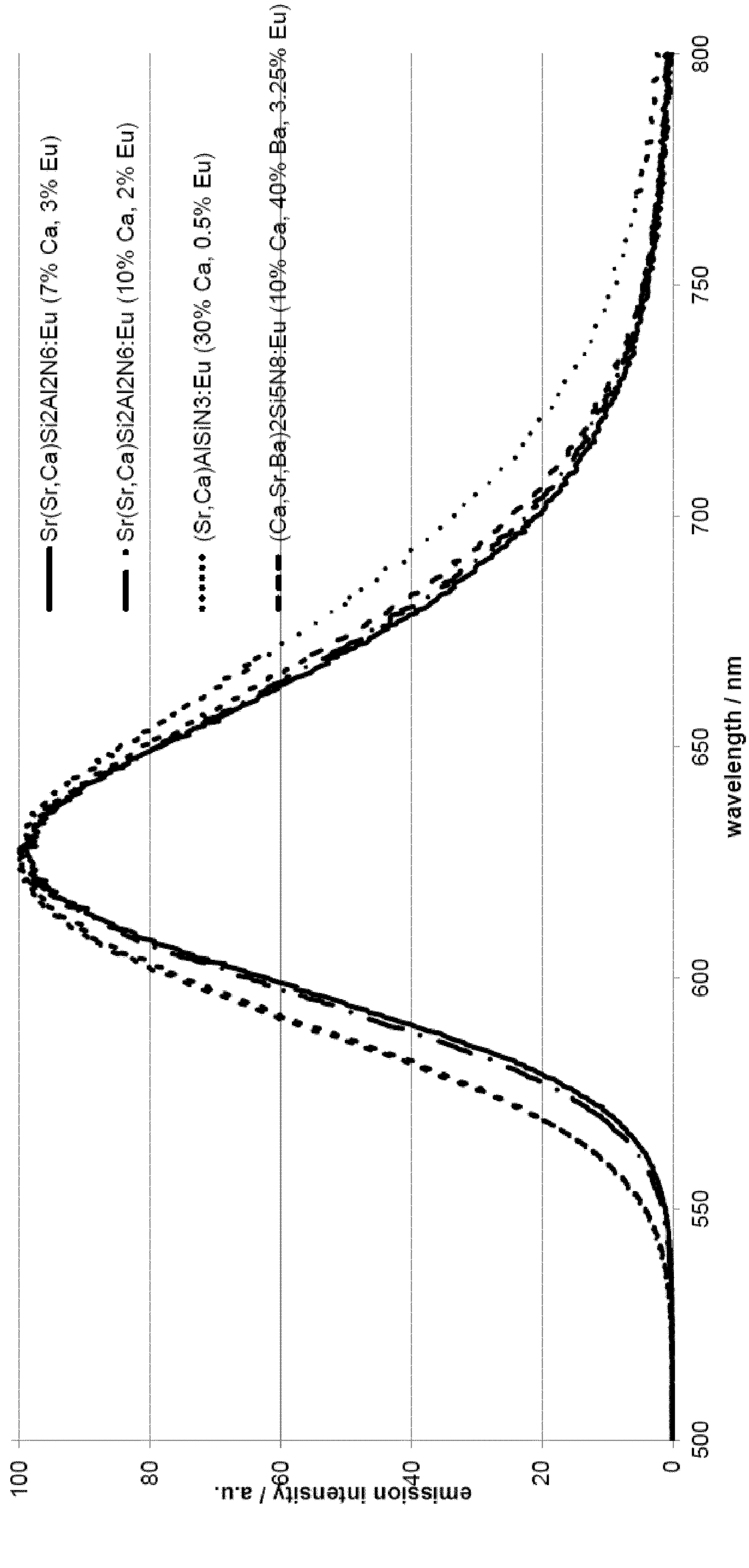
Sr(Sr,Ca)Si2Al2N6:Eu (7% Ca, 3% Eu)
Sr(Sr,Ca)Si2Al2N6:Eu (10% Ca, 2% Eu)
(Sr,Ca)AlSiN3:Eu (30% Ca, 0.5% Eu)
(Ca,Sr,Ba)2Si5N8:Eu (10% Ca, 40% Ba, 3.25% Eu)
emission intensity / a.u.
100
80
60
40
20
0
500
550
600
650
700
750
800
wavelength / nm

Fig. 51d

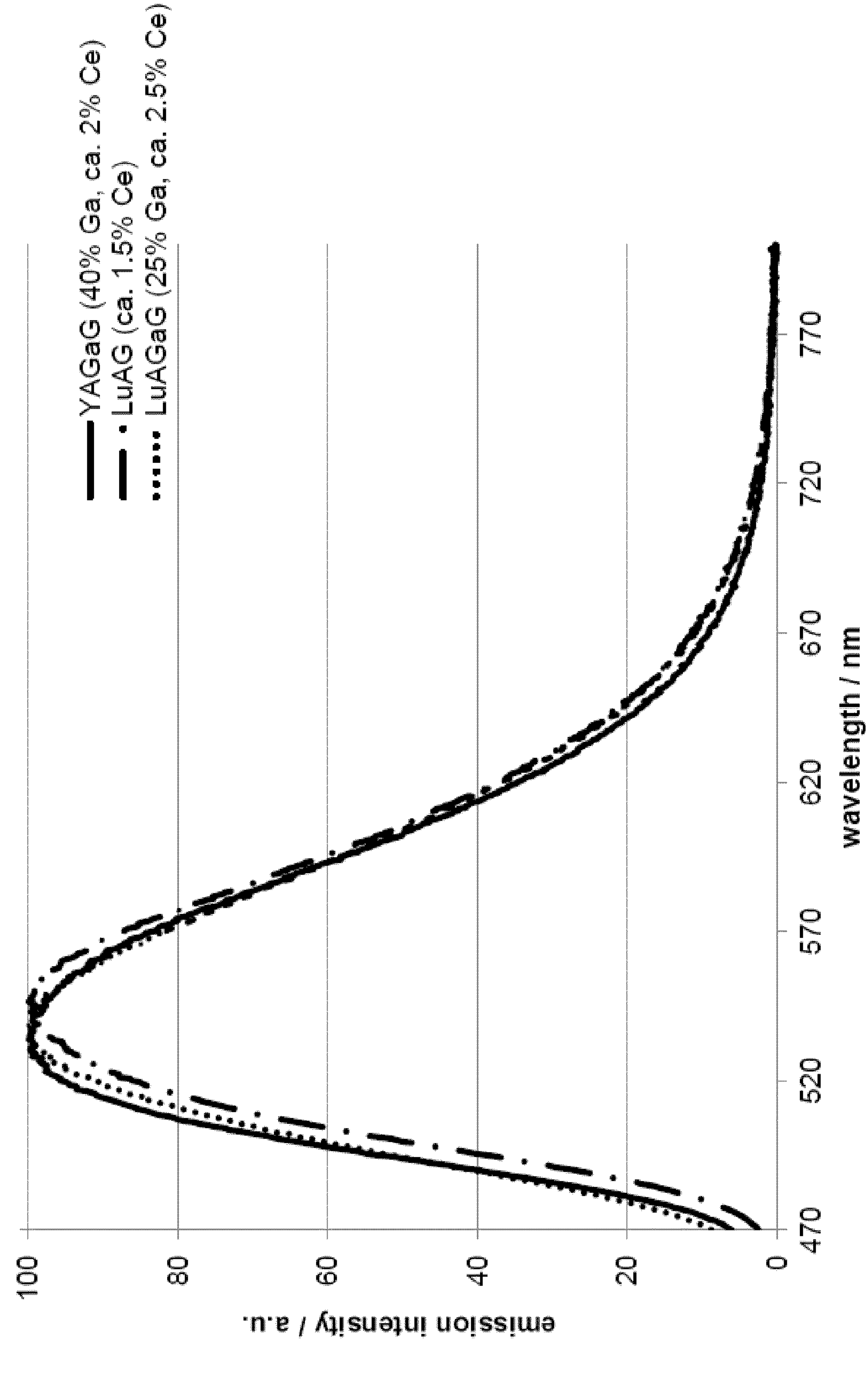
YAGaG (40% Ga, ca. 2% Ce)
LuAG (ca. 1.5% Ce)
LuAGaG (25% Ga, ca. 2.5% Ce)
emission intensity / a.u.
100
80
60
40
20
0
470
520
570
620
670
720
770
wavelength / nm

Fig. 51e

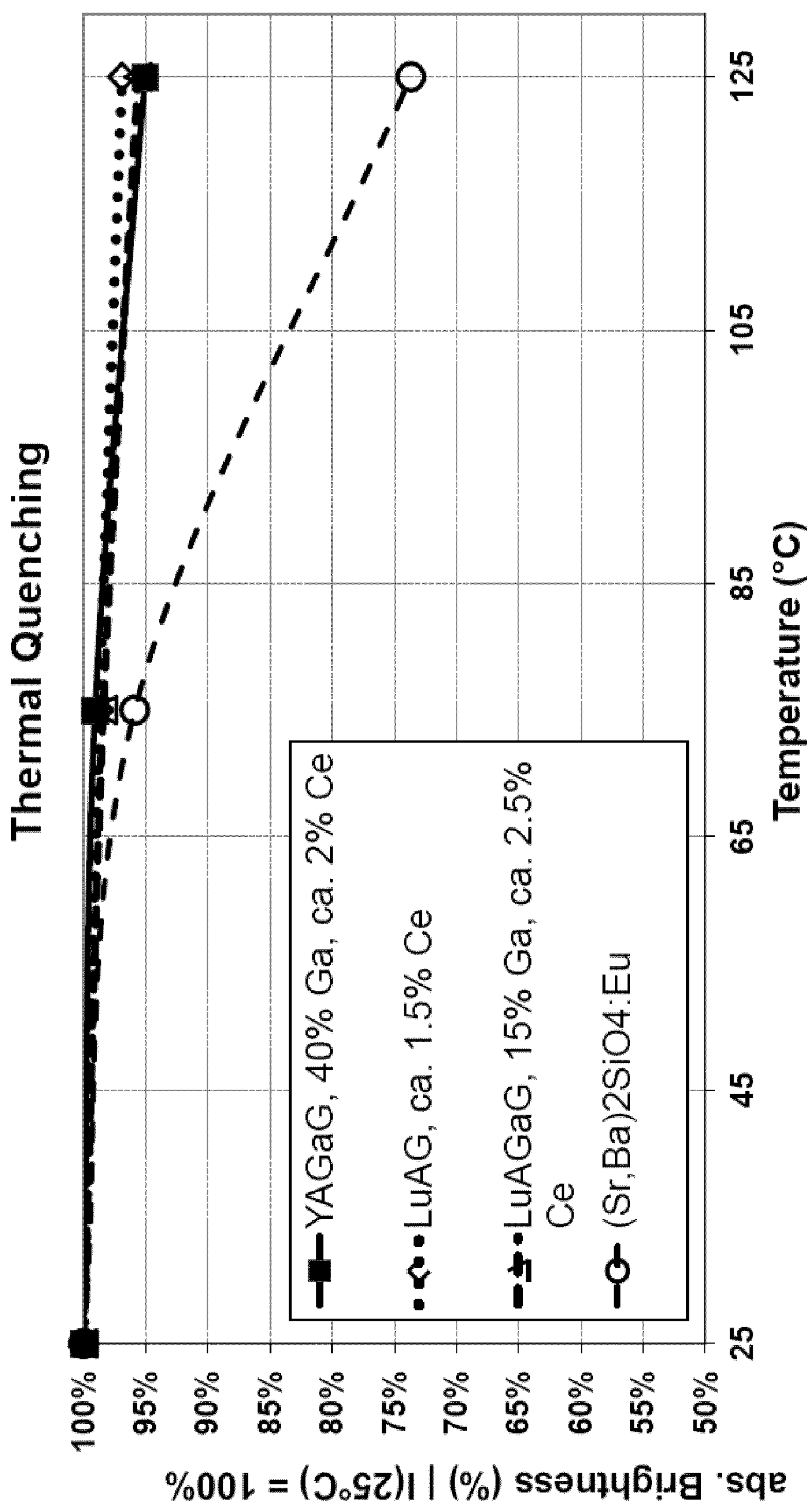
Thermal Quenching
abs. Brightness (%) | I(25°C) = 100%
100%
95%
90%
85%
80%
75%
70%
65%
60%
55%
50%
25
45
65
85
105
125
Temperature (°C)
YAGaG, 40% Ga, ca. 2% Ce
LuAG, ca. 1.5% Ce
LuAGaG, 15% Ga, ca. 2.5% Ce
(Sr,Ba)2SiO4:Eu

Fig. 51f

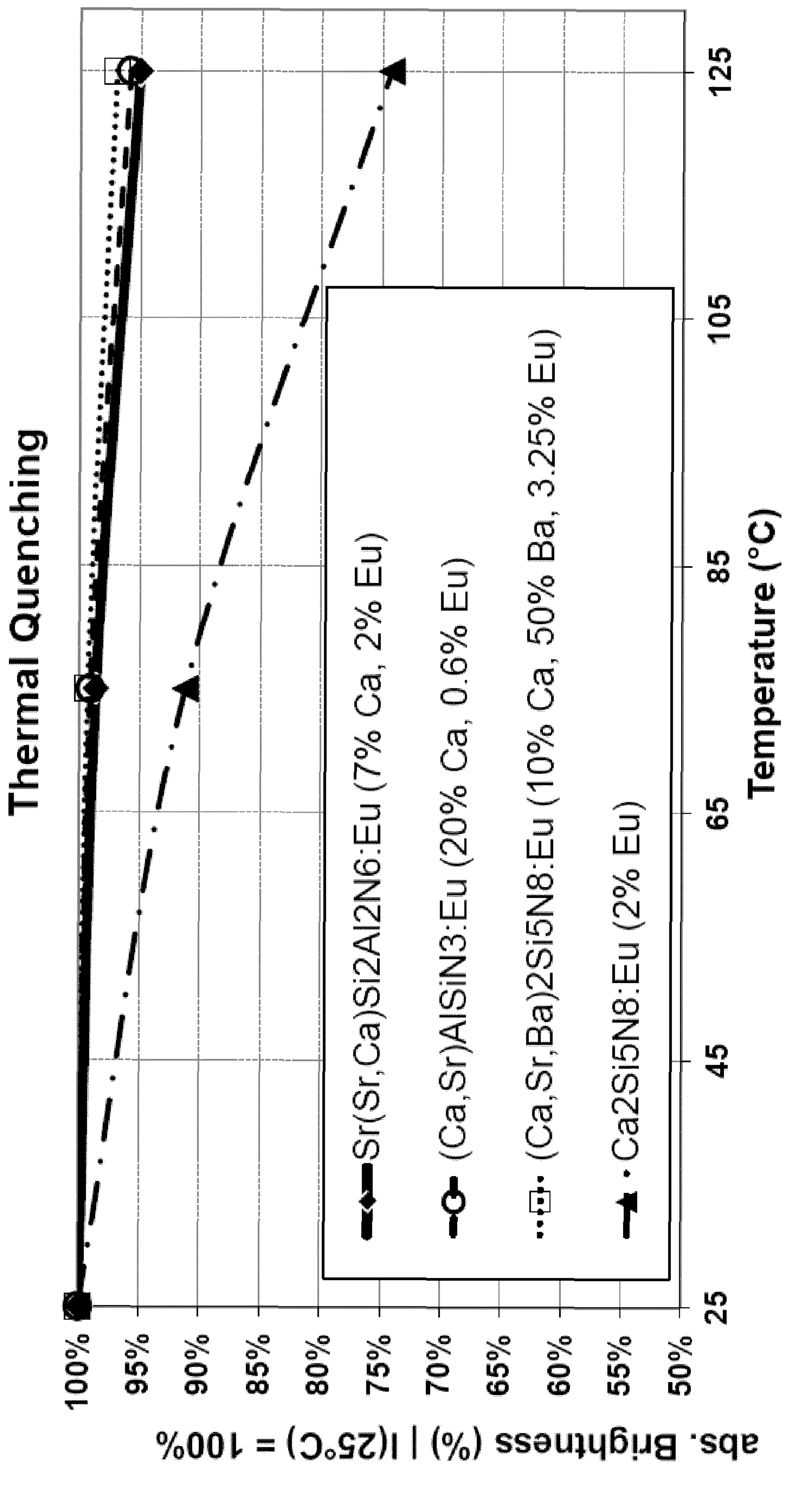
Thermal Quenching
abs. Brightness (%) | I(25°C) = 100%
100%
95%
90%
85%
80%
75%
70%
65%
60%
55%
50%
Temperature (°C)
25
45
65
85
105
125
Sr(Sr,Ca)Si2Al2N6:Eu (7% Ca, 2% Eu)
(Ca,Sr)AlSiN3:Eu (20% Ca, 0.6% Eu)
(Ca,Sr,Ba)2Si5N8:Eu (10% Ca, 50% Ba, 3.25% Eu)
Ca2Si5N8:Eu (2% Eu)

Fig. 51g

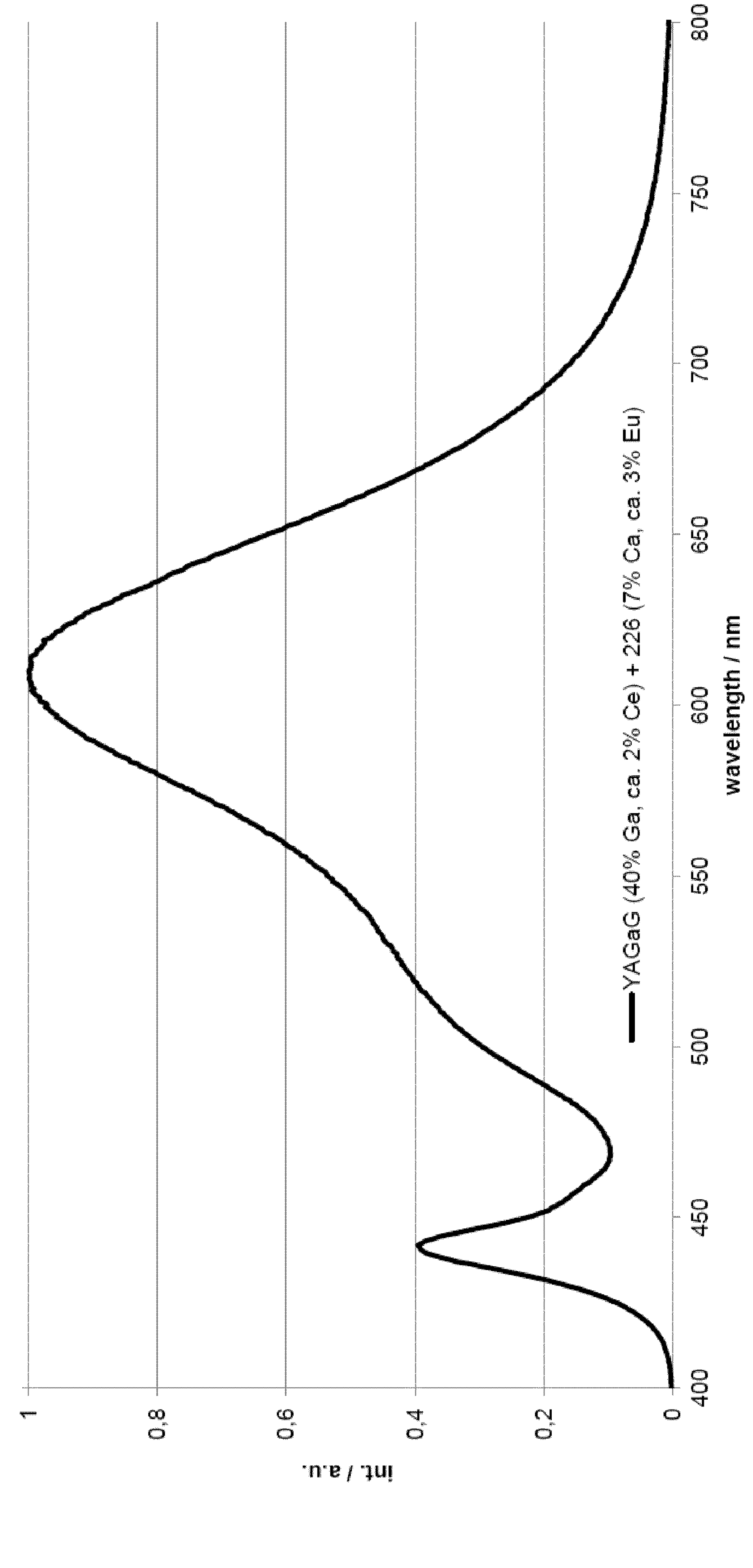
int. / a.u.
1
0,8
0,6
0,4
0,2
0
400
450
500
550
600
650
700
750
800
wavelength / nm
YAGaG (40% Ga, ca. 2% Ce) + 226 (7% Ca, ca. 3% Eu)

Fig. 51h

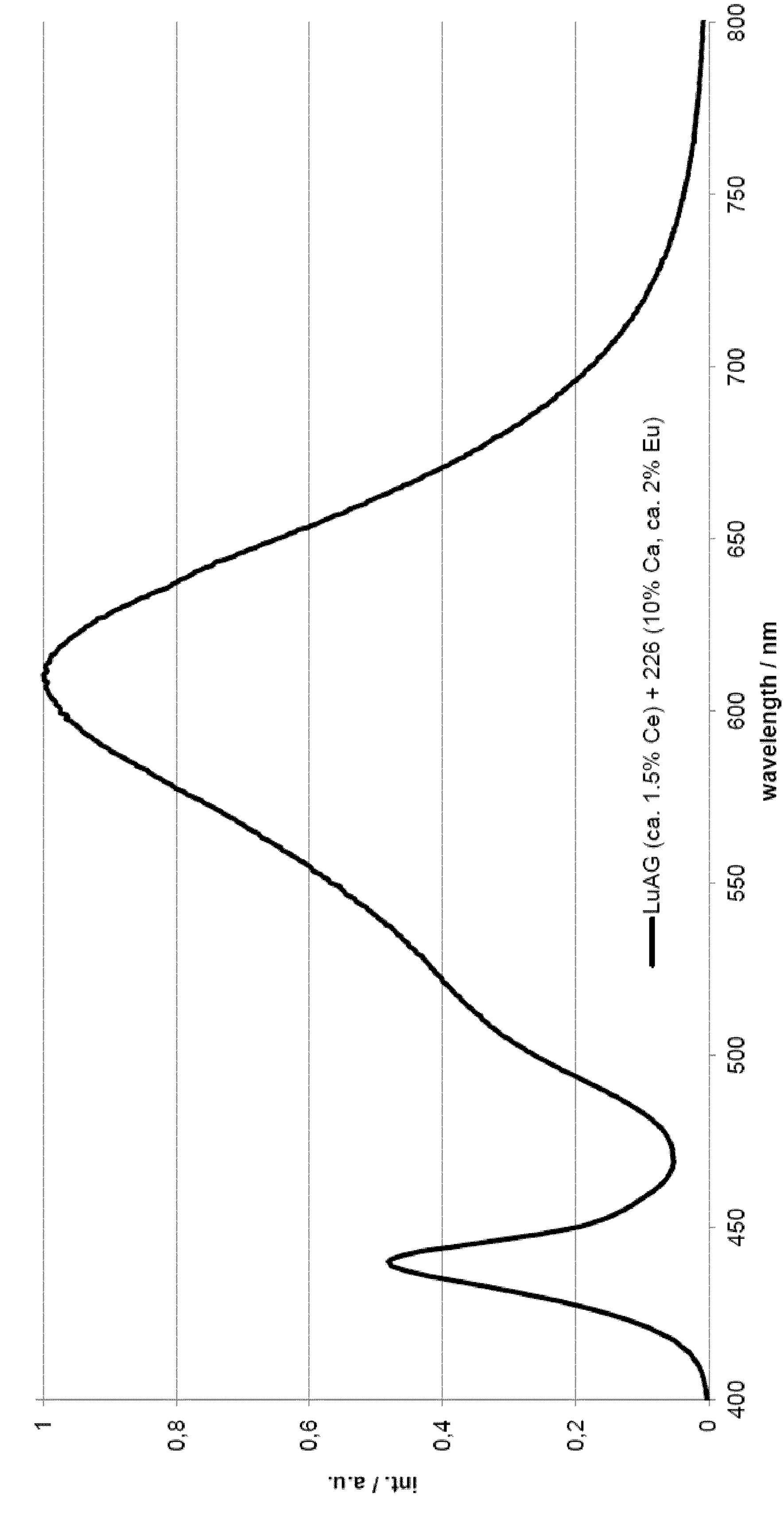

int. / a.u.
1
0,8
0,6
0,4
0,2
0
400
450
500
550
600
650
700
750
800
wavelength / nm
LuAG (ca. 1.5% Ce) + 226 (10% Ca, ca. 2% Eu)

Fig. 52a

| Beispiele | LED wavelength $I_{dom}$ / nm | Grün | Rot | Gesamt-Konz. | Verhältnis g/r | abs. Konz. grün | abs. Konz. rot | CCT / K | CRI | R9 | Rel. Konversions-eff. |
|---|---|---|---|---|---|---|---|---|---|---|---|
| Vergleichs-beispiel 1 | 446 | $(Lu,Ce)_3(Al,Ga)_5O_{12}$ (25% Ga, ca. 2.5% Ce) | $(Sr_{0.4}Ca_{0.6})AlSiN_3$:0.4% Eu | 18,0% | 2,78 | 13,2% | 4,8% | 2673 | 92 | 55 | 100% |
| Ausführungs-beispiel 1 | 446 | $(Lu,Ce)_3(Al,Ga)_5O_{12}$ (25% Ga, ca. 2.5% Ce) | $Sr(Sr_{0.84}Ca_{0.16})Al_2Si_2N_6$:4,7% Eu | 18,8% | 12,60 | 17,4% | 1,4% | 2711 | 91 | 42 | 109% |
| Ausführungs-beispiel 2 | 446 | $(Lu,Ce)_3(Al,Ga)_5O_{12}$ (25% Ga, ca. 2% Ce) | $Sr(Sr_{0.84}Ca_{0.16})Al_2Si_2N_6$:4,7% Eu | 20,3% | 15,00 | 19,0% | 1,3% | 2707 | 93 | 49 | 105% |
| Ausführungs-beispiel 3 | 446 | $(Lu,Ce)_3(Al,Ga)_5O_{12}$ (25% Ga, ca. 2% Ce) | $Sr(Sr_{0.8}Ca_{0.2})Al_2Si_2N_6$:3,7% Eu | 20,5% | 12,40 | 19,0% | 1,5% | 2670 | 91 | 40 | 107% |
| Ausführungs-beispiel 4 | 446 | $(Lu,Ce)_3(Al,Ga)_5O_{12}$ (25% Ga, ca. 1.8% Ce) | $Sr(Sr_{0.8}Ca_{0.2})Al_2Si_2N_6$:3,7% Eu | 20,5% | 13,00 | 19,0% | 1,5% | 2726 | 92 | 44 | 109% |

Fig. 52b

| example | LED wavelength $l_{dom}$ / nm | Grün | Rot | Gesamt-Konz. | Verhältnis g/r | abs. Konz. grün | abs. Konz. rot | CCT / K | CRI | R9 | Konversions-eff. |
|---|---|---|---|---|---|---|---|---|---|---|---|
| Vergleichs-beispiel 1 | 446 | (Lu,Ce)3(Al,Ga)5O12 (25% Ga, ca. 2.5% Ce) | (Sr0.4Ca0.6)AlSiN3:0.4% Eu | 18,0% | 2,78 | 13,2% | 4,8% | 2673 | 92 | 55 | 100% |
| Ausführungs-beispiel 1 | 446 | (Lu,Ce)3(Al,Ga)5O12 (25% Ga, ca. 2.5% Ce) | $Sr(Sr_{0.8}Ca_{0.2})Al_2Si_2N_6$:4,7% Eu | 18,8% | 12,60 | 17,4% | 1,4% | 2711 | 91 | 42 | 109% |
| Vergleichs-beispiel 1 | 446 | (Lu,Ce)3(Al,Ga)5O12 (25% Ga, ca. 2.5% Ce) | $(Sr_{0.4}Ca_{0.6})AlSiN_3$:0.4% Eu | 13,2% | 3,87 | 10,5% | 2,7% | 3974 | 90 | 61 | 100% |
| Ausführungs-beispiel 1 | 446 | (Lu,Ce)3(Al,Ga)5O12 (25% Ga, ca. 2.5% Ce) | $Sr(Sr_{0.8}Ca_{0.2})Al_2Si_2N_6$:4,7% Eu | 13,5% | 16,00 | 12,7% | 0,8% | 3986 | 90 | 50 | 106% |

Fig. 52c

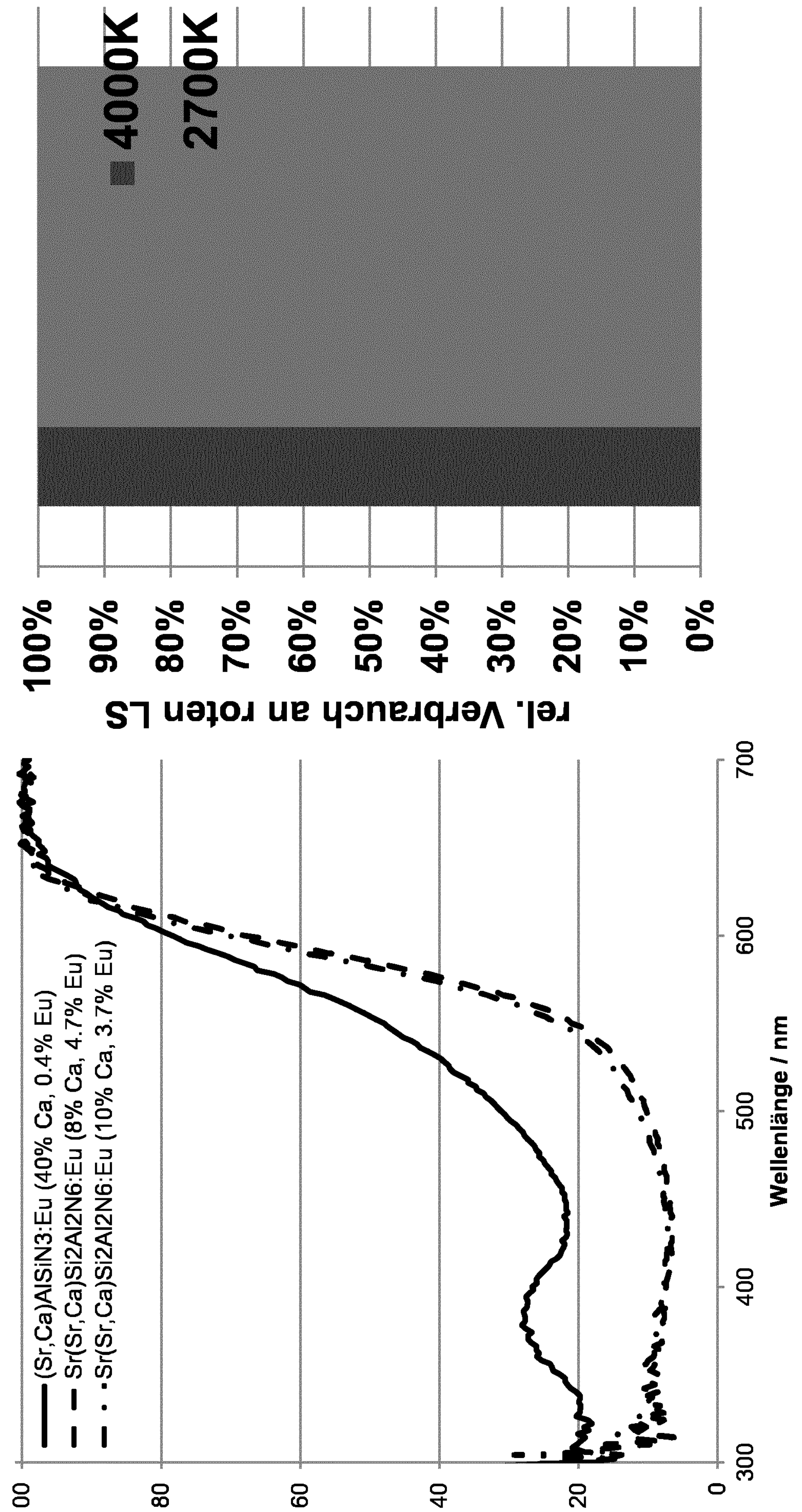

4000K
2700K
rel. Verbrauch an roten LS
100%
90%
80%
70%
60%
50%
40%
30%
20%
10%
0%
(Sr,Ca)AlSiN3:Eu (40% Ca, 0.4% Eu)
Sr(Sr,Ca)Si2Al2N6:Eu (8% Ca, 4.7% Eu)
Sr(Sr,Ca)Si2Al2N6:Eu (10% Ca, 3.7% Eu)
Reflektivität / %
100
80
60
40
20
0
300
400
500
600
700
Wellenlänge / nm

Fig. 52d

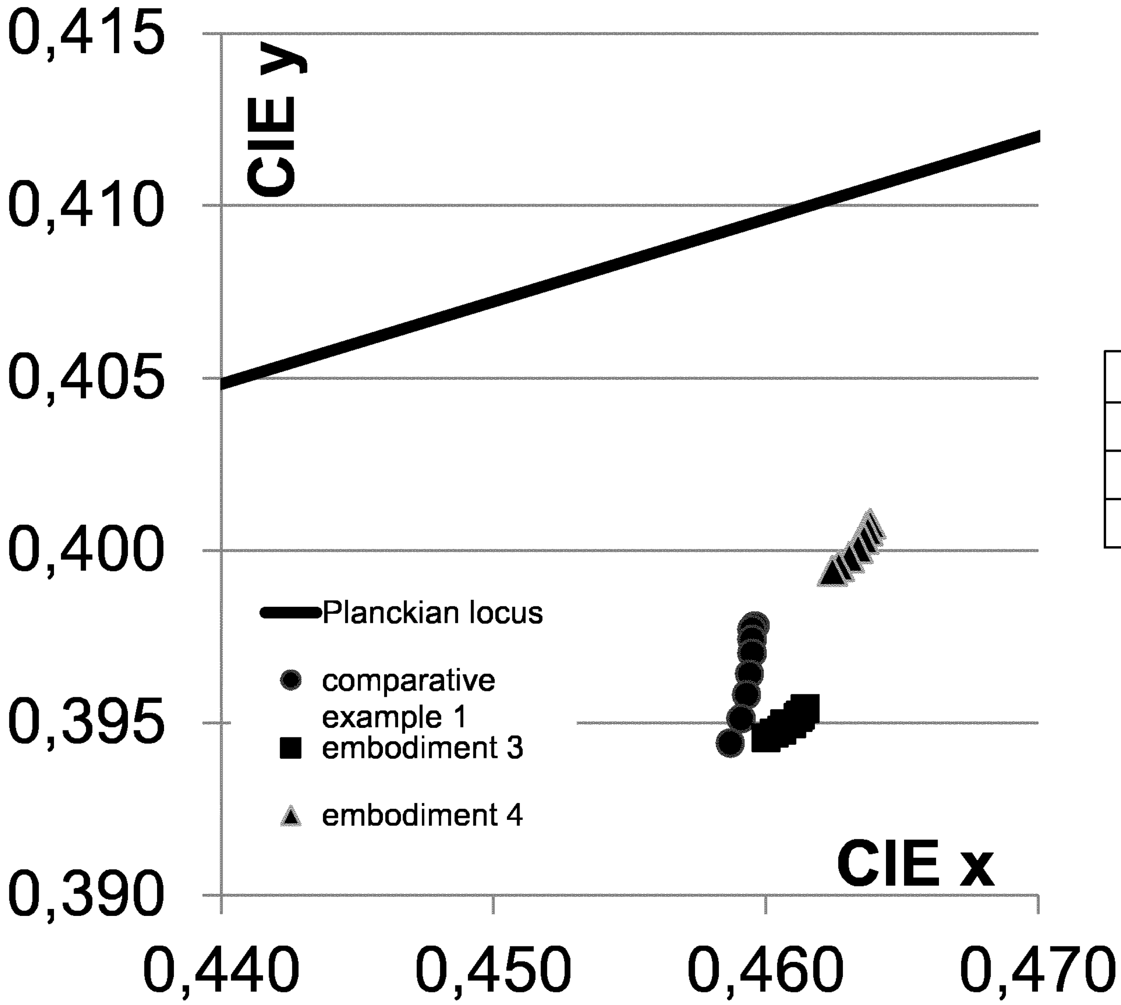


| Warmweiße Bsp. | $[(\Delta CIEx)^2+(\Delta CIEy)^2]^{1/2}$ |
|---|---|
| Vergleichsbeispiel 1 | 0,004 |
| Ausführungsbeispiel 3 | 0,001 |
| Ausführungsbeispiel 4 | 0,002 |

Fig. 52e

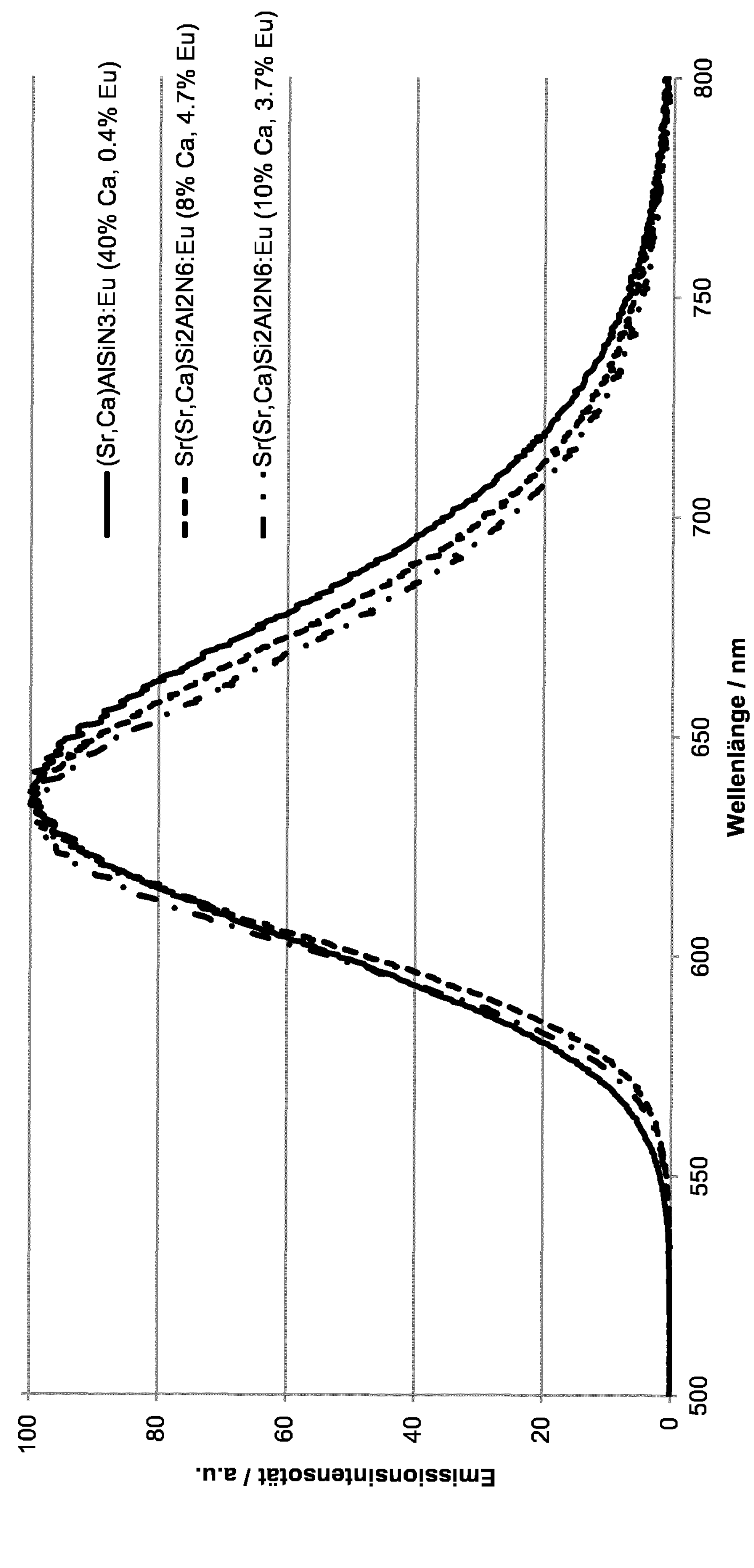
(Sr,Ca)AlSiN3:Eu (40% Ca, 0.4% Eu)
Sr(Sr,Ca)Si2Al2N6:Eu (8% Ca, 4.7% Eu)
Sr(Sr,Ca)Si2Al2N6:Eu (10% Ca, 3.7% Eu)
Emissionsintensität / a.u.
0
20
40
60
80
100
Wellenlänge / nm
500
550
600
650
700
750
800

Fig. 52f

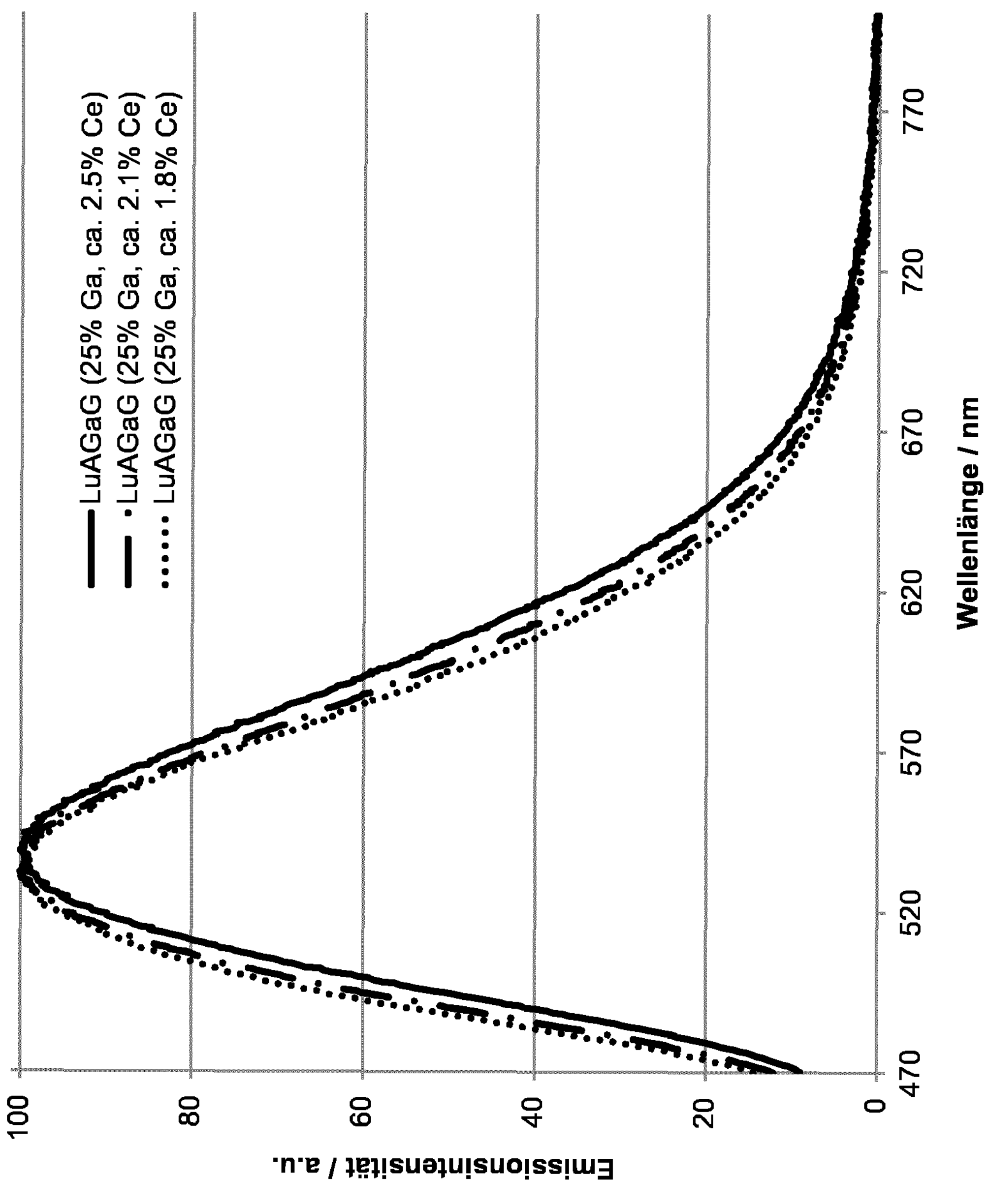

LuAGaG (25% Ga, ca. 2.5% Ce)
LuAGaG (25% Ga, ca. 2.1% Ce)
LuAGaG (25% Ga, ca. 1.8% Ce)
Emissionsintensität / a.u.
100
80
60
40
20
0
470
520
570
620
670
720
770
Wellenlänge / nm

Fig. 52g

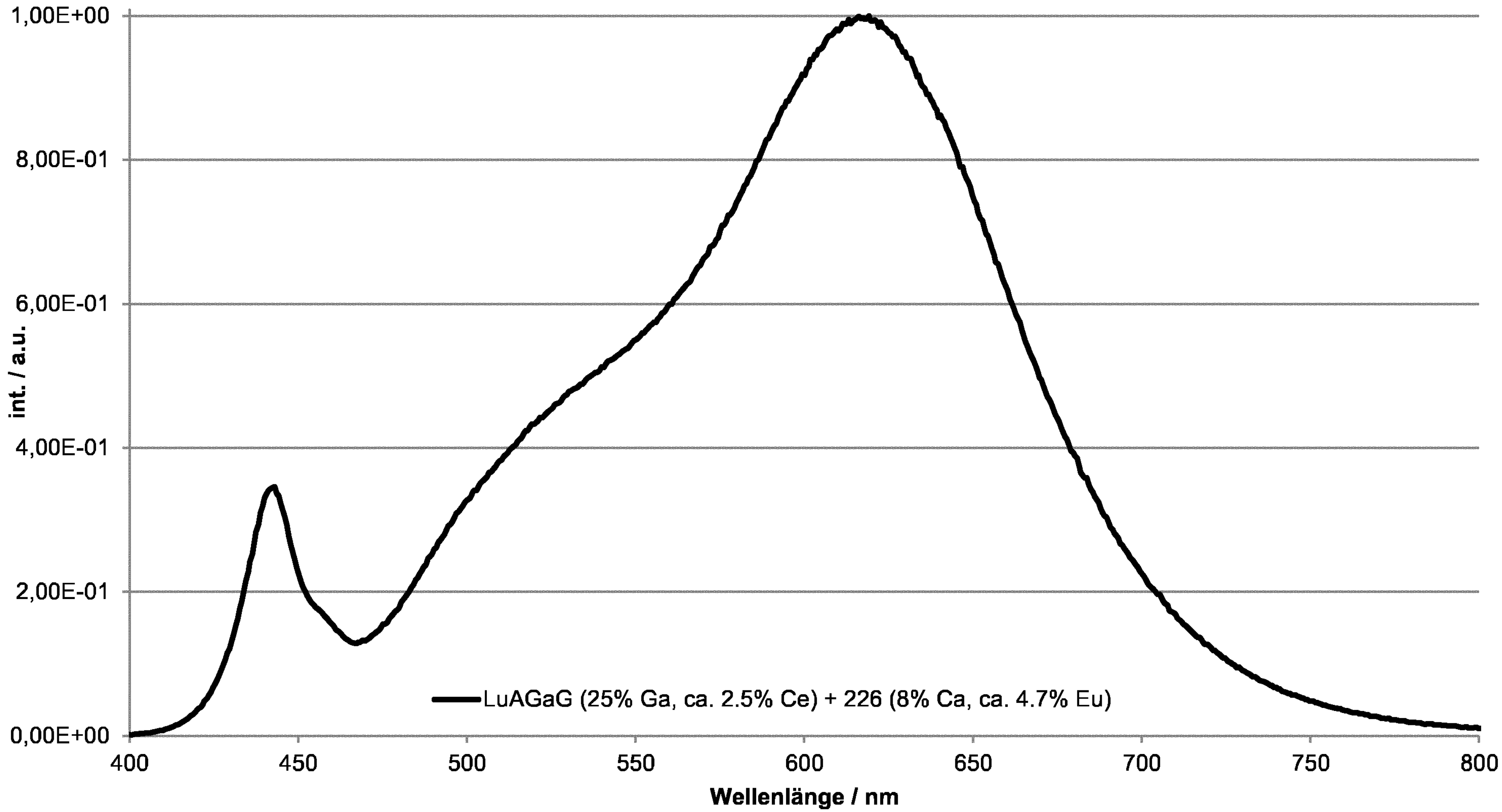
1,00E+00
8,00E-01
6,00E-01
4,00E-01
2,00E-01
0,00E+00
int. / a.u.
400
450
500
550
600
650
700
750
800
Wellenlänge / nm
LuAGaG (25% Ga, ca. 2.5% Ce) + 226 (8% Ca, ca. 4.7% Eu)

Fig. 52h

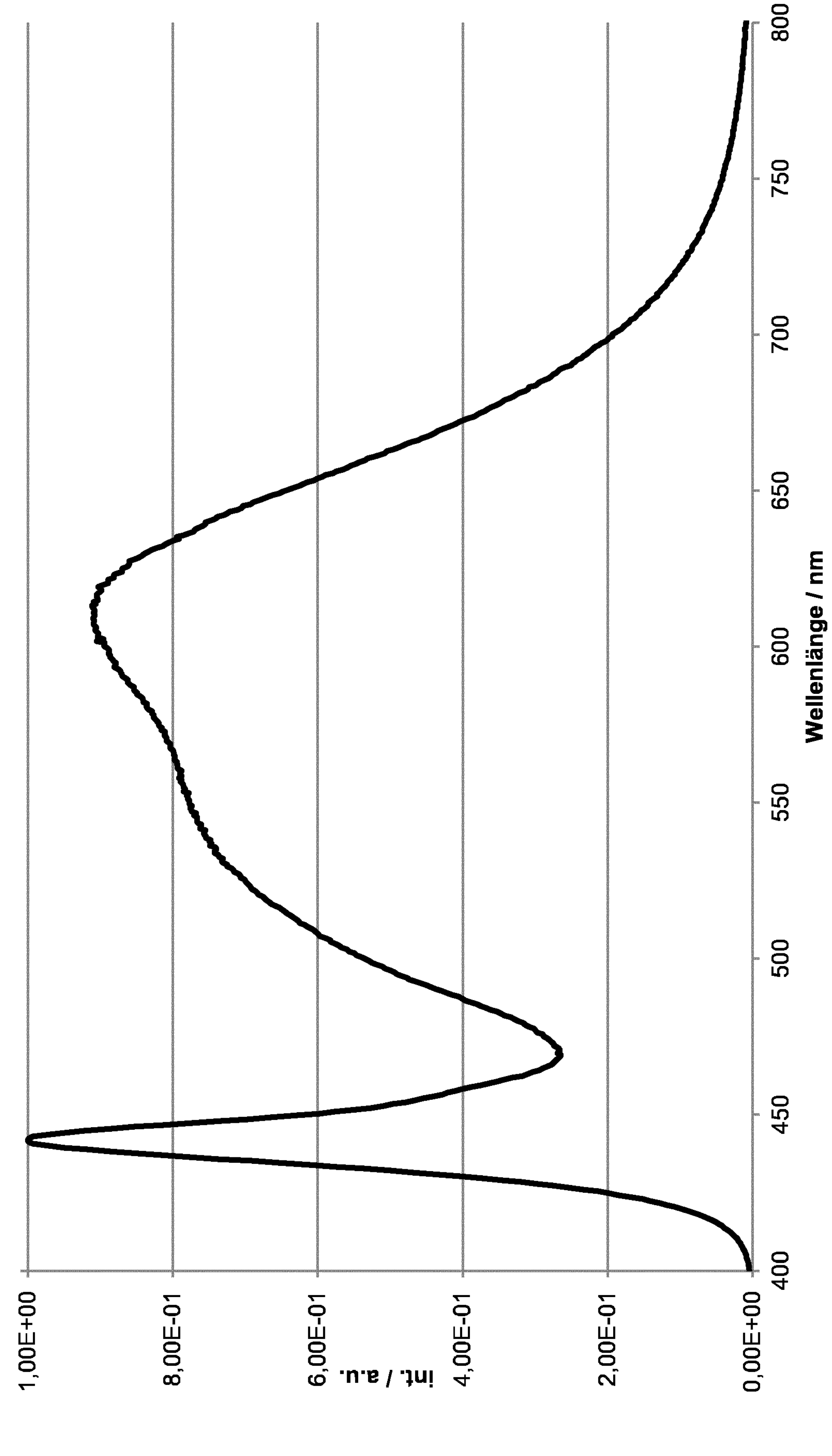

1,00E+00
8,00E-01
6,00E-01
4,00E-01
2,00E-01
0,00E+00
int. / a.u.
400
450
500
550
600
650
700
750
800
Wellenlänge / nm

Fig. 53a

| Beispiel | $\lambda_{dom}$(blaue LED bei 350 mA) | Zusammen-setzung gelb-grüner Leuchtstoff | Zusammen-setzung orange-roter Leuchtstoff | Zusammen-setzung roter Leuchtstoff | Gesamtkonz. Leuchtstoff (Gew%) | Verhältnis gelb-grün/ rot Bzw. gelb-grün/rot/rot |
|---|---|---|---|---|---|---|
| **Vgbl. 1** | 447 | $Lu_3(Al_{0,75}Ga_{0,25})_5O_{12}$: Ce (2% Ce) | $CaAlSi(N,O)_3$:Eu (0,4% Eu) | - | 21,5% | 2,4:1 |
| **Vgbl. 2** | 447 | $Lu_3(Al_{0,75}Ga_{0,25})_5O_{12}$: Ce (2,0 % Ce) | $(Ca_{0,025}Sr_{0,475}Ba_{0,5})_2Si_5N_8$:Eu (2,5% Eu) | $CaAlSi(N,O)_3$: Eu (0,4% Eu) | 19,0% | 3,6:0,2:0,8 |
| **Ausführungsbsp. 1** | 447 | $Lu_3(Al_{0,75}Ga_{0,25})_5O_{12}$: Ce (2% Ce) | $(Sr_{0,5}Ba_{0,5})_2Si_5N_8$:Eu (1% Eu) | $Sr(Sr_{0,8}Ca_{0,2})Si_2Al_2N_6$: Eu (4,5% Eu) | 20,6% | 13,7:0,14:0,86 |
| **Ausführungsbsp. 2** | 447 | $Lu_3(Al_{0,75}Ga_{0,25})_5O_{12}$: Ce (2 % Ce) | $Sr(Sr_{0,86}Ca_{0,14})Si_2Al_2N_6$: Eu (0,8% Eu) | $Sr(Sr_{0,80}Ca_{0,20})Si_2Al_2N_6$: Eu (4,5% Eu) | 20,6% | 13,6:0,11:0,89 |

Fig. 53b

| Beispiel | CIE-x | CIE-y | CRI | Rel. $\Phi_{v(\text{gefüllter Verguß})}$/ $\Phi_{e(\text{klarer Verguß})}$ | Rel. Vs ( visueller Nutzeffekt) | Rel. $\Phi_{e(\text{gefüllter Verguß})}$/ $\Phi_{e(\text{klarer Verguß})}$ |
|---|---|---|---|---|---|---|
| **Vgbl. 1** | 0,460 | 0,411 | 97 | 100% | 100% | 100% |
| **Vgbl. 2** | 0,459 | 0,412 | 94 | 107,5% | 105,9% | 101,5% |
| **Ausführungsbsp. 1** | 0,460 | 0,413 | 92 | 120,9% | 115,7% | 104,5% |
| **Ausführungsbsp. 2** | 0,460 | 0,409 | 92 | 120,2% | 114,7% | 104,8% |

Fig. 53c

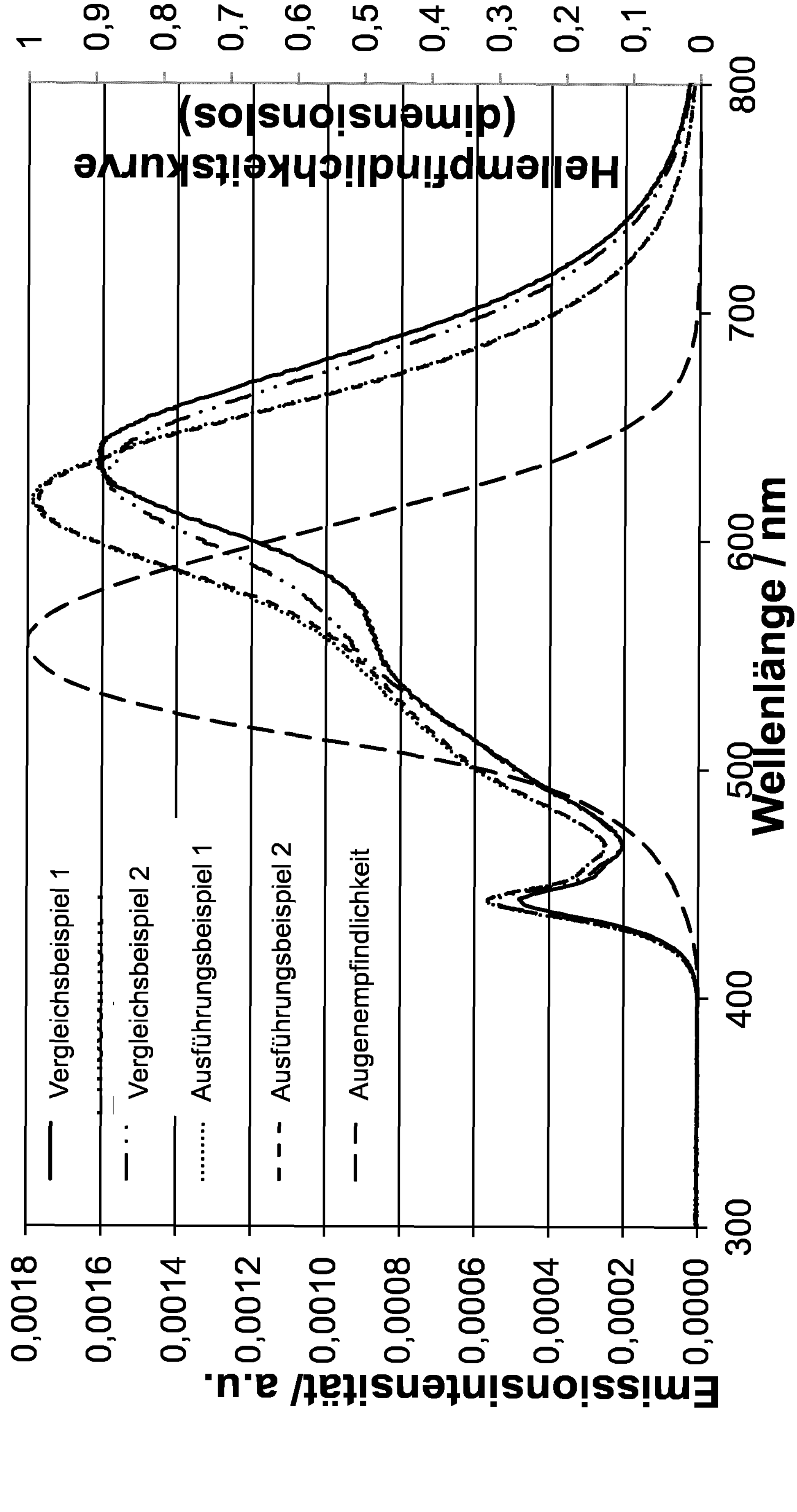
Emissionsintensität/ a.u.
0,0000
0,0002
0,0004
0,0006
0,0008
0,0010
0,0012
0,0014
0,0016
0,0018
Wellenlänge / nm
300
400
500
600
700
800
Hellempfindlichkeitskurve (dimensionslos)
0
0,1
0,2
0,3
0,4
0,5
0,6
0,7
0,8
0,9
1
Vergleichsbeispiel 1
Vergleichsbeispiel 2
Ausführungsbeispiel 1
Ausführungsbeispiel 2
Augenempfindlichkeit

Fig. 53d

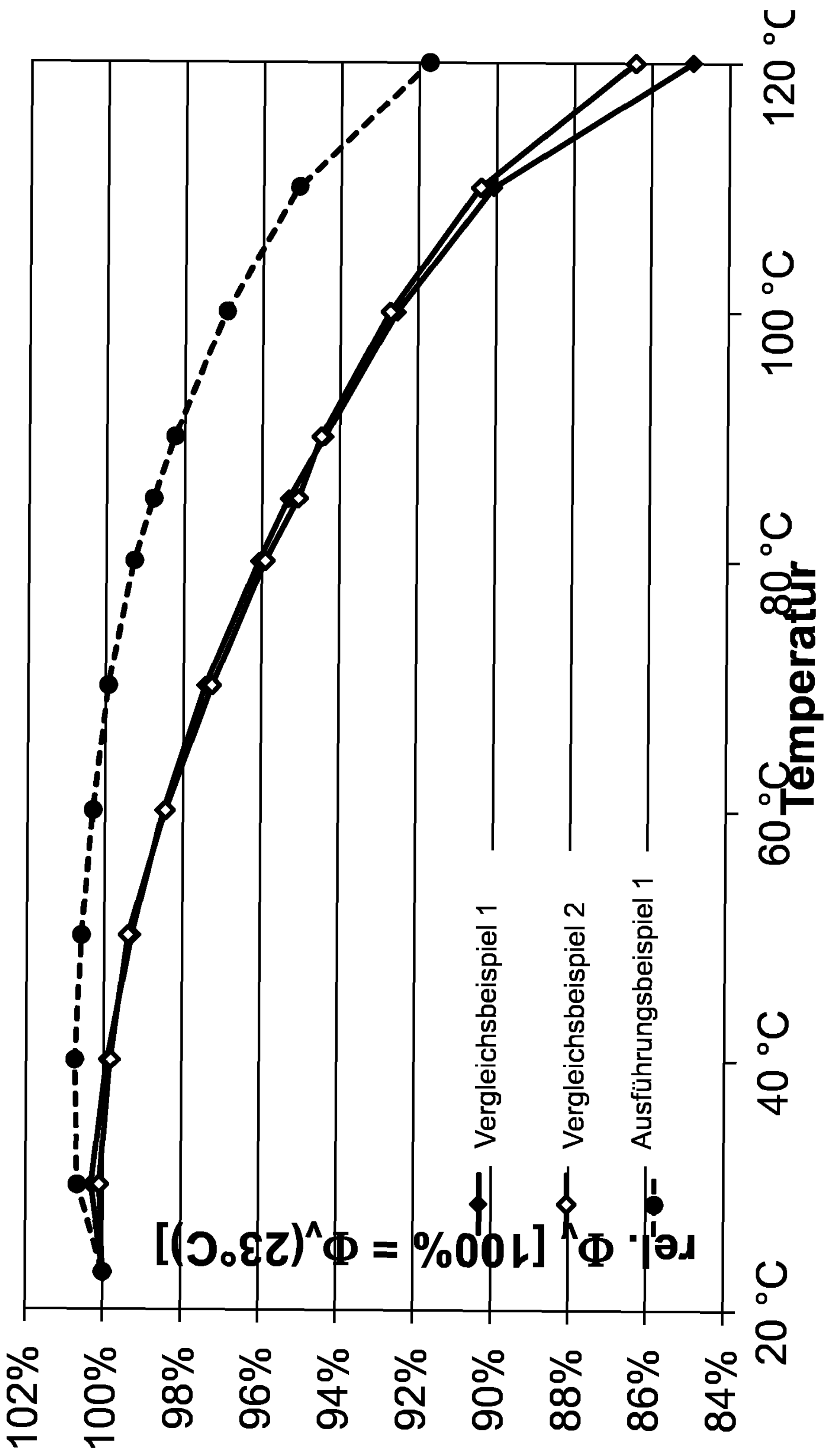
rel. Φv [100% = Φv(23°C)]
102%
100%
98%
96%
94%
92%
90%
88%
86%
84%
20 °C
40 °C
60 °C
80 °C
100 °C
120 °C
Temperatur
Vergleichsbeispiel 1
Vergleichsbeispiel 2
Ausführungsbeispiel 1

Fig. 54

| | **Leuchtstoff** | $\lambda_{dom}$ | **Vs** | **Vs relativ** |
|---|---|---|---|---|
| **Vergleichs-beispiel 6** | $(Ca_{0,5}Sr_{0,5})_2 Si_5N_8:Eu$ (1,2%) | 601 nm | 0,273 | 100 % |
| **Ausführungs-beispiel 7** | $Sr(Sr_{0,8}Ca_{0,2})Si_2Al_2N_6:Eu$ (1,2%) | 597 nm | 0,389 | 142 % |

Fig. 55

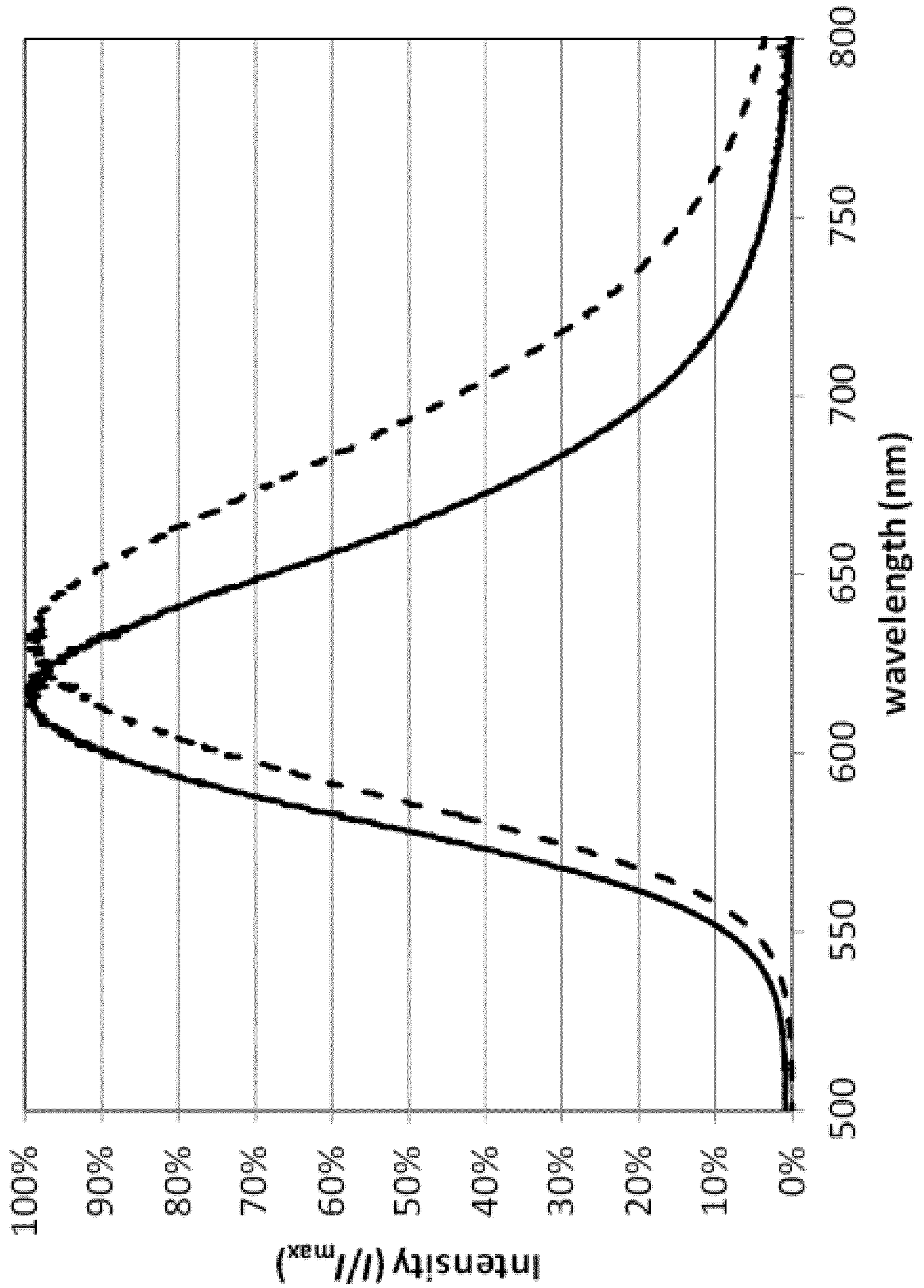
Intensity (I/I$_{max}$)
100%
90%
80%
70%
60%
50%
40%
30%
20%
10%
0%
500
550
600
650
700
750
800
wavelength (nm)

Fig. 56

| | Leuchtstoff | $\lambda_{dom}$ | Vs | Vs relativ |
|---|---|---|---|---|
| **Vergleichs-beispiel 7** | $(Ca_{0,1}Sr_{0,4}Ba_{0,5})_2 Si_5N_8:Eu$ (4%) | 597 nm | 0,343 | 100 % |
| **Ausführungs-beispiel 8** | $Sr(Sr_{0,8}Ca_{0,2})Si_2Al_2N_6:Eu$ (1,2%) | 597 nm | 0,389 | 113 % |

Fig. 57

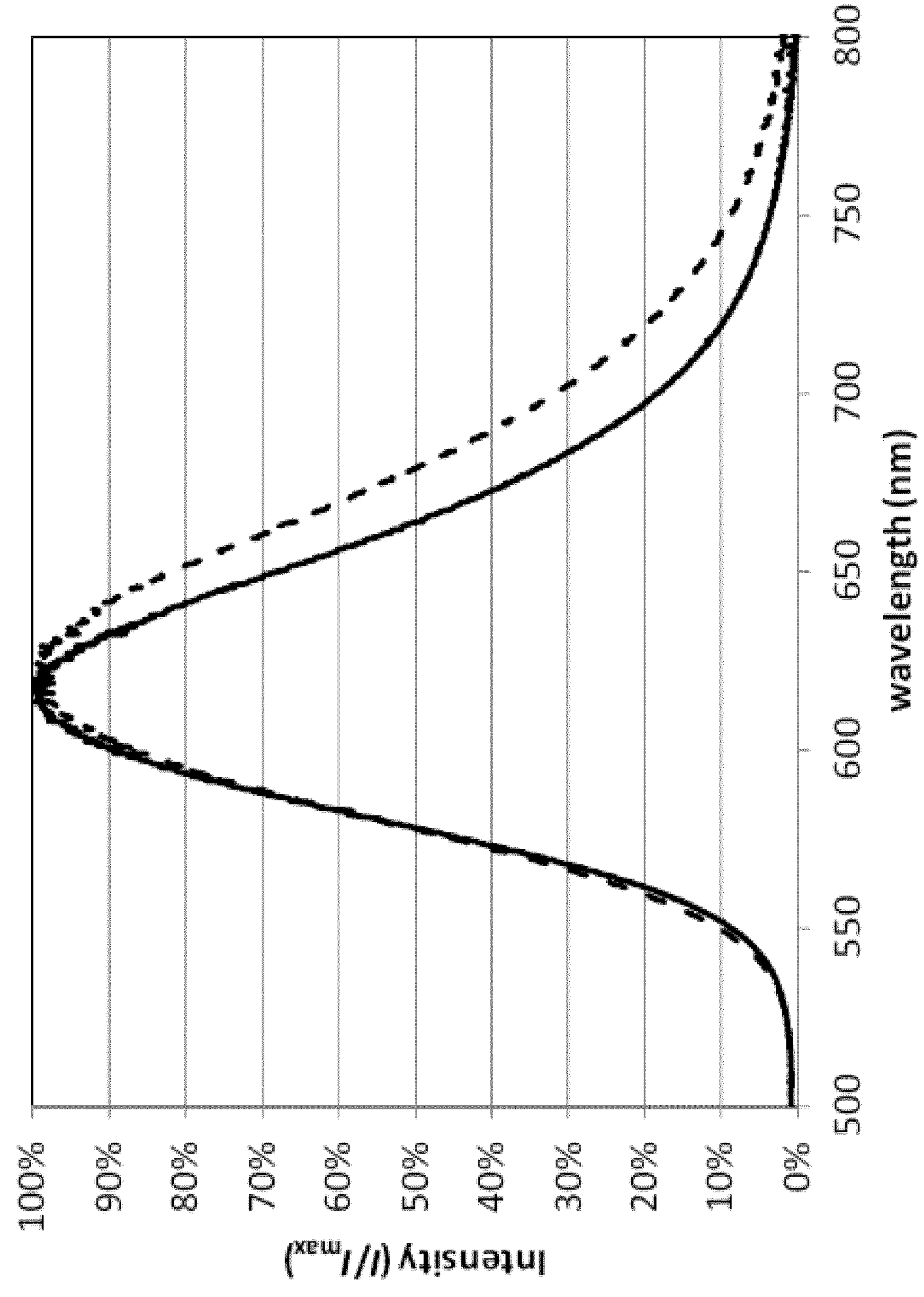
Intensity ($I/I_{max}$)
100%
90%
80%
70%
60%
50%
40%
30%
20%
10%
0%
500
550
600
650
700
750
800
wavelength (nm)

Fig. 58a

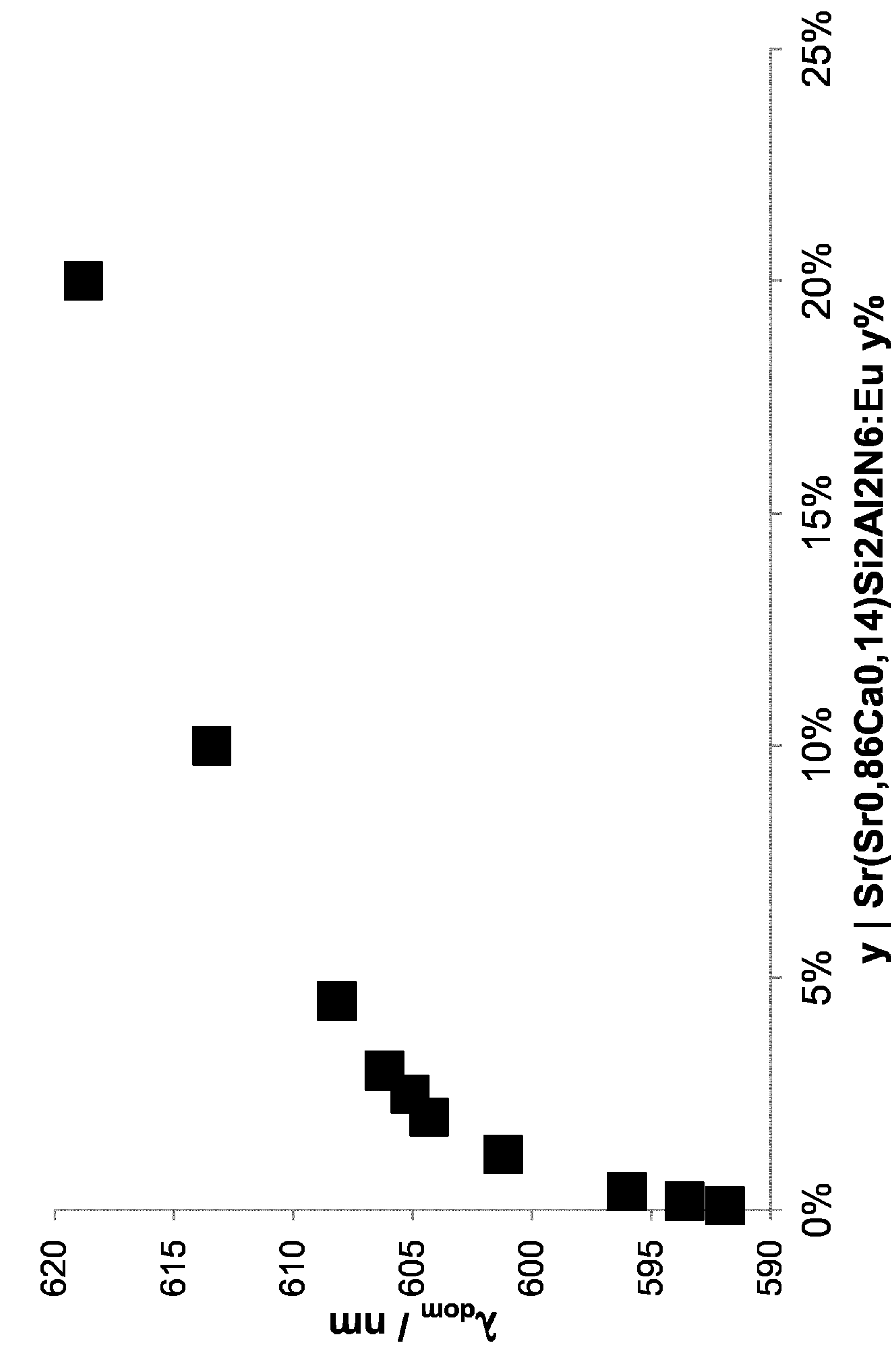

$\lambda_{dom}$ / nm
620
615
610
605
600
595
590
0%
5%
10%
15%
20%
25%
y | Sr(Sr0,86Ca0,14)Si2Al2N6:Eu y%

Fig. 58b

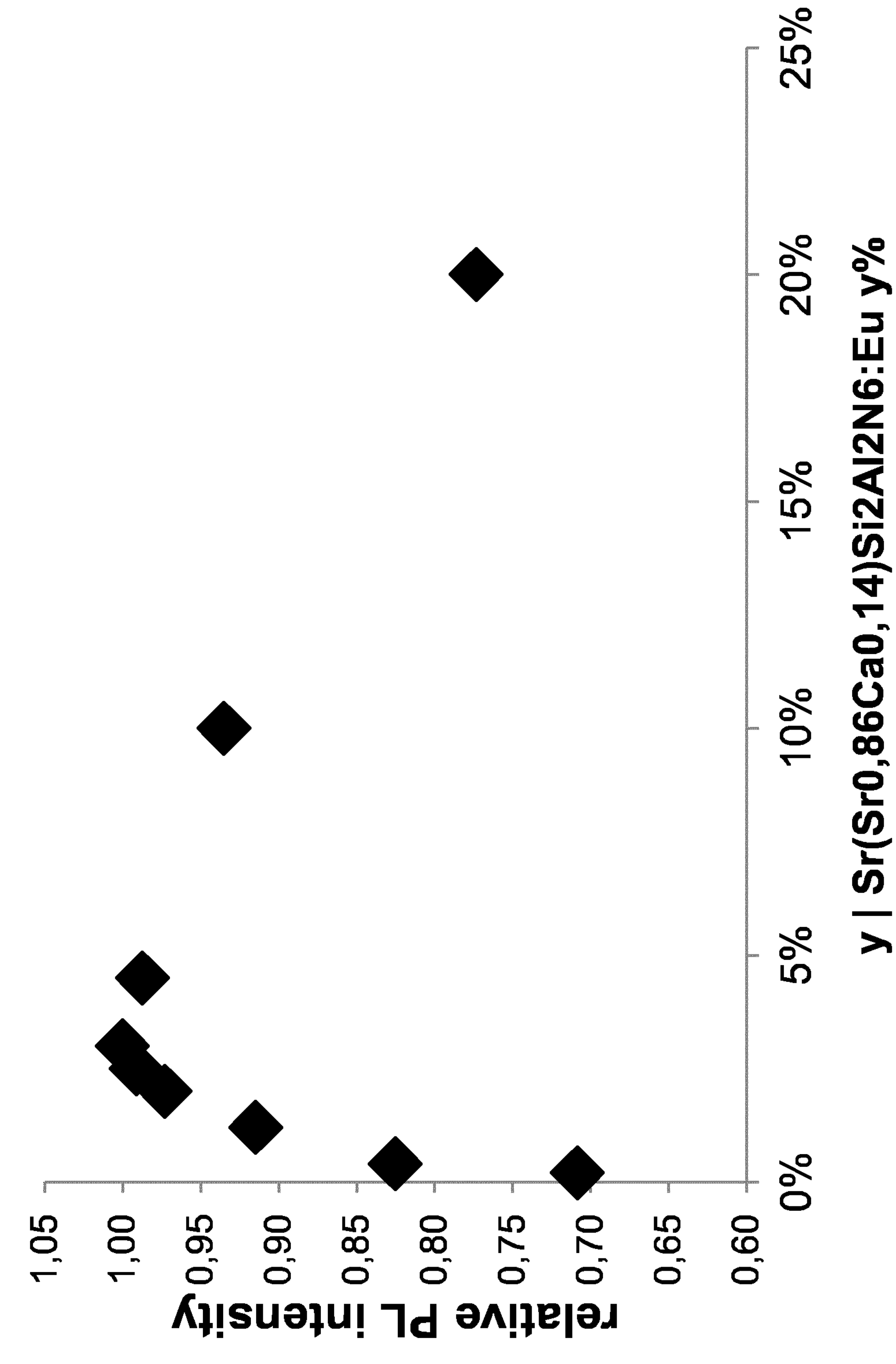
relative PL intensity
1,05
1,00
0,95
0,90
0,85
0,80
0,75
0,70
0,65
0,60
0%
5%
10%
15%
20%
25%
y | Sr(Sr0,86Ca0,14)Si2Al2N6:Eu y%

Fig. 58c

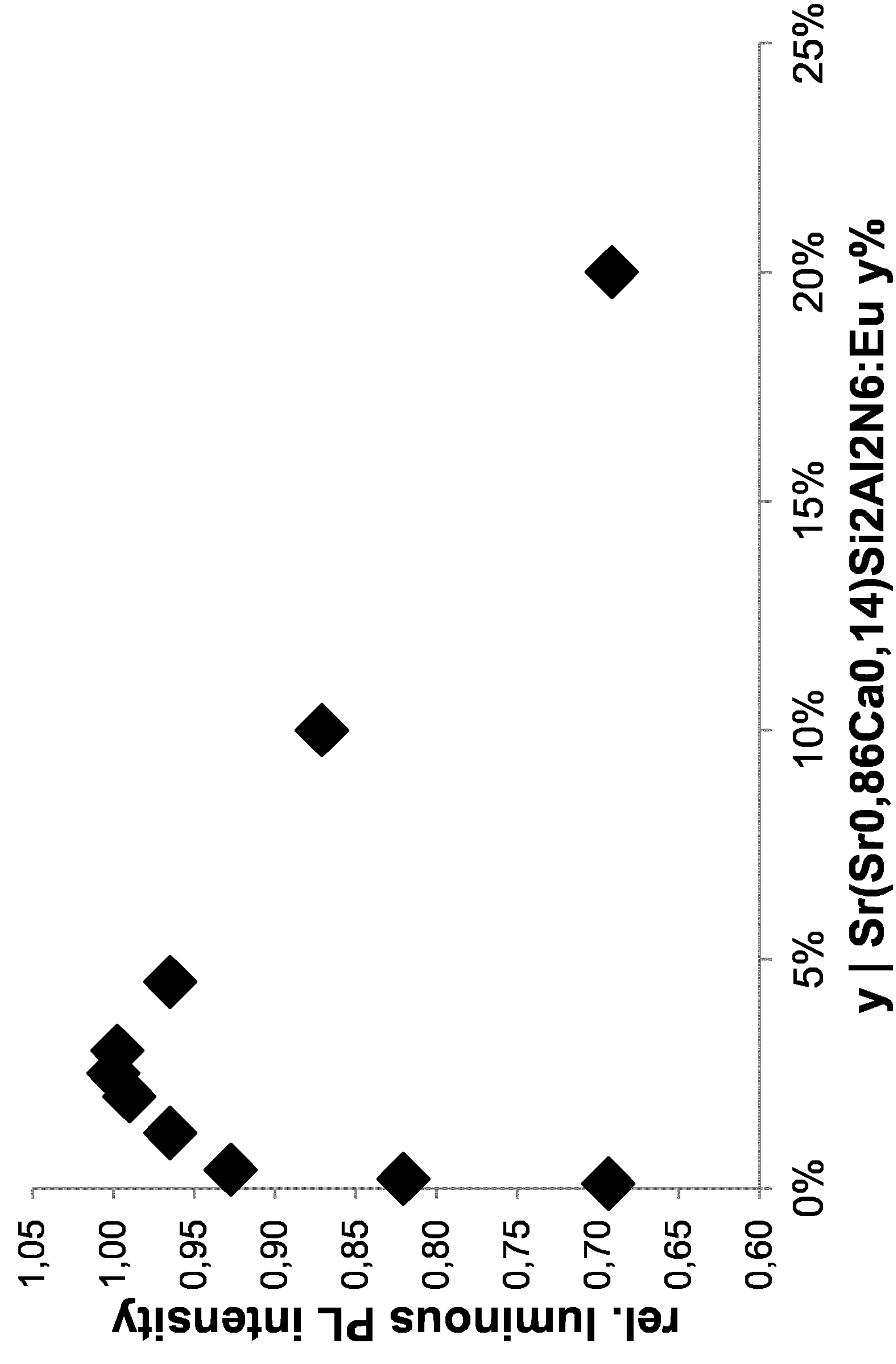
rel. luminous PL intensity
1,05
1,00
0,95
0,90
0,85
0,80
0,75
0,70
0,65
0,60
0%
5%
10%
15%
20%
25%
y | Sr(Sr0,86Ca0,14)Si2Al2N6:Eu y%

Fig. 59a

| Nominelle Zusammensetzung | R(450-470) | CIE-x: | CIE-y: | Vs | Idom [nm] | FWHM [nm] |
|---|---|---|---|---|---|---|
| $Sr_{(1-x)}(Sr_{0.8}Ca_{0.2})_{(1-y)}Cu_{(x+y)}Si_2Al_2N_6$ : 2% Eu (x+y=0.2) | 15,6% | 0,646 | 0,352 | 0,260 | 604,8 | 90,0 |
| $Sr_{(1-x)}(Sr_{0.8}Ca_{0.2})_{(1-y)}Zn_{(x+y)}Si_2Al_2N_6$ : 2% Eu (x+y=0.2) | 14,8% | 0,648 | 0,350 | 0,275 | 605,4 | 83,2 |
| $Sr_{(1-x)}(Sr_{0.8}Ca_{0.2})_{(1-y)}(La\ Li)_{(x+y)}Si_2Al_2N_6$ : 2% Eu (x+y=0.2) | 11,4% | 0,640 | 0,353 | 0,183 | 604,5 | 146,0 |
| $Sr_{(1-x)}(Sr_{0.86}Ca_{0.14})_{(1-y)}(La\ Li)_{(x+y)}Si_2Al_2N_6$ : 3% Eu (x+y=0.04) | 10,6% | 0,648 | 0,349 | 0,215 | 605,6 | 103,3 |
| $Sr_{(1-x)}(Sr_{0.86}Ca_{0.14})_{(1-y)}La_{(x+y)}Si_{2-(x+y)}Al_{2+(x+y)}N_6$ : 3% Eu (x+y=0.2) | 10,0% | 0,464 | 0,352 | 0,234 | 604,8 | 100,3 |

Fig. 59b

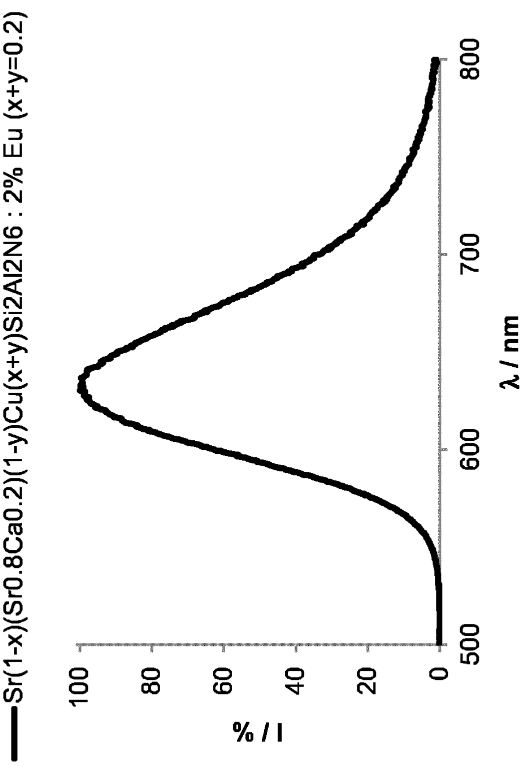


Fig. 59c

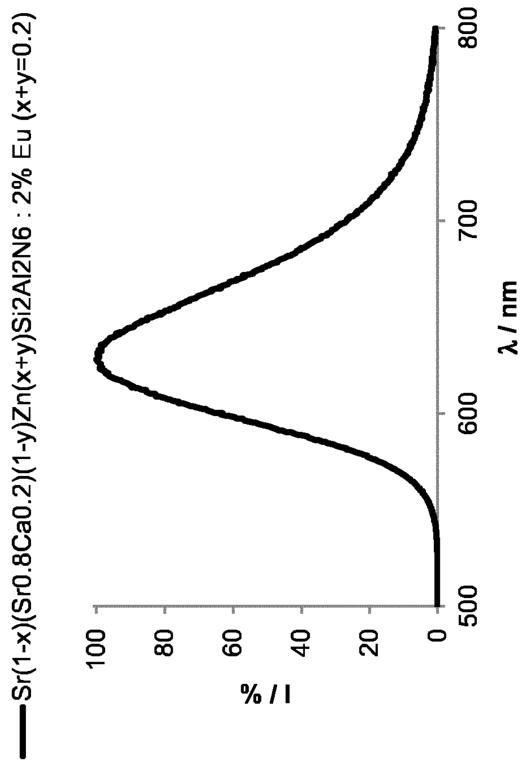

Fig. 59d

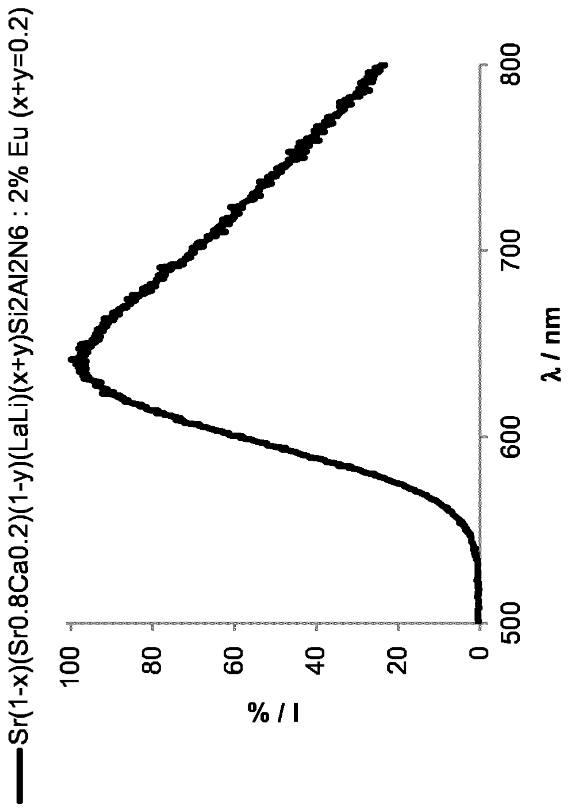


Fig. 59e

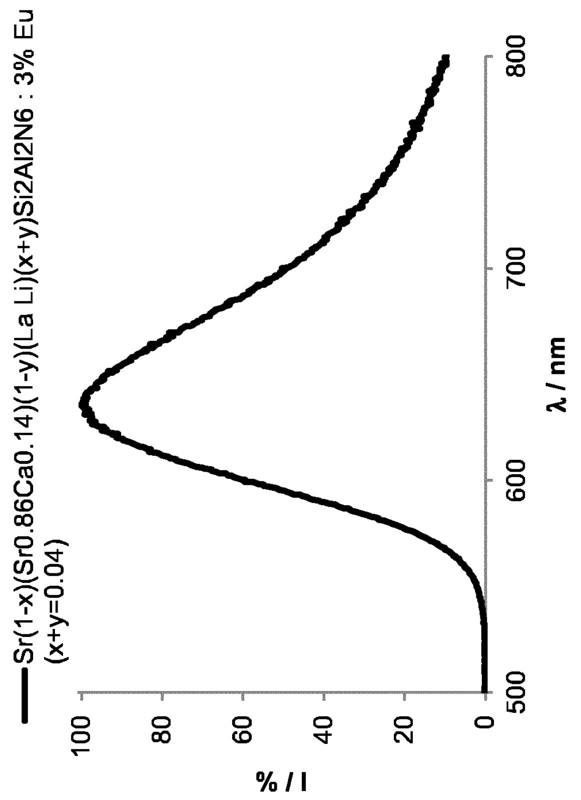

Fig. 59f

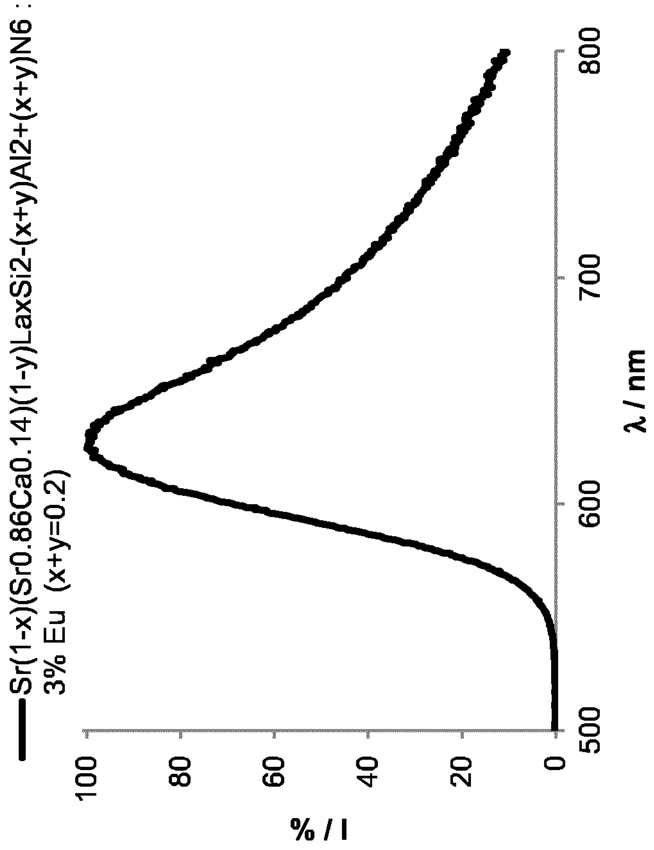
Sr(1-x)(Sr0.86Ca0.14)(1-y)LaxSi2-(x+y)Al2+(x+y)N6 : 3% Eu (x+y=0.2)
I / %
100
80
60
40
20
0
500
600
700
800
λ / nm

Fig. 59g

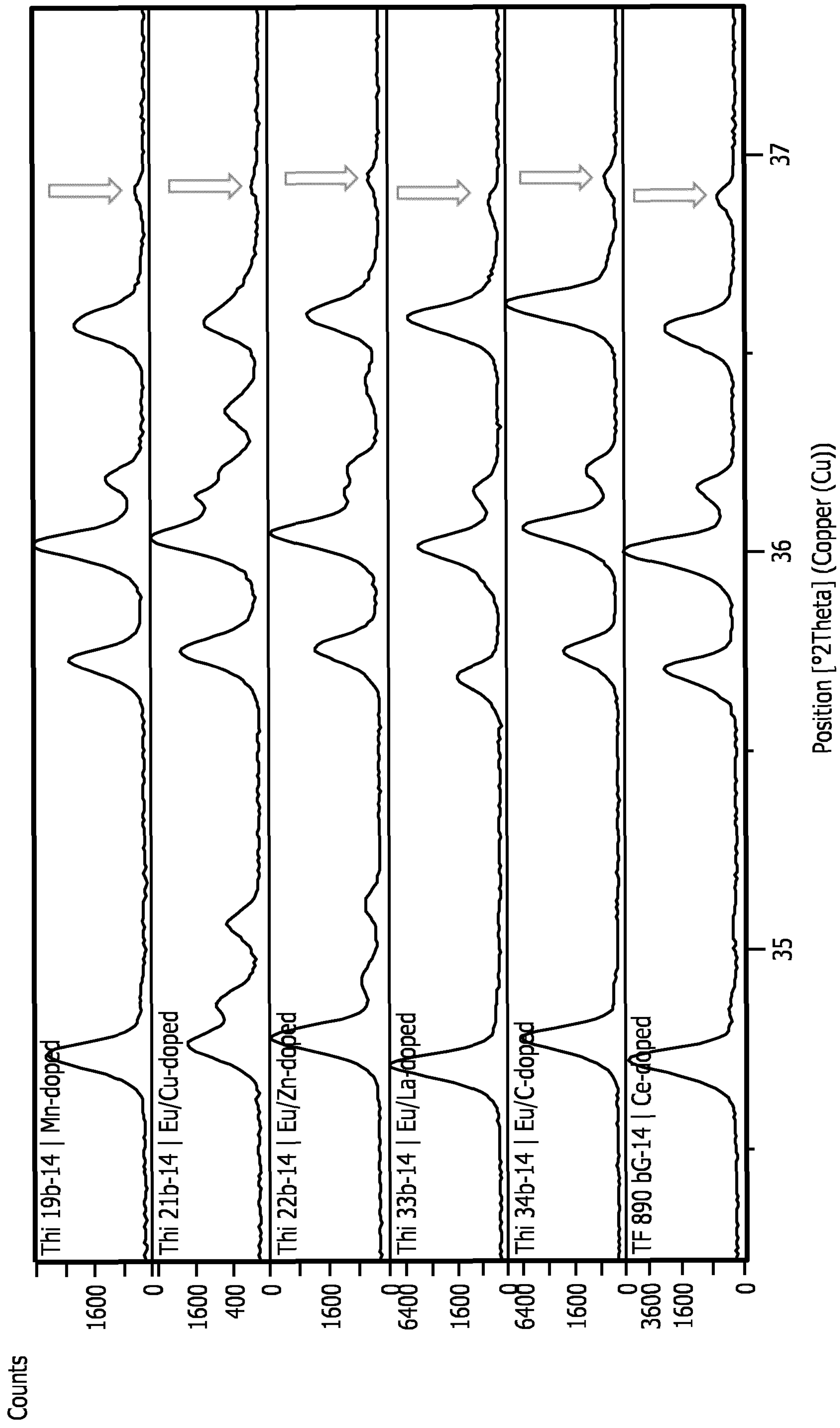
Counts
Thi 19b-14 | Mn-doped
Thi 21b-14 | Eu/Cu-doped
Thi 22b-14 | Eu/Zn-doped
Thi 33b-14 | Eu/La-doped
Thi 34b-14 | Eu/C-doped
TF 890 bG-14 | Ce-doped
1600
0
1600
400
0
1600
0
6400
1600
0
6400
1600
0
3600
1600
0
35
36
37
Position [°2Theta] (Copper (Cu))

Fig. 60a

| Nominelle Zusammensetzung | R(450-470) | CIE-x: | CIE-y: | Vs | ldom [nm] | Centroid WL [nm] | FWHM [nm] |
|---|---|---|---|---|---|---|---|
| $Sr(Sr_{0.8}Ca_{0.2})Si_2Al_2N_6$ : 3% Eu | 7,2% | 0,653 | 0,346 | 0,275 | 606,4 | 641,1 | 77,6 |
| $Sr(Sr_{0.8}Ca_{0.2})(Si_{1.98}C_{0.02})Al_2N_6$ : 3% Eu | 7,8% | 0,656 | 0,343 | 0,258 | 607,3 | 643,8 | 79,8 |
| $Sr(Sr_{0.8}Ca_{0.2})(Si_{1.60}C_{0.40})Al_2N_6$ : 3% Eu | 8,2% | 0,656 | 0,343 | 0,245 | 607,3 | 646,2 | 83,5 |

Fig. 60b

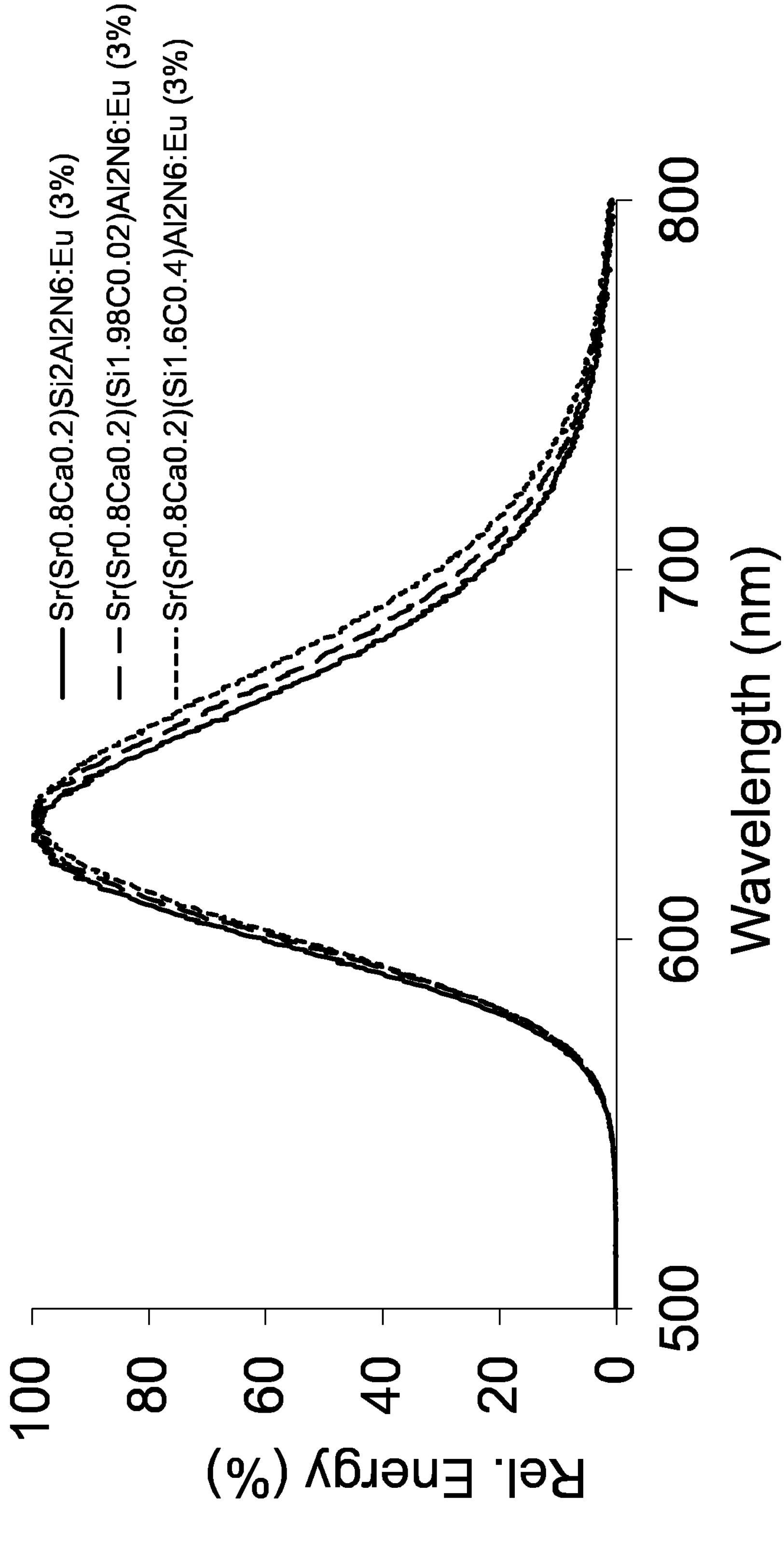
Sr(Sr0.8Ca0.2)Si2Al2N6:Eu (3%)
Sr(Sr0.8Ca0.2)(Si1.98C0.02)Al2N6:Eu (3%)
Sr(Sr0.8Ca0.2)(Si1.6C0.4)Al2N6:Eu (3%)
Rel. Energy (%)
100
80
60
40
20
0
500
600
700
800
Wavelength (nm)

Fig. 61a

| Nominelle Zusammensetzung | R(450-470) | CIE-x: | CIE-y: | Vs | ldom [nm] | FWHM [nm] |
|---|---|---|---|---|---|---|
| $Sr(Sr_{0.8}Ca_{0.2})Si_2Al_2N_6$:Eu(1,5%),Ce(1,5%),Li(1,5%) | 13,3% | 0,638 | 0,36 | 0,292 | 602,8 | 88,0 |
| $Sr(Sr_{0.8}Ca_{0.2})Si_2Al_2N_6$:Mn(2%) | 79,6% | 0,573 | 0,423 | 0,480 | 590,1 | 85,5 |
| $Sr(Sr_{0.8}Ca_{0.2})Si_2Al_2N_6$:Ce(1%) | 45,2% | 0,452 | 0,524 | 0,611 | 572,4 | 126,9 |

Fig. 61b

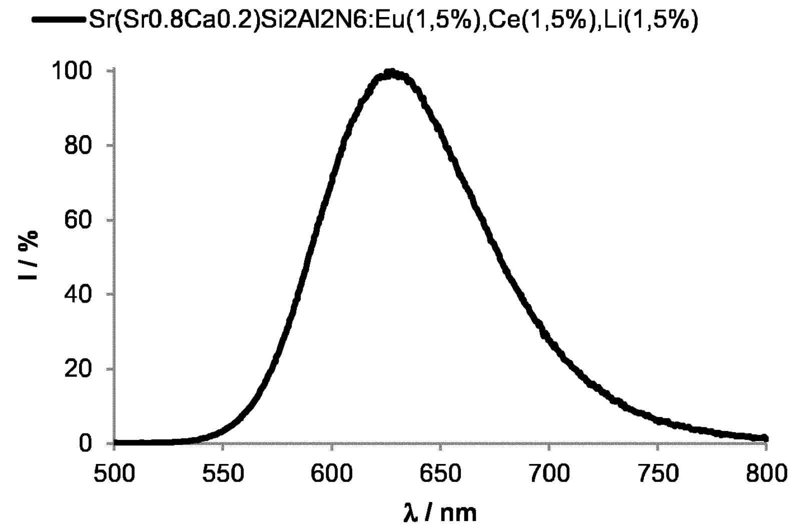

Fig. 61c

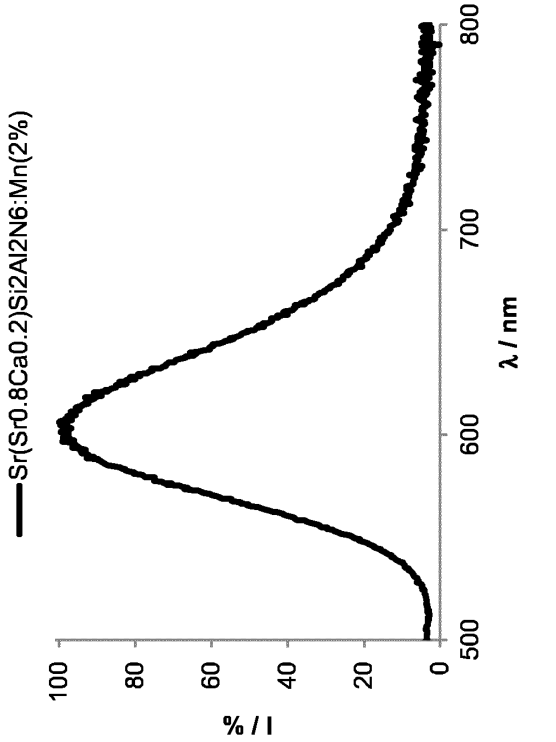


Fig. 61d

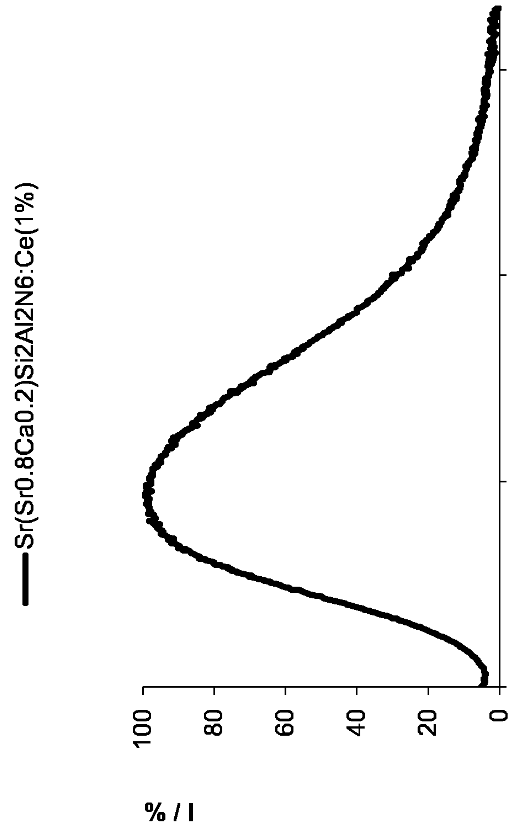

Fig. 62a

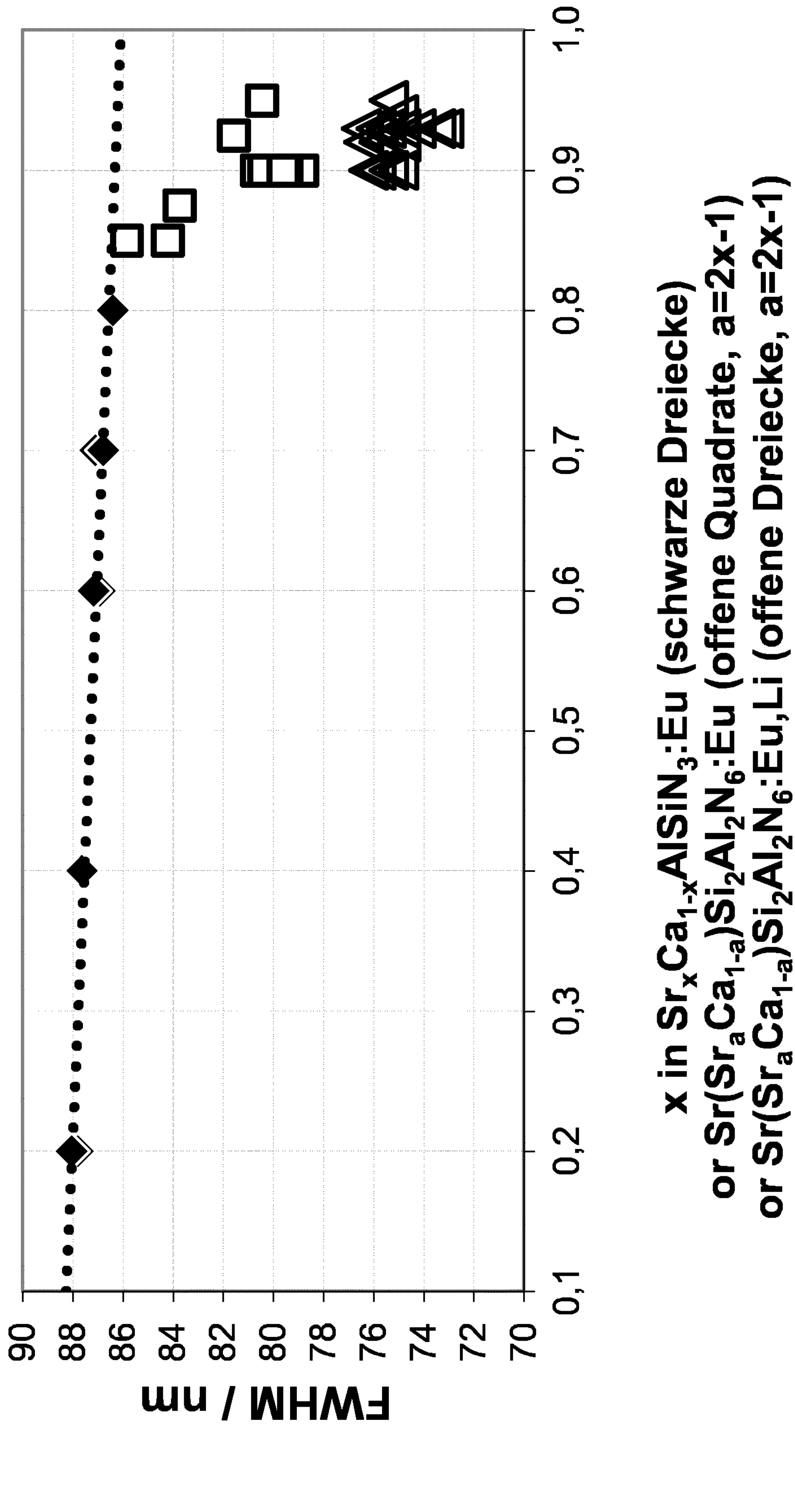
FWHM / nm
90
88
86
84
82
80
78
76
74
72
70
0,1
0,2
0,3
0,4
0,5
0,6
0,7
0,8
0,9
1,0
x in $Sr_xCa_{1-x}AlSiN_3$:Eu (schwarze Dreiecke)
or $Sr(Sr_aCa_{1-a})Si_2Al_2N_6$:Eu (offene Quadrate, a=2x-1)
or $Sr(Sr_aCa_{1-a})Si_2Al_2N_6$:Eu,Li (offene Dreiecke, a=2x-1)

Fig. 62b

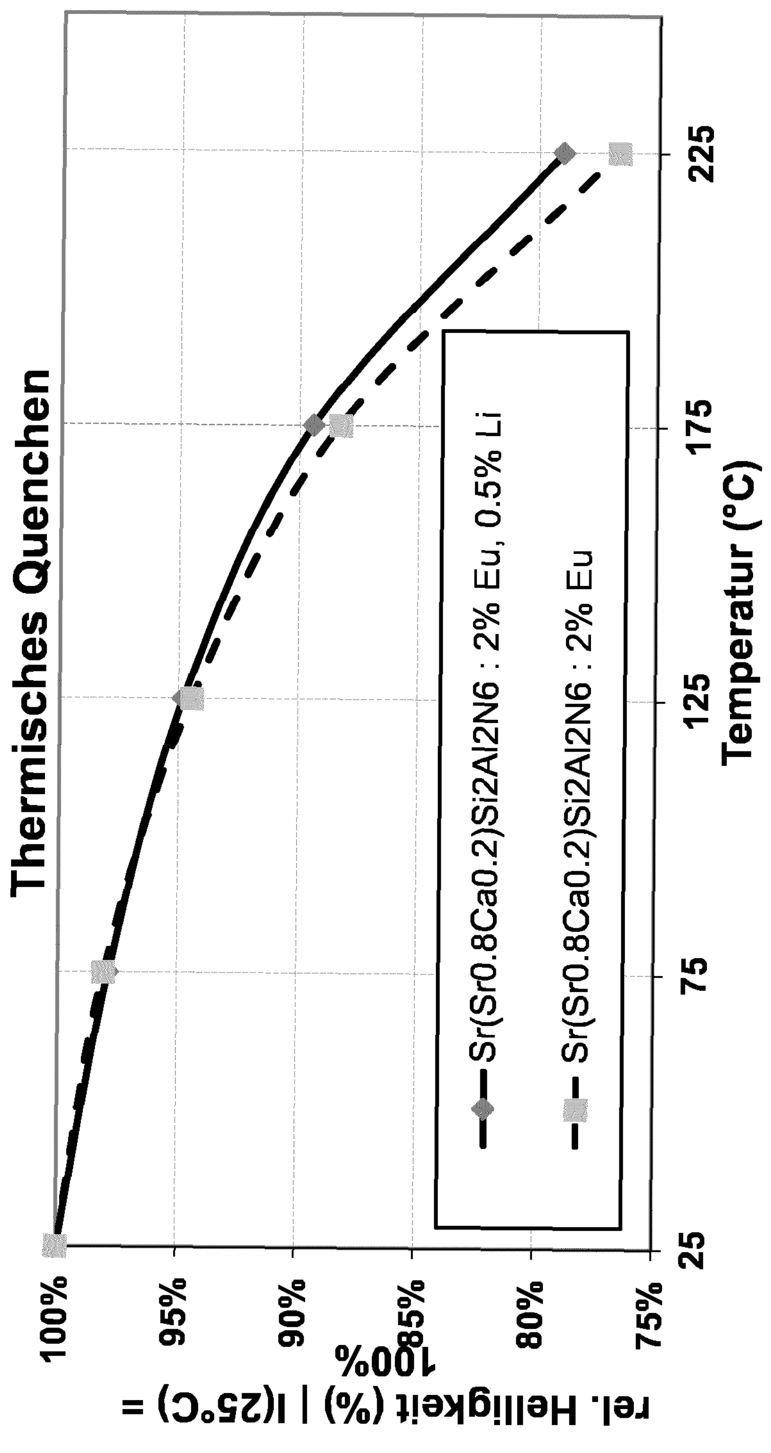
Thermisches Quenchen
rel. Helligkeit (%) | I(25°C) = 100%
100%
95%
90%
85%
80%
75%
25
75
125
175
225
Temperatur (°C)
Sr(Sr0.8Ca0.2)Si2Al2N6 : 2% Eu, 0.5% Li
Sr(Sr0.8Ca0.2)Si2Al2N6 : 2% Eu

Fig. 62c

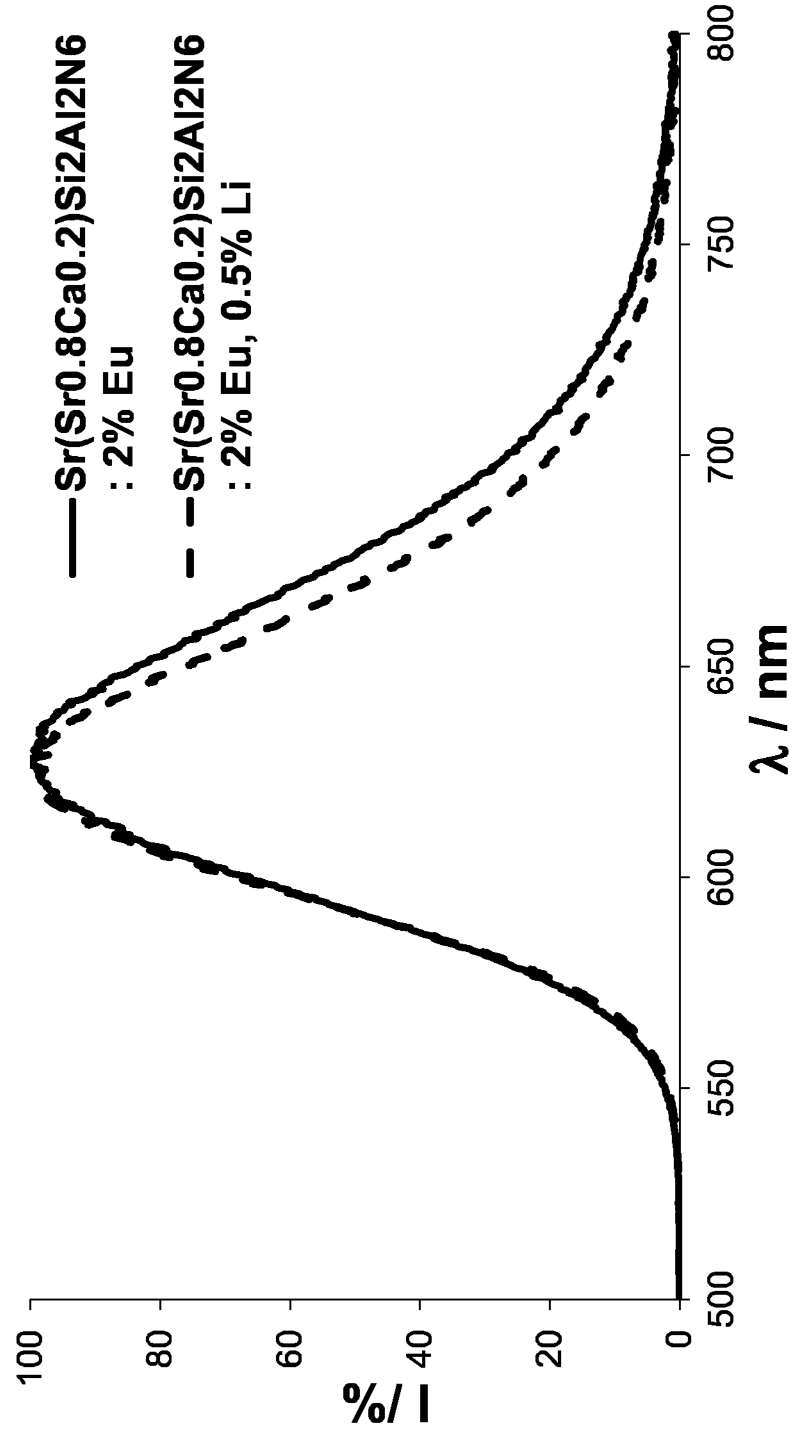
Sr(Sr0.8Ca0.2)Si2Al2N6
: 2% Eu
Sr(Sr0.8Ca0.2)Si2Al2N6
: 2% Eu, 0.5% Li
I /%
100
80
60
40
20
0
500
550
600
650
700
750
800
λ / nm

Fig. 62d

| Zusammensetzung | rel. Q.E. | CIE-x: | CIE-y: | Vs | Centroid WL [nm] | λdom [nm] | FWHM [nm] |
|---|---|---|---|---|---|---|---|
| $Sr(Sr_{0,8}Ca_{0,2})Si_2Al_2N_6$:Eu (2%), Li (0,5%) | 107% | 0,645 | 0,353 | 0,304 | 637,1 | 604,6 | 77,4 |
| $Sr(Sr_{0,8}Ca_{0,2})Si_2Al_2N_6$:Eu (2%) | 100% | 0,644 | 0,355 | 0,284 | 641,0 | 604,1 | 84,5 |

Fig. 62e

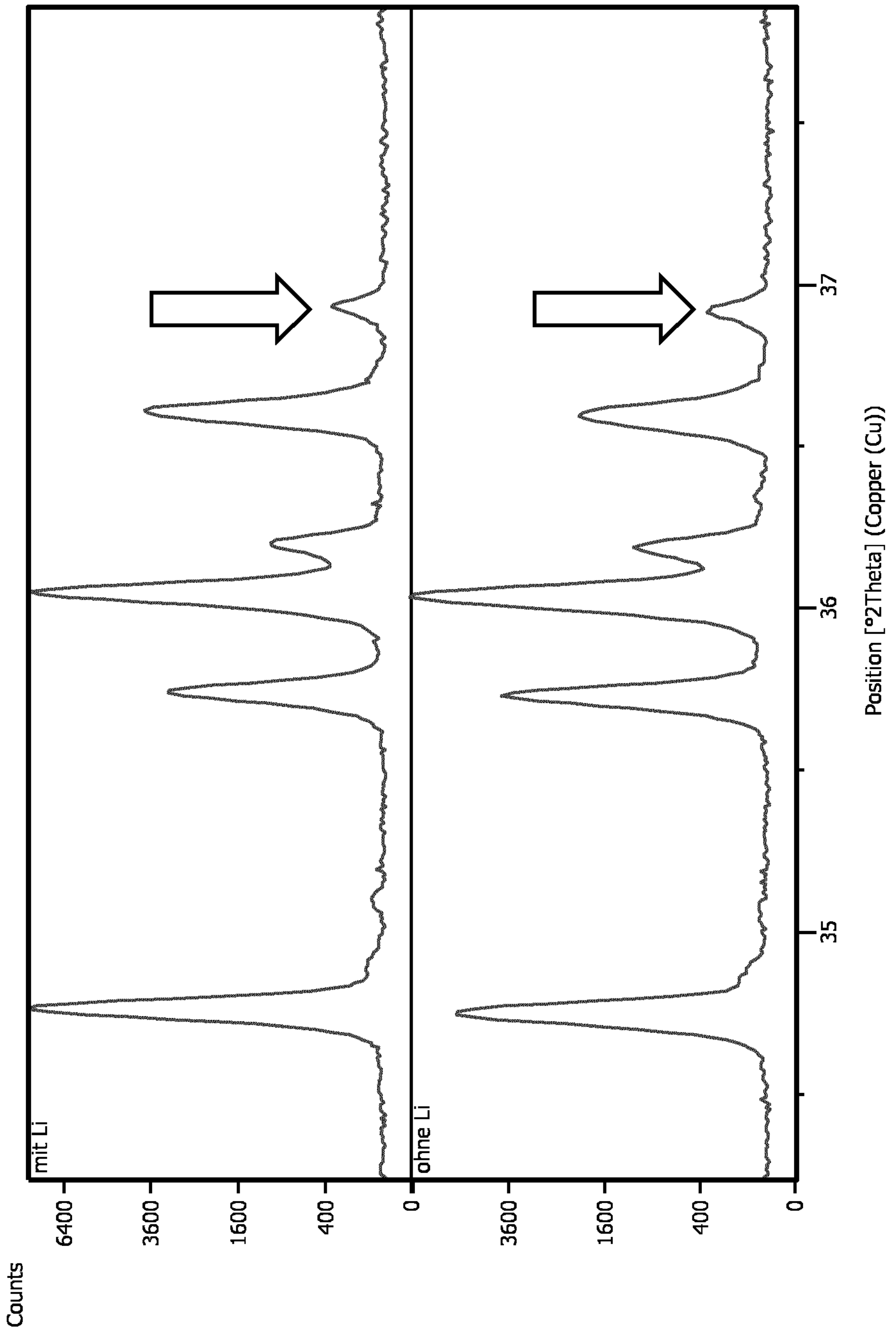
Counts
6400
3600
1600
400
0
3600
1600
400
0
mit Li
ohne Li
35
36
37
Position [°2Theta] (Copper (Cu))

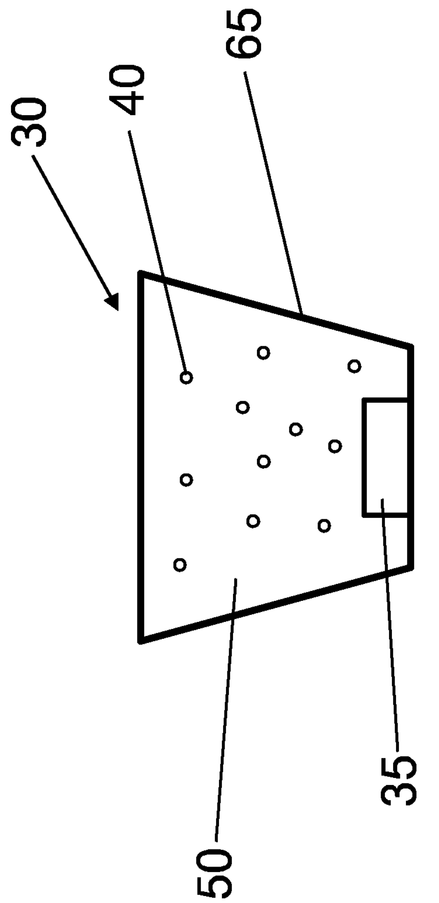


Fig. 63

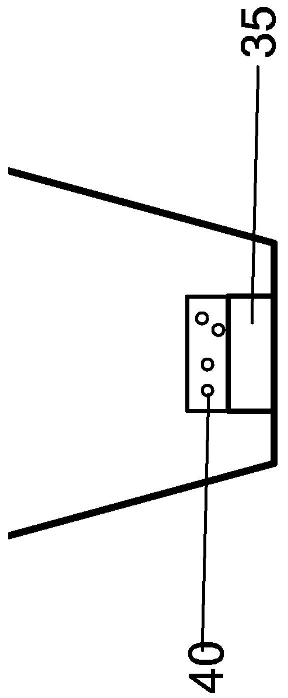


Fig. 64

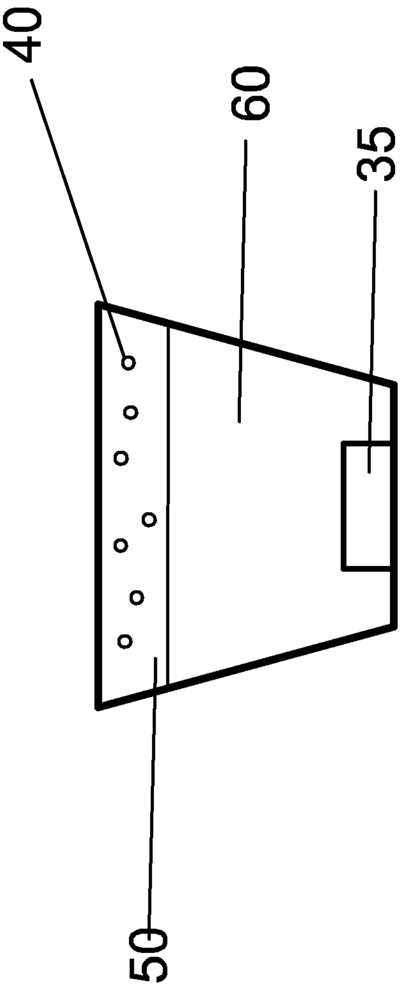


Fig. 65

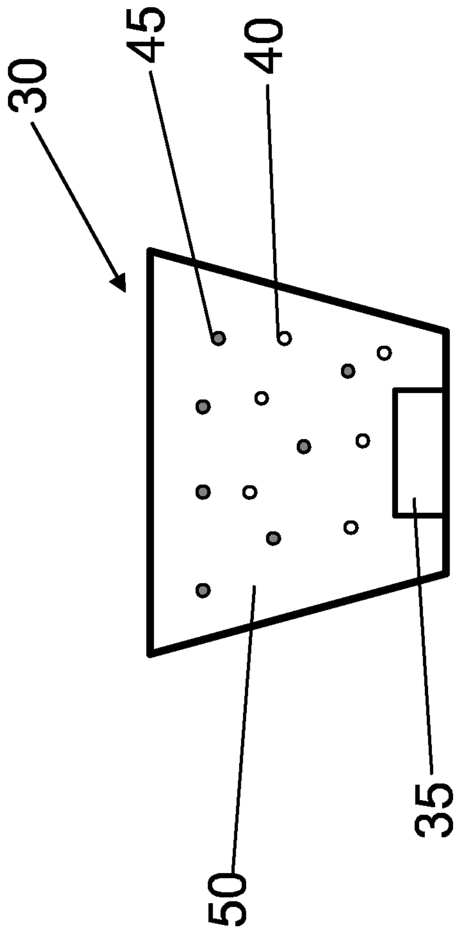


Fig. 66

Fig. 67

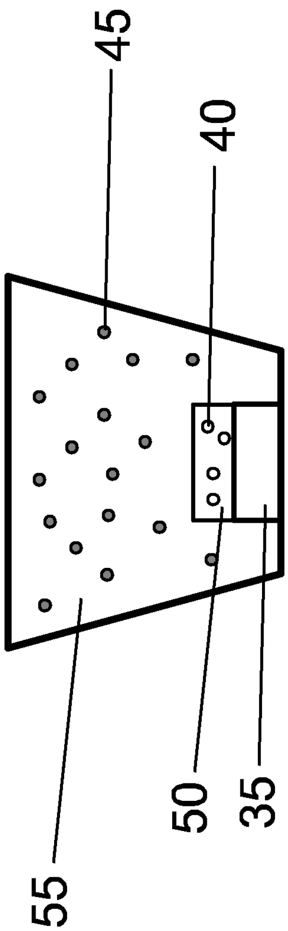


Fig. 68a und 68b

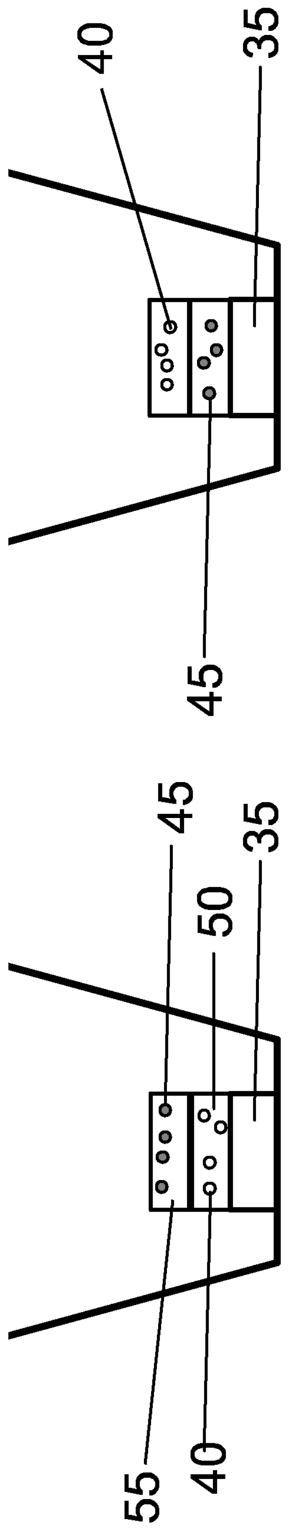

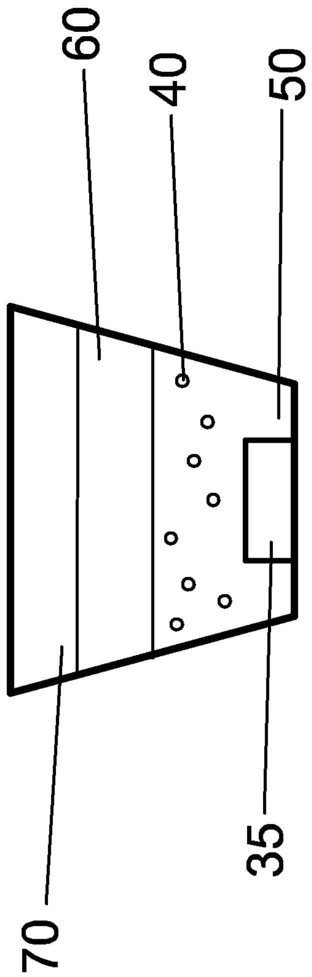


Fig. 69

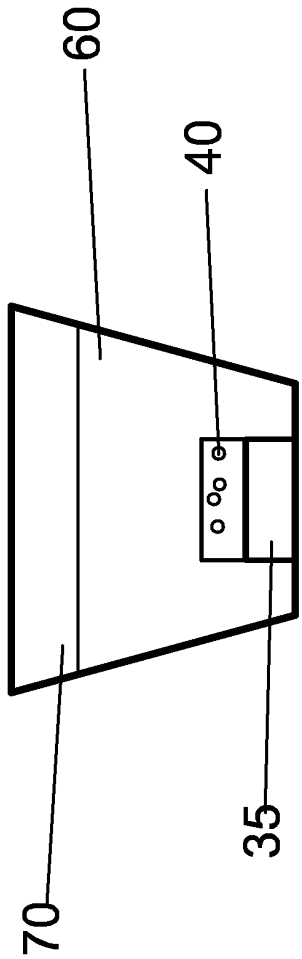


Fig. 70

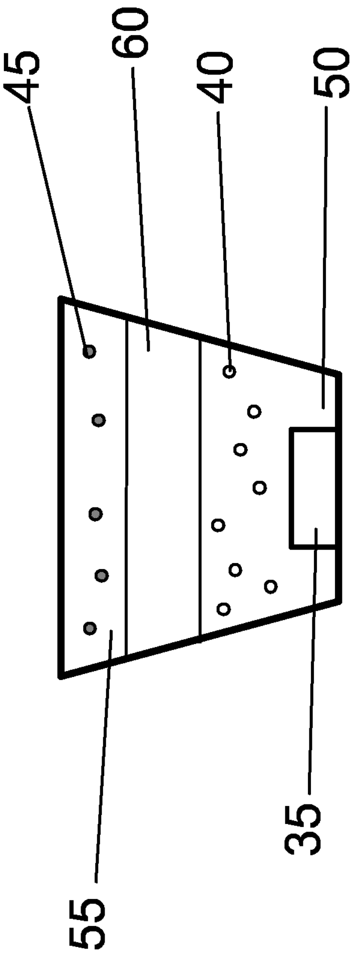


Fig. 71

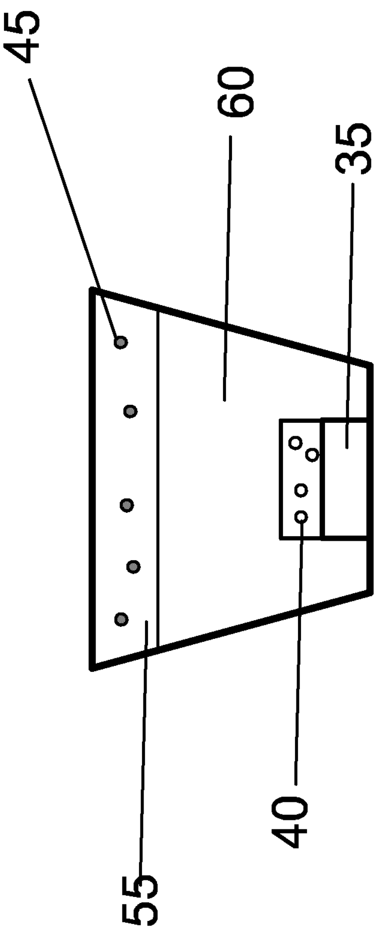


Fig. 72

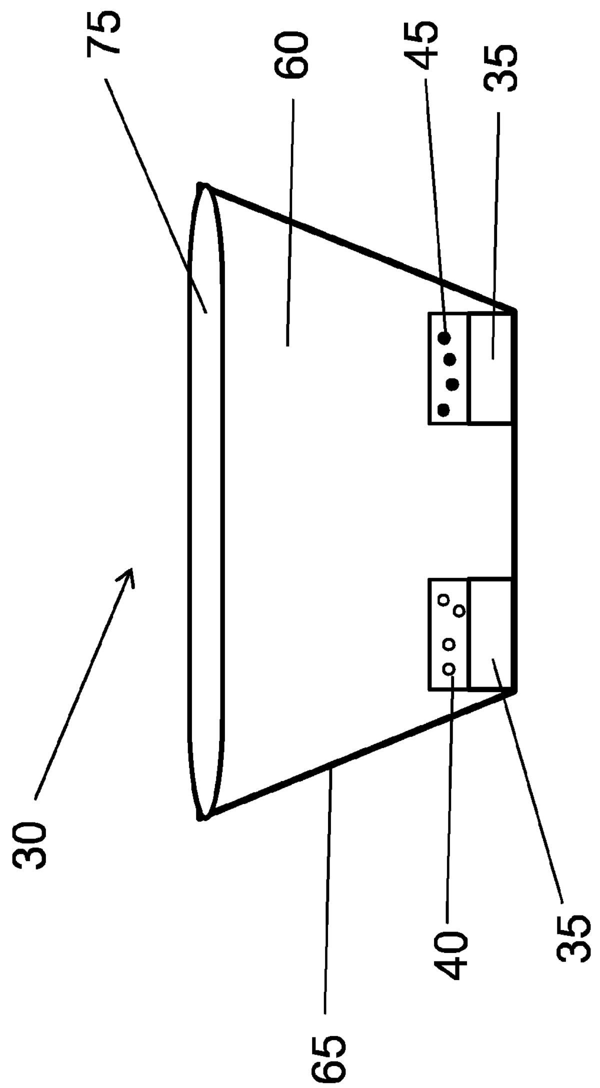


Fig. 73a

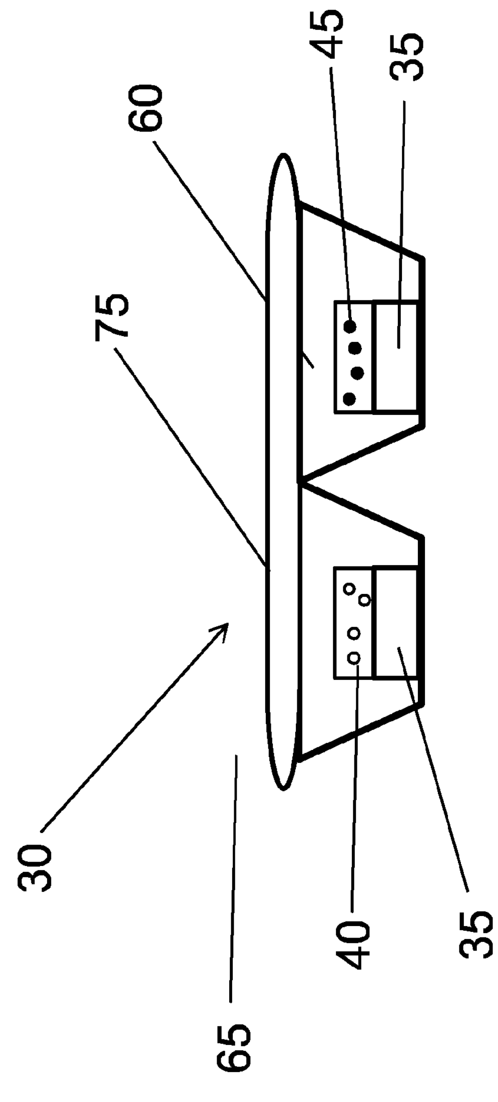


Fig. 73b

Fig. 74

| | $Ca_{1-x}Sr_xAlSiN_3:Eu_y$ | | m / g | | | | | | | | | | Farbort | |
|---|---|---|---|---|---|---|---|---|---|---|---|---|---|---|
| Nr. | y | x | $Ca_3N_2$ | $Sr_3N_2$ | $AlF_3$ | $SrF_2$ | $BaF_2$ | $Li_2B_4O_7$ | $LiBF_4$ | $Si_3N_4$ | AlN | $Eu_2O_3$ | CIE x | CIE y |
| 1 | 0,6% | 0,8 | 2,746 | 21,552 | 0,875 | 0,436 | 0 | 0 | 0 | 12,993 | 11,104 | 0,293 | 0,632 | 0,365 |
| 2 | 0,6% | 0,8 | 2,730 | 21,428 | 0,290 | 1,301 | 0 | 0 | 0 | 12,918 | 11,040 | 0,292 | 0,632 | 0,365 |
| 3 | 0,6% | 0,8 | 2,729 | 21,416 | 0,232 | 1,387 | 0 | 0 | 0 | 12,911 | 11,034 | 0,292 | 0,634 | 0,364 |
| 4 | 0,6% | 0,8 | 2,748 | 21,564 | 0,934 | 0,349 | 0 | 0 | 0 | 13,000 | 11,111 | 0,294 | 0,632 | 0,365 |
| 5 | 0,6% | 0,8 | 2,738 | 21,492 | 1,163 | 0 | 0 | 0 | 0 | 12,957 | 11,357 | 0,293 | 0,631 | 0,366 |
| 6 | 0,6% | 0,8 | 2,646 | 20,769 | 1,124 | 1,682 | 0 | 0 | 0 | 12,521 | 10,975 | 0,283 | 0,631 | 0,366 |
| 7 | 0,6% | 0,8 | 2,574 | 20,202 | 1,641 | 2,454 | 0 | 0 | 0 | 12,179 | 10,676 | 0,275 | 0,633 | 0,364 |
| 8 | 0,6% | 0,8 | 2,506 | 19,665 | 2,129 | 3,185 | 0 | 0 | 0 | 11,855 | 10,392 | 0,268 | 0,632 | 0,364 |
| 9 | 0,6% | 0,8 | 2,731 | 21,434 | 0 | 0 | 0 | 0 | 1,295 | 12,922 | 11,326 | 0,292 | 0,635 | 0,363 |
| 10 | 0,6% | 0,8 | 2,735 | 21,463 | 0,581 | 0 | 0 | 0 | 0,648 | 12,939 | 11,342 | 0,292 | 0,633 | 0,364 |
| 11 | 0,6% | 0,8 | 2,719 | 21,340 | 0,000 | 0,864 | 0 | 0 | 0,645 | 12,865 | 11,277 | 0,290 | 0,634 | 0,364 |
| 12 | 0,6% | 0,8 | 2,725 | 21,389 | 0,387 | 0,578 | 0 | 0 | 0,432 | 12,895 | 11,303 | 0,291 | 0,633 | 0,364 |
| 13 | 0,6% | 0,8 | 2,671 | 20,961 | 0 | 0 | 2,369 | 0 | 0 | 12,637 | 11,077 | 0,285 | 0,633 | 0,364 |
| 14 | 0,6% | 0,8 | 2,704 | 21,223 | 0,574 | 0 | 1,199 | 0 | 0 | 12,795 | 11,215 | 0,289 | 0,631 | 0,366 |
| 15 | 0,6% | 0,8 | 2,689 | 21,103 | 0,000 | 0,857 | 1,193 | 0 | 0 | 12,722 | 11,152 | 0,287 | 0,630 | 0,367 |
| 16 | 0,6% | 0,8 | 2,701 | 21,195 | 0,000 | 0 | 1,198 | 0 | 0,640 | 12,778 | 11,200 | 0,289 | 0,636 | 0,361 |
| 17 | 0,4% | 0,6 | 5,741 | 16,896 | 0,305 | 1,368 | 0 | 0 | 0 | 13,581 | 11,905 | 0,204 | 0,636 | 0,360 |
| 18 | 0,4% | 0,6 | 5,738 | 16,886 | 0,244 | 1,458 | 0 | 0 | 0 | 13,573 | 11,897 | 0,204 | 0635 | 0,361 |
| 19 | 0,4% | 0,6 | 5,776 | 16,999 | 0,920 | 0,459 | 0 | 0 | 0 | 13,664 | 11,977 | 0,206 | 0,637 | 0,359 |
| 20 | 0,4% | 0,6 | 5,779 | 17,009 | 0,982 | 0,367 | 0 | 0 | 0 | 13,672 | 11,984 | 0,206 | 0,638 | 0,358 |
| 21 | 0,4% | 0,6 | 5,793 | 17,048 | 0,000 | 0 | 0 | 0 | 1,239 | 13,703 | 12,011 | 0,206 | 0,636 | 0,359 |
| 22 | 0,4% | 0,6 | 5,793 | 17,049 | 0,615 | 0 | 0 | 0 | 0,620 | 13,704 | 12,012 | 0,206 | 0,640 | 0,356 |
| 23 | 0,4% | 0,6 | 5,758 | 16,946 | 0 | 0,915 | 0 | 0 | 0,616 | 13,621 | 11,940 | 0,205 | 0,639 | 0,357 |
| 24 | 0,4% | 0,6 | 5,785 | 17,025 | 0 | 0 | 0 | 0,619 | 0,686 | 13,685 | 11,995 | 0,206 | 0,642 | 0,354 |

Fig. 74

| | | | | | | | | | | | | | | |
|---|---|---|---|---|---|---|---|---|---|---|---|---|---|---|
| 25 | 0,4% | 0,6 | 5,747 | 16,913 | 0 | 1,205 | 0 | 0,418 | 0 | 13,595 | 11,917 | 0,205 | 0,639 | 0,358 |
| 26 | 0,4% | 0,6 | 5,737 | 16,885 | 0 | 1,458 | 0 | 0,245 | 0 | 13,573 | 11,897 | 0,204 | 0,639 | 0,358 |
| 27 | 0,4% | 0,6 | 5,782 | 17,017 | 0 | 0 | 0 | 0,421 | 0,905 | 13,679 | 11,990 | 0,206 | 0,640 | 0,356 |
| 28 | 0,4% | 0,6 | 5,780 | 17,011 | 0 | 0 | 0 | 0,247 | 1,096 | 13,674 | 11,986 | 0,206 | 0,640 | 0,356 |
| 29 | 0,4% | 0,6 | 5,793 | 17,050 | 0,809 | 0 | 0 | 0,421 | 0 | 13,707 | 12,013 | 0,206 | 0,639 | 0,357 |
| 30 | 0,4% | 0,6 | 5,793 | 17,049 | 0,984 | 0 | 0 | 0,248 | 0 | 13,707 | 12,013 | 0,206 | 0,639 | 0,358 |
| 31 | 0,4% | 0,6 | 5,770 | 16,980 | 0,408 | 0,611 | 0 | 0,411 | 0 | 13,651 | 11,964 | 0,205 | 0,639 | 0,358 |
| 32 | 0,4% | 0,6 | 5,725 | 17,196 | 0,486 | 0,728 | 0 | 0,245 | 0 | 13,545 | 11,871 | 0,204 | 0,639 | 0,358 |
| 33 | 0,4% | 0,6 | 5,704 | 17,134 | 0,906 | 0,606 | 0 | 0,122 | 0 | 13,496 | 11,828 | 0,203 | 0,636 | 0,360 |
| 34 | 0,4% | 0,6 | 5,753 | 17,280 | 0,000 | 1,100 | 0 | 0,123 | 0 | 13,611 | 11,929 | 0,205 | 0,637 | 0,360 |
| 35 | 0,4% | 0,6 | 5,793 | 17,049 | 1,107 | 0,000 | 0 | 0,124 | 0 | 13,707 | 12,013 | 0,206 | 0,638 | 0,358 |
| 36 | 0,4% | 0,6 | 5,722 | 17,186 | 0,818 | 0,548 | 0 | 0,122 | 0 | 13,537 | 11,864 | 0,204 | 0,638 | 0,359 |
| 37 | 0,8% | 0,8 | 2,791 | 21,907 | 0,119 | 0 | 0 | 0 | 0 | 13,209 | 11,577 | 0,398 | 0,634 | 0,364 |
| 38 | 1,0% | 0,8 | 2,786 | 21,863 | 0,118 | 0 | 0 | 0 | 0 | 13,183 | 11,554 | 0,496 | 0,638 | 0,360 |
| 39 | 1,2% | 0,8 | 2,780 | 21,820 | 0,118 | 0 | 0 | 0 | 0 | 13,157 | 11,531 | 0,594 | 0,641 | 0,357 |
| 40 | 1,2% | 0,9 | 1,354 | 23,908 | 0,115 | 0 | 0 | 0 | 0 | 12,814 | 11,230 | 0,579 | 0,633 | 0,366 |
| 41 | 1,2% | 0,875 | 1,704 | 23,397 | 0,116 | 0 | 0 | 0 | 0 | 12,898 | 11,304 | 0,582 | 0,636 | 0,362 |
| 42 | 1,2% | 0,85 | 2,058 | 22,878 | 0,117 | 0 | 0 | 0 | 0 | 12,983 | 11,378 | 0,586 | 0,640 | 0,358 |
| 43 | 1,2% | 0,825 | 2,417 | 22,353 | 0,117 | 0 | 0 | 0 | 0 | 13,069 | 11,454 | 0,590 | 0,642 | 0,356 |
| 44 | 1,2% | 0,925 | 1,009 | 24,413 | 0,114 | 0 | 0 | 0 | 0 | 12,731 | 11,158 | 0,575 | 0,628 | 0,370 |
| 45 | 1,2% | 0,95 | 0,668 | 24,912 | 0,114 | 0 | 0 | 0 | 0 | 12,649 | 11,086 | 0,571 | 0,626 | 0,372 |
| 46 | 1,5% | 0,8 | 2,772 | 21,756 | 0,118 | 0 | 0 | 0 | 0 | 13,118 | 11,497 | 0,740 | 0,645 | 0,353 |
| 47 | 2,0% | 0,8 | 2,759 | 21,649 | 0,117 | 0 | 0 | 0 | 0 | 13,053 | 11,440 | 0,982 | 0,654 | 0,345 |
| 48 | 0,5% | 0,7 | 8,632 | 39,518 | 0,244 | 0 | 0 | 0 | 0 | 27,227 | 23,866 | 0,512 | 0,635 | 0,364 |
| 49 | 0,6% | 0,8 | 5,594 | 43,903 | 0,238 | 0 | 0 | 0 | 0 | 26,468 | 23,200 | 0,598 | 0,638 | 0,361 |
| 50 | 0,5% | 0,7 | 8,632 | 39,518 | 0,244 | 0 | 0 | 0 | 0 | 27,227 | 23,866 | 0,512 | 0,632 | 0,366 |

Fig. 74

| | | | | | | | | | | | | | | |
|---|---|---|---|---|---|---|---|---|---|---|---|---|---|---|
| 51 | 0,6% | 0,8 | 5,594 | 43,903 | 0,238 | 0 | 0 | 0 | 0 | 26,486 | 23,200 | 0,598 | 0,628 | 0,371 |
| 52 | 0,5% | 0,8 | 5,600 | 43,947 | 0,238 | 0 | 0 | 0 | 0 | 26,494 | 23,223 | 0,499 | 0,624 | 0,375 |
| 53 | 0,6% | 0,9 | 2,724 | 48,097 | 0,231 | 0 | 0 | 0 | 0 | 25,774 | 22,592 | 0,582 | 0,622 | 0,377 |
| 54 | 0,7% | 0,9 | 2,721 | 48,050 | 0,231 | 0 | 0 | 0 | 0 | 25,749 | 22,570 | 0,678 | 0,624 | 0,375 |
| 55 | 0,8% | 0,9 | 2,719 | 48,004 | 0,231 | 0 | 0 | 0 | 0 | 25,724 | 22,548 | 0,774 | 0,626 | 0,372 |
| 56 | 1,0% | 0,9 | 2,713 | 47,911 | 0,231 | 0 | 0 | 0 | 0 | 25,674 | 22,505 | 0,966 | 0,635 | 0,364 |
| 57 | 1,2% | 0,9 | 2,708 | 47,818 | 0,230 | 0 | 0 | 0 | 0 | 25,625 | 22,461 | 1,157 | 0,637 | 0,362 |
| 58 | 0,6% | 0,85 | 4,140 | 46,028 | 0,235 | 0 | 0 | 0 | 0 | 26,116 | 22,892 | 0,590 | 0,624 | 0,374 |
| 59 | 0,9% | 0,9 | 2,716 | 47,957 | 0,231 | 0 | 0 | 0 | 0 | 25,699 | 22,527 | 0,870 | 0,629 | 0,370 |
| 60 | 1,2% | 0,95 | 1,337 | 49,826 | 0,227 | 0 | 0 | 0 | 0 | 25,295 | 22,173 | 1,142 | 0,631 | 0,368 |

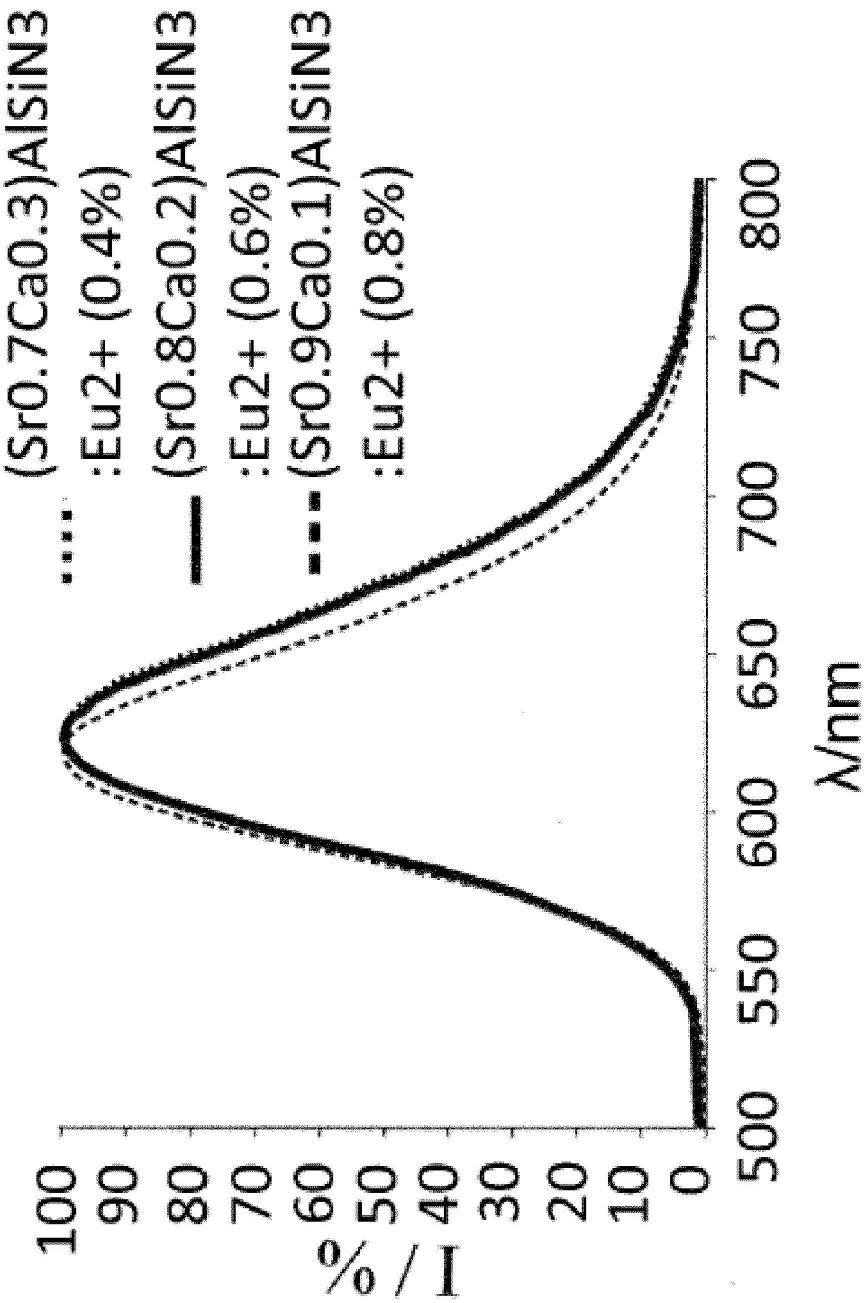
(Sr0.7Ca0.3)AlSiN3
:Eu2+ (0.4%)
(Sr0.8Ca0.2)AlSiN3
:Eu2+ (0.6%)
(Sr0.9Ca0.1)AlSiN3
:Eu2+ (0.8%)
I / %
λ/nm
100
90
80
70
60
50
40
30
20
10
0
500
550
600
650
700
750
800

Fig. 75

Fig. 76

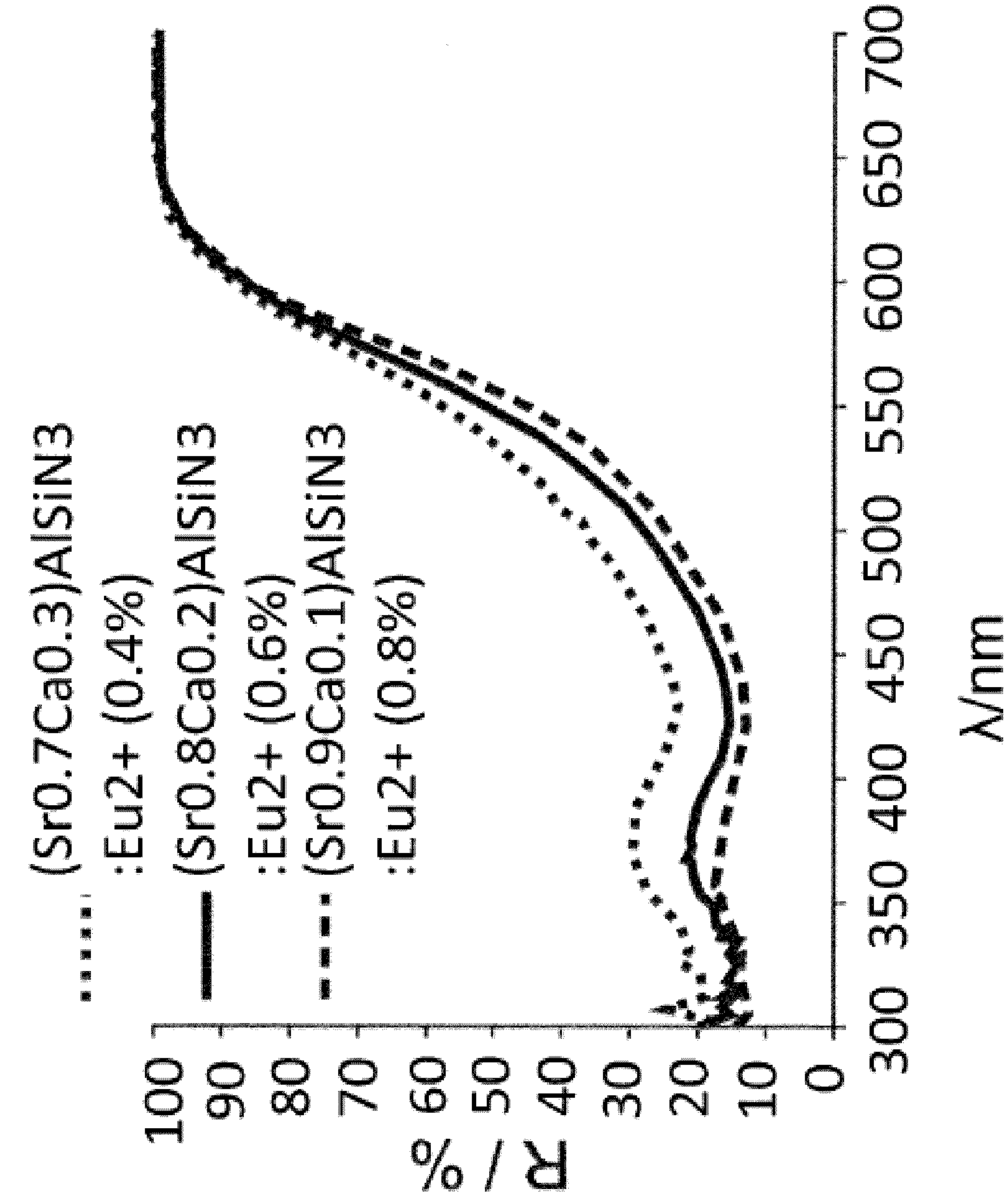
(Sr0.7Ca0.3)AlSiN3
:Eu2+ (0.4%)
(Sr0.8Ca0.2)AlSiN3
:Eu2+ (0.6%)
(Sr0.9Ca0.1)AlSiN3
:Eu2+ (0.8%)
R / %
100
90
80
70
60
50
40
30
20
10
0
300
350
400
450
500
550
600
650
700
λ/nm

Fig. 77

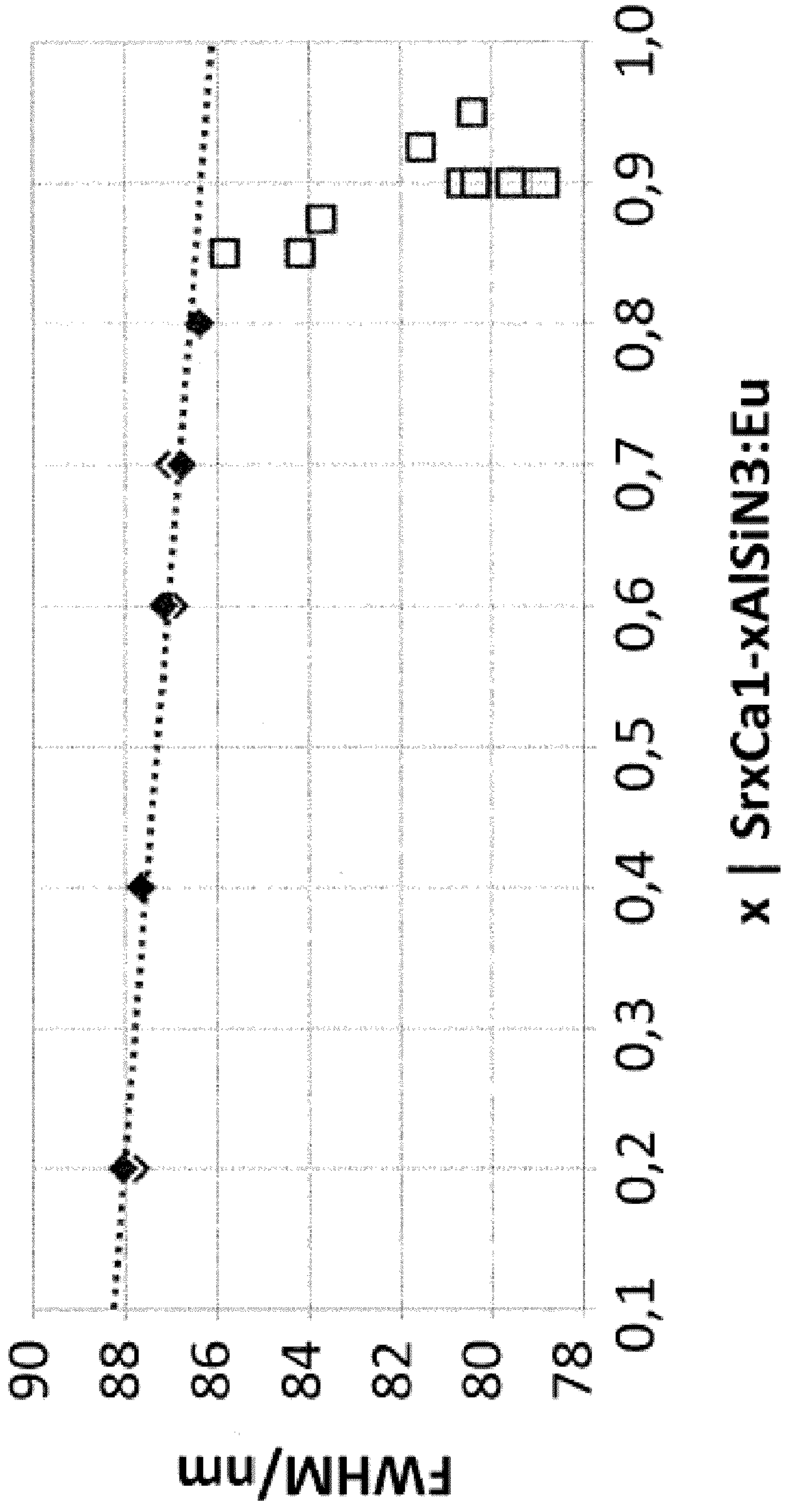
FWHM/nm
90
88
86
84
82
80
78
0,1
0,2
0,3
0,4
0,5
0,6
0,7
0,8
0,9
1,0
x | SrxCa1-xAlSiN3:Eu

Fig. 78

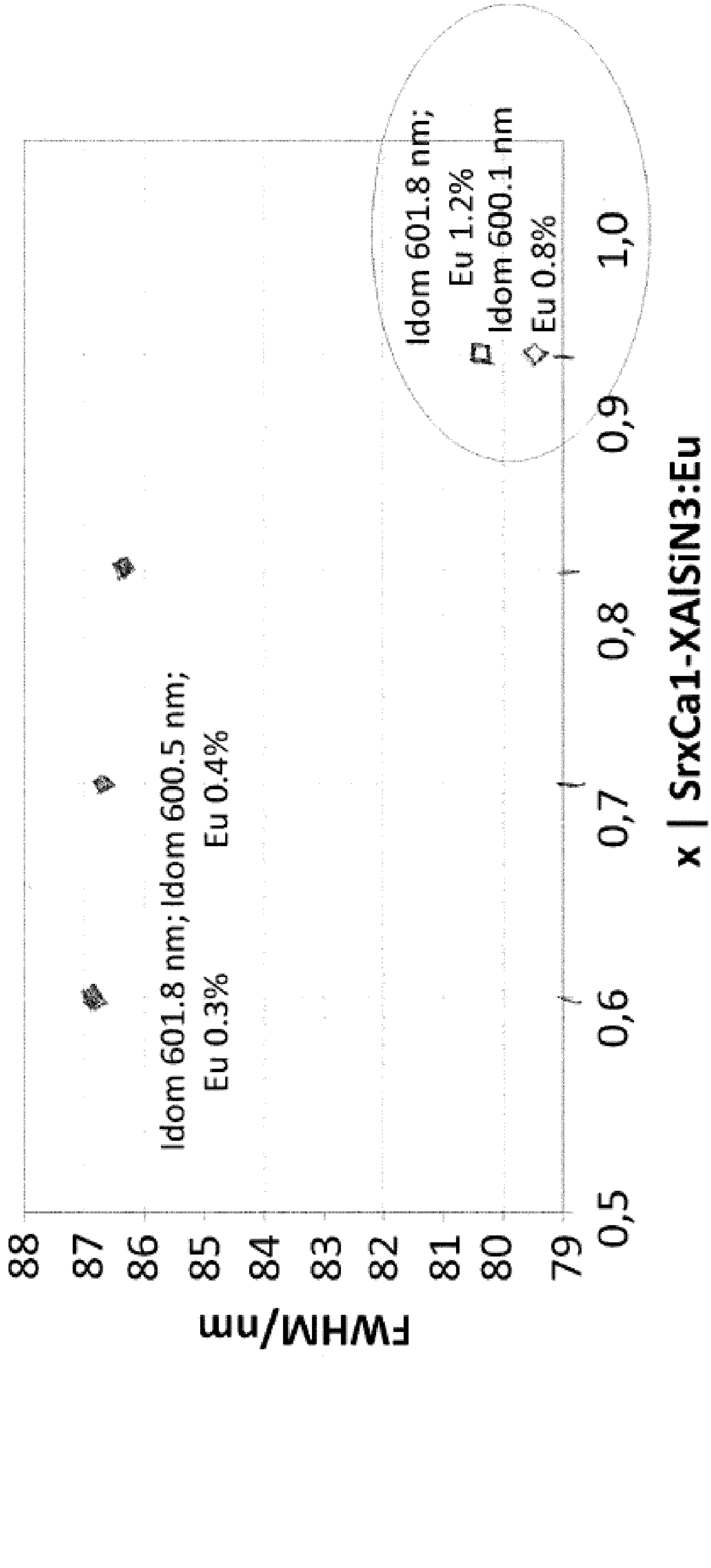
FWHM/nm
88
87
86
85
84
83
82
81
80
79
0,5
0,6
0,7
0,8
0,9
1,0
x | SrxCa1-XAlSiN3:Eu
Idom 601.8 nm; Eu 0.3%
Idom 600.5 nm; Eu 0.4%
Idom 601.8 nm; Eu 1.2%
Idom 600.1 nm Eu 0.8%

Fig. 79

| | x | y | Idom/nm | FWHM/nm | QI | QE | LER | B |
|---|---|---|---|---|---|---|---|---|
| (Sr0.7Ca0.3)AlSiN3:Eu (0.4%) | 0,628 | 0,37 | 600,5 | 86,7 | 100% | 100% | 100% | 100% |
| (Sr0.8Ca0.2)AlSiN3:Eu (0.6%) | 0,628 | 0,371 | 600,3 | 86,5 | 99% | 110% | 101% | 111% |
| (Sr0.9Ca0.1)AlSiN3:Eu (0.8%) | 0,626 | 0,372 | 600,1 | 79,5 | 99% | 113% | 110% | 125% |

Fig. 80

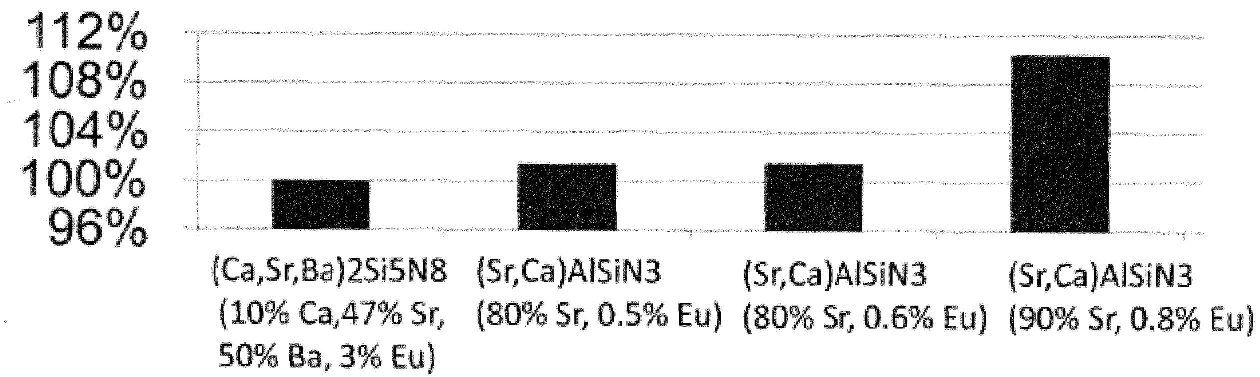

Fig. 81

| G | R | Idom/nm | c | v | CIE x | Cie y | CCT/K | CRI | E |
|---|---|---|---|---|---|---|---|---|---|
| (Lu,Ce)3(Al,Ga)5012 (25% Ga, 2.5% Ce) | (Ca,Sr,Ba)2Si5N8 (10% Ca, 47% Sr, 50% Ba, 3% Eu) | 601,5 | 15,50% | 4,45:1 | 0,461 | 0,408 | 2669 | 79 | 100,00% |
| (Lu,Ce)3(Al,Ga)5012 (25% Ga, 2.5% Ce) | (Sr,Ca)AlSiN3 (80% Sr, 0.5% Eu) | 599,4 | 18,00% | 2,5:1 | 0,459 | 0,416 | 2754 | 80 | 101,40% |
| (Lu,Ce)3(Al,Ga)5012 (25% Ga, 2.5% Ce) | (Sr,Ca)AlSiN3 (80% Sr, 0.6% Eu) | 600,3 | 16,80% | 2,6:1 | 0,461 | 0,408 | 2655 | 81 | 101,50% |
| (Lu,Ce)3(Al,Ga)5012 (25% Ga, 2.5% Ce) | (Sr,Ca)AlSiN3 (90% Sr, 0,8% Eu) | 600,1 | 16,70% | 3,7:1 | 0,462 | 0,411 | 2681 | 79 | 110,40% |

Fig. 82

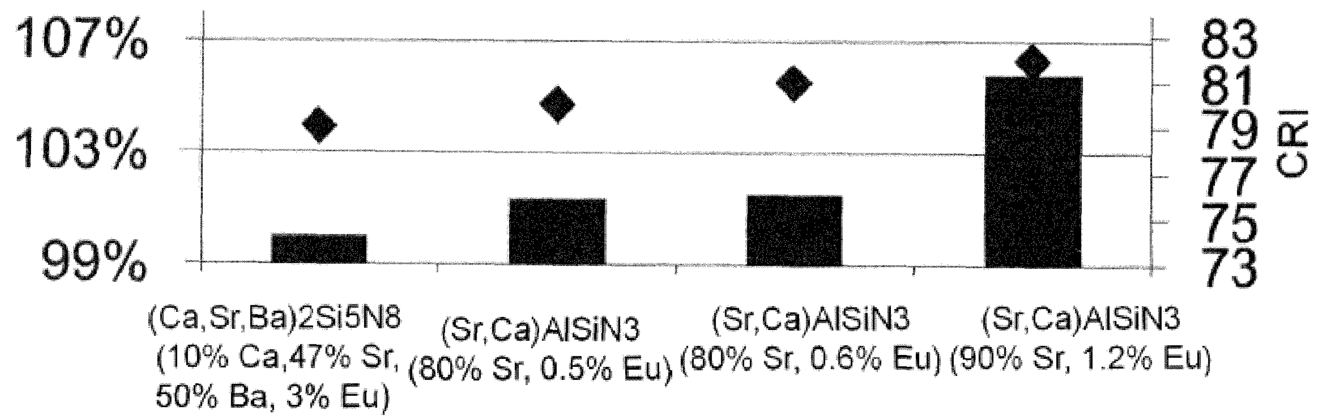

Fig. 83

| G | R | Idom/nm | c | v | CIE x | Cie y | CCT/K | CRI | E |
|---|---|---|---|---|---|---|---|---|---|
| (Lu,Ce)3(Al,Ga)5012 (25% Ga, 2.5% Ce) | (Ca,Sr,Ba)2Si5N8 (10% Ca, 47% Sr, 50% Ba, 3% Eu) | 601,5 | 15,50% | 4,45:1 | 0,461 | 0,408 | 2669 | 79 | 100,00% |
| (Lu,Ce)3(Al,Ga)5012 (25% Ga, 2.5% Ce) | (Sr,Ca)AlSiN3 (80% Sr, 0.5% Eu) | 599,4 | 18,00% | 2,5:1 | 0,459 | 0,416 | 2754 | 80 | 101,40% |
| (Lu,Ce)3(Al,Ga)5012 (25% Ga, 2.5% Ce) | (Sr,Ca)AlSiN3 (80% Sr, 0.6% Eu) | 600,3 | 16,80% | 2,6:1 | 0,461 | 0,408 | 2655 | 81 | 101,50% |
| (Lu,Ce)3(Al,Ga)5012 (25% Ga, 2.5% Ce) | (Sr,Ca)AlSiN3 (90% Sr, 1.2% Eu) | 602,4 | 16,50% | 5,5:1 | 0,462 | 0,408 | 2649 | 82 | 105,80% |

Fig. 84

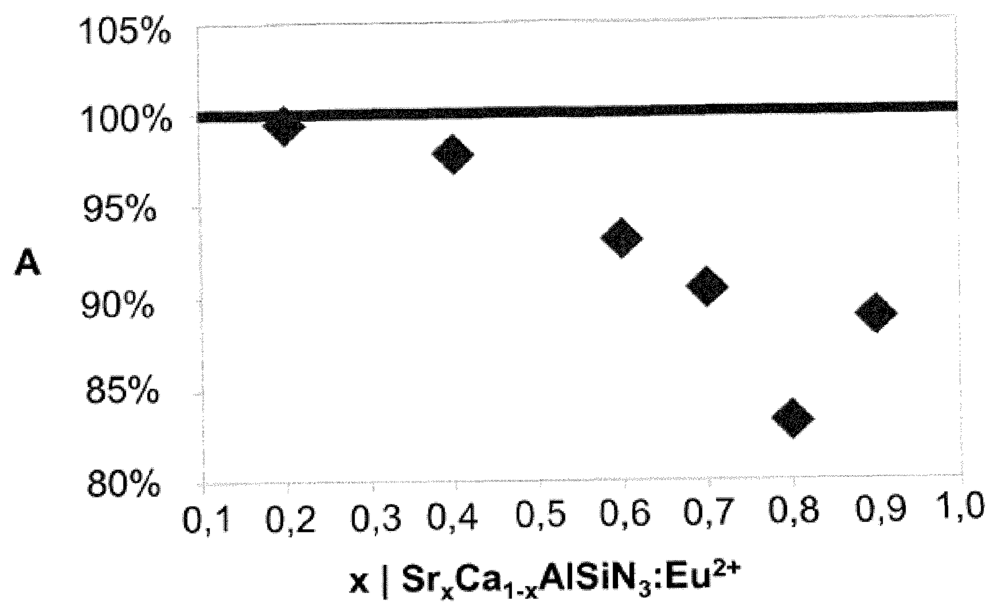

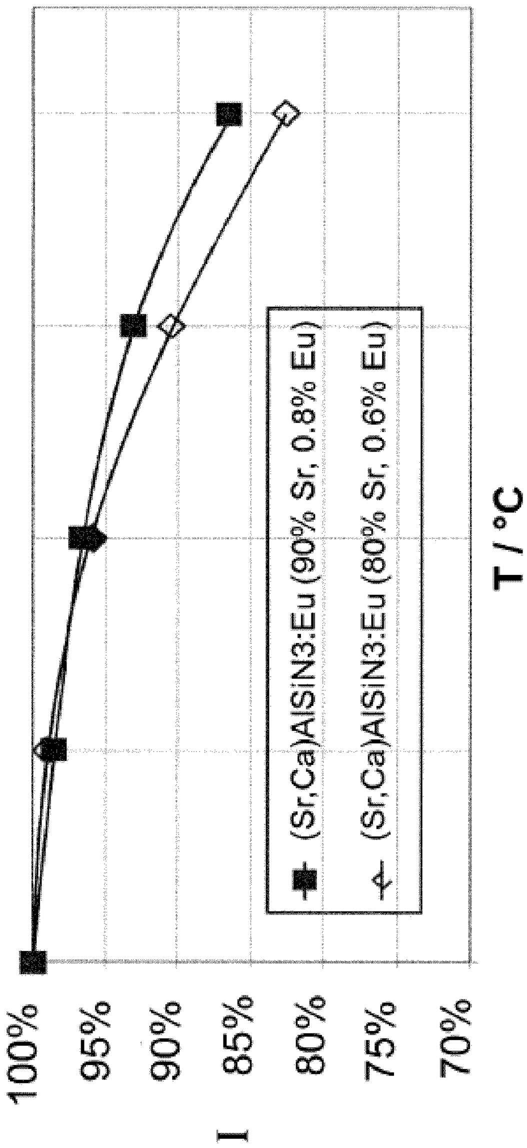
100%
95%
90%
85%
80%
75%
70%
I
T / °C
(Sr,Ca)AlSiN3:Eu (90% Sr, 0.8% Eu)
(Sr,Ca)AlSiN3:Eu (80% Sr, 0.6% Eu)

Fig. 85

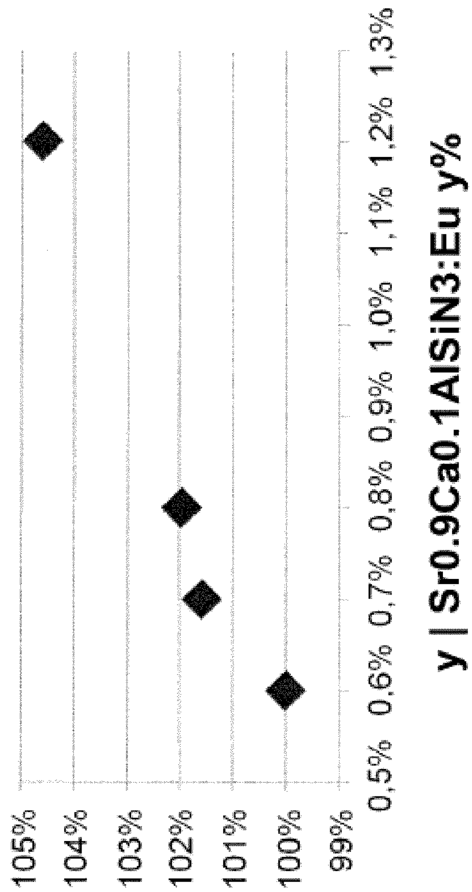
105%
104%
103%
102%
101%
100%
99%
0,5% 0,6% 0,7% 0,8% 0,9% 1,0% 1,1% 1,2% 1,3%
y | Sr0.9Ca0.1AlSiN3:Eu y%

Fig. 86

Fig. 87

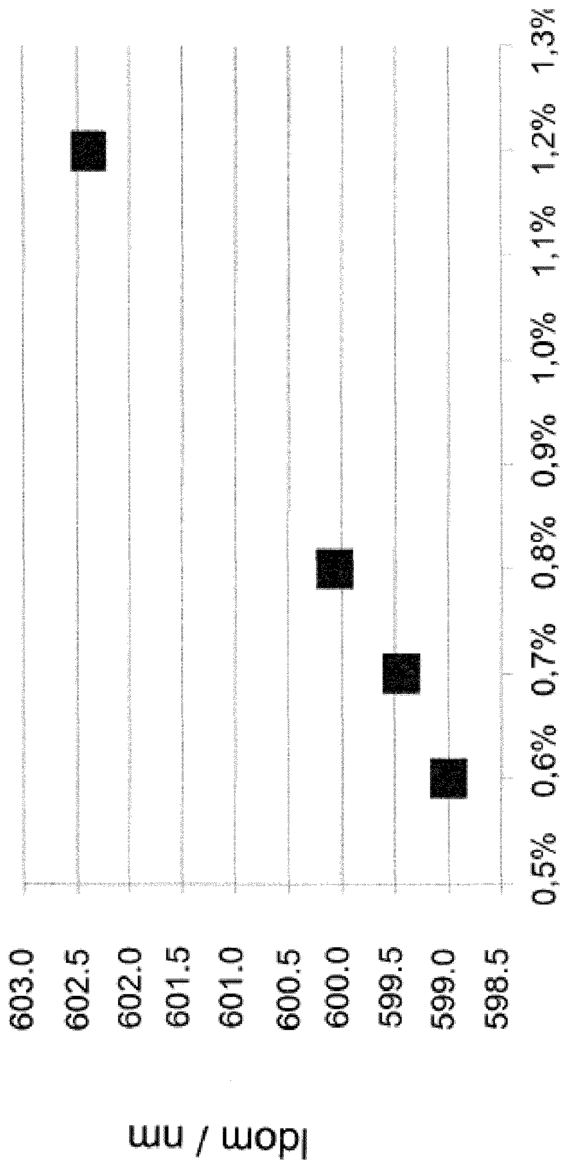
ldom / nm
603.0
602.5
602.0
601.5
601.0
600.5
600.0
599.5
599.0
598.5
0,5%
0,6%
0,7%
0,8%
0,9%
1,0%
1,1%
1,2%
1,3%

Fig. 88

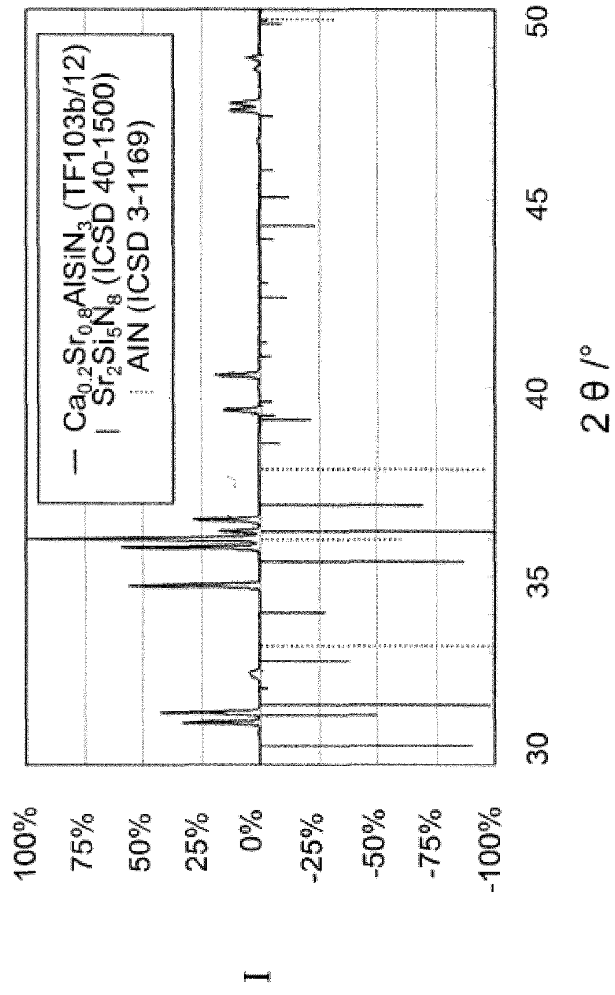
$Ca_{0.2}Sr_{0.8}AlSiN_3$ (TF103b/12)
$Sr_2Si_5N_8$ (ICSD 40-1500)
AlN (ICSD 3-1169)
I
100%
75%
50%
25%
0%
-25%
-50%
-75%
-100%
30
35
40
45
50
2 θ /°

Fig. 89

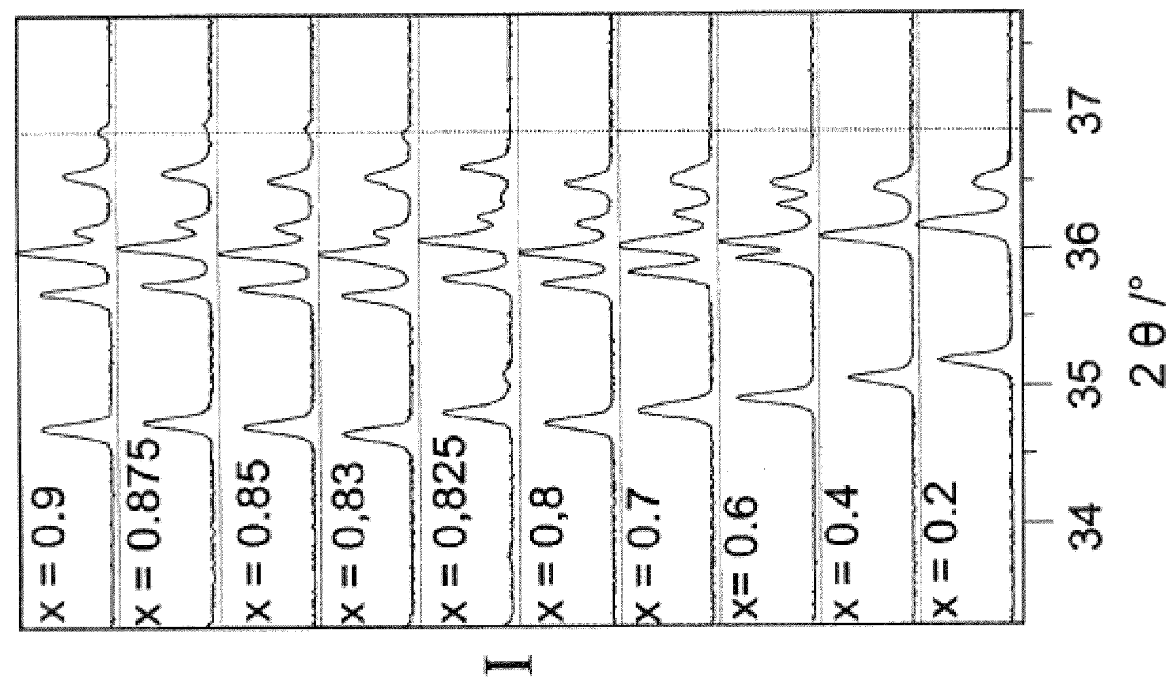

Fig. 90

| **Raumgruppe** | **$Cmc2_1$** | **Zellsuche** | **P1 (Ca nur auf einer Lage, unverfeinert)** | **P1 endgültige Verfeinerung** |
|---|---|---|---|---|
| **Gitterparameter** | | | | |
| **a** | 9.821 Å | 9.825 Å | 9.821 Å | 9.821 Å |
| **b** | 5.749 Å | 5.752 Å | 5.749 Å | 5.749 Å |
| **c** | 5.163 Å | 5.165 Å | 5.163 Å | 5.163 Å |
| **V** | | | 291.5 $Å^3$ | 291.5 $Å^3$ |
| **Güteparameter** | | | | |
| **$R_p$** | 7.2% | | 7.1 % | 6.2% |
| **$R_{wp}$** | 11.1% | | 11.0 % | 9.6% |
| **$R_{bragg}$** | 5.6% | | 5.6 % | 3.7% |

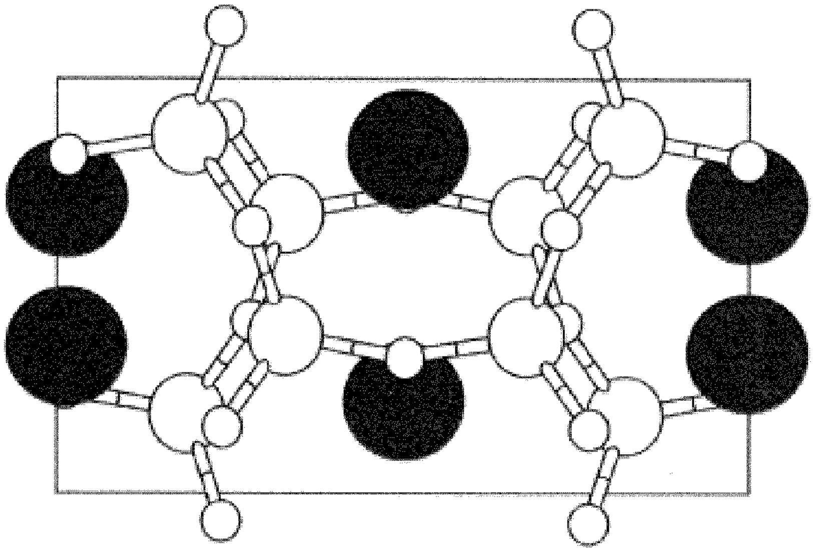

Fig. 92

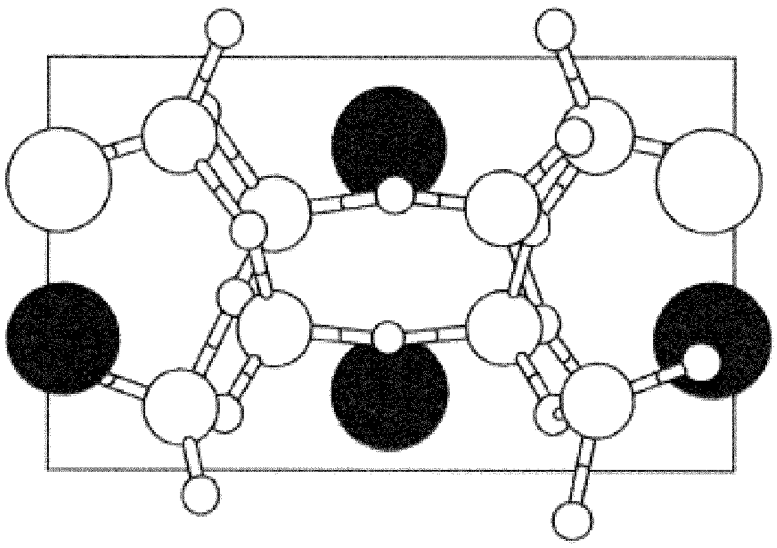

Fig. 91

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 2135920 A
- EP 1696016 A
- WO 2012166841 A1
- US 8274215 B
- US 5998925 A
- EP 1696016 A1
- WO 2011160944 A
- WO 2012076296 A2
- WO 2011098164 A1
- WO 2013110495 A2
- DE 102012209172 A1
- DE 102010062465 A1
- DE 102011002961 A1
- DE 102012201790 A1
- DE 102014105588
- EP 2135920 A1


### In der Beschreibung aufgeführte Nicht-Patentliteratur


- **WATANABE H. et al.** Crystal structure and luminescence properties of SrxCa1-xAlSiN3:Eu2+ mixed nitride phosphors. *Journal of Alloys and Compounds,* 05. Mai 2009, 434-439
- **WATANABE H. et al.** Synthetic Method and Luminescence Properties of SrxCa1- xAlSiN3:Eu2+ Mixed Nitride Phosphors. *Journal of the Electrochemical Society,* 01. Januar 2008, F31
- **H. WATANABE et al.** *J. Electrochem. Soc.,* 2008, vol. 155 (3), F31-F36
- **PETRICEK,V. ; DUSEK,M. ; PALATINUS,L.** The crystallographic computing system. Institute of Physics, 2006